(19) Europäisches Patentamt
European Patent Office
Office européen des brevets

(11) EP 3 798 225 B1

(12) # EUROPEAN PATENT SPECIFICATION

(45) Date of publication and mention of the grant of the patent:
**02.11.2022 Bulletin 2022/44**

(21) Application number: **20198206.3**

(22) Date of filing: **24.09.2020**

(51) International Patent Classification (IPC):
***C07F 15/00*** *(2006.01)* ***C09K 11/06*** *(2006.01)*
***H01L 51/50*** *(2006.01)* ***H01L 51/00*** *(2006.01)*

(52) Cooperative Patent Classification (CPC):
**C07F 15/0033; C09K 11/06; H01L 51/0085; H01L 51/0094;** C09K 2211/185; H01L 51/5016

(54) **ORGANOMETALLIC COMPOUND, ORGANIC LIGHT-EMITTING DEVICE INCLUDING THE SAME AND ELECTRONIC APPARATUS INCLUDING THE ORGANIC LIGHT-EMITTING DEVICE**

ORGANOMETALLISCHE VERBINDUNG, ORGANISCHE LICHTEMITTIERENDE VORRICHTUNG DAMIT UND ELEKTRONISCHE VORRICHTUNG MIT DER ORGANISCHEN LICHTEMITTIERENDEN VORRICHTUNG

COMPOSÉ ORGANOMÉTALLIQUE, DISPOSITIF ÉLECTROLUMINESCENT ORGANIQUE LE COMPRENANT ET APPAREIL ÉLECTRONIQUE COMPRENANT LE DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.09.2019 KR 20190119095**
**23.09.2020 KR 20200123024**

(43) Date of publication of application:
**31.03.2021 Bulletin 2021/13**

(73) Proprietor: **Samsung Electronics Co., Ltd.**
**Gyeonggi-do 16677 (KR)**

(72) Inventors:
- **LEE, Kum Hee**
  **16678 Gyeonggi-do (KR)**
- **KANG, Byungjoon**
  **16678 Gyeonggi-do (KR)**
- **KWAK, Seungyeon**
  **16678 Gyeonggi-do (KR)**
- **LEE, Sunghun**
  **16678 Gyeonggi-do (KR)**
- **JEON, Aram**
  **16678 Gyeonggi-do (KR)**
- **CHOI, Hyeonho**
  **16678 Gyeonggi-do (KR)**
- **HWANG, Kyuyoung**
  **16678 Gyeonggi-do (KR)**
- **CHOI, Byoungki**
  **16678 Gyeonggi-do (KR)**
- **CHOI, Whail**
  **16678 Gyeonggi-do (KR)**

(74) Representative: **Elkington and Fife LLP**
**Prospect House**
**8 Pembroke Road**
**Sevenoaks, Kent TN13 1XR (GB)**

(56) References cited:
**US-A1- 2016 268 522**

- **YONGBIAO ZHAO ET AL: "Ultrathin Nondoped Emissive Layers for Efficient and Simple Monochrome and White Organic Light-Emitting Diodes", ACS APPLIED MATERIALS & INTERFACES, vol. 5, no. 3, 16 January 2013 (2013-01-16), pages 965-971, XP055764269, US ISSN: 1944-8244, DOI: 10.1021/am3026097**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

FIELD OF THE INVENTION

One or more embodiments relate to an organometallic compound, an organic light-emitting device including the same and an electronic apparatus including the organic light-emitting device.

BACKGROUND OF THE INVENTION

Organic light-emitting devices are self-emission devices that produce fullcolor images, and also have wide viewing angles, high contrast ratios, short response times, and excellent characteristics in terms of brightness, driving voltage, and response speed

An example of the organic light-emitting device may include an anode, a cathode, and an organic layer disposed between the anode and the cathode and including an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. Carriers, such as holes and electrons, recombine in the emission layer to produce excitons. These excitons transit from an excited state to a ground state, thereby generating light.

US 2016/268522 discloses an organometallic compound and an organic light-emitting device including the organometallic compound.

Yongbiao Zhao et al., in "Ultrathin nondoped emissive layers for efficient and simple monochrome and white organic light-emitting diodes", ACS Appl. Mater. Interfaces, 2013, Feb; 5(3):965-71, discloses monochrome blue, green, orange, and red organic light emitting diodes (OLEDs) based on ultrathin nondoped emissive layers (EMLs).

SUMMARY OF THE INVENTION

Provided are novel organometallic compounds, organic light-emitting devices using the same and an electronic apparatus including the organic light-emitting device.

Additional aspects will be set forth in part in the description which follows and, in part, will be apparent from the description, or may be learned by practice of the presented embodiments of the disclosure.

According to an aspect, an organometallic compound presented in Formula 1 is provided:

<Formula 1> $M\ (L_1)_{n1}(L_2)_{n2}$

In Formula 1,

M may be a transition metal,
$L_1$ may be a ligand represented by Formula 2,
$L_2$ may be a ligand represented by Formula 3,
n1 and n2 may each independently be 1 or 2, when n1 is 2, two $L_1$(s) may be identical to or different from each other, and when n2 is 2, two $L_2$(s) may be identical to or different from each other.

<Formula 2>

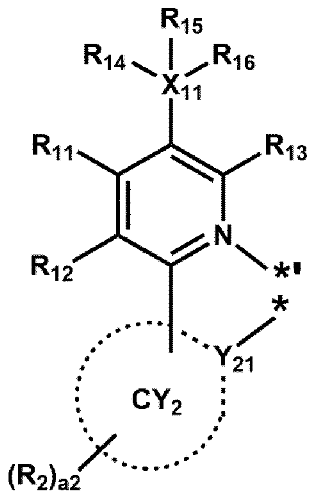

<Formula 3>

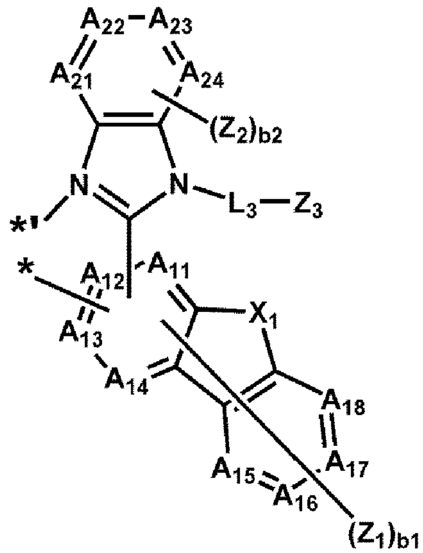

In Formulae 2 and 3,

$Y_{21}$ may be C or N,
ring $CY_2$ may be a $C_5$-$C_{30}$ carbocyclic group or $C_1$-$C_{30}$ heterocyclic group,
$X_{11}$ may be Si or Ge,
$X_1$ may be O, S, Se, $N(Z_{19})$, $C(Z_{19})(Z_{20})$, or $Si(Z_{19})(Z_{20})$,
$A_{11}$ to $A_{14}$ may each independently be C or N, wherein one of $A_{11}$ to $A_{14}$ may be C bonded to a group represented by

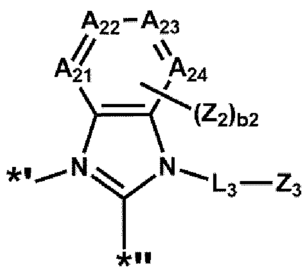

in Formula (3), and one of the remaining $A_{11}$ to $A_{14}$ may be C bonded to M in Formula 1,
$A_{15}$ to $A_{18}$ and $A_{21}$ to $A_{24}$ may each independently be C or N,
at least one of $A_{11}$ to $A_{18}$ may be N,
$L_3$ may be a single bond, a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,
$R_2$, $R_{11}$ to $R_{16}$, $Z_1$ to $Z_3$, $Z_{19}$, and $Z_{20}$ may each independently be hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$ or $-P(Q_8)(Q_9)$,
a2 is an integer from 0 to 20, and when a2 is two or more, two or more of $R_2$ may be identical to or different from each other,

b1 is an integer from 0 to 5, and when b1 is two or more, two or more of $Z_1$ may be identical to or different from each other,
b2 is an integer from 0 to 4, and when b2 is two or more, two or more of $Z_2$ may be identical to or different from each other,
$R_{11}$ and $R_{12}$ are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
two or more of a plurality of $R_2$ are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
two or more of a plurality of $Z_1$ are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
two or more of a plurality of $Z_2$ are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
$R_{10a}$ is the same as explained in connection with $Z_1$,
* and *' indicates a binding site to M in Formula 1,
wherein a substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group is:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, carboxylic acid group or a salt thereof, sulfonic acid group or a salt thereof, phosphoric acid group or a salt thereof, a $C_1$-$C_{60}$ alkyl group, a $C_2$-$C_{60}$ alkenyl group, a $C_2$-$C_{60}$ alkynyl group, $C_1$-$C_{60}$ alkoxy group, or a $C_1$-$C_{60}$ alkylthio group;
a $C_1$-$C_{60}$ alkyl group, a $C_2$-$C_{60}$ alkenyl group, a $C_2$-$C_{60}$ alkynyl group, a C1-$C_{60}$ alkoxy group, or a $C_1$-$C_{60}$ alkylthio group, each substituted with deuterium, -F, - Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, carboxylic acid group or a salt thereof, sulfonic acid group or a salt thereof, phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a C1-C60 heteroaryl group, a monovalent non-aromatic condensed polycyclic group, a monovalent non-aromatic condensed heteropolycyclic group, $-N(Q_{11})(Q_{12})$,$Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$, or any combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with deuterium, -F, -Cl, - Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, carboxylic acid group or a salt thereof, sulfonic acid group or a salt thereof, phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, - $N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, - $P(Q_{28})(Q_{29})$, or any combination thereof;
$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, - $P(=O)(Q_{38})(Q_{39})$, or $-P(Q_{38})(Q_{39})$; or any combination thereof, and
wherein $Q_1$ to $Q_9$, $Q_{11}$ to $Q_{19}$, $Q_{21}$ to $Q_{29}$, and $Q_{31}$ to $Q_{39}$ may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, -F, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_1$-$C_{60}$ alkylthio group; a $C_3$-$C_{10}$ cycloalkyl group; a $C_1$-$C_{10}$ heterocycloalkyl group; a $C_3$-$C_{10}$ cycloalke-

nyl group; a $C_1$-$C_{10}$ heterocycloalkenyl group; a $C_6$-$C_{60}$ aryl group unsubstituted or substituted with deuterium, -F, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_1$-$C_{60}$ heteroaryl group; a monovalent non-aromatic condensed polycyclic group; or a monovalent non-aromatic condensed heteropolycyclic group.

Another aspect provides an organic light-emitting device including a first electrode; a second electrode; and an organic layer including an emission layer disposed between the first electrode and the second electrode, wherein the organic layer includes at least one organometallic compound described above.

The organometallic compound may be included in the emission layer, and the organometallic compound included in the emission layer may serve as a dopant.

Another aspect provides an electronic apparatus including the organic light-emitting device.

BRIEF DESCRIPTION OF THE DRAWINGS

The above and other aspects, features, and advantages of certain embodiments of the disclosure will be more apparent from the following description taken in conjunction with the accompanying drawings, in which FIGURE is a schematic view of a structure of an organic light-emitting device according to an embodiment.

FIG. 1 shows a schematic cross-sectional view of an organic light-emitting device according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

An aspect of the present disclosure provides an organometallic compound represented by Formula 1 below:

<Formula 1> $M (L_1)_{n1}(L_2)_{n2}$

In Formula 1, M may be a transition metal.

For example, M may be a first-row transition metal, a second-row transition metal, or a third-row transition metal, of the Periodic Table of Elements.

In one embodiment, M may be iridium (Ir), platinum (Pt), osmium (Os), titanium (Ti), zirconium (Zr), hafnium (Hf), europium (Eu), terbium (Tb), thulium (Tm), or rhodium (Rh).

In one embodiment, M may be Ir, Pt, Os, or Rh.

In Formula 1, $L_1$ may be a ligand represented by Formula 2 below, and $L_2$ may be a ligand represented by Formula 3 below:

<Formula 2>

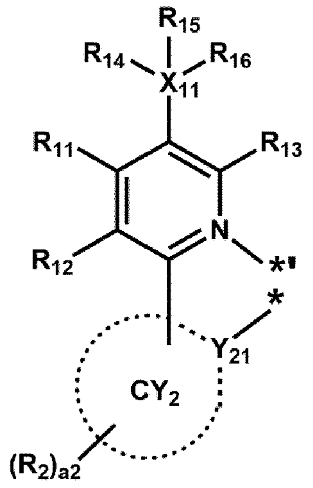

<Formula 3>

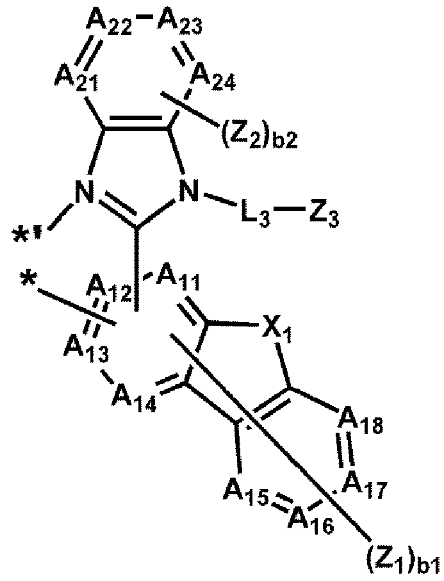

Formulae 2 and 3 may each be understood by referring to the corresponding descriptions thereof provided herein.

In Formula 1, $L_1$ and $L_2$ may be different from each other.

In Formula 1, n1 and n2 indicate the number of $L_1$ and the number of $L_2$, respectively, and may each independently be 1 or 2. When n1 is 2, two $L_1$(s) may be identical to or different from each other, and when n2 is 2, two $L_2$(s) may be identical to or different from each other.

For example, in Formula 1, i) n1 may be 2, and n2 may be 1; or ii) n1 may be 1, and n2 may be 2, but embodiments of the present disclosure are not limited thereto.

In one embodiment, in Formula 1, i) M may be Ir or Os, and the sum of n1 + n2 may be 3 or 4; or ii) M may be Pt, and the sum of n1 + n2 may be 2.

In Formula 2, $Y_{21}$ may be C or N.

For example, $Y_{21}$ may be C.

In Formula 2, ring $CY_2$ may be a $C_5$-$C_{30}$ carbocyclic group or a $C_1$-$C_{30}$ heterocyclic group.

For example, ring $CY_2$ may be i) a first ring, ii) a second ring, iii) a condensed ring in which two or more first rings are condensed with each other, iv) a condensed ring in which two or more second rings are condensed with each other, or v) a condensed ring in which one or more first rings and one or more second rings are condensed with each other.

The first ring may be a cyclopentane group, a cyclopentadiene group, a furan group, a thiophene group, a pyrrole group, a silole group, a germole group, a borole group, a selenophene group, a phosphole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaselenophene group, or an azaphosphole group.

The second ring may be an adamantane group, a norbornane group (a bicyclo[2.2.1]heptane group), a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

In one embodiment, ring $CY_2$ may be a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group,

an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

In one embodiment, ring $CY_2$ may be a benzene group, a naphthalene group, an anthracene group, a phenanthrene group, a 1,2,3,4-tetrahydronaphthalene group, an indole group, a carbazole group, a fluorene group, a dibenzosilole group, a dibenzothiophene group, a dibenzofuran group, an azabenzosilole group, a pyridine group, a benzimidazole group, a benzoxazole group, or a benzothiazole group.

In one embodiment, ring $CY_2$ may be a benzene group, a naphthalene group, an anthracene group, a phenanthrene group, a 1,2,3,4-tetrahydronaphthalene group, a carbazole group, a fluorene group, a dibenzosilole group, a dibenzothiophene group, or a dibenzofuran group.

In Formula 2, $X_{11}$ may be Si or Ge.

In Formula 3, $X_1$ may be O, S, Se, $N(Z_{19})$, $C(Z_{19})(Z_{20})$, or $Si(Z_{19})(Z_{20})$. $Z_{19}$ and $Z_{20}$ may each be understood by referring to the corresponding descriptions thereof provided herein.

For example, $X_1$ may be O, S, or $N(Z_{19})$.

In Formula 3, $A_{11}$ to $A_{14}$ may each independently be C or N, wherein one of $A_{11}$ to $A_{14}$ may be C bonded to a group represented by

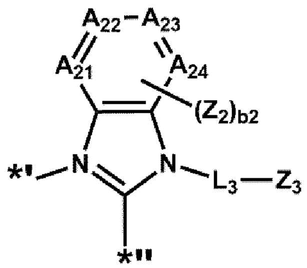

in Formula 3, and one of the remaining $A_{11}$ to $A_{14}$ may be C bonded to M in Formula 1.

In Formula 3, $A_{15}$ to $A_{18}$ and $A_{21}$ to $A_{24}$ may each independently be C or N.

In Formula 3, at least one of $A_{11}$ to $A_{18}$ may be N.

For example, one or two of $A_{11}$ to $A_{18}$ in Formula 3 may be N.

In one embodiment, in Formula 3, one or two of $A_{13}$ to $A_{18}$ may be N.

In one embodiment, in Formula 3, one or two of $A_{15}$ to $A_{18}$ may be N.

In one embodiment, in Formula 3, $A_{18}$ may be N.

In one or more embodiments, $A_{21}$ to $A_{24}$ in Formula 3 may each be C.

In one or more embodiments, at least one of $A_{21}$ to $A_{24}$ (for example, one or two of $A_{21}$ to $A_{24}$) in Formula 3 may be N.

In Formula 3, $L_3$ may be a single bond, a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$.

For example, $L_3$ may be:

a single bond; or

a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with at least one $R_{10a}$.

In one embodiment, $L_3$ in Formula 3 may be:

a single bond; or
a benzene group unsubstituted or substituted with at least one $R_{10a}$.

In one embodiment, $L_3$ in Formula 3 may be:

a single bond; or
a benzene group, a naphthalene group, a dibenzofuran group, or a dibenzothiophene group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

In Formulae 2 and 3, $R_2$, $R_{11}$ to $R_{16}$, $Z_1$ to $Z_3$, $Z_{19}$, and $Z_{20}$ may each independently be hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), - Si($Q_3$)($Q_4$)($Q_5$), -Ge($Q_3$)($Q_4$)($Q_5$), -B($Q_6$)($Q_7$), -P(=O)($Q_8$)($Q_9$), or -P($Q_8$)($Q_9$). $Q_1$ to $Q_9$ are the same as described above.

For example, each of $R_2$, $Z_1$ and $Z_2$ may not be hydrogen.

For example, $R_2$, $R_{11}$ to $R_{16}$, $Z_1$ to $Z_3$, $Z_{19}$, and $Z_{20}$ in Formulae 2 and 3 may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -$SF_5$, a $C_1$-$C_{20}$ alkyl group, or a $C_1$-$C_{20}$ alkoxy group;
a $C_1$-$C_{20}$ alkyl group or a $C_1$-$C_{20}$ alkoxy group, each substituted with deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterated $C_1$-$C_{20}$ alkyl group, a cyclopentyl group, a cyclohexyl group, a cycloheptyl group, a cyclooctyl group, an adamantanyl group, a norbornanyl group (a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl) cyclopentyl group, a ($C_1$-$C_{20}$ alkyl) cyclohexyl group, a ($C_1$-$C_{20}$ alkyl) cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a 1,2,3,4-tetrahydronaphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a

cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterated $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, - $Si(Q_{33})(Q_{34})(Q_{35})$, $-Ge(Q_{33})(Q_{34})(Q_{35})$, or any combination thereof; or
$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_9)$, and
$Q_1$ to $Q_9$ and $Q_{33}$ to $Q_{35}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$,$-CHDCH_3$, $-CHDCD_2H$, $-CHDCDH_2$, $-CHDCD_3$, $-CD_2CD_3$, $-CD_2CD_2H$, or $-CD_2CDH_2$; or
an n-propyl group, an isopropyl group, an n-butyl group, a sec-butyl group, an isobutyl group, a tert-butyl group, an n-pentyl group, a tert-pentyl group, an neopentyl group, an isopentyl group, a sec-pentyl group, a 3-pentyl group, a secisopentyl group, a phenyl group, a biphenyl group, or a naphthyl group, each unsubstituted or substituted with deuterium, a $C_1$-$C_{20}$ alkyl group, a phenyl group, or any combination thereof.

In one embodiment, $R_2$, $R_{11}$ to $R_{13}$, $Z_1$ to $Z_3$, $Z_{19}$ and $Z_{20}$ in Formulae 2 and 3 may each independently be:

hydrogen, deuterium, -F, or a cyano group; or
a $C_1$-$C_{20}$ alkyl group, a $C_3$-$C_{10}$ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, $-Si(Q_{33})(Q_{34})(Q_{35})$, $-Ge(Q_{33})(Q_{34})(Q_{35})$, or any combination thereof.

In one embodiment, $R_{14}$ to $R_{16}$ in Formula 2 may each independently be a $C_1$-$C_{20}$ alkyl group, a $C_3$-$C_{10}$ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.
In one or more embodiments, $R_{14}$ to $R_{16}$ in Formula 2 may each independently be $-CH_3$, $-CH_2CH_3$, $-CD_3$,

$-CD_2H$, $-CDH_2$, $-CH_2CD_3$, or $-CD_2CH_3$.

In one or more embodiments, $R_{14}$ to $R_{16}$ in Formula 2 may be identical to or different from each other.

In one or more embodiments, $R_{11}$ in Formula 2 may not be hydrogen.

In one or more embodiments, $R_{11}$ in Formula 2 may not be hydrogen and a methyl group.

In one or more embodiments, $R_{11}$ in Formula 2 may not be hydrogen, a methyl group and a cyano group.

In one or more embodiments, in Formula 2, $R_{11}$ may not be hydrogen and $R_{12}$ and $R_{13}$ may be hydrogen.

In one or more embodiments, $R_{11}$ in Formula 2 may be a group including at least two carbons, at least three carbons or at least four carbons.

In one or more embodiments, $R_{11}$ in Formula 2 may be:

a methyl group, substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof; or

a $C_2$-$C_{20}$ alkyl group, a $C_3$-$C_{10}$ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

In one or more embodiments, $Z_3$ may in Formula 3 be a $C_6$-$C_{20}$ aryl group substituted with at least one $C_1$-$C_{20}$ alkyl group and at least one $C_6$-$C_{20}$ aryl group at the same time.

In one or more embodiments, Formula 3 may satisfy at least one of <Condition A> and <Condition B> :

<Condition A>

$L_3$ is a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$.

<Condition B>

$Z_3$ is a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

In some embodiments, $R_2$, $R_{11}$ to $R_{16}$, $Z_1$ to $Z_3$, $Z_{19}$ and $Z_{20}$ in Formulae 2 and 3 may each independently be hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, $-OCH_3$, $-OCDH_2$, $-OCD_2H$,$-OCD_3$, $-SCH_3$, $-SCDH_2$, $-SCD_2H$, $-SCD_3$, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, a group represented by one of Formulae 10-201 to 10-354 in which at least one hydrogen is substituted with -F, $-Si(Q_3)(Q_4)(Q_5)$, or $-Ge(Q_3)(Q_4)(Q_5)$, wherein $Q_3$ to $Q_5$ may respectively be understood by referring to the descriptions of $Q_3$ to $Q_5$ provided herein.

In some embodiments, $R_{11}$ in Formula 2 may be a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one

of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, or a group represented by one of Formulae 10-201 to 10-354 in which at least one hydrogen is substituted with -F.

In some embodiments, $Z_3$ in Formula 3 may be a group represented by one of Formulae 10-12 to 10-145, a group represented by one of Formulae 10-12 to 10-145 in which at least one hydrogen is substituted with deuterium, a group represented by one of Formulae 10-12 to 10-145 in which at least one hydrogen is substituted with -F, a group represented by one of Formulae 10-201 to 10-354, a group represented by one of Formulae 10-201 to 10-354 in which at least one hydrogen is substituted with deuterium, or a group represented by one of Formulae 10-201 to 10-354 in which at least one hydrogen is substituted with -F:

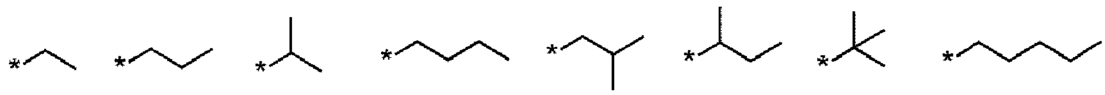
9-1 9-2 9-3 9-4 9-5 9-6 9-7 9-8

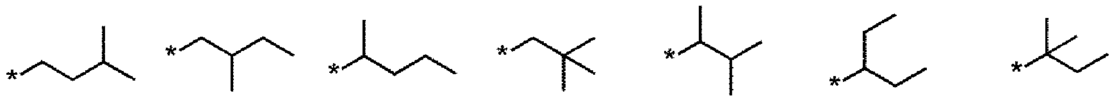
9-9 9-10 9-11 9-12 9-13 9-14 9-15

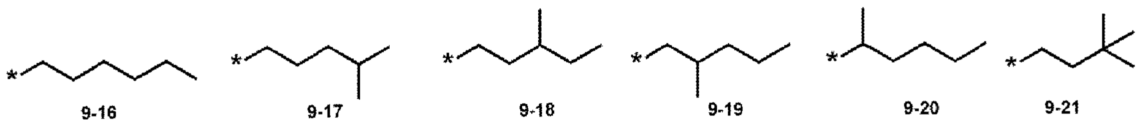
9-16 9-17 9-18 9-19 9-20 9-21

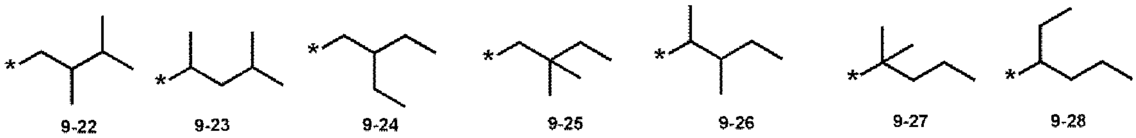
9-22 9-23 9-24 9-25 9-26 9-27 9-28

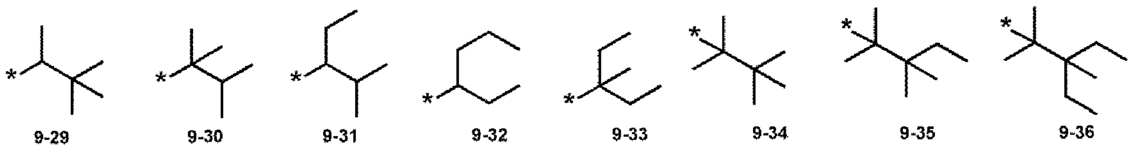
9-29 9-30 9-31 9-32 9-33 9-34 9-35 9-36

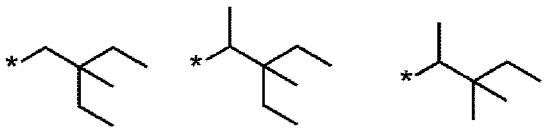
9-37 9-38 9-39

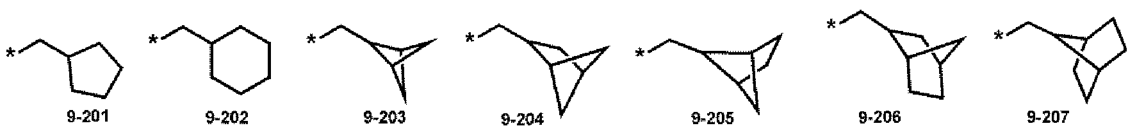
9-201 9-202 9-203 9-204 9-205 9-206 9-207

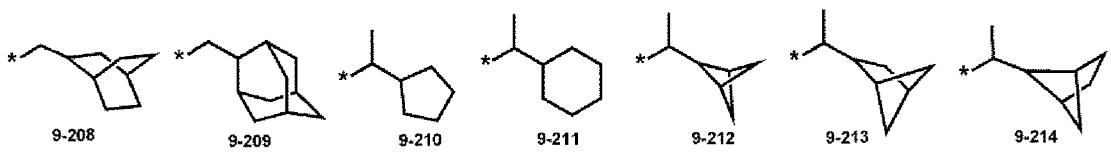
9-208 9-209 9-210 9-211 9-212 9-213 9-214

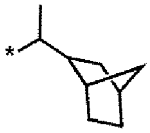
9-215
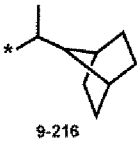
9-216
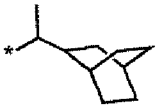
9-217
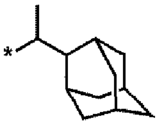
9-218
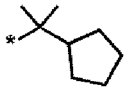
9-219
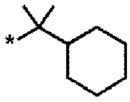
9-220
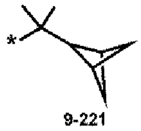
9-221

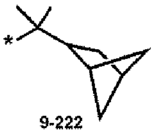
9-222
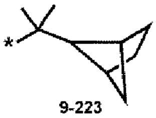
9-223
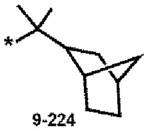
9-224
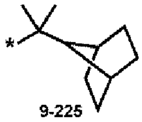
9-225
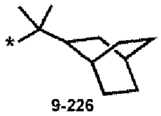
9-226
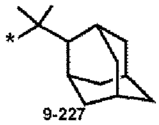
9-227
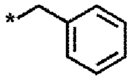
9-228

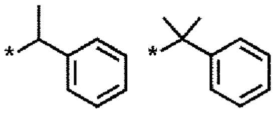
9-229
9-230

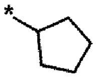
10-1
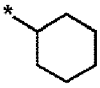
10-2
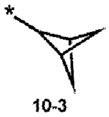
10-3
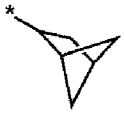
10-4
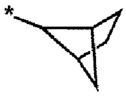
10-5
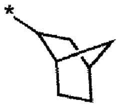
10-6
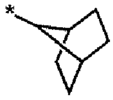
10-7
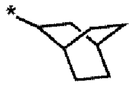
10-8

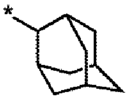
10-9
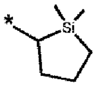
10-10
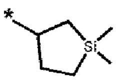
10-11
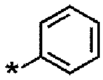
10-12
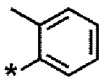
10-13
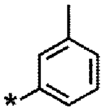
10-14
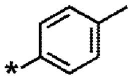
10-15
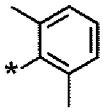
10-16

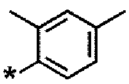
10-17
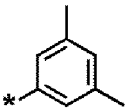
10-18
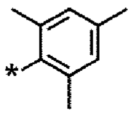
10-19
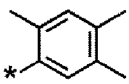
10-20
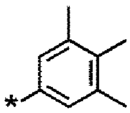
10-21
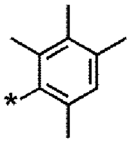
10-22
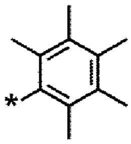
10-23

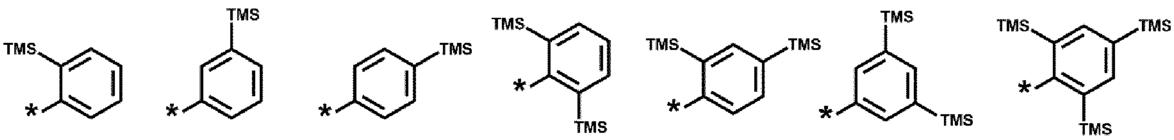
10-24
10-25
10-26
10-27
10-28
10-29
10-30

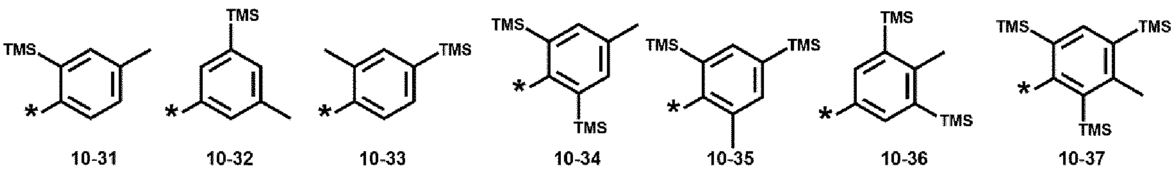
10-31
10-32
10-33
10-34
10-35
10-36
10-37

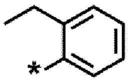 10-38 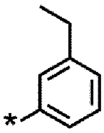 10-39 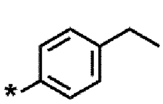 10-40 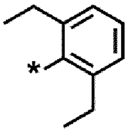 10-41 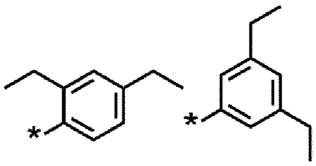 10-42 10-43 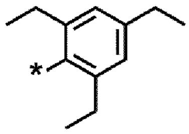 10-44

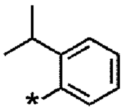 10-45 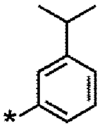 10-46 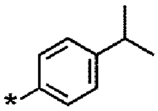 10-47 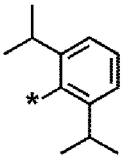 10-48 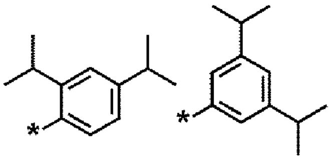 10-49 10-50 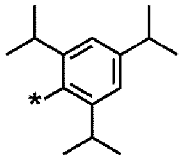 10-51

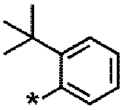 10-52 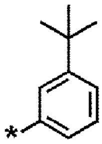 10-53 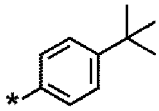 10-54 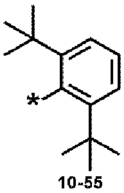 10-55 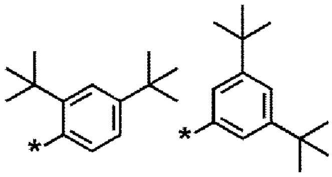 10-56 10-57 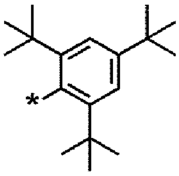 10-58

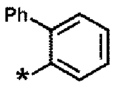 10-59 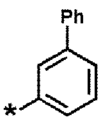 10-60 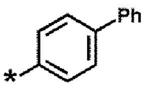 10-61 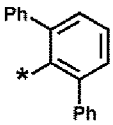 10-62 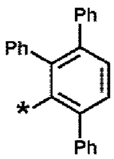 10-63 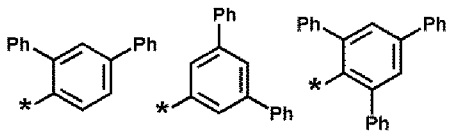 10-64 10-65 10-66

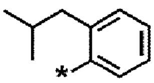 10-67 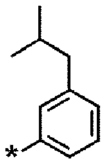 10-68 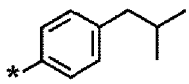 10-69 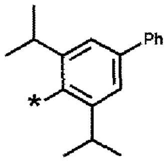 10-70 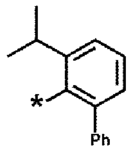 10-71 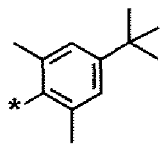 10-72

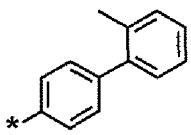 10-73 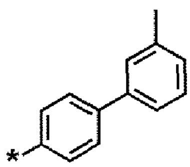 10-74 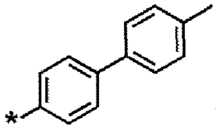 10-75 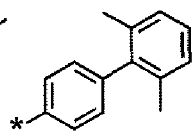 10-76 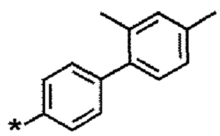 10-77

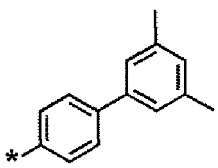 10-78 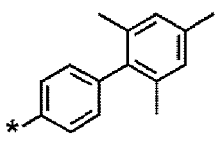 10-79 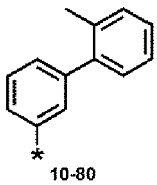 10-80 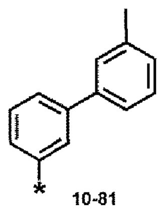 10-81 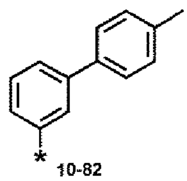 10-82

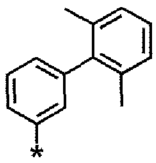
10-83

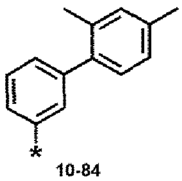
10-84

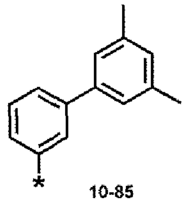
10-85

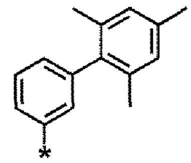
10-86

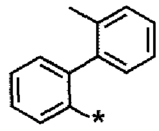
10-87

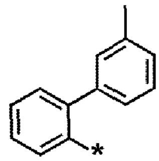
10-88

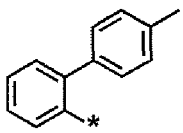
10-89

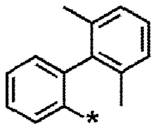
10-90

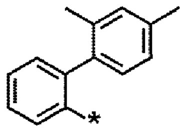
10-91

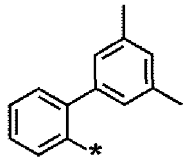
10-92

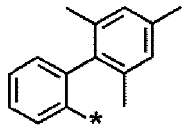
10-93

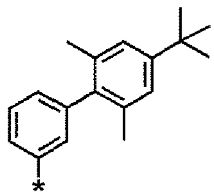
10-94

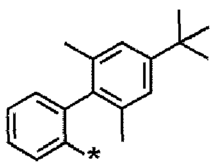
10-95

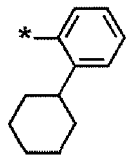
10-96

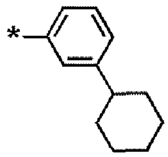
10-97

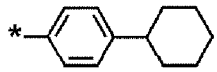
10-98

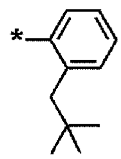
10-99

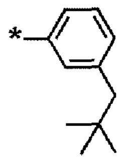
10-100

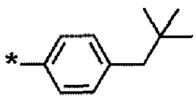
10-101

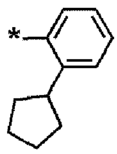
10-102

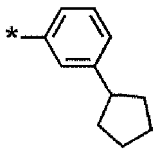
10-103

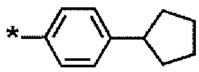
10-104

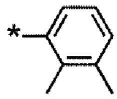
10-105

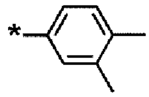
10-106

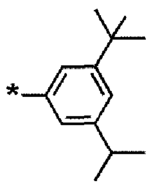
10-107

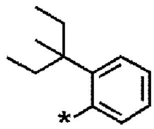
10-108

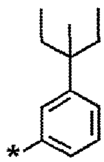
10-109

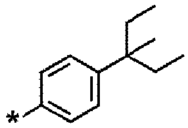
10-110

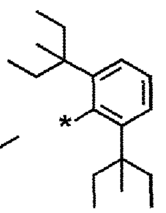
10-111

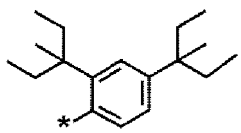
10-112

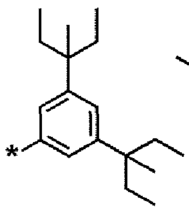
10-113

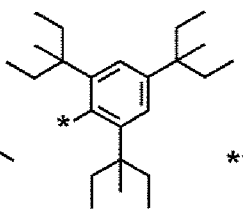
10-114

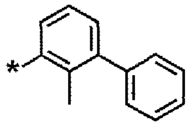
10-115

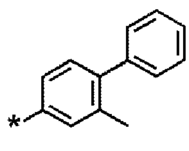
10-116

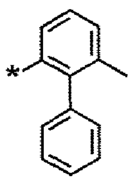
10-117

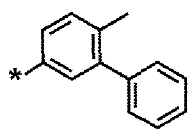
10-118

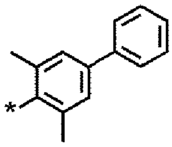
10-119
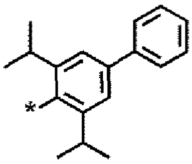
10-120
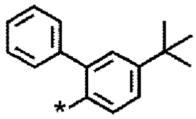
10-121
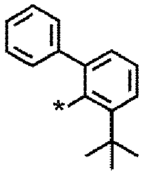
10-122
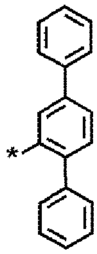
10-123
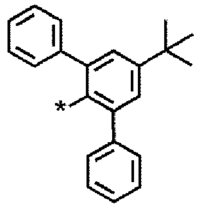
10-124

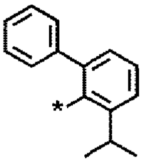
10-125
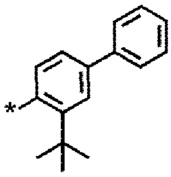
10-126
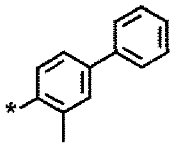
10-127
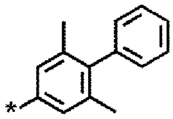
10-128
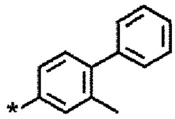
10-129
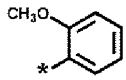
10-130

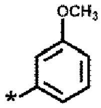
10-131
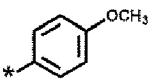
10-132
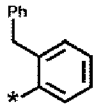
10-133
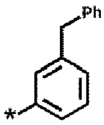
10-134
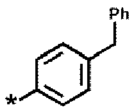
10-135
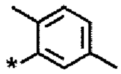
10-136
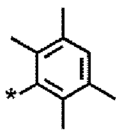
10-137
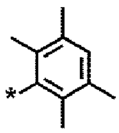
10-138

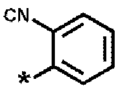
10-139
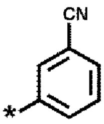
10-140
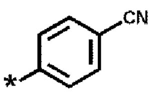
10-141
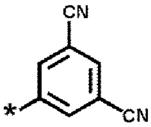
10-142
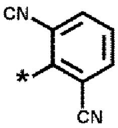
10-143
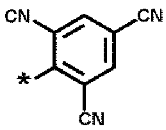
10-144
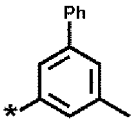
10-145

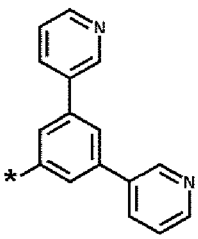
10-201
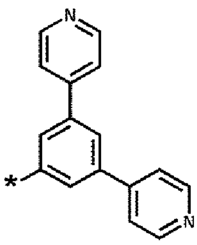
10-202
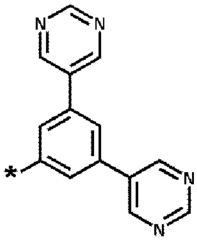
10-203
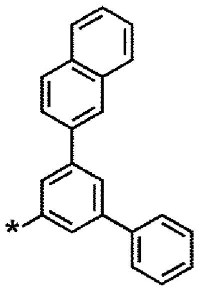
10-204
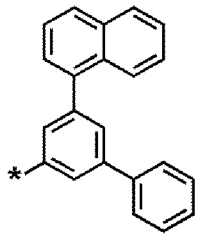
10-205

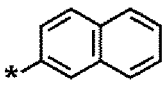
10-206
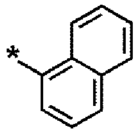
10-207
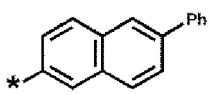
10-208
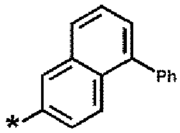
10-209
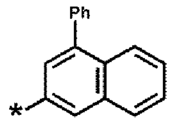
10-210

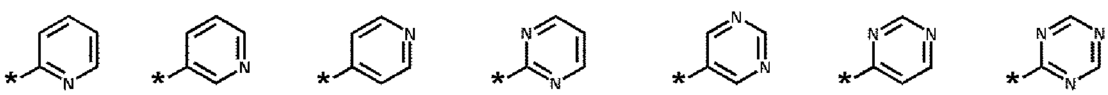
10-211 10-212 10-213 10-214 10-215 10-216 10-217

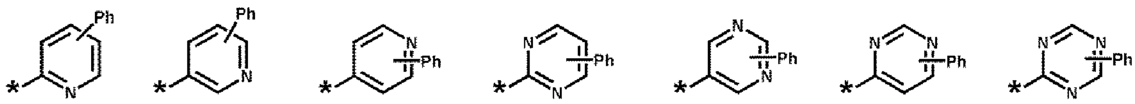
10-218 10-219 10-220 10-221 10-222 10-223 10-224

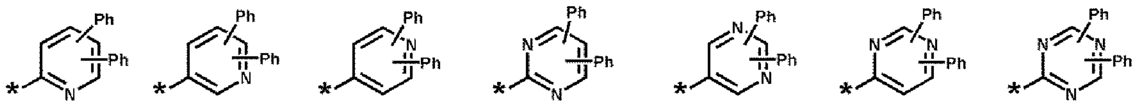
10-225 10-226 10-227 10-228 10-229 10-230 10-231

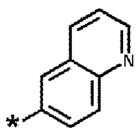 10-232
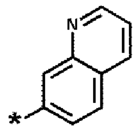 10-233
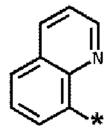 10-234
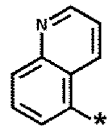 10-235
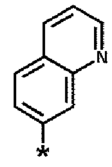 10-236
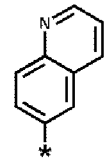 10-237

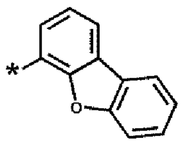 10-238
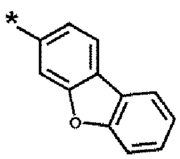 10-239
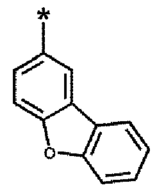 10-240
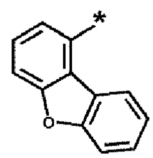 10-241
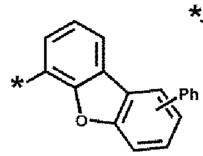 10-242
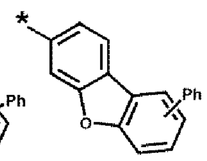 10-243

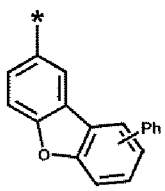 10-244
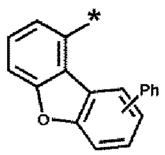 10-245
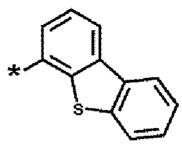 10-246
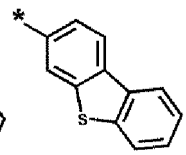 10-247
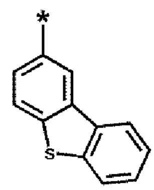 10-248
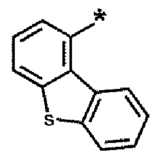 10-249

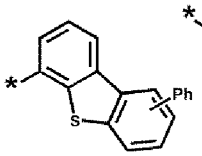 10-250
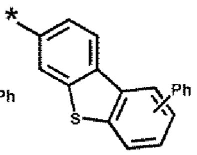 10-251
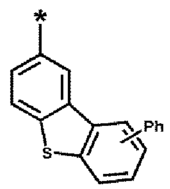 10-252
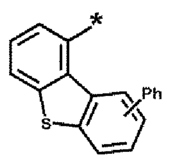 10-253
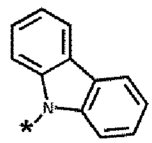 10-254
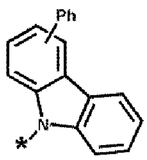 10-255

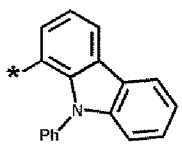 10-256
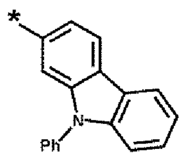 10-257
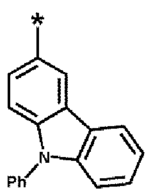 10-258
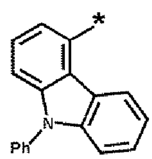 10-259
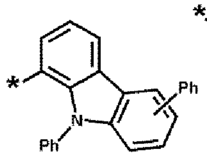 10-260
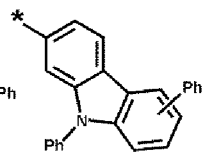 10-261

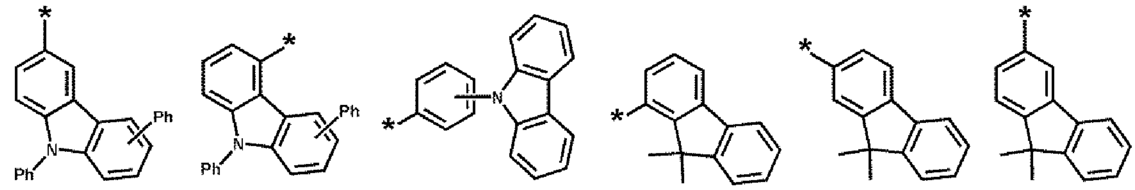

10-262 10-263 10-264 10-265 10-266 10-267

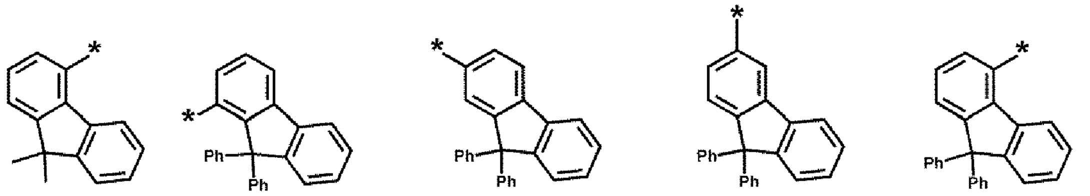

10-268 10-269 10-270 10-271 10-272

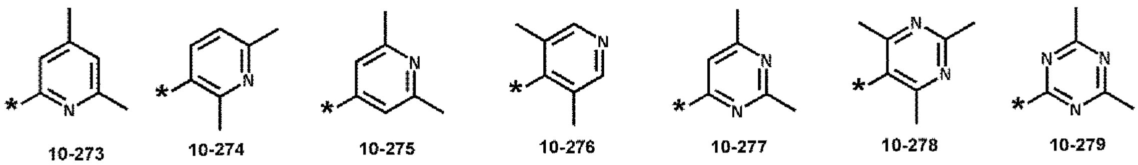

10-273 10-274 10-275 10-276 10-277 10-278 10-279

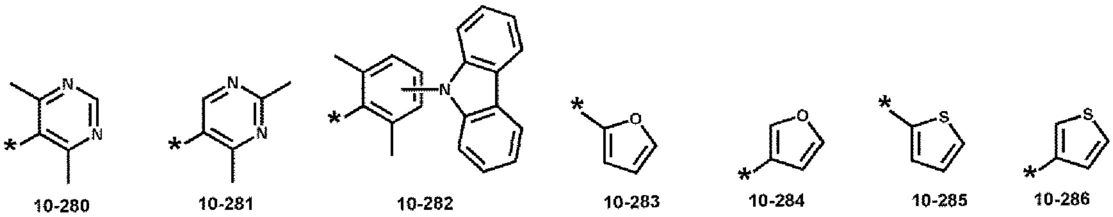

10-280 10-281 10-282 10-283 10-284 10-285 10-286

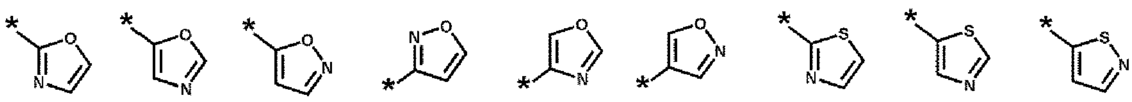

10-287 10-288 10-289 10-290 10-291 10-292 10-293 10-294 10-295

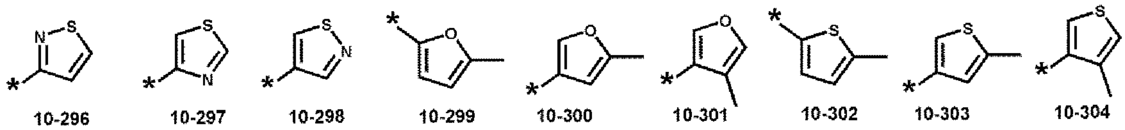

10-296 10-297 10-298 10-299 10-300 10-301 10-302 10-303 10-304

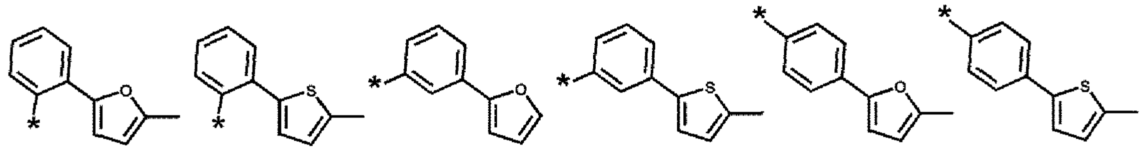

10-305 10-306 10-307 10-308 10-309 10-310

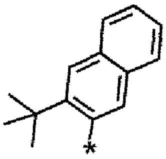
10-311
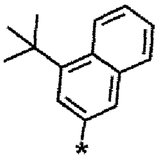
10-312
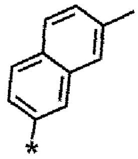
10-313
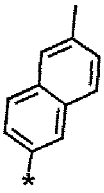
10-314
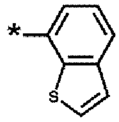
10-315
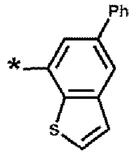
10-316
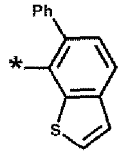
10-317

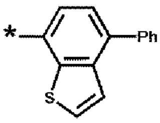
10-318
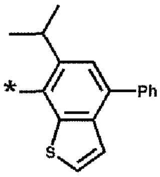
10-319
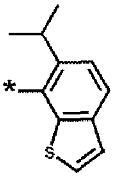
10-320
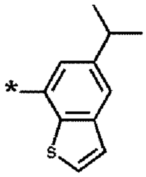
10-321
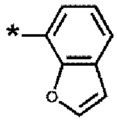
10-322
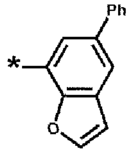
10-323
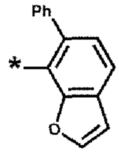
10-324

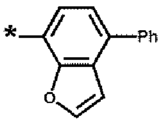
10-325
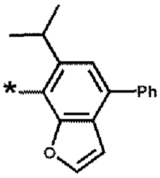
10-326
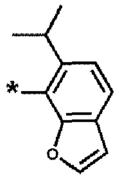
10-327
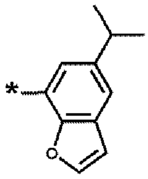
10-328
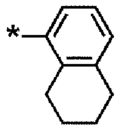
10-329
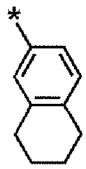
10-330
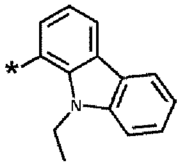
10-331

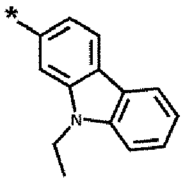
10-332
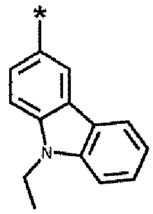
10-333
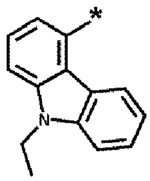
10-334
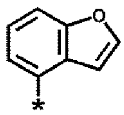
10-335
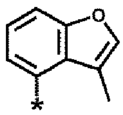
10-336
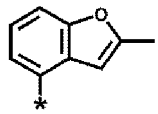
10-337

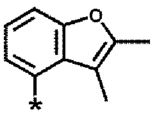
10-338
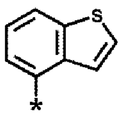
10-339
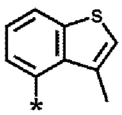
10-340
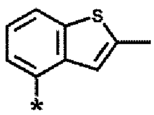
10-341
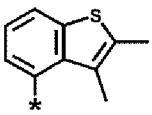
10-342
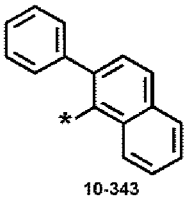
10-343

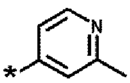
10-344
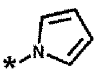
10-345
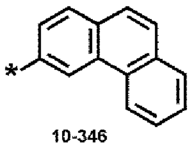
10-346
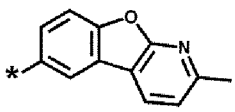
10-347
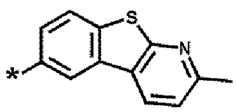
10-348

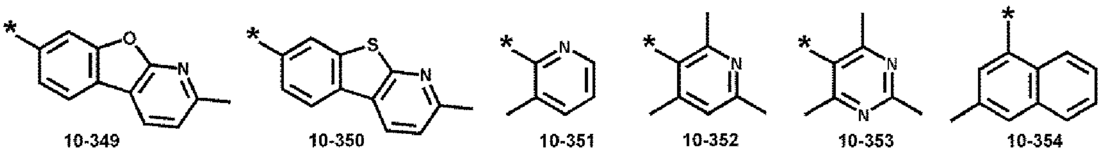
10-349 10-350 10-351 10-352 10-353 10-354

In Formulae 9-1 to 9-39, 9-201 to 9-230, 10-1 to 10-145, and 10-201 to 10-354, * indicates a binding site to an adjacent atom, "Ph" represents a phenyl group, "TMS" represents a trimethylsilyl group, "TMG" represents a trimethylgermyl group and "OMe" represents a methoxy group.

The "group represented by one of Formulae 9-1 to 9-39 in which at least one hydrogen is substituted with deuterium" and the "group represented by one of Formulae 9-201 to 9-230 in which at least one hydrogen is substituted with deuterium" may each be, for example, a group represented by one of Formulae 9-501 to 9-514 and 9-601 to 9-637:

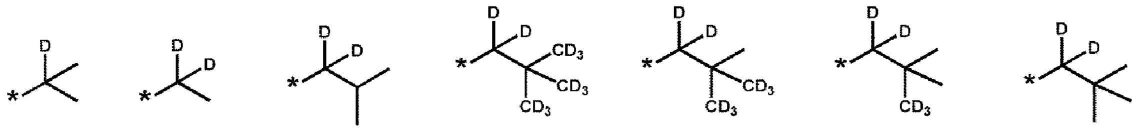
9-501 9-502 9-503 9-504 9-505 9-506 9-507

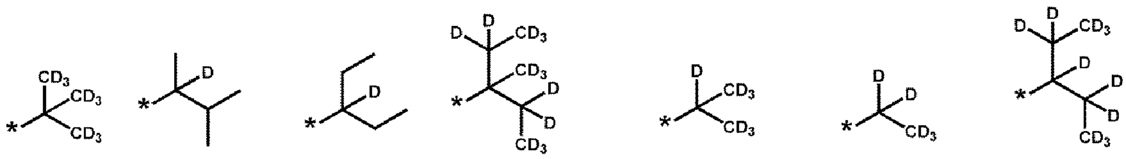
9-508 9-509 9-510 9-511 9-512 9-513 9-514

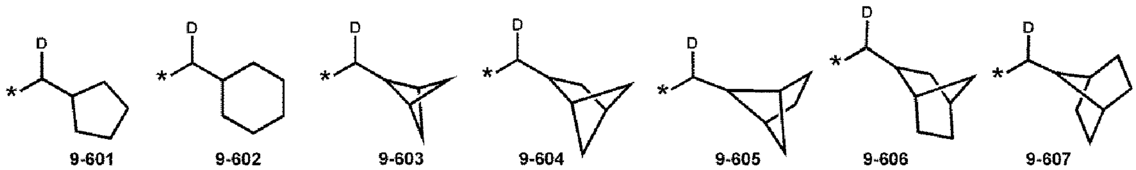
9-601 9-602 9-603 9-604 9-605 9-606 9-607

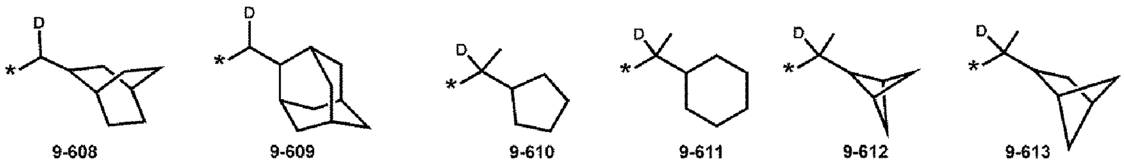
9-608 9-609 9-610 9-611 9-612 9-613

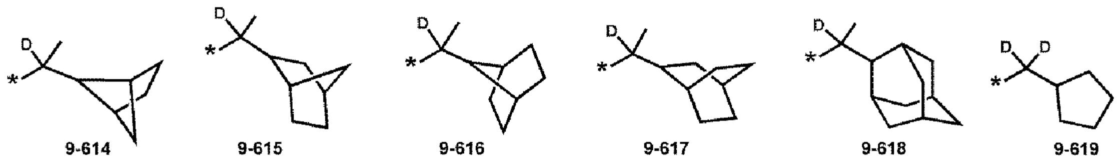
9-614 9-615 9-616 9-617 9-618 9-619

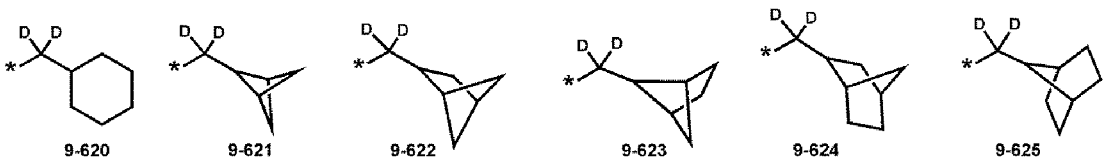
9-620 9-621 9-622 9-623 9-624 9-625

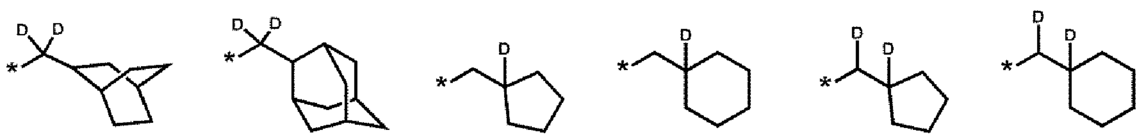
9-626 9-627 9-628 9-629 9-630 9-631

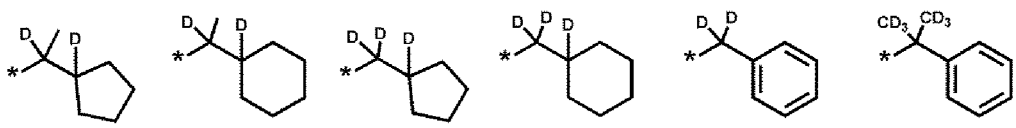
9-632 9-633 9-634 9-635 9-636 9-637

The "group represented by one of Formulae 9-1 to 9-39 in which at least one hydrogen is substituted with -F" and the "group represented by one of Formulae 9-201 to 9-230 in which at least one hydrogen is substituted with -F" may each be, for example, a group represented by one of Formulae 9-701 to 9-710:

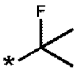 9-701
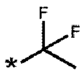 9-702
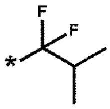 9-703
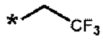 9-704
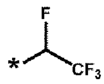 9-705
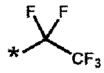 9-706
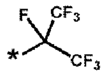 9-707

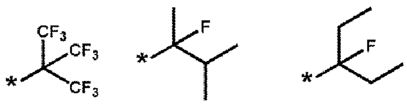 9-708
9-709
9-710

The "group represented by one of Formulae 10-1 to 10-145 in which at least one hydrogen is substituted with a deuterium" and the "group represented by one of Formulae 10-201 to 10-354 in which at least one hydrogen is substituted with deuterium" may each be, for example, a group represented by one of Formulae 10-501 to 10-553:

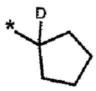 10-501
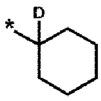 10-502
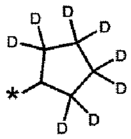 10-503
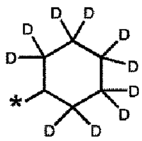 10-504
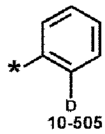 10-505
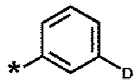 10-506
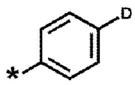 10-507
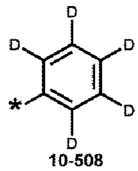 10-508

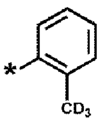 10-509
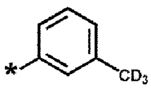 10-510
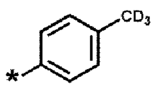 10-511
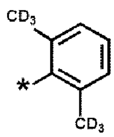 10-512
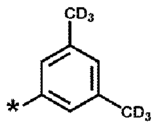 10-513
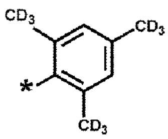 10-514
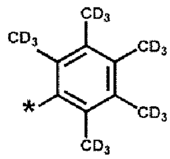 10-515

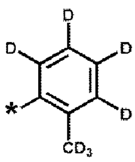 10-516
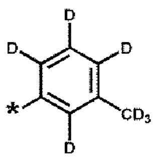 10-517
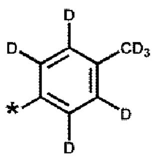 10-518
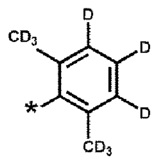 10-519
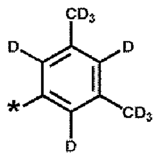 10-520
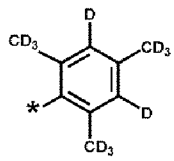 10-521

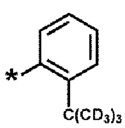 10-522
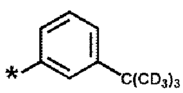 10-523
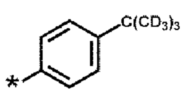 10-524
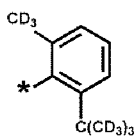 10-525
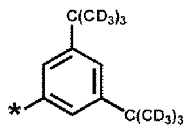 10-526
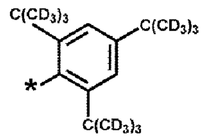 10-527

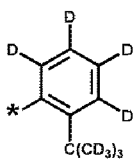 10-528
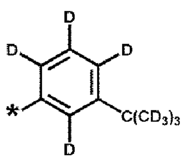 10-529
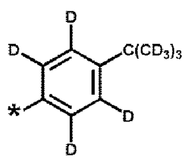 10-530
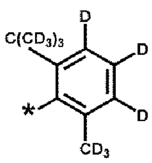 10-531
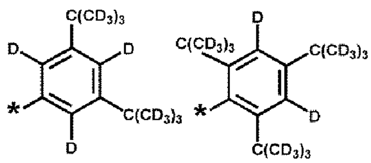 10-532
10-533

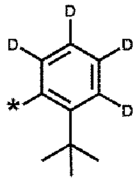
10-534

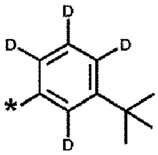
10-535

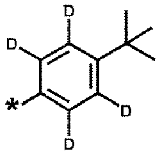
10-536

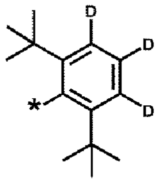
10-537

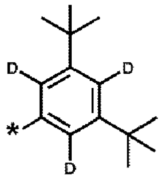
10-538

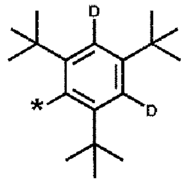
10-540

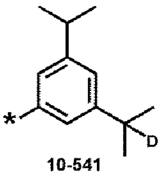
10-541

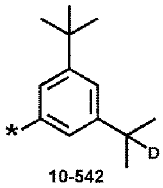
10-542

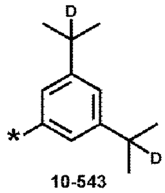
10-543

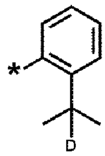
10-544

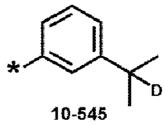
10-545

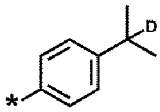
10-546

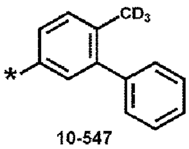
10-547

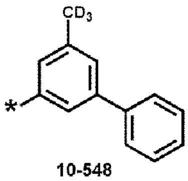
10-548

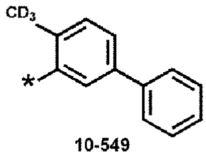
10-549

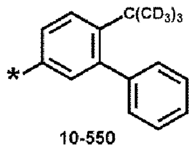
10-550

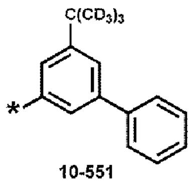
10-551

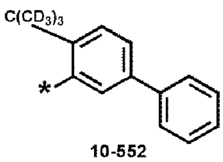
10-552

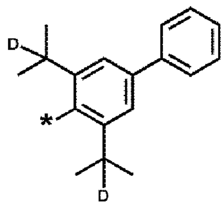
10-553

The "group represented by one of Formulae 10-1 to 10-145 in which at least one hydrogen is substituted with -F" and the "group represented by one of Formulae 10-201 to 10-354 in which at least one hydrogen is substituted with -F" may each be, for example, a group represented by one of Formulae 10-601 to 10-636:

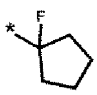
10-601

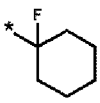
10-602

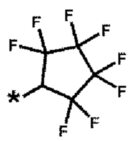
10-603

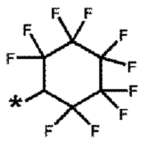
10-604

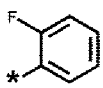
10-605

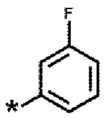
10-606

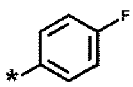
10-607

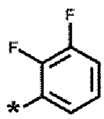
10-608

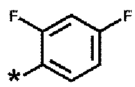
10-609

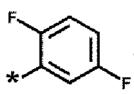
10-610

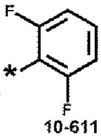
10-611

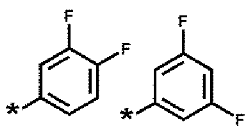
10-612 10-613

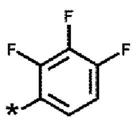
10-614

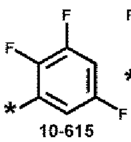
10-615

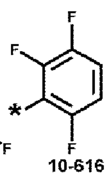
10-616

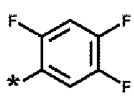
10-617

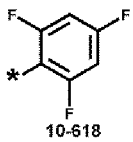
10-618

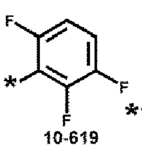
10-619

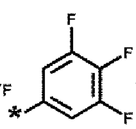
10-620

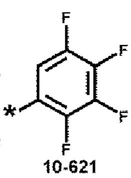
10-621

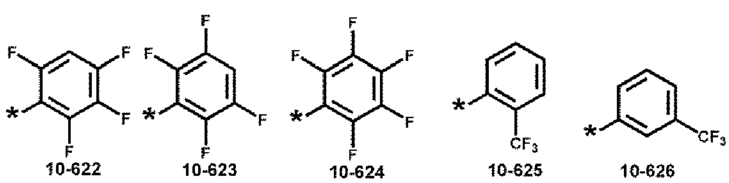
10-622 10-623 10-624 10-625 10-626

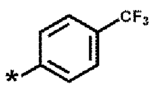
10-627

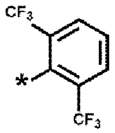
10-628

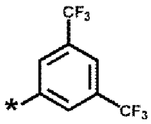
10-629

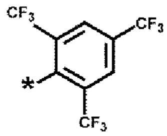
10-630

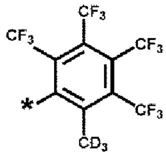
10-631

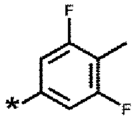
10-632

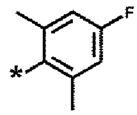
10-633

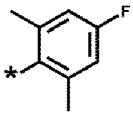
10-634

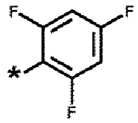
10-635

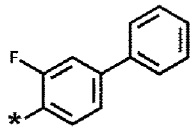
10-636

In Formulae 2 and 3, a2, b1, and b2 indicate the number of $R_2$(s), the number of $Z_1$(s), and the number of $Z_2$(s), respectively, wherein a2 may be an integer from 0 to 20 (for example, an integer from 0 to 10), b1 may be an integer 0 to 5, and b2 may be an integer from 0 to 4. When a2 is 2 or more, two or more $R_2$(s) may be identical to or different from each other, when b1 is 2 or more, two or more $Z_1$(s) may be identical to or different from each other, and when b2 is 2 or more, two or more $Z_2$(s) may be identical to or different from each other.

In one or more embodiments, in Formula 3, $Z_1$ may not be hydrogen and b1 may be an integer from 1 to 5.

In one or more embodiments, $Z_2$ in Formula 3 may not be hydrogen and b2 may be an integer from 1 to 4.

In one or more embodiments, the organometallic compound represented by Formula 1 may include deuterium, -F, or a combination thereof.

In one or more embodiments, the organometallic compound represented by Formula 1 may satisfy at least one of <Condition 1> to <Condition 12>:

<Condition 1>
$R_{11}$ is not hydrogen, and includes at least one deuterium.
<Condition 2>
At least one selected from $R_{11}$ to $R_{13}$ is not hydrogen, and includes at least one deuterium.
<Condition 3>
At least one of $R_2$(s) in the number of a2 is not hydrogen, and includes at least one deuterium.
<Condition 4>
$L_3$ is not a single bond, and includes at least one deuterium.
<Condition 5>
$Z_3$ is not hydrogen, and includes at least one deuterium.
<Condition 6>
At least one of $Z_1$(s) in the number of b1 is not hydrogen, and includes at least one deuterium.
<Condition 7>
$R_{11}$ is not hydrogen and includes at least one fluoro group (-F).
<Condition 8>
at least one of $R_{11}$ to $R_{13}$ is not hydrogen and includes at least one fluoro group.
<Condition 9>
at least one of $R_2$(s) in the number of a2 is not hydrogen and includes at least one fluoro group.
<Condition 10>
$L_3$ is not a single bond and may include at least one fluoro group.
<Condition 11>
$Z_3$ is not hydrogen and includes at least one fluoro group.
<Condition 12>
at least one of $Z_1$(s) in the number of b1 is not hydrogen and includes at least one fluoro group.

In Formulae 2 and 3, i) $R_{11}$ and $R_{12}$ may optionally be linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$, ii) two or more selected from a plurality of $R_2$(s) may optionally be linked to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$, iii) two or more selected from a plurality of $Z_1$(s) may optionally be linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$, or iv) two or more selected from a

plurality of $Z_2$(s) may optionally be linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$. $R_{10a}$ may be understood by referring to the description provided in connection with $Z_1$. For example, $R_{10a}$ may be understood by referring to the description provided in connection with $Z_1$, but may not be hydrogen.

In Formulae 2 and 3, * and *' each indicate a binding site to a neighboring atom.

In one embodiment, a group represented by

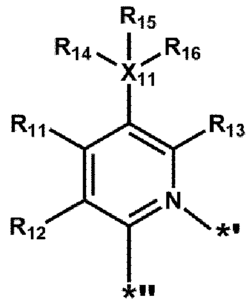

in Formula 2 may be a group represented by Formula 2-1 or 2-2:

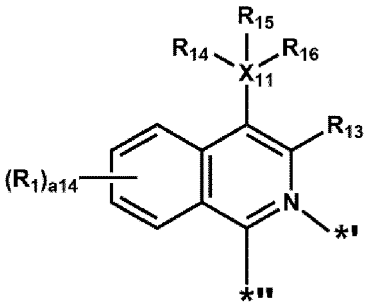

2-1

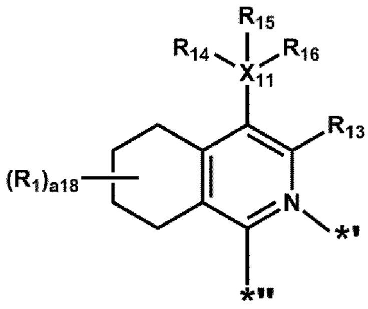

2-2

In Formulae 2-1 and 2-2,

$X_{11}$, and $R_{13}$ to $R_{16}$ may each be understood by referring to the corresponding descriptions thereof provided herein,
$R_1$ may be understood by referring to the description provided in connection with $R_{12}$,
a14 may be an integer from 0 to 4,
a18 may be an integer from 0 to 8,
*' indicates a binding site to M in Formula 1, and
*" indicates a binding site to a neighboring atom in Formula 2.

In one or more embodiments, a group represented by

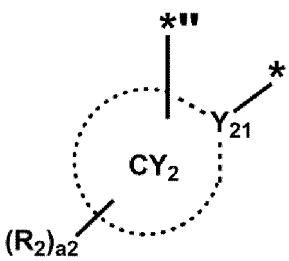

in Formula 2 may be a group represented by one of Formulae CY2-1 to CY2-33:

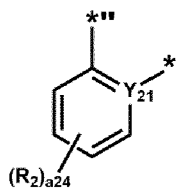
CY2-1

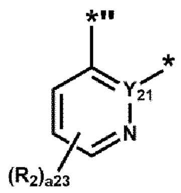
CY2-2

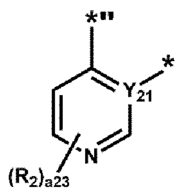
CY2-3

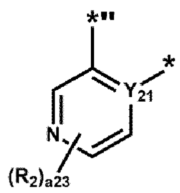
CY2-4

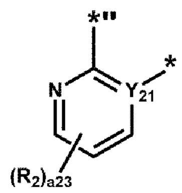
CY2-5

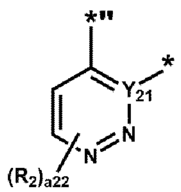
CY2-6

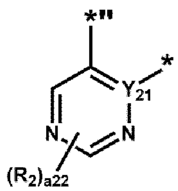
CY2-7

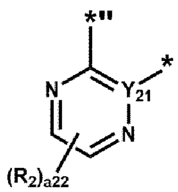
CY2-8

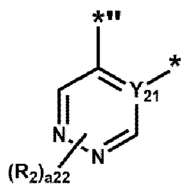
CY2-9

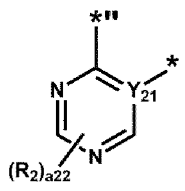
CY2-10

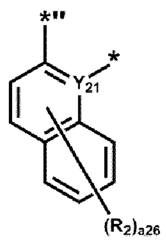
CY2-11

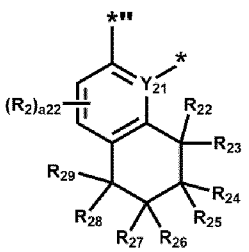
CY2-12

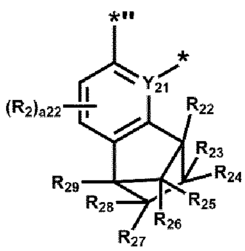
CY2-13

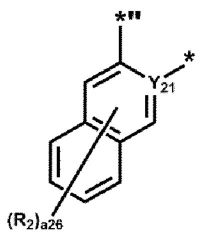
CY2-14

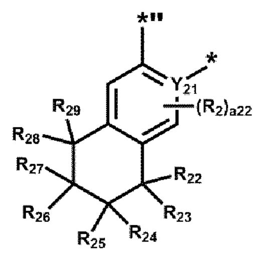
CY2-15

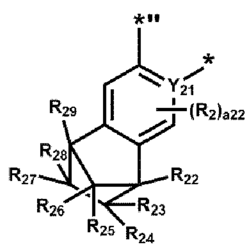
CY2-16

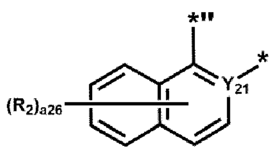
CY2-17

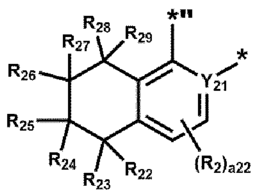
CY2-18

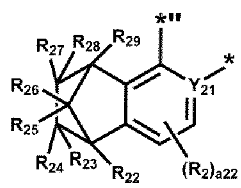
CY2-19

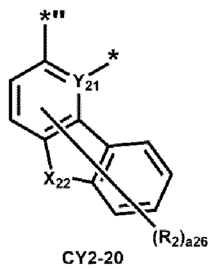
CY2-20

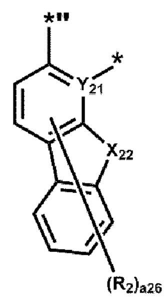
CY2-21

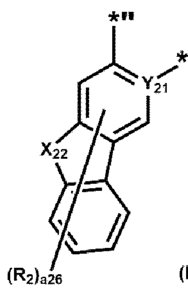
CY2-22

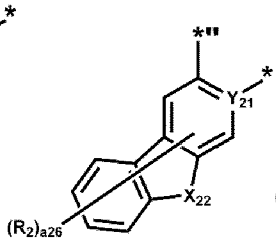
CY2-23

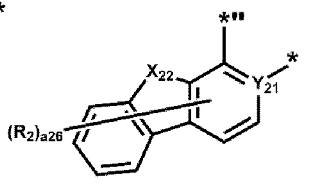
CY2-24

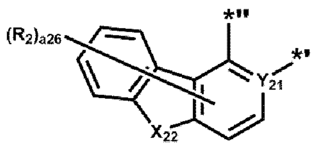

CY2-25

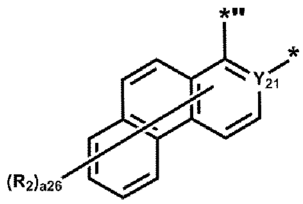

CY2-26

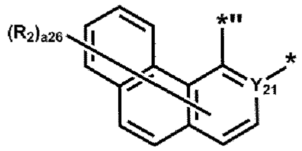

CY2-27

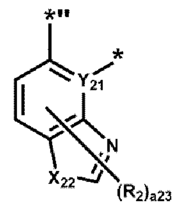

CY2-28

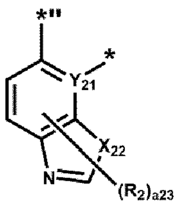

CY2-29

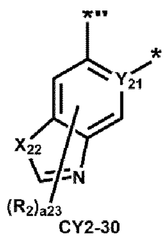

CY2-30

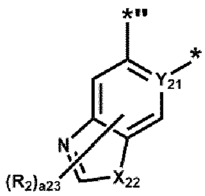

CY2-31

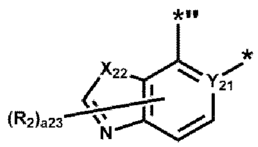

CY2-32

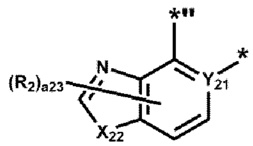

CY2-33

In Formulae CY2-1 to CY2-33,

$Y_{21}$ and $R_2$ may each be understood by referring to the descriptions thereof provided herein,
$X_{22}$ may be $C(R_{22})(R_{23})$, $N(R_{22})$, O, S, or $Si(R_{22})(R_{23})$,
$R_{22}$ to $R_{29}$ may each independently be understood by referring to the description provided in connection with $R_2$,
a28 may be an integer from 0 to 8,
a26 may be an integer from 0 to 6,
a24 may be an integer from 0 to 4,
a23 may be an integer from 0 to 3,
a22 may be an integer from 0 to 2,
*" indicates a binding site to a neighboring atom in Formula 2, and
* indicates a binding site to M in Formula 1.

In one or more embodiments, a group represented by

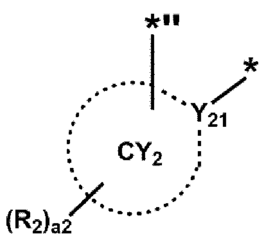

in Formula 2 may be a group represented by one of Formulae CY2(1) to CY2(56) or a group represented by one of Formulae CY2-11 to CY2-33:

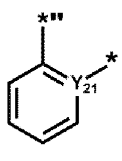

CY2(1)

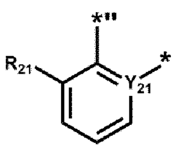

CY2(2)

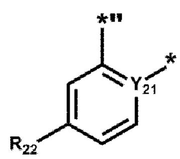

CY2(3)

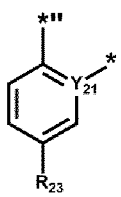

CY2(4)

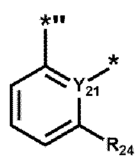

CY2(5)

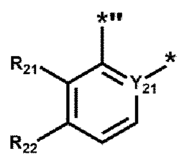

CY2(6)

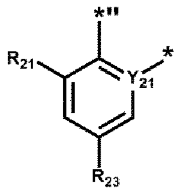
CY2(7)

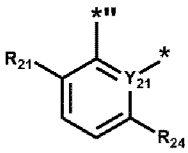
CY2(8)

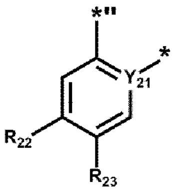
CY2(9)

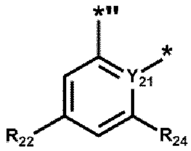
CY2(10)

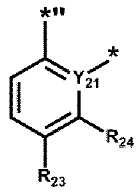
CY2(11)

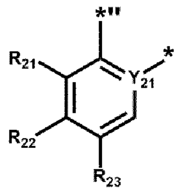
CY2(12)

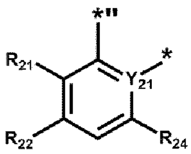
CY2(13)

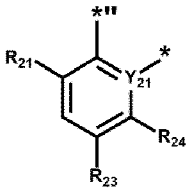
CY2(14)

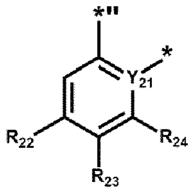
CY2(15)

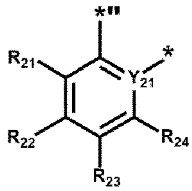
CY2(16)

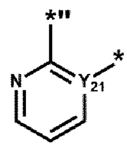
CY2(17)

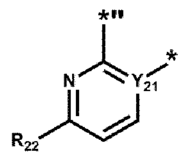
CY2(18)

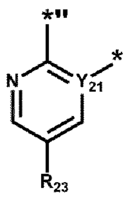
CY2(19)

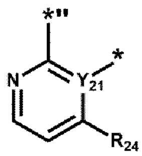
CY2(20)

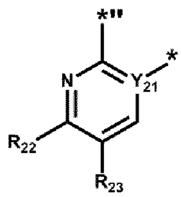
CY2(21)

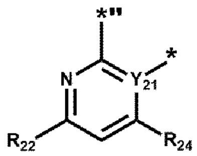
CY2(22)

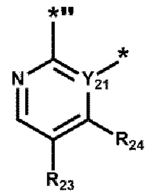
CY2(23)

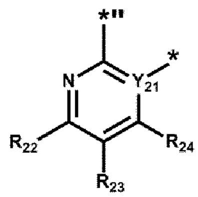
CY2(24)

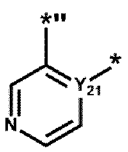
CY2(25)

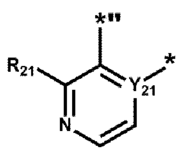
CY2(26)

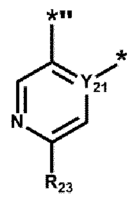
CY2(27)

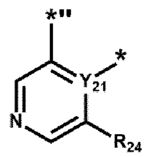
CY2(28)

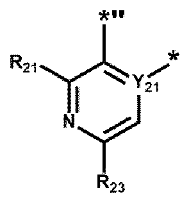
CY2(29)

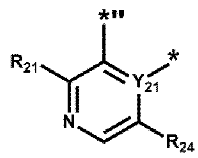
CY2(30)

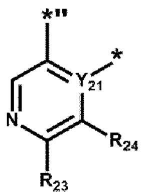
CY2(31)

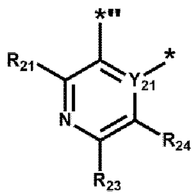
CY2(32)

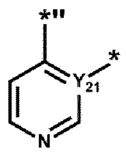
CY2(33)

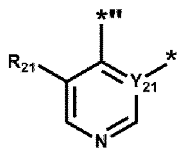
CY2(34)

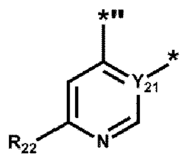
CY2(35)

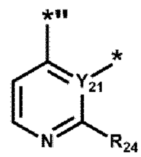
CY2(36)

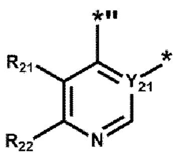
CY2(37)

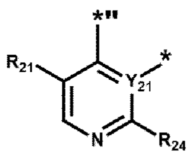
CY2(38)

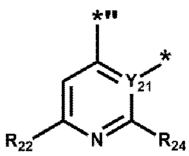
CY2(39)

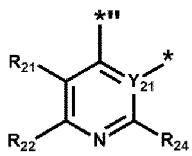
CY2(40)

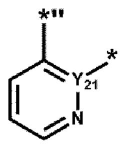
CY2(41)

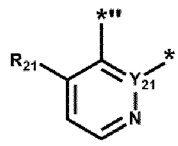
CY2(42)

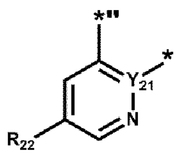

CY2(43)

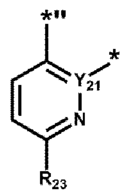

CY2(44)

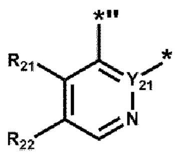

CY2(45)

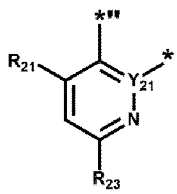

CY2(46)

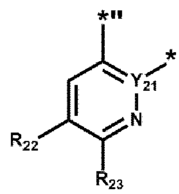

CY2(47)

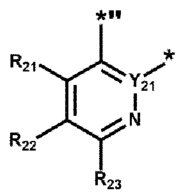

CY2(48)

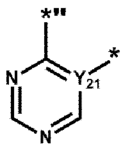

CY2(49)

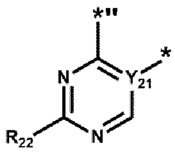

CY2(50)

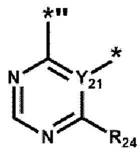

CY2(51)

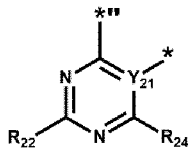

CY2(52)

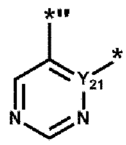

CY2(53)

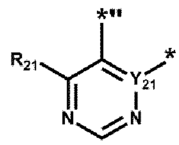

CY2(54)

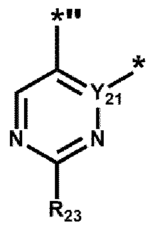

CY2(55)

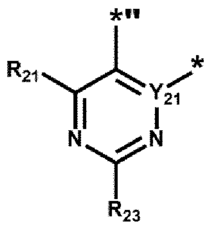

CY2(56)

In Formulae CY2(1) to CY2(56),

$Y_{21}$ may be C,
$R_{21}$ to $R_{24}$ may each independently be understood by referring to the description provided in connection with $R_2$, wherein each of $R_{21}$ to $R_{24}$ may not be hydrogen,
*" indicates a binding site to a neighboring atom in Formula 2, and
* indicates a binding site to M in Formula 1.

In one or more embodiments, a group represented by

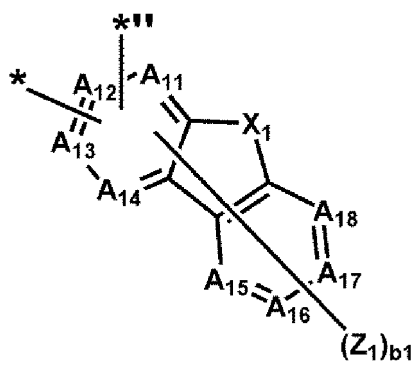

in Formula 3 may be a group represented by one of Formulae CY3-1 to CY3-6:

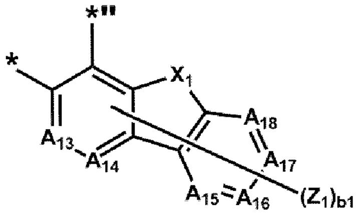

CY3-1

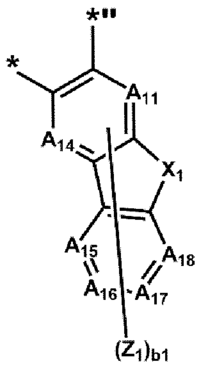

CY3-2

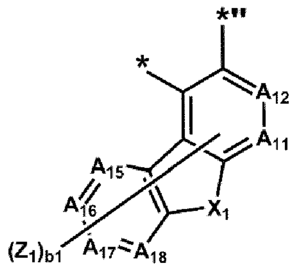

CY3-3

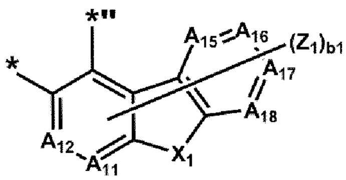

CY3-4

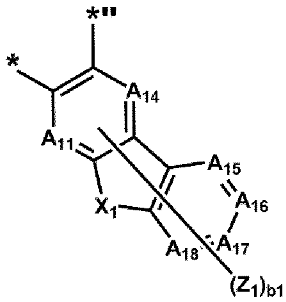

CY3-5

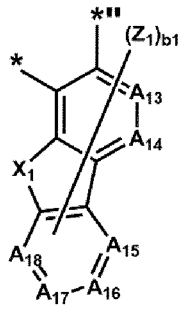

CY3-6

In Formulae CY3-1 to CY3-6,

$X_1$, $Z_1$ and b1 may each be understood by referring to the corresponding descriptions thereof provided herein,
$A_{11}$ to $A_{18}$ may each independently be C or N, wherein at least one of $A_{13}$ to $A_{18}$ in Formulae CY3-1 and CY3-6 may be N, at least one of $A_{11}$, $A_{14}$, $A_{15}$, $A_{16}$, $A_{17}$ and $A_{18}$ in Formulae CY3-2 and CY3-5 may be N, and at least one of $A_{11}$, $A_{12}$, $A_{15}$, $A_{16}$, $A_{17}$ and $A_{18}$ in Formulae CY3-3 and CY3-4 may be N,
* indicates a binding site to M in Formula 1, and
*" indicates a binding site to a neighboring atom in Formula 3.

In one or more embodiments, a group represented by

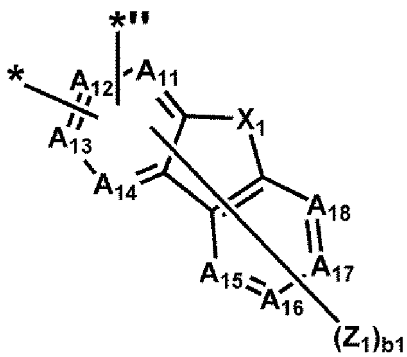

in Formula 3 may be a group represented by one of Formulae CY3-1-1 to CY3-1-6, CY3-2-1 to CY3-2-6, CY3-3-1 to CY3-3-6, CY3-4-1 to CY3-4-6, CY3-5-1 to CY3-5-6, and CY3-6-1 to CY3-6-6:

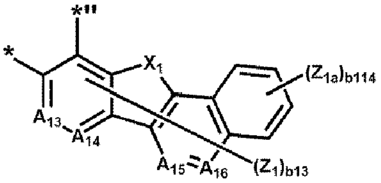

CY3-1-1

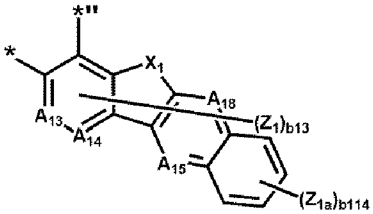

CY3-1-2

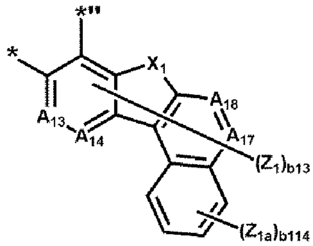

CY3-1-3

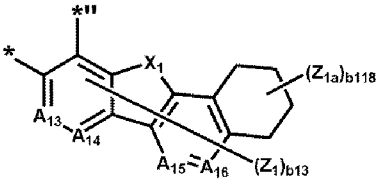

CY3-1-4

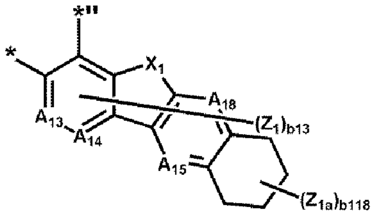

CY3-1-5

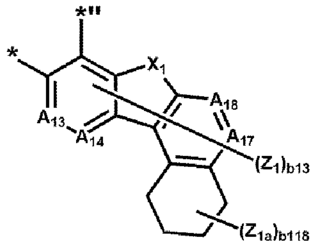

CY3-1-6

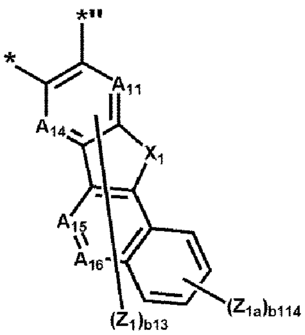

CY3-2-1

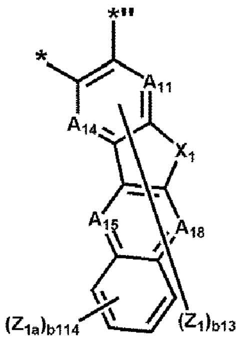

CY3-2-2

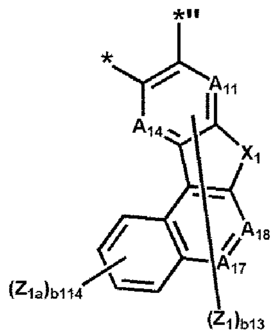

CY3-2-3

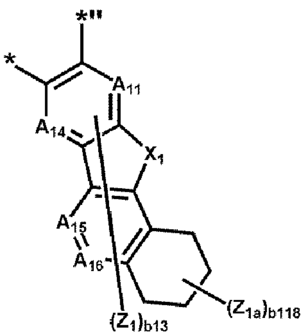

CY3-2-4

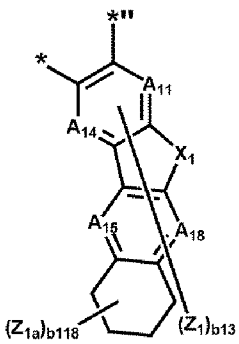

CY3-2-5

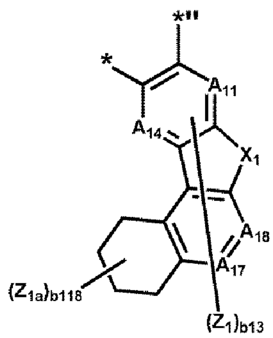

CY3-2-6

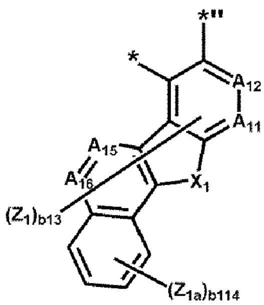

CY3-3-1

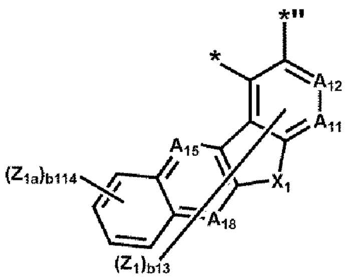

CY3-3-2

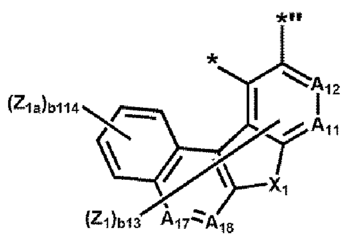

CY3-3-3

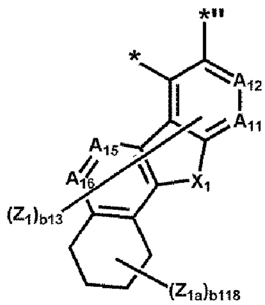

CY3-3-4

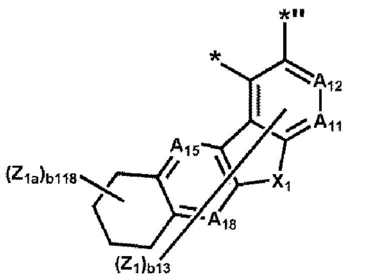

CY3-3-5

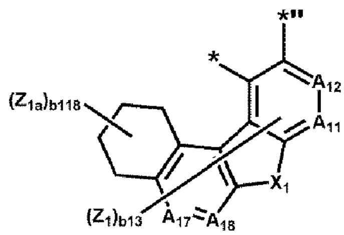

CY3-3-6

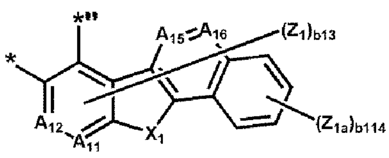

CY3-4-1

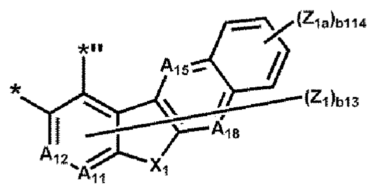

CY3-4-2

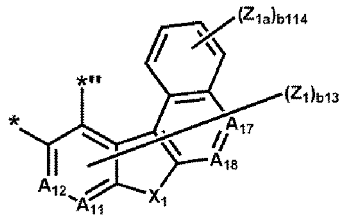

CY3-4-3

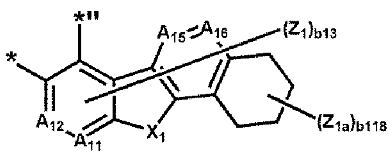

CY3-4-4

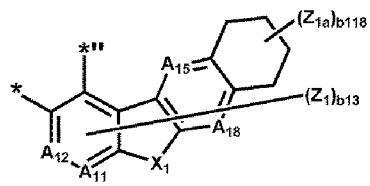

CY3-4-5

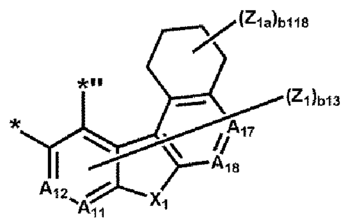

CY3-4-6

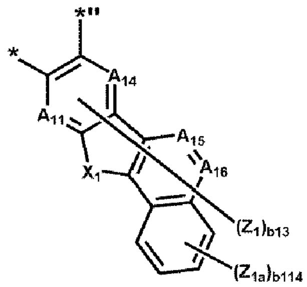

CY3-5-1

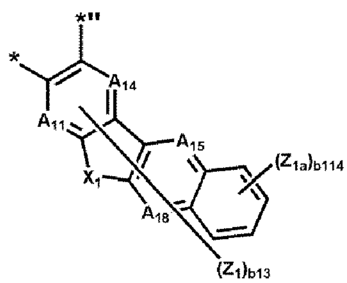

CY3-5-2

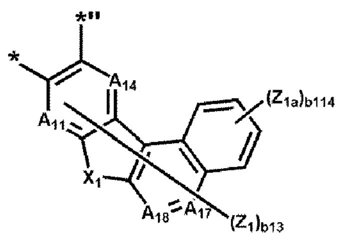

CY3-5-3

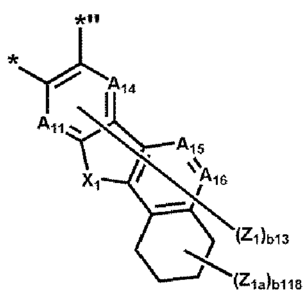

CY3-5-4

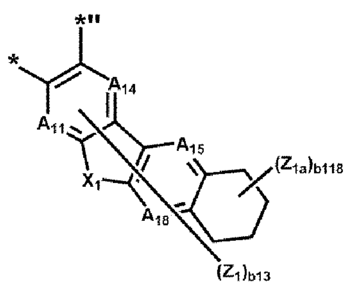

CY3-5-5

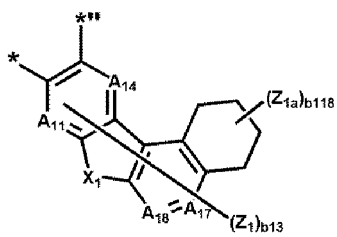

CY3-5-6

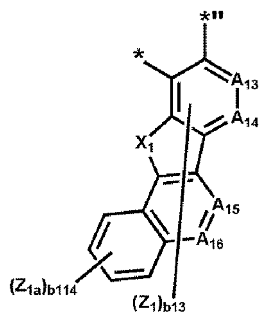

CY3-6-1

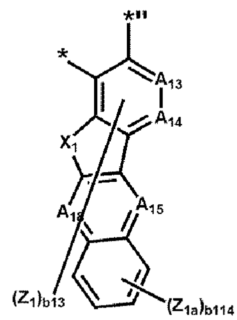

CY3-6-2

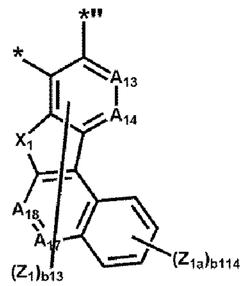

CY3-6-3

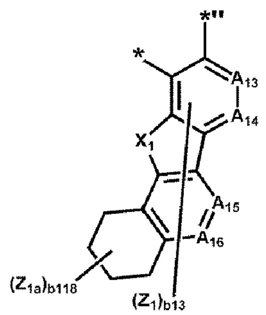

CY3-6-4

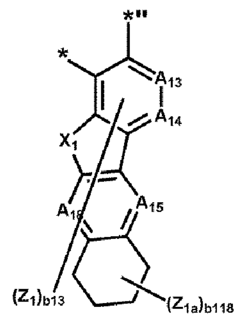

CY3-6-5

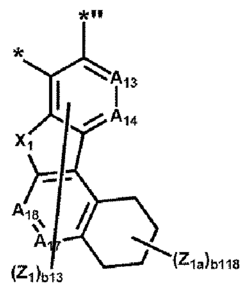

CY3-6-6

In Formulae CY3-1-1 to CY3-1-6, CY3-2-1 to CY3-2-6, CY3-3-1 to CY3-3-6, CY3-4-1 to CY3-4-6, CY3-5-1 to CY3-5-6, and CY3-6-1 to CY3-6-6,

$X_1$ and $Z_1$ may each be understood by referring to the corresponding descriptions thereof provided herein,
$Z_{1a}$ may be understood by referring to the description provided in connection with $R_1$a,
$A_{11}$ to $A_{18}$ may each independently be C or N, wherein a) at least one of $A_{13}$, $A_{14}$, $A_{15}$, and $A_{16}$ in Formulae CY3-1-1, CY3-1-4, CY3-6-1, and CY3-6-4 is N, b) at least one of $A_{13}$, $A_{14}$, $A_{15}$, and $A_{18}$ in Formulae CY3-1-2, CY3-1-5, CY3-6-2, and CY3-6-5 is N, c) at least one of $A_{13}$, $A_{14}$, $A_{17}$, and $A_{18}$ in Formulae CY3-1-3, CY3-1-6, CY3-6-3, and CY3-6-6 is N, d) at least one of $A_{11}$, $A_{14}$, $A_{15}$, and $A_{16}$ in Formulae CY3-2-1, CY3-2-4, CY3-5-1, and CY3-5-4 is N, e) at least one of $A_{11}$, $A_{14}$, $A_{15}$, and $A_{18}$ in Formulae CY3-2-2, CY3-2-5, CY3-5-2, and CY3-5-5 is N, f) at least one of $A_{11}$, $A_{14}$, $A_{17}$, and $A_{18}$ in Formulae CY3-2-3, CY3-2-6, CY3-5-3, and CY3-5-6 is N, g) at least one of $A_{11}$, $A_{12}$, $A_{15}$, and $A_{16}$ in Formulae CY3-3-1, CY3-3-4, CY3-4-1, and CY3-4-4 is N, h) at least one of $A_{11}$, $A_{12}$, $A_{15}$ and $A_{18}$ in Formulae CY3-3-2, CY3-3-5, CY3-4-2, and CY3-4-5 is N, i) at least one of $A_{11}$, $A_{12}$, $A_{17}$, and $A_{18}$ in Formulae CY3-3-3, CY3-3-6, CY3-4-3, and CY3-4-6 is N,
b13 may be an integer from 0 to 3,
b114 may be an integer from 0 to 4,
b118 may be an integer from 0 to 8,
* indicates a binding site to M in Formula 1, and
*" indicates a binding site to a neighboring atom in Formula 3.

In one or more embodiments, a group represented by

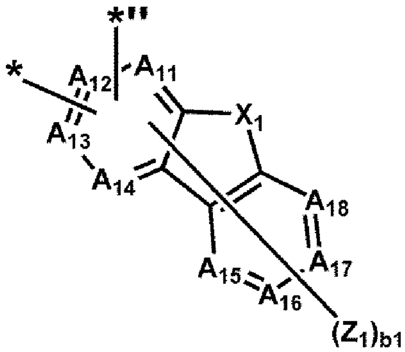

in Formula 3 may be a group represented by one of Formulae NCY3(1) to NCY3(84):

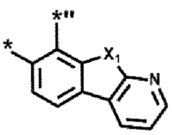
NCY3(1)

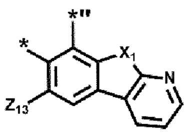
NCY3(2)

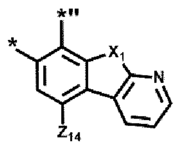
NCY3(3)

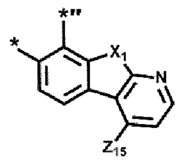
NCY3(4)

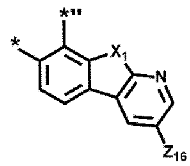
NCY3(5)

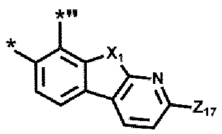
NCY3(6)

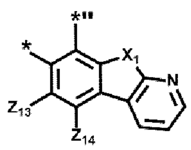
NCY3(7)

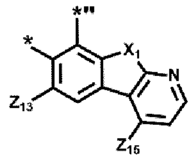
NCY3(8)

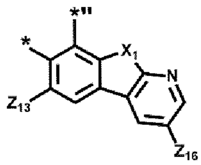
NCY3(9)

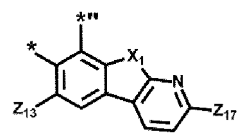
NCY3(10)

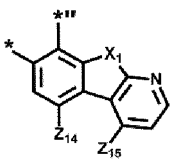
NCY3(11)

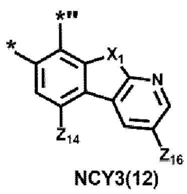
NCY3(12)

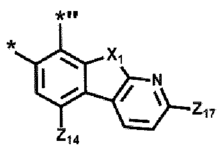
NCY3(13)

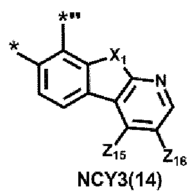
NCY3(14)

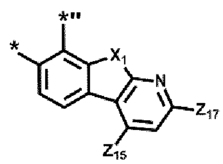
NCY3(15)

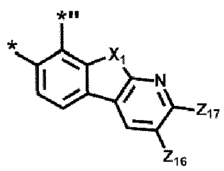
NCY3(16)

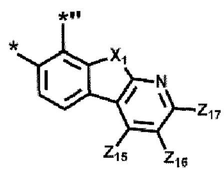
NCY3(17)

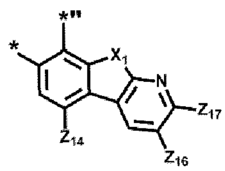
NCY3(18)

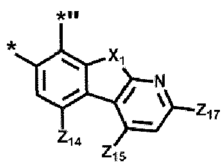
NCY3(19)

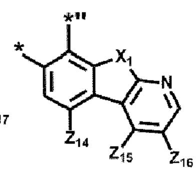
NCY3(20)

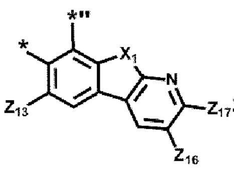
NCY3(21)

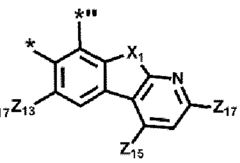
NCY3(22)

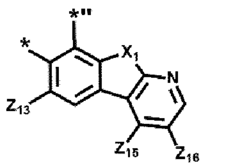
NCY3(23)

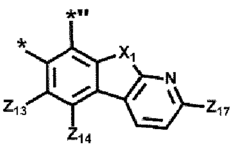
NCY3(24)

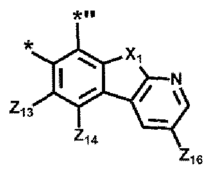
NCY3(25)

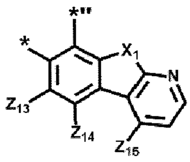
NCY3(26)

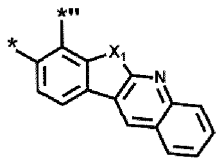
NCY3(27)

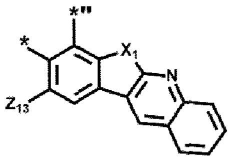
NCY3(28)

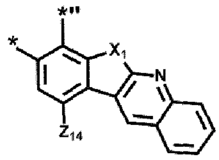
NCY3(29)

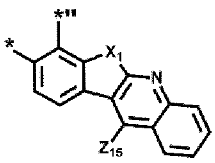
NCY3(30)

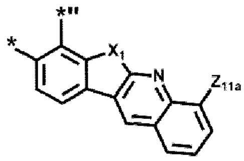
NCY3(31)

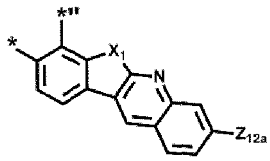
NCY3(32)

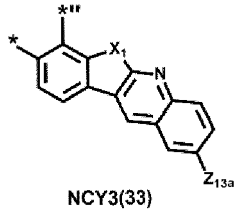
NCY3(33)

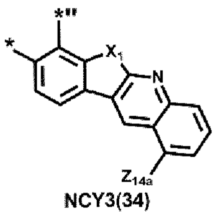
NCY3(34)

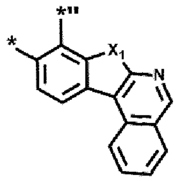
NCY3(35)

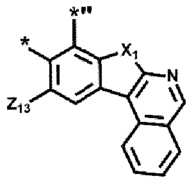
NCY3(36)

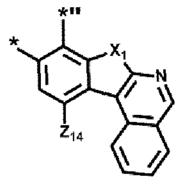
NCY3(37)

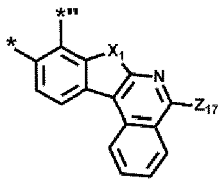
NCY3(38)

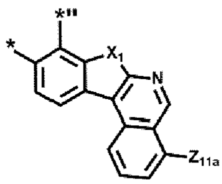
NCY3(39)

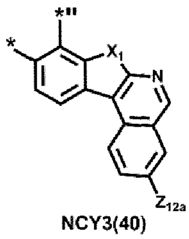
NCY3(40)

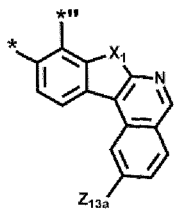
NCY3(41)

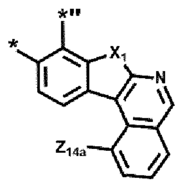
NCY3(42)

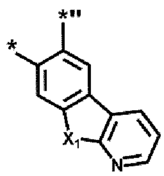
NCY3(43)

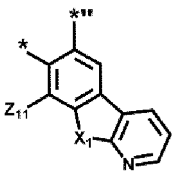
NCY3(44)

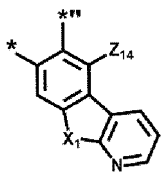
NCY3(45)

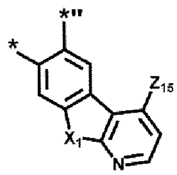
NCY3(46)

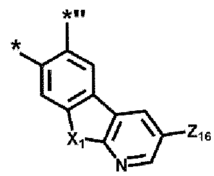
NCY3(47)

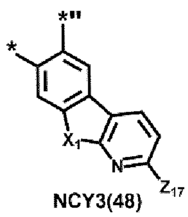
NCY3(48)

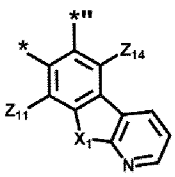
NCY3(49)

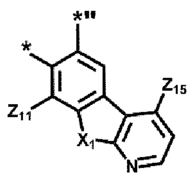
NCY3(50)

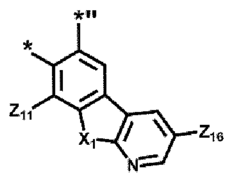
NCY3(51)

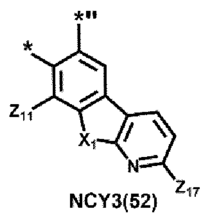
NCY3(52)

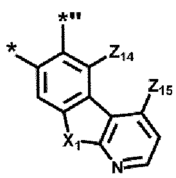
NCY3(53)

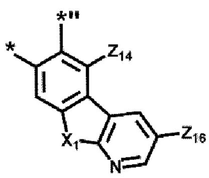
NCY3(54)

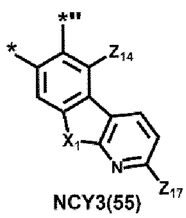
NCY3(55)

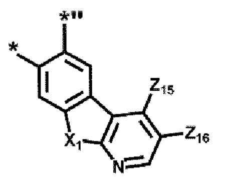
NCY3(56)

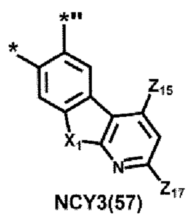
NCY3(57)

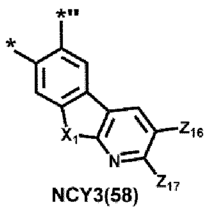
NCY3(58)

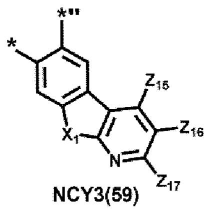
NCY3(59)

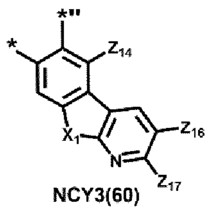
NCY3(60)

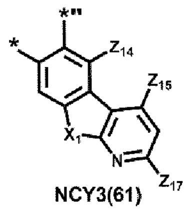
NCY3(61)

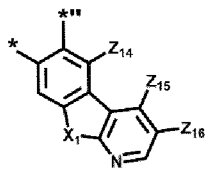
NCY3(62)

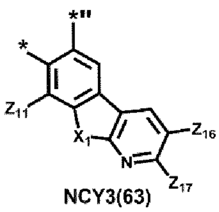
NCY3(63)

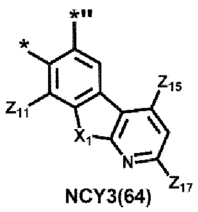
NCY3(64)

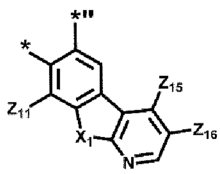
NCY3(65)

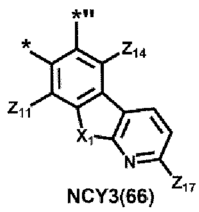
NCY3(66)

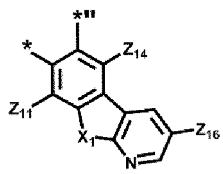
NCY3(67)

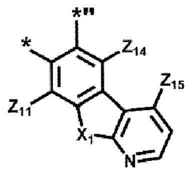
NCY3(68)

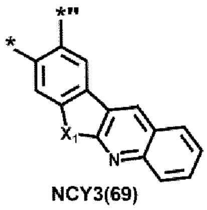
NCY3(69)

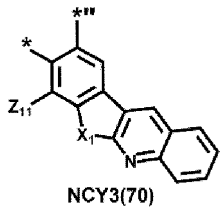
NCY3(70)

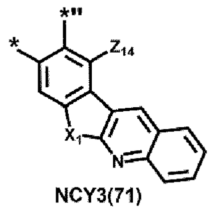
NCY3(71)

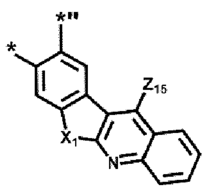
NCY3(72)

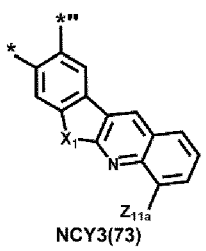
NCY3(73)

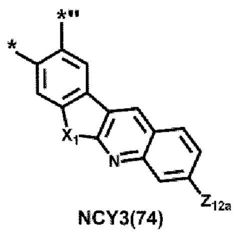
NCY3(74)

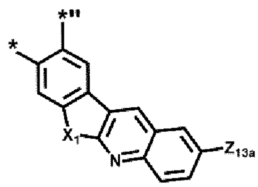
NCY3(75)

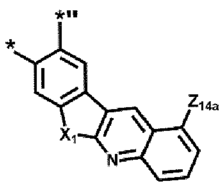
NCY3(76)

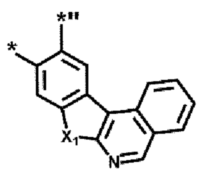
NCY3(77)

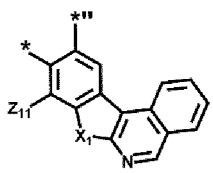
NCY3(78)

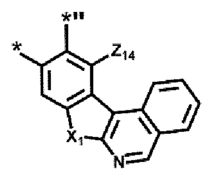
NCY3(79)

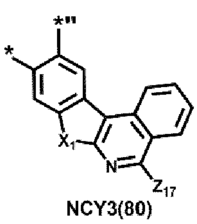
NCY3(80)

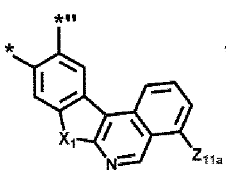
NCY3(81)

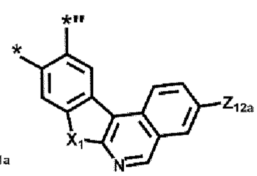
NCY3(82)

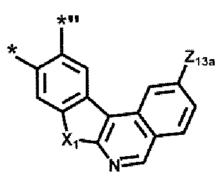
NCY3(83)

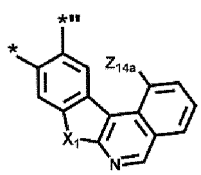
NCY3(84)

In Formulae NCY3(1) to NCY3(84),

$X_1$ may be understood by referring to the corresponding descriptions thereof provided herein,
$Z_{11}$ to $Z_{18}$ and $Z_{11a}$ to $Z_{14a}$ may be each understood by referring to the description provided in connection with $Z_1$, and each of $Z_{11}$ to $Z_{18}$ and $Z_{11a}$ to $Z_{14a}$ is not hydrogen,
* indicates a binding site to M in Formula 1, and
*" indicates a binding site to a neighboring atom in Formula 3.

In one or more embodiments, a group represented by

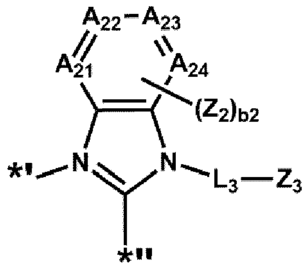

in Formula 3 may be a group represented by one of Formulae CY4-1 to CY4-60:

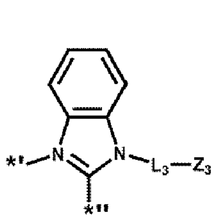
CY4-1

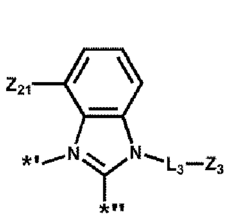
CY4-2

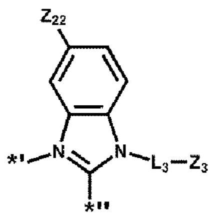
CY4-3

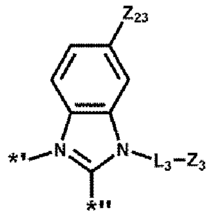
CY4-4

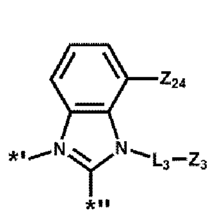
CY4-5

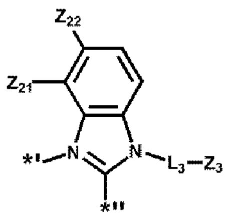
CY4-6

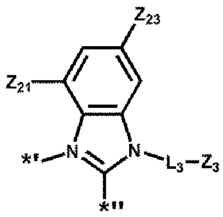
CY4-7

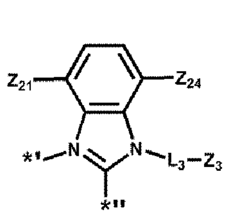
CY4-8

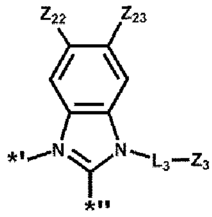
CY4-9

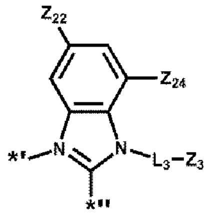
CY4-10

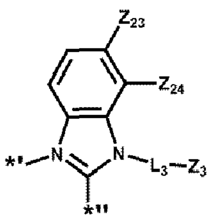
CY4-11

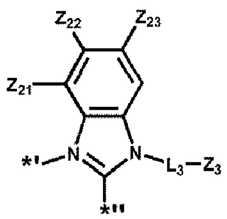
CY4-12

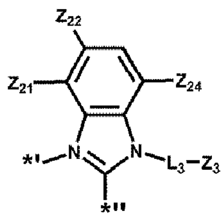
CY4-13

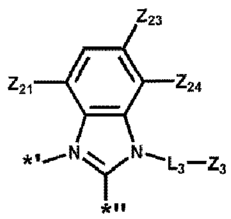
CY4-14

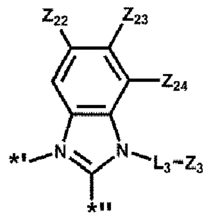
CY4-15

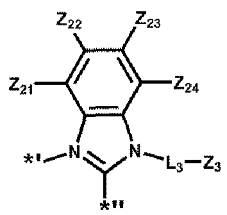
CY4-16

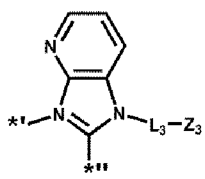
CY4-17

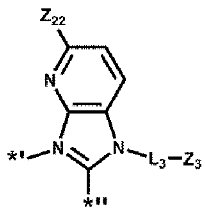
CY4-18

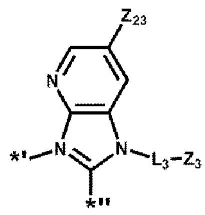
CY4-19

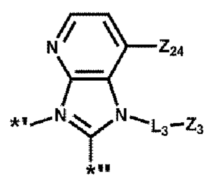
CY4-20

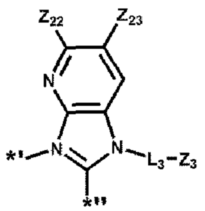
CY4-21

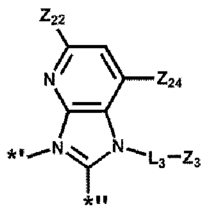
CY4-22

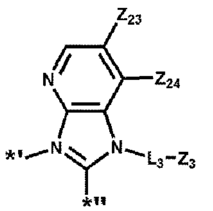
CY4-23

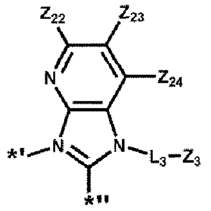
CY4-24

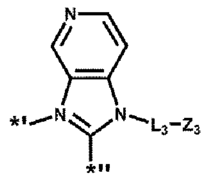
CY4-25

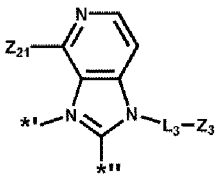
CY4-26

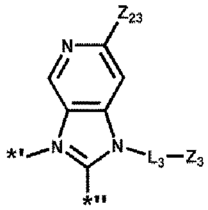
CY4-27

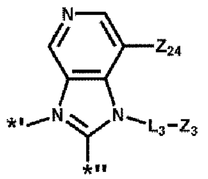
CY4-28

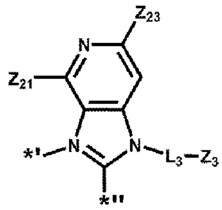
CY4-29

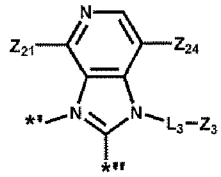
CY4-30

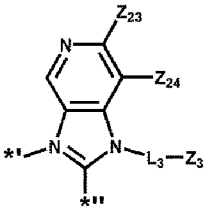
CY4-31

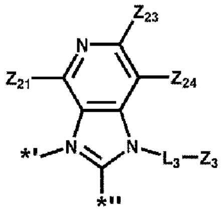
CY4-32

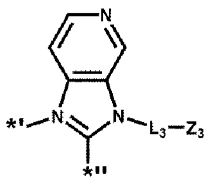
CY4-33

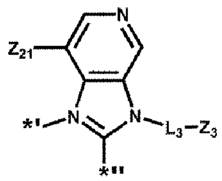
CY4-34

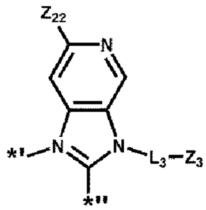
CY4-35

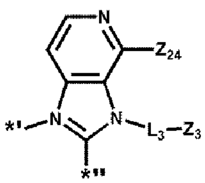
CY4-36

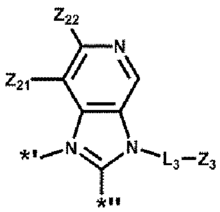
CY4-37

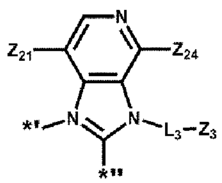
CY4-38

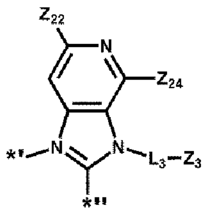
CY4-39

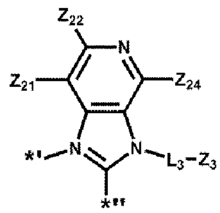
CY4-40

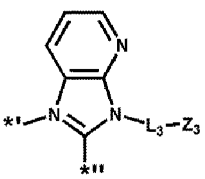
CY4-41

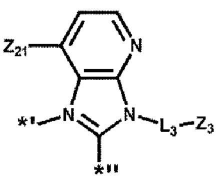
CY4-42

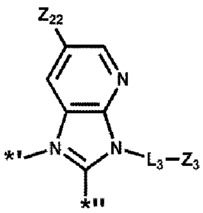
CY4-43

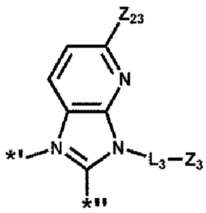
CY4-44

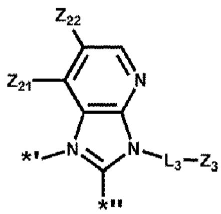
CY4-45

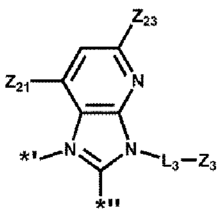
CY4-46

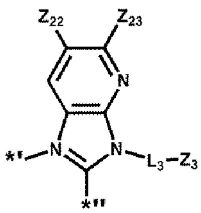
CY4-47

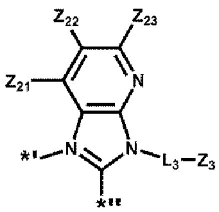
CY4-48

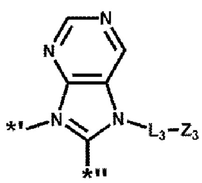
CY4-49

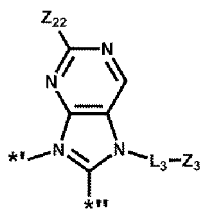
CY4-50

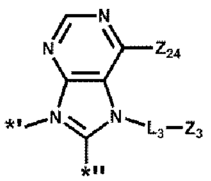
CY4-51

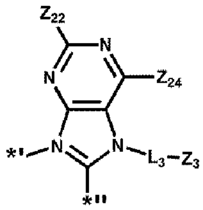
CY4-52

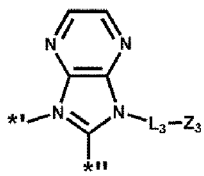
CY4-53

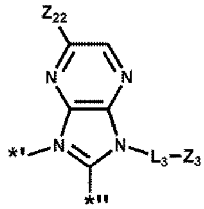
CY4-54

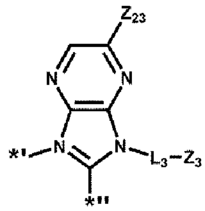
CY4-55

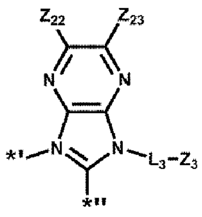
CY4-56

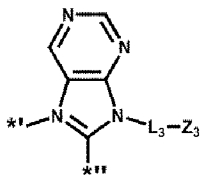
CY4-57

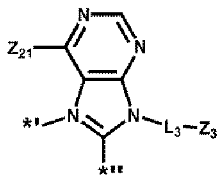
CY4-58

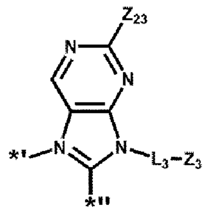
CY4-59

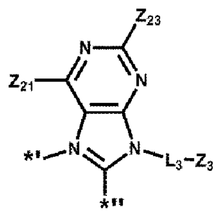
CY4-60

In Formulae CY4-1 to CY4-60,

$L_3$ and $Z_3$ may each be understood by referring to the corresponding descriptions thereof provided herein,
$Z_{21}$ to $Z_{24}$ may each be understood by referring to the description provided in connection with $Z_2$, wherein each of $Z_{21}$ to $Z_{24}$ may not be hydrogen,
*' indicates a binding site to M in Formula 1, and
*" indicates a binding site to a neighboring atom in Formula 3.

In one or more embodiments, two or more of a plurality of $Z_2$(s) in a group represented by

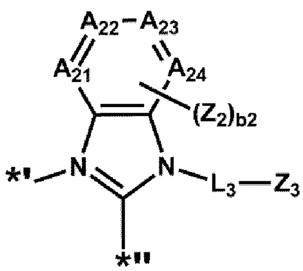

in Formula 3 may be linked to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$. As a result, a group represented by

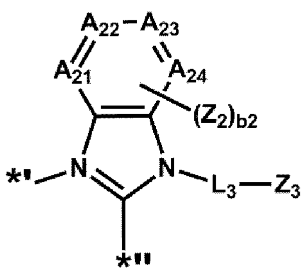

in Formula 3 may be a group represented by one of Formulae CY4(1) to CY4(4):

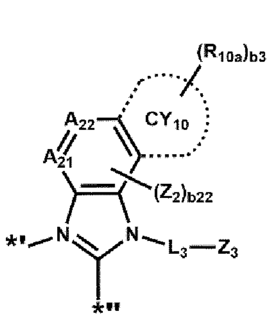
CY4(1)

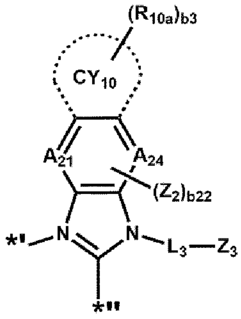
CY4(2)

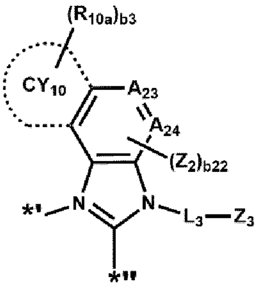
CY4(3)

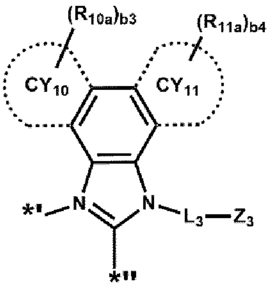
CY4(4)

In Formulae CY4(1) to CY4(4),

$A_{21}$ to $A_{24}$, $L_3$, $Z_2$ , $Z_3$ and $R_{10a}$ are the same as described above,
b22 may be an integer from 0 to 2,
ring $CY_{10}$ and ring $CY_{11}$ may each independently be a $C_5$-$C_{30}$ carbocyclic group or a $C_1$-$C_{30}$ heterocyclic group,
$R_{11a}$ is the same as described in connection with $R_{10a}$,
b3 and b4 may each independently be an integer from 0 to 20, when b3 is 2 or more, two or more $R_{10a}$(s) may be identical to or different from each other, and when b4 is 2 or more, two or more $R_{11a}$(s) may be identical to or different from each other,
*' indicates a binding site to M in Formula 1, and
*" indicates a binding site to a neighboring atom in Formula 3.

For example, ring $CY_{10}$ and ring $CY_{11}$ in Formulae CY4(1) to CY4(4) may each independently be a benzene group or a naphthalene group.

In one or more embodiments, a group represented by

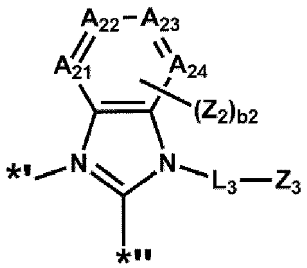

in Formula 3 may be a group represented by one of Formulae CY4(1)-1 to CY4(1)-4, CY4(2)-1 to CY4(2)-4, CY4(3)-1 to CY4(3)-4 and CY4(4)-1:

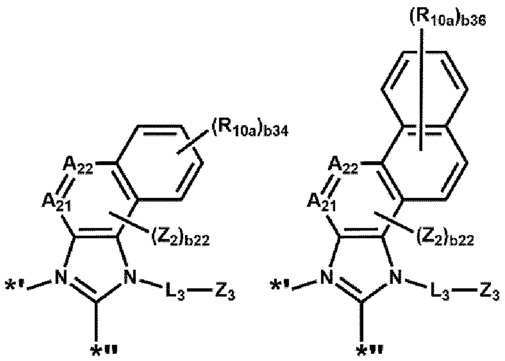
CY4(1)-1 CY4(1)-2

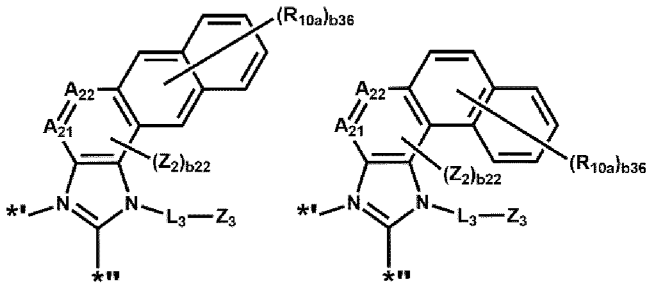
CY4(1)-3 CY4(1)-4

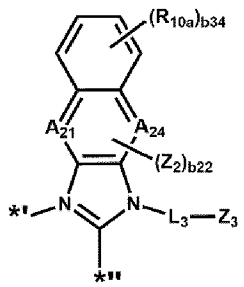

CY4(2)-1

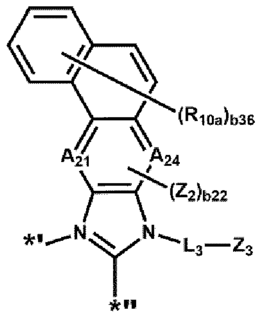

CY4(2)-2

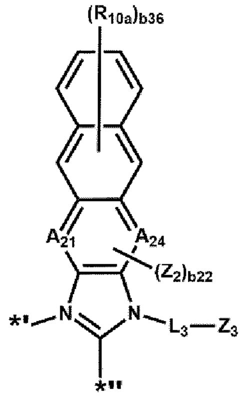

CY4(2)-3

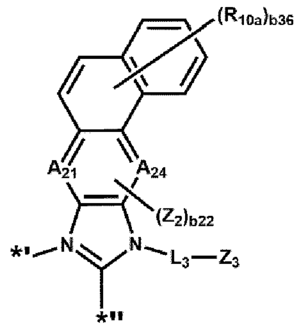

CY4(2)-4

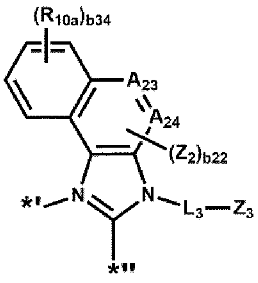

CY4(3)-1

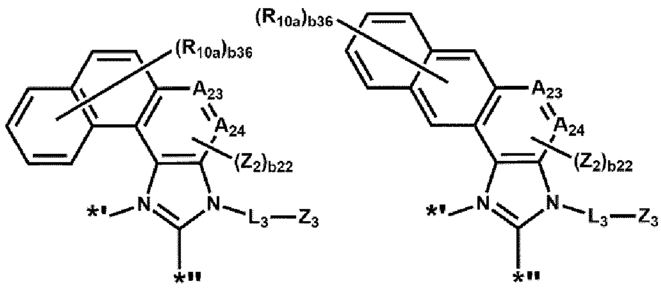

CY4(3)-2

CY4(3)-3

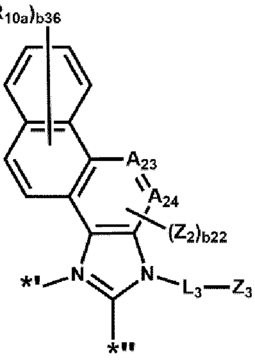

CY4(3)-4

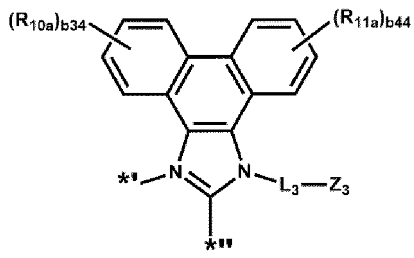

CY4(4)-1

In Formulae CY4(1)-1 to CY4(1)-4, CY4(2)-1 to CY4(2)-4, CY4(3)-1 to CY4(3)-4 and CY4(4)-1,

$A_{21}$ to $A_{24}$, $L_3$, $Z_2$ , $Z_3$ and $R_{10a}$ are the same as described above,
b22 may be an integer from 0 to 2,
$R_{11a}$ is the same as described in connection with $R_{10a}$,
b34 and b44 may each independently be an integer from 0 to 4, when b34 is 2 or more, two or more $R_{10a}$(s) may be identical to or different from each other, and when b44 is 2 or more, two or more $R_{11a}$(s) may be identical to or different from each other,
b36 may be an integer from 0 to 6, when b36 is 2 or more, two or more $R_{10a}$(s) may be identical to or different from each other,
*' indicates a binding site to M in Formula 1, and
*" indicates a binding site to a neighboring atom in Formula 3.

In one embodiment, the organometallic compound represented by Formula 1 may emit red light or green light, for example, red light or green light, each having a maximum emission wavelength of 500 nm or more, for example, 500 nm or more and 850 nm or less. For example, the organometallic compound may emit green light.

For example, the organometallic compound may be one of Compounds 1 to 4010:

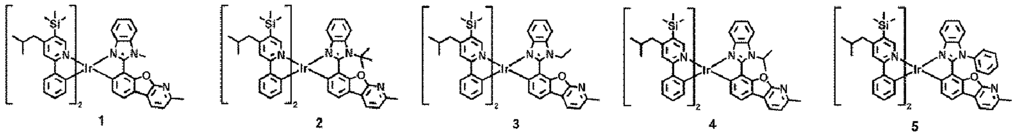
1 2 3 4 5

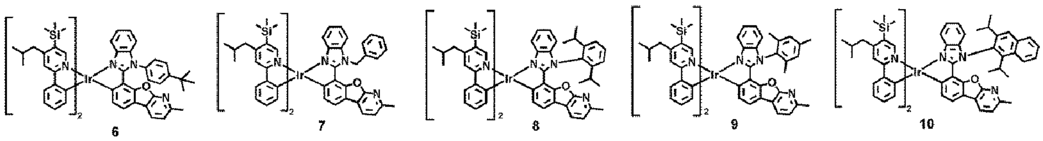
6 7 8 9 10

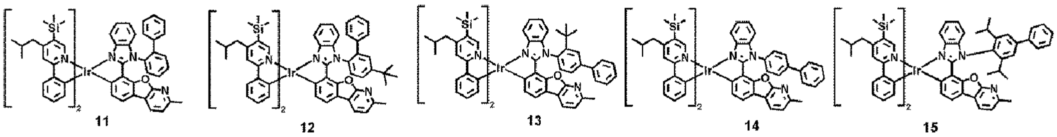
11 12 13 14 15

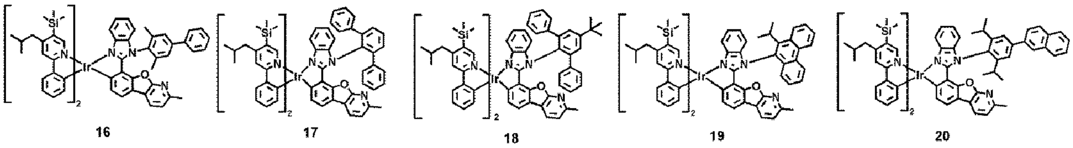
16 17 18 19 20

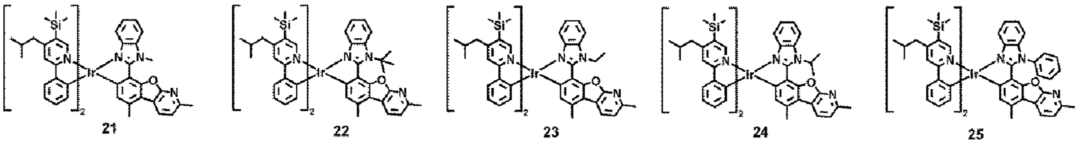
21 22 23 24 25

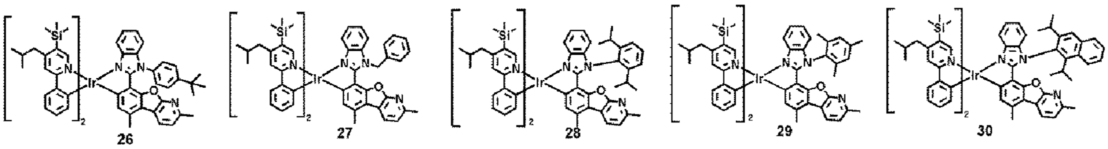
26 27 28 29 30

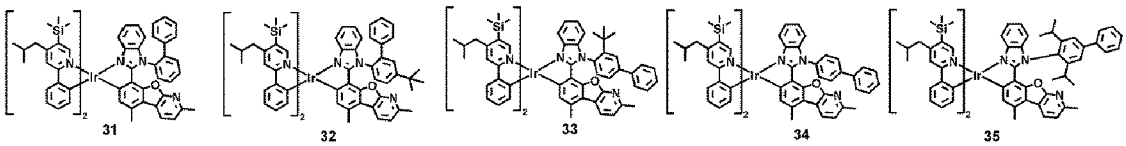
31 32 33 34 35

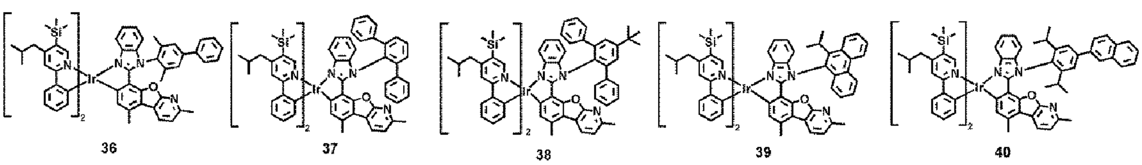
36 37 38 39 40

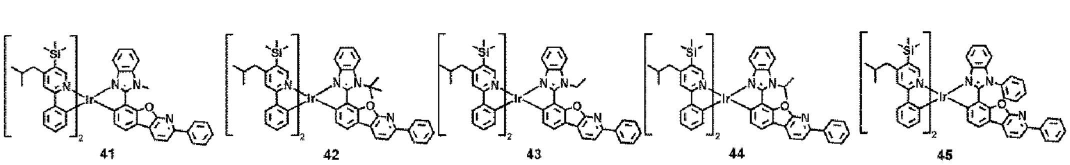
41 42 43 44 45

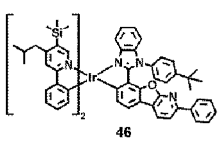
46
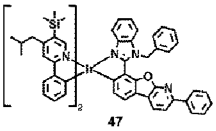
47
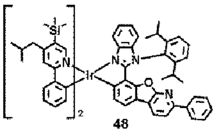
48
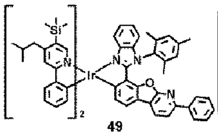
49
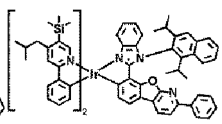
50

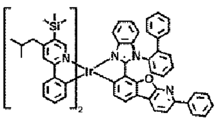
51
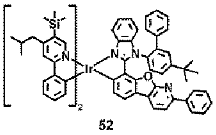
52
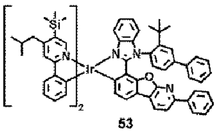
53
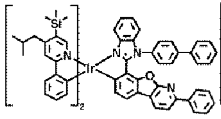
54
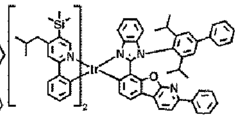
55

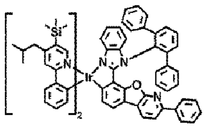
56
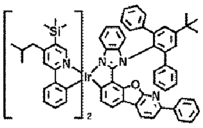
57
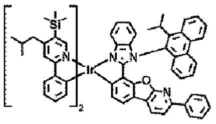
58
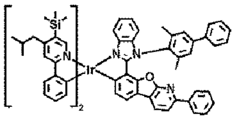
59
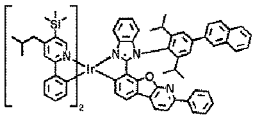
60

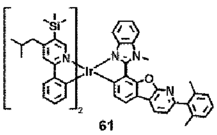
61
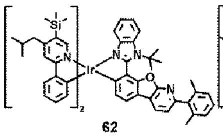
62
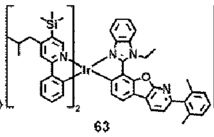
63
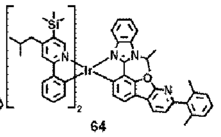
64
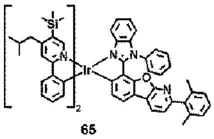
65

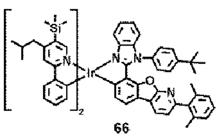
66
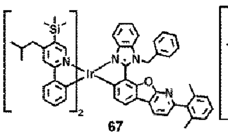
67
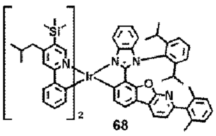
68
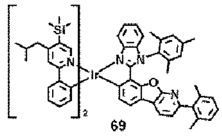
69
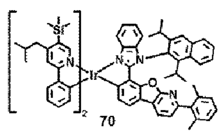
70

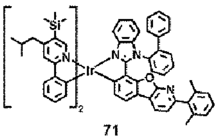
71
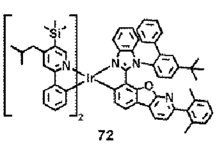
72
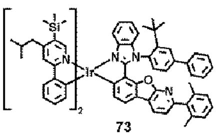
73
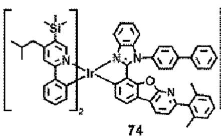
74
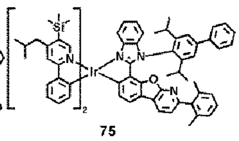
75

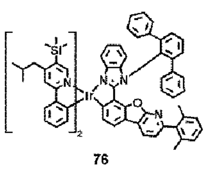
76
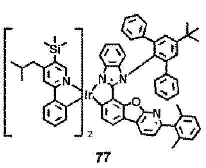
77
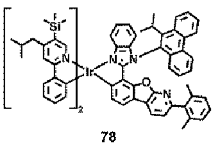
78
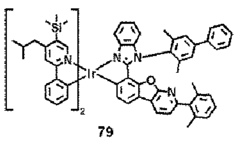
79
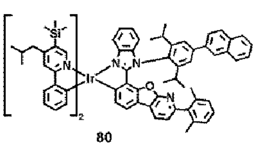
80

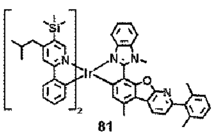
81
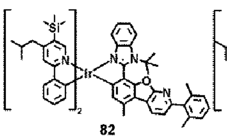
82
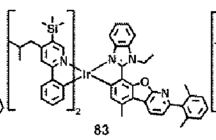
83
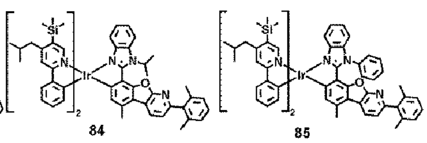
84
85

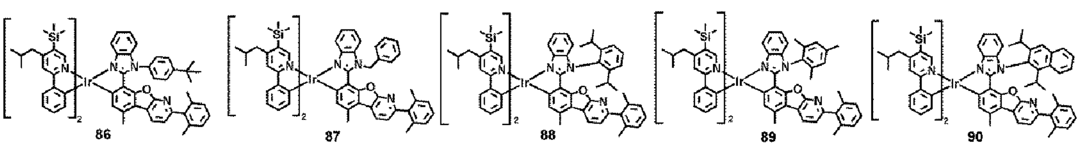
86
87
88
89
90

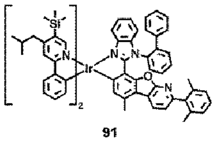
91
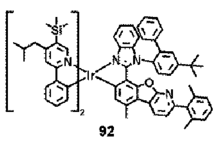
92
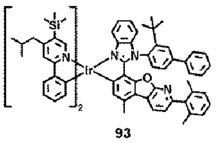
93
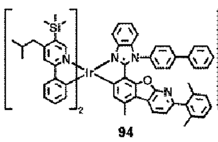
94
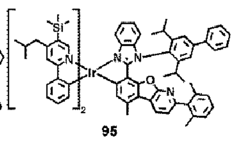
95

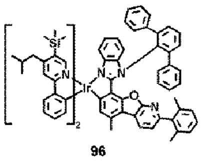
96
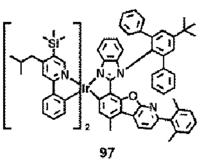
97
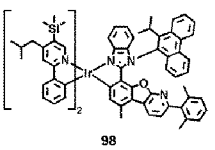
98
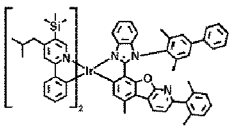
99
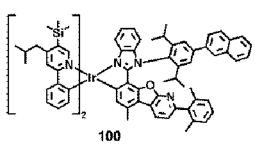
100

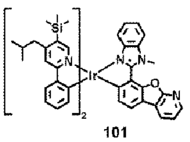
101
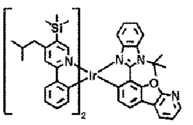
102
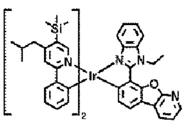
103
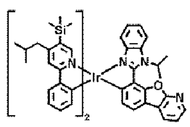
104
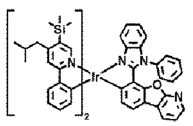
105

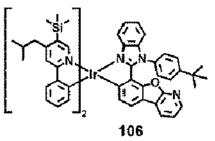
106
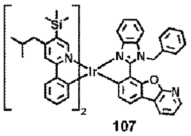
107
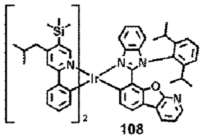
108
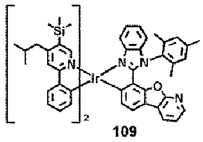
109
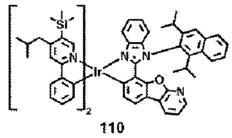
110

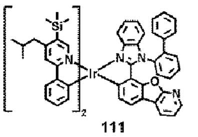
111
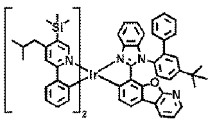
112
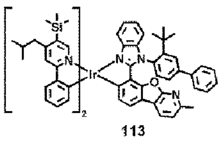
113
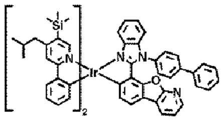
114
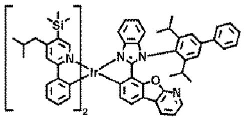
115

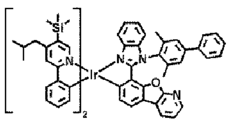
116
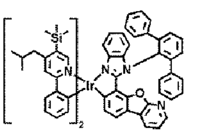
117
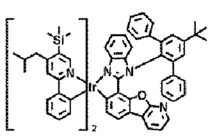
118
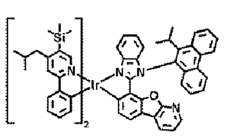
119
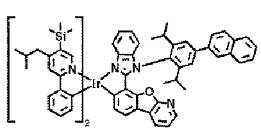
120

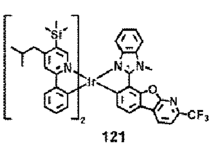
121
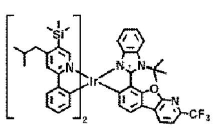
122
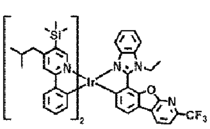
123
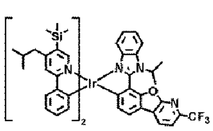
124
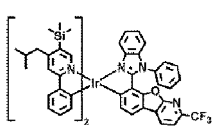
125

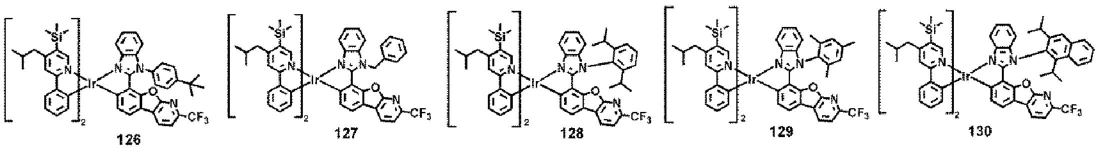
126
127
128
129
130

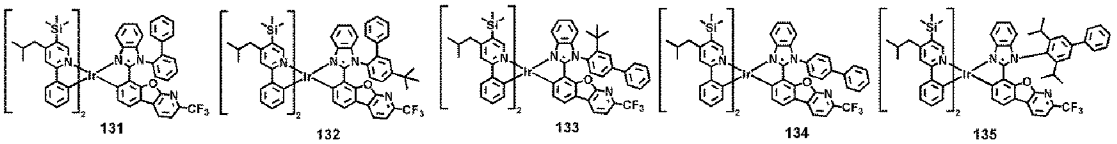
131
132
133
134
135

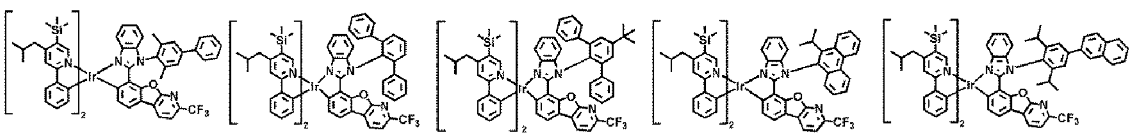

136 137 138 139 140

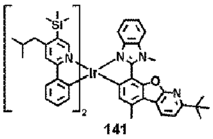
141
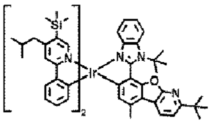
142
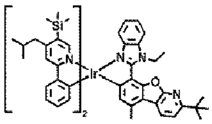
143
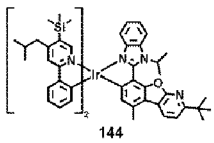
144
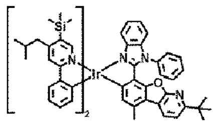
145

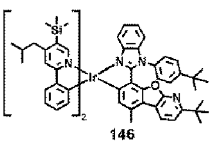
146
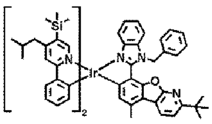
147
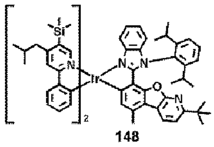
148
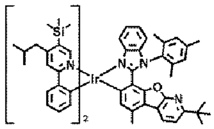
149
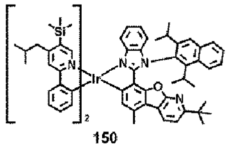
150

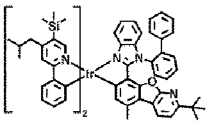
151
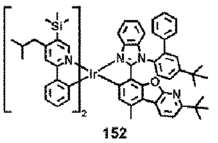
152
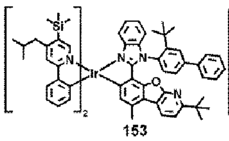
153
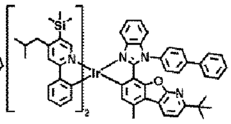
154
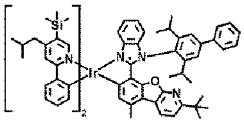
155

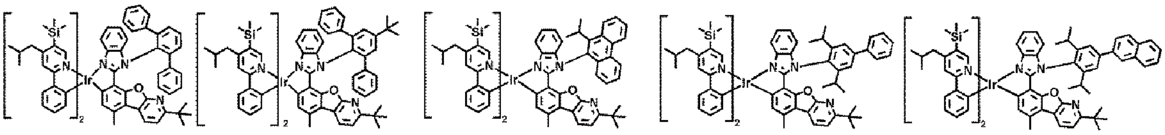

156 157 158 159 160

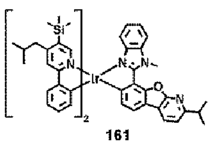
161
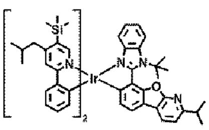
162
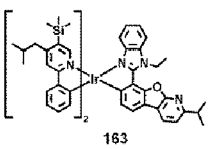
163
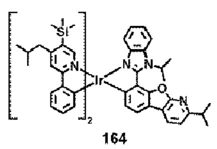
164
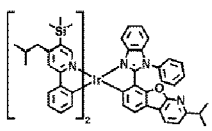
165

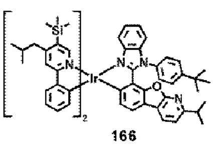
166
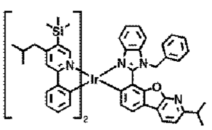
167
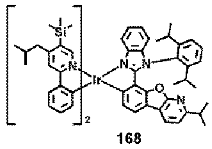
168
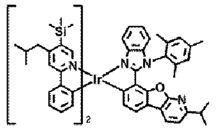
169
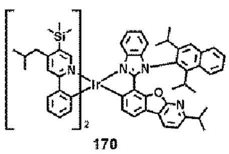
170

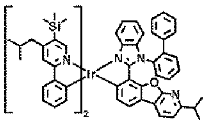
171
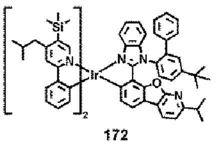
172
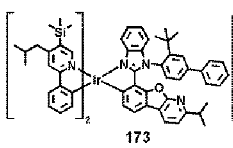
173
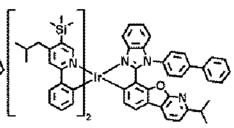
174
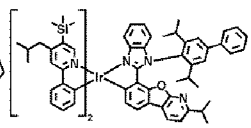
175

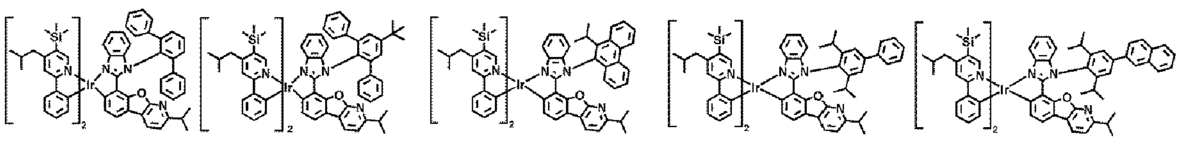

176 177 178 179 180

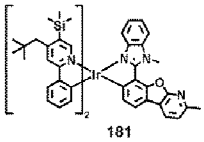
181

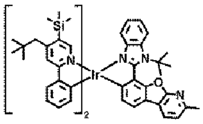
182

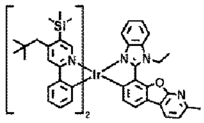
183

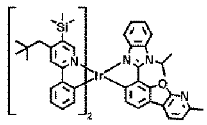
184

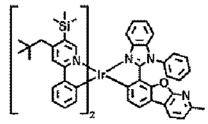
185

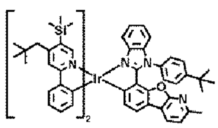
186

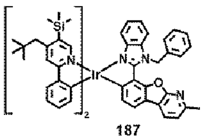
187

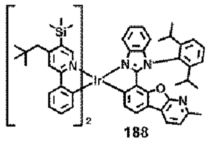
188

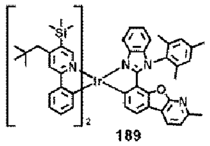
189

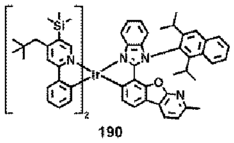
190

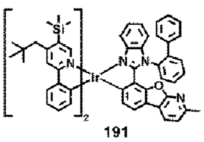
191

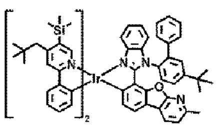
192

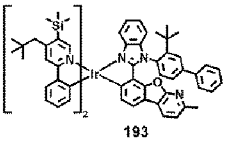
193

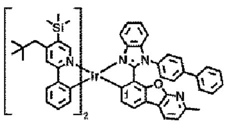
194

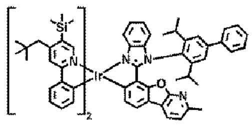
195

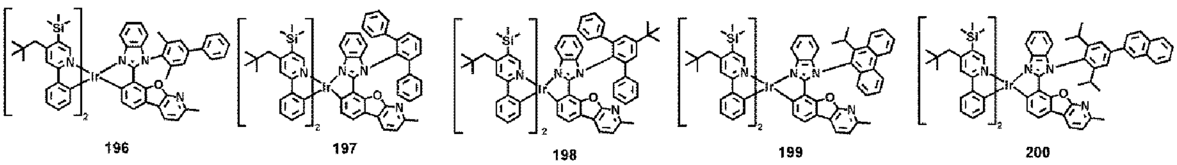
196

197

198

199

200

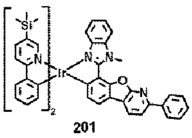
201

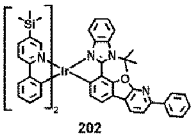
202

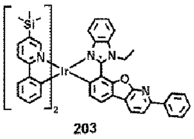
203

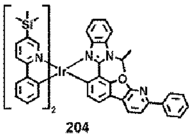
204

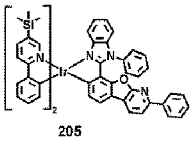
205

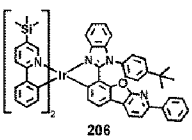
206

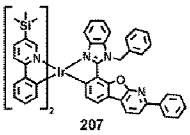
207

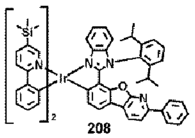
208

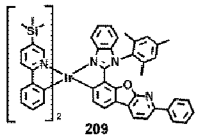
209

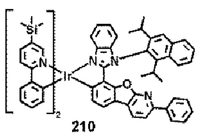
210

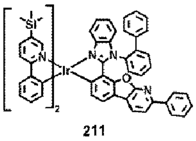
211

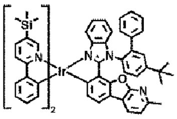
212

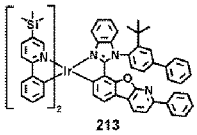
213

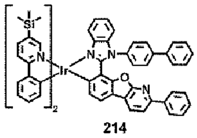
214

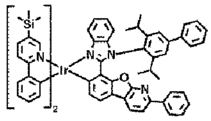
215

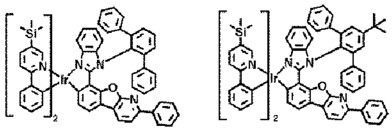
216

217

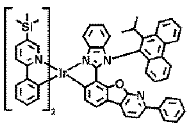
218

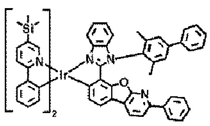
219

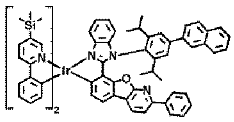
220

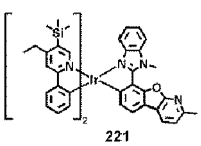
221

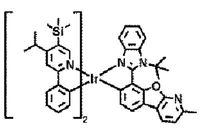
222

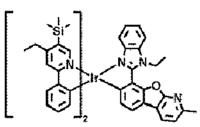
223

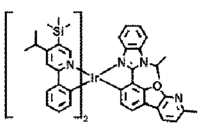
224

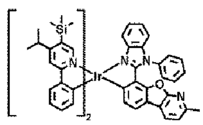
225

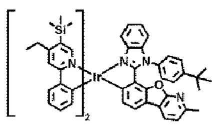
226
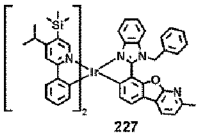
227
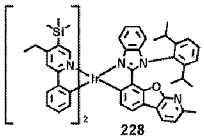
228
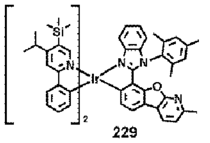
229
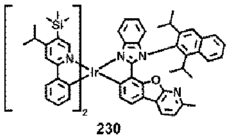
230

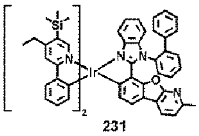
231
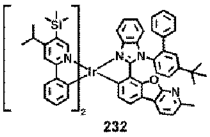
232
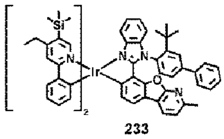
233
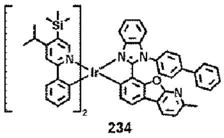
234
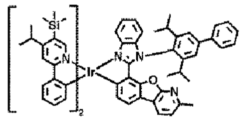
235

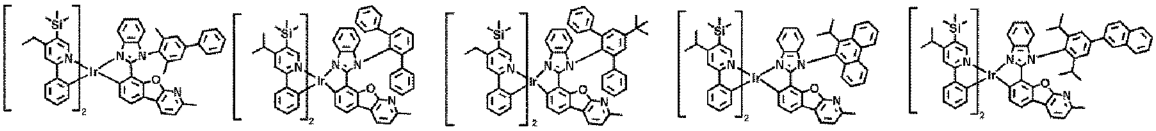
236
237
238
239
240

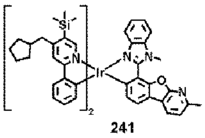
241
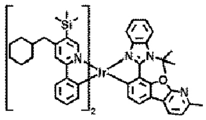
242
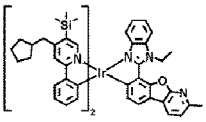
243
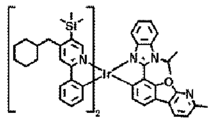
244
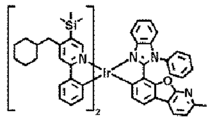
245

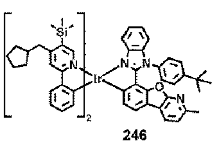
246
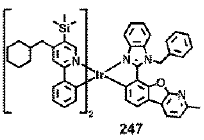
247
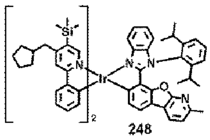
248
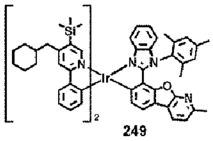
249
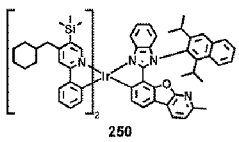
250

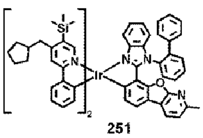
251
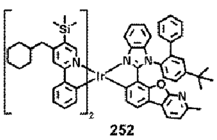
252
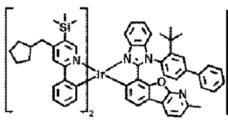
253
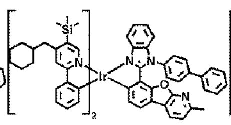
254
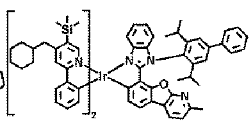
255

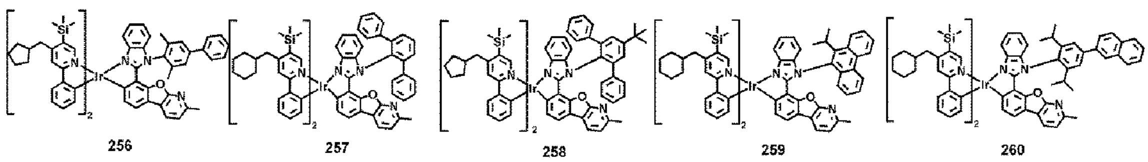
256
257
258
259
260

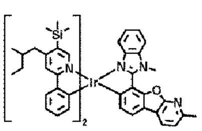
261
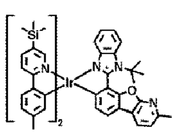
262
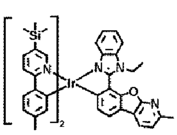
263
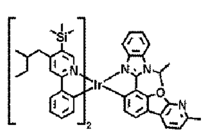
264
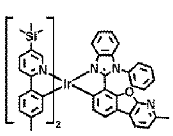
265

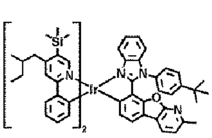
266
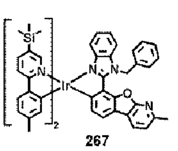
267
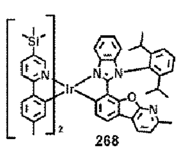
268
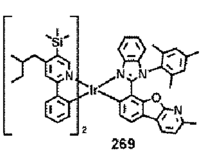
269
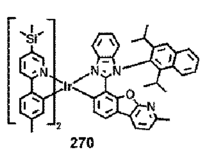
270

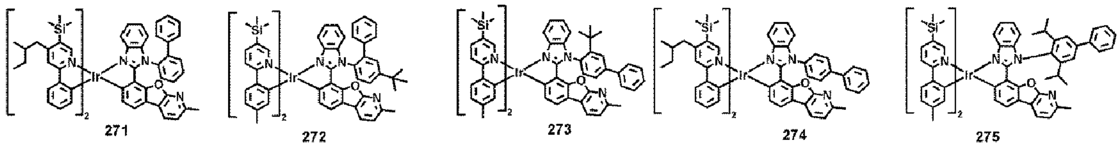

271 272 273 274 275

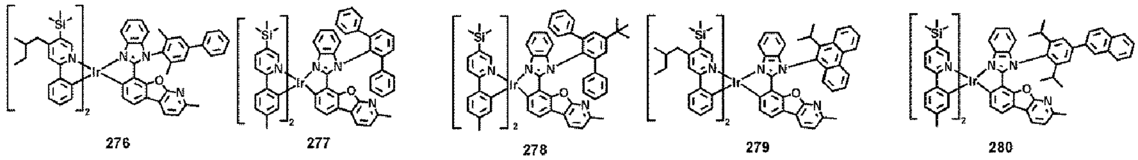

276 277 278 279 280

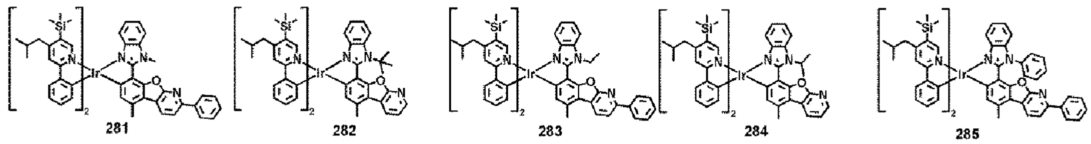

281 282 283 284 285

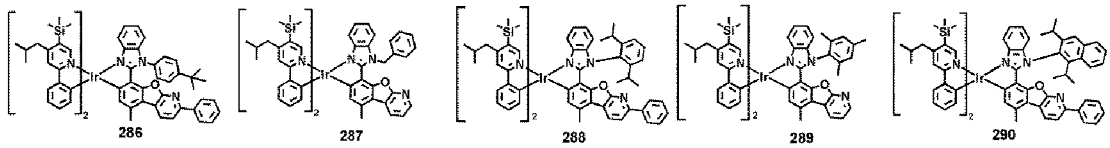

286 287 288 289 290

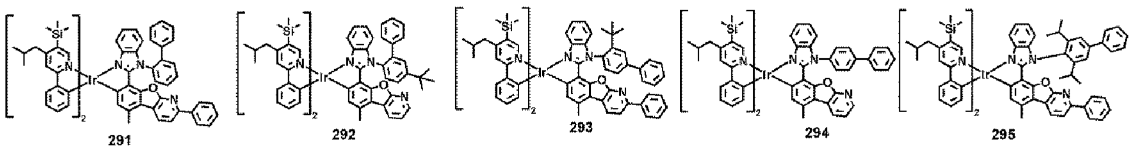

291 292 293 294 295

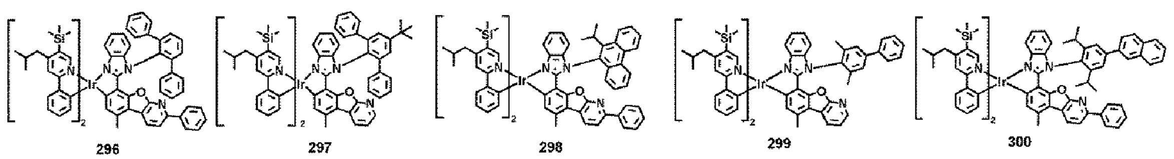

296 297 298 299 300

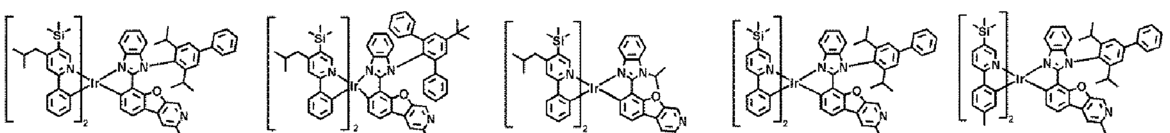

301 302 303 304 305

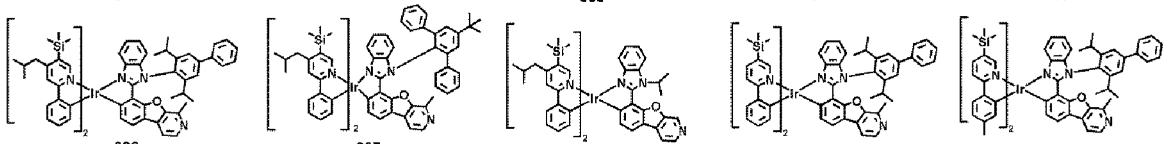

306 307 308 309 310

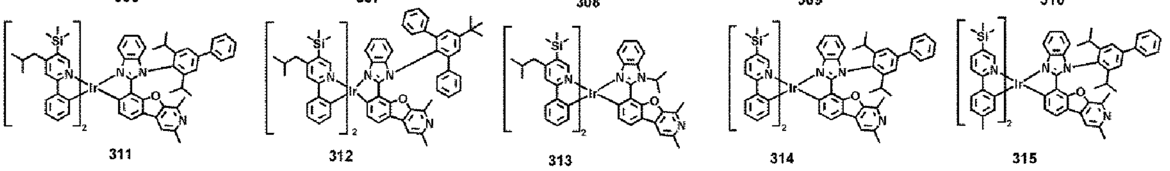

311 312 313 314 315

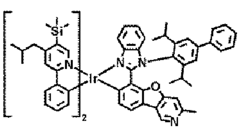
316
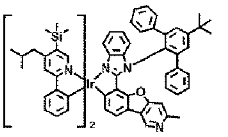
317
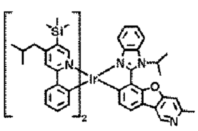
318
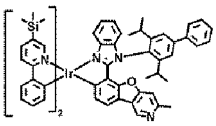
319
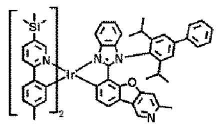
320

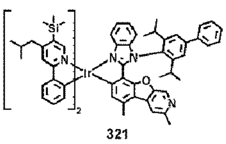
321
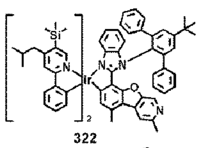
322
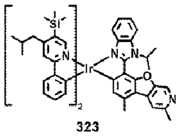
323
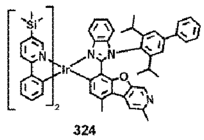
324
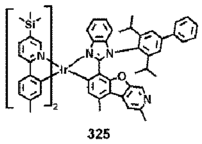
325

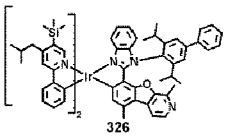
326
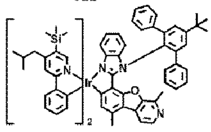
327
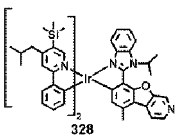
328
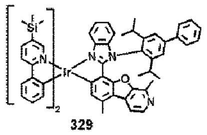
329
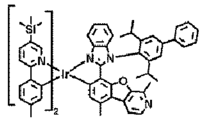
330

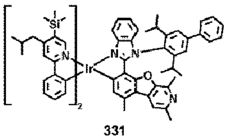
331
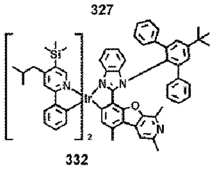
332
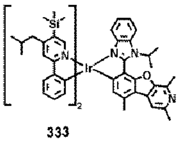
333
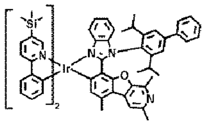
334
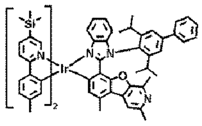
335

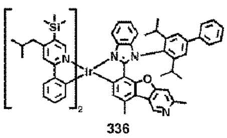
336
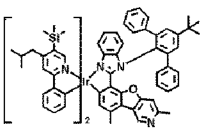
337
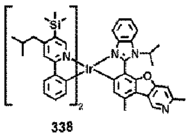
338
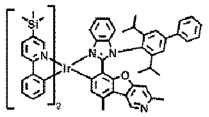
339
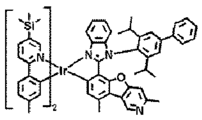
340

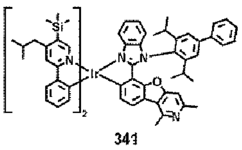
341
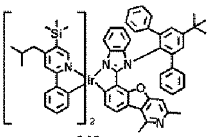
342
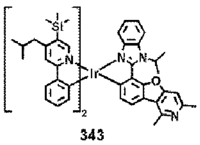
343
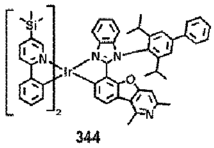
344
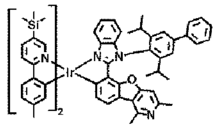
345

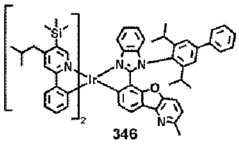
346
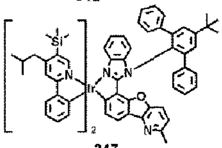
347
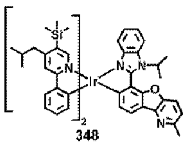
348
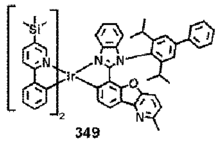
349
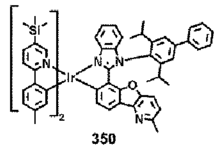
350

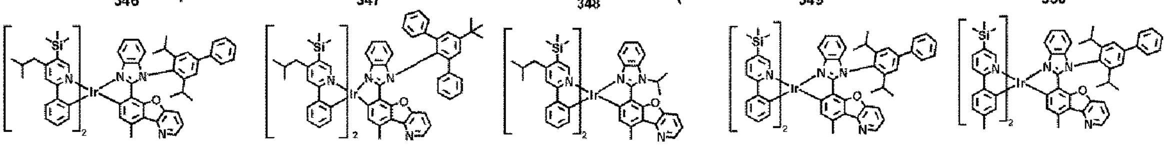
351 352 353 354 355

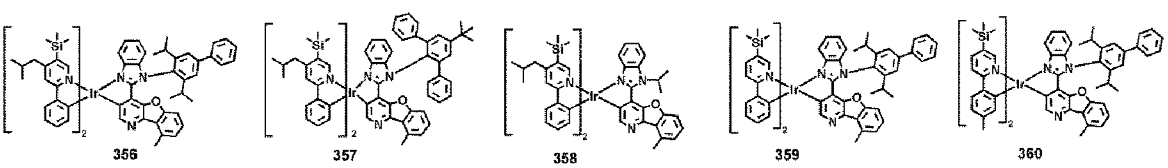
356 357 358 359 360

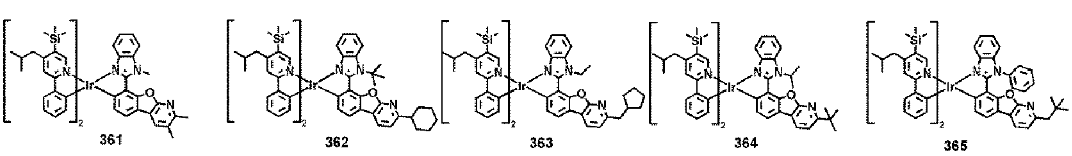
361 362 363 364 365

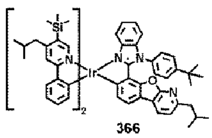
366
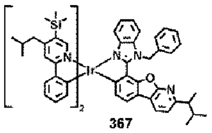
367
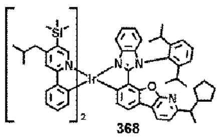
368
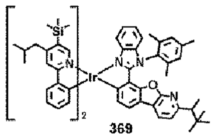
369
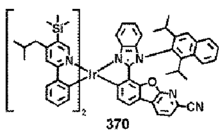
370

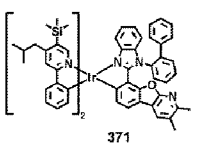
371
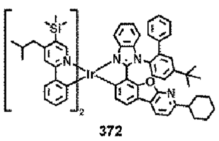
372
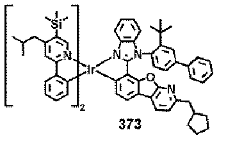
373
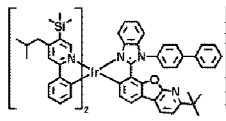
374
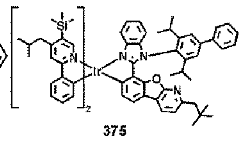
375

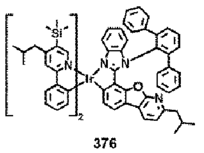
376
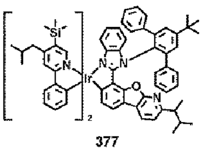
377
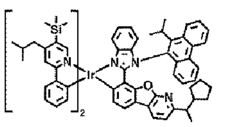
378
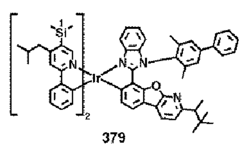
379
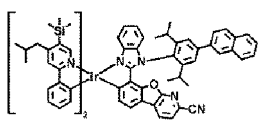
380

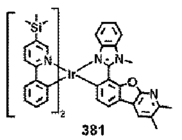
381
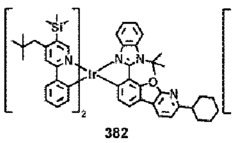
382
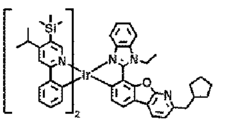
383
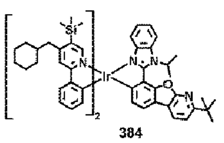
384
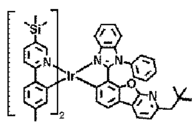
385

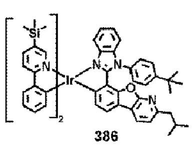
386
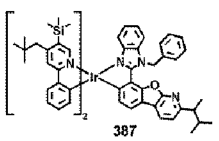
387
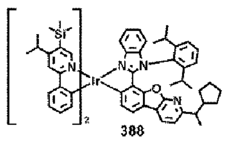
388
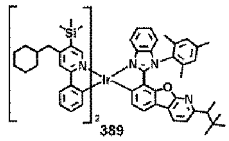
389
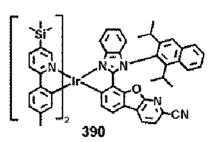
390

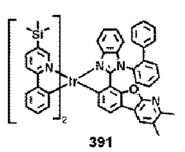
391
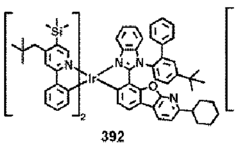
392
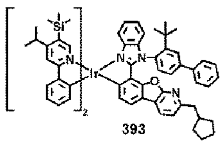
393
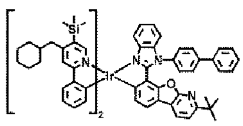
394
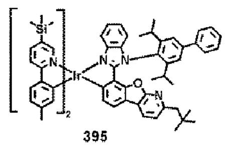
395

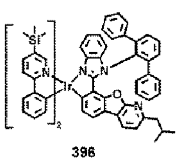
396
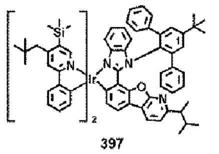
397
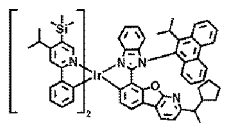
398
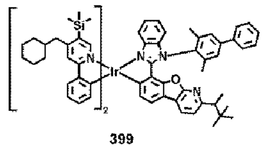
399
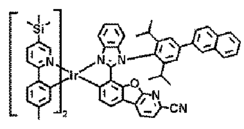
400

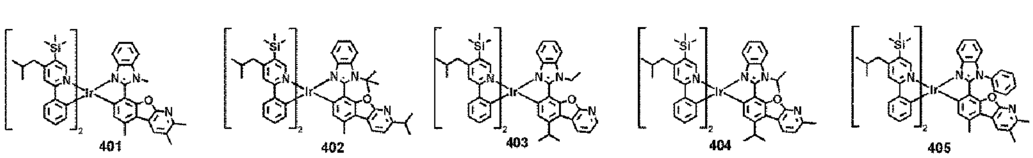
401
402
403
404
405

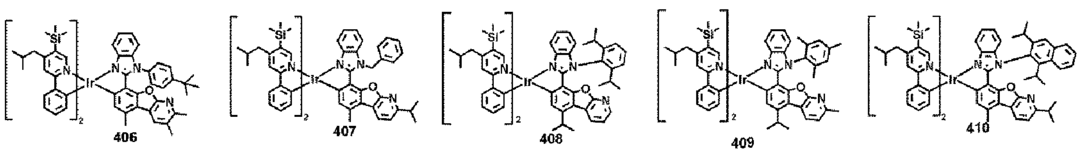
406
407
408
409
410

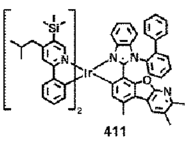
411
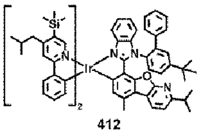
412
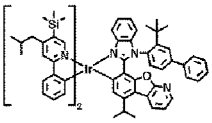
413
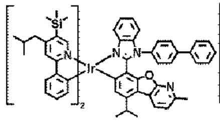
414
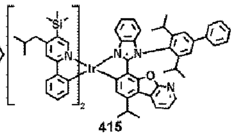
415

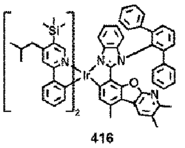
416
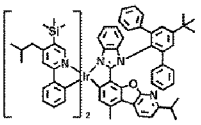
417
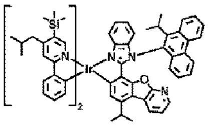
418
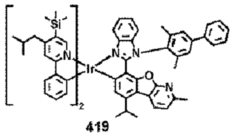
419
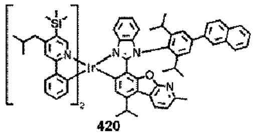
420

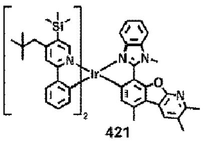
421
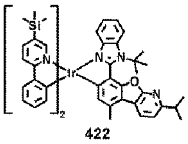
422
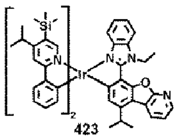
423
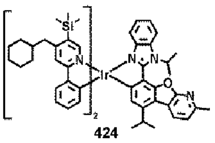
424
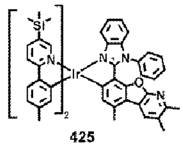
425

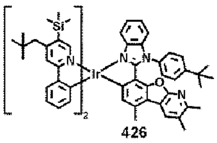
426
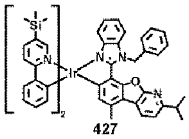
427
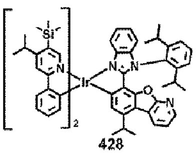
428
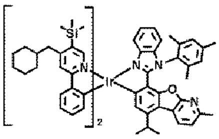
429
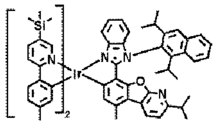
430

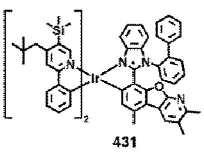
431
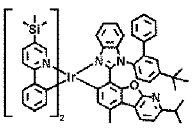
432
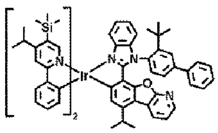
433
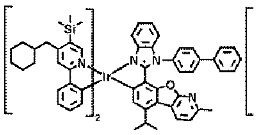
434
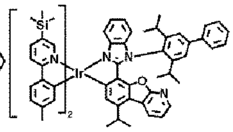
435

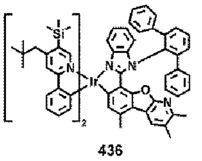
436
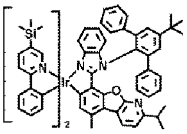
437
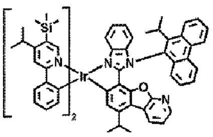
438
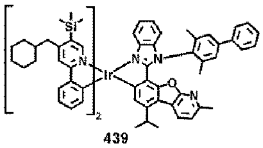
439
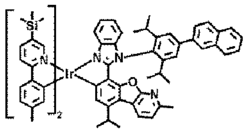
440

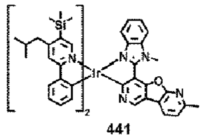
441
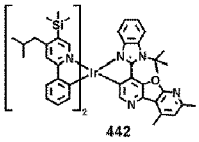
442
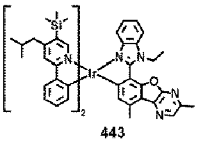
443
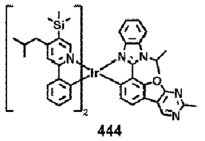
444
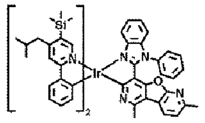
445

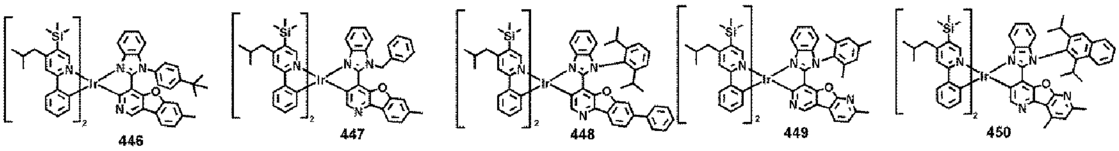
446
447
448
449
450

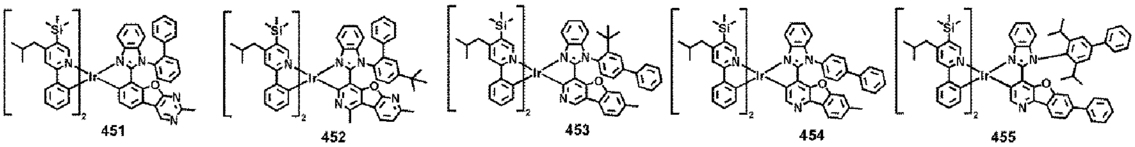
451
452
453
454
455

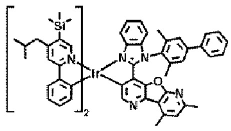
456

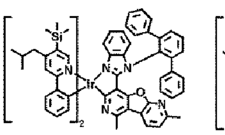
457

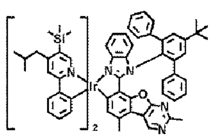
458

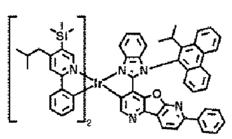
459

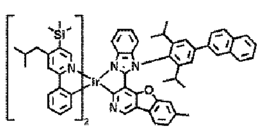
460

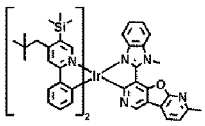
461

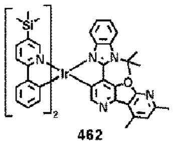
462

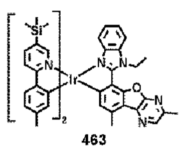
463

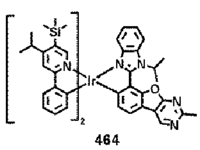
464

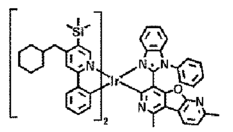
465

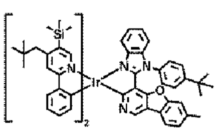
466

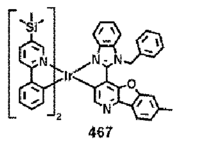
467

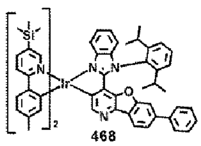
468

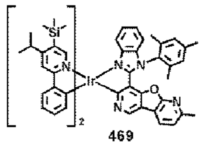
469

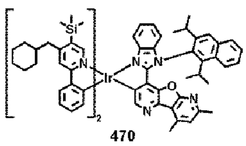
470

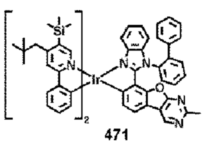
471

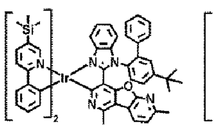
472

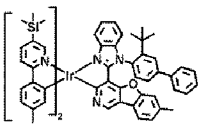
473

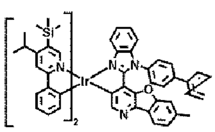
474

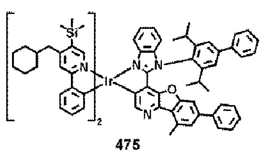
475

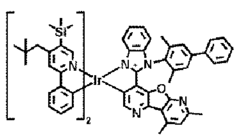
476

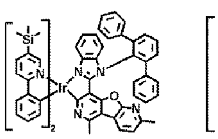
477

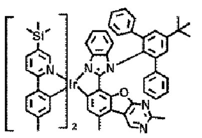
478

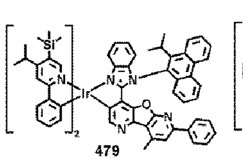
479

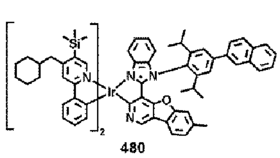
480

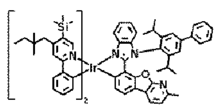
481

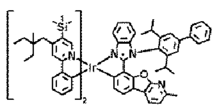
482

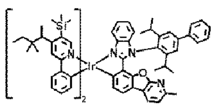
483

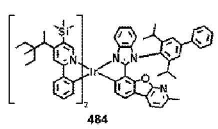
484

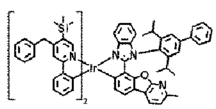
485

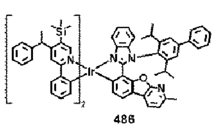
486

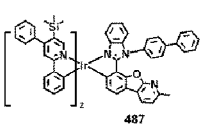
487

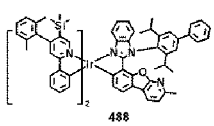
488

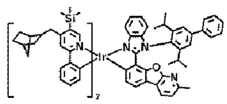
489

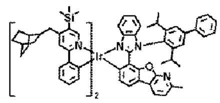
490

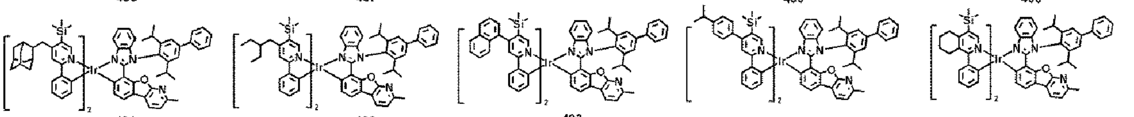
491 492 493 494 495

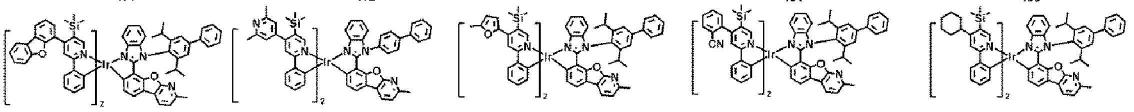
496 497 498 499 500

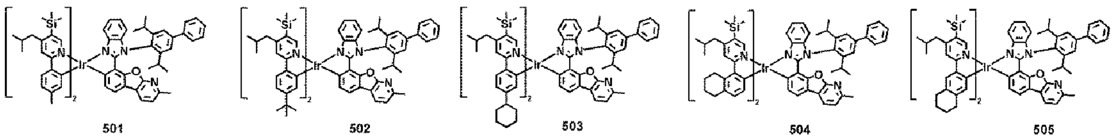
501 502 503 504 505

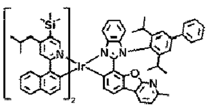
506
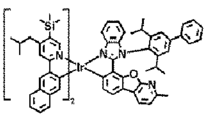
507
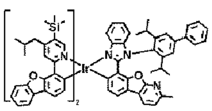
508
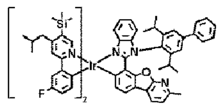
509
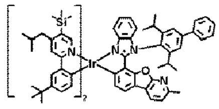
510

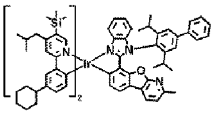
511
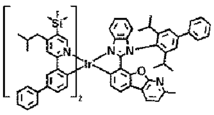
512
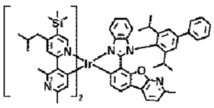
513
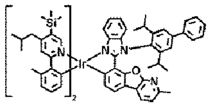
514
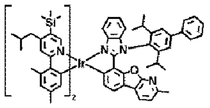
515

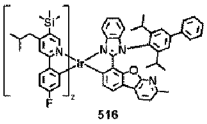
516
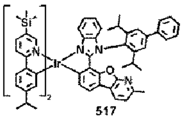
517
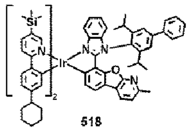
518
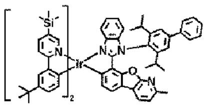
519
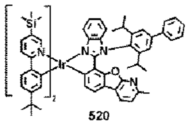
520

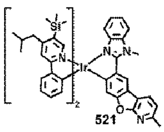
521
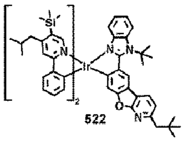
522
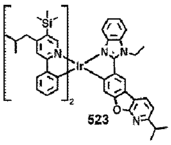
523
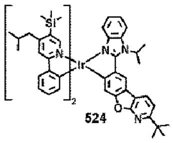
524
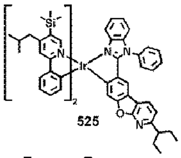
525

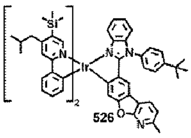
526
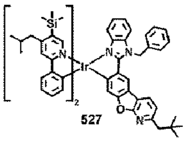
527
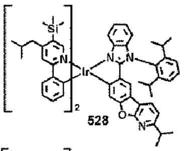
528
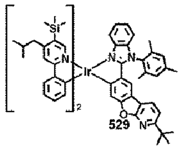
529
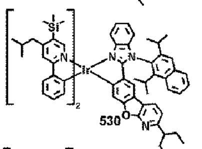
530

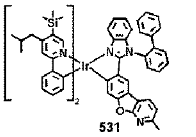
531
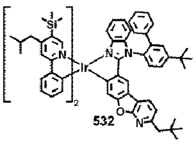
532
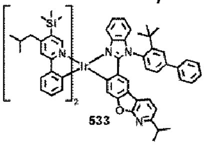
533
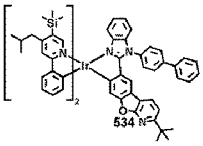
534
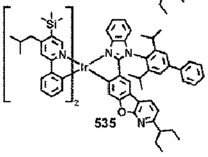
535

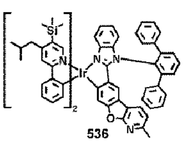
536
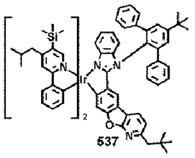
537
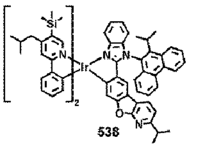
538
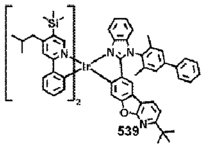
539
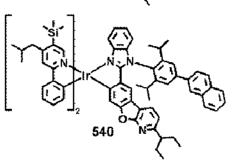
540

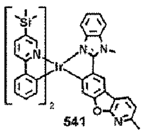
541
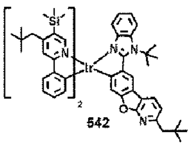
542
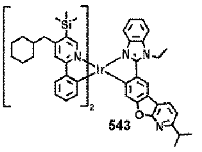
543
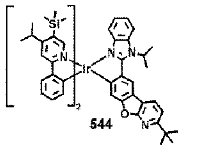
544
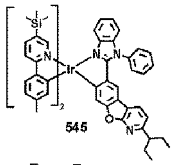
545
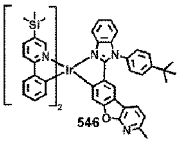
546
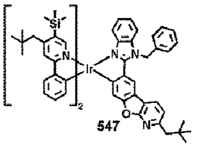
547
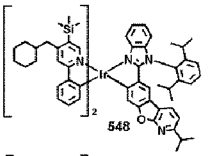
548
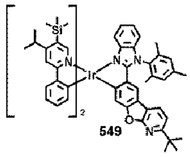
549
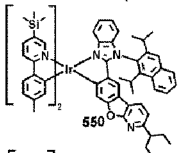
550
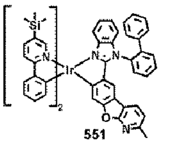
551
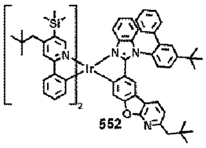
552
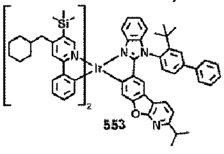
553
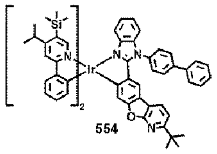
554
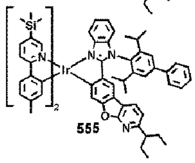
555
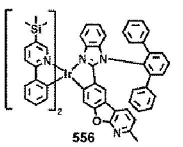
556
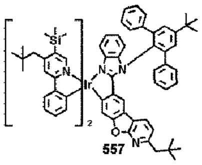
557
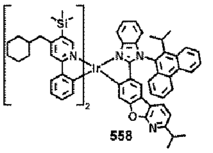
558
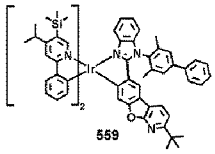
559
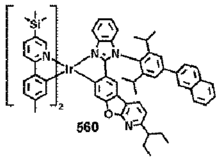
560
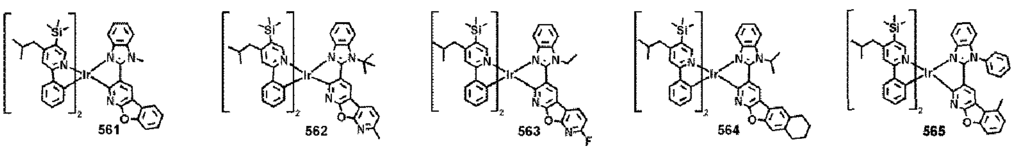
561 562 563 564 565
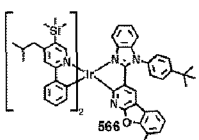
566
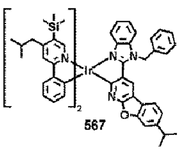
567
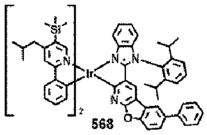
568
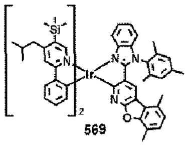
569
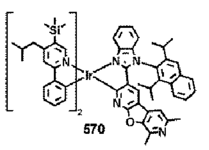
570
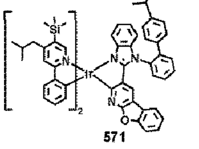
571
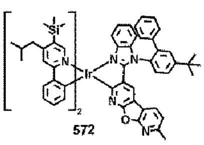
572
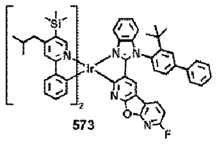
573
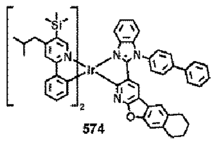
574
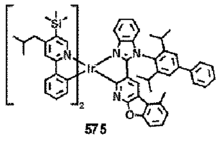
575
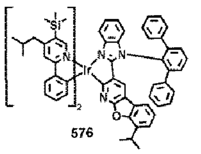
576
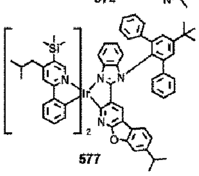
577
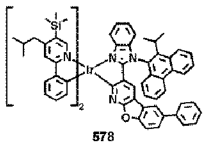
578
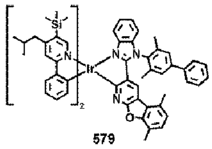
579
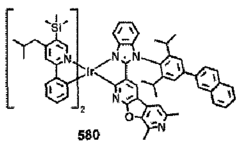
580
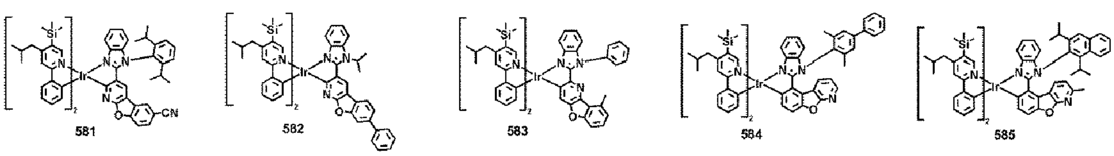
581 582 583 584 585

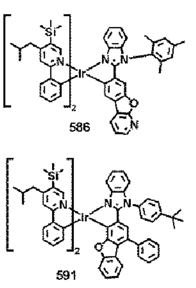
586
591
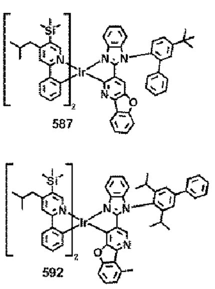
587
592
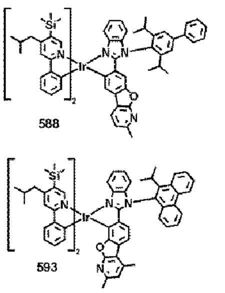
588
593
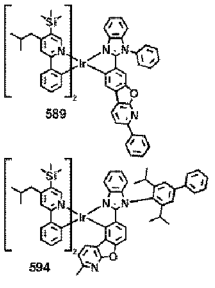
589
594
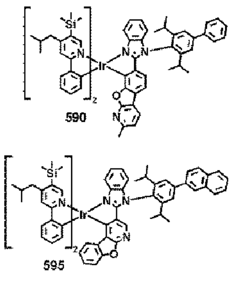
590
595
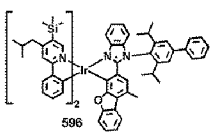
596
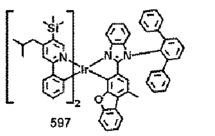
597
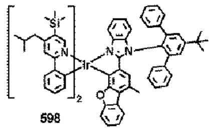
598
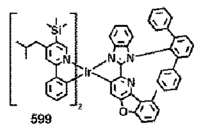
599
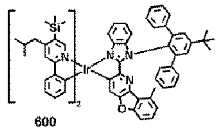
600
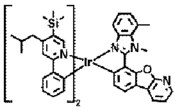
601
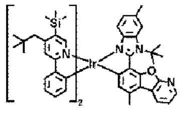
602
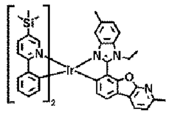
603
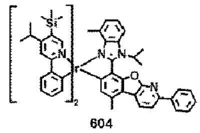
604
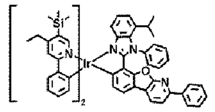
605
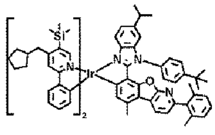
606
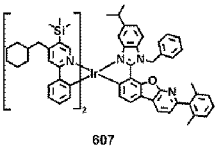
607
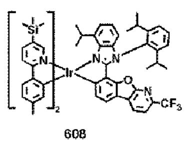
608
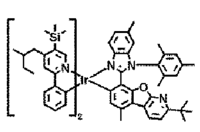
609
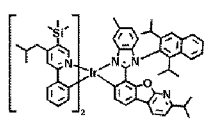
610
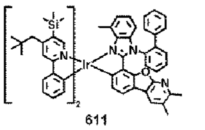
611
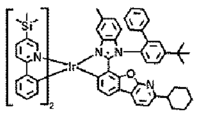
612
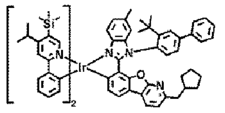
613
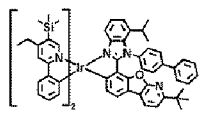
614
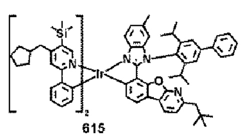
615
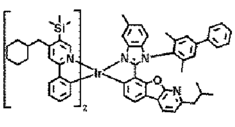
616
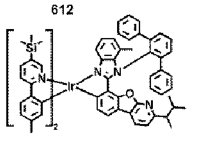
617
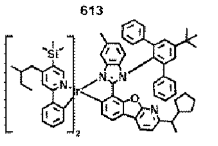
618
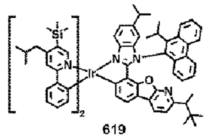
619
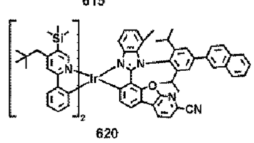
620
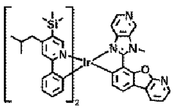
621
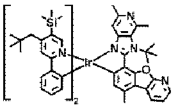
622
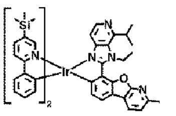
623
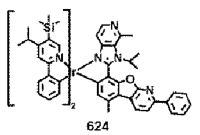
624
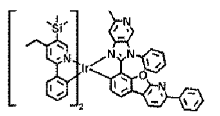
625
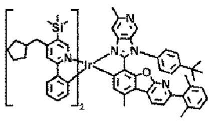
626
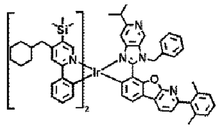
627
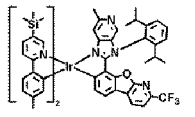
628
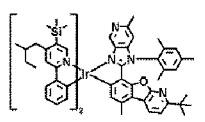
629
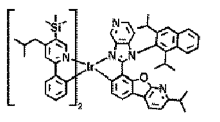
630

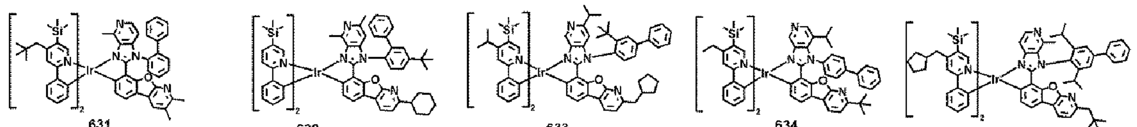

631 632 633 634 635

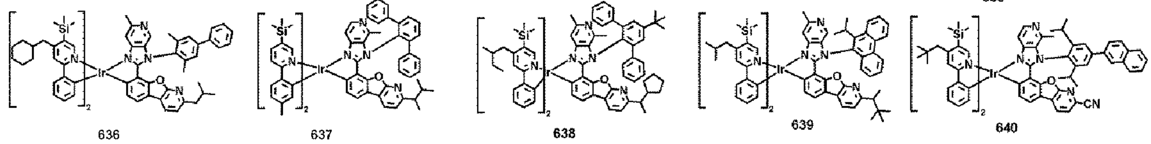

636 637 638 639 640

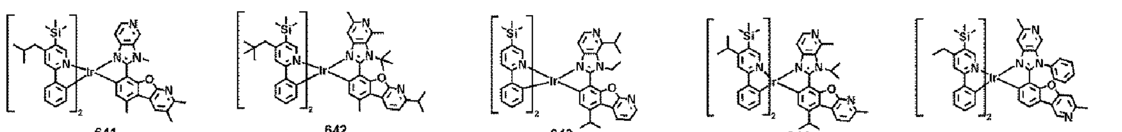

641 642 643 644 645

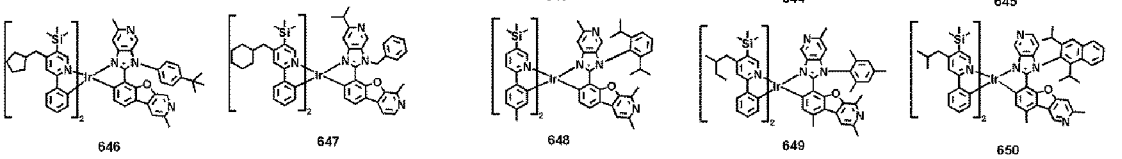

646 647 648 649 650

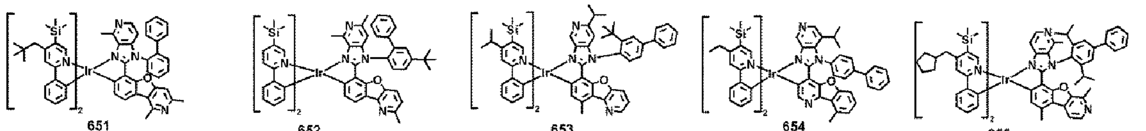

651 652 653 654 655

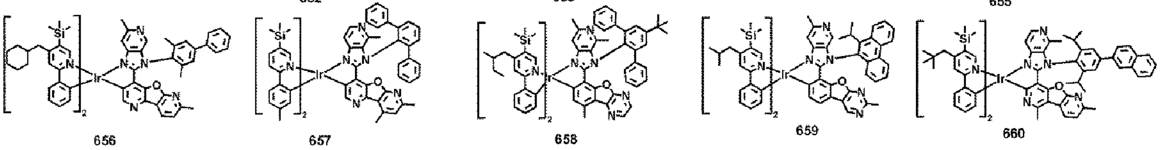

656 657 658 659 660

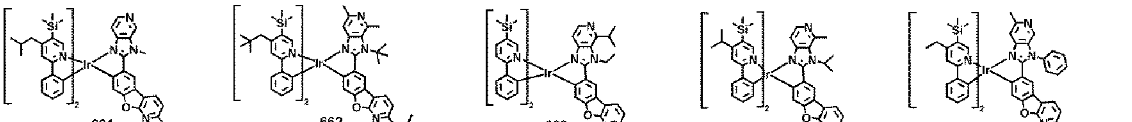

661 662 663 664 665

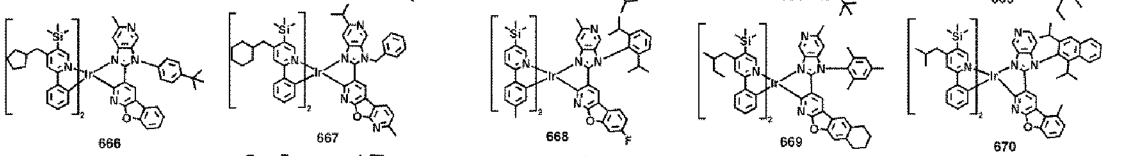

666 667 668 669 670

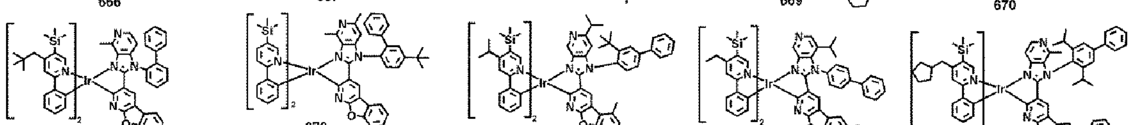

671 672 673 674 675

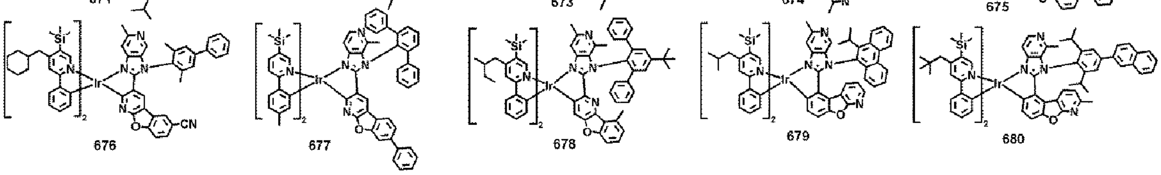

676 677 678 679 680

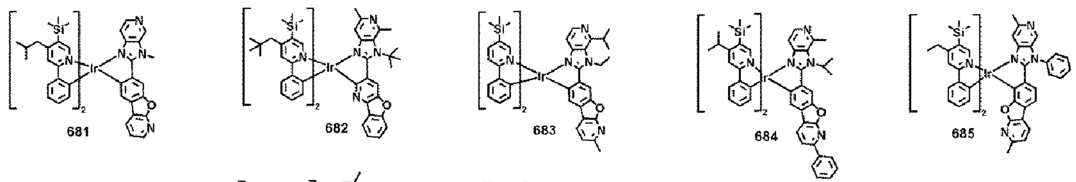

681 682 683 684 685

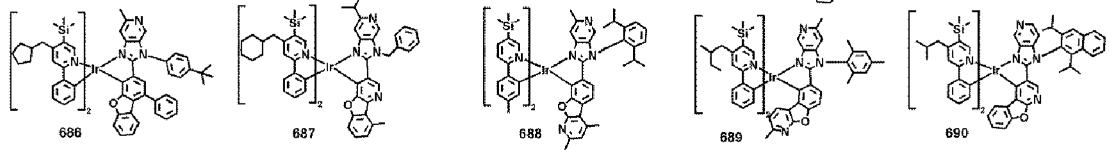

686 687 688 689 690

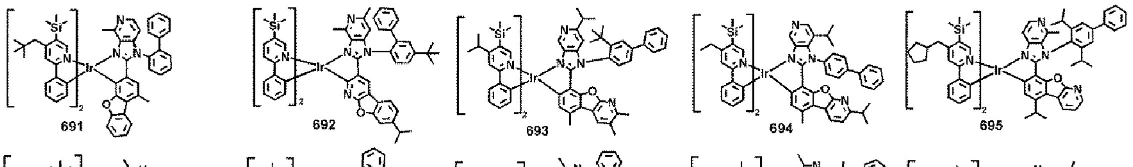

691 692 693 694 695

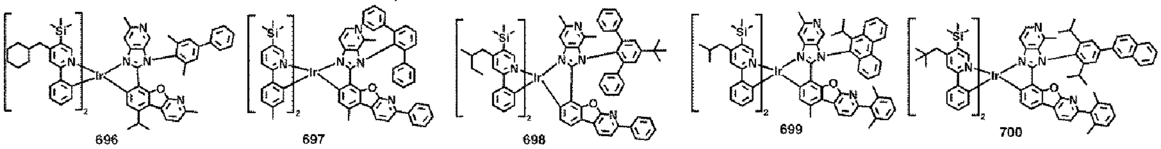

696 697 698 699 700

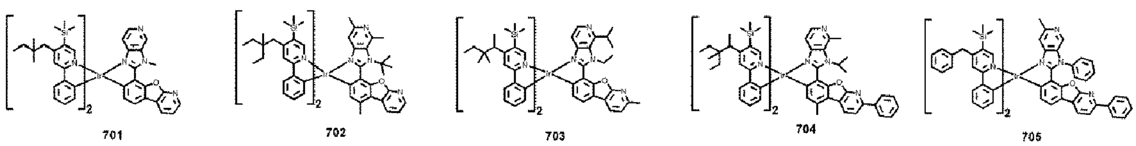

701 702 703 704 705

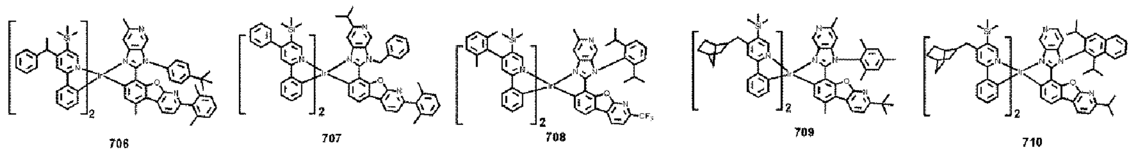

706 707 708 709 710

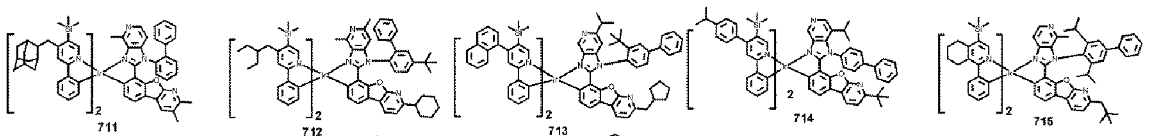

711 712 713 714 715

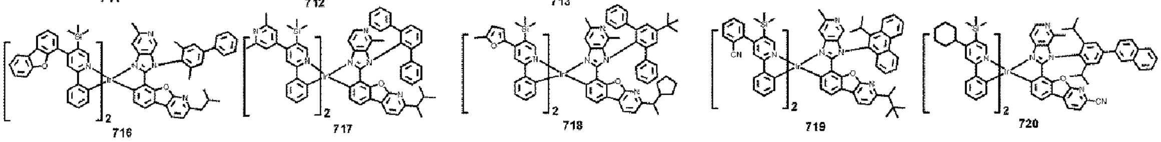

716 717 718 719 720

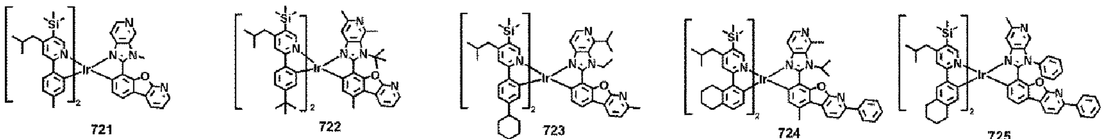

721 722 723 724 725

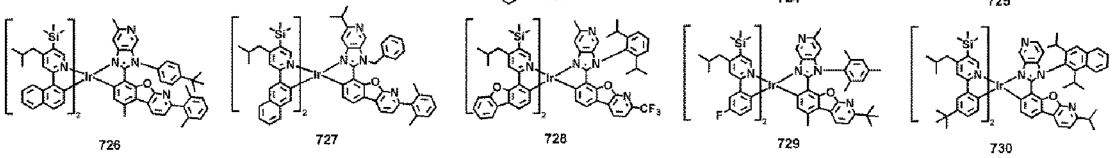

726 727 728 729 730

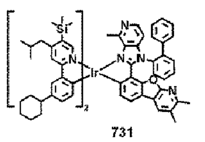
731
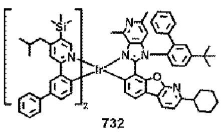
732
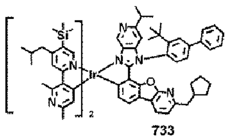
733
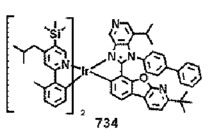
734
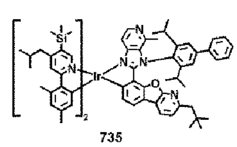
735

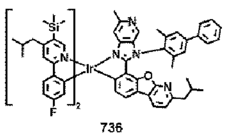
736
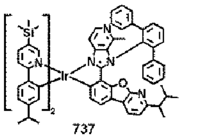
737
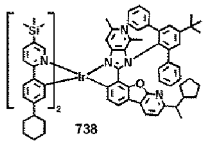
738
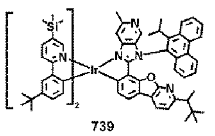
739
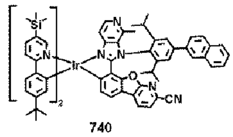
740

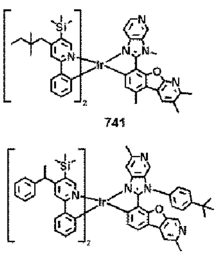
741
746
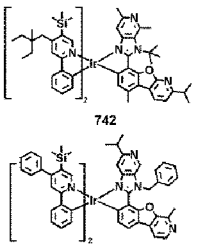
742
747
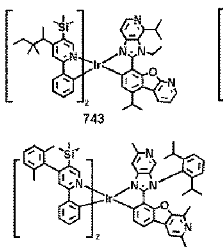
743
748
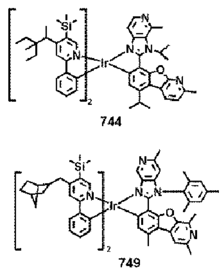
744
749
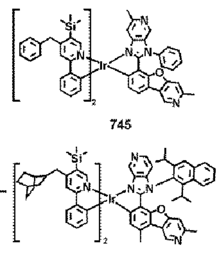
745
750

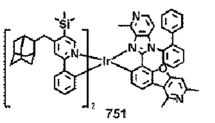
751
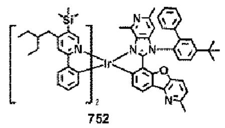
752
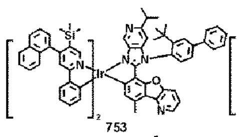
753
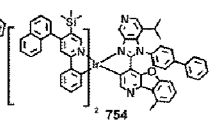
754
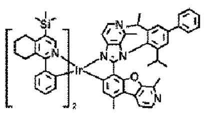
755

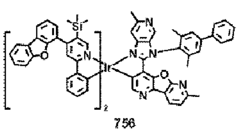
756
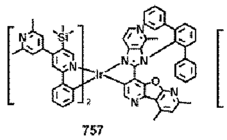
757
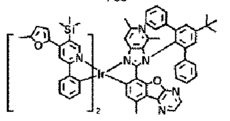
758
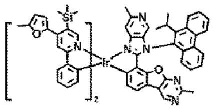
759
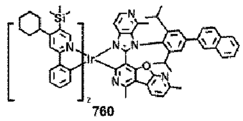
760

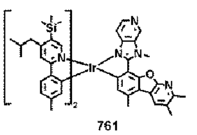
761
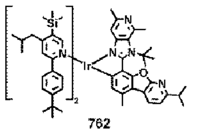
762
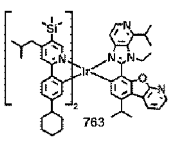
763
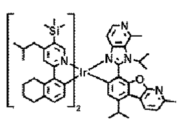
764
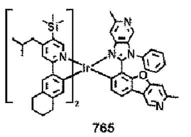
765

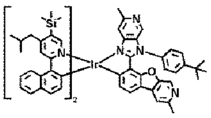
766
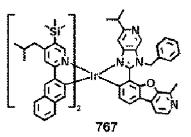
767
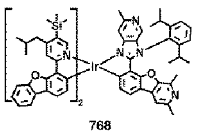
768
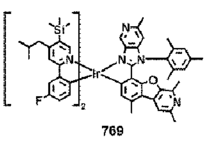
769
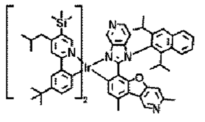
770

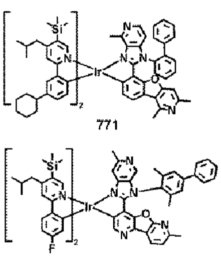
771
776
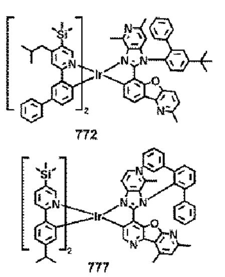
772
777
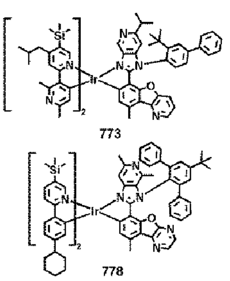
773
778
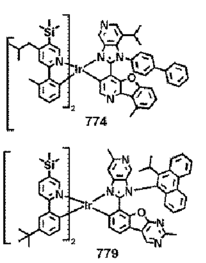
774
779
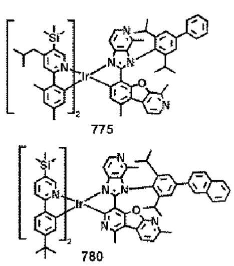
775
780

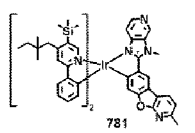
781
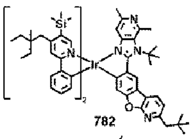
782
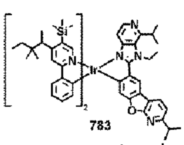
783
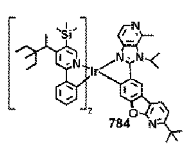
784
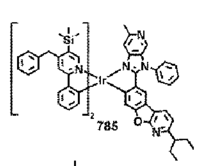
785
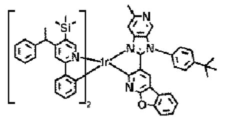
786
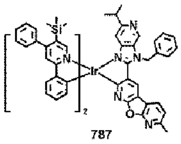
787
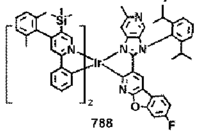
788
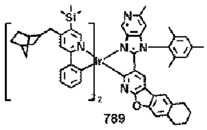
789
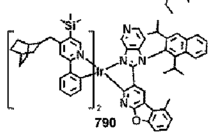
790
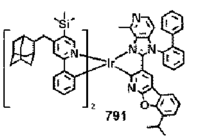
791
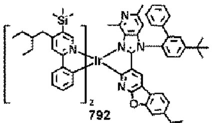
792
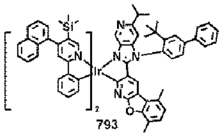
793
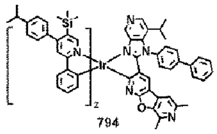
794
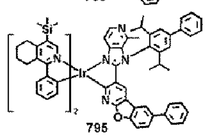
795
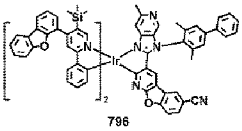
796
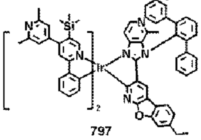
797
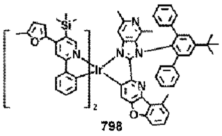
798
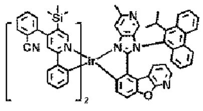
799
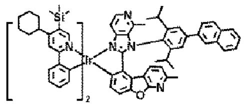
800
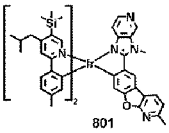
801
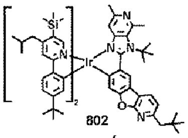
802
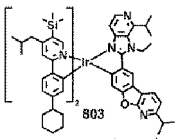
803
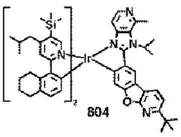
804
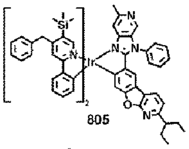
805
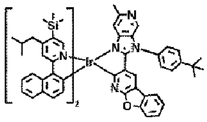
806
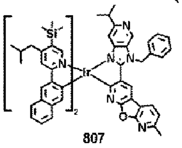
807
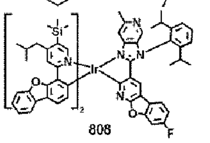
808
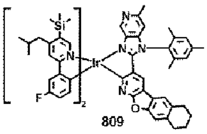
809
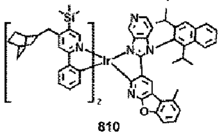
810
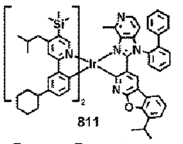
811
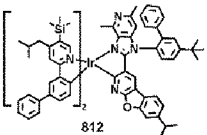
812
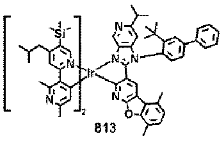
813
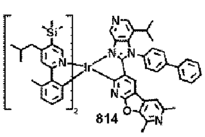
814
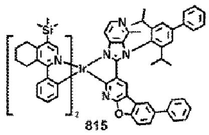
815
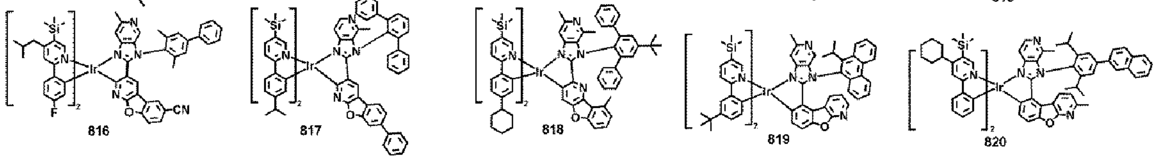
816 817 818 819 820
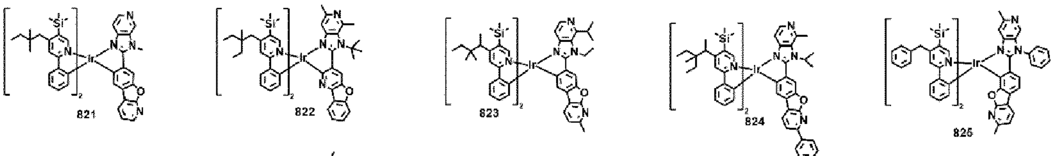
821 822 823 824 825
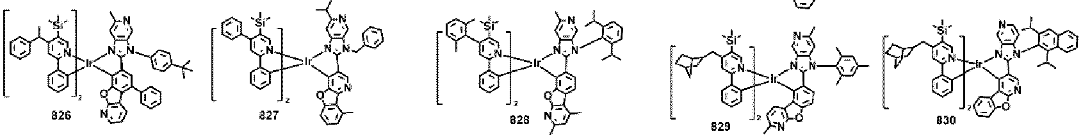
826 827 828 829 830

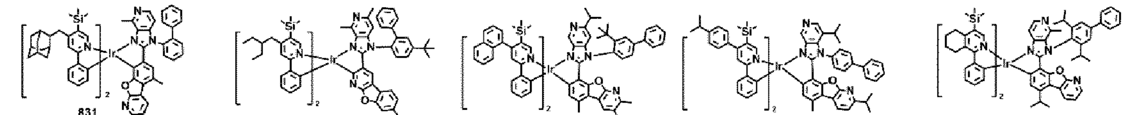

831 832 833 834 835

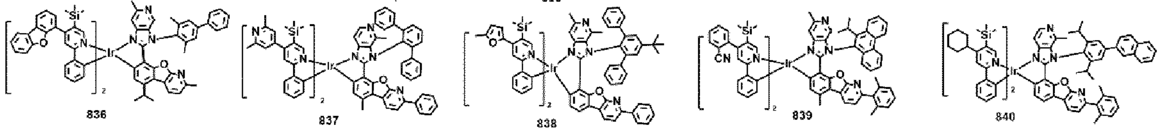

836 837 838 839 840

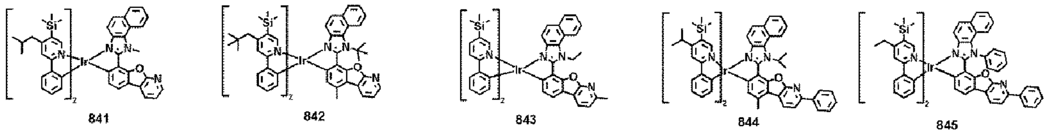

841 842 843 844 845

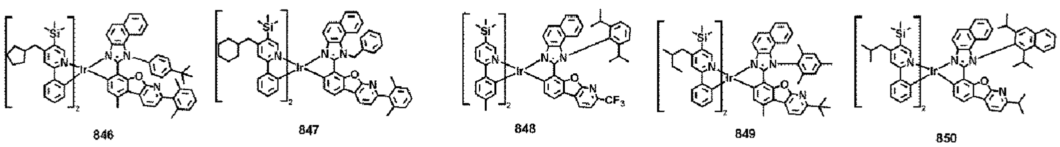

846 847 848 849 850

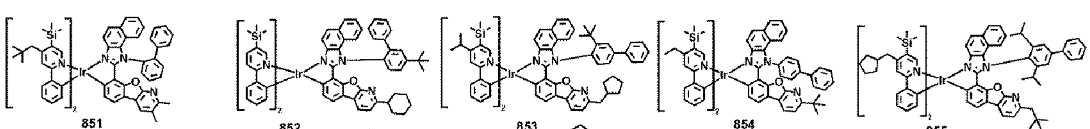

851 852 853 854 855

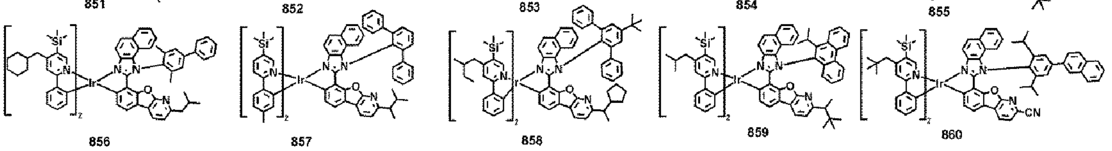

856 857 858 859 860

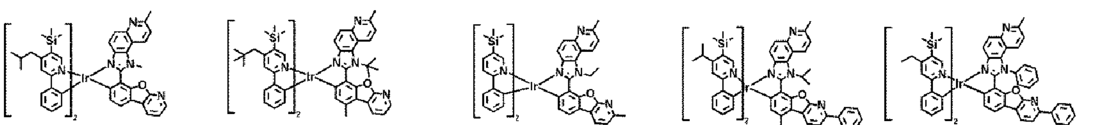

861 862 863 864 865

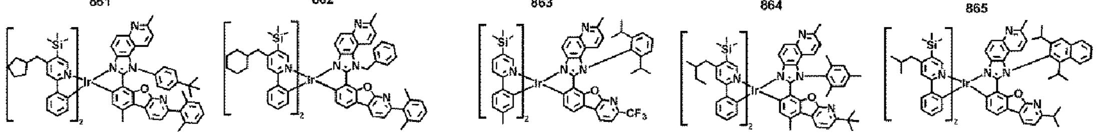

866 867 868 869 870

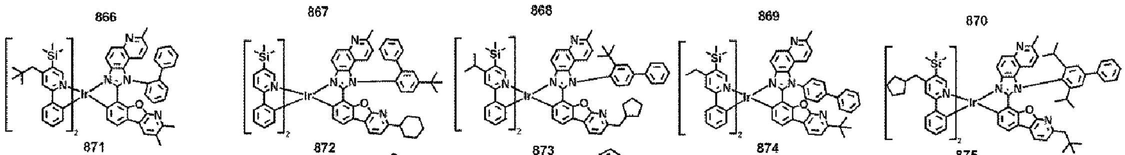

871 872 873 874 875

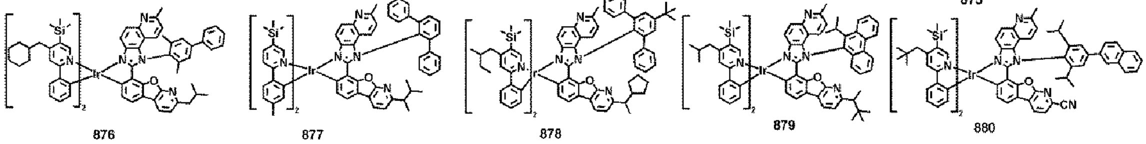

876 877 878 879 880

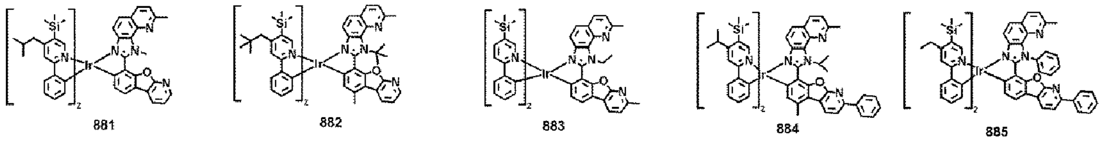

881 882 883 884 885

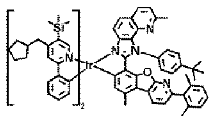
886

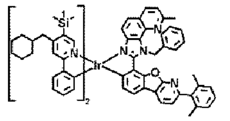
887

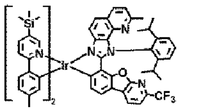
888

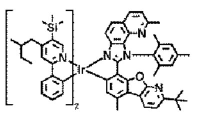
889

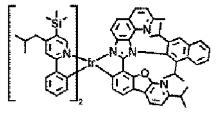
890

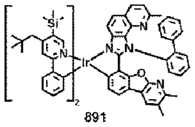
891

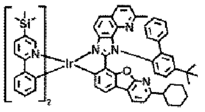
892

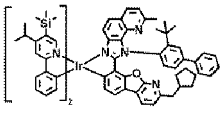
893

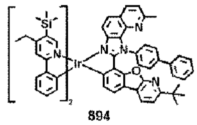
894

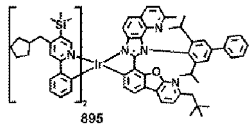
895

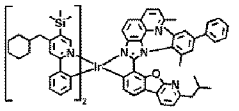
896

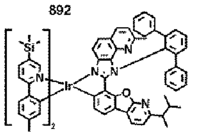
897

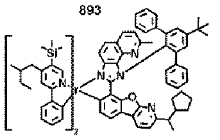
898

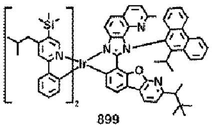
899

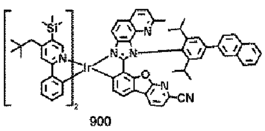
900

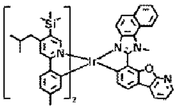
901

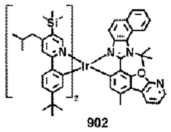
902

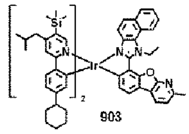
903

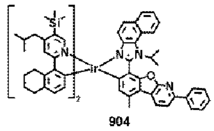
904

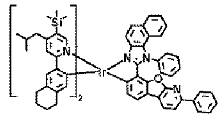
905

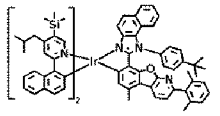
906

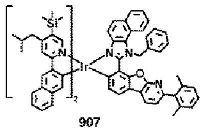
907

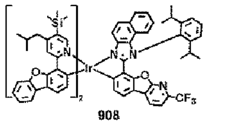
908

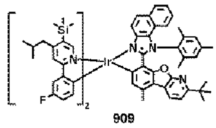
909

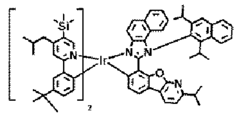
910

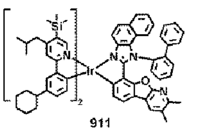
911

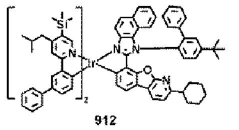
912

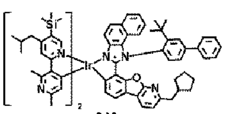
913

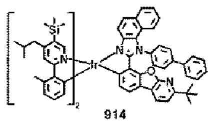
914

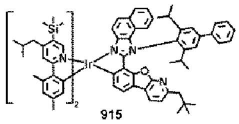
915

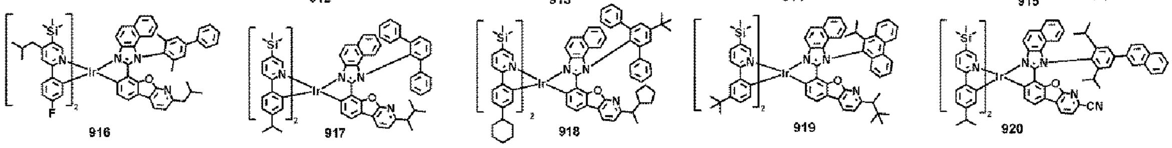
916 917 918 919 920

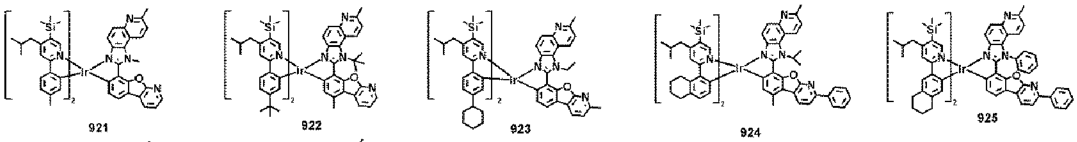
921 922 923 924 925

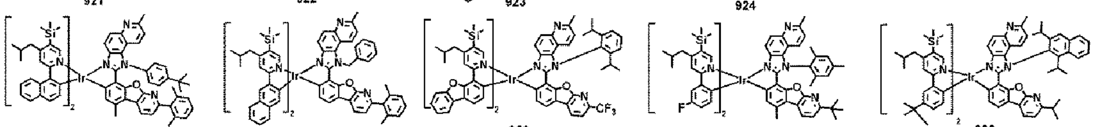
926 927 928 929 930

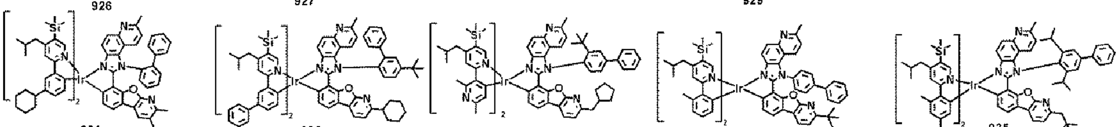
931 932 933 934 935

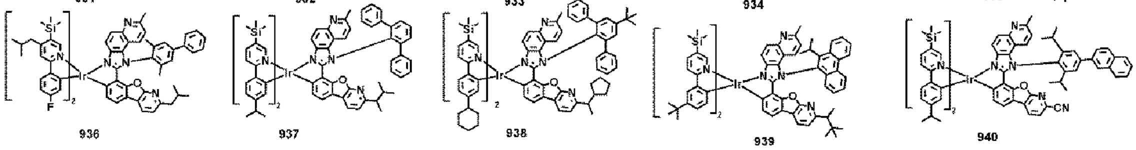
936 937 938 939 940

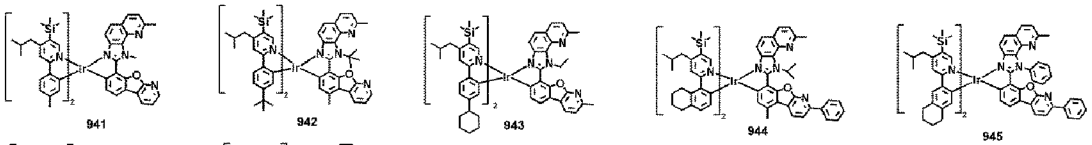
941 942 943 944 945

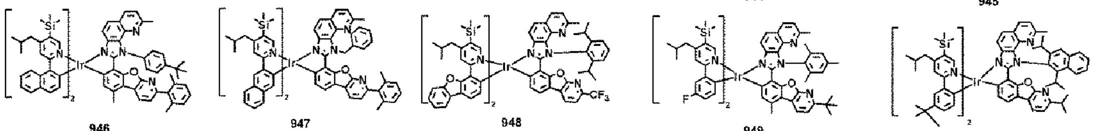
946 947 948 949 950

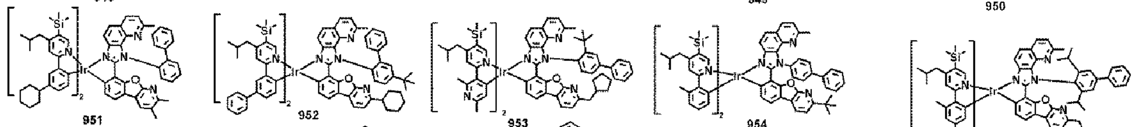
951 952 953 954 955

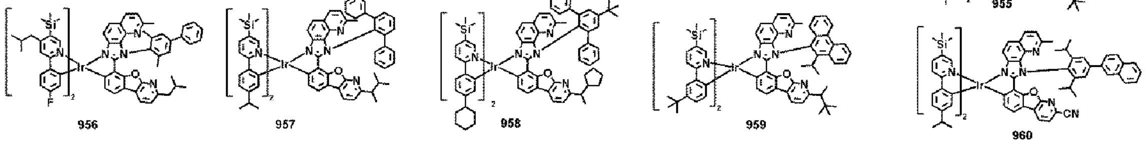
956 957 958 959 960

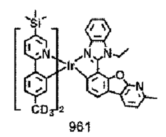
961

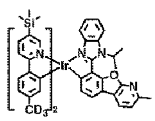
962

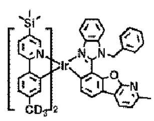
963

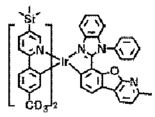
964

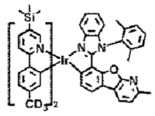
965

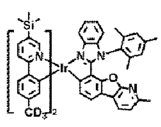
966

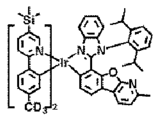
967

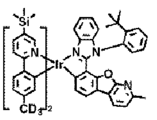
968

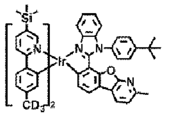
969

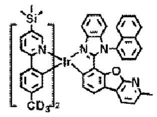
970

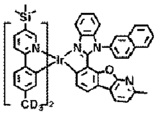
971

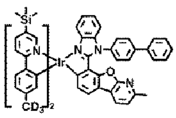
972

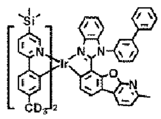
973

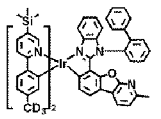
974

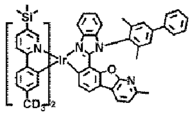
975

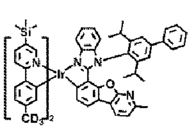
976

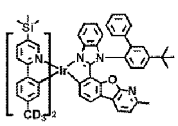
977

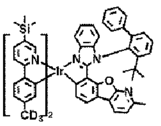
978

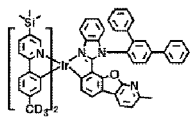
979

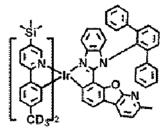
980

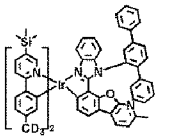
981

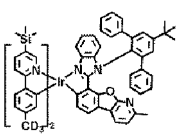
982

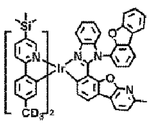
983

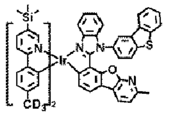
984

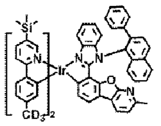
985

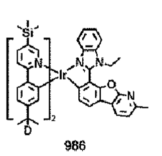
986

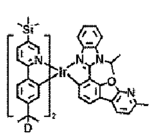
987

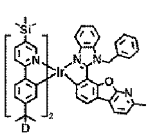
988

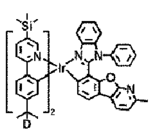
989

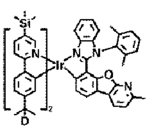
990

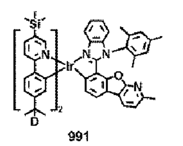
991
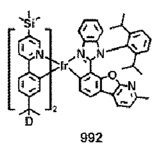
992
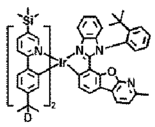
993
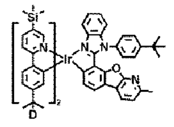
994
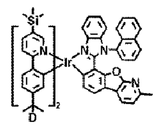
995

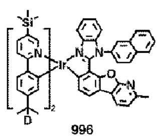
996
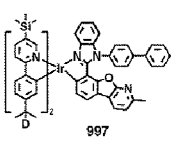
997
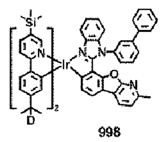
998
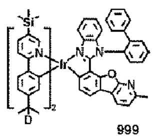
999
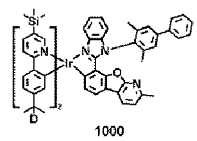
1000

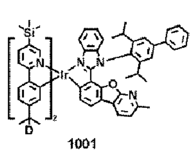
1001
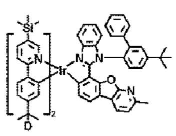
1002
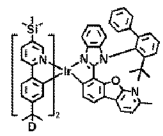
1003
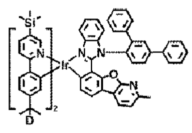
1004
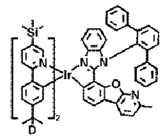
1005

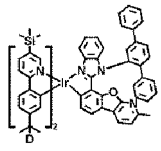
1006
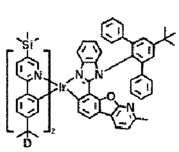
1007
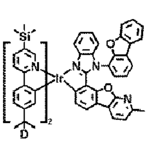
1008
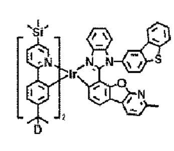
1009
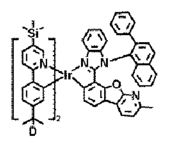
1010

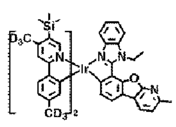
1011
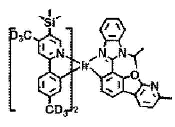
1012
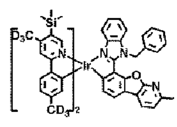
1013
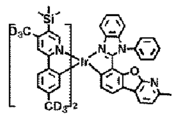
1014
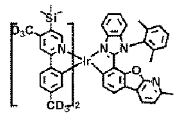
1015

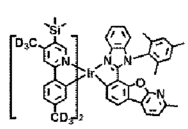
1016
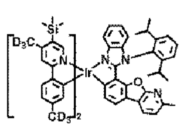
1017
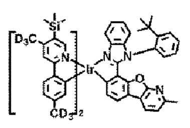
1018
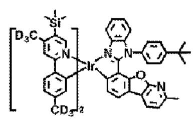
1019
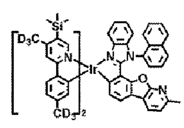
1020

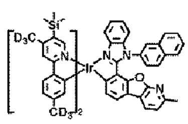
1021
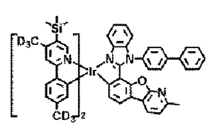
1022
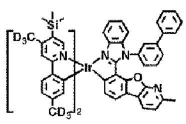
1023
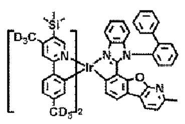
1024
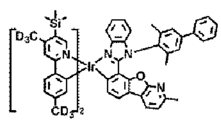
1025

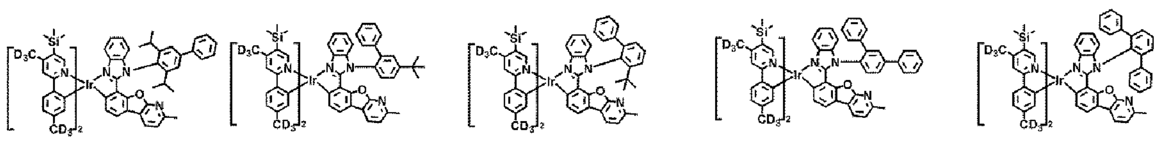
1026 1027 1028 1029 1030

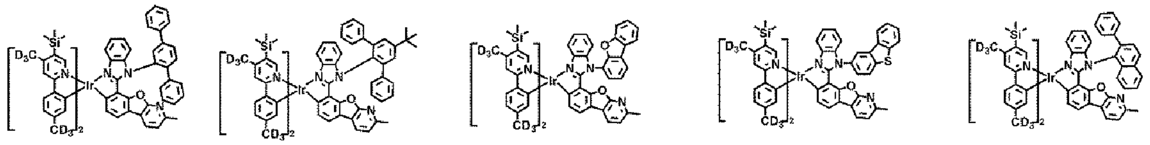
1031 1032 1033 1034 1035

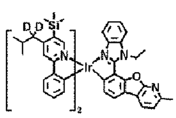
1036

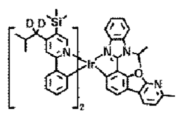
1037

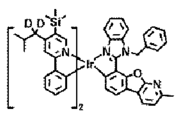
1038

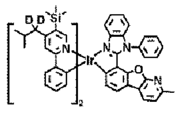
1039

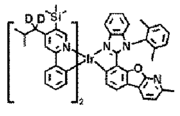
1040

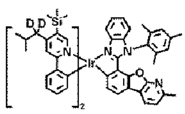
1041

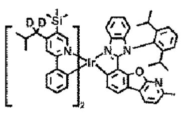
1042

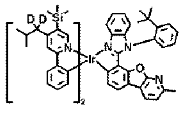
1043

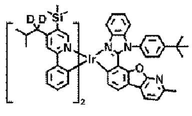
1044

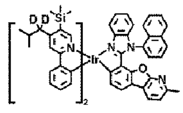
1045

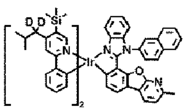
1046

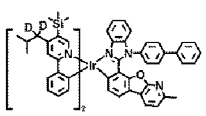
1047

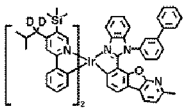
1048

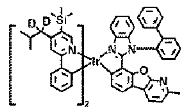
1049

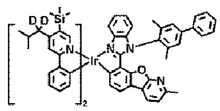
1050

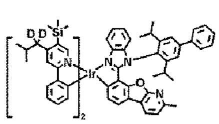
1051

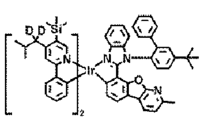
1052

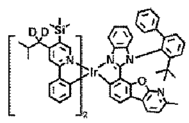
1053

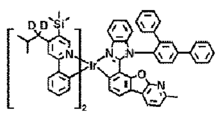
1054

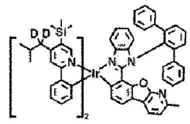
1055

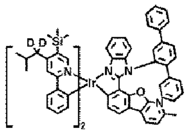
1056

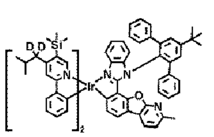
1057

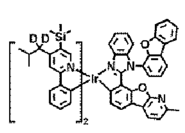
1058

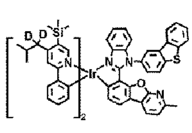
1059

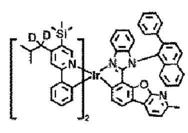
1060

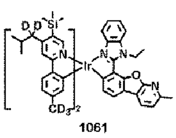
1061

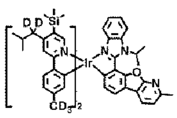
1062

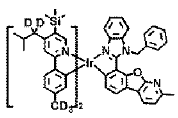
1063

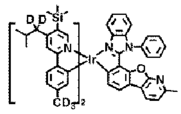
1064

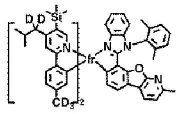
1065

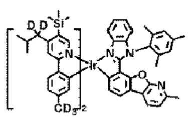
1066

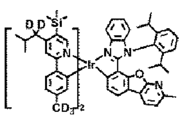
1067

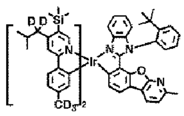
1068

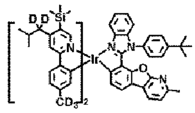
1069

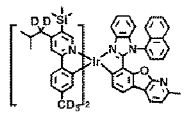
1070

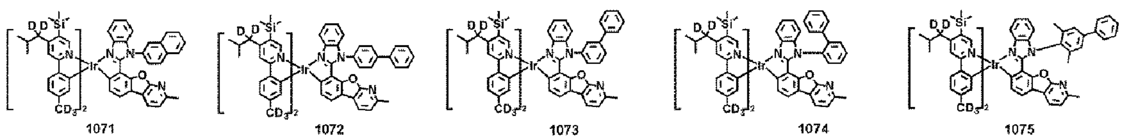
1071 1072 1073 1074 1075

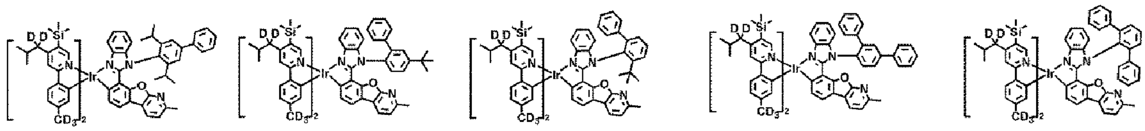
1076 1077 1078 1079 1080

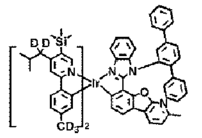
1081

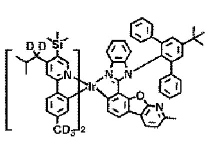
1082

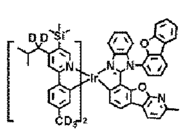
1083

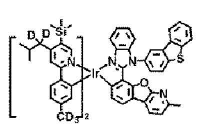
1084

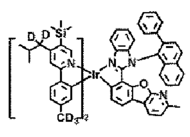
1085

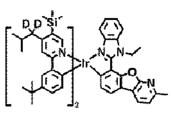
1086

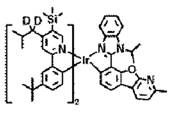
1087

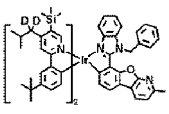
1088

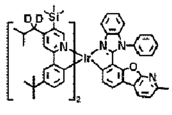
1089

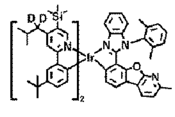
1090

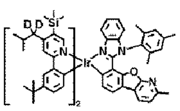
1091

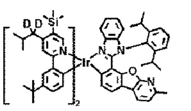
1092

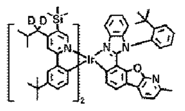
1093

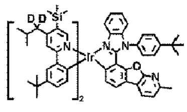
1094

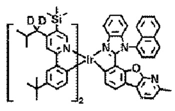
1095

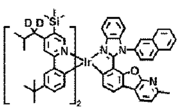
1096

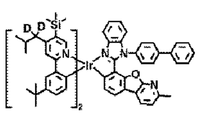
1097

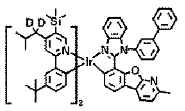
1098

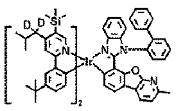
1099

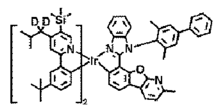
1100

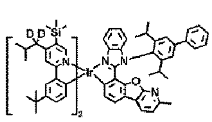
1101

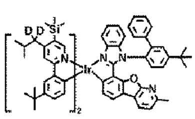
1102

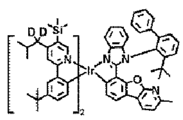
1103

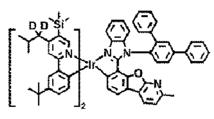
1104

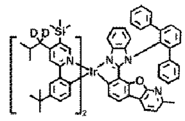
1105

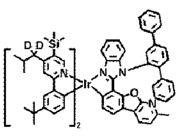
1106

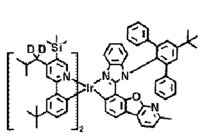
1107

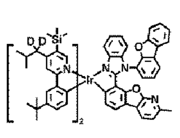
1108

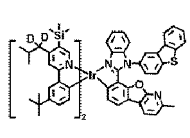
1109

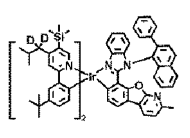
1110

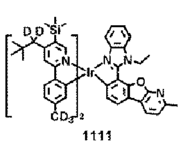
1111

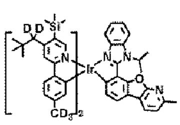
1112

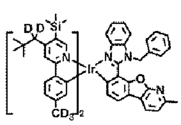
1113

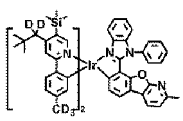
1114

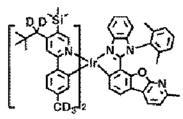
1115

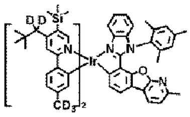
1116

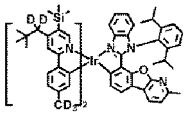
1117

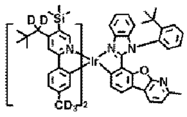
1118

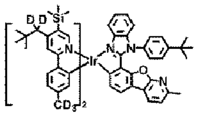
1119

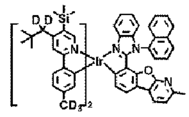
1120

1121

1122

1123

1124

1125

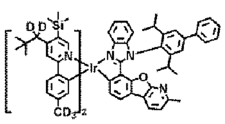
1126

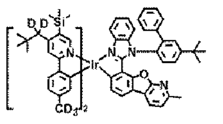
1127

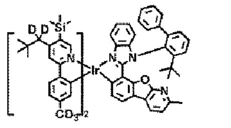
1128

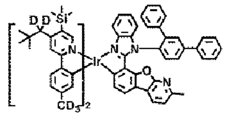
1129

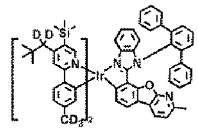
1130

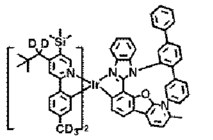
1131

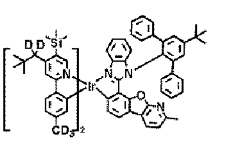
1132

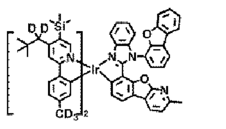
1133

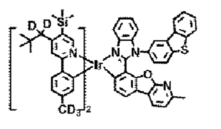
1134

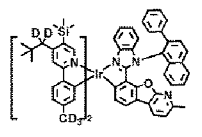
1135

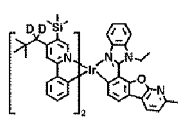
1136

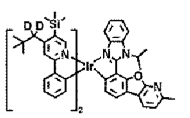
1137

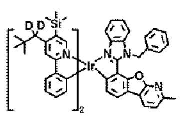
1138

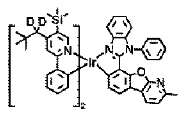
1139

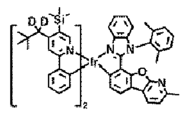
1140

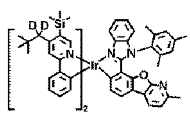
1141

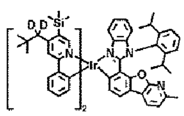
1142

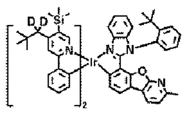
1143

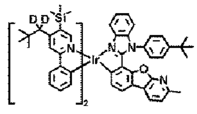
1144

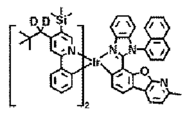
1145

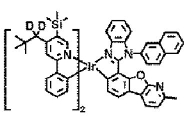
1146

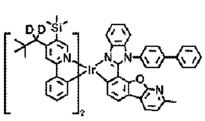
1147

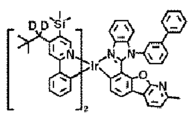
1148

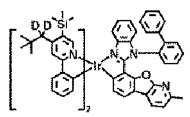
1149

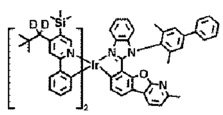
1150

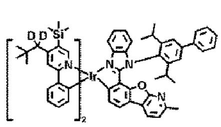
1151

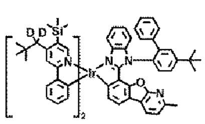
1152

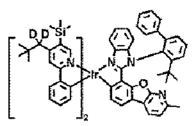
1153

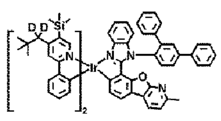
1154

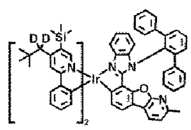
1155

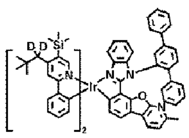
1156

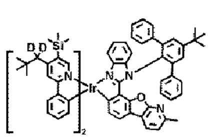
1157

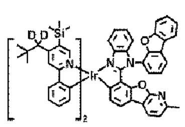
1158

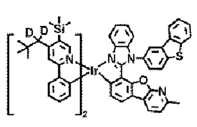
1159

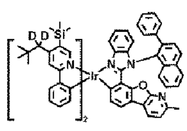
1160

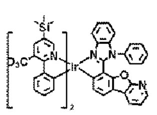
1161

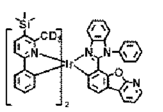
1162

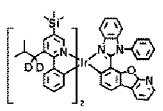
1163

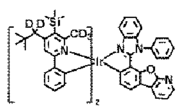
1164

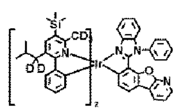
1165

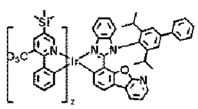
1166

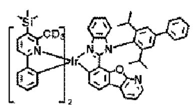
1167

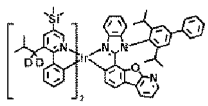
1168

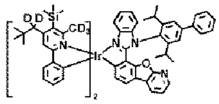
1169

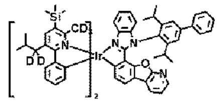
1170

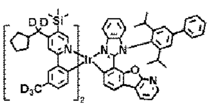
1171

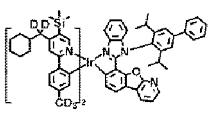
1172

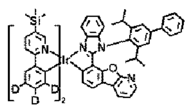
1173

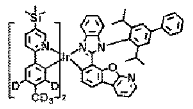
1174

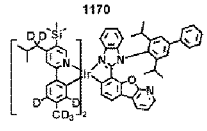
1175

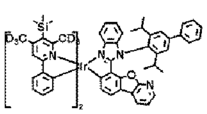
1176

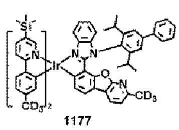
1177

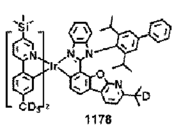
1178

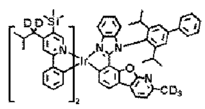
1179

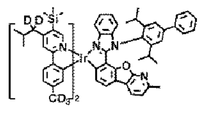
1180

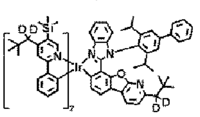
1181

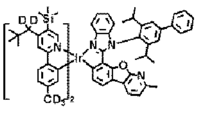
1182

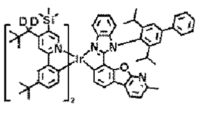
1183

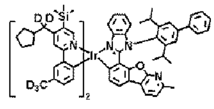
1184

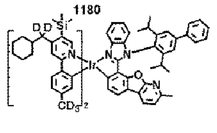
1185

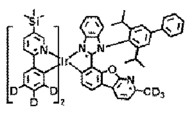
1186

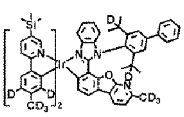
1187

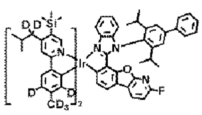
1188

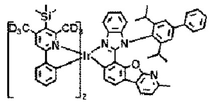
1189

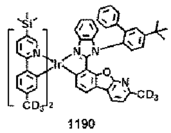
1190

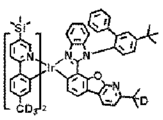
1191

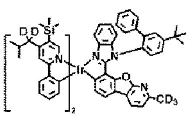
1192

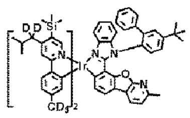
1193

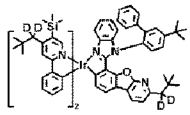
1194

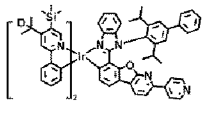
1195

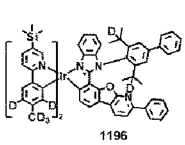
1196

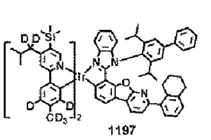
1197

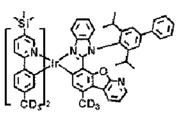
1198

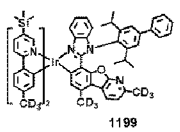
1199

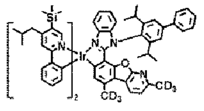
1200

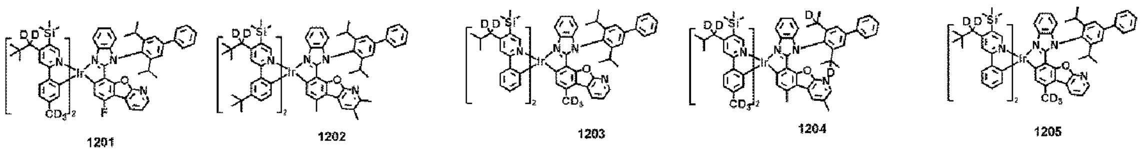
1201 1202 1203 1204 1205

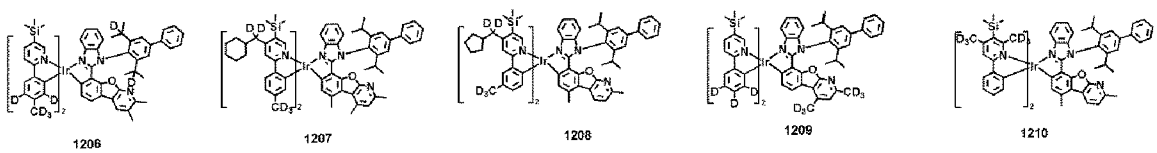
1206 1207 1208 1209 1210

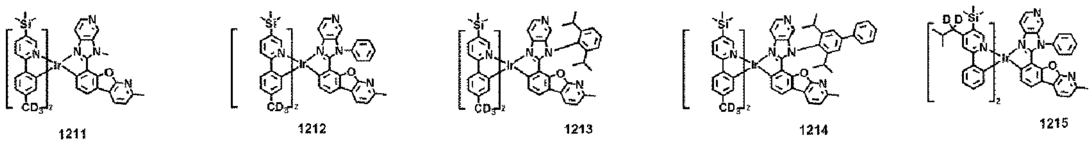
1211 1212 1213 1214 1215

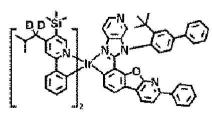
1216

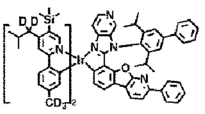
1217

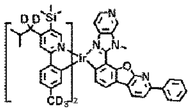
1218

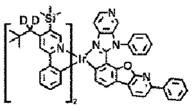
1219

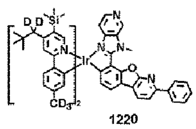
1220

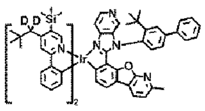
1221

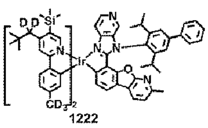
1222

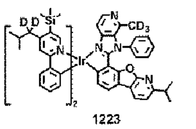
1223

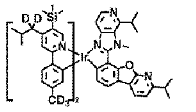
1224

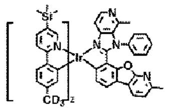
1225

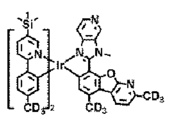
1226

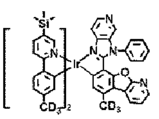
1227

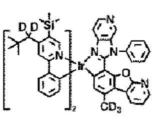
1228

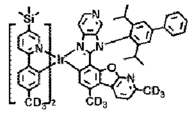
1229

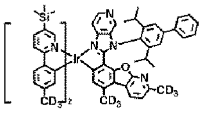
1230

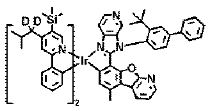
1231

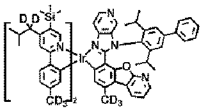
1232

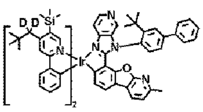
1233

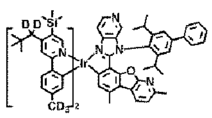
1234

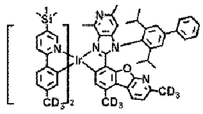
1235

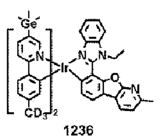
1236

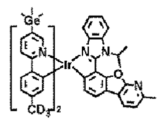
1237

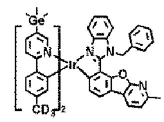
1238

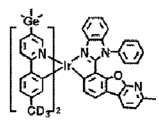
1239

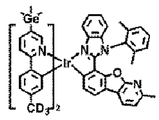
1240

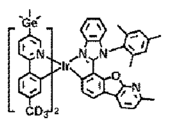
1241

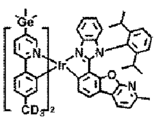
1242

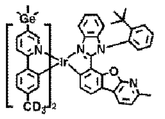
1243

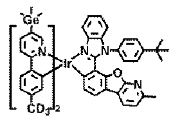
1244

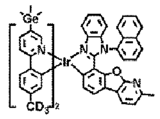
1245

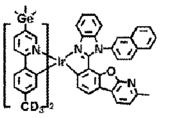
1246

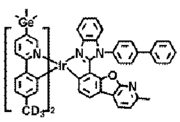
1247

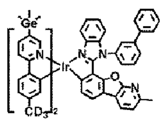
1248

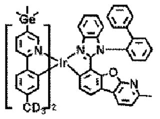
1249

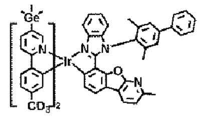
1250

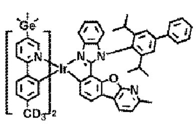
1251

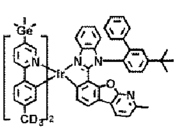
1252

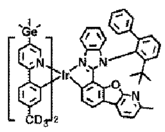
1253

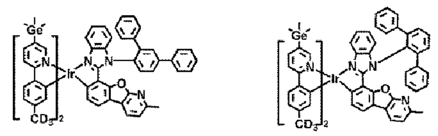
1254

1255

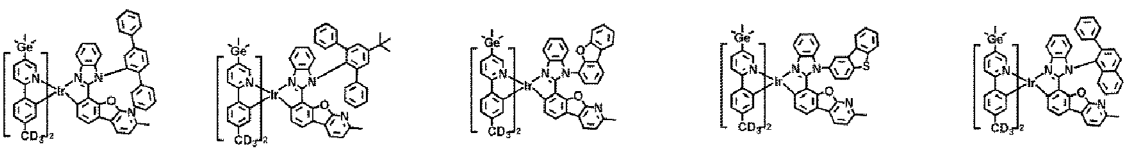
1256

1257

1258

1259

1260

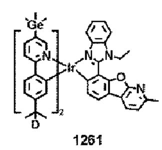
1261

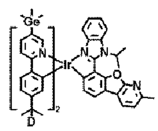
1262

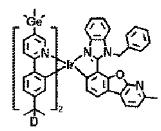
1263

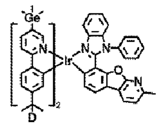
1264

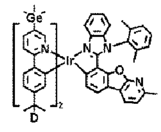
1265

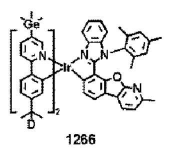
1266

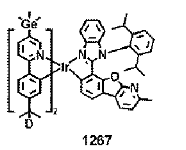
1267

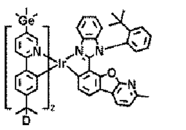
1268

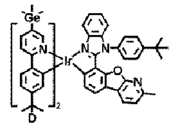
1269

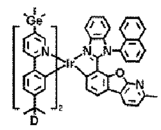
1270

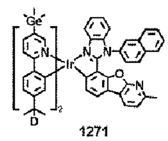
1271

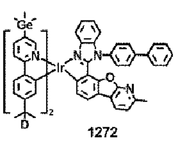
1272

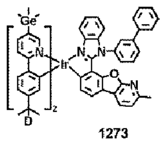
1273

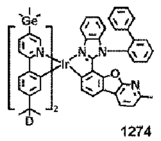
1274

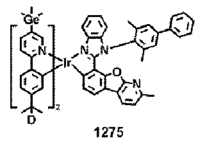
1275

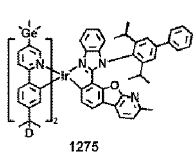
1275

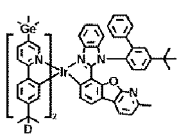
1277

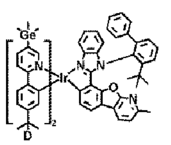
1278

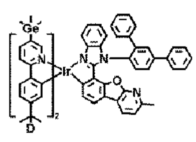
1279

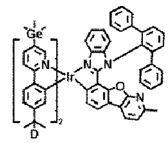
1280

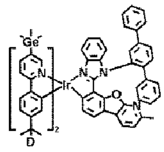
1281

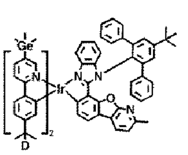
1282

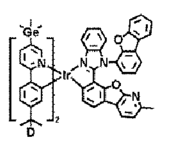
1283

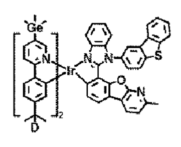
1284

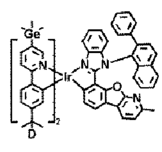
1285

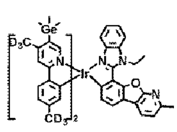
1286

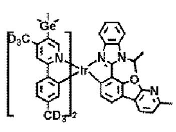
1287

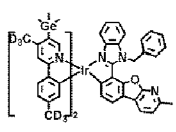
1288

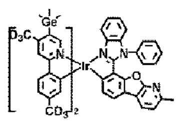
1289

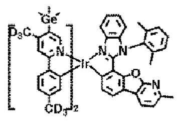
1290

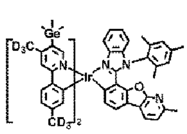
1291

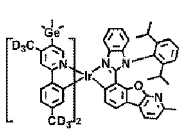
1292

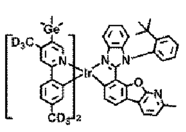
1293

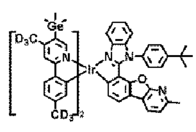
1294

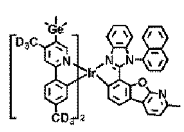
1295

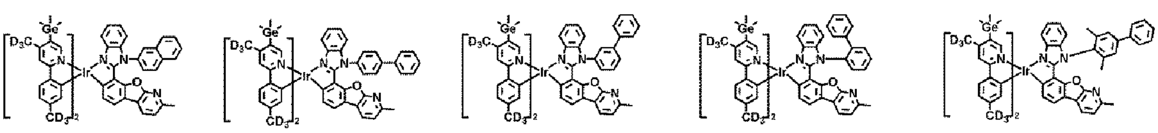
1296 1297 1298 1299 1300

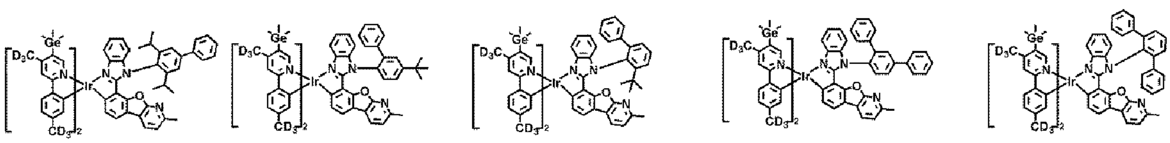
1301 1302 1303 1304 1305

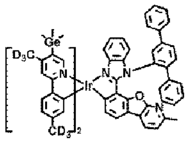
1306
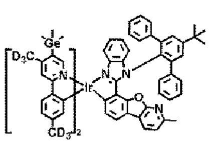
1307
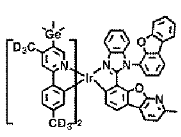
1308
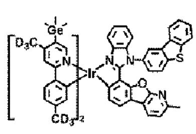
1309
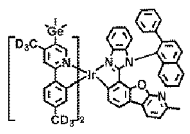
1310

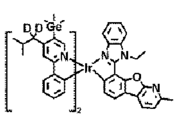
1311
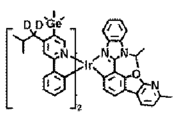
1312
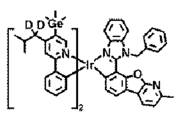
1313
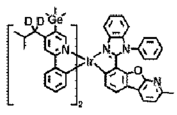
1314
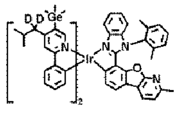
1315

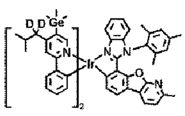
1316
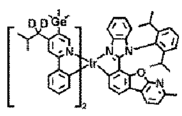
1317
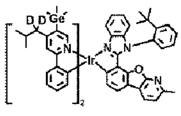
1318
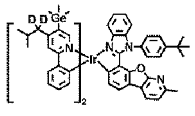
1319
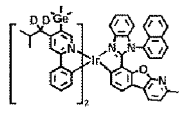
1320

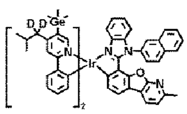
1321
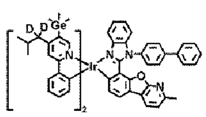
1322
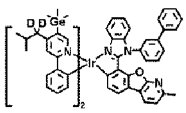
1323
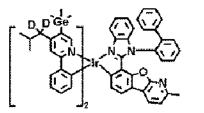
1324
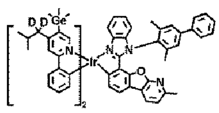
1325

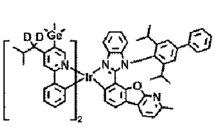
1326
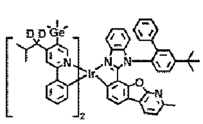
1327
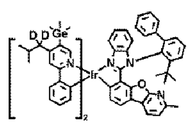
1328
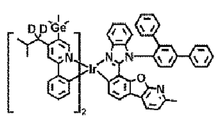
1329
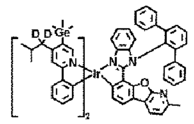
1330

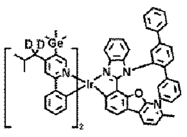
1331
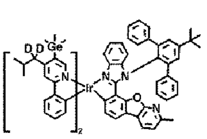
1332
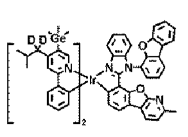
1333
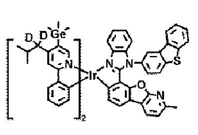
1334
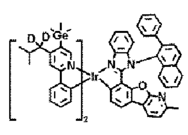
1335

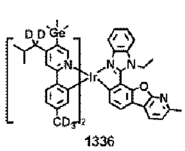
1336
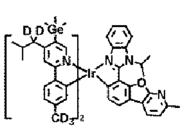
1337
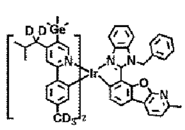
1338
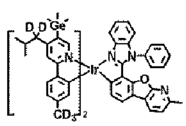
1339
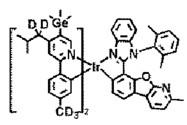
1340

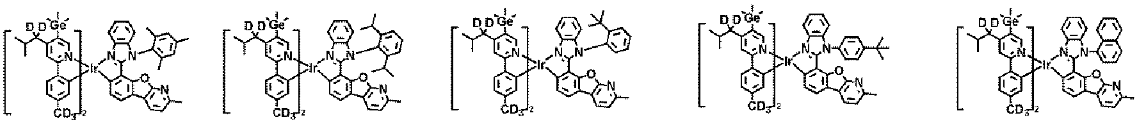
1341
1342
1343
1344
1345

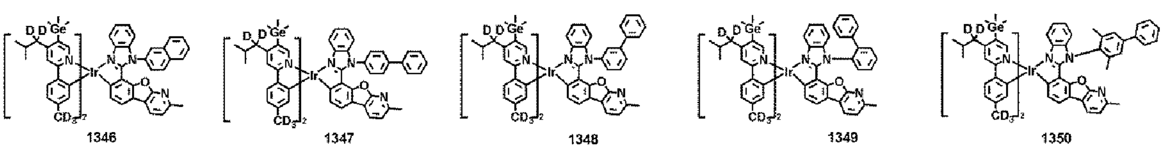
1346
1347
1348
1349
1350

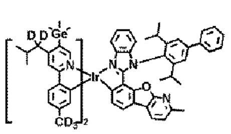
1351
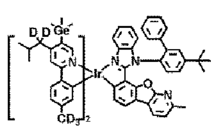
1352
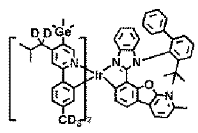
1353
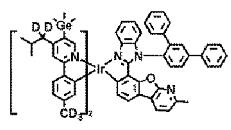
1354
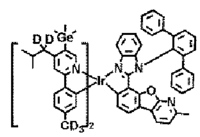
1355

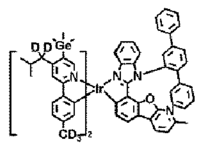
1356
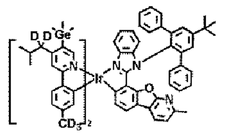
1357
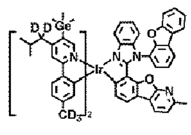
1358
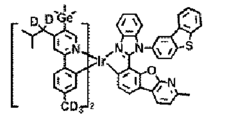
1359
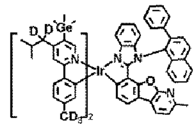
1360

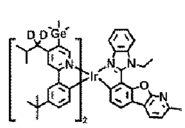
1361
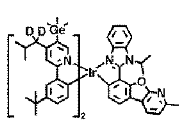
1362
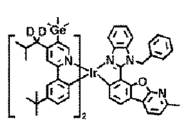
1363
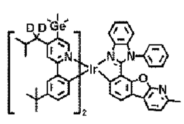
1364
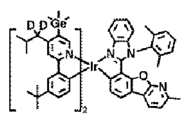
1365

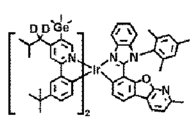
1366
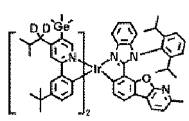
1367
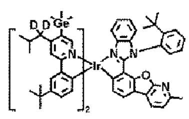
1368
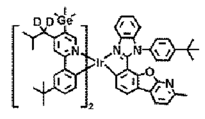
1369
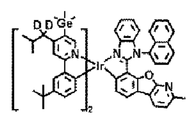
1370

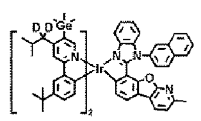
1371
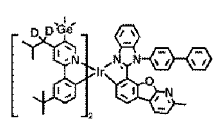
1372
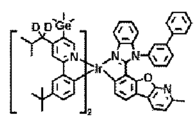
1373
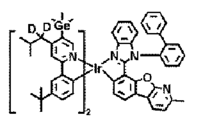
1374
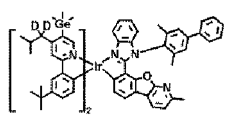
1375

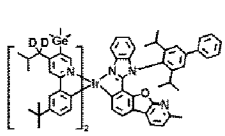
1376
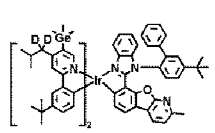
1377
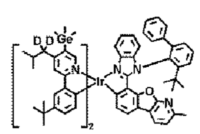
1378
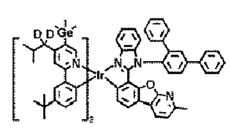
1379
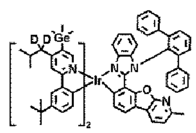
1380

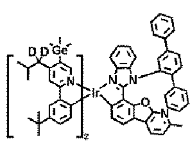
1381
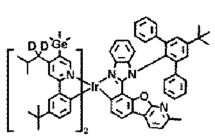
1382
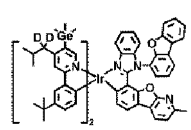
1383
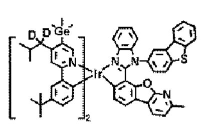
1384
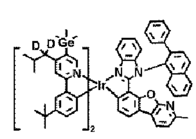
1385

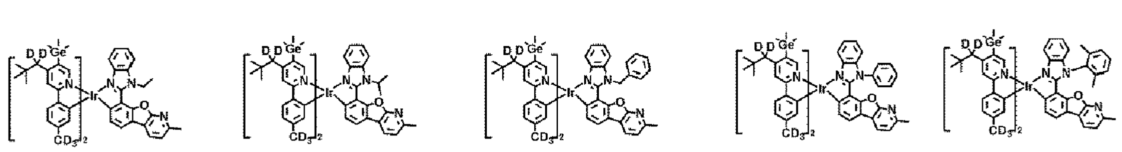
1386 1387 1388 1389 1390

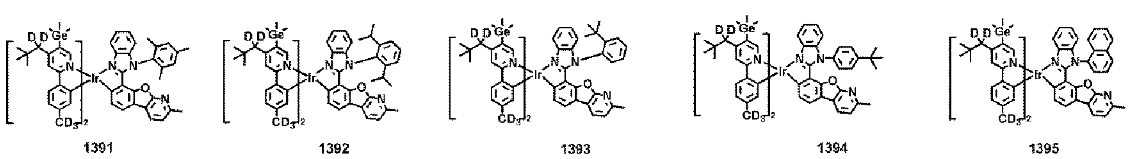
1391 1392 1393 1394 1395

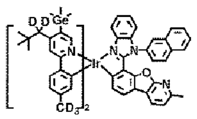
1396
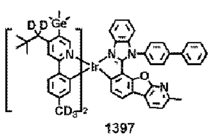
1397
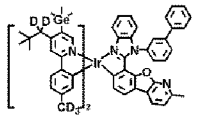
1398
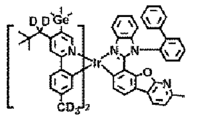
1399
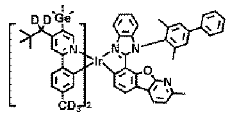
1400

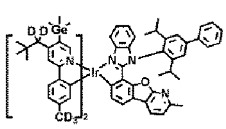
1401
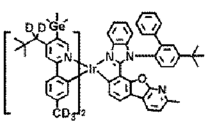
1402
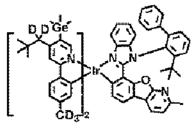
1403
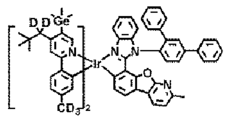
1404
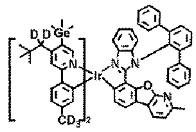
1405

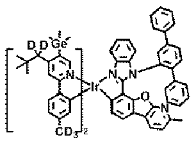
1406
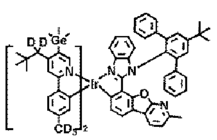
1407
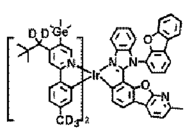
1408
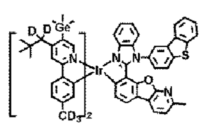
1409
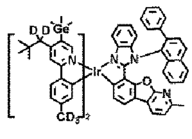
1410

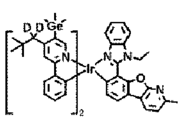
1411
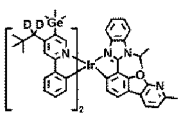
1412
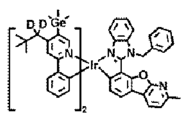
1413
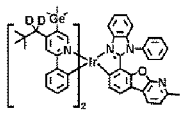
1414
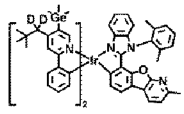
1415

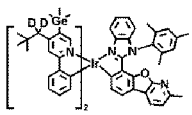
1416
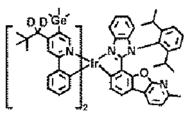
1417
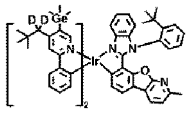
1418
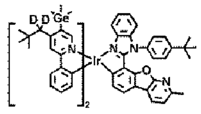
1419
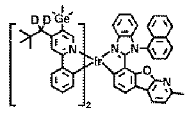
1420

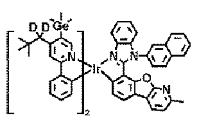
1421
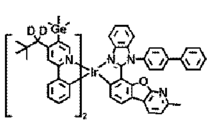
1422
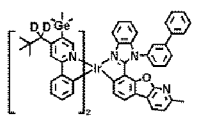
1423
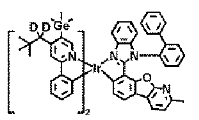
1424
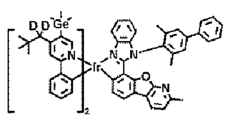
1425

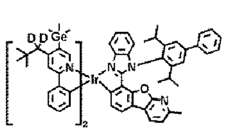
1426
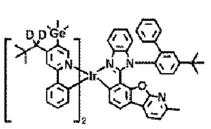
1427
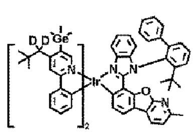
1428
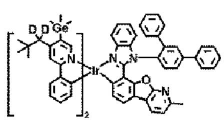
1429
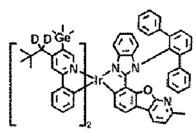
1430

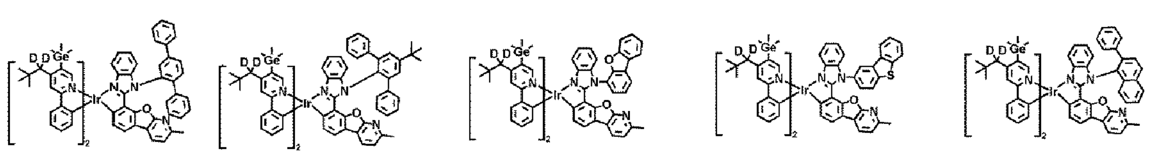
1431 1432 1433 1434 1435

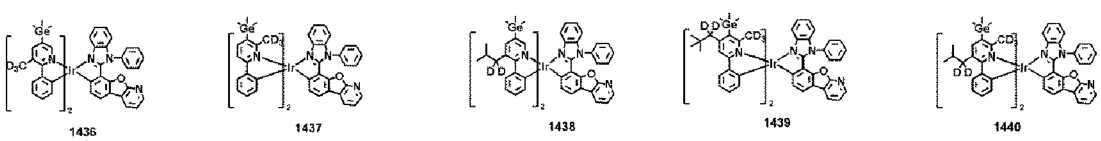
1436 1437 1438 1439 1440

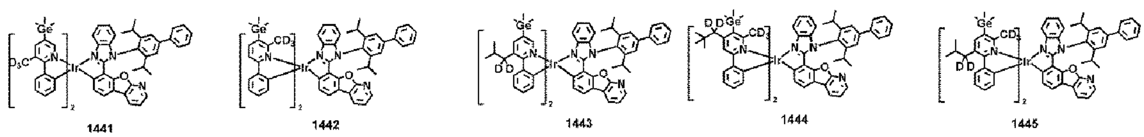
1441 1442 1443 1444 1445

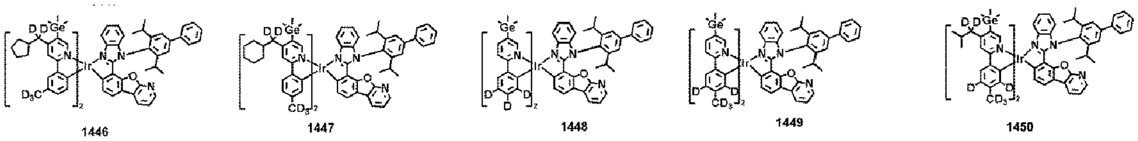
1446 1447 1448 1449 1450

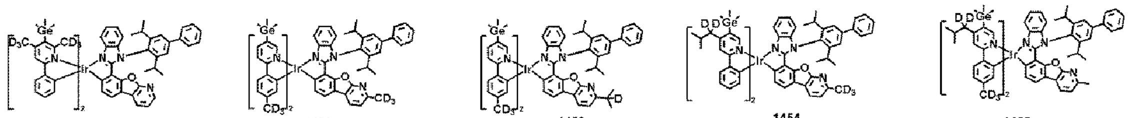
1451 1452 1453 1454 1455

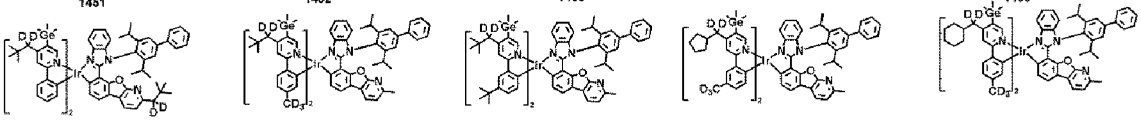
1456 1457 1458 1459 1460

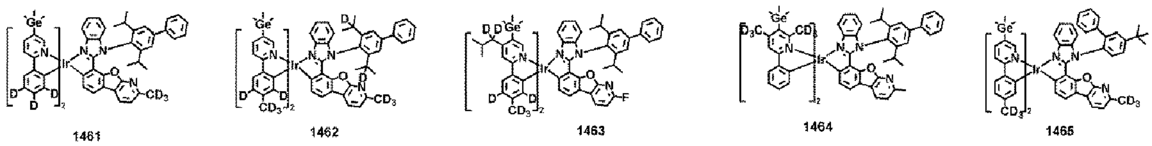
1461 1462 1463 1464 1465

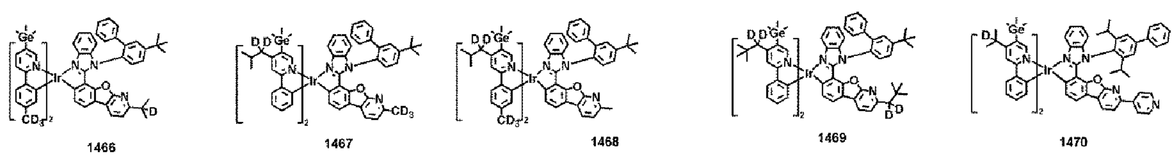
1466 1467 1468 1469 1470

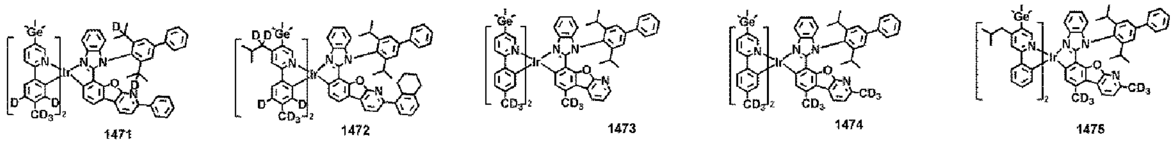
1471 1472 1473 1474 1475

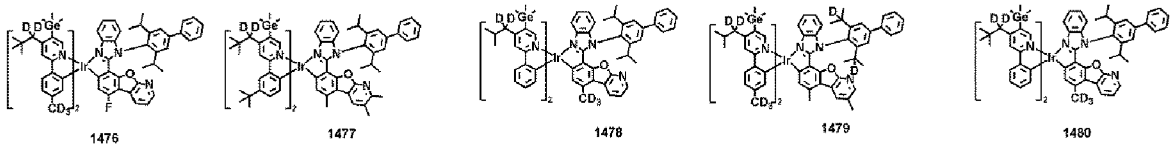
1476 1477 1478 1479 1480

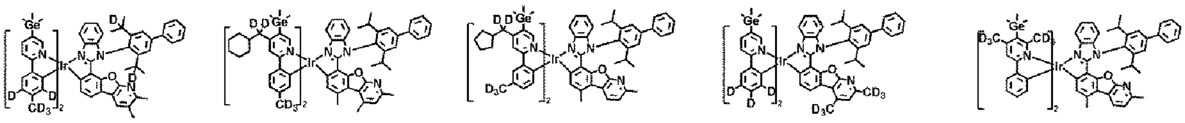
1481 1482 1483 1484 1485

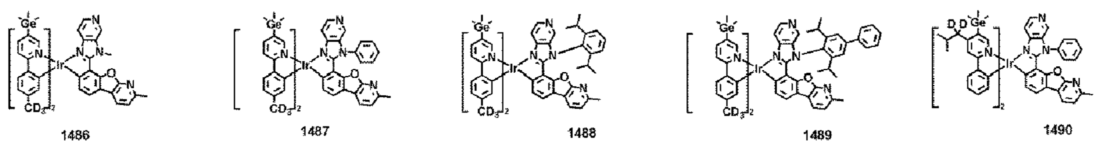
1486 1487 1488 1489 1490

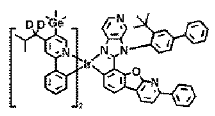
1491
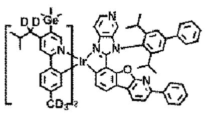
1492
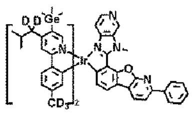
1493
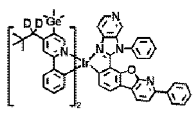
1494
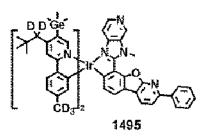
1495

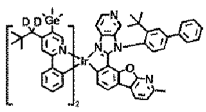
1496
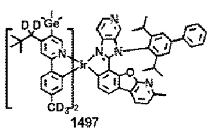
1497
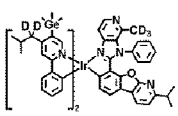
1498
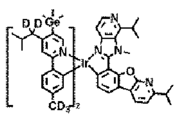
1499
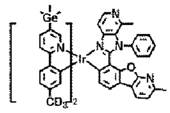
1500

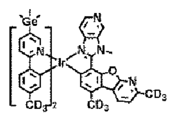
1501
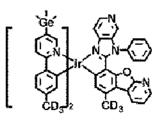
1502
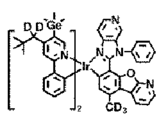
1503
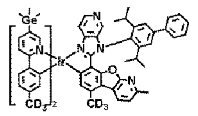
1504
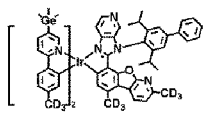
1505

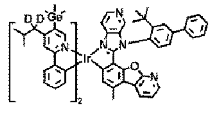
1506
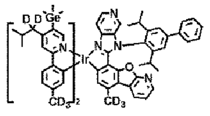
1507
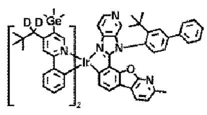
1508
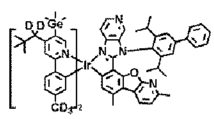
1509
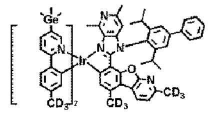
1510

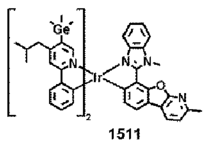
1511
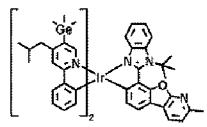
1512
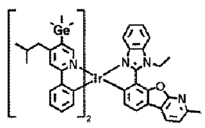
1513
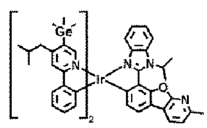
1514
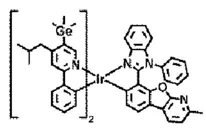
1515

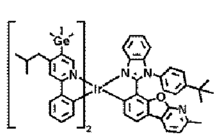
1516
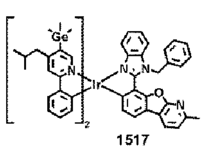
1517
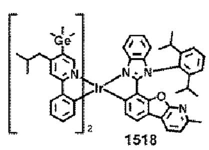
1518
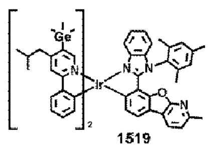
1519
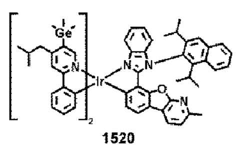
1520

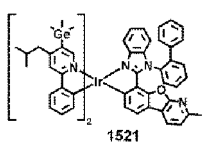
1521
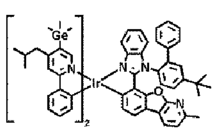
1522
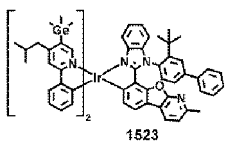
1523
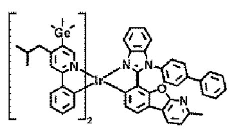
1524
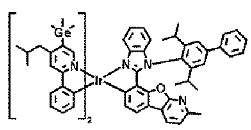
1525

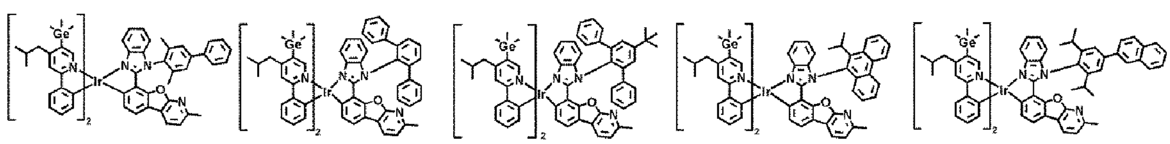
1526 1527 1528 1529 1530

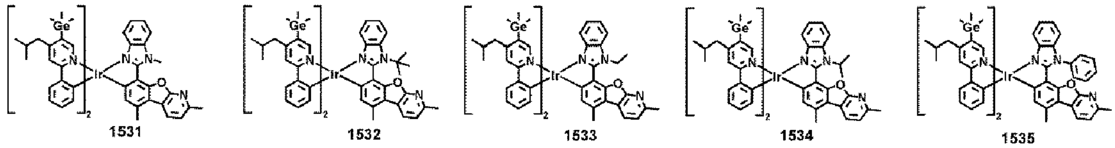
1531 1532 1533 1534 1535

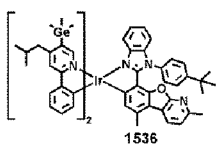
1536
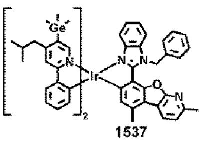
1537
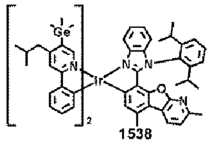
1538
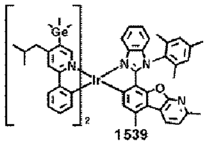
1539
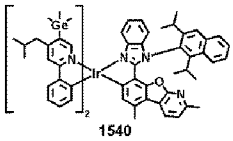
1540
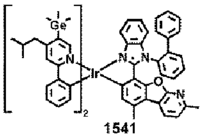
1541
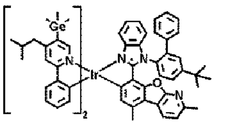
1542
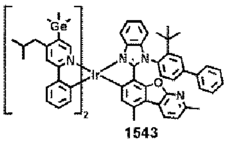
1543
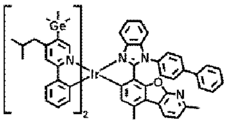
1544
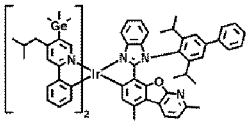
1545
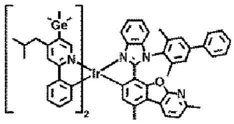
1546
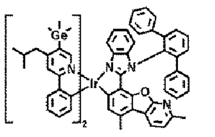
1547
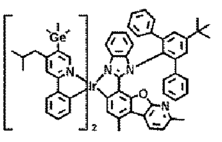
1548
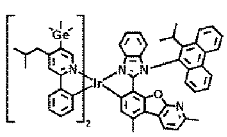
1549
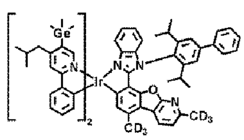
1550
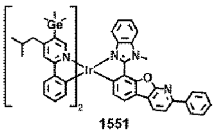
1551
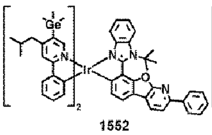
1552
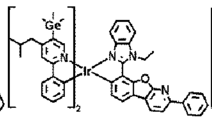
1553
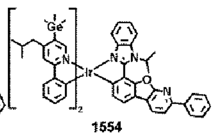
1554
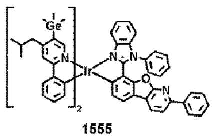
1555
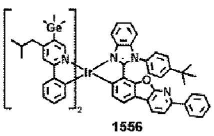
1556
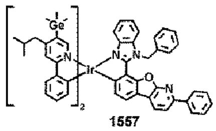
1557
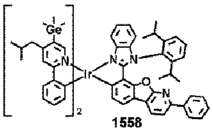
1558
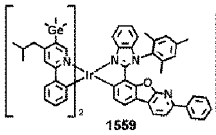
1559
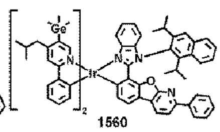
1560
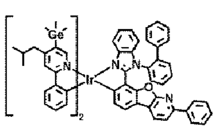
1561
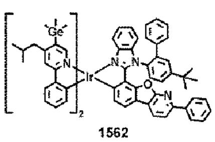
1562
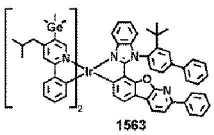
1563
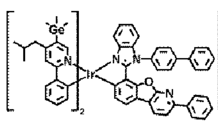
1564
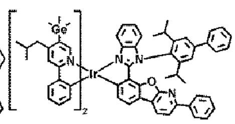
1565
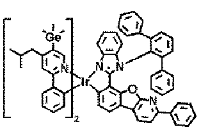
1566
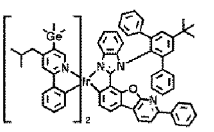
1567
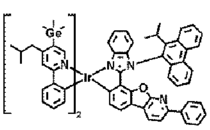
1568
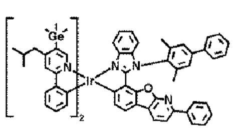
1569
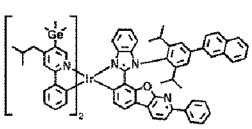
1570
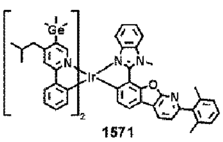
1571
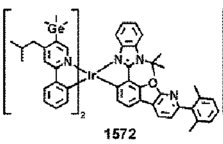
1572
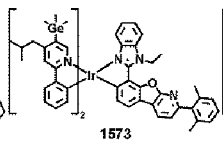
1573
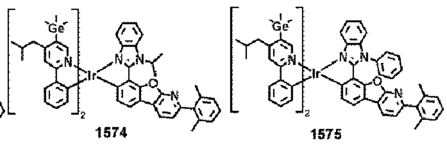
1574
1575
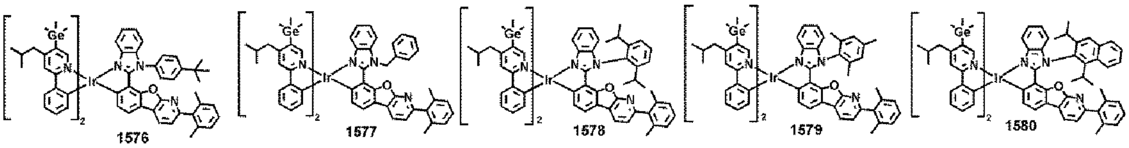
1576
1577
1578
1579
1580

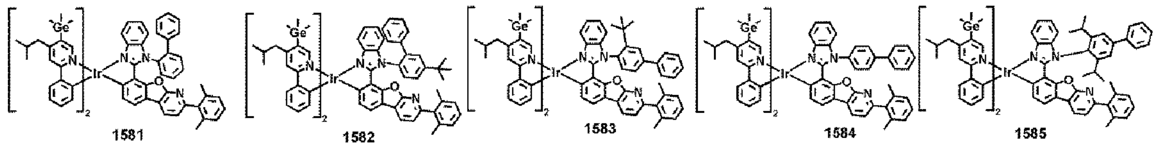

1581 1582 1583 1584 1585

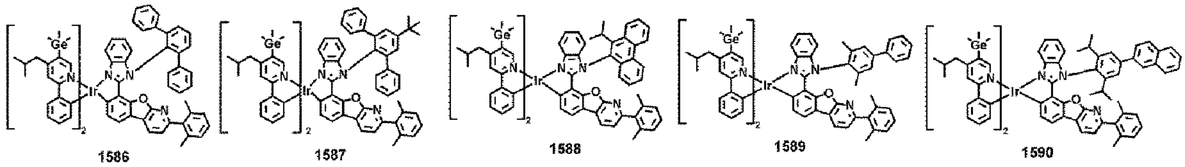

1586 1587 1588 1589 1590

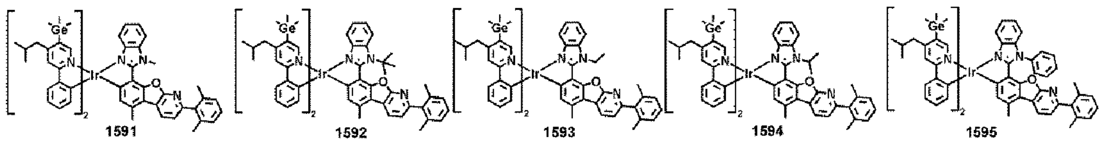

1591 1592 1593 1594 1595

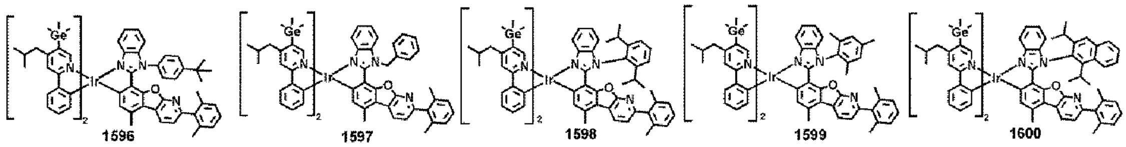

1596 1597 1598 1599 1600

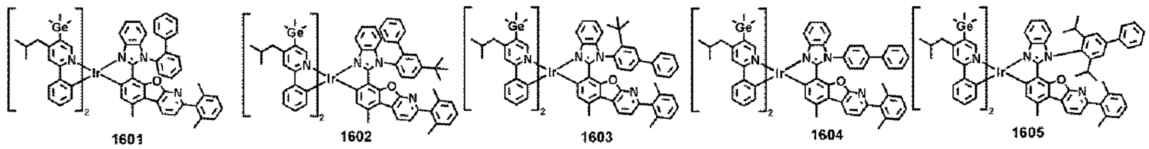

1601 1602 1603 1604 1605

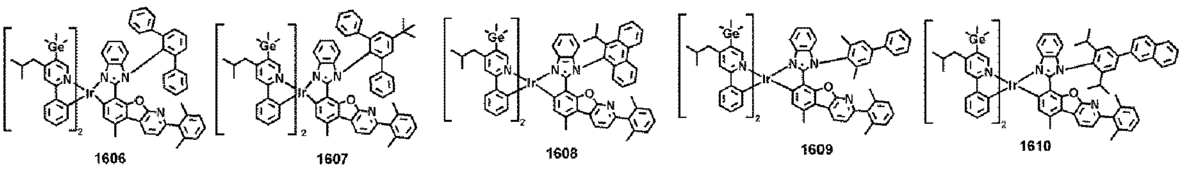

1606 1607 1608 1609 1610

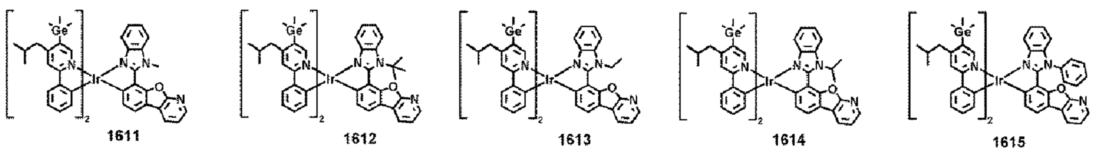

1611 1612 1613 1614 1615

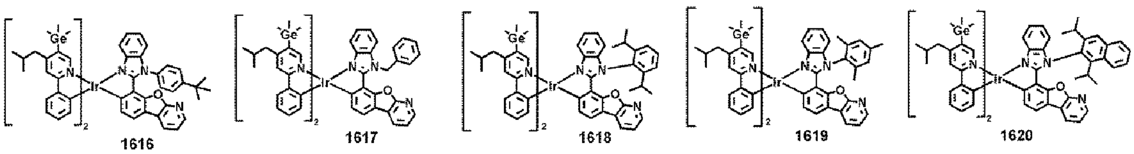

1616 1617 1618 1619 1620

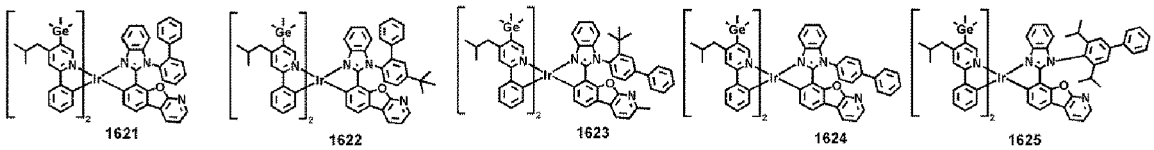

1621 1622 1623 1624 1625

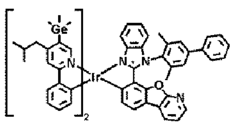
1626
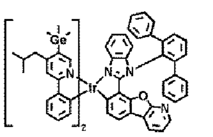
1627
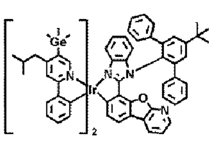
1628
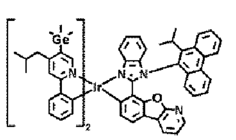
1629
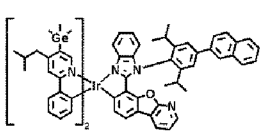
1630

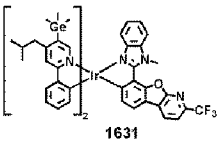
1631
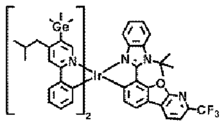
1632
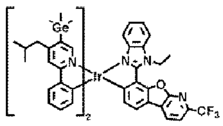
1633
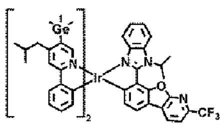
1634
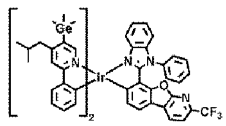
1635

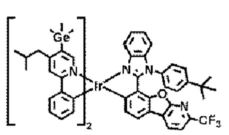
1636
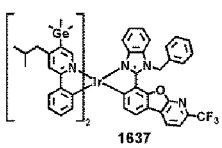
1637
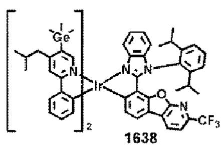
1638
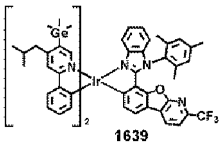
1639
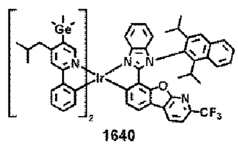
1640

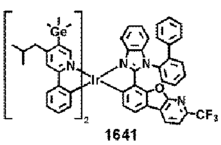
1641
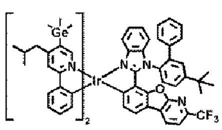
1642
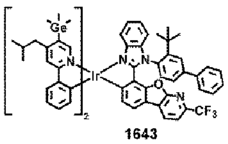
1643
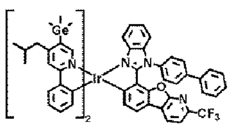
1644
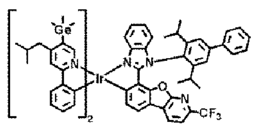
1645

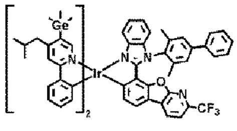
1646
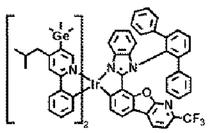
1647
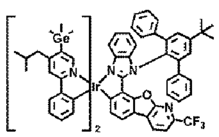
1648
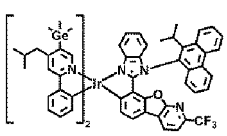
1649
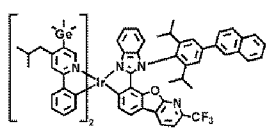
1650

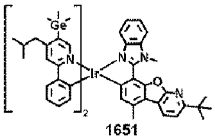
1651
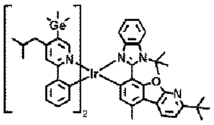
1652
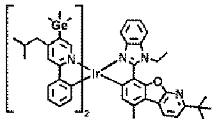
1653
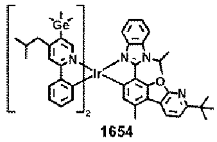
1654
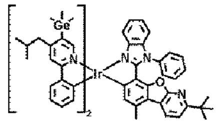
1655

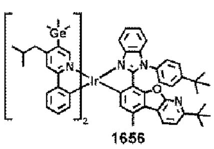
1656
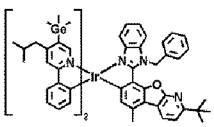
1657
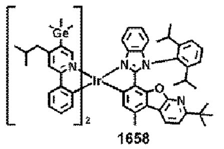
1658
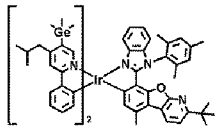
1659
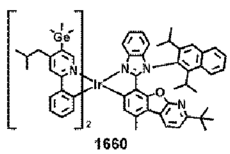
1660

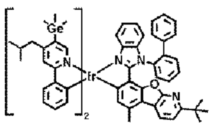
1661
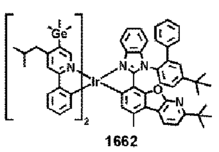
1662
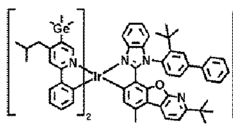
1663
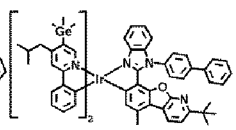
1664
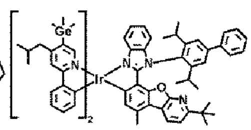
1665

1666
1667
1668
1669
1670

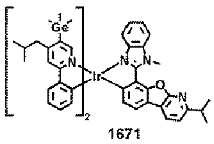
1671
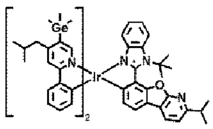
1672
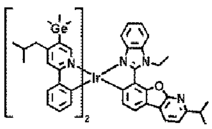
1673
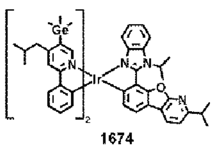
1674
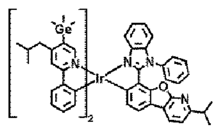
1675

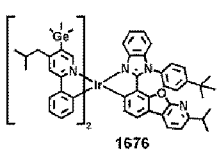
1676
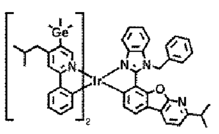
1677
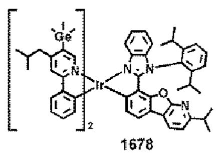
1678
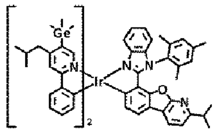
1679
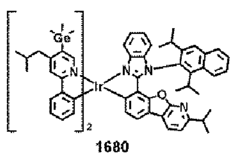
1680

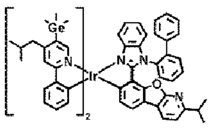
1681
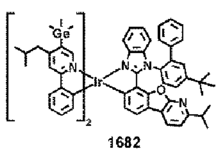
1682
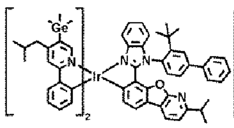
1683
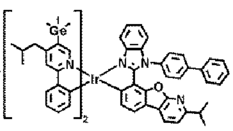
1684
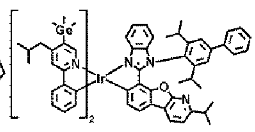
1685

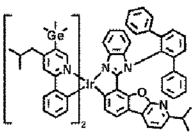
1686
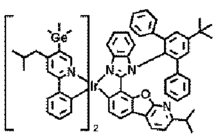
1687
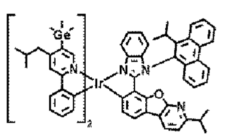
1688
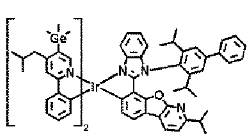
1689
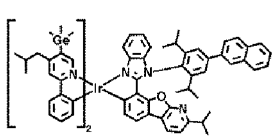
1690

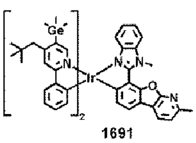
1691
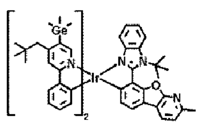
1692
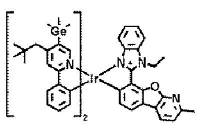
1693
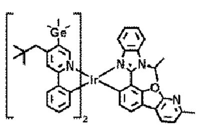
1694
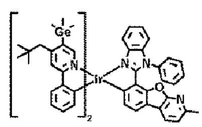
1695

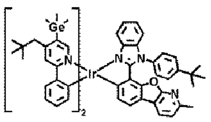
1696
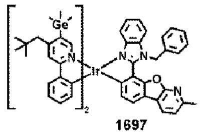
1697
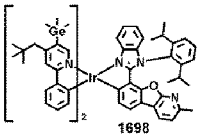
1698
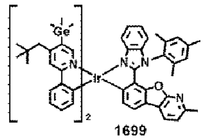
1699
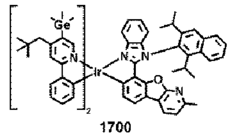
1700

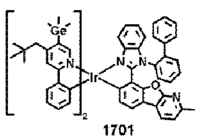
1701
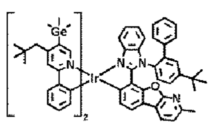
1702
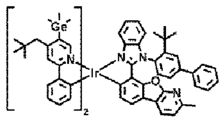
1703
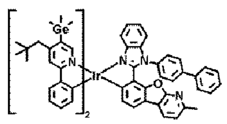
1704
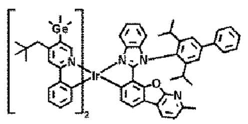
1705

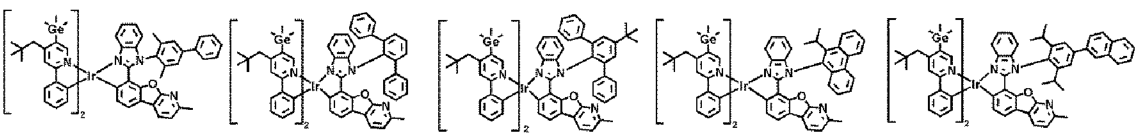
1706
1707
1708
1709
1710

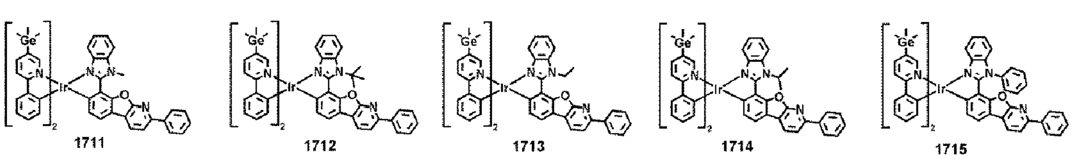
1711
1712
1713
1714
1715

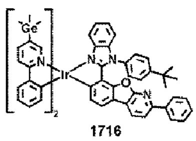
1716
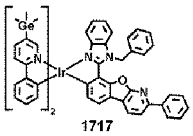
1717
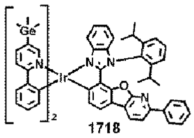
1718
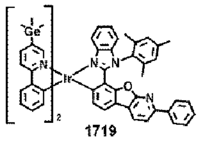
1719
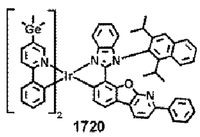
1720

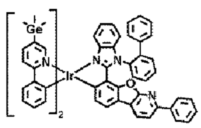
1721
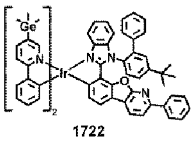
1722
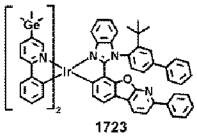
1723
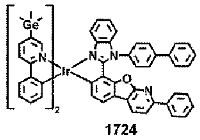
1724
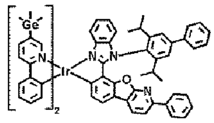
1725

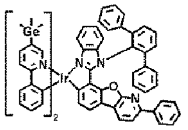
1726
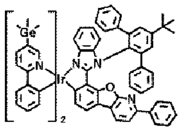
1727
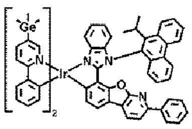
1728
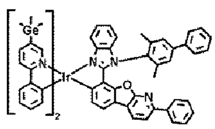
1729
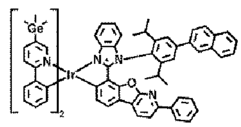
1730

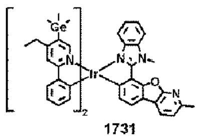
1731
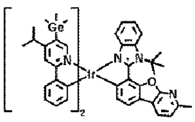
1732
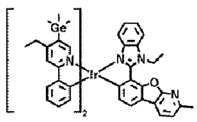
1733
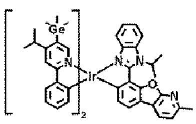
1734
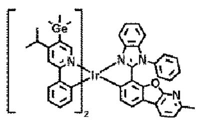
1735

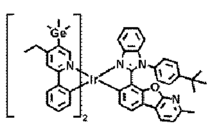
1736
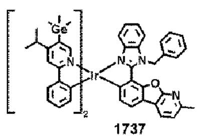
1737
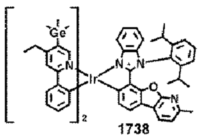
1738
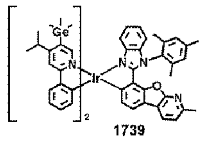
1739
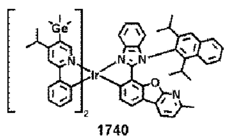
1740

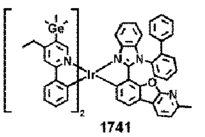
1741
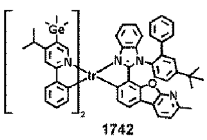
1742
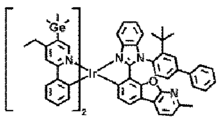
1743
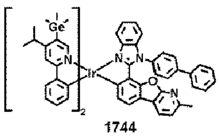
1744
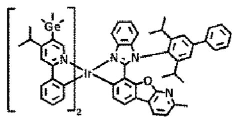
1745

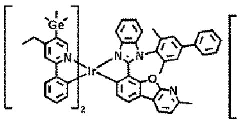
1746
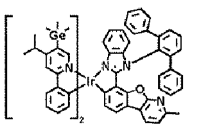
1747
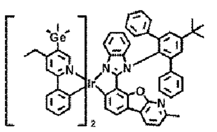
1748
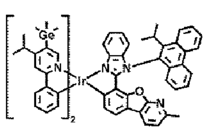
1749
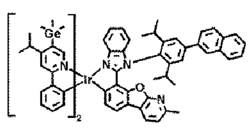
1750

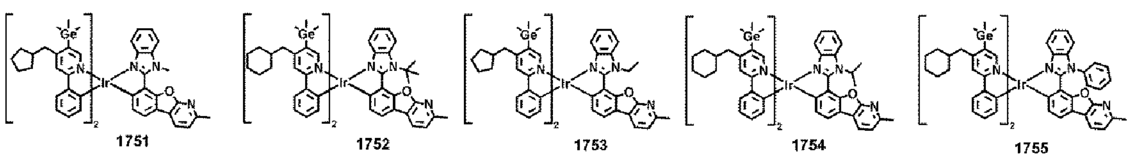
1751
1752
1753
1754
1755

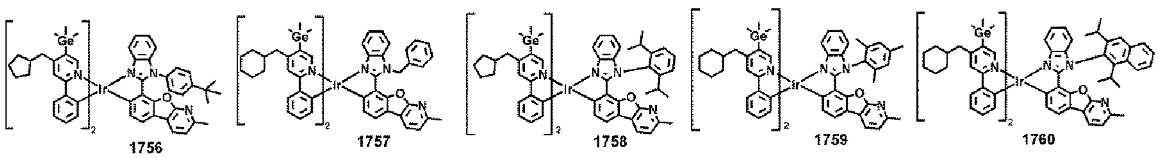
1756
1757
1758
1759
1760

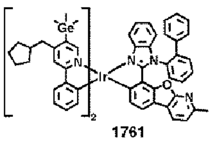
1761
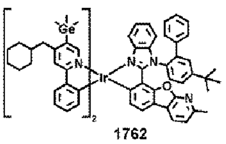
1762
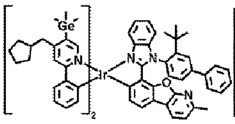
1763
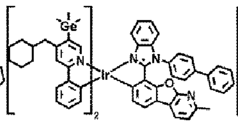
1764
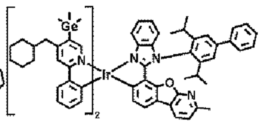
1765

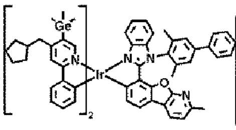
1766
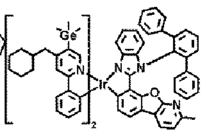
1767
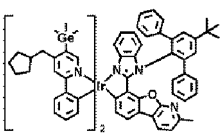
1768
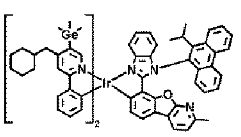
1769
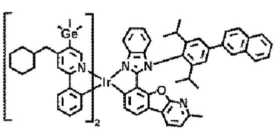
1770

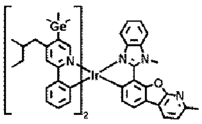
1771
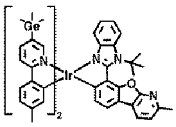
1772
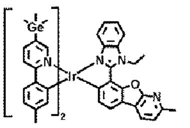
1773
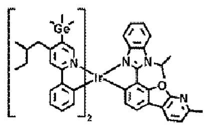
1774
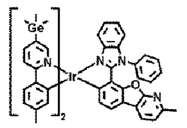
1775

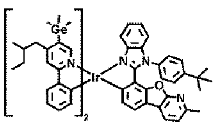
1776
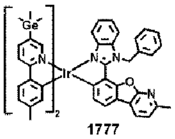
1777
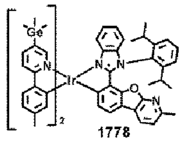
1778
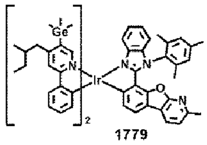
1779
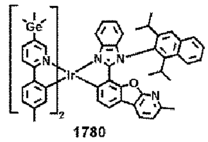
1780

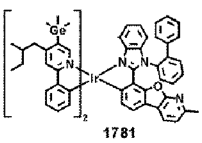
1781
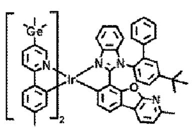
1782
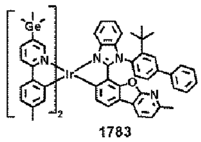
1783
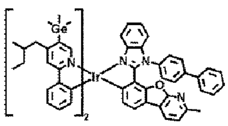
1784
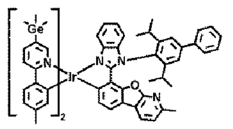
1785

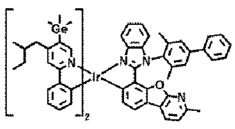
1786
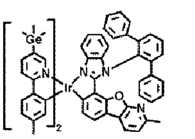
1787
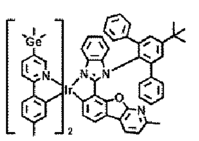
1788
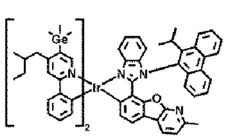
1789
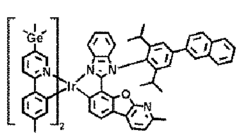
1790

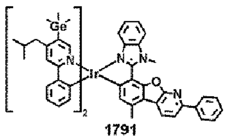
1791
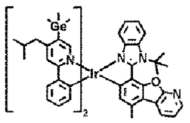
1792
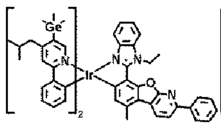
1793
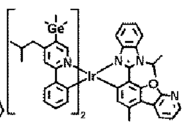
1794
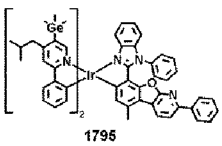
1795

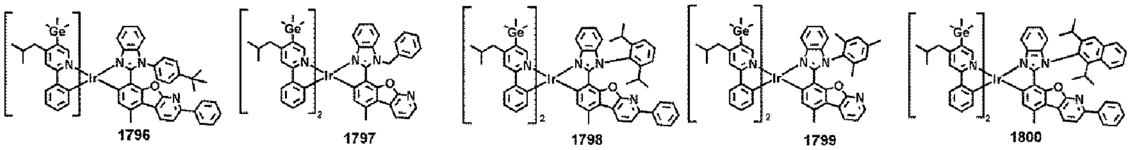
1796
1797
1798
1799
1800

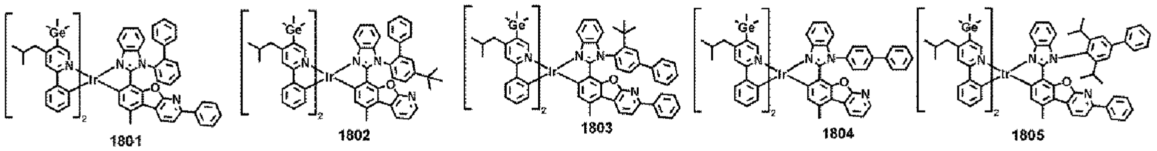
1801
1802
1803
1804
1805

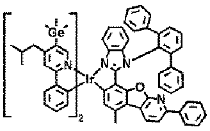
1806

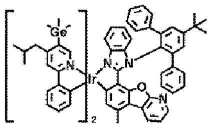
1807

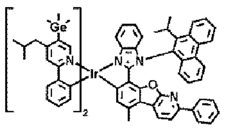
1808

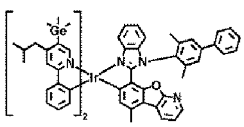
1809

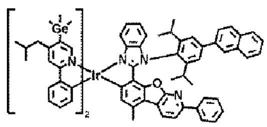
1810

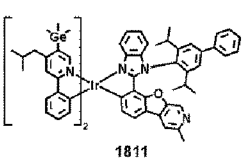
1811

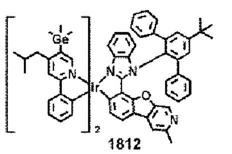
1812

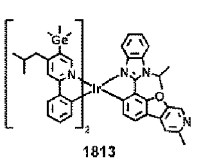
1813

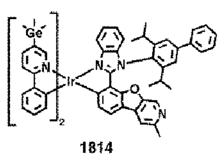
1814

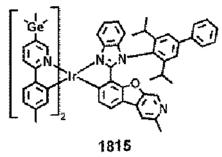
1815

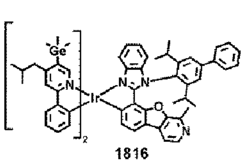
1816

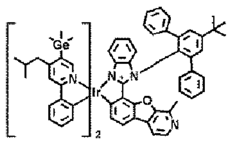
1817

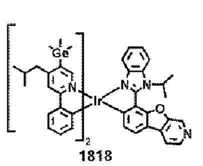
1818

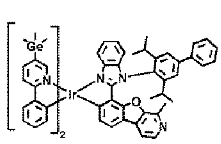
1819

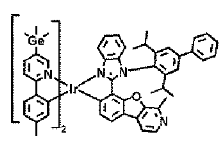
1820

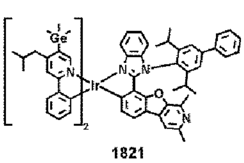
1821

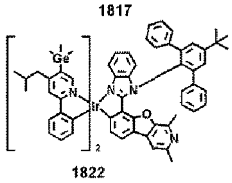
1822

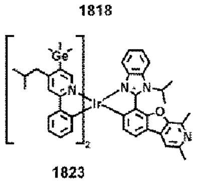
1823

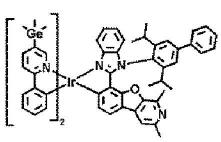
1824

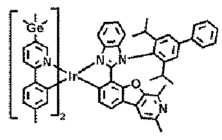
1825

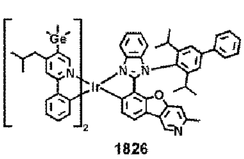
1826

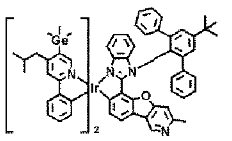
1827

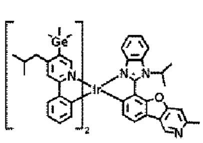
1828

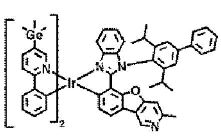
1829

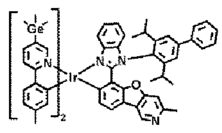
1830

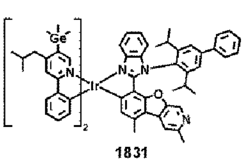
1831

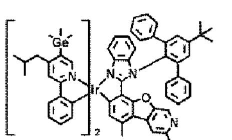
1832

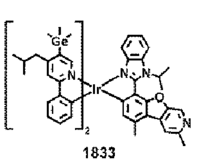
1833

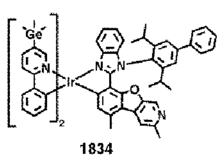
1834

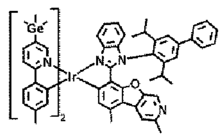
1835

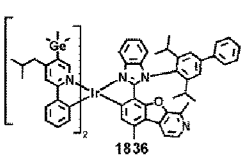
1836

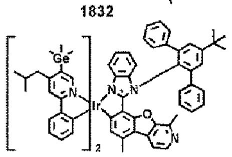
1837

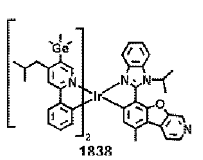
1838

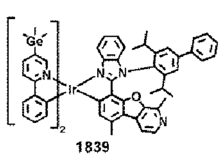
1839

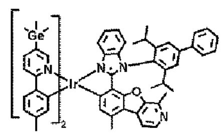
1840

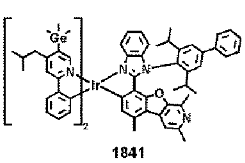
1841

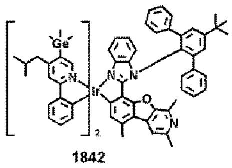
1842

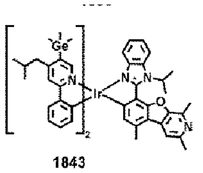
1843

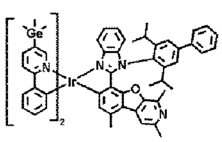
1844

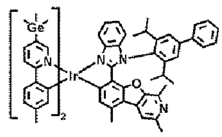
1845

1846

1847

1848

1849

1850

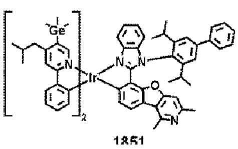
1851
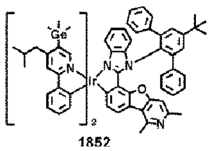
1852
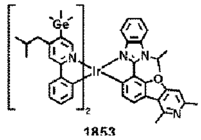
1853
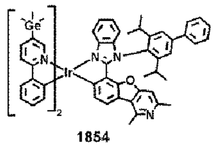
1854
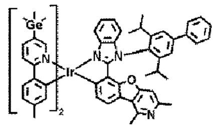
1855
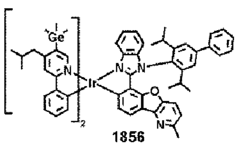
1856
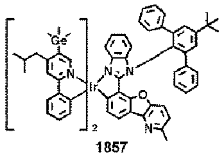
1857
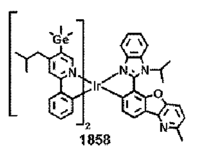
1858
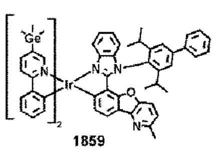
1859
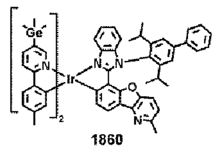
1860
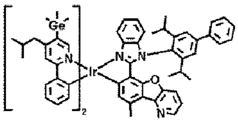
1861
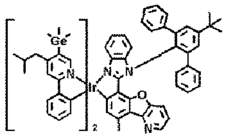
1862
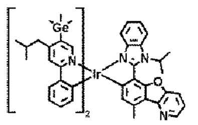
1863
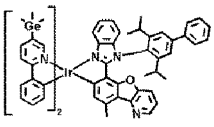
1864
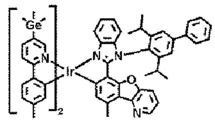
1865
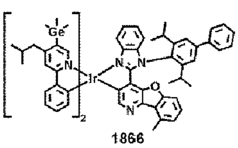
1866
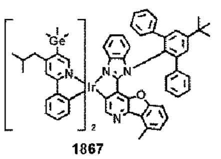
1867
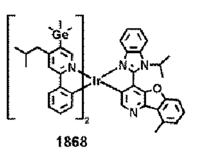
1868
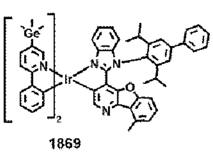
1869
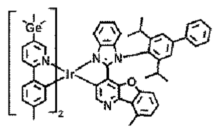
1870
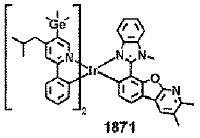
1871
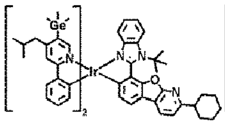
1872
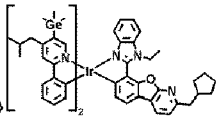
1873
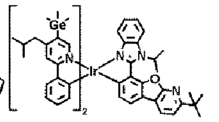
1874
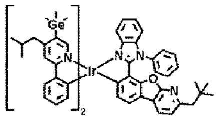
1875
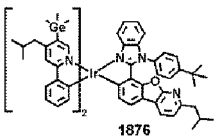
1876
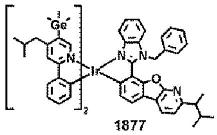
1877
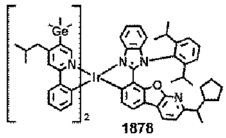
1878
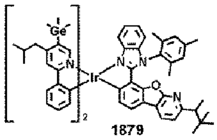
1879
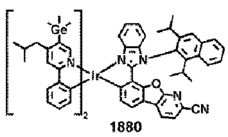
1880
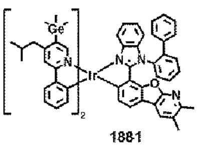
1881
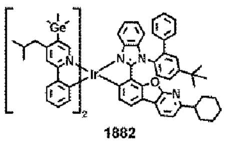
1882
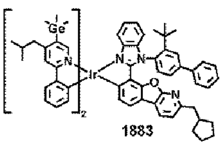
1883
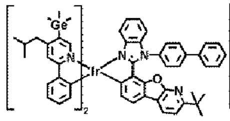
1884
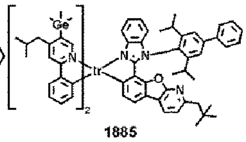
1885
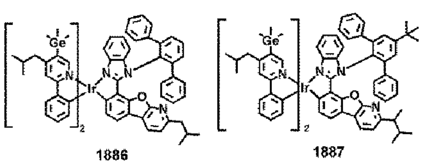
1886
1887
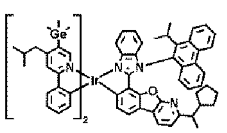
1888
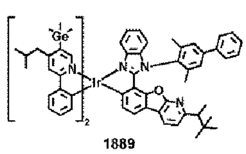
1889
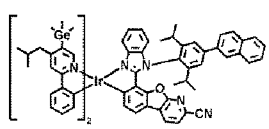
1890
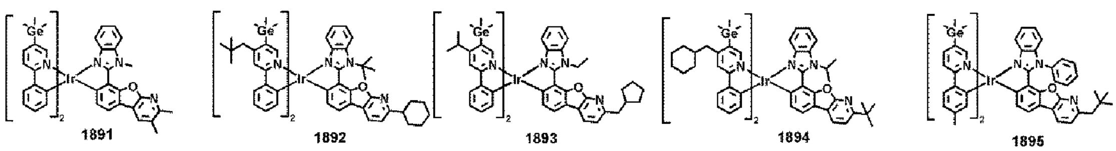
1891
1892
1893
1894
1895

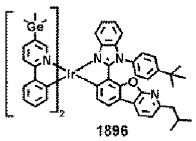
1896

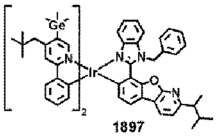
1897

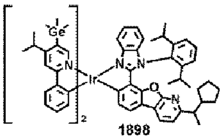
1898

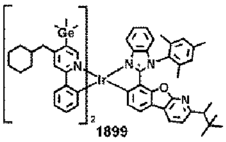
1899

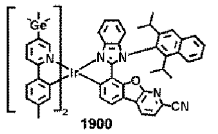
1900

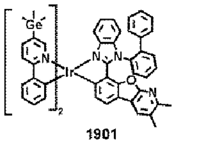
1901

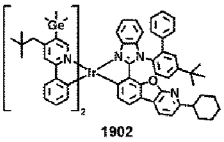
1902

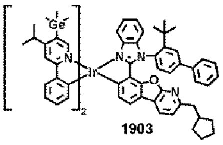
1903

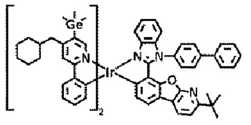
1904

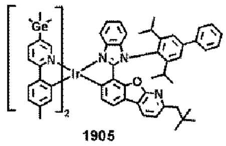
1905

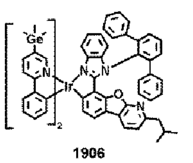
1906

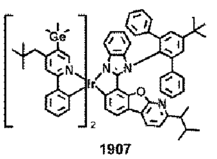
1907

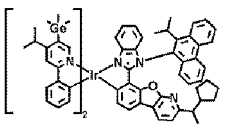
1908

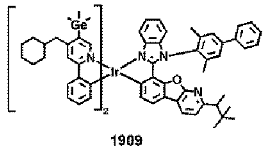
1909

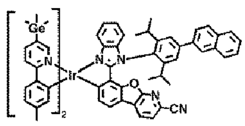
1910

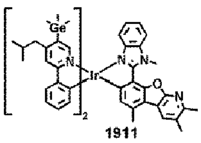
1911

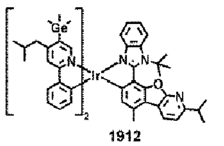
1912

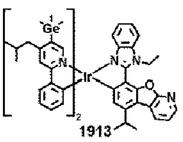
1913

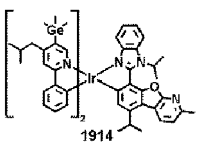
1914

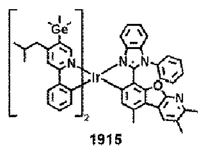
1915

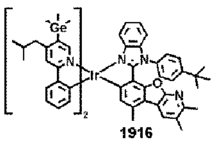
1916

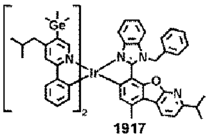
1917

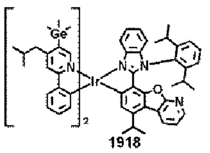
1918

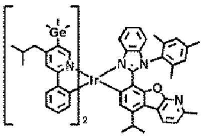
1919

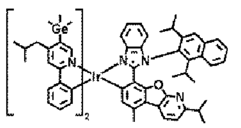
1920

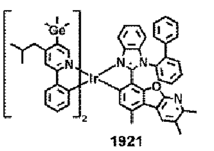
1921

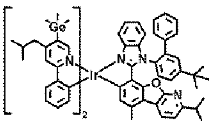
1922

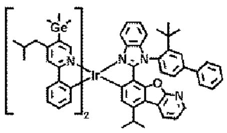
1923

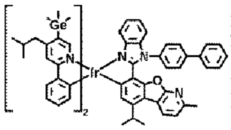
1924

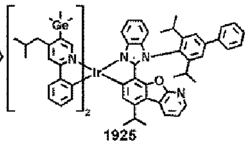
1925

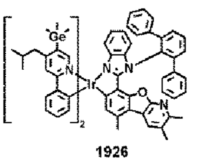
1926

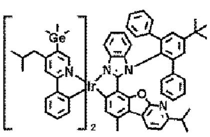
1927

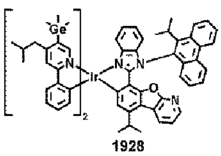
1928

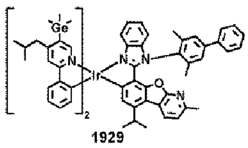
1929

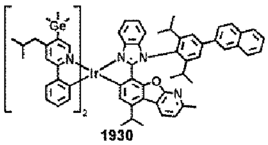
1930

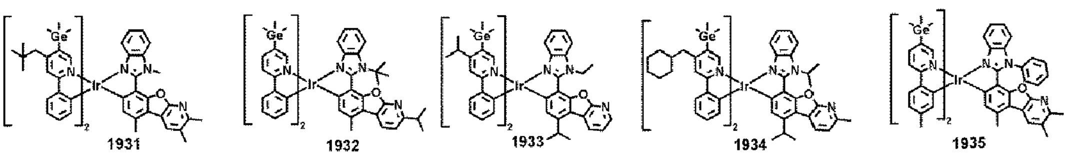
1931 1932 1933 1934 1935

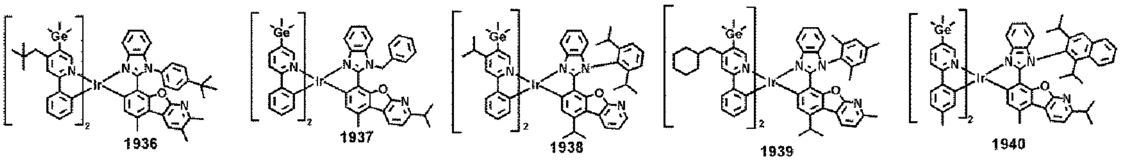
1936 1937 1938 1939 1940

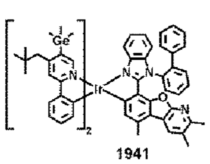
1941
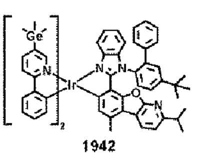
1942
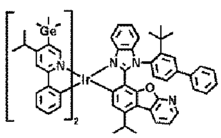
1943
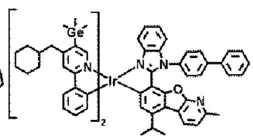
1944
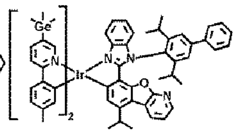
1945

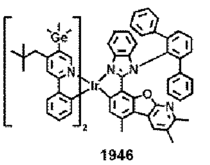
1946
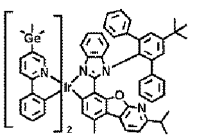
1947
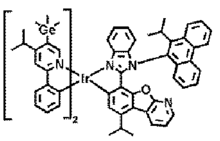
1948
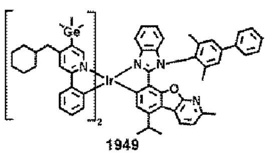
1949
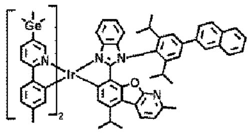
1950

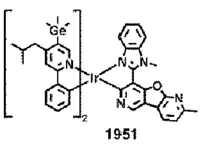
1951
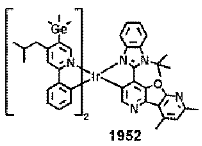
1952
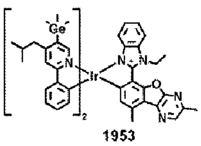
1953
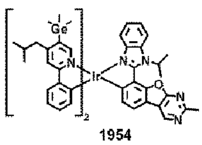
1954
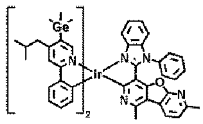
1955

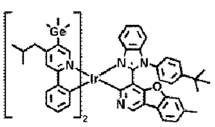
1956
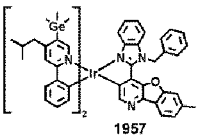
1957
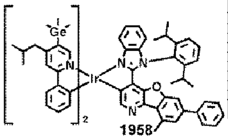
1958
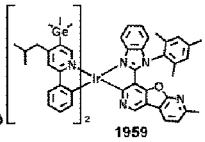
1959
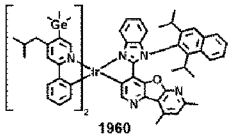
1960

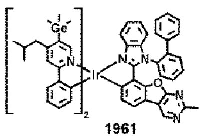
1961
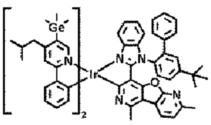
1962
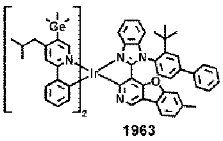
1963
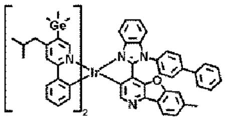
1964
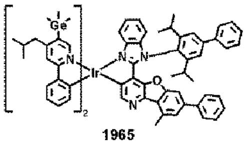
1965

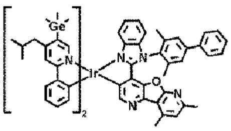
1966
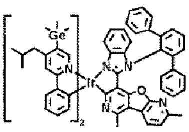
1967
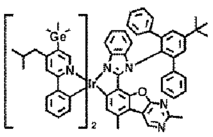
1968
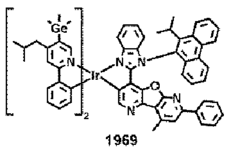
1969
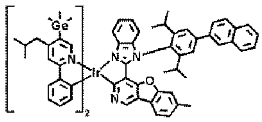
1970

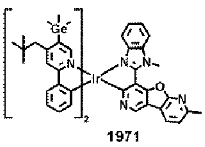
1971
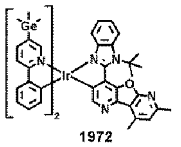
1972
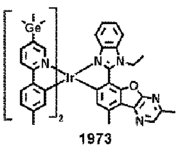
1973
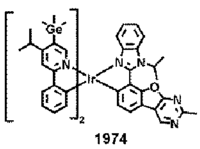
1974
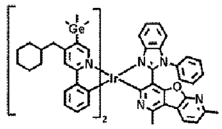
1975

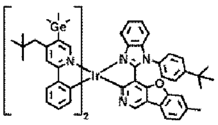
1976
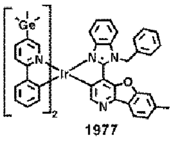
1977
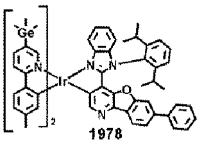
1978
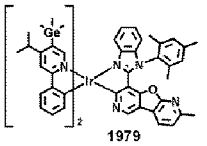
1979
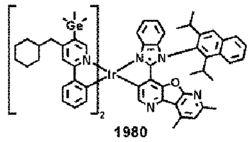
1980

1981
1982
1983
1984
1985

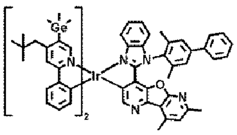
1986
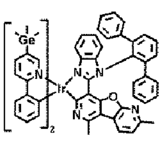
1987
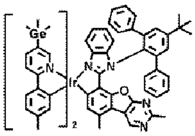
1988
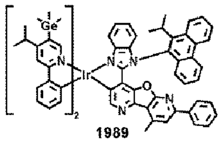
1989
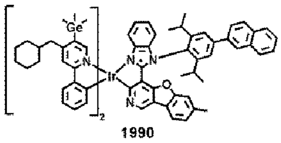
1990

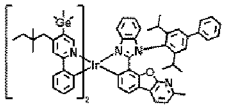
1991
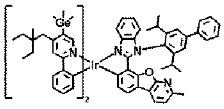
1992
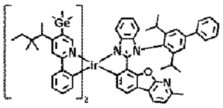
1993
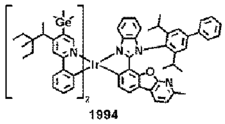
1994
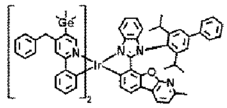
1995

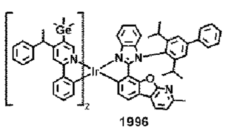
1996
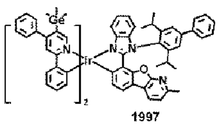
1997
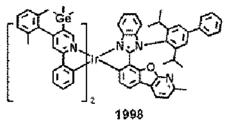
1998
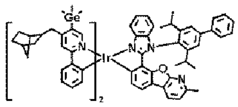
1999
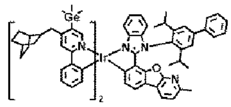
2000

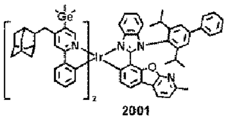
2001
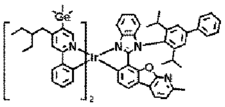
2002
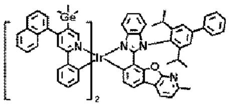
2003
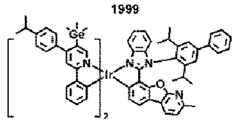
2004
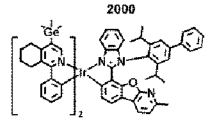
2005

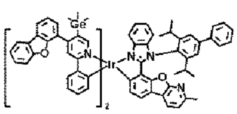
2006
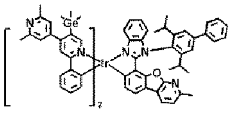
2007
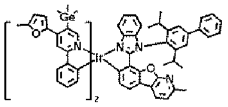
2008
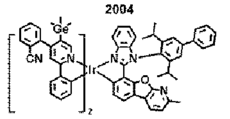
2009
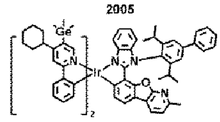
2010

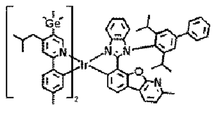
2011
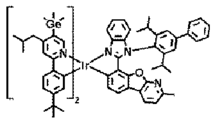
2012
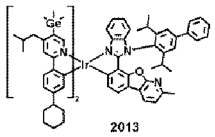
2013
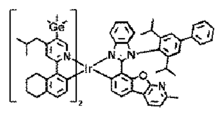
2014
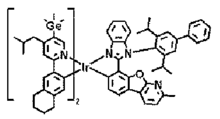
2015

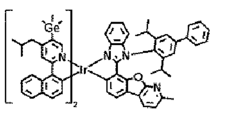
2016
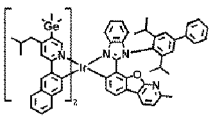
2017
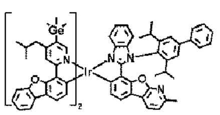
2018
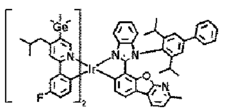
2019
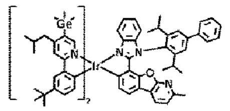
2020

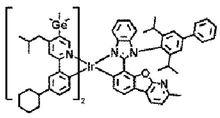
2021
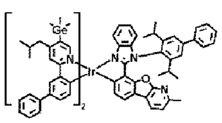
2022
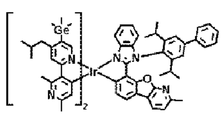
2023
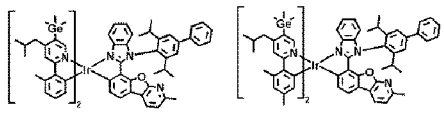
2024
2025

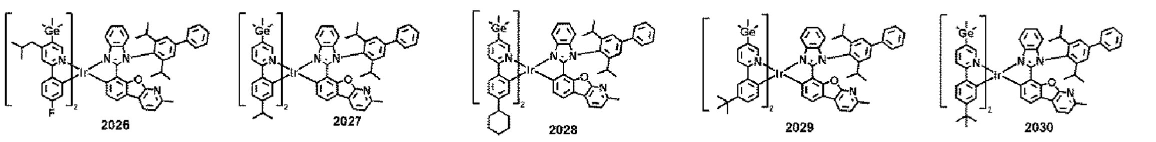
2026
2027
2028
2029
2030

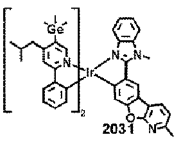
2031

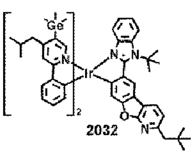
2032

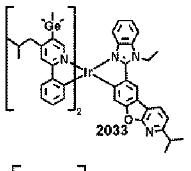
2033

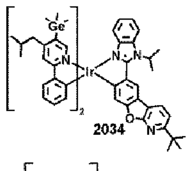
2034

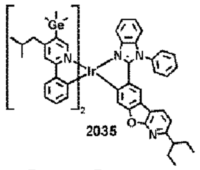
2035

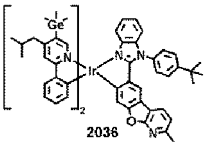
2036

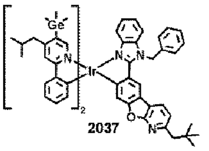
2037

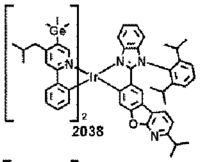
2038

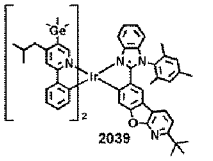
2039

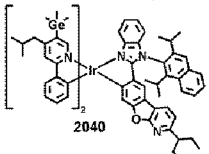
2040

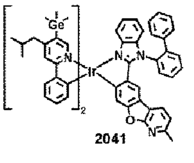
2041

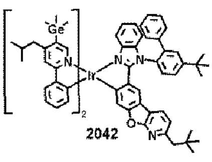
2042

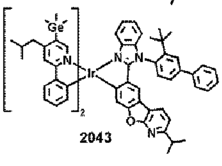
2043

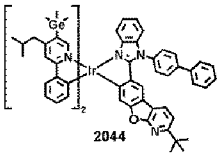
2044

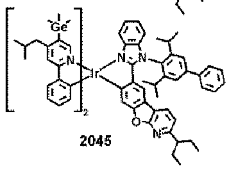
2045

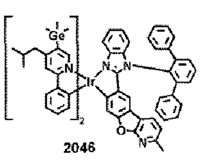
2046

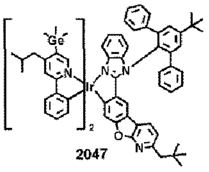
2047

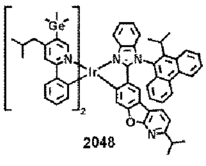
2048

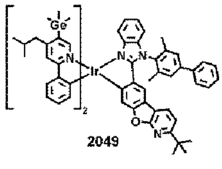
2049

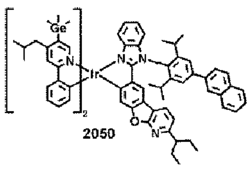
2050

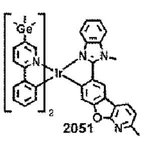
2051

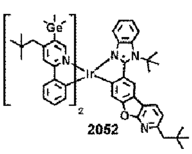
2052

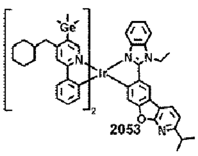
2053

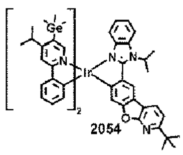
2054

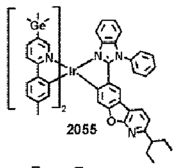
2055

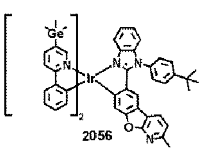
2056

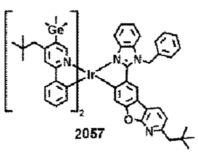
2057

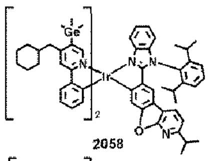
2058

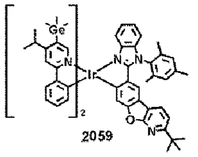
2059

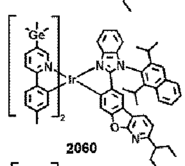
2060

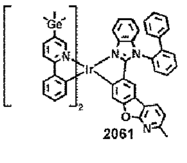
2061

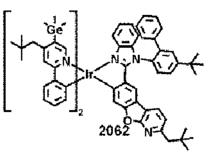
2062

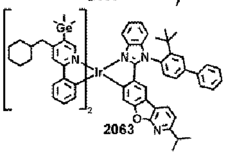
2063

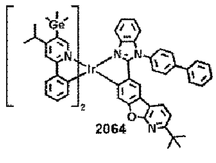
2064

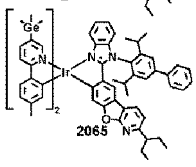
2065

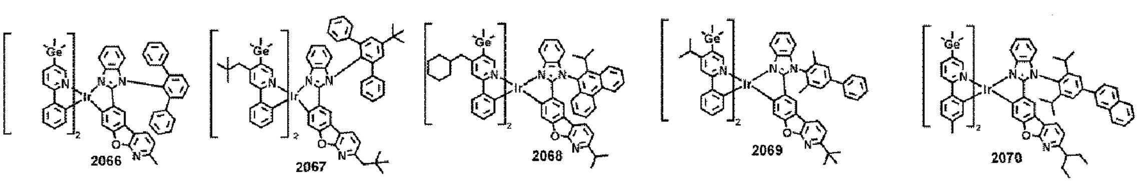
2066 2067 2068 2069 2070

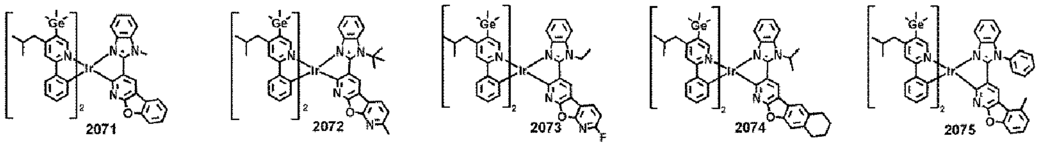
2071 2072 2073 2074 2075

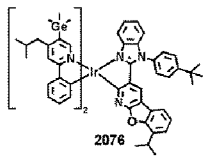
2076
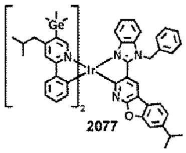
2077
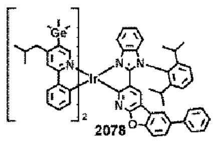
2078
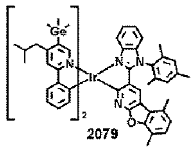
2079
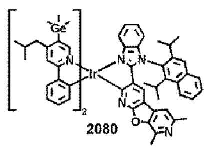
2080
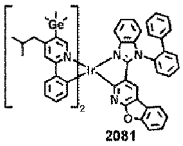
2081
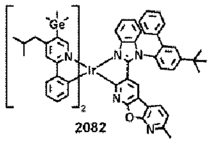
2082
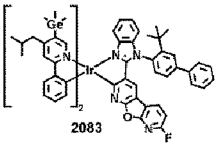
2083
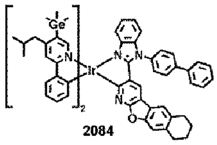
2084
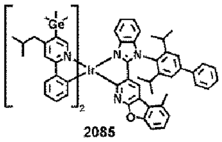
2085
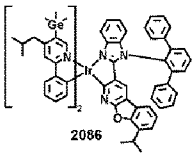
2086
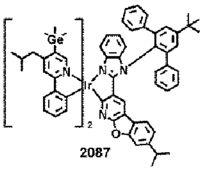
2087
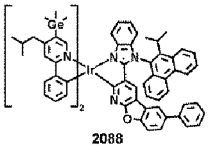
2088
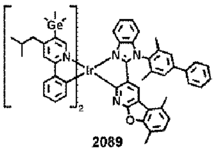
2089
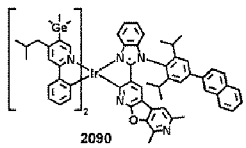
2090
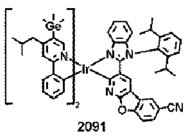
2091
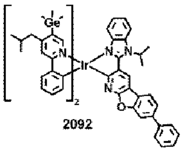
2092
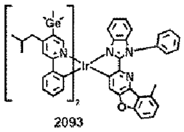
2093
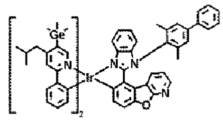
2094
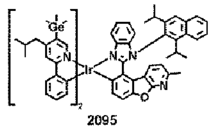
2095
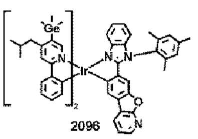
2096
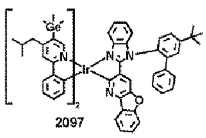
2097
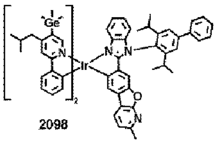
2098
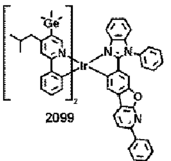
2099
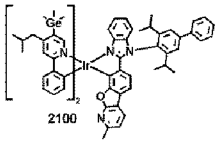
2100
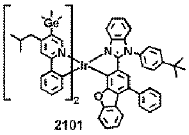
2101
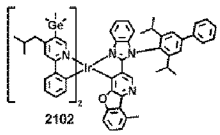
2102
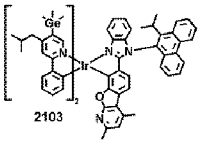
2103
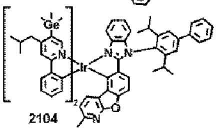
2104
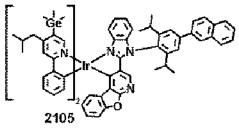
2105
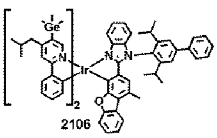
2106
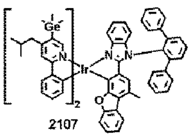
2107
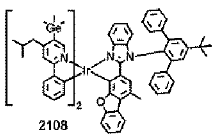
2108
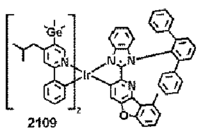
2109
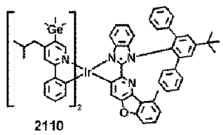
2110
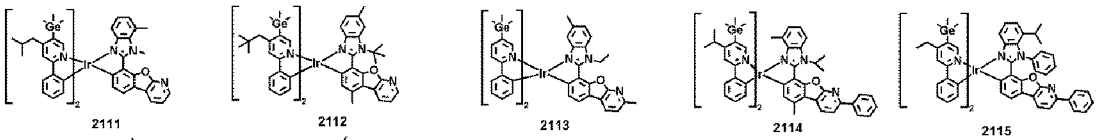
2111 2112 2113 2114 2115
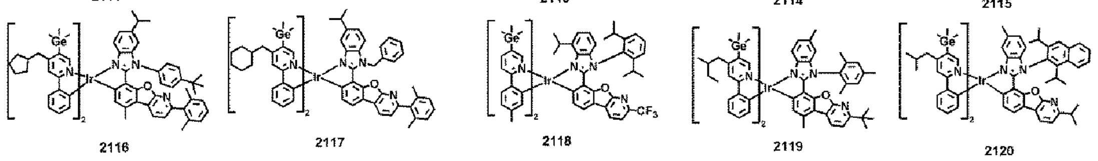
2116 2117 2118 2119 2120

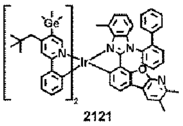
2121
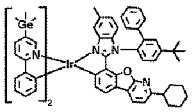
2122
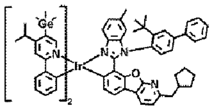
2123
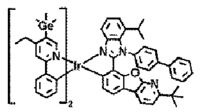
2124
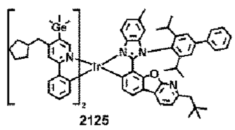
2125
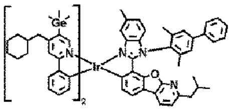
2126
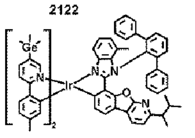
2127
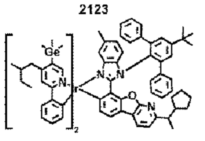
2128
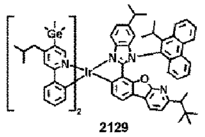
2129
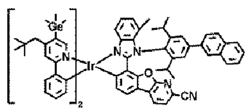
2130
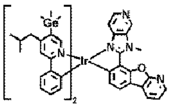
2131
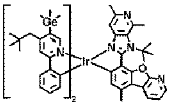
2132
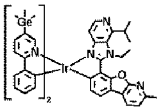
2133
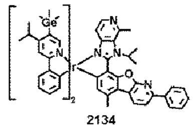
2134
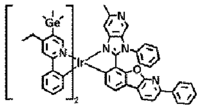
2135
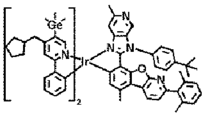
2136
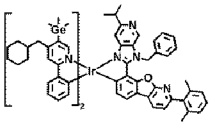
2137
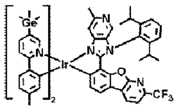
2138
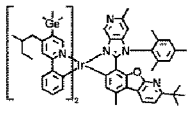
2139
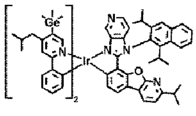
2140
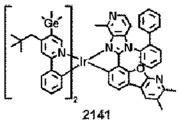
2141
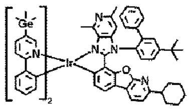
2142
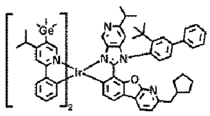
2143
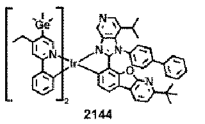
2144
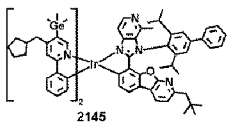
2145
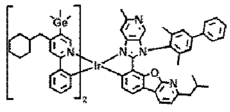
2146
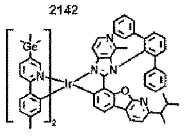
2147
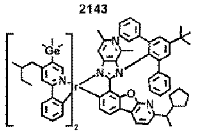
2148
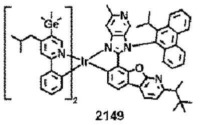
2149
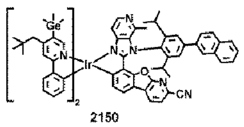
2150
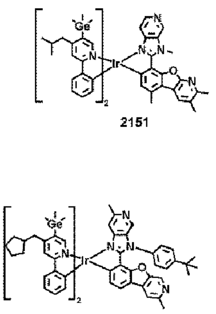
2151
2156
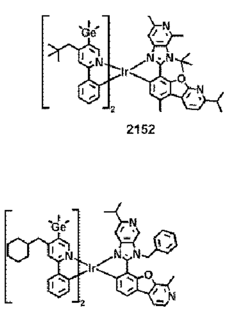
2152
2157
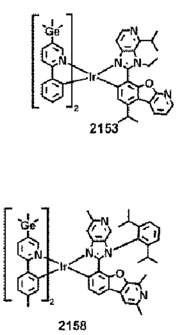
2153
2158
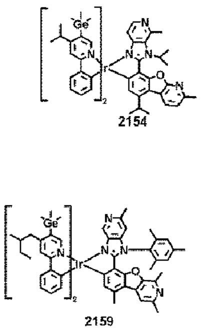
2154
2159
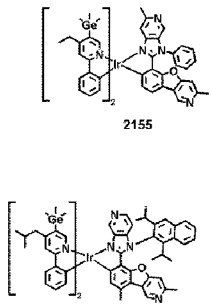
2155
2160
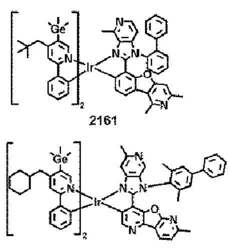
2161
2166
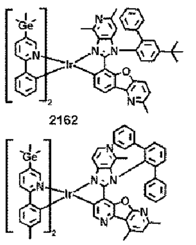
2162
2167
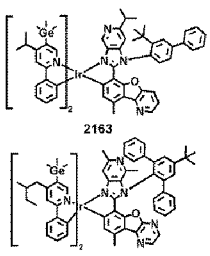
2163
2168
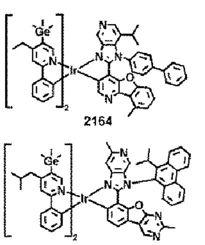
2164
2169
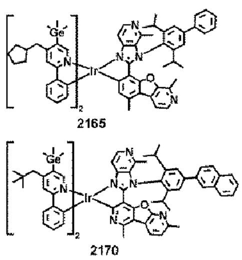
2165
2170

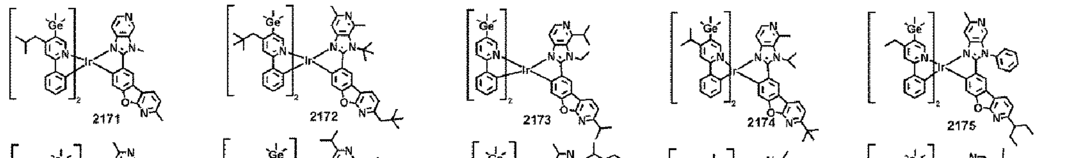
2171 2172 2173 2174 2175

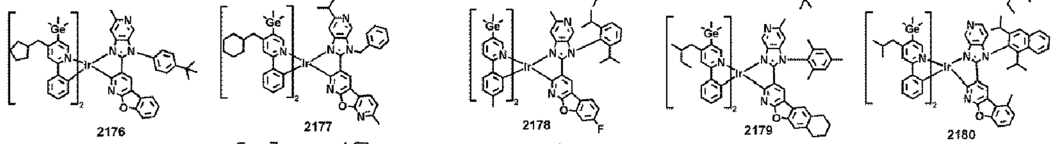
2176 2177 2178 2179 2180

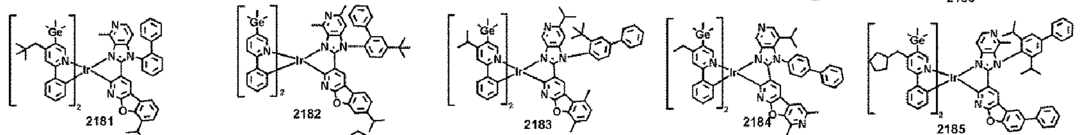
2181 2182 2183 2184 2185

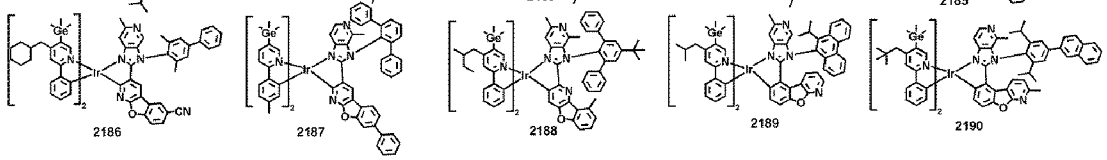
2186 2187 2188 2189 2190

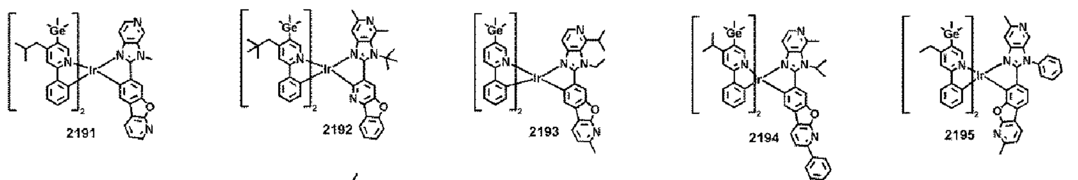
2191 2192 2193 2194 2195

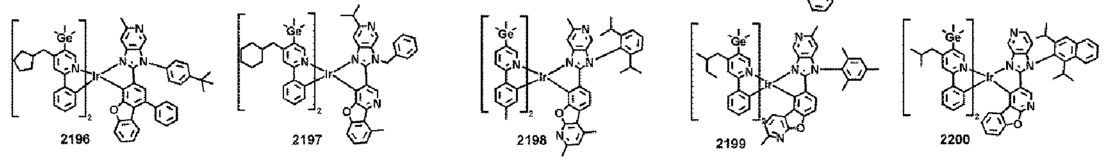
2196 2197 2198 2199 2200

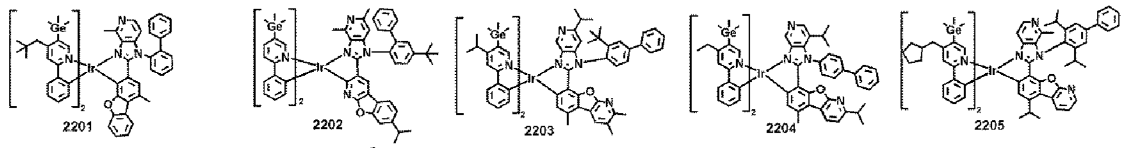
2201 2202 2203 2204 2205

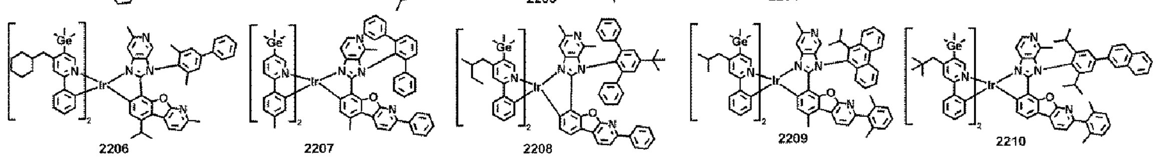
2206 2207 2208 2209 2210

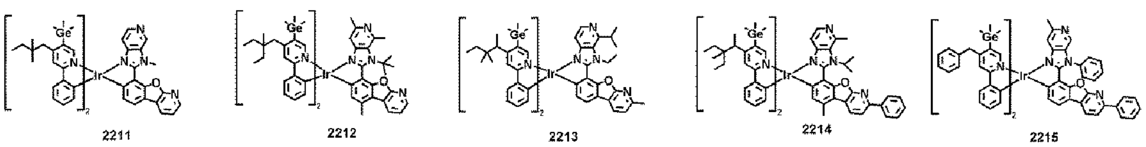
2211 2212 2213 2214 2215

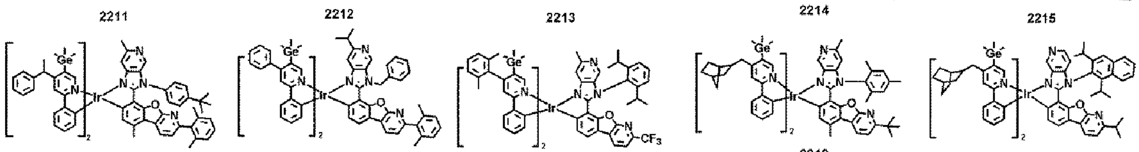
2216 2217 2218 2219 2220

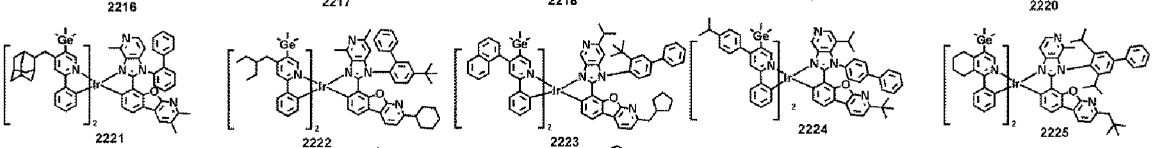
2221 2222 2223 2224 2225

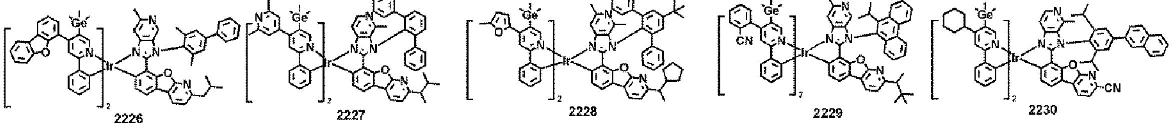
2226 2227 2228 2229 2230

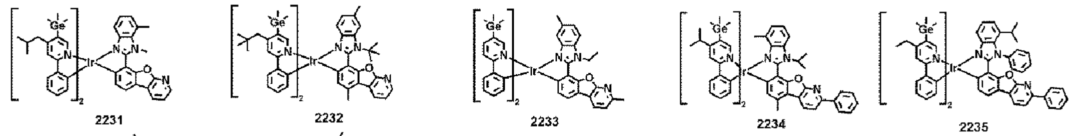

2231 2232 2233 2234 2235

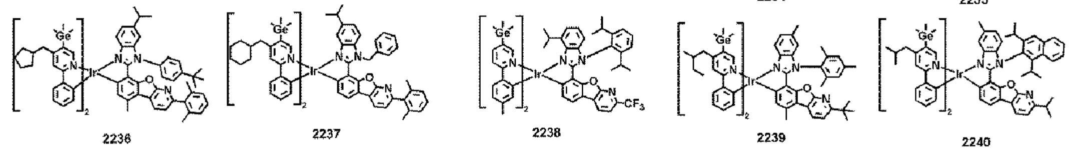

2236 2237 2238 2239 2240

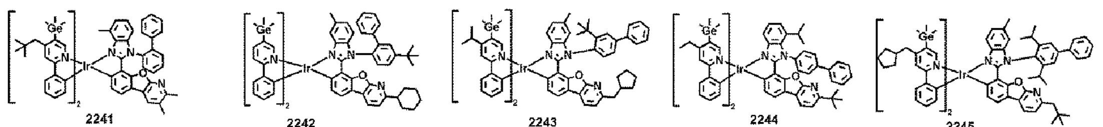

2241 2242 2243 2244 2245

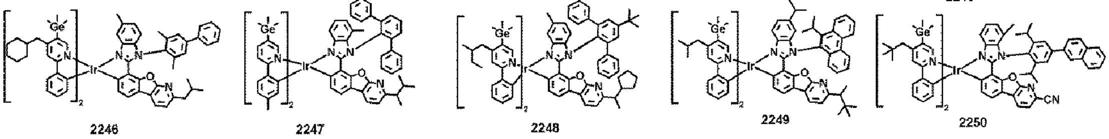

2246 2247 2248 2249 2250

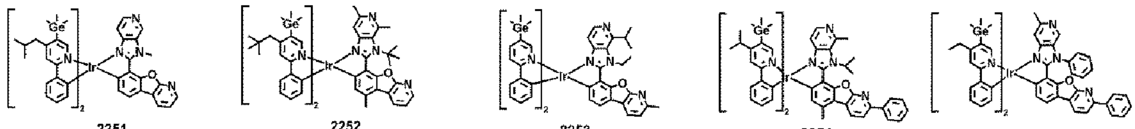

2251 2252 2253 2254 2255

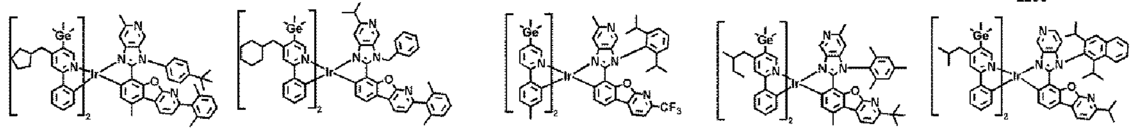

2256 2257 2258 2259 2260

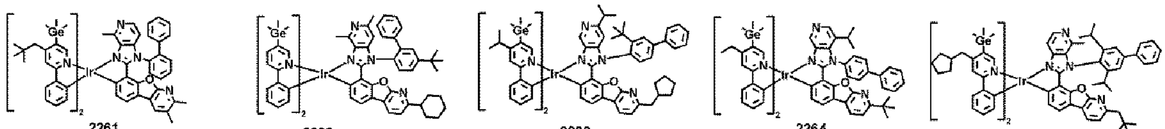

2261 2262 2263 2264 2265

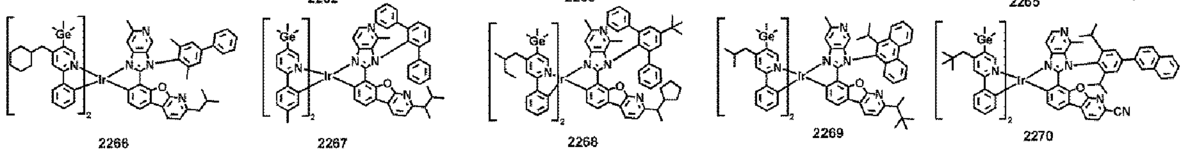

2266 2267 2268 2269 2270

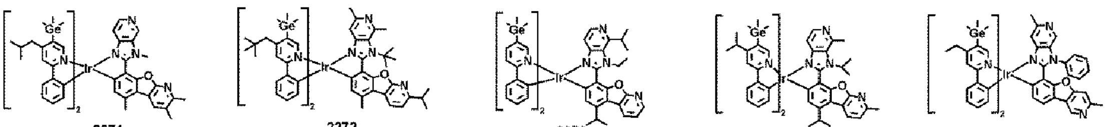

2271 2272 2273 2274 2275

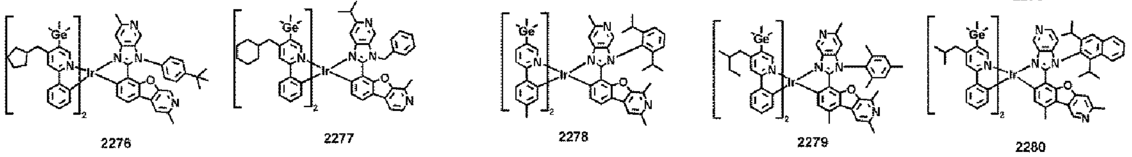

2276 2277 2278 2279 2280

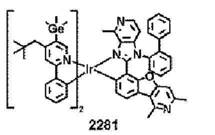
2281
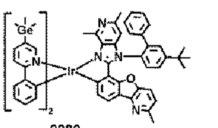
2282
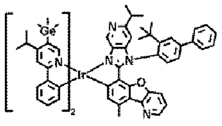
2283
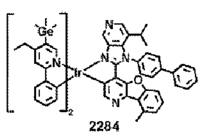
2284
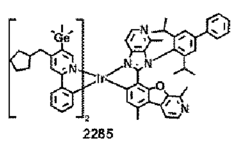
2285
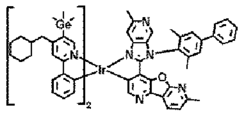
2286
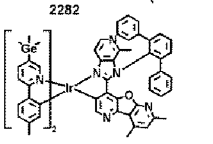
2287
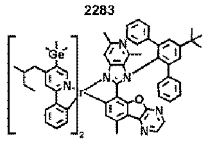
2288
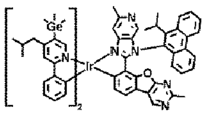
2289
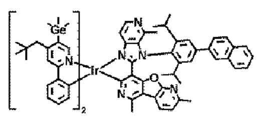
2290
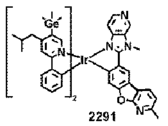
2291
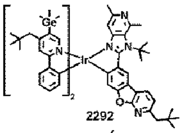
2292
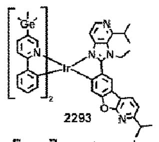
2293
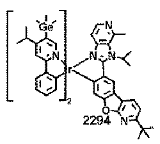
2294
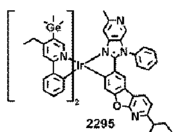
2295
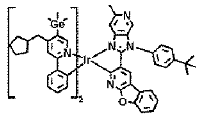
2296
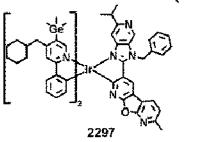
2297
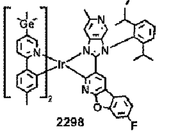
2298
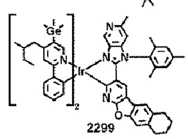
2299
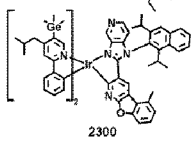
2300
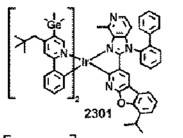
2301
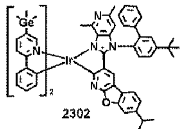
2302
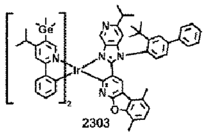
2303
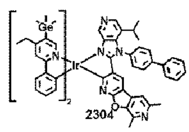
2304
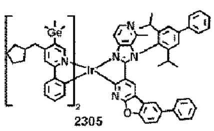
2305
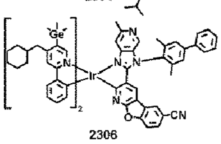
2306
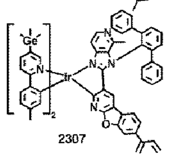
2307
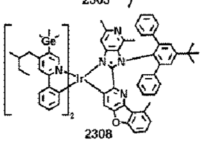
2308
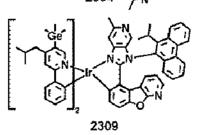
2309
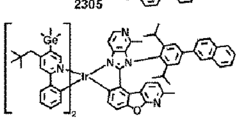
2310
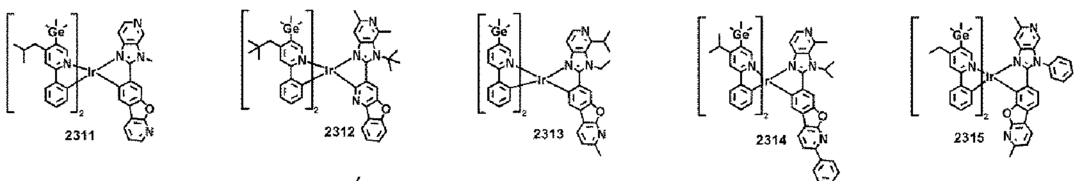
2311 2312 2313 2314 2315
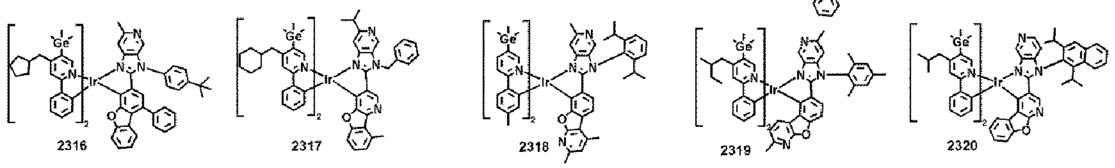
2316 2317 2318 2319 2320
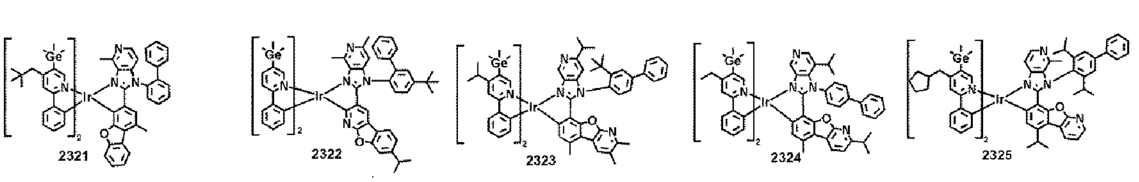
2321 2322 2323 2324 2325
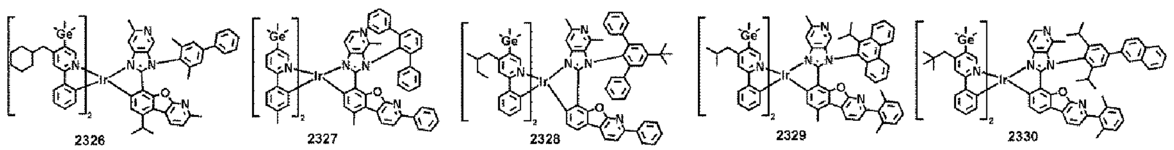
2326 2327 2328 2329 2330

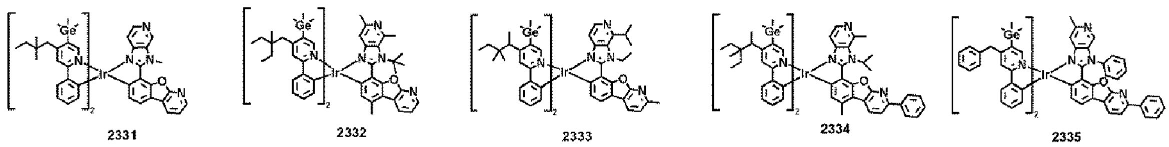

2331 2332 2333 2334 2335

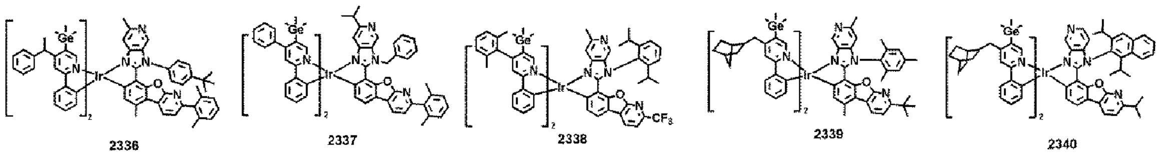

2336 2337 2338 2339 2340

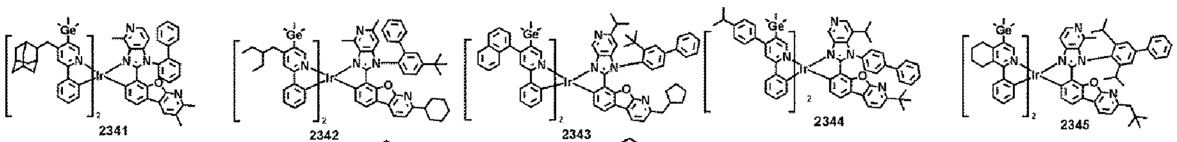

2341 2342 2343 2344 2345

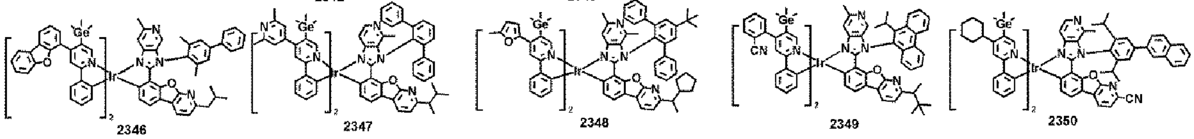

2346 2347 2348 2349 2350

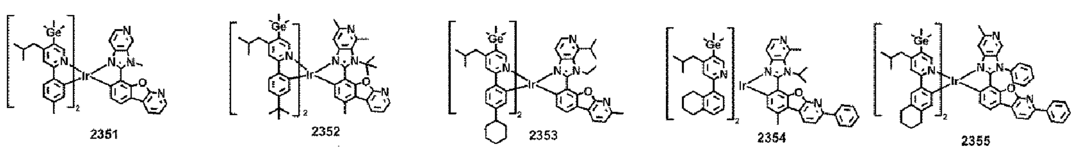

2351 2352 2353 2354 2355

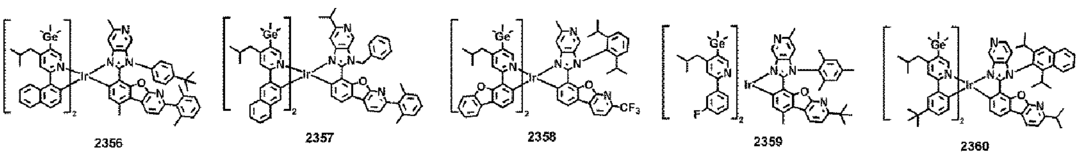

2356 2357 2358 2359 2360

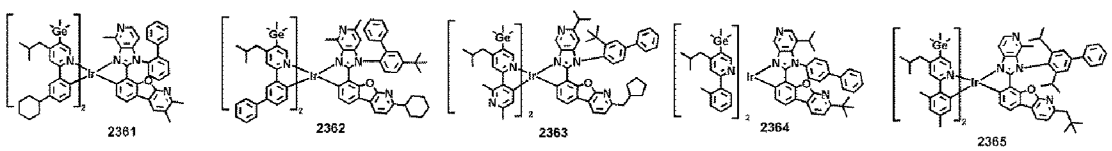

2361 2362 2363 2364 2365

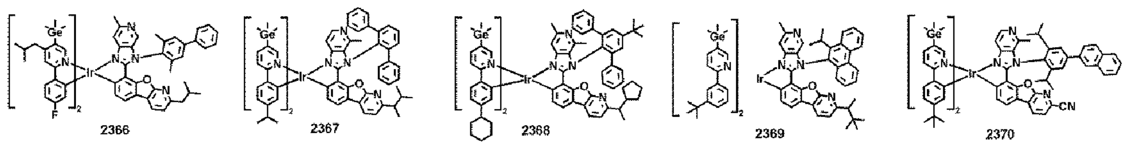

2366 2367 2368 2369 2370

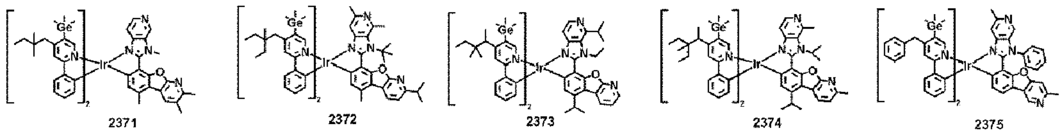

2371 2372 2373 2374 2375

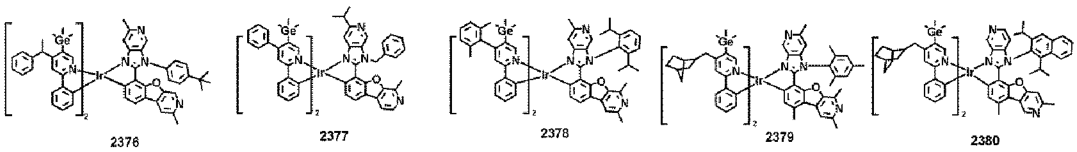

2376 2377 2378 2379 2380

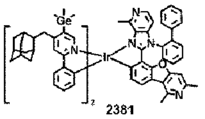
2381
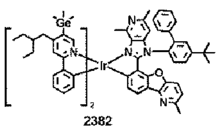
2382
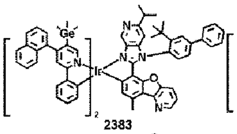
2383
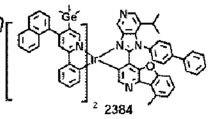
2384
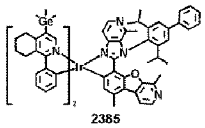
2385

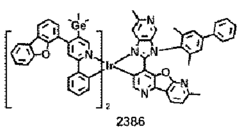
2386
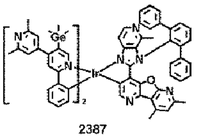
2387
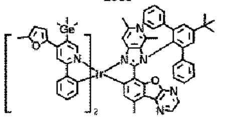
2388
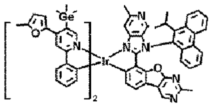
2389
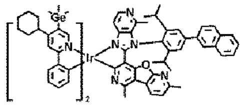
2390

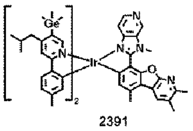
2391
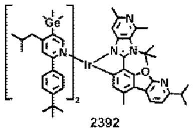
2392
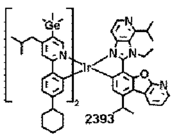
2393
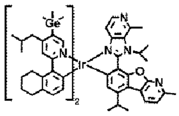
2394
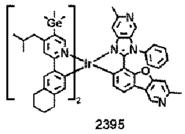
2395

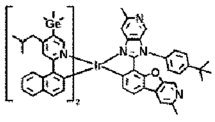
2396
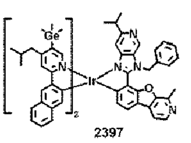
2397
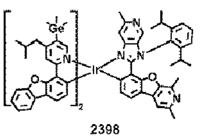
2398
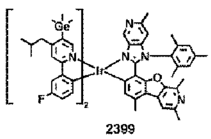
2399
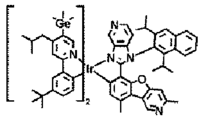
2400

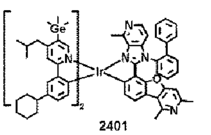
2401
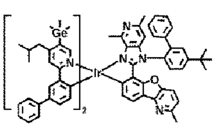
2402
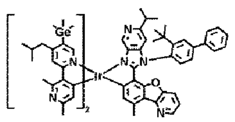
2403
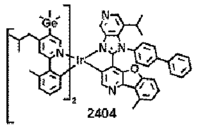
2404
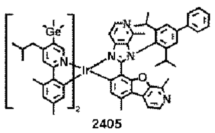
2405

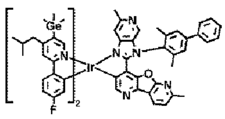
2406
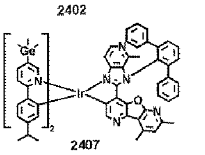
2407
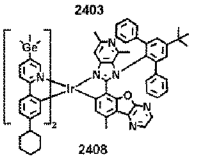
2408
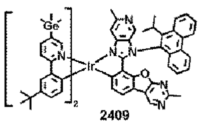
2409
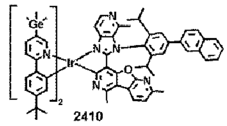
2410

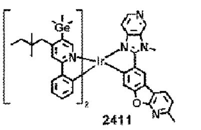
2411
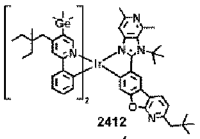
2412
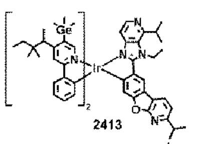
2413
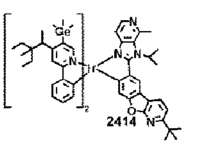
2414
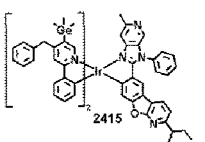
2415

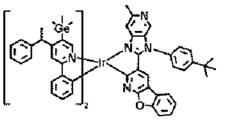
2416
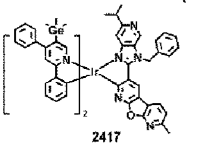
2417
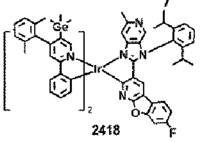
2418
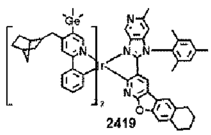
2419
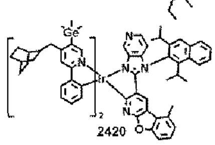
2420

2421
2422
2423
2424
2425

2426
2427
2428
2429
2430

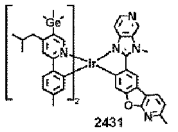
2431
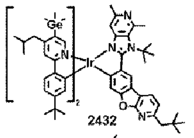
2432
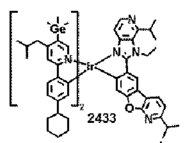
2433
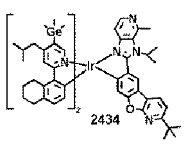
2434
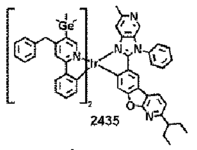
2435
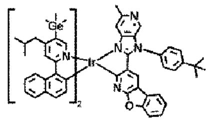
2436
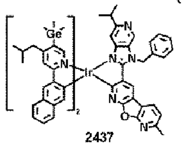
2437
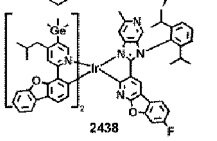
2438
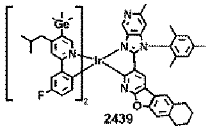
2439
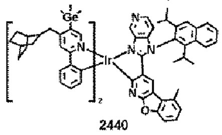
2440
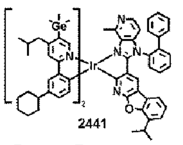
2441
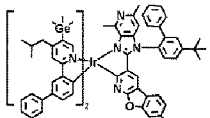
2442
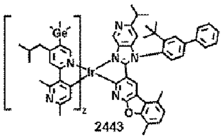
2443
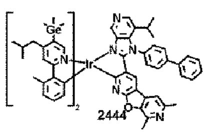
2444
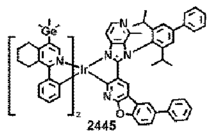
2445
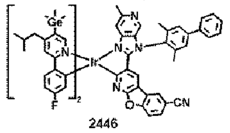
2446
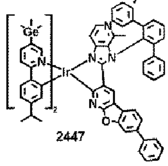
2447
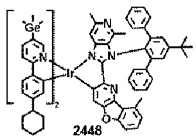
2448
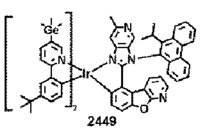
2449
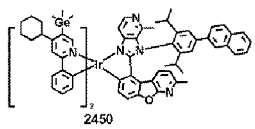
2450
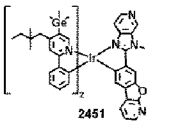
2451
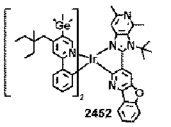
2452
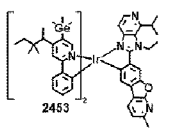
2453
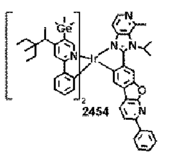
2454
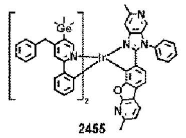
2455
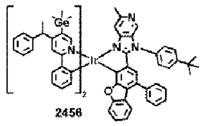
2456
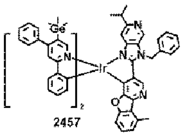
2457
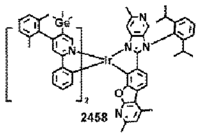
2458
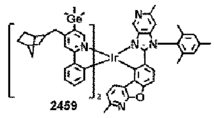
2459
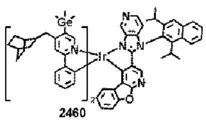
2460
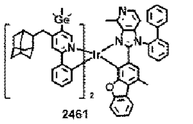
2461
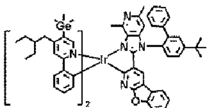
2462
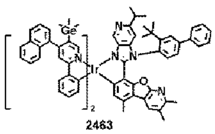
2463
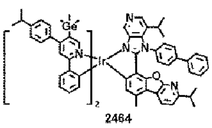
2464
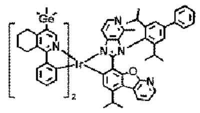
2465
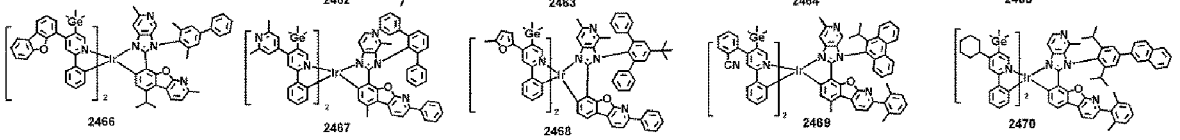
2466
2467
2468
2469
2470
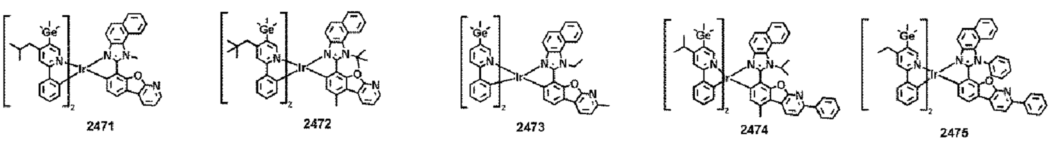
2471
2472
2473
2474
2475
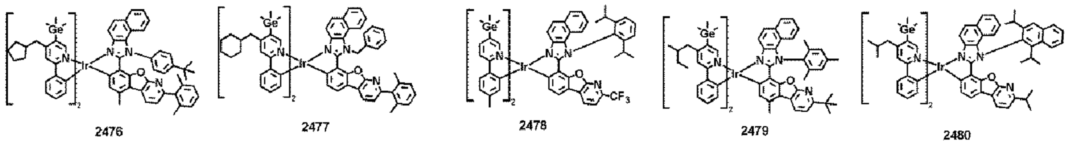
2476
2477
2478
2479
2480

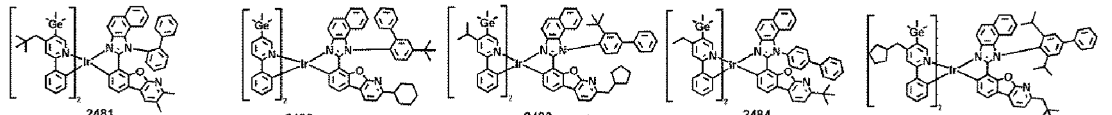
2481 2482 2483 2484 2485

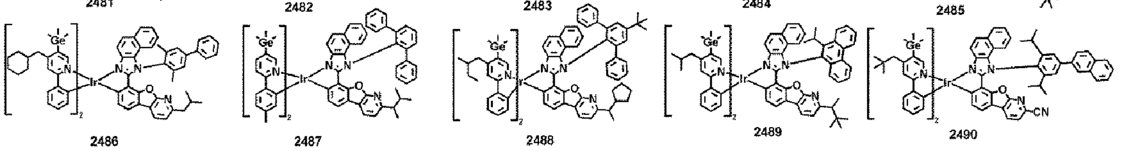
2486 2487 2488 2489 2490

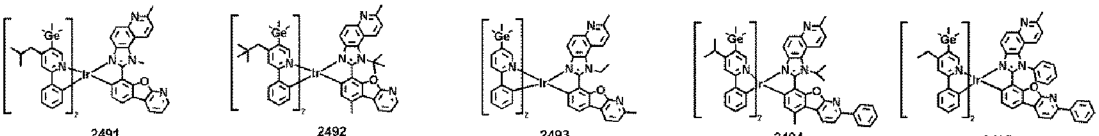
2491 2492 2493 2494 2495

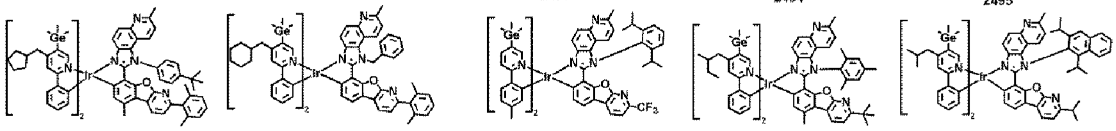
2496 2497 2498 2499 2500

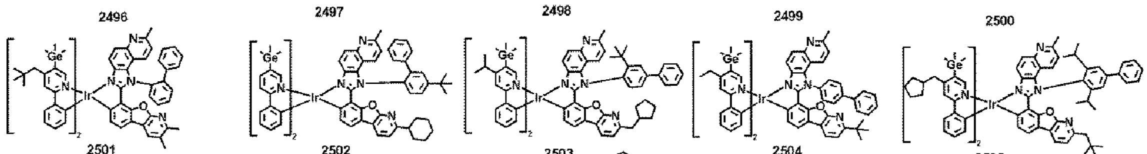
2501 2502 2503 2504 2505

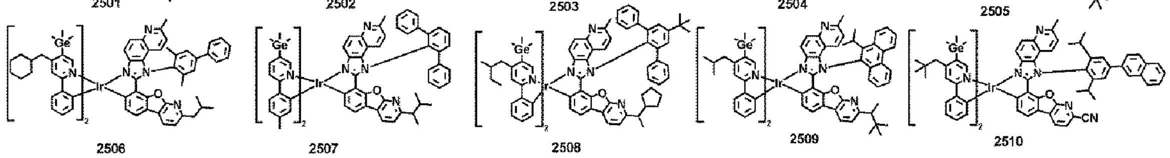
2506 2507 2508 2509 2510

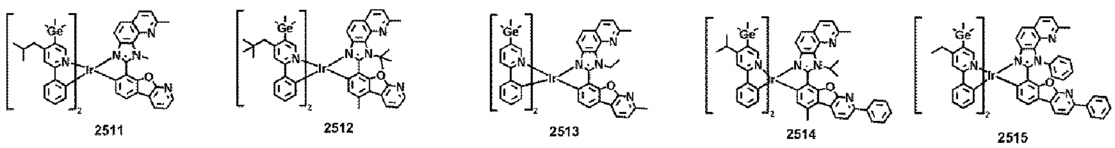
2511 2512 2513 2514 2515

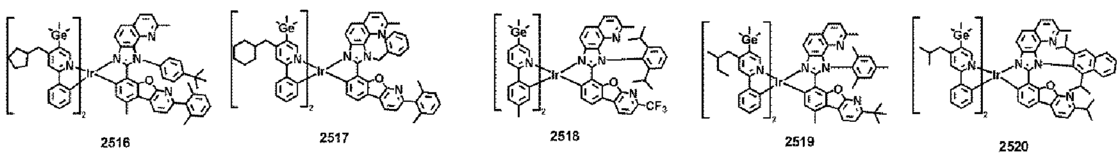
2516 2517 2518 2519 2520

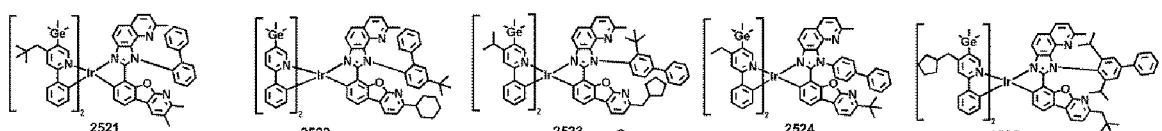
2521 2522 2523 2524 2525

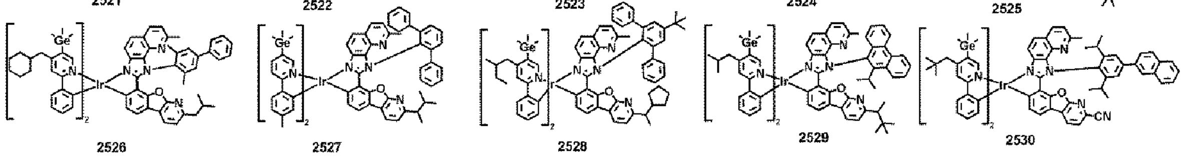
2526 2527 2528 2529 2530

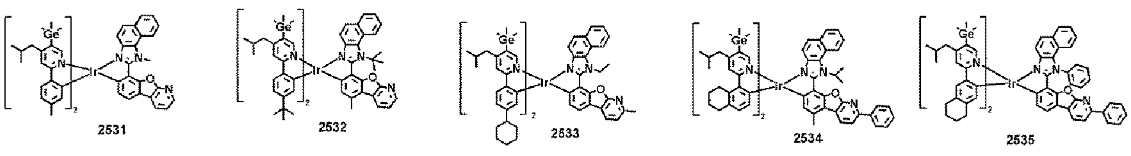
2531 2532 2533 2534 2535

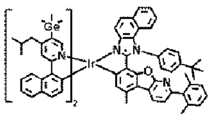
2536
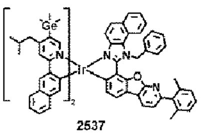
2537
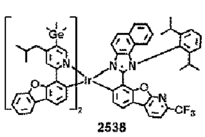
2538
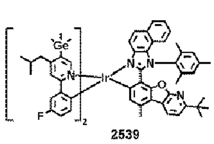
2539
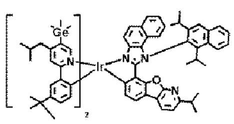
2540
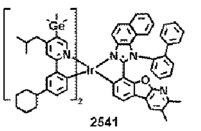
2541
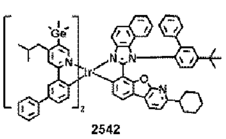
2542
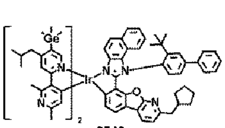
2543
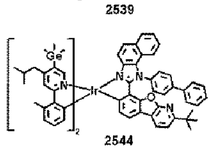
2544
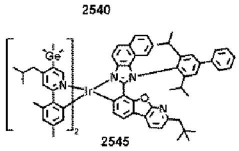
2545
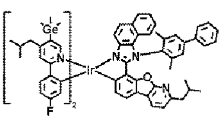
2546
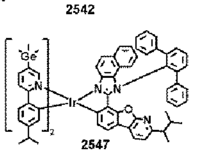
2547
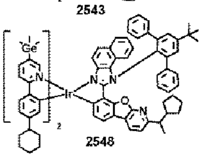
2548
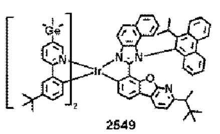
2549
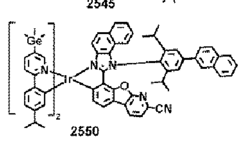
2550

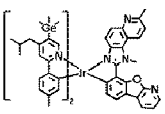
2551
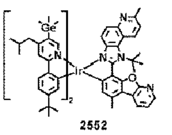
2552
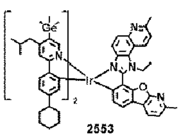
2553
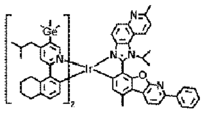
2554
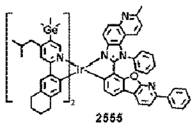
2555
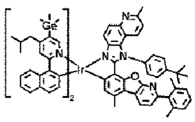
2556
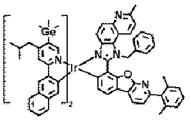
2557
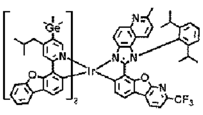
2558
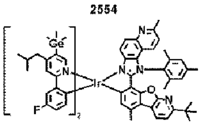
2559
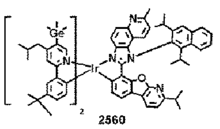
2560
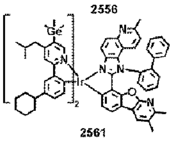
2561
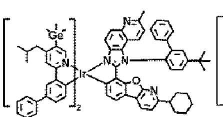
2562
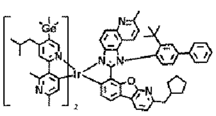
2563
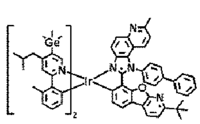
2564
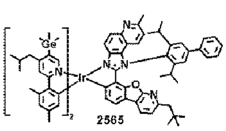
2565
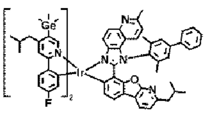
2566
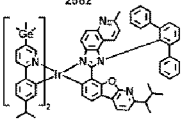
2567
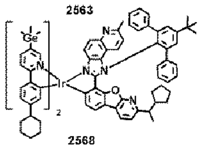
2568
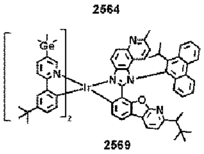
2569
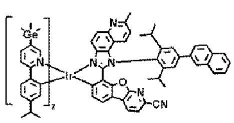
2570

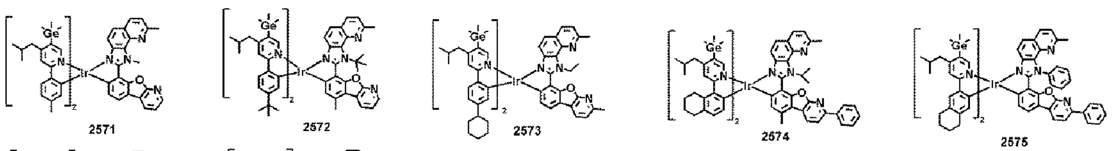
2571
2572
2573
2574
2575
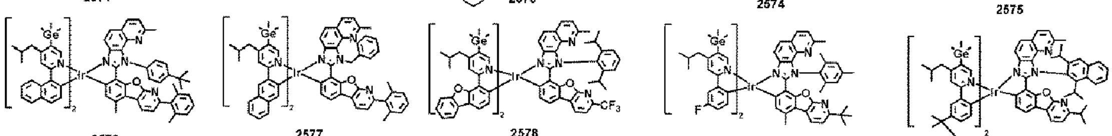
2576
2577
2578
2579
2580
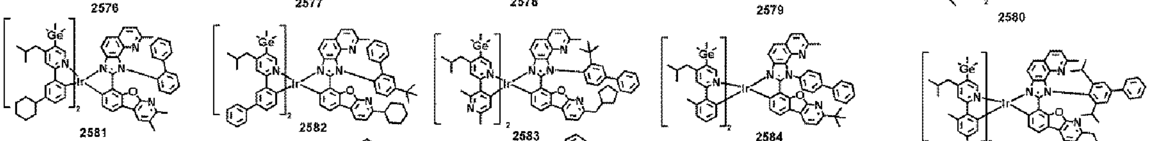
2581
2582
2583
2584
2585
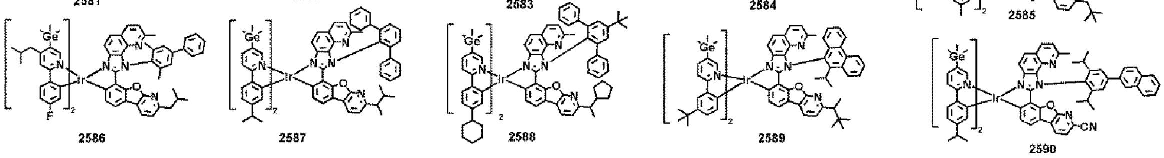
2586
2587
2588
2589
2590

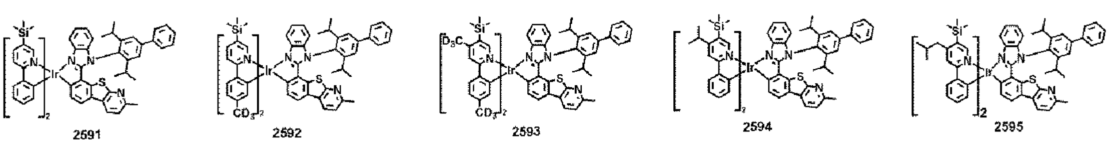
2591
2592
2593
2594
2595

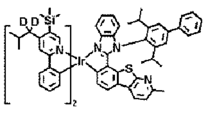
2596
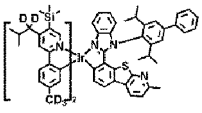
2597
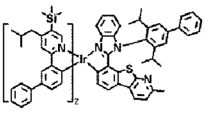
2598
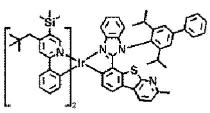
2599
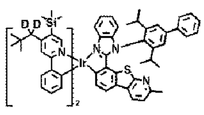
2600

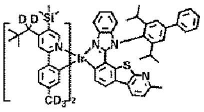
2601
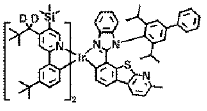
2602
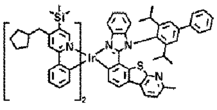
2603
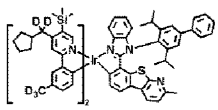
2604
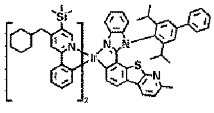
2605

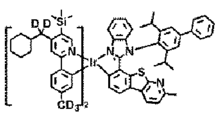
2606
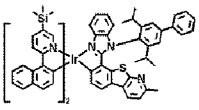
2607
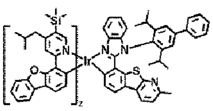
2608
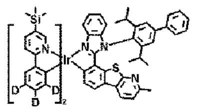
2609
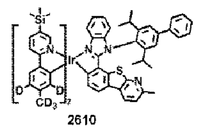
2610

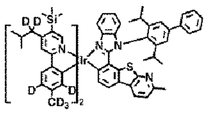
2611
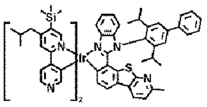
2612
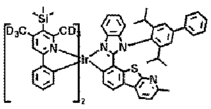
2613
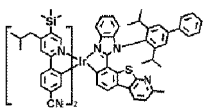
2614
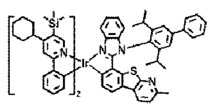
2615

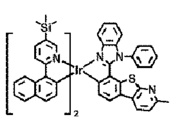
2616
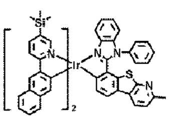
2617
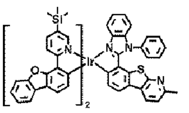
2618
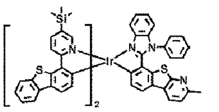
2619
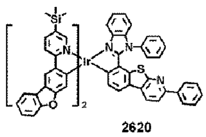
2620

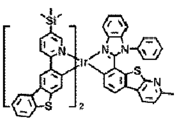
2621
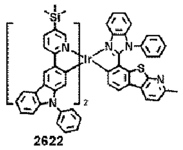
2622
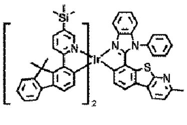
2623
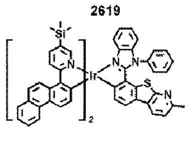
2624
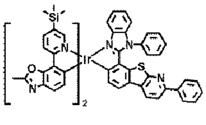
2625

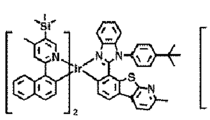
2626
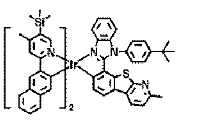
2627
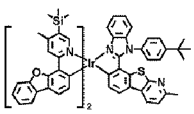
2628
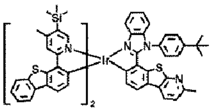
2629
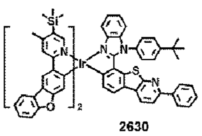
2630

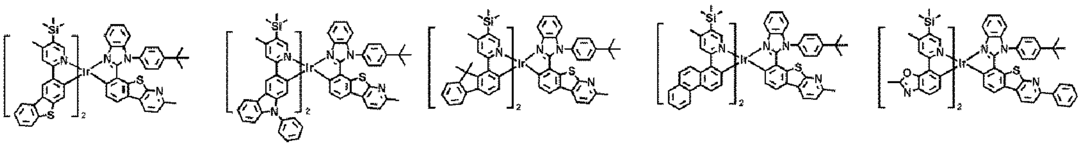
2631
2632
2633
2634
2635

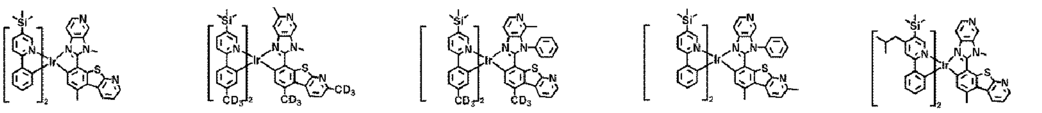
2636
2637
2638
2639
2640

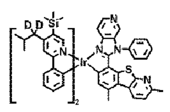
2641

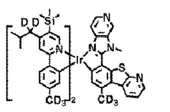
2642

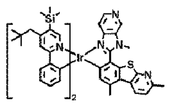
2643

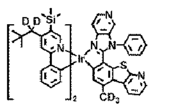
2644

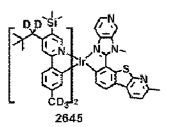
2645

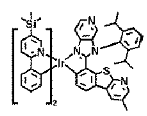
2646

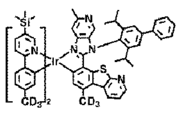
2647

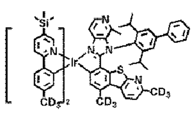
2648

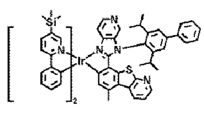
2649

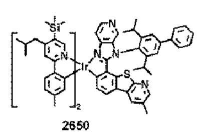
2650

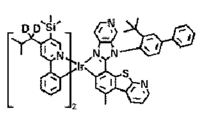
2651

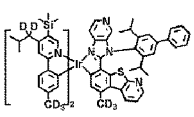
2652

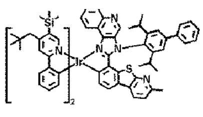
2653

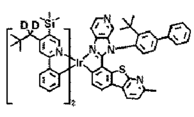
2651

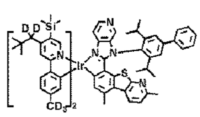
2655

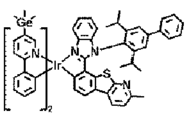
2656

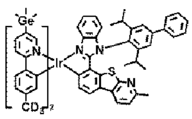
2657

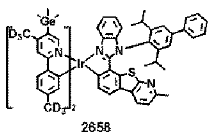
2658

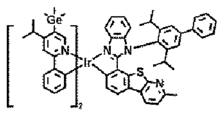
2659

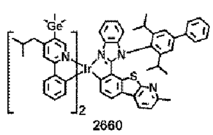
2660

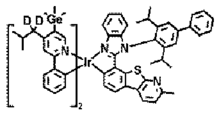
2661

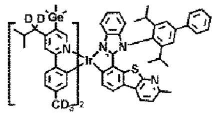
2662

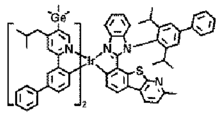
2663

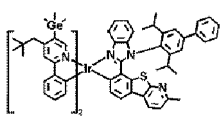
2664

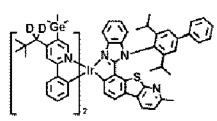
2665

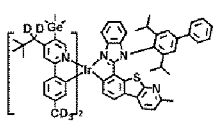
2666

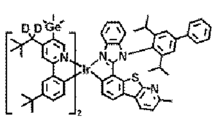
2667

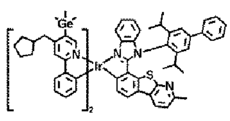
2668

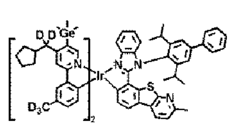
2669

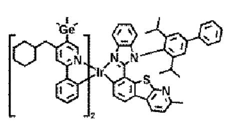
2670

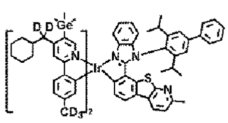
2671

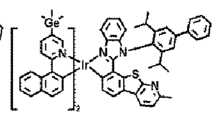
2672

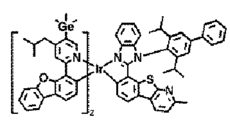
2673

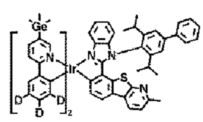
2674

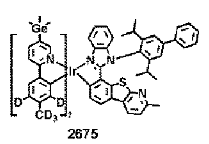
2675

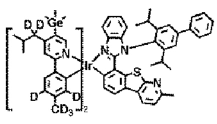
2676

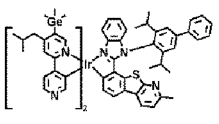
2677

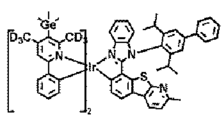
2678

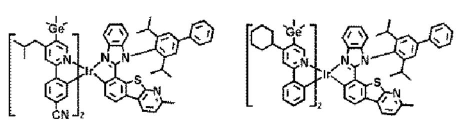
2679

2680

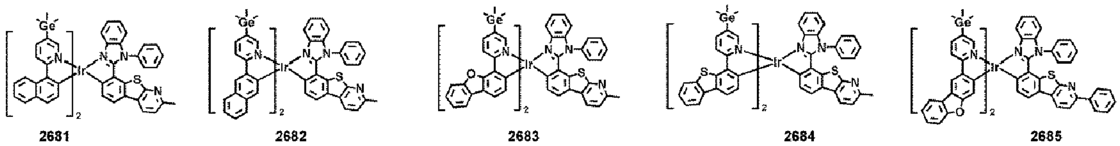
2681

2682

2683

2684

2685

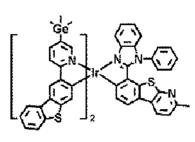
2686
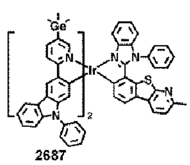
2687
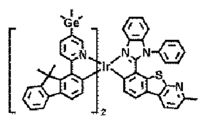
2688
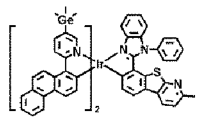
2689
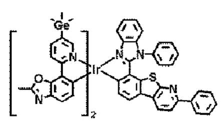
2690

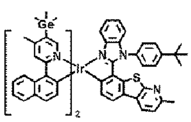
2691
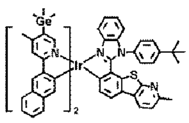
2692
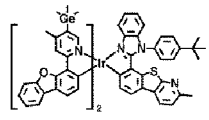
2693
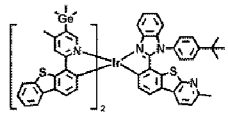
2694
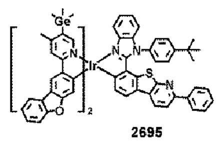
2695

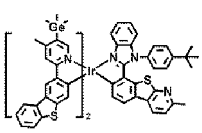
2696
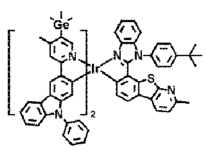
2697
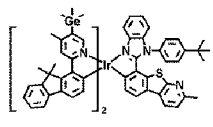
2698
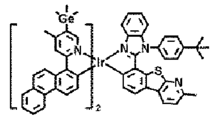
2699
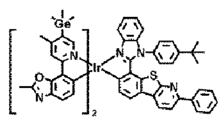
2700

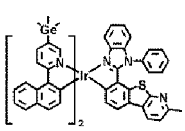
2701
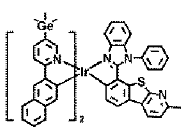
2702
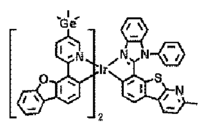
2703
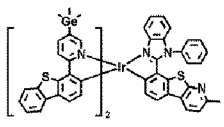
2704
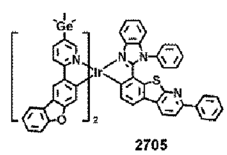
2705

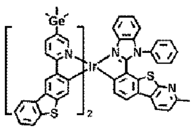
2706
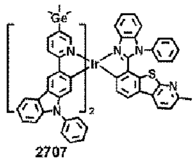
2707
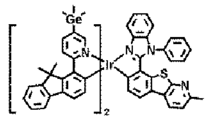
2708
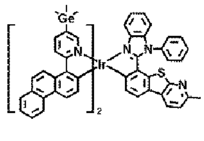
2709
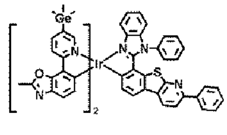
2710

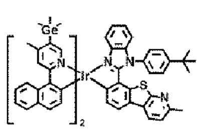
2711
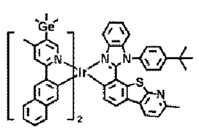
2712
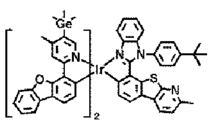
2713
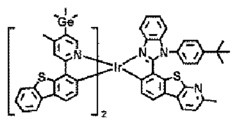
2714
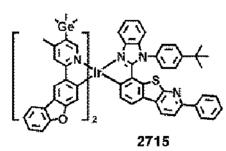
2715

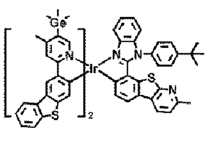
2716
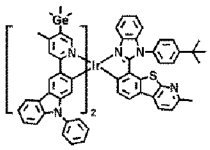
2717
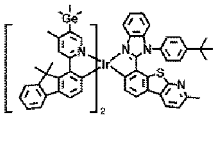
2718
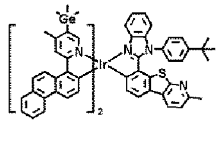
2719
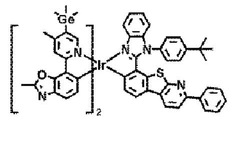
2720

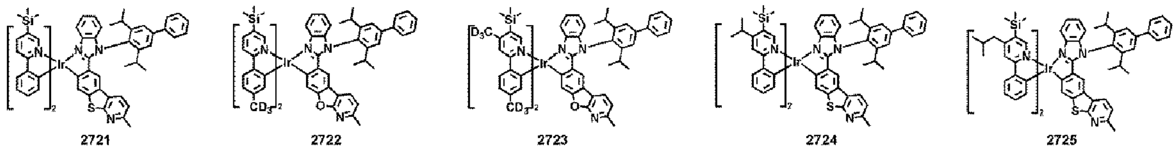
2721
2722
2723
2724
2725

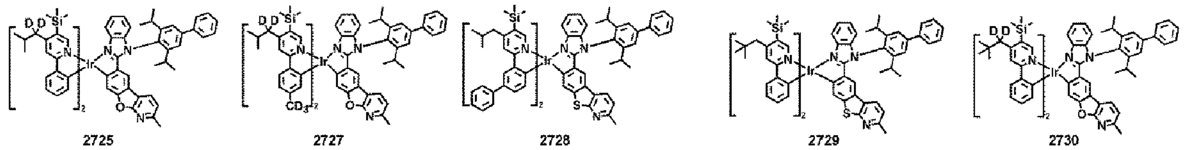
2725
2727
2728
2729
2730

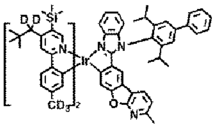
2731
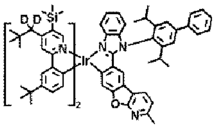
2732
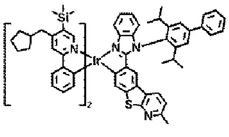
2733
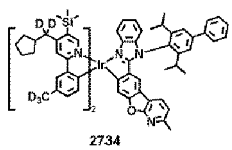
2734
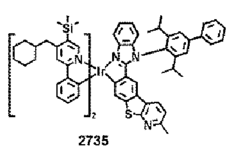
2735

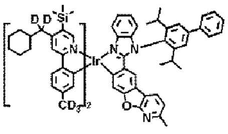
2736
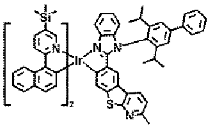
2737
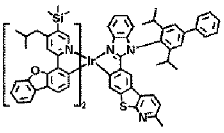
2738
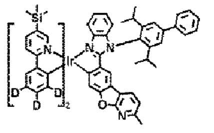
2739
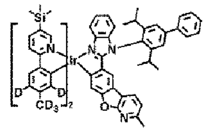
2740

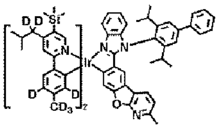
2741
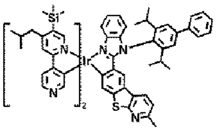
2742
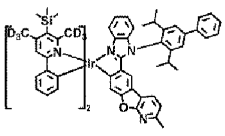
2743
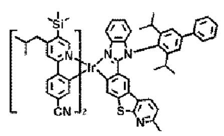
2744
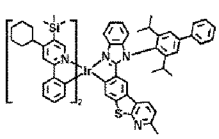
2745

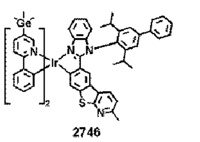
2746
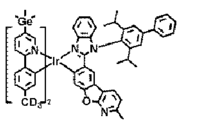
2747
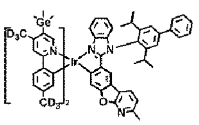
4748
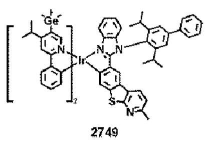
2749
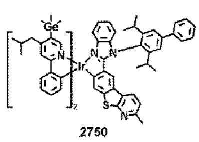
2750

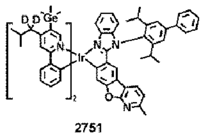
2751
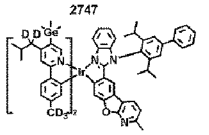
2752
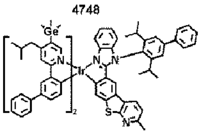
2753
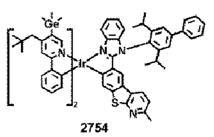
2754
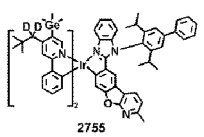
2755

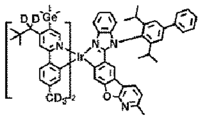
2756
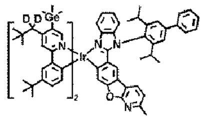
2757
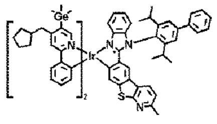
2758
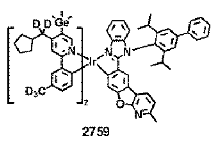
2759
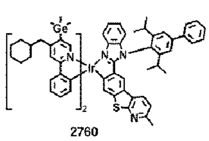
2760

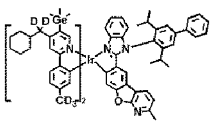
2761
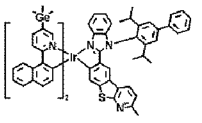
2762
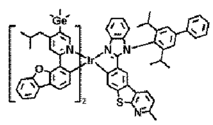
2763
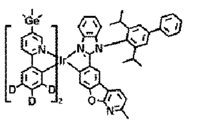
2764
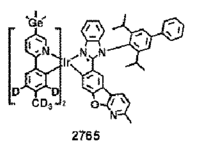
2765

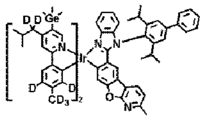
2766
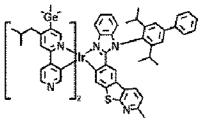
2767
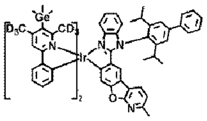
2768
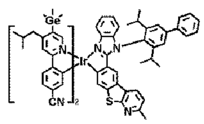
2769
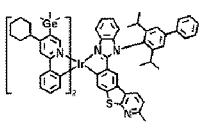
2770

2771
2772
2773
2774
2775

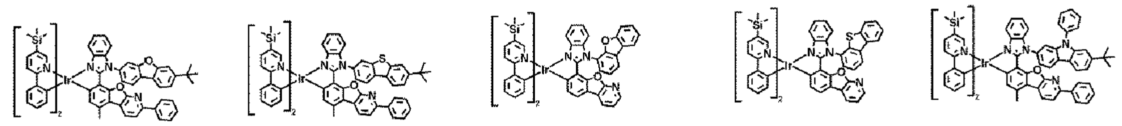

2776 2777 2778 2779 2780

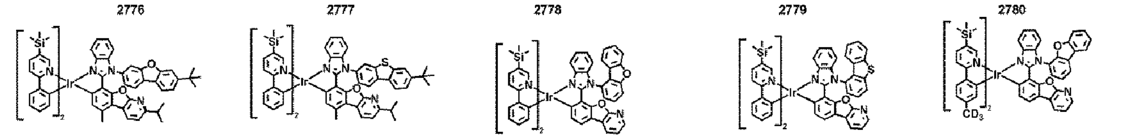

2781 2782 2783 2784 2785

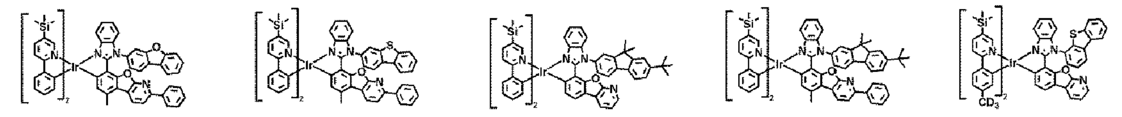

2786 2787 2788 2789 2790

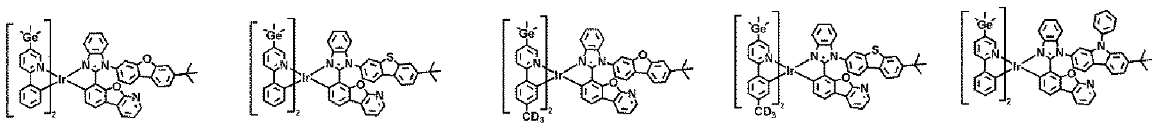

2791 2792 2793 2794 2795

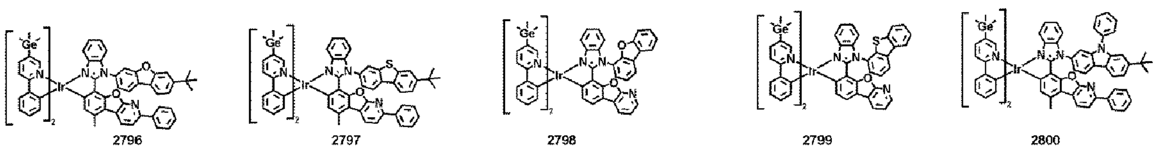

2796 2797 2798 2799 2800

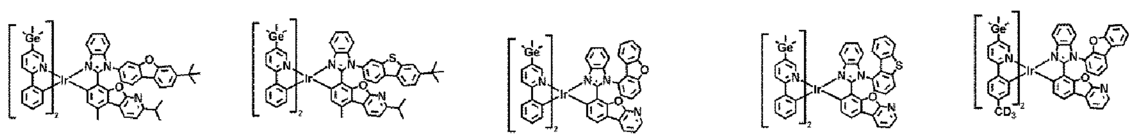

2801 2802 2803 2804 2805

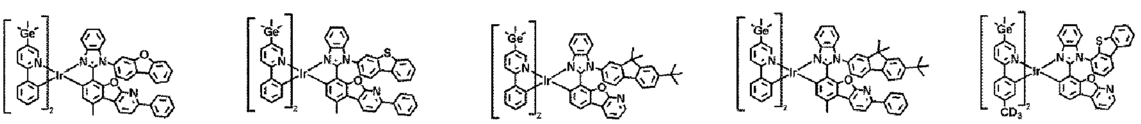

2806 2807 2808 2809 2810

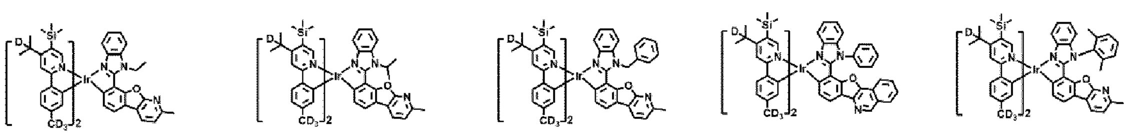

2811 2812 2813 2814 2815

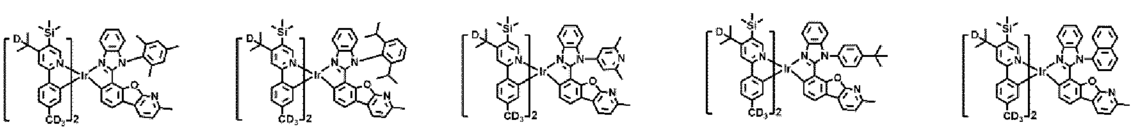

2816 2817 2818 2819 2820

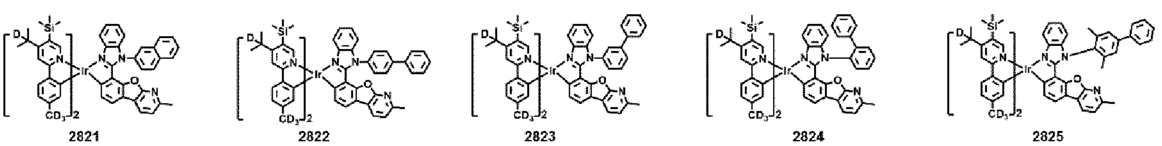

2821 2822 2823 2824 2825

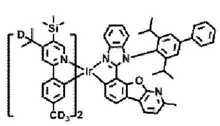
2826
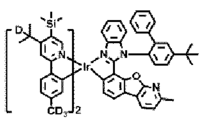
2827
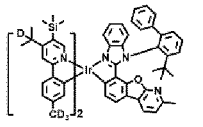
2828
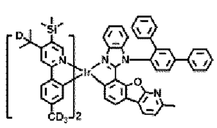
2829
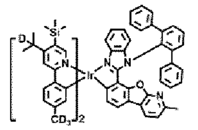
2830

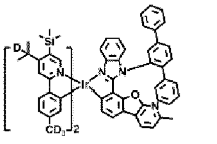
2831
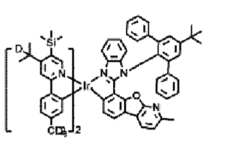
2832
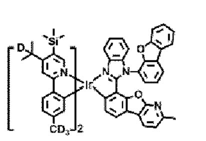
2833
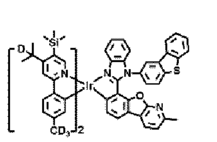
2834
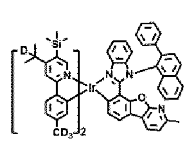
2835

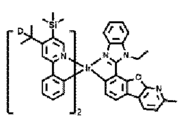
2836
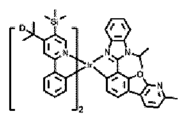
2837
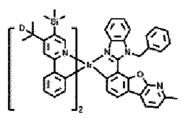
2838
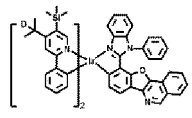
2839
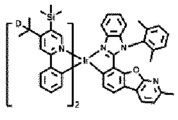
2840

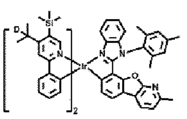
2841
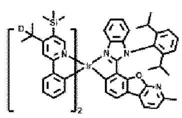
2842
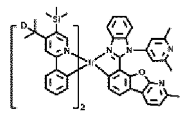
2843
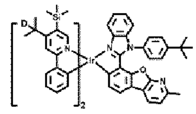
2844
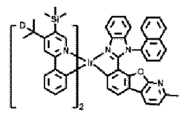
2845

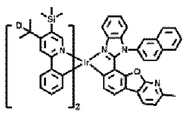
2846
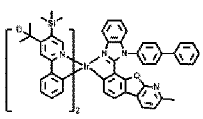
2847
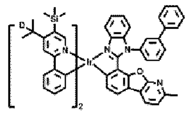
2848
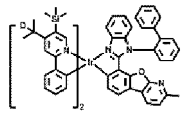
2849
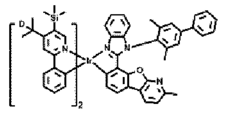
2850

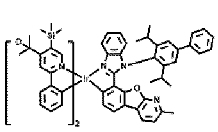
2851
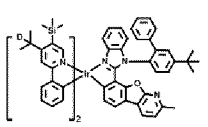
2852
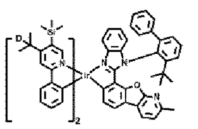
2853
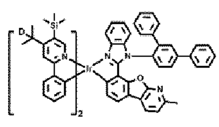
2854
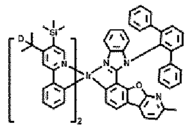
2855

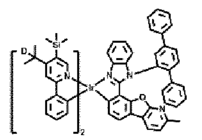
2856
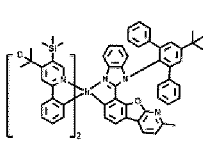
2857
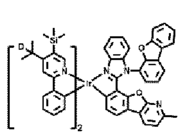
2858
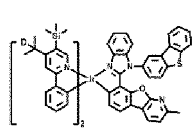
2859
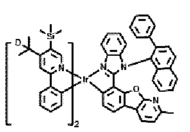
2860

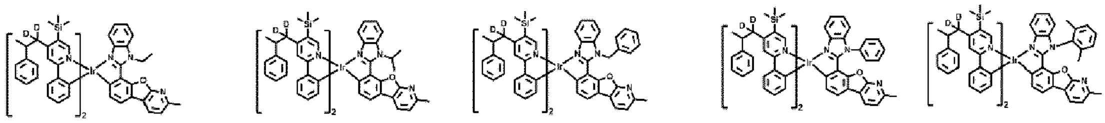
2861
2862
2863
2864
2865

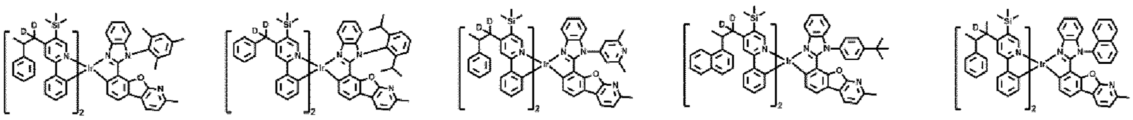
2866
2867
2868
2869
2870

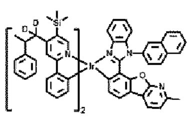
2871
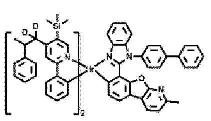
2872
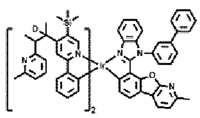
2873
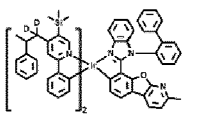
2874
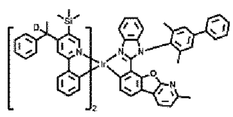
2875
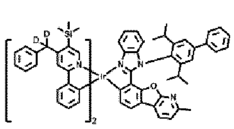
2876
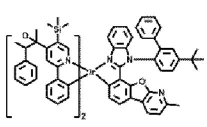
2877
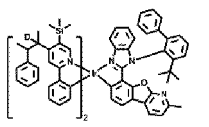
2878
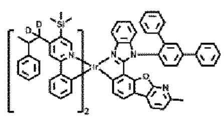
2879
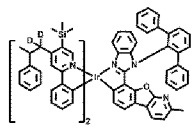
2880
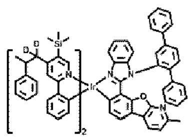
2881
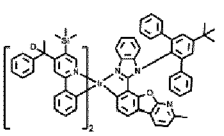
2882
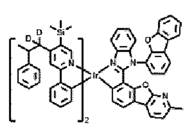
2883
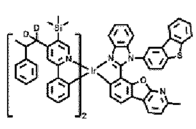
2884
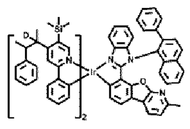
2885
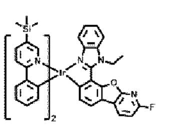
2886
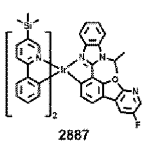
2887
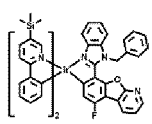
2888
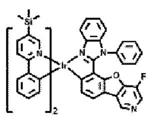
2889
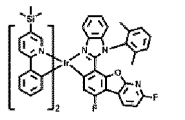
2890
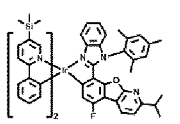
2891
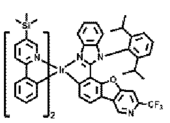
2892
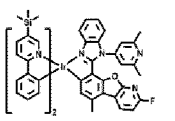
2893
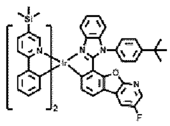
2894
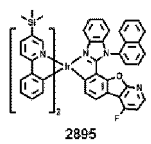
2895
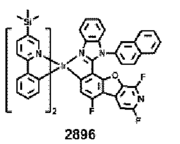
2896
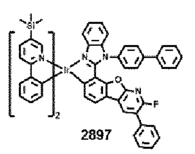
2897
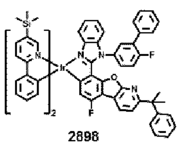
2898
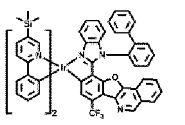
2899
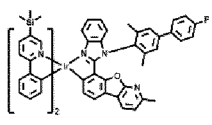
2900
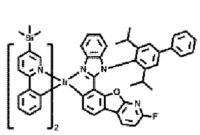
2901
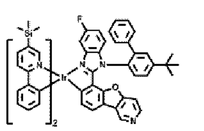
2902
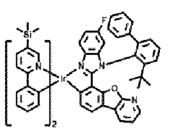
2903
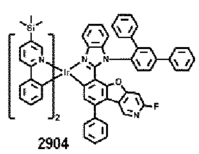
2904
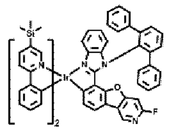
2905
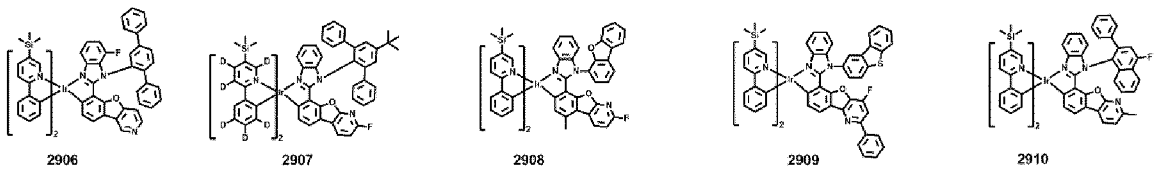
2906 2907 2908 2909 2910
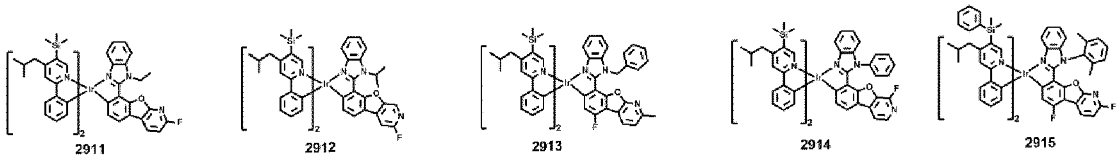
2911 2912 2913 2914 2915

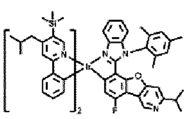
2916
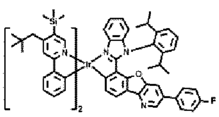
2917
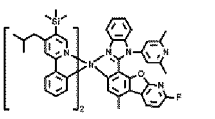
2918
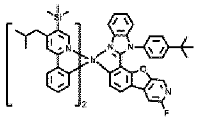
2919
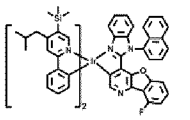
2920
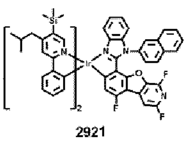
2921
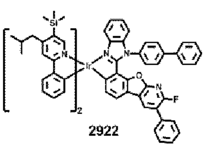
2922
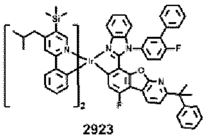
2923
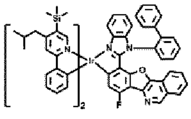
2924
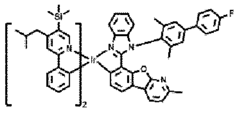
2925
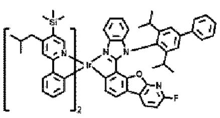
2926
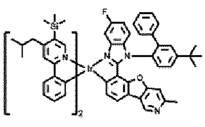
2927
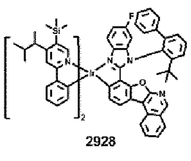
2928
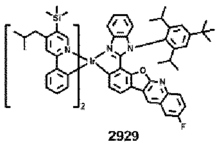
2929
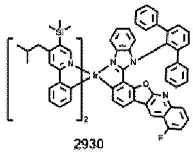
2930
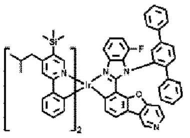
2931
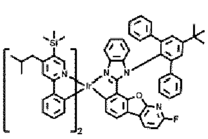
2932
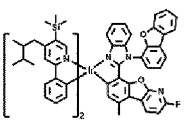
2933
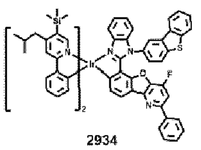
2934
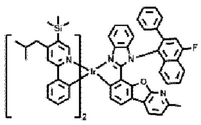
2935
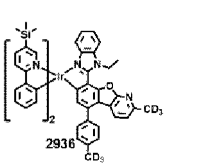
2936
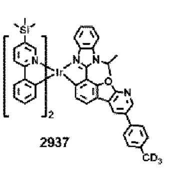
2937
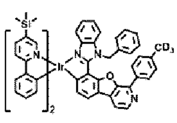
2938
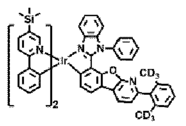
2939
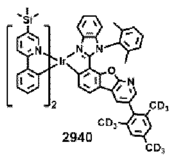
2940
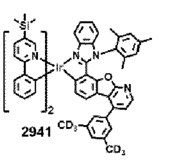
2941
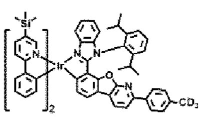
2942
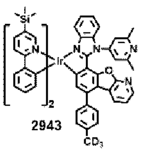
2943
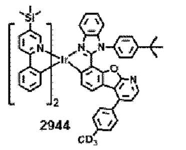
2944
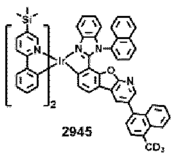
2945
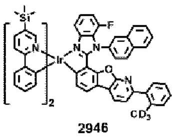
2946
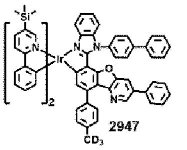
2947
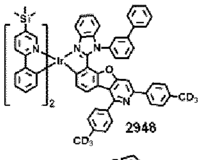
2948
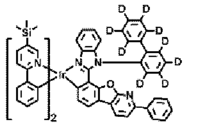
2949
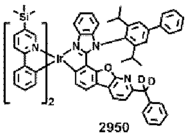
2950
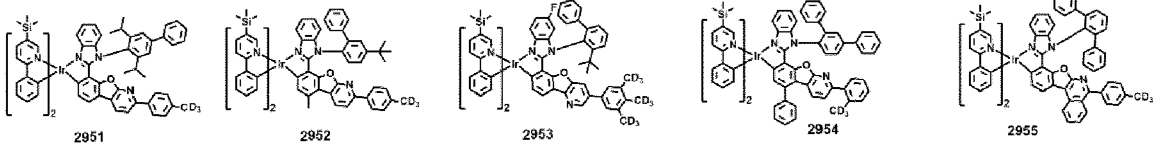
2951 2952 2953 2954 2955
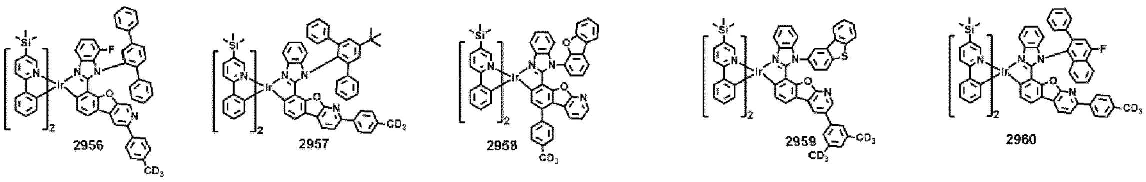
2956 2957 2958 2959 2960

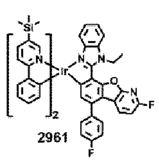
2961
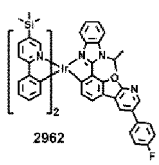
2962
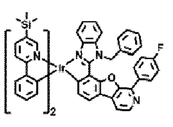
2963
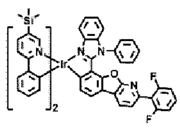
2964
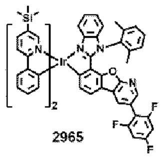
2965

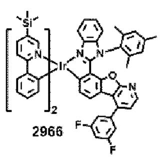
2966
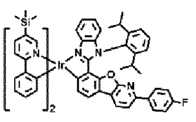
2967
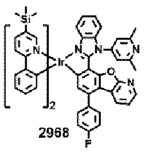
2968
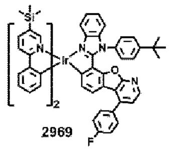
2969
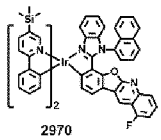
2970

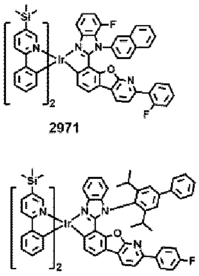
2971
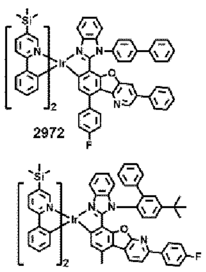
2972
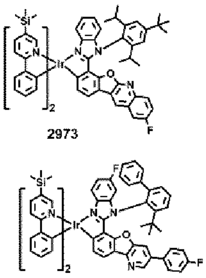
2973
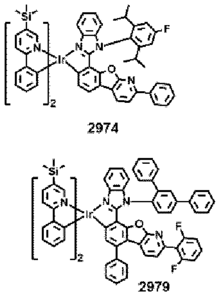
2974
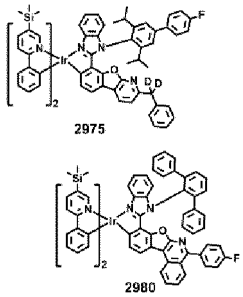
2975

2976
2977
2978
2979
2980

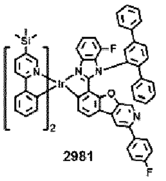
2981
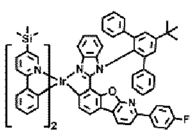
2982
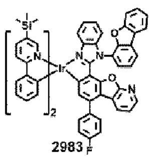
2983
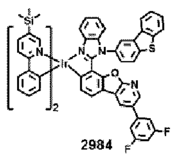
2984
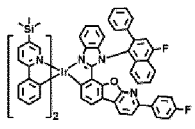
2985

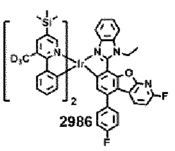
2986
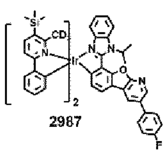
2987
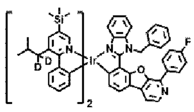
2988
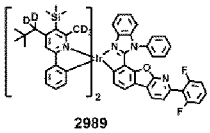
2989
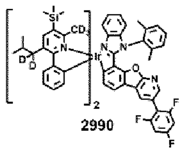
2990

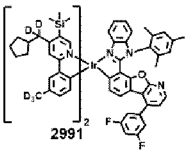
2991
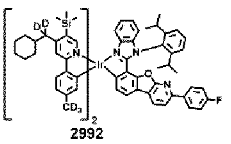
2992
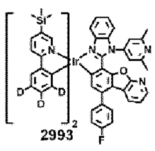
2993
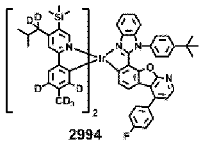
2994
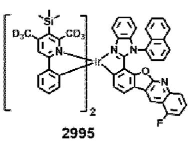
2995

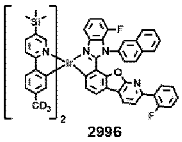
2996
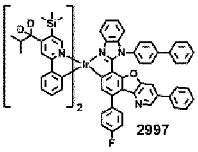
2997
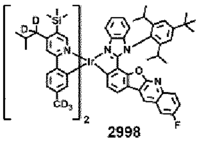
2998
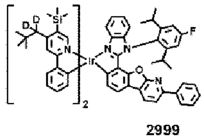
2999
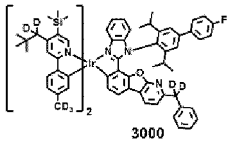
3000

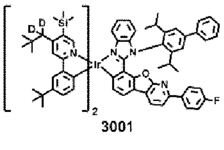
3001
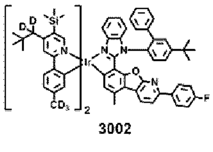
3002
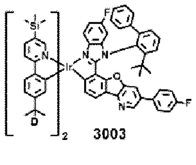
3003
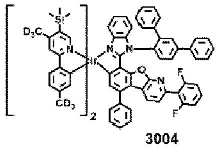
3004
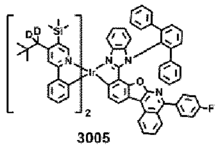
3005

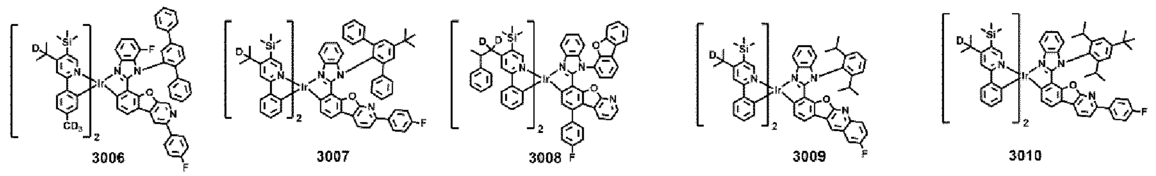

3006 3007 3008 3009 3010

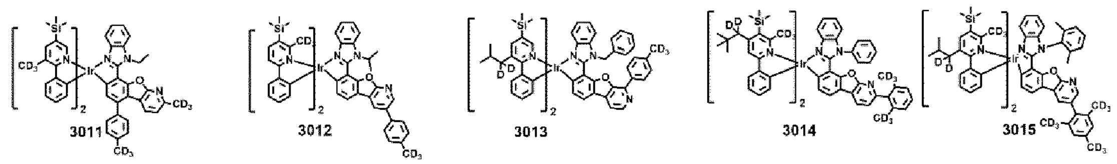

3011 3012 3013 3014 3015

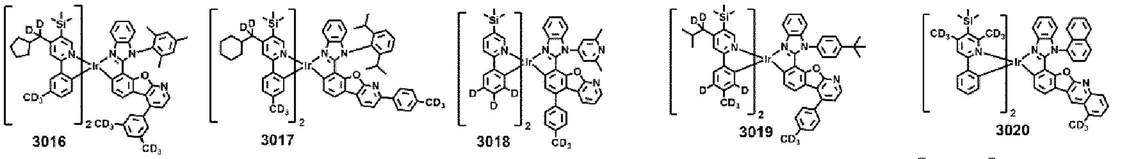

3016 3017 3018 3019 3020

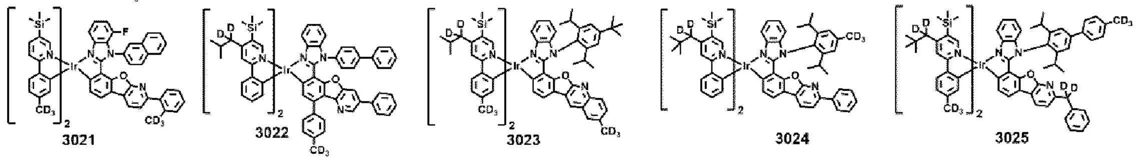

3021 3022 3023 3024 3025

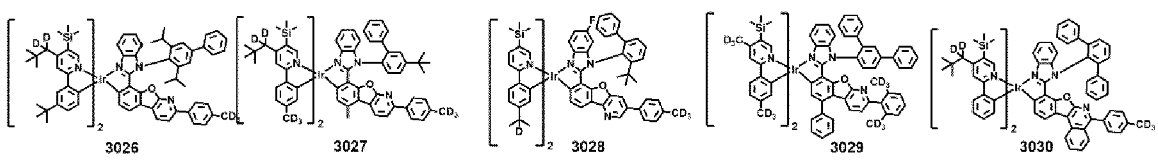

3026 3027 3028 3029 3030

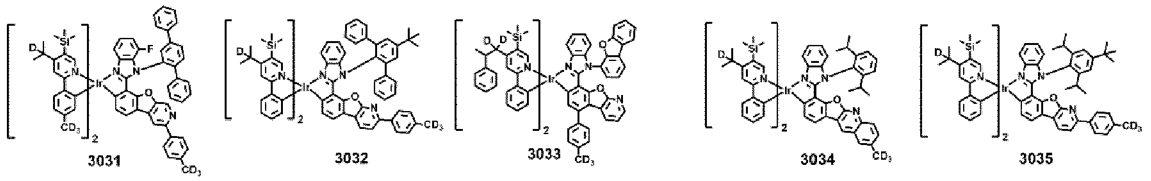

3031 3032 3033 3034 3035

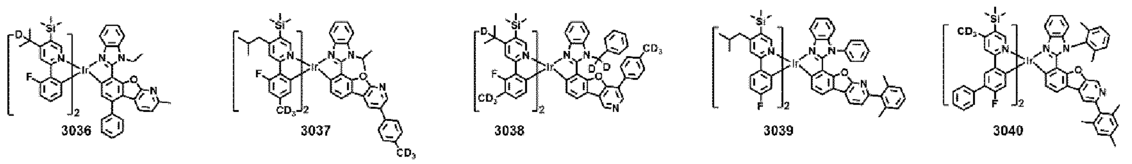

3036 3037 3038 3039 3040

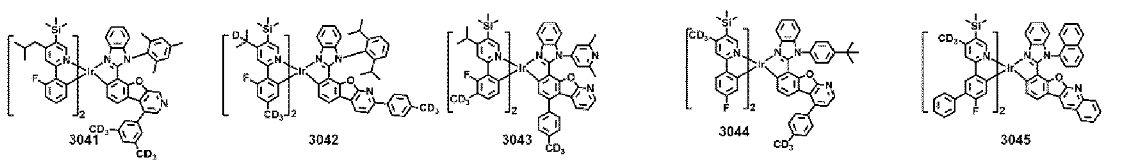

3041 3042 3043 3044 3045

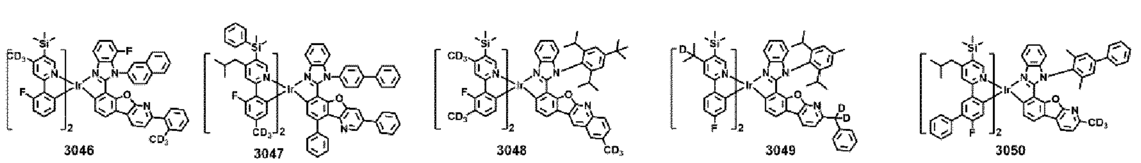

3046 3047 3048 3049 3050

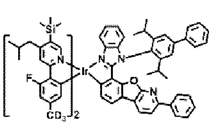
3051
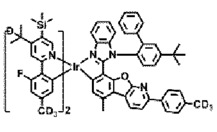
3052
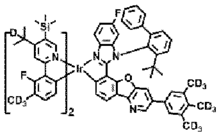
3053
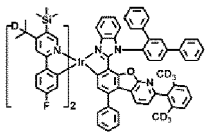
3054
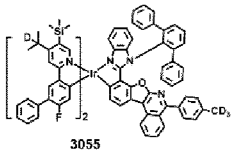
3055

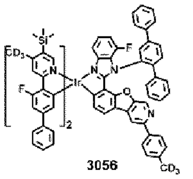
3056
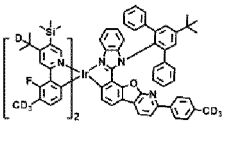
3057
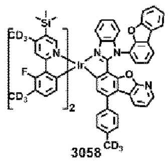
3058
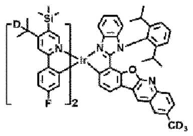
3059
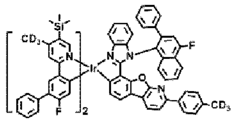
3060

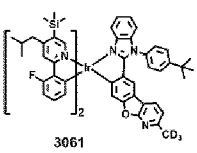
3061
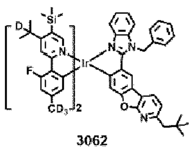
3062
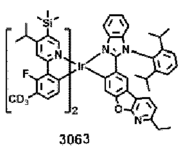
3063
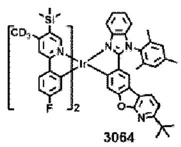
3064
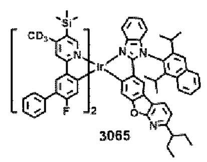
3065

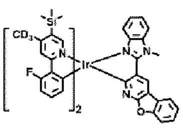
3066
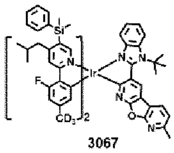
3067
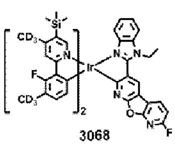
3068
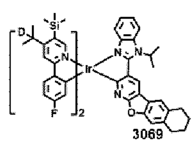
3069
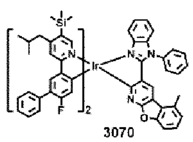
3070

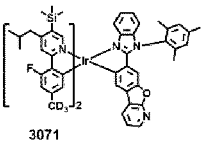
3071
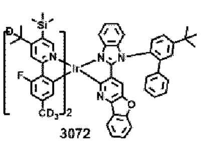
3072
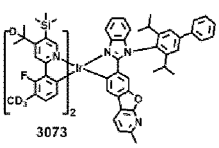
3073
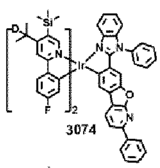
3074
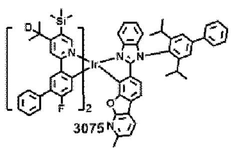
3075

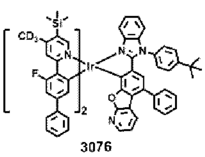
3076
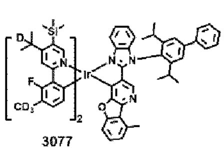
3077
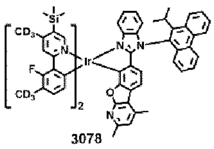
3078
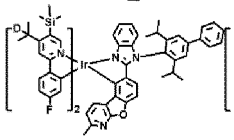
3079
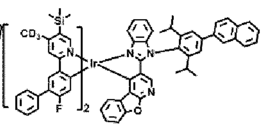
3080

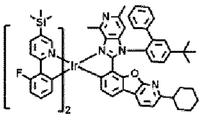
3081
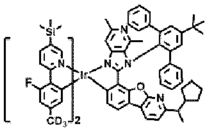
3082
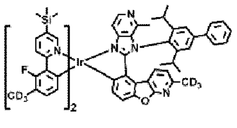
3083
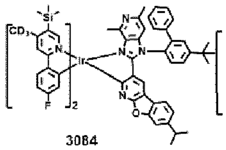
3084
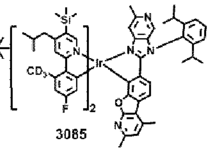
3085

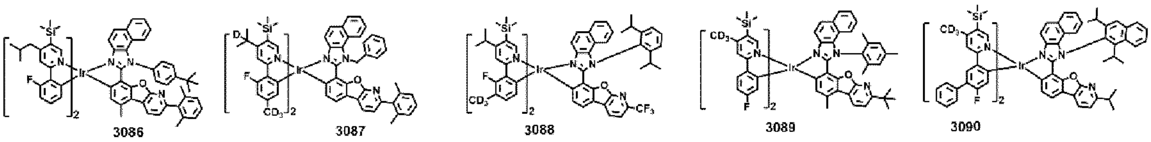
3086
3087
3088
3089
3090

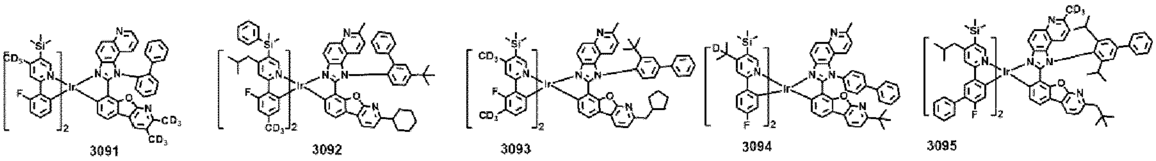
3091
3092
3093
3094
3095

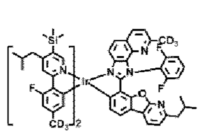
3096
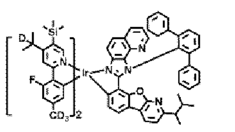
3097
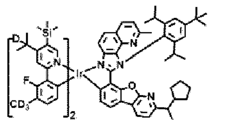
3098
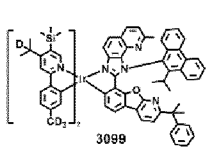
3099
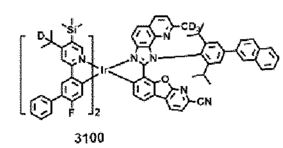
3100

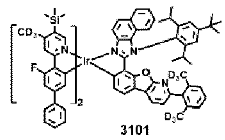
3101
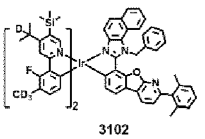
3102
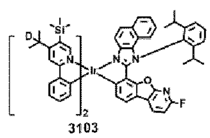
3103
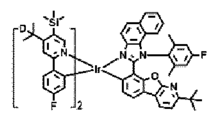
3104
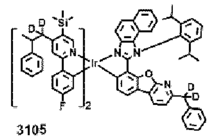
3105

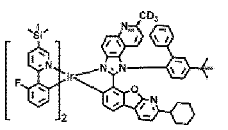
3106
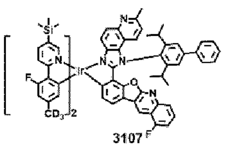
3107
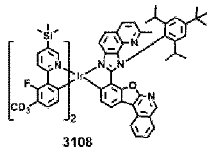
3108
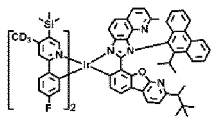
3109
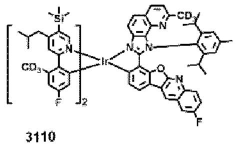
3110

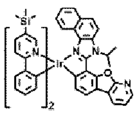
3111
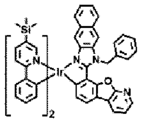
3112
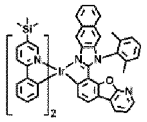
3113
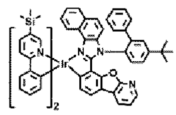
3114
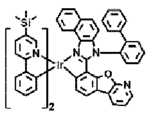
3115

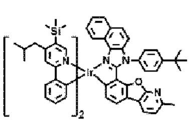
3116
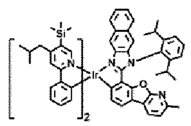
3117
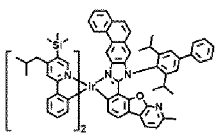
3118
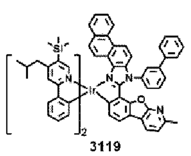
3119
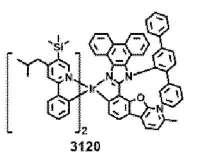
3120

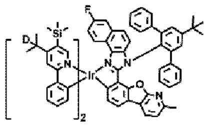
3121
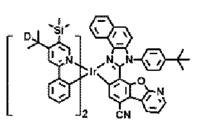
3122
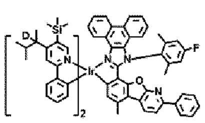
3123
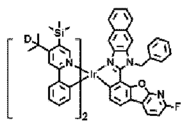
3124
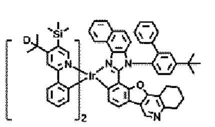
3125

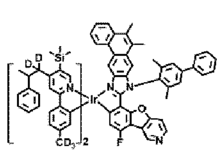
3126
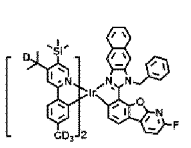
3127
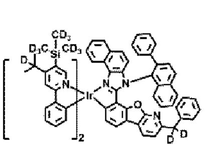
3128
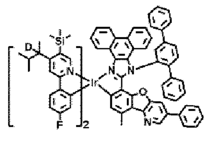
3129
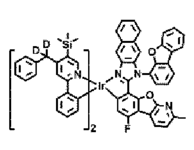
3130

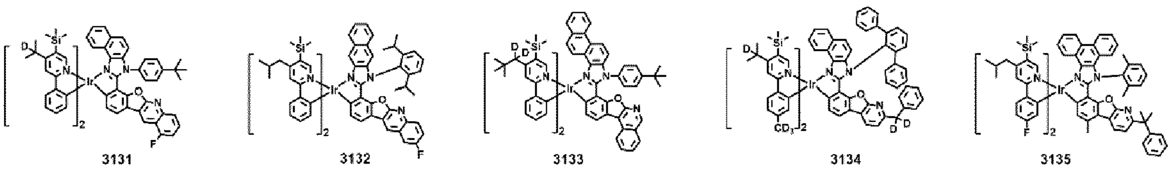
3131
3132
3133
3134
3135

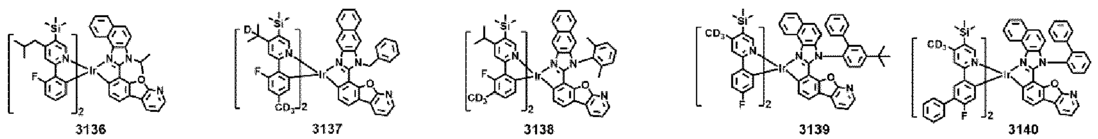
3136
3137
3138
3139
3140

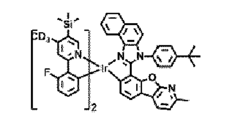
3141

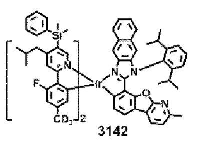
3142

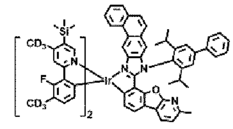
3143

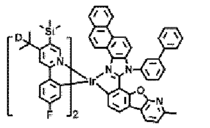
3144

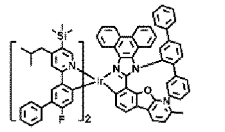
3145

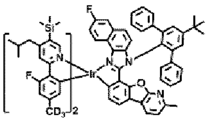
3146

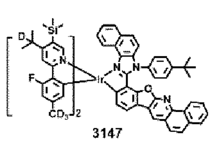
3147

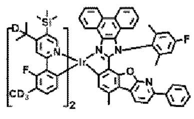
3148

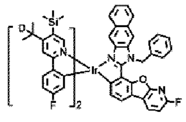
3149

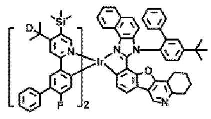
3150

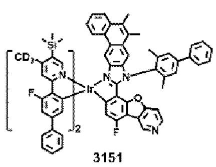
3151

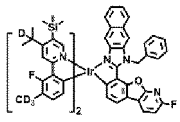
3152

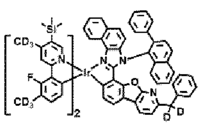
3153

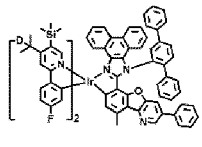
3154

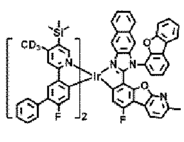
3155

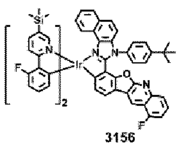
3156

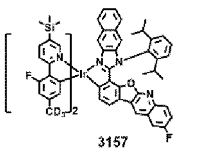
3157

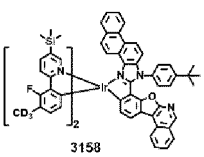
3158

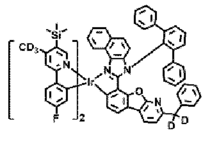
3159

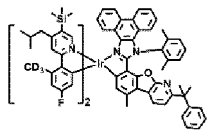
3160

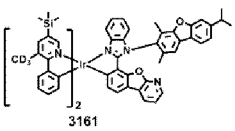
3161

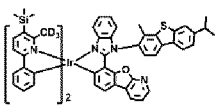
3162

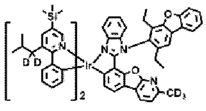
3163

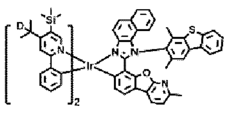
3164

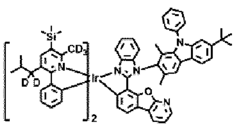
3165

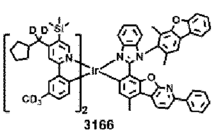
3166

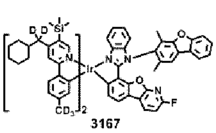
3167

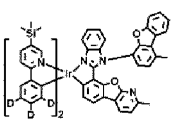
3168

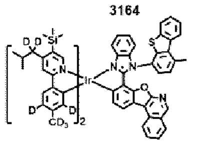
3169

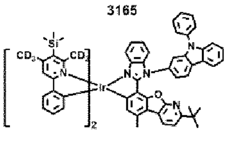
3170

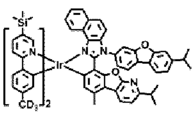
3171

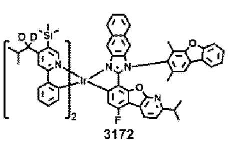
3172

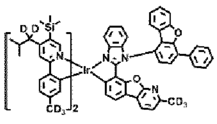
3173

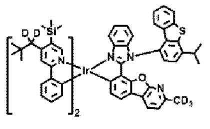
3174

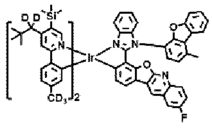
3175

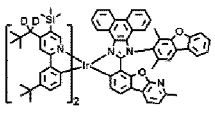
3176

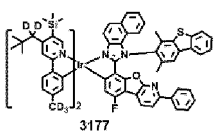
3177

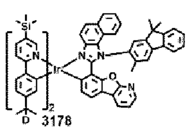
3178

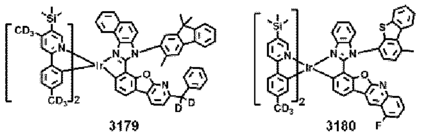
3179

3180

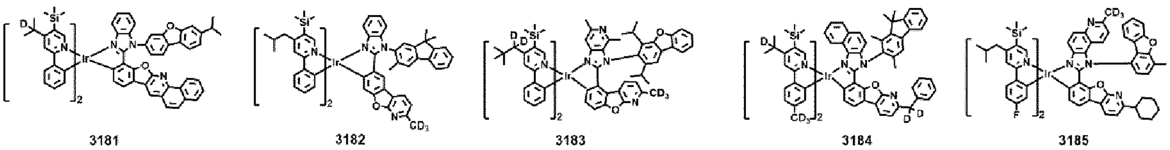
3181

3182

3183

3184

3185

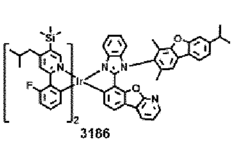
3186
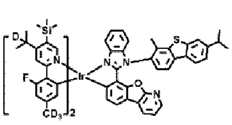
3187
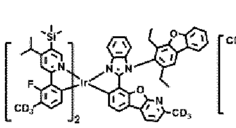
3188
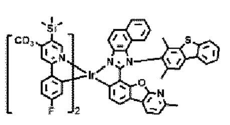
3189
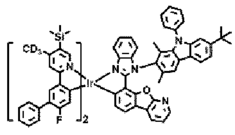
3190

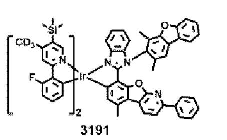
3191
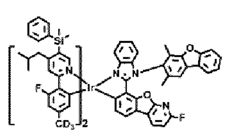
3192
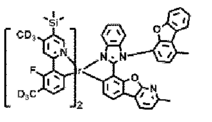
3193
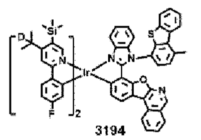
3194
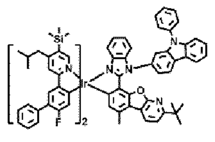
3195

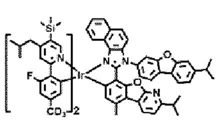
3196
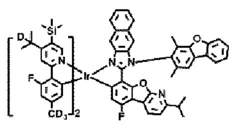
3197
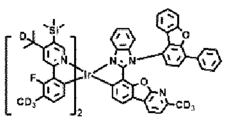
3198
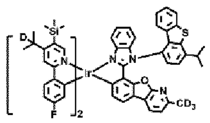
3199
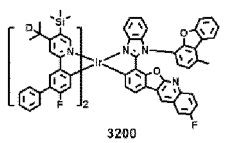
3200

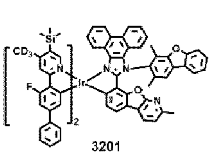
3201
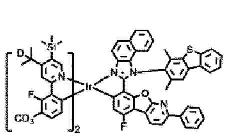
3202
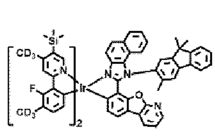
3203
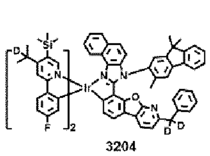
3204
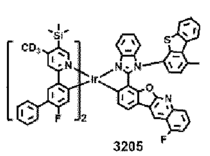
3205

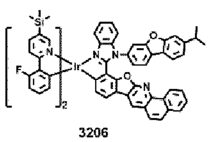
3206
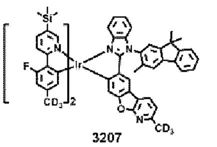
3207
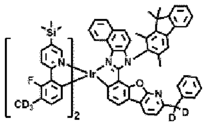
3208
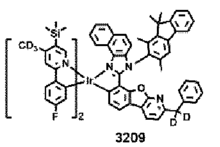
3209
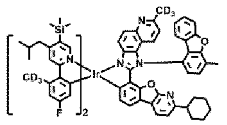
3210

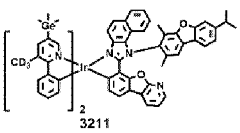
3211
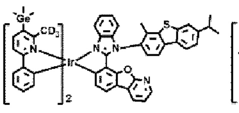
3212
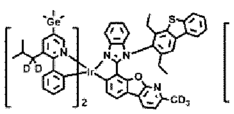
3213
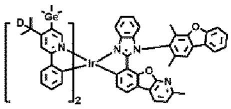
3214
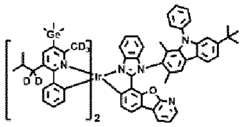
3215

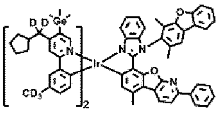
3216
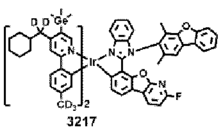
3217
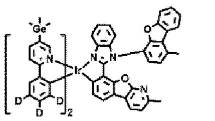
3218
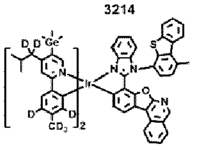
3219
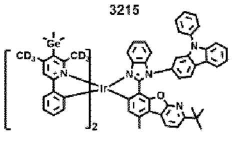
3220

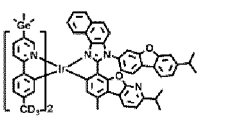
3221
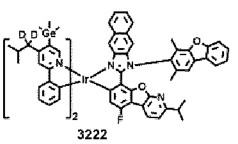
3222
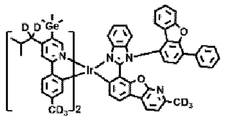
3223
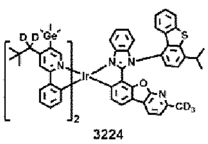
3224
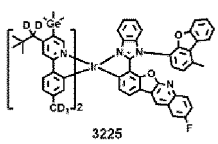
3225

3226
3227
3228
3229
3230

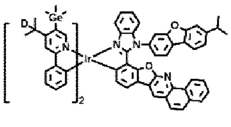
3231
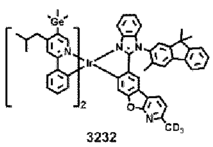
3232
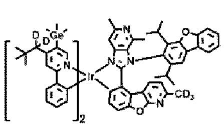
3233
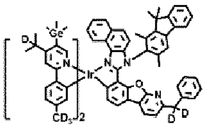
3234
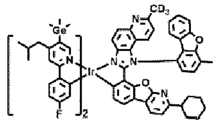
3235

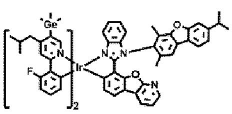
3236
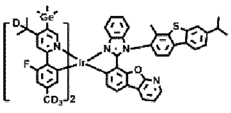
3237
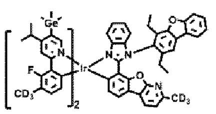
3238
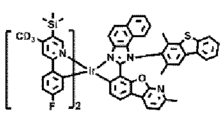
3239
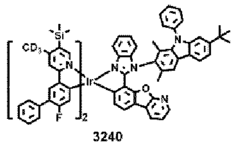
3240

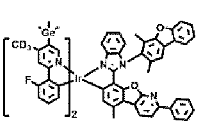
3241
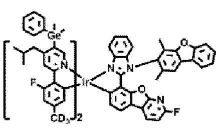
3242
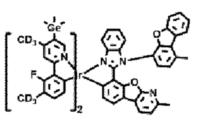
3243
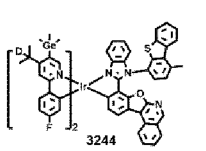
3244
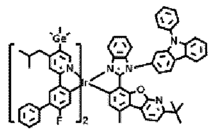
3245

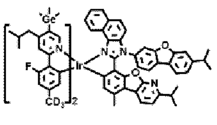
3246
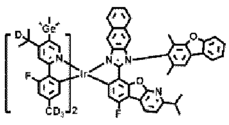
3247
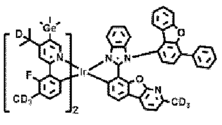
3248
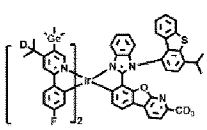
3249
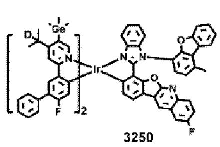
3250

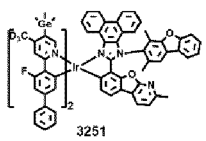
3251
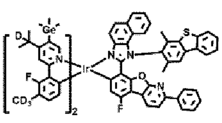
3252
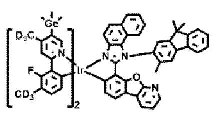
3253
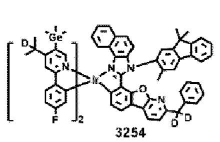
3254
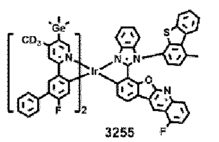
3255

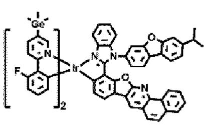
3256
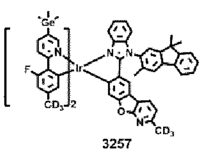
3257
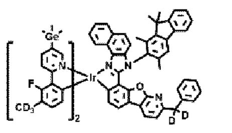
3258
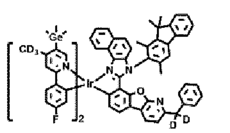
3259
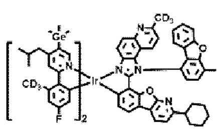
3260

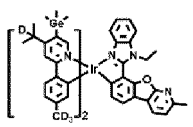
3261
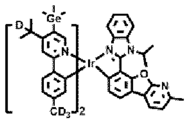
3262
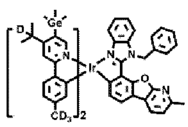
3263
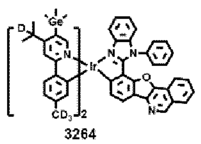
3264
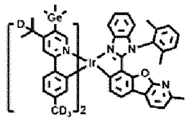
3265

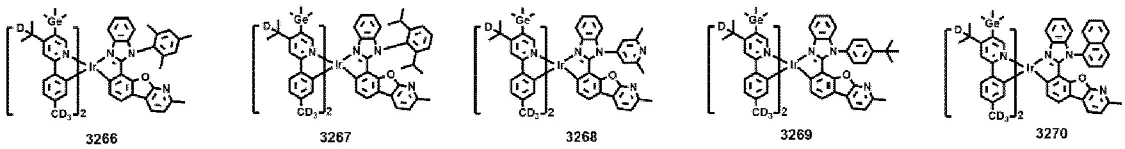
3266
3267
3268
3269
3270

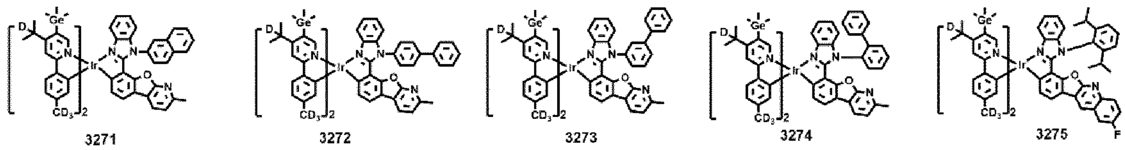
3271
3272
3273
3274
3275

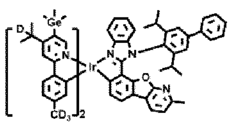
3276

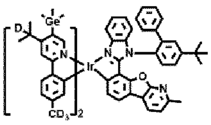
3277

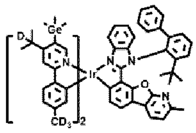
3278

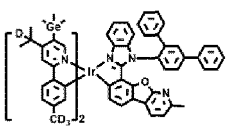
3279

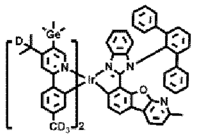
3280

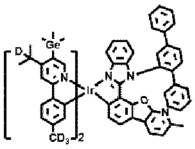
3281

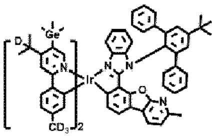
3282

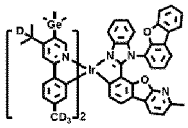
3283

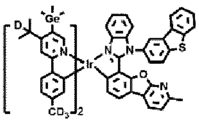
3284

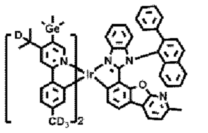
3285

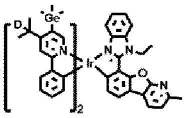
3286

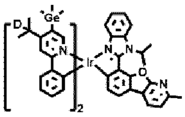
3287

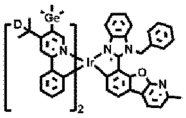
3288

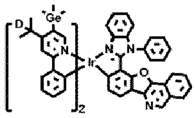
3289

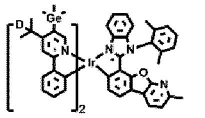
3290

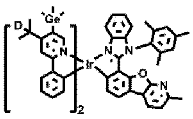
3291

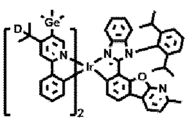
3292

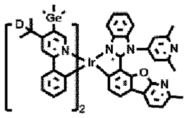
3293

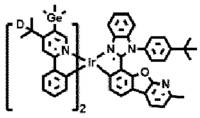
3294

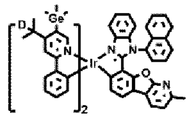
3295

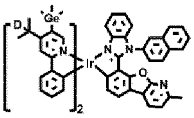
3296

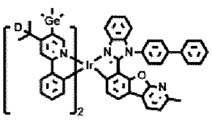
3297

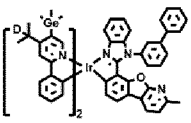
3298

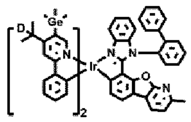
3299

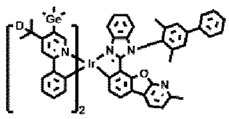
3300

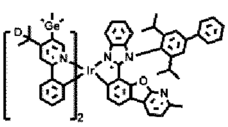
3301

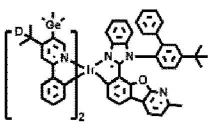
3302

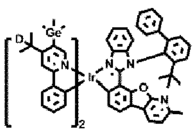
3303

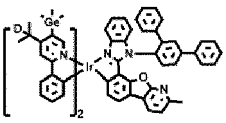
3304

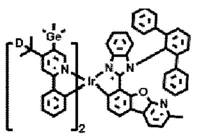
3305

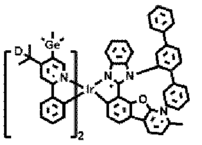
3306

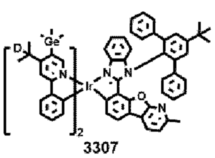
3307

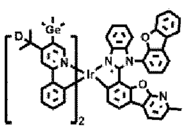
3308

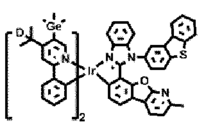
3309

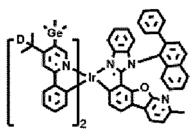
3310

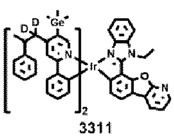
3311

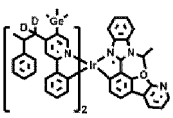
3312

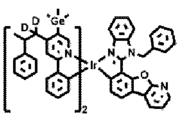
3313

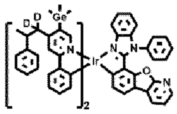
3314

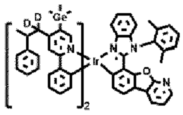
3315

3316

3317

3318

3319

3320

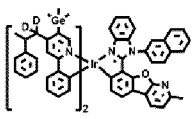
3321

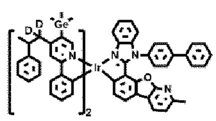
3322

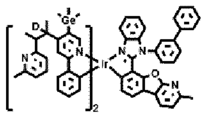
3323

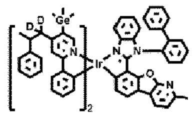
3324

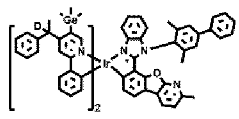
3325

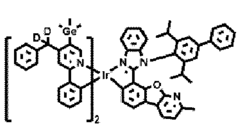
3326

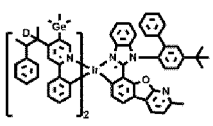
3327

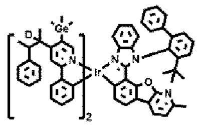
3328

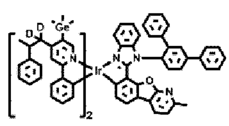
3329

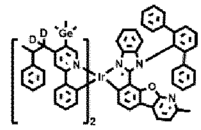
3330

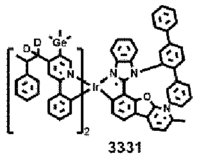
3331

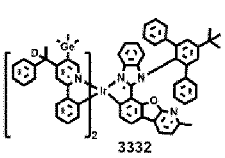
3332

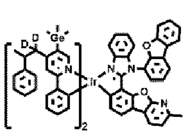
3333

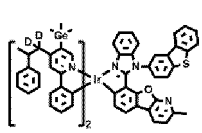
3334

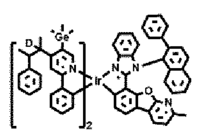
3335

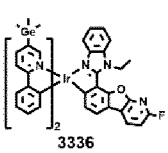
3336

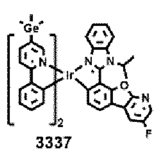
3337

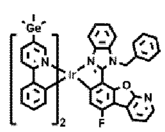
3338

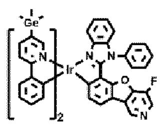
3339

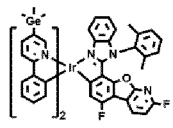
3340

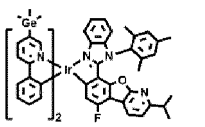
3341

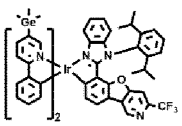
3342

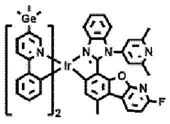
3343

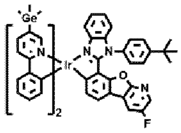
3344

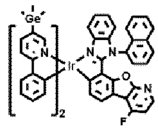
3345

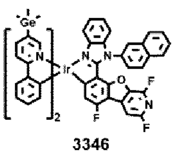
3346

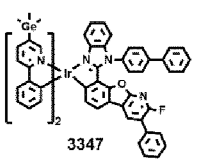
3347

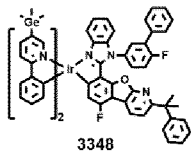
3348

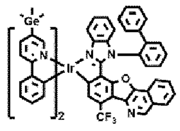
3349

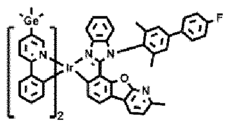
3350

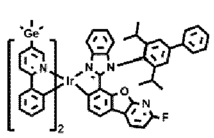
3351

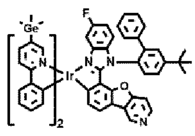
3352

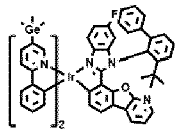
3353

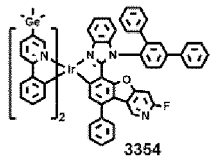
3354

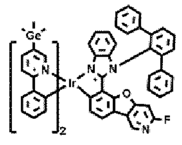
3355

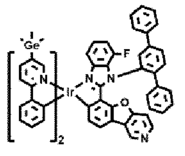
3356

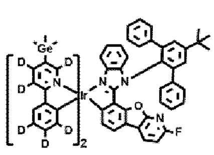
3357

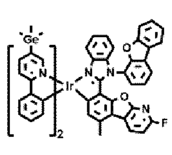
3358

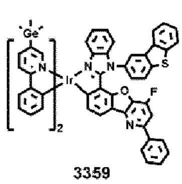
3359

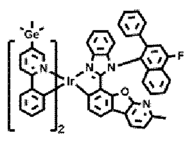
3360

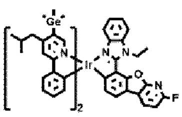
3361
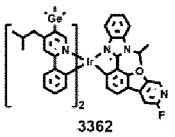
3362
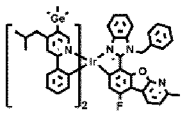
3363
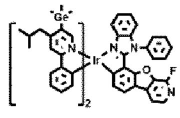
3364
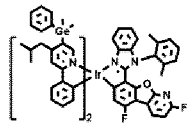
3365

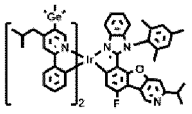
3366
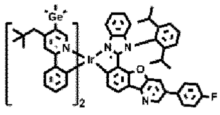
3367
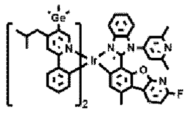
3368
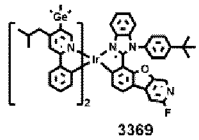
3369
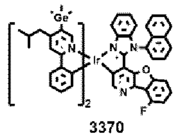
3370

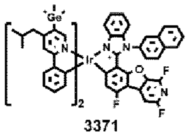
3371
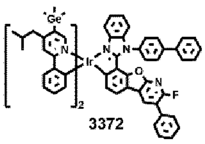
3372
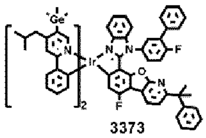
3373
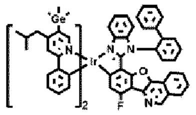
3374
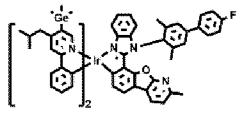
3375

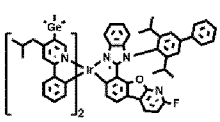
3376
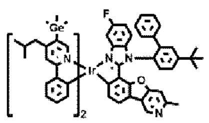
3377
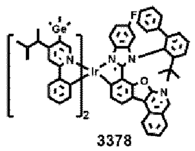
3378
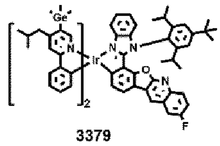
3379
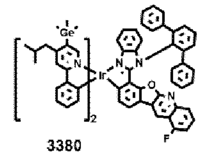
3380

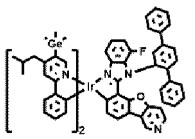
3381
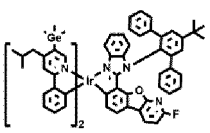
3382
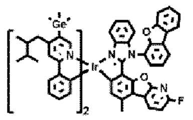
3383
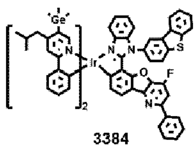
3384
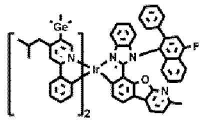
3385

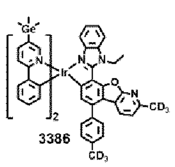
3386
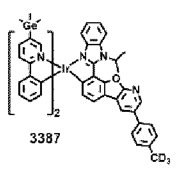
3387
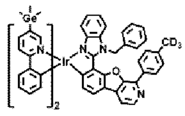
3388
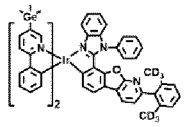
3389
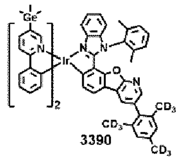
3390

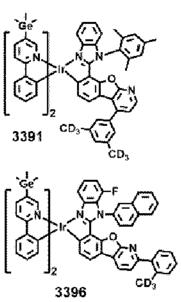
3391
3396
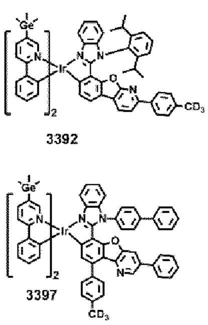
3392
3397
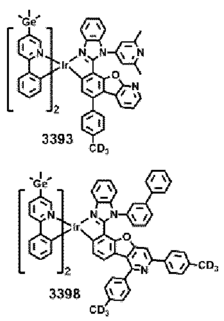
3393
3398
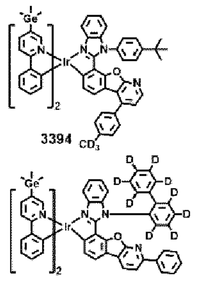
3394
3399
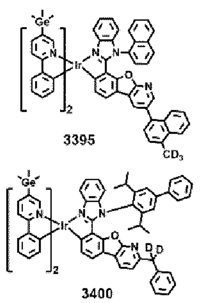
3395
3400

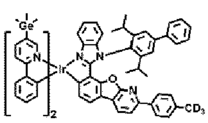
3401
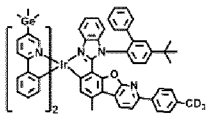
3402
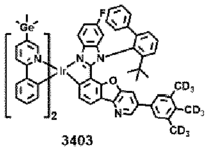
3403
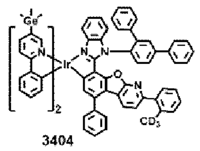
3404
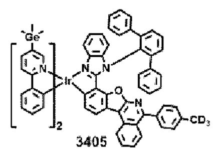
3405

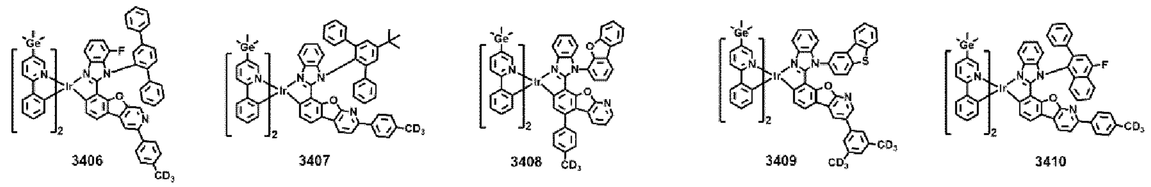

3406 3407 3408 3409 3410

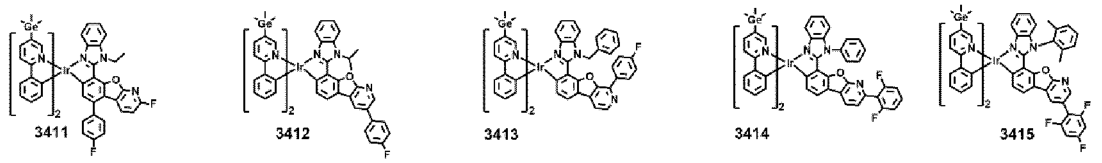

3411 3412 3413 3414 3415

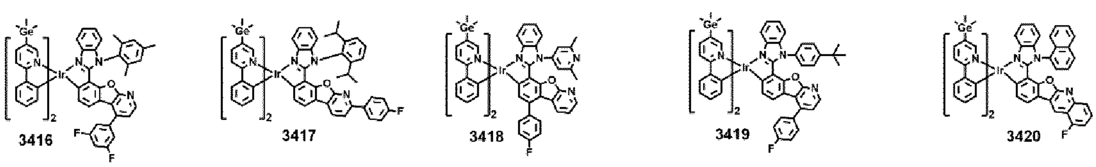

3416 3417 3418 3419 3420

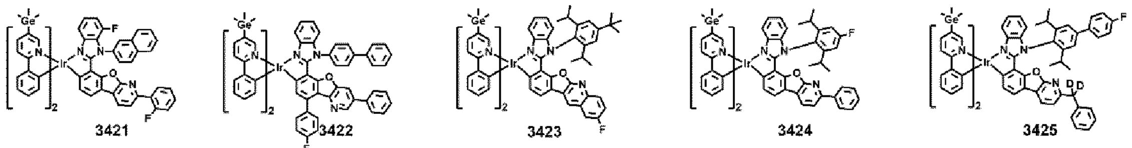

3421 3422 3423 3424 3425

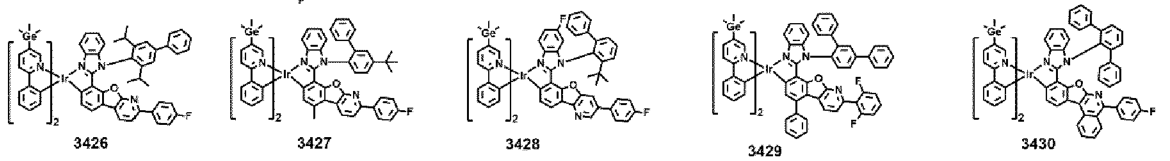

3426 3427 3428 3429 3430

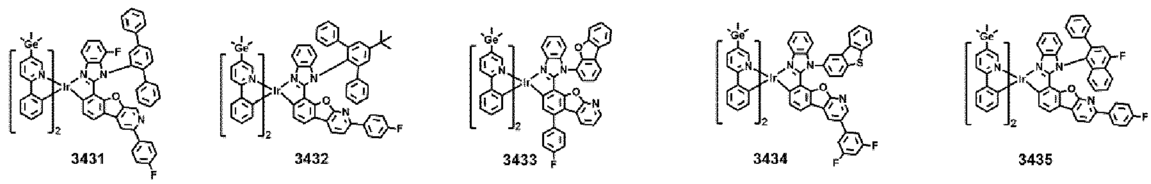

3431 3432 3433 3434 3435

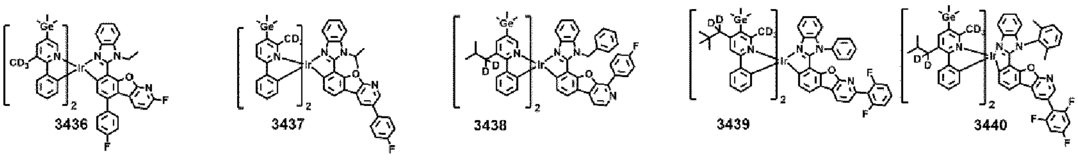

3436 3437 3438 3439 3440

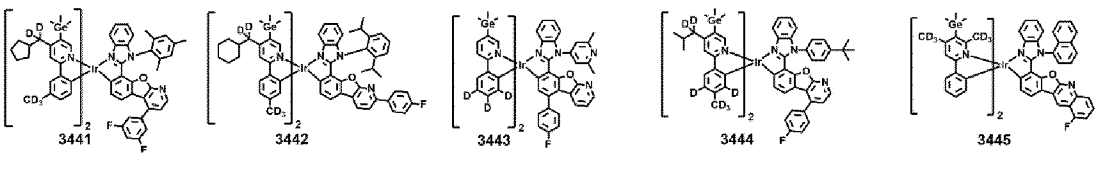

3441 3442 3443 3444 3445

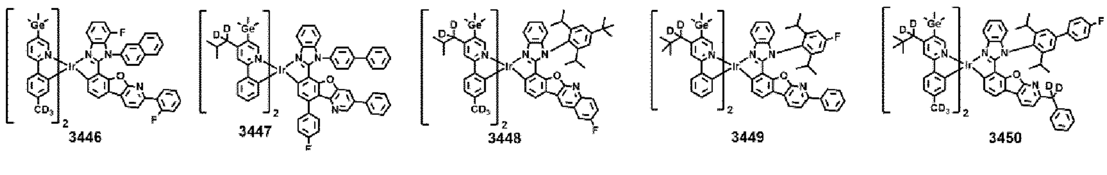

3446 3447 3448 3449 3450

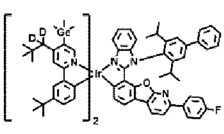
3451

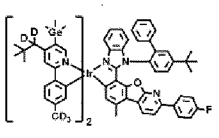
3452

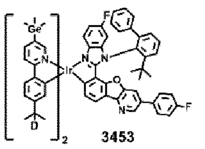
3453

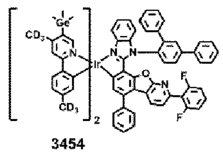
3454

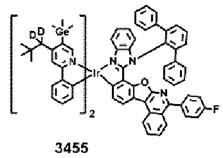
3455

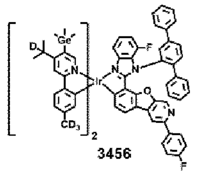
3456

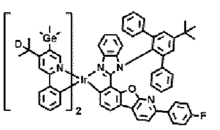
3457

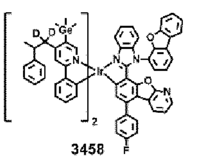
3458

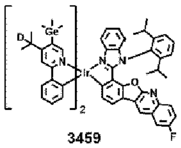
3459

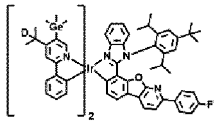
3460

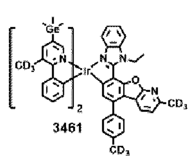
3461

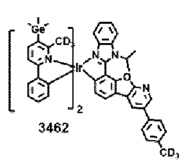
3462

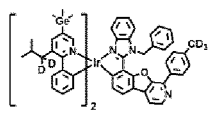
3463

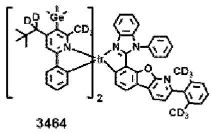
3464

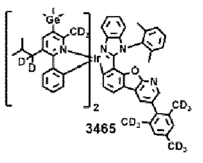
3465

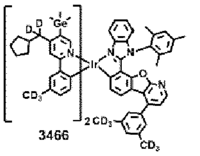
3466

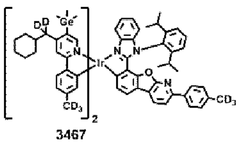
3467

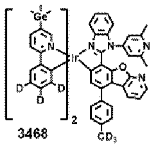
3468

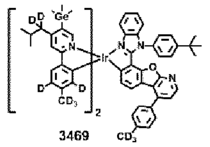
3469

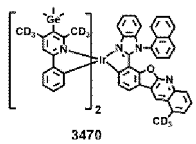
3470

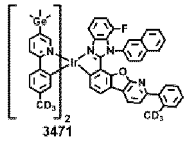
3471

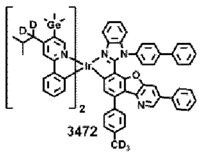
3472

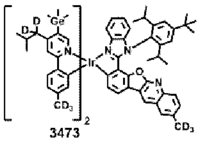
3473

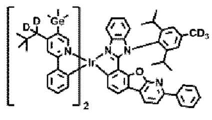
3474

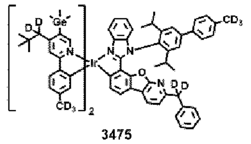
3475

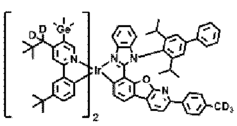
3476

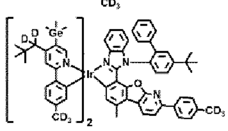
3477

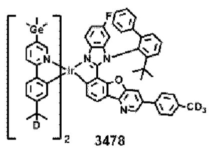
3478

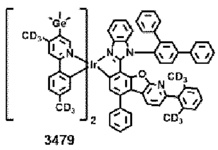
3479

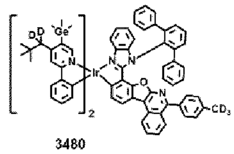
3480

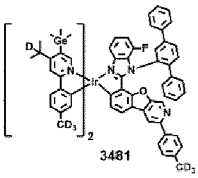
3481

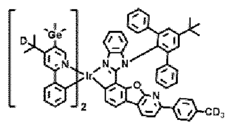
3482

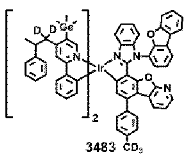
3483

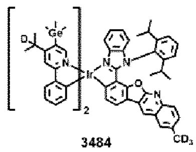
3484

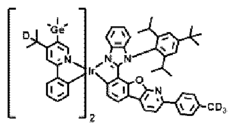
3485

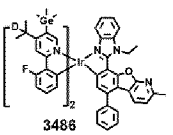
3486

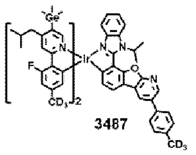
3487

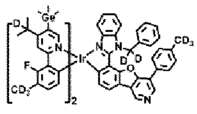
3488

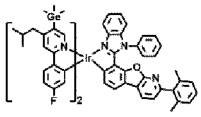
3489

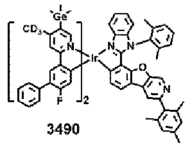
3490

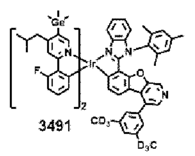
3491
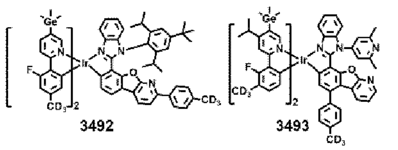
3492
3493
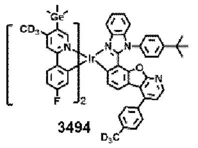
3494
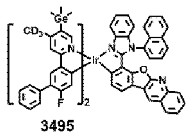
3495

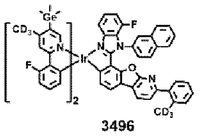
3496
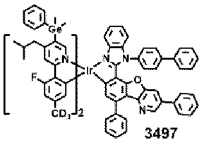
3497
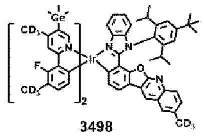
3498
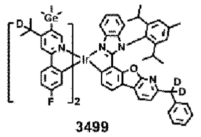
3499
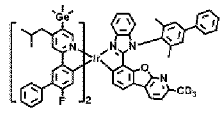
3500

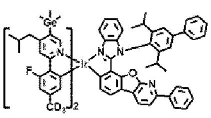
3501
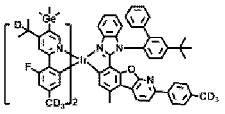
3502
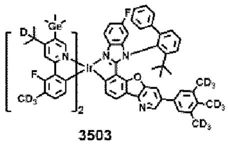
3503
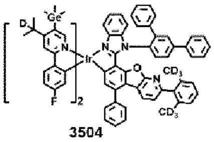
3504
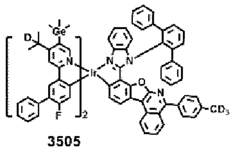
3505

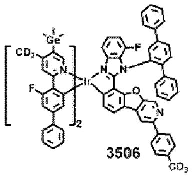
3506
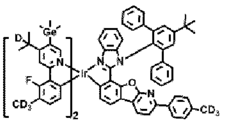
3507
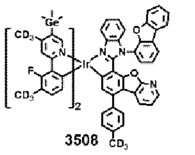
3508
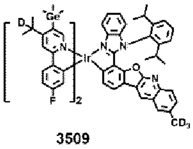
3509
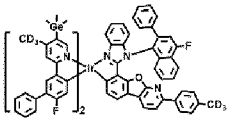
3510

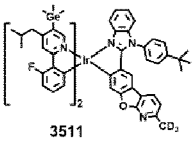
3511
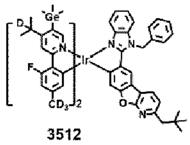
3512
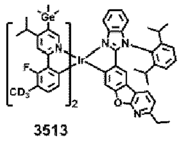
3513
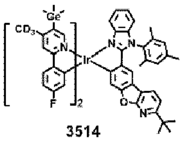
3514
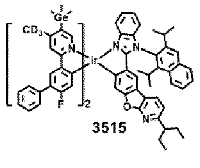
3515

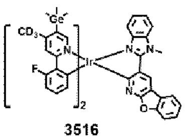
3516
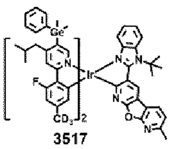
3517
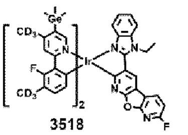
3518
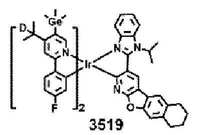
3519
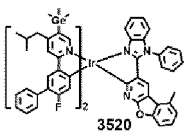
3520

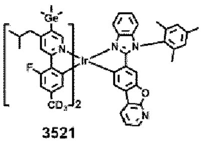
3521
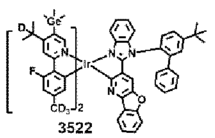
3522
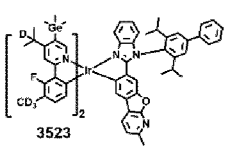
3523
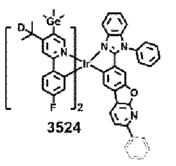
3524
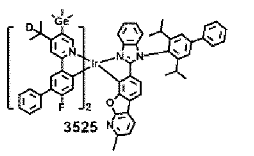
3525

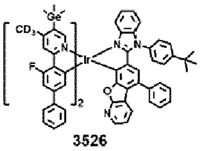
3526
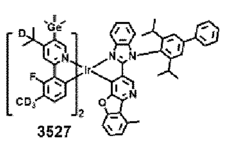
3527
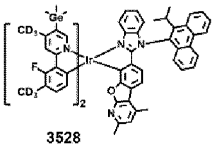
3528
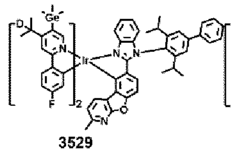
3529
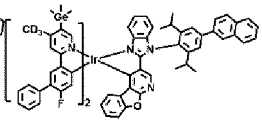
3530

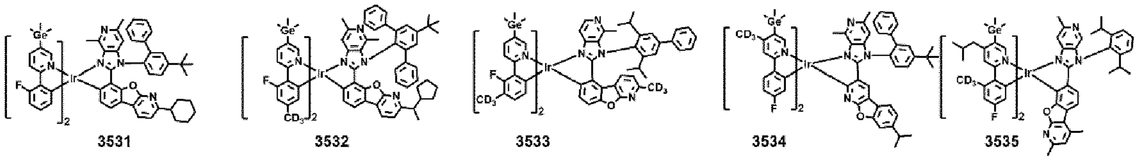
3531
3532
3533
3534
3535

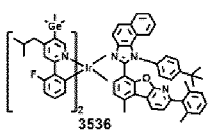
3536
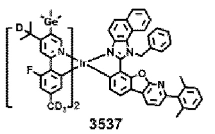
3537
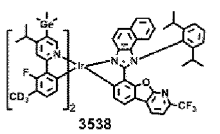
3538
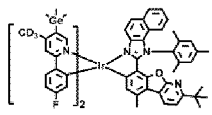
3539
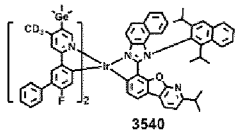
3540

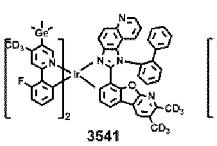
3541
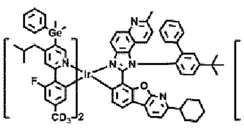
3542
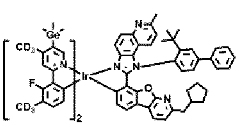
3543
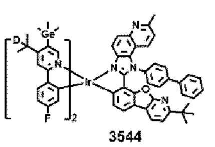
3544
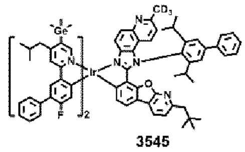
3545

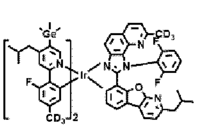
3546
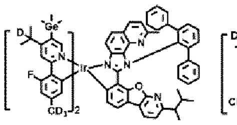
3547
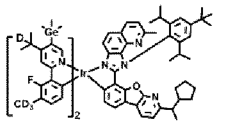
3548
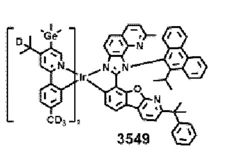
3549
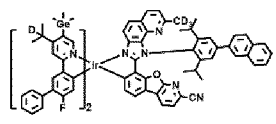
3550

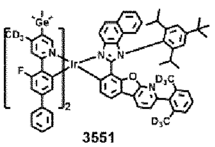
3551
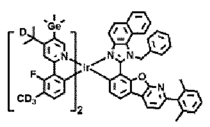
3552
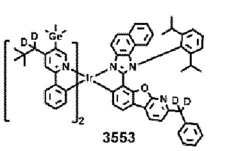
3553
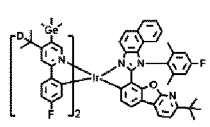
3554
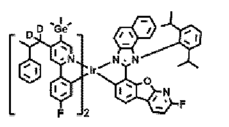
3555

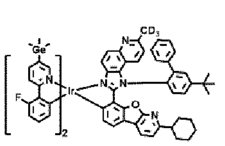
3556
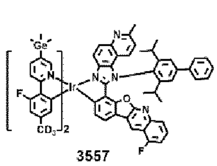
3557
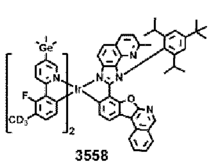
3558
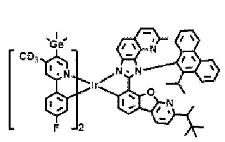
3559
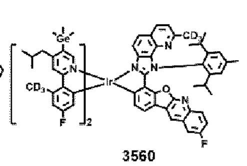
3560

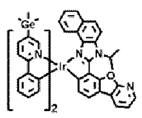
3561
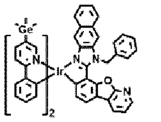
3562
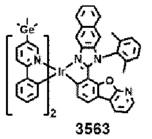
3563
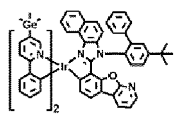
3564
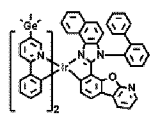
3565

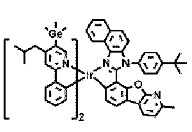
3566
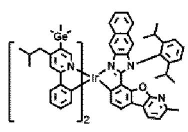
3567
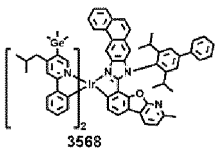
3568
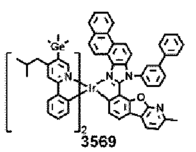
3569
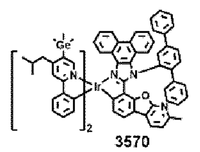
3570

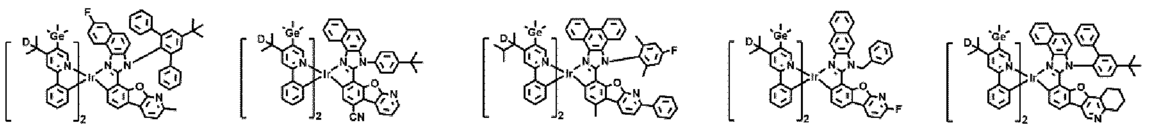
3571
3572
3573
3574
3575

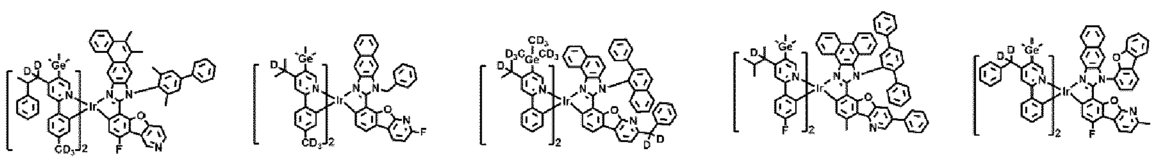
3576
3577
3578
3579
3580

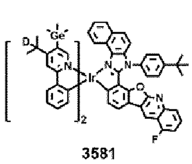
3581
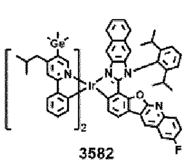
3582
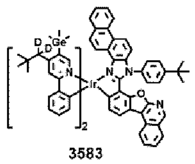
3583
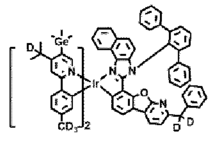
3584
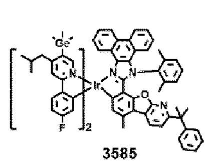
3585
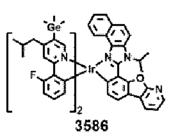
3586
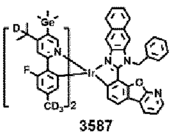
3587
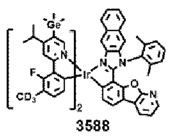
3588
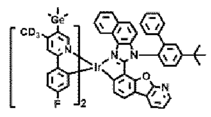
3589
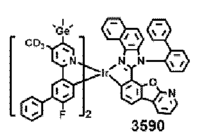
3590
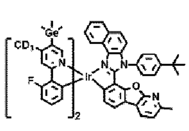
3591
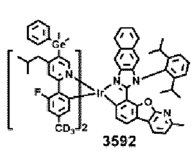
3592
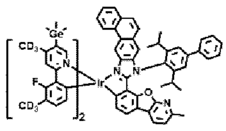
3593
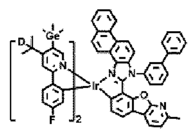
3594
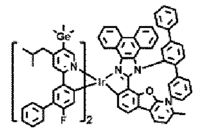
3595
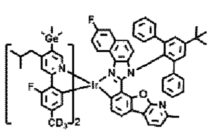
3596
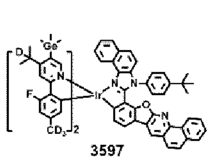
3597
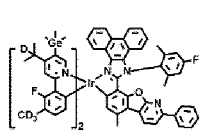
3598
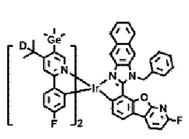
3599
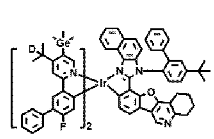
3600
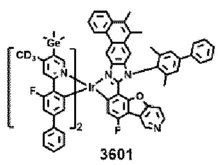
3601
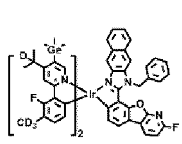
3602
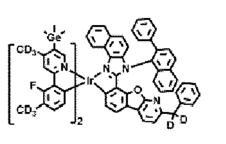
3603
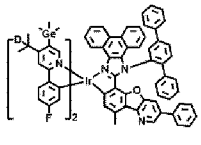
3604
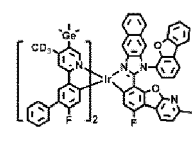
3605
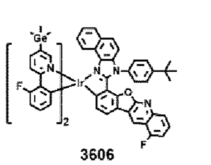
3606
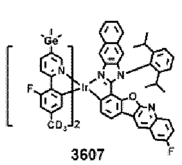
3607
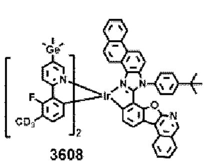
3608
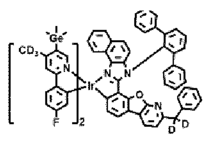
3609
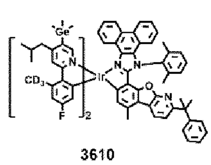
3610
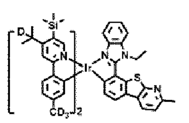
3611
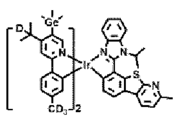
3612
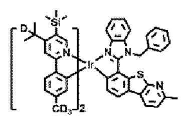
3613
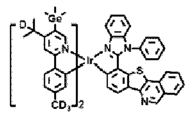
3614
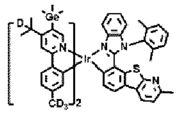
3615
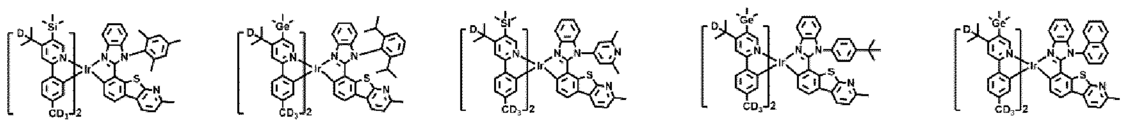
3616 3617 3618 3619 3620
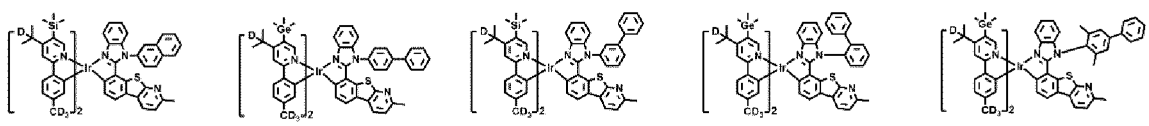
3621 3622 3623 3624 3625

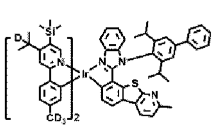
3626

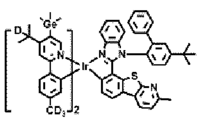
3627

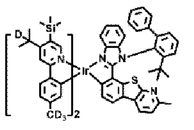
3628

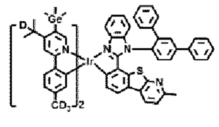
3629

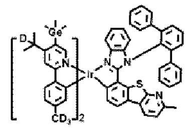
3630

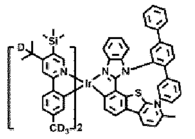
3631

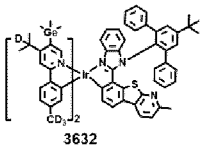
3632

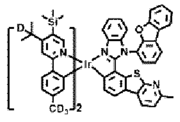
3633

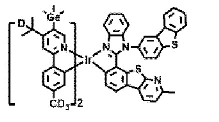
3634

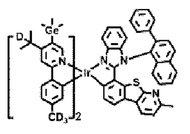
3635

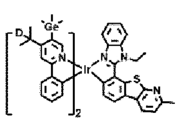
3636

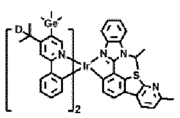
3637

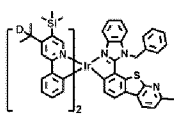
3638

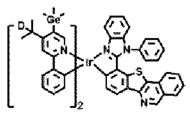
3639

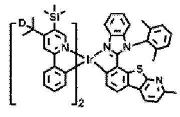
3640

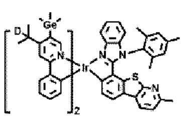
3641

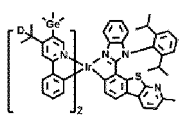
3642

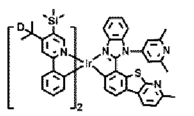
3643

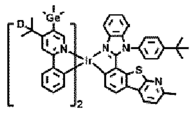
3644

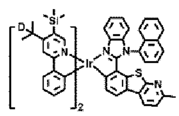
3645

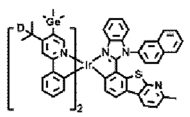
3646

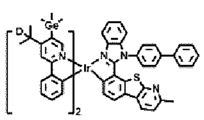
3647

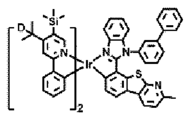
3648

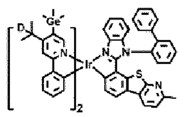
3649

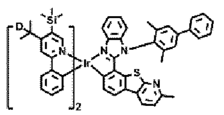
3650

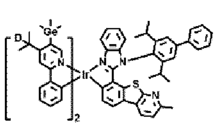
3651

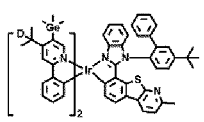
3652

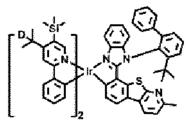
3653

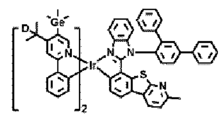
3654

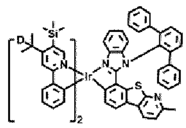
3655

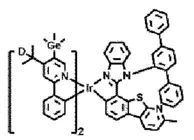
3656

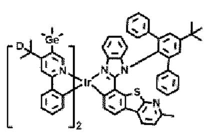
3657

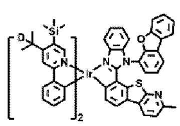
3658

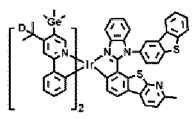
3659

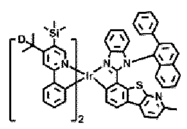
3660

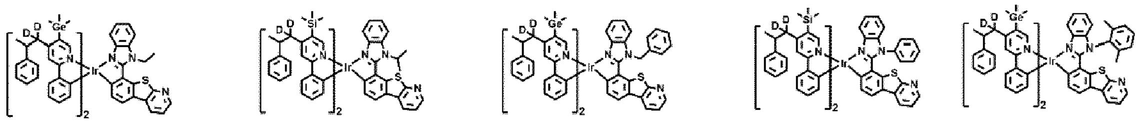
3661 3662 3663 3664 3665

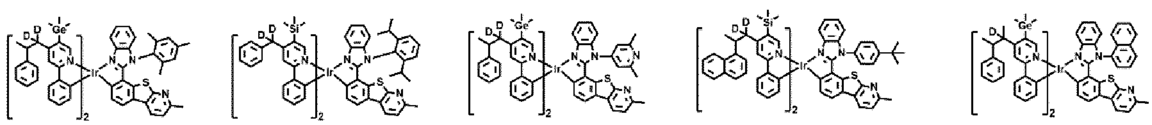
3666 3667 3668 3669 3670

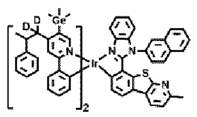
3671
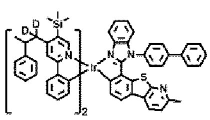
3672
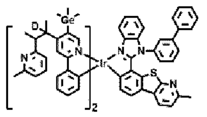
3673
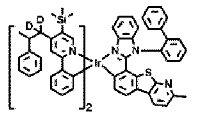
3674
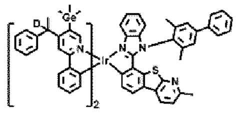
3675

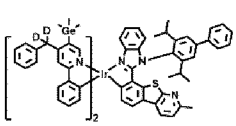
3676
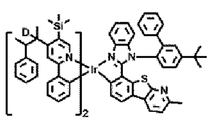
3677
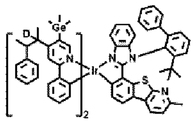
3678
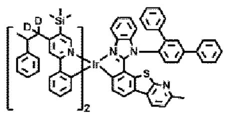
3679
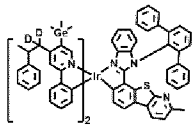
3680

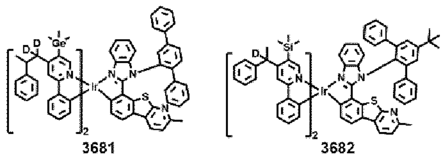
3681
3682
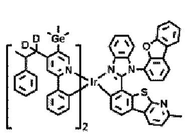
3683
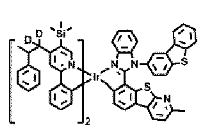
3684
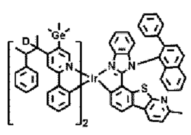
3685

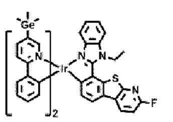
3686
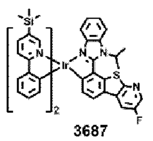
3687
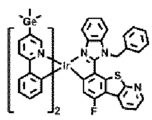
3688
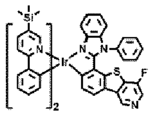
3689
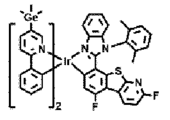
3690

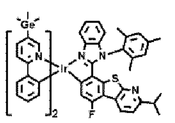
3691
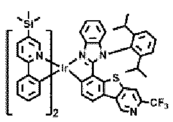
3692
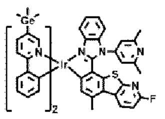
3693
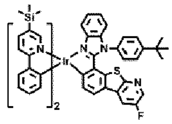
3694
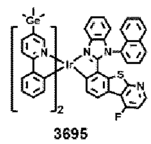
3695

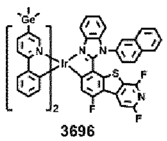
3696
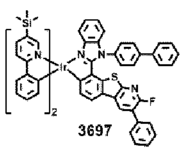
3697
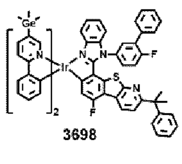
3698
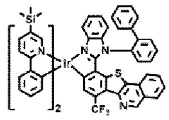
3699
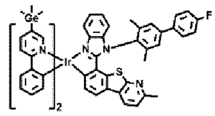
3700

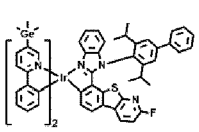
3701
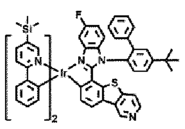
3702
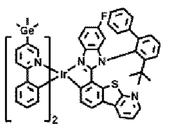
3703
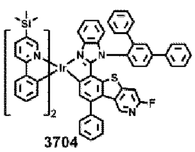
3704
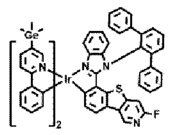
3705

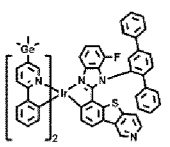
3706
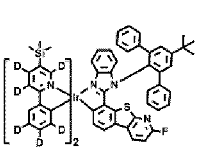
3707
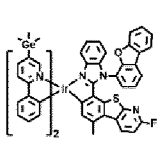
3708
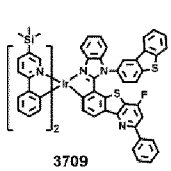
3709
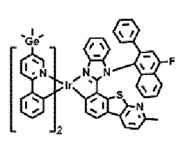
3710

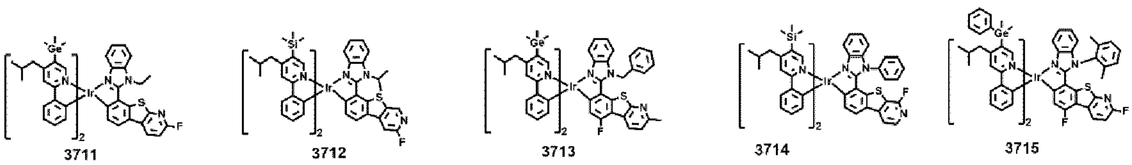
3711
3712
3713
3714
3715

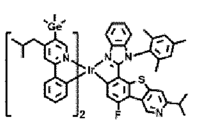
3716
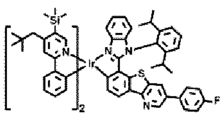
3717
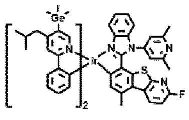
3718
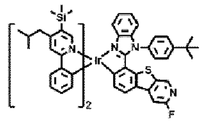
3719
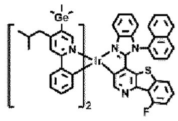
3720

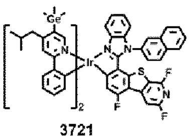
3721
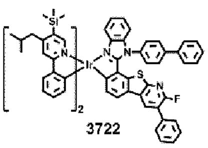
3722
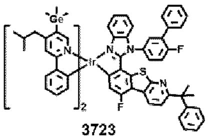
3723
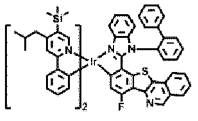
3724
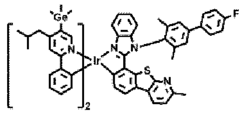
3725

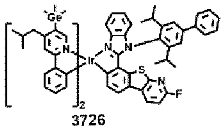
3726
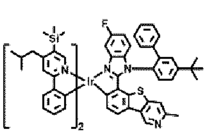
3727
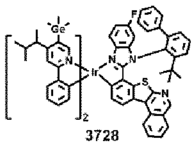
3728
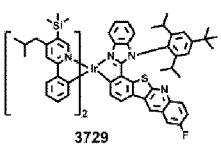
3729
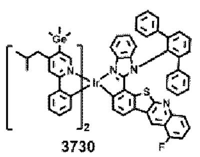
3730

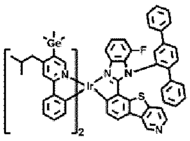
3731
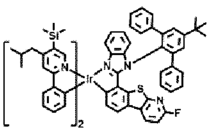
3732
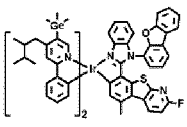
3733
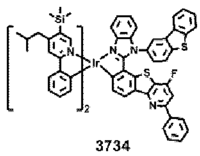
3734
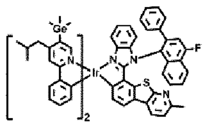
3735

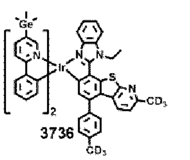
3736
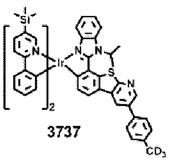
3737
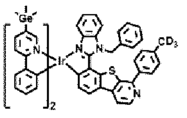
3738
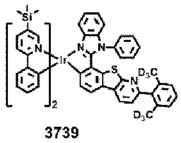
3739
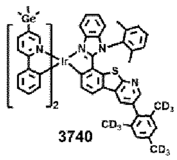
3740

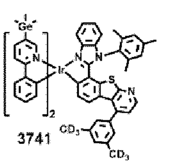
3741
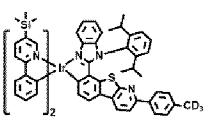
3742
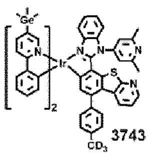
3743
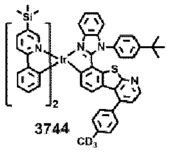
3744
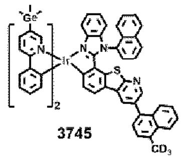
3745

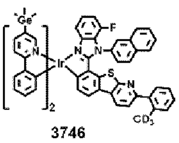
3746
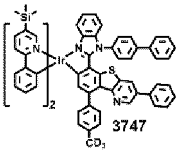
3747
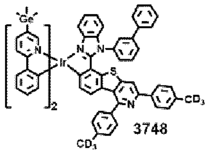
3748
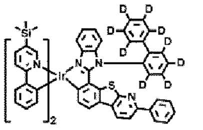
3749
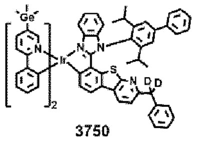
3750

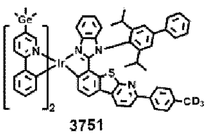
3751
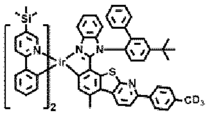
3752
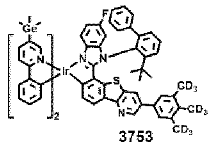
3753
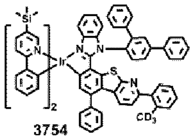
3754
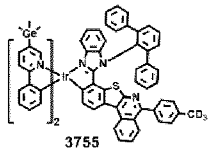
3755

3756
3757
3758
3759
3760

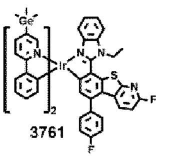
3761

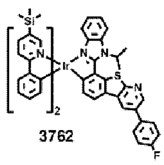
3762

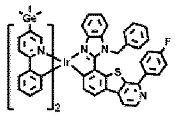
3763

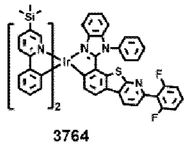
3764

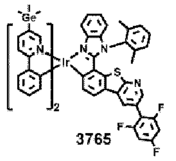
3765

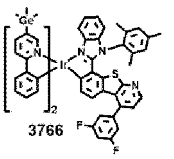
3766

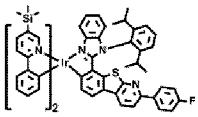
3767

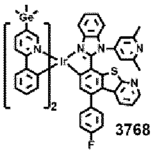
3768

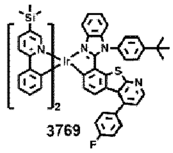
3769

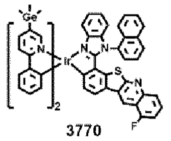
3770

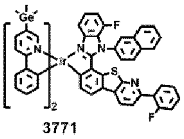
3771

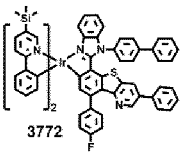
3772

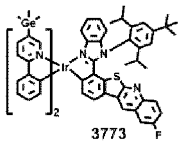
3773

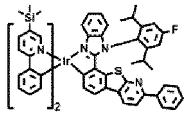
3774

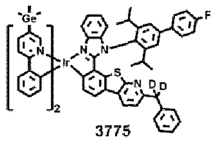
3775

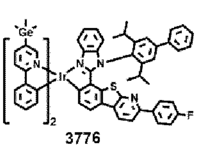
3776

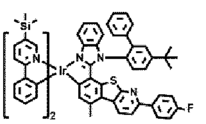
3777

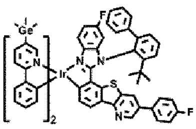
3778

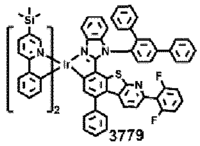
3779

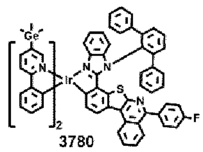
3780

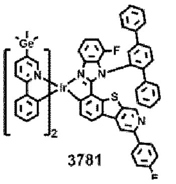
3781

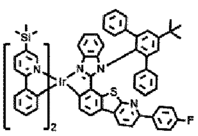
3782

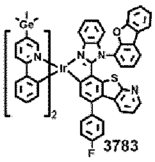
3783

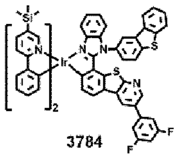
3784

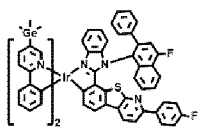
3785

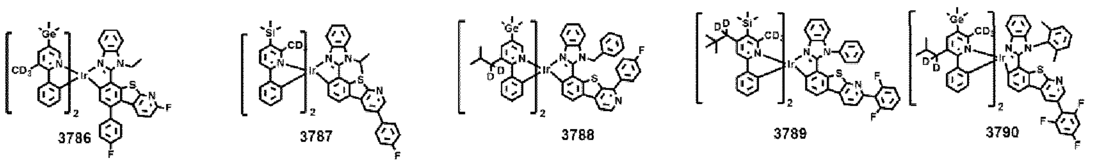
3786 3787 3788 3789 3790

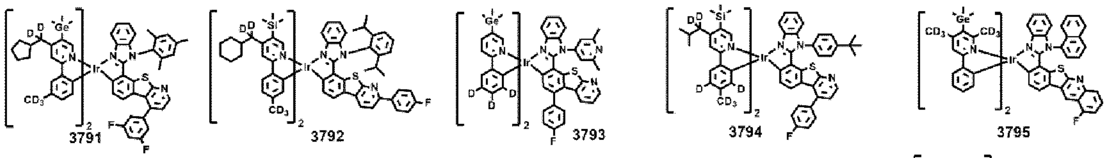
3791 3792 3793 3794 3795

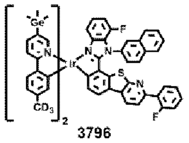
3796

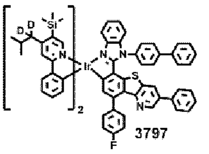
3797

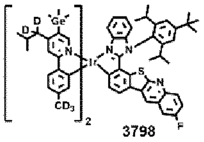
3798

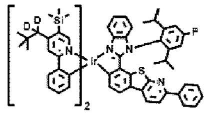
3799

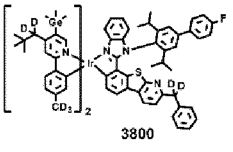
3800

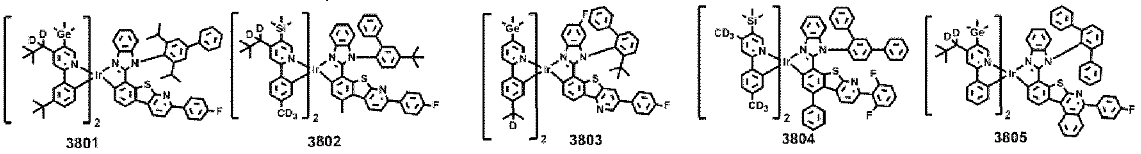
3801 3802 3803 3804 3805

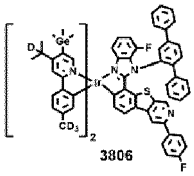
3806

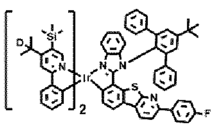
3807

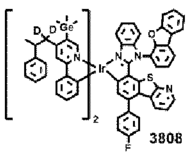
3808

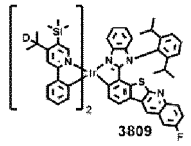
3809

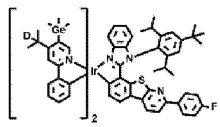
3810

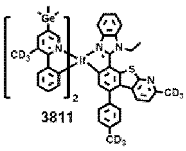
3811

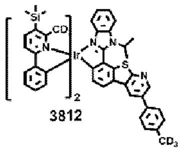
3812

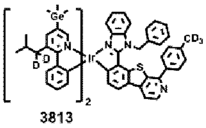
3813

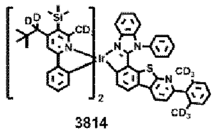
3814

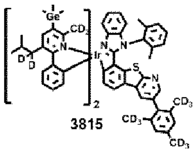
3815

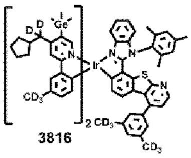
3816

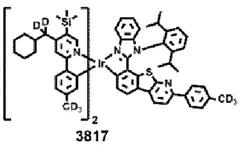
3817

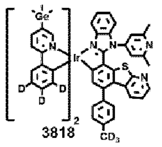
3818

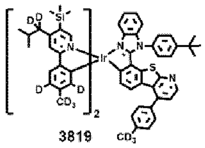
3819

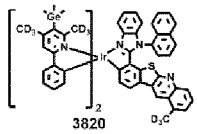
3820

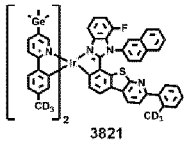
3821

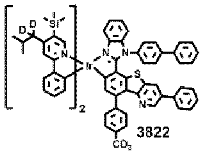
3822

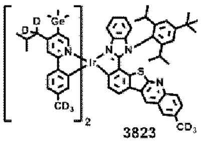
3823

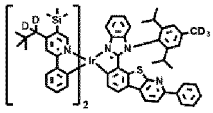
3824

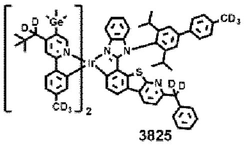
3825

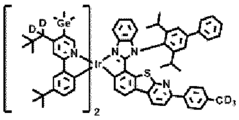
3826

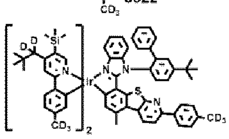
3827

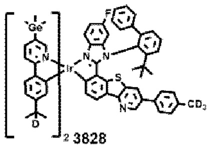
3828

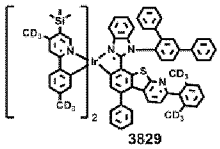
3829

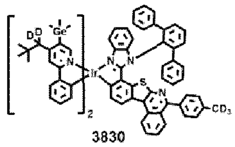
3830

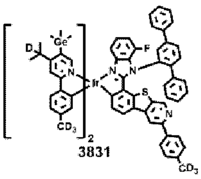
3831

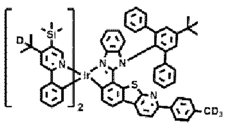
3832

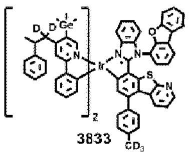
3833

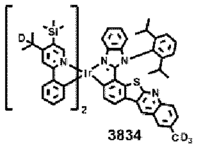
3834

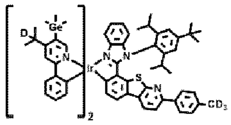
3835

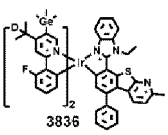
3836

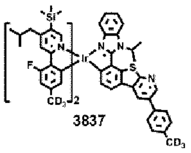
3837

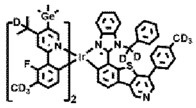
3838

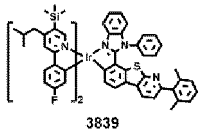
3839

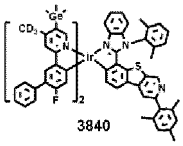
3840

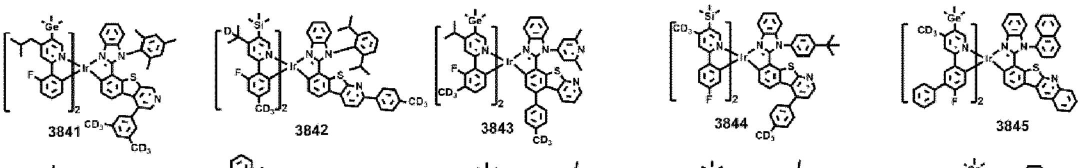
3841 3842 3843 3844 3845

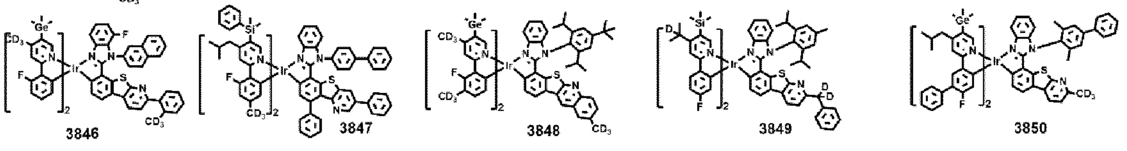
3846 3847 3848 3849 3850

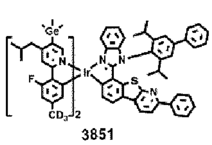
3851
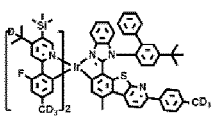
3852
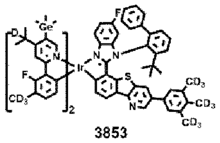
3853
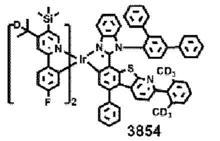
3854
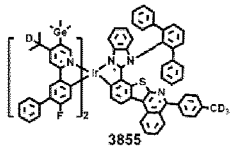
3855

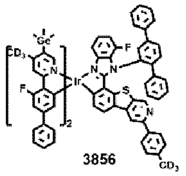
3856
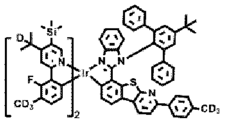
3857
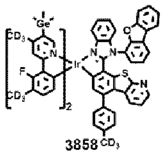
3858
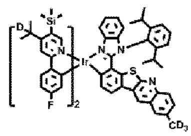
3859
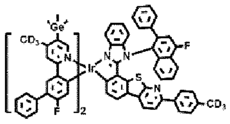
3860

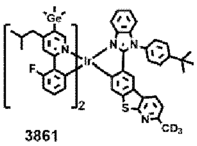
3861
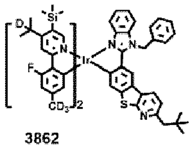
3862
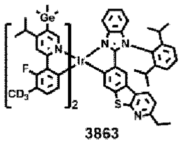
3863
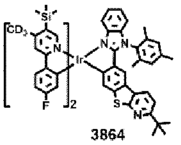
3864
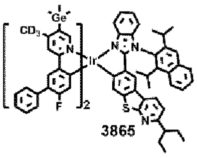
3865

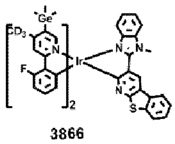
3866
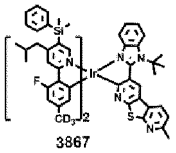
3867
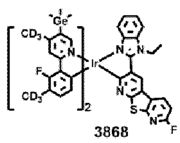
3868
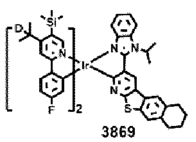
3869
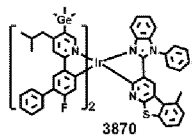
3870

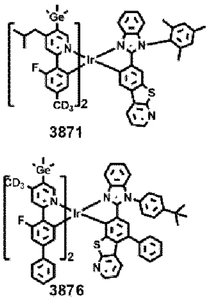
3871
3876
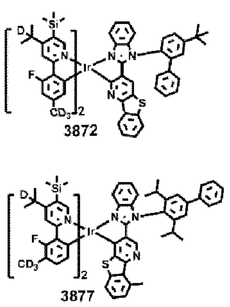
3872
3877
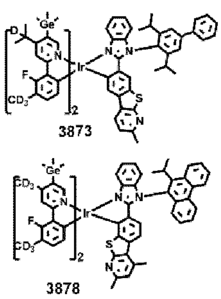
3873
3878
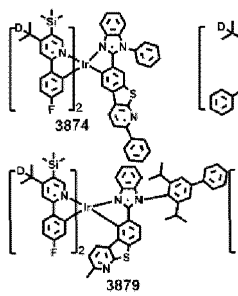
3874
3879
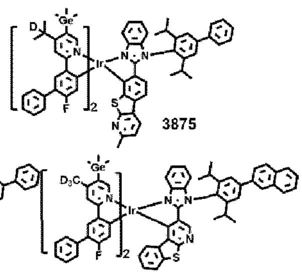
3875
3880

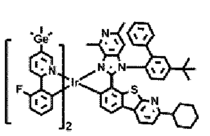
3881
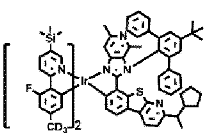
3882
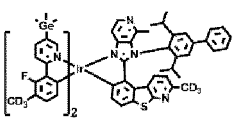
3883
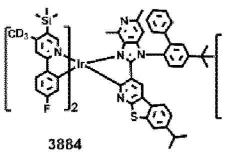
3884
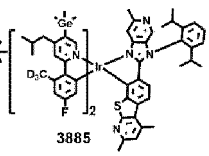
3885

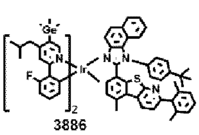
3886
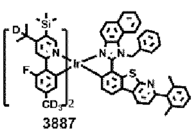
3887
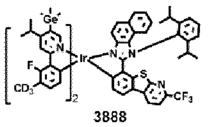
3888
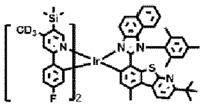
3889
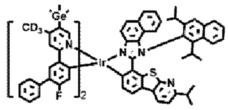
3890

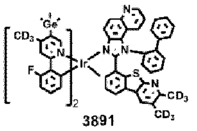
3891
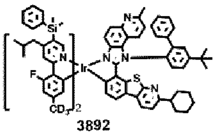
3892
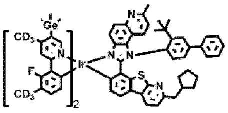
3893
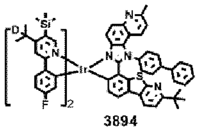
3894
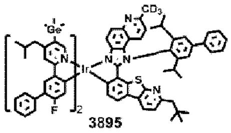
3895

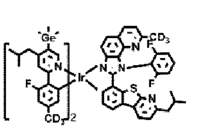
3896

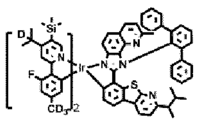
3897

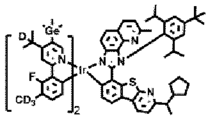
3898

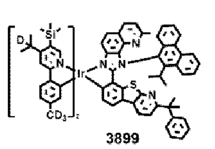
3899

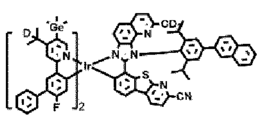
3900

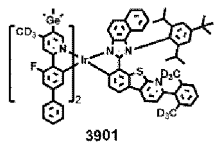
3901

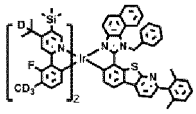
3902

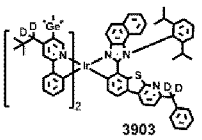
3903

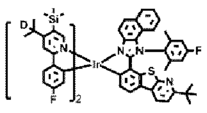
3904

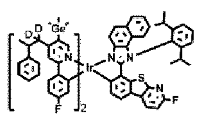
3905

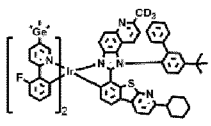
3906

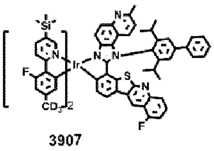
3907

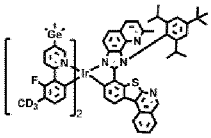
3908

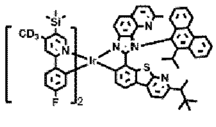
3909

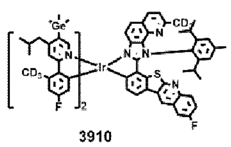
3910

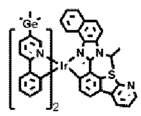
3911

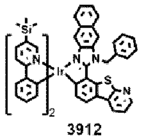
3912

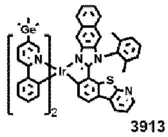
3913

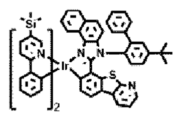
3914

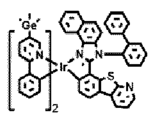
3915

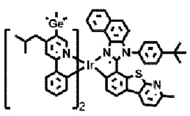
3916

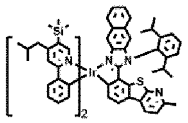
3917

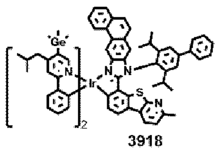
3918

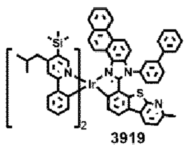
3919

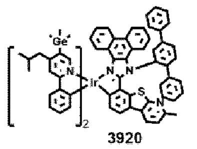
3920

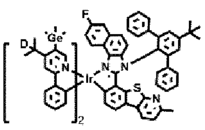
3921

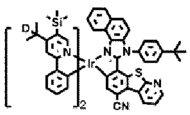
3922

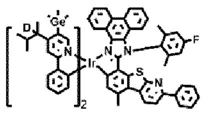
3923

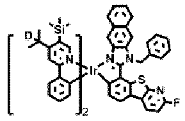
3924

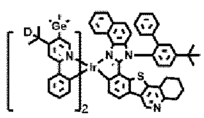
3925

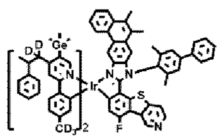
3926

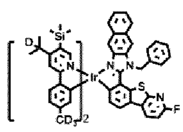
3927

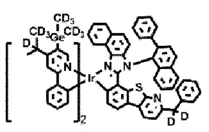
3928

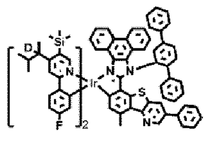
3929

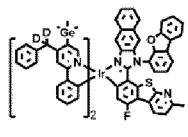
3930

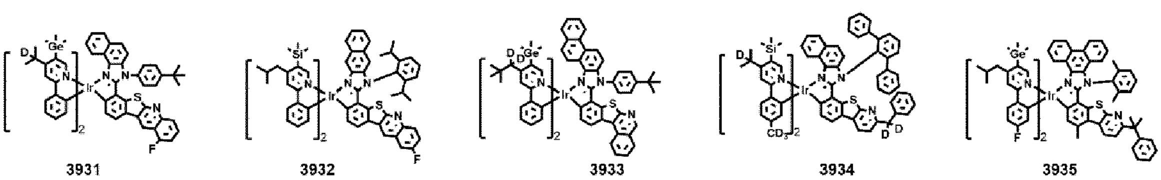
3931

3932

3933

3934

3935

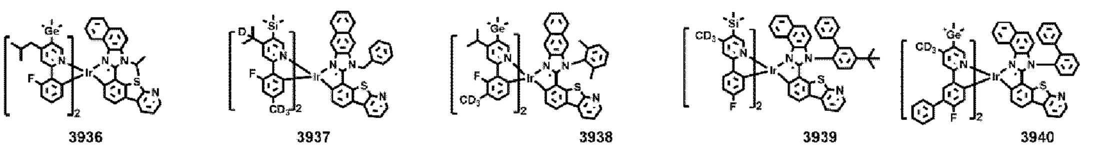
3936

3937

3938

3939

3940

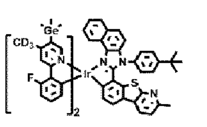
3941
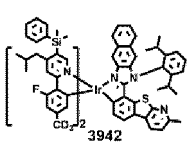
3942
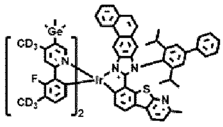
3943
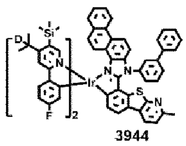
3944
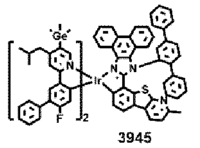
3945

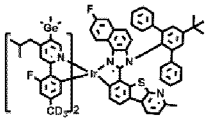
3946
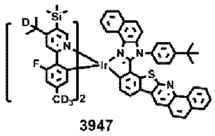
3947
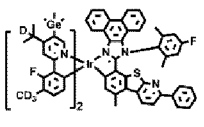
3948
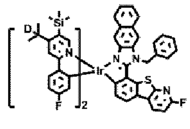
3949
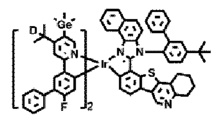
3950

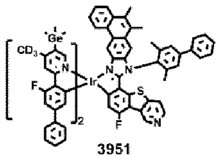
3951
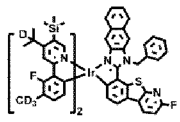
3952
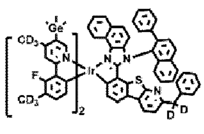
3953
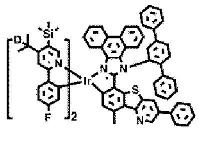
3954
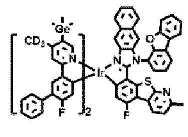
3955

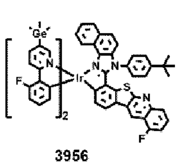
3956
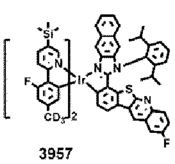
3957
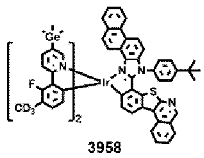
3958
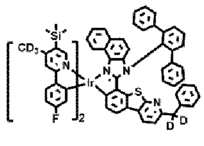
3959
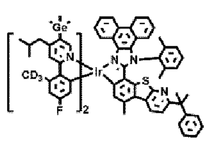
3960

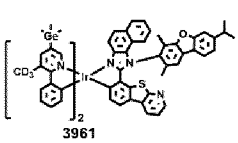
3961
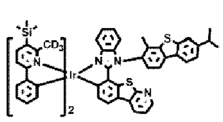
3962
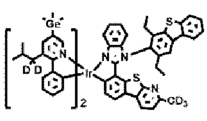
3963
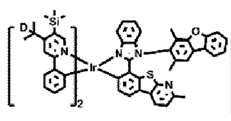
3964
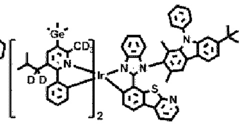
3965

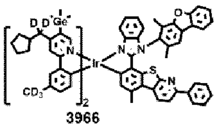
3966
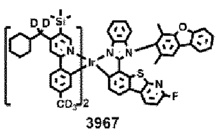
3967
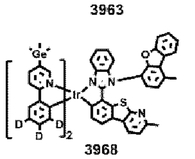
3968
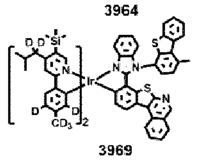
3969
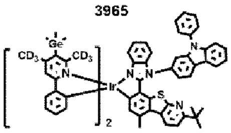
3970

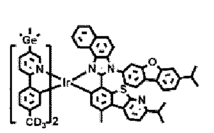
3971
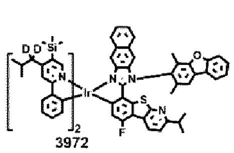
3972
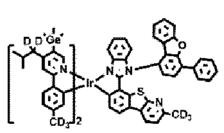
3973
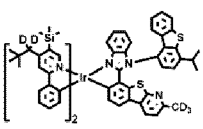
3974
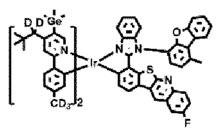
3975

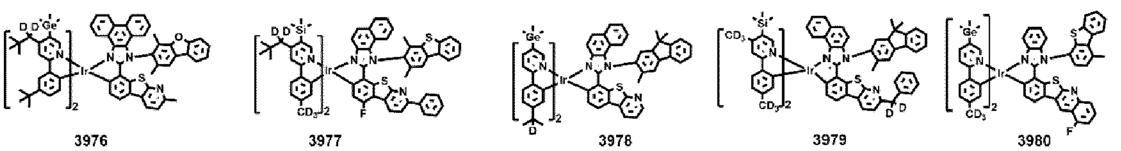
3976 3977 3978 3979 3980

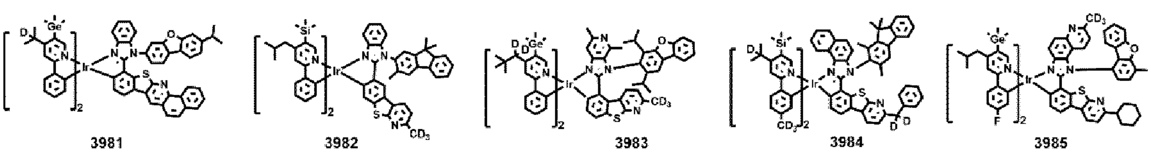
3981 3982 3983 3984 3985

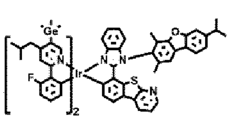
3986
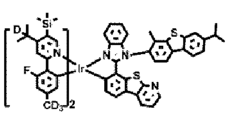
3987
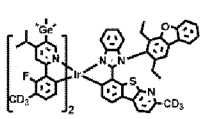
3988
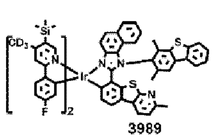
3989
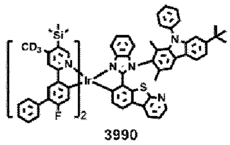
3990

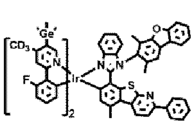
3991
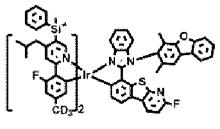
3992
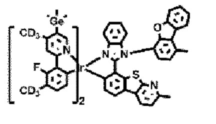
3993
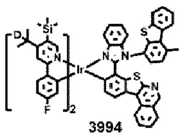
3994
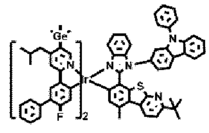
3995

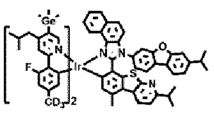
3996
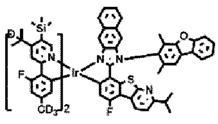
3997
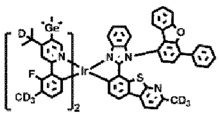
3998
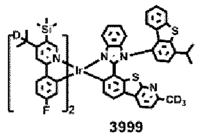
3999
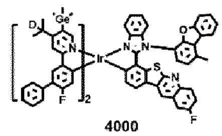
4000

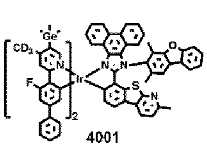
4001
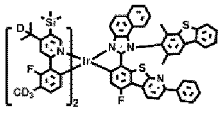
4002
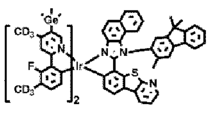
4003
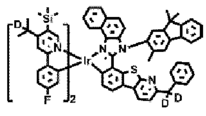
4004
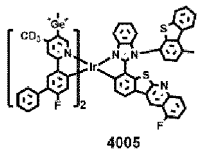
4005

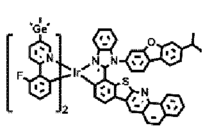
4006
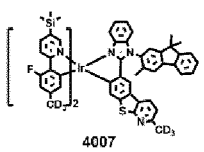
4007
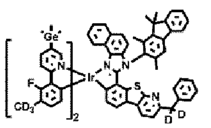
4008
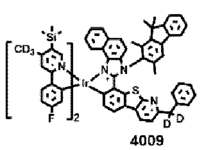
4009
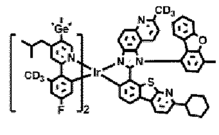
4010

$L_1$ and $L_2$ of the organometallic compound represented by Formula 1 may be ligands represented by Formulae 2 and 3, respectively, and n1 and n2, indicating the numbers of $L_1$ and $L_2$, respectively, may each independently be 1 or 2. In other words, the organometallic compound includes $L_1$ (Formula 2) essentially including a group represented by *-$X_{11}(R_{14})(R_{15})(R_{16})$ and $L_2$ (Formula 3). Accordingly, molecular orientation and charge mobility of the organometallic compound represented by Formula 1 may be significantly improved, and thus external quantum efficiency and lifespan of an electronic device, for example, an organic light-emitting device, including the same may be improved.

Results of evaluating a HOMO energy level, a LUMO energy level, a $S_1$ energy level, a $T_1$ energy level of a part of the organometallic compound represented by Formula 1 by using a Gaussian 09 program involving molecular structure optimization by density functional theory (DFT) based on B3LYP are shown in Table 1 below.

[Table 1]

| Compound No. | HOMO(eV) | LUMO(eV) | Si(eV) | $T_1$(eV) |
|---|---|---|---|---|
| 1 | -4.723 | -1.151 | 2.872 | 2.528 |
| 5 | -4.719 | -1.145 | 2.874 | 2.523 |
| 6 | -4.702 | -1.133 | 2.868 | 2.523 |
| 11 | -4.719 | -1.173 | 2.857 | 2.517 |
| 12 | -4.673 | -1.131 | 2.843 | 2.513 |
| 14 | -4.707 | -1.181 | 2.844 | 2.511 |
| 15 | -4.744 | -1.171 | 2.873 | 2.532 |
| 37 | -4.704 | -1.152 | 2.856 | 2.558 |
| 184 | -4.721 | -1.139 | 2.871 | 2.552 |
| 212 | -4.794 | -1.255 | 2.831 | 2.536 |

(continued)

| Compound No. | HOMO(eV) | LUMO(eV) | Si(eV) | $T_1$(eV) |
|---|---|---|---|---|
| 295 | -4.710 | -1.154 | 2.856 | 2.545 |
| 982 | -4.706 | 1.149 | 2.862 | 2.554 |
| 1042 | -4.761 | -1.197 | 2.856 | 2.513 |
| 1229 | -4.842 | -1.281 | 2.864 | 2.539 |
| 1525 | -4.728 | -1.129 | 2.900 | 2.530 |
| 1550 | --4.705 | -1.108 | 2.892 | 2.557 |
| 1725 | -4.783 | -1.237 | 2.838 | 2.546 |
| 2610 | -4.769 | -1.273 | 32.849 | 2.558 |
| 2755 | -4.779 | -1.200 | 2.883 | 2.531 |
| 3214 | -4.707 | -1.148 | 2.865 | 2.533 |
| 3275 | -4.755 | -1.238 | 2.850 | 2.402 |
| 3492 | -4.840 | -1.268 | 2.892 | 2.509 |
| 3553 | -4.727 | -1.231 | 2.839 | 2.405 |

From Table 1, it is confirmed that the organometallic compound represented by Formula 1 has such electric characteristics that are suitable for use as a dopant for an electronic device, for example, an organic light-emitting device.

A synthesis method for the organometallic compound represented by Formula 1 would be understood to those of ordinary skill in the art by referring to the following examples.

Therefore, the organometallic compound represented by Formula 1 may be suitable for an organic layer of an organic light-emitting device. For example, the organometallic compound represented by Formula 1 may be suitable as a dopant in an emission layer in the organic layer. Accordingly, another aspect of the present disclosure provides an organic light-emitting device including: a first electrode; a second electrode; and an organic layer disposed between the first electrode and the second electrode and including an emission layer, wherein the organic layer includes at least one organometallic compound represented by Formula 1.

The organic light-emitting device including the organic layer including the organometallic compound represented by Formula 1 may have improved external quantum efficiency and improved lifespan characteristics.

The organometallic compound represented by Formula 1 may be used between a pair of electrodes of the organic light-emitting device. For example, the organometallic compound represented by Formula 1 may be included in the emission layer. Here, the organometallic compound may serve as a dopant, and the emission layer may further include a host (i.e., an amount of the organometallic compound represented by Formula 1 may be smaller than that of the host). The emission layer may emit red light or green light, for example, red light or green light, each having a maximum emission wavelength of 500 nm or more, for example, 500 nm or more and 850 nm or less. For example, the organometallic compound may emit green light.

The expression "(an organic layer) includes at least one organometallic compound" as used herein may include a case in which "(an organic layer) includes identical organometallic compounds represented by Formula 1" and a case in which "(an organic layer) includes two or more different organometallic compounds represented by Formula 1".

For example, the organic layer may include, as the organometallic compound, only Compound 1. Here, Compound 1 may exist only in the emission layer of the organic light-emitting device. In one or more embodiments, the organic layer may include, as the organometallic compound, Compound 1 and Compound 2. Here, Compound 1 and Compound 2 may exist in an identical layer (for example, Compound 1 and Compound 2 may all exist in the emission layer).

The first electrode may be an anode which is a hole injection electrode, and the second electrode may be a cathode which is an electron injection electrode; or the first electrode may be a cathode which is an electron injection electrode, and the second electrode may be an anode which is a hole injection electrode.

For example, in the organic light-emitting device, the first electrode may be an anode, the second electrode may be a cathode, and the organic layer may further include a hole transport region between the first electrode and the emission layer and an electron transport region between the emission layer and the second electrode, wherein the hole transport region may include a hole injection layer, a hole transport layer, an electron blocking layer, a buffer layer, or any combination thereof, and the electron transport region may include a hole blocking layer, an electron transport layer, an electron injection layer, or any combination thereof.

The term "organic layer" as used herein refers to a single layer and/or a plurality of layers disposed between the first electrode and the second electrode of the organic light-emitting device. The "organic layer" may include not only an organic compound, but also an organometallic complex including metal.

FIGURE is a schematic cross-sectional view of an organic light-emitting device 10 according to an embodiment. Hereinafter, the structure of the organic light-emitting device 10 according to an embodiment and a method of manufacturing the organic light-emitting device 10 will be described in connection with the FIGURE. The organic light-emitting device 10 has a structure in which a first electrode 11, an organic layer 15, and a second electrode 19 are stacked in the stated order.

A substrate may be additionally disposed under the first electrode 11 or above the second electrode 10. For use as the substrate, a substrate used in a typical organic light-emitting device in the related art may be used, and in this regard, the substrate may be a glass substrate or a plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. A material for forming the first electrode 11 may include a material with a high work function to facilitate hole injection. The first electrode 11 may be a reflective electrode, a semi-transmissive electrode, or a transmissive electrode. The material for forming the first electrode 11 may include indium tin oxide (ITO), indium zinc oxide (IZO), tin oxide ($SnO_2$), zinc oxide (ZnO), or the like. In one or more embodiments, the material for forming the first electrode 11 may include metal, such as magnesium (Mg), aluminum (Al), aluminum-lithium (Al-Li), calcium (Ca), magnesium-indium (Mg-In), and magnesium-silver (Mg-Ag).

The first electrode 11 may have a single-layered structure, or a multi-layered structure including two or more layers. For example, the first electrode 11 may have a three-layered structure of ITO/Ag/ITO.

The organic layer 15 is disposed on the first electrode 11.

The organic layer 15 may include: a hole transport region; an emission layer; and an electron transport region.

The hole transport region may be disposed between the first electrode 11 and the emission layer.

The hole transport region may include a hole injection layer, a hole transport layer, an electron blocking layer, a buffer layer, or any combination thereof.

The hole transport region may include a hole injection layer only, or a hole transport layer only. In one or more embodiments, the hole transport region may have a hole injection layer/hole transport layer structure or a hole injection layer/hole transport layer/electron blocking layer structure, wherein for each structure, constituting layers are sequentially stacked from the first electrode 11 in this stated order.

When the hole transport region includes a hole injection layer, the hole injection layer may be formed on the first electrode 11 by using various methods, such as vacuum deposition, spin coating, casting, Langmuir-Blodgett (LB) deposition, and the like.

When the hole injection layer is formed by vacuum deposition, the deposition may be performed at a deposition temperature of about 100 °C to about 500 °C, a vacuum degree of about $10^{-8}$ torr to about $10^{-3}$ torr (wherein 1 torr = 133.322 Pa), and a deposition speed of about 0.01 Å/sec to about 100 Å/sec by taking into account a compound for forming a hole injection layer and a structure and thermal characteristics of a hole injection layer to be formed.

When the hole injection layer is formed by spin coating, the coating may be performed at a coating speed of about 2,000 rpm to about 5,000 rpm (wherein 1 rpm =1/60 Hz) and at a heat treatment temperature of about 80 °C to 200 °C for the removal of a solvent after coating by taking into account a compound for forming a hole injection layer and a structure and thermal characteristics of a hole injection layer to be formed.

Conditions for forming the hole transport layer and the electron blocking layer may be referred to those for forming the hole injection layer.

The hole transport region may include, for example, m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine) (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate):polyaniline (PANI/PSS), a compound represented by Formula 201, a compound represented by Formula 202, or any combination thereof:

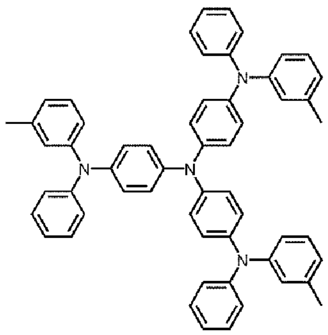

m-MTDATA

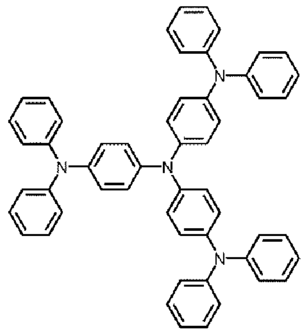

TDATA

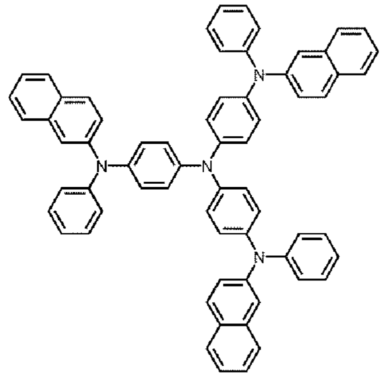

2-TNATA

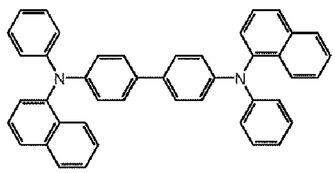

NPB

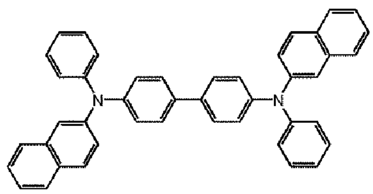

β-NPB

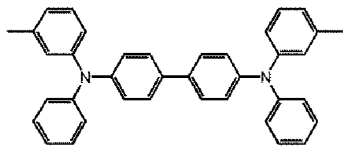

TPD

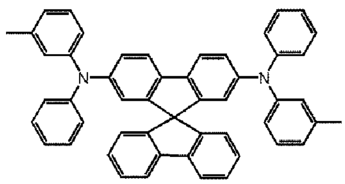

Spiro-TPD

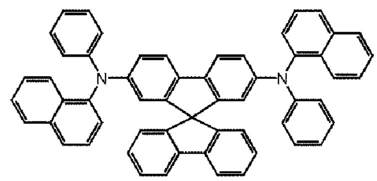

Spiro-NPB

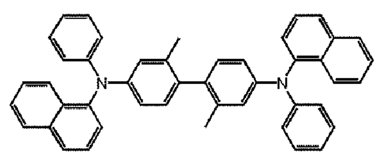

methylated NPB

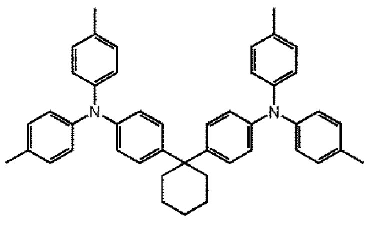

TAPC

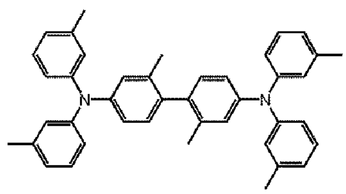

HMTPD

<Formula 201>

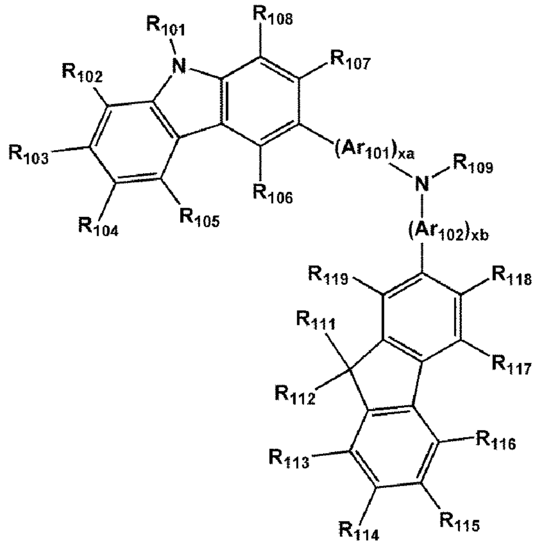

<Formula 202>

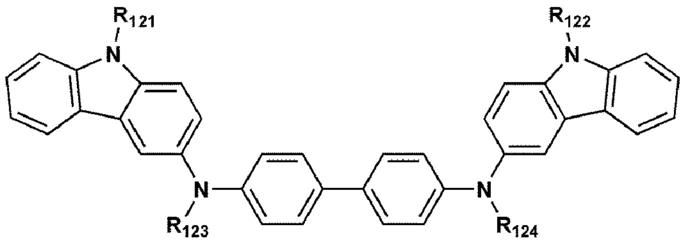

In Formula 201, $Ar_{101}$ and $Ar_{102}$ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, or any combination thereof.

In Formula 201, xa and xb may each independently be an integer from 0 to 5, or may be 0, 1, or 2. For example, xa may be 1, and xb may be 0.

In Formulae 201 and 202, $R_{101}$ to $R_{108}$, $R_{111}$ to $R_{119}$, and $R_{121}$ to $R_{124}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, a pentyl group, a hexyl group, or the like), or a $C_1$-$C_{10}$ alkoxy group (for example, a methoxy group, an ethoxy group, a propoxy group, a butoxy group, a pentoxy group, or the like);

a $C_1$-$C_{10}$ alkyl group or a $C_1$-$C_{10}$ alkoxy group, each substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or any combination thereof; or

a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group

or a salt thereof, a phosphoric acid group or a salt thereof, a $C_1$-$C_{10}$ alkyl group, a $C_1$-$C_{10}$ alkoxy group, or any combination thereof.

In Formula 201, $R_{109}$ may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyridinyl group, or any combination thereof.

In one embodiment, the compound represented by Formula 201 may be represented by Formula 201A:

<Formula 201A>

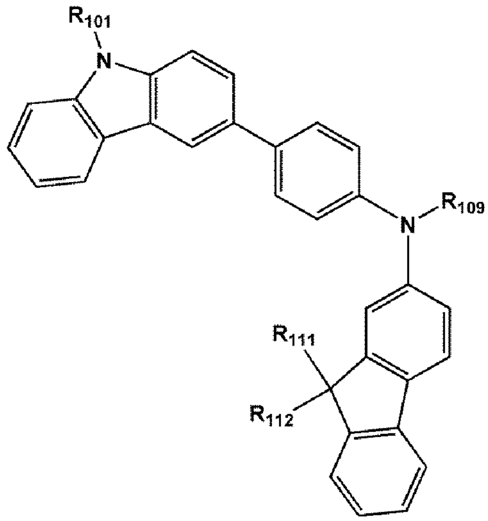

In Formula 201A, $R_{101}$, $R_{111}$, $R_{112}$, and $R_{109}$ may each be understood by referring to the corresponding descriptions thereof provided herein.

For example, the compound represented by Formula 201 and the compound represented by Formula 202 may include Compounds HT1 to HT20:

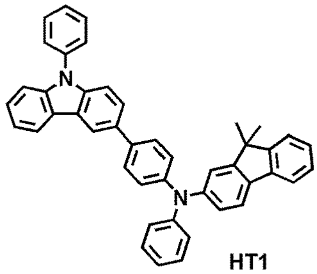
HT1

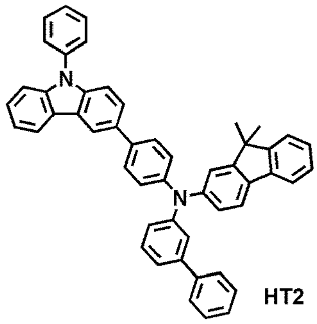
HT2

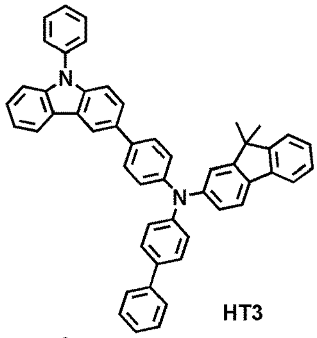
HT3

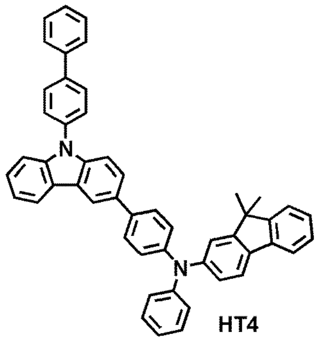
HT4

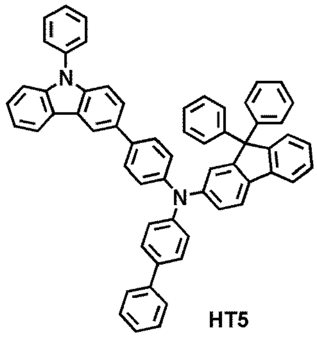
HT5

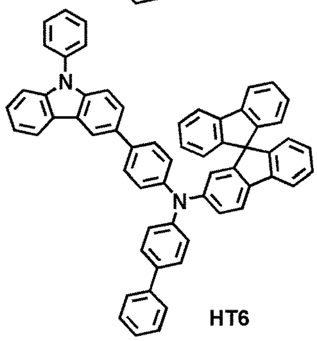
HT6

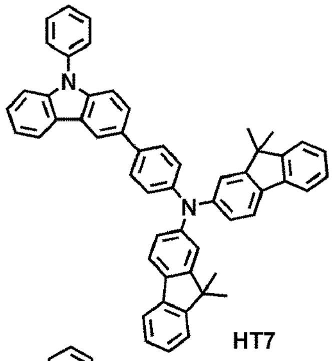

HT7

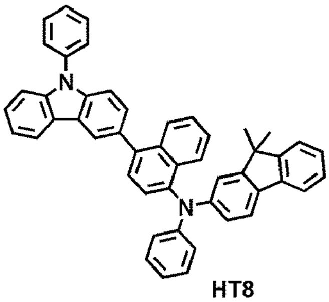

HT8

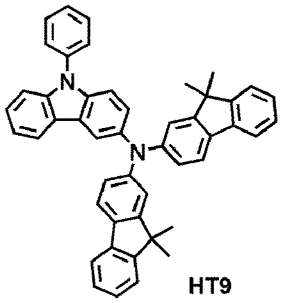

HT9

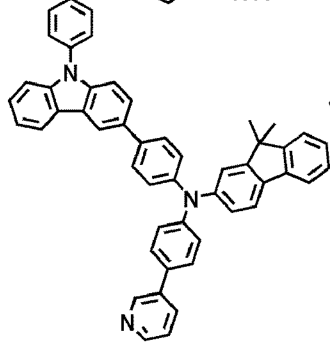

HT10

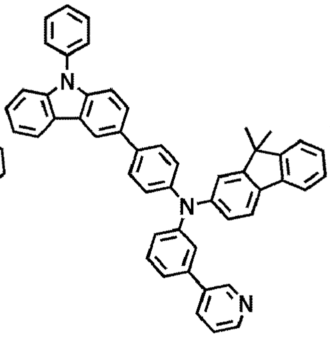

HT11

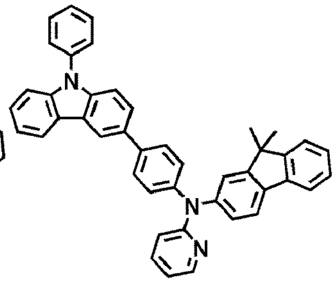

HT12

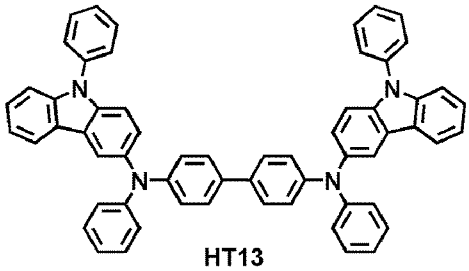

HT13

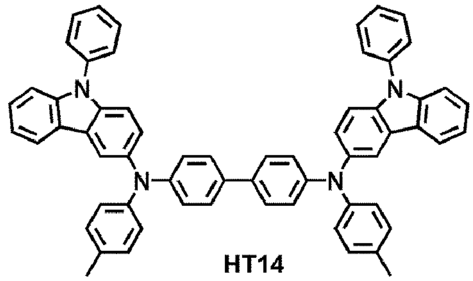

HT14

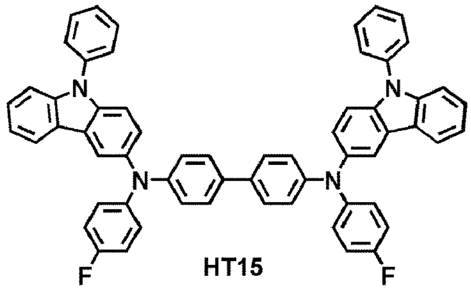

HT15

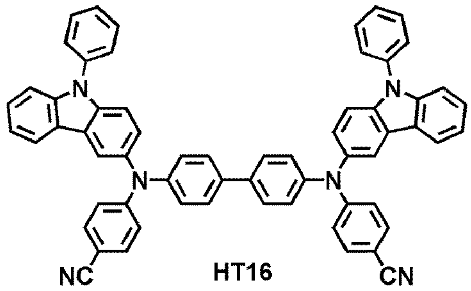

HT16

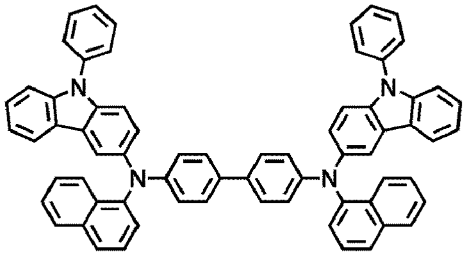

HT17

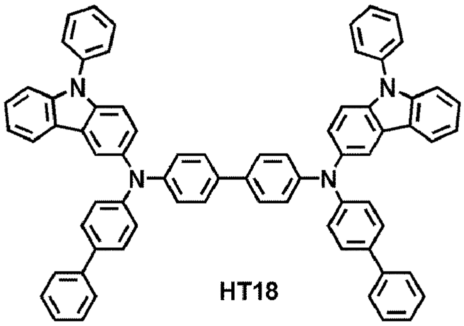

HT18

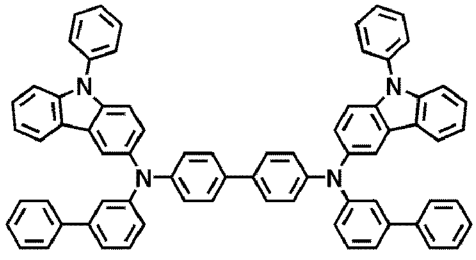

HT19

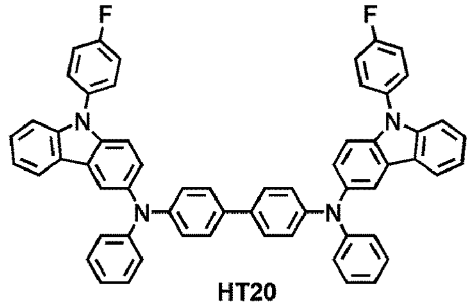

HT20

A thickness of the hole transport region may be in a range of about 100 Å to about 10,000 Å, for example, about 100 Å to about 1,000 Å. When the hole transport region includes at least one layer selected from a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one of a quinone derivative, a metal oxide, and a cyano groupcontaining compound. For example, non-limiting examples of the p-dopant include: a quinone derivative, such as tetracyanoquinodimethane (TCNQ), 2,3,5,6-tetrafluoro-7,7,8,8-tetracyanoquinodimethane (F4-TCNQ), or F6-TCNNQ; a metal oxide, such as a tungsten oxide or a molybdenum oxide; and a cyano groupcontaining compound such as Compound HT-D1:

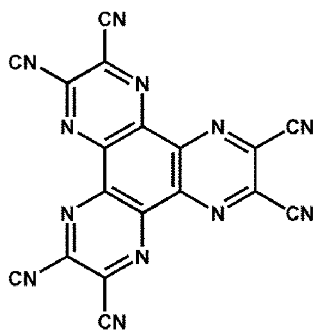

HT-D1

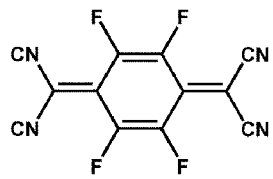

F4-TCNQ

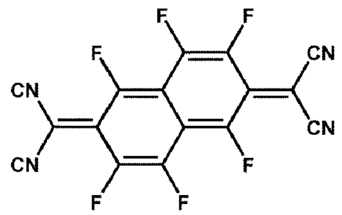

F6-TCNNQ

The hole transport region may further include a buffer layer.

The buffer layer may increase efficiency by compensating for an optical resonance distance according to the wavelength of light emitted by the emission layer.

In one or more embodiments, when the hole transport region includes an electron blocking layer, a material for forming the electron blocking layer may include the above-mentioned material for forming the hole transport region, a host material described below, or any combination thereof. For example, when the hole transport region includes an electron blocking layer, a material for forming the electron blocking layer may be mCP described below.

An emission layer may be formed on the hole transport region by using methods, such as vacuum deposition, spin coating, casting, LB deposition, or the like. When the emission layer is formed by vacuum deposition and spin coating, the deposition conditions and the coating conditions may vary depending on a compound used, but may be generally selected within a range of conditions almost identical to the formation of the emission layer.

The emission layer may include a host and a dopant, and the dopant may include the organometallic compound represented by Formula 1.

The host may include TPBi, TBADN, AND (also referred to as "DNA"), CBP, CDBP, TCP, mCP, Compound H50, Compound H51, Compound H52, or any combination thereof:

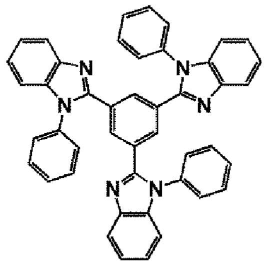

TPBi

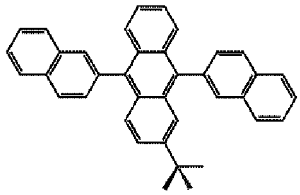

TBADN

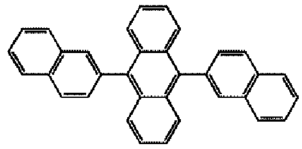

ADN

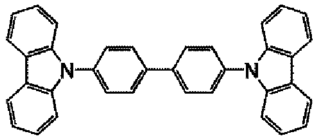

CBP

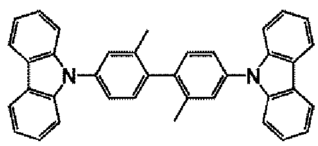

CDBP

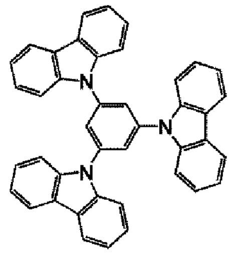

TCP

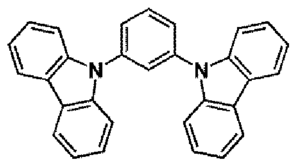

mCP

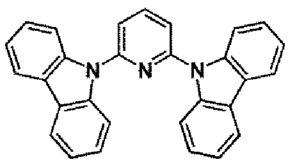

H50

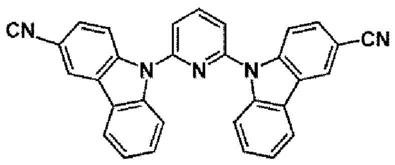

H51

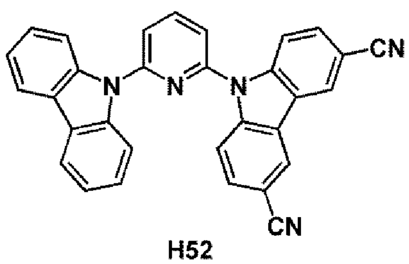

H52

When the organic light-emitting device 10 is a full-color organic light-emitting device, the emission layer may be patterned into a red emission layer, a green emission layer, or a blue emission layer, according to a sub-pixel. In one or more embodiments, the emission layer may have a stacked structure of a red emission layer, a green emission layer, and/or a blue emission layer to emit white light.

When the emission layer includes a host and a dopant, an amount of the dopant may be in a range of about 0.01 parts by weight to about 15 parts by weight based on 100 parts by weight of the host.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

Next, an electron transport region may be disposed on the emission layer.

The electron transport region may include a hole blocking layer, an electron transport layer, an electron injection layer, or any combination thereof.

For example, electron transport region may have a hole blocking layer/electron transport layer/electron injection layer structure or an electron transport layer/electron injection layer structure. The electron transport layer may have a single-layered structure or a multi-layered structure having two or more different materials.

Conditions for forming a hole blocking layer, an electron transport layer, and an electron injection layer in the electron transport region may be referred to those for forming the hole injection layer.

When the electron transport region includes a hole blocking layer, the hole blocking layer may include, for

example, BCP, Bphen, BAlq, or any combination thereof.

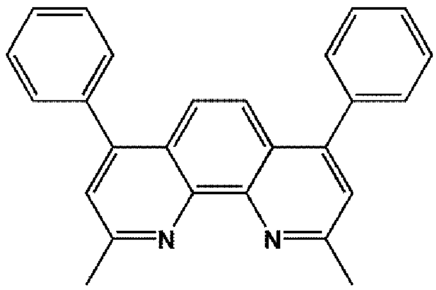

BCP

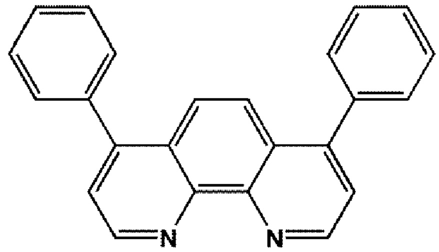

Bphen

A thickness of the hole blocking layer may be in a range of about 20 Å to about 1,000 Å, for example, about 30 Å to about 300 Å. When the thickness of the hole blocking layer is within the range described above, excellent hole blocking characteristics may be obtained without a substantial increase in driving voltage.

The electron transport layer may include BCP, Bphen, $Alq_3$, BAlq, TAZ, NTAZ, or any combination thereof:

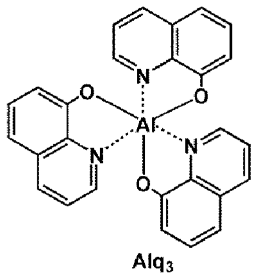

$Alq_3$

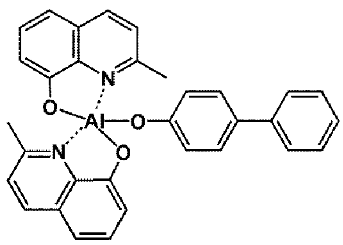

BAlq

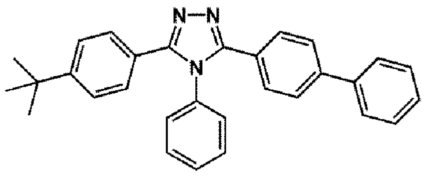

TAZ

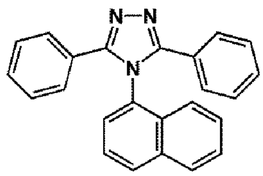

NTAZ

In one or more embodiments, the electron transport layer may include one of Compounds ET1 to ET25, or any combination thereof:

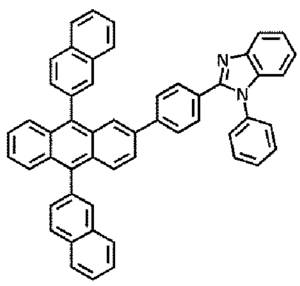

ET1

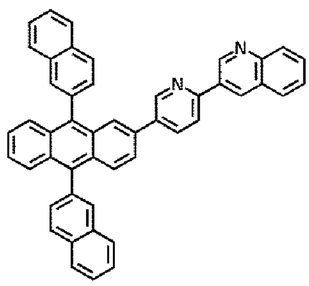

ET2

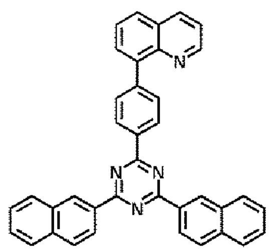

ET3

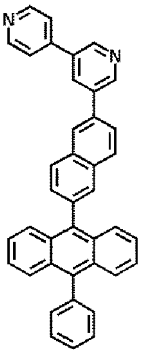

ET4

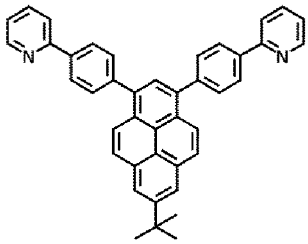

ET5

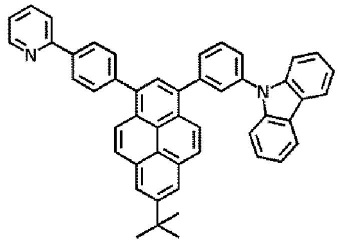

ET6

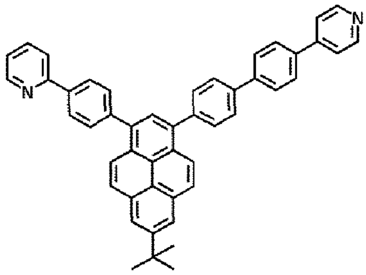

ET7

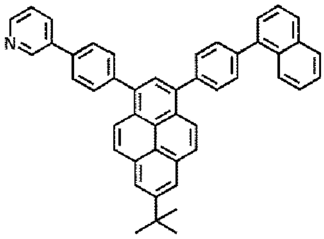

ET8

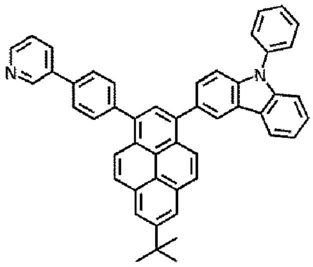

ET9

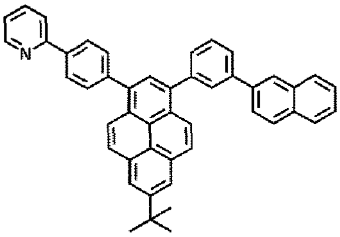

ET10

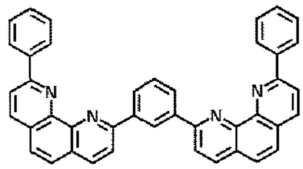

ET11

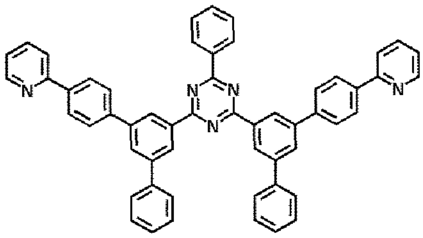

ET12

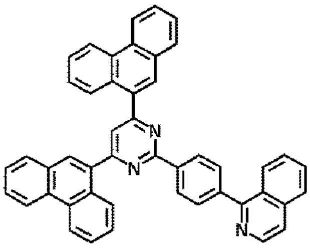

ET13

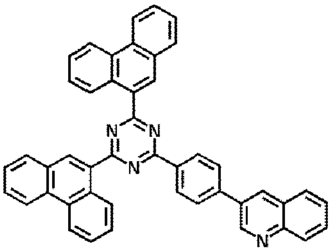

ET14

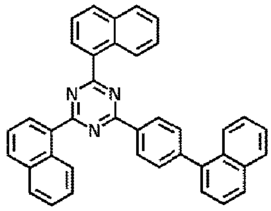

ET15

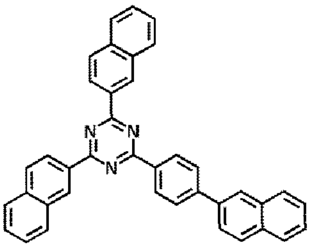

ET16

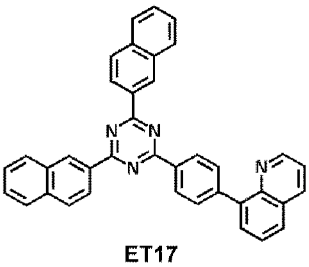

ET17

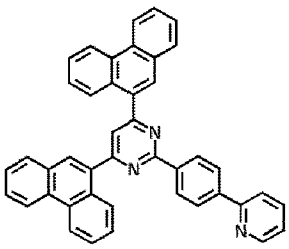

ET18

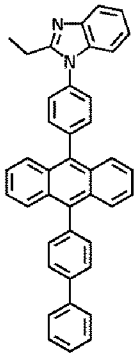
ET19

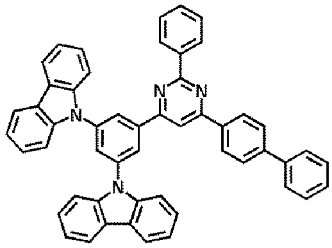
ET20

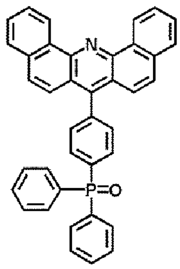
ET21

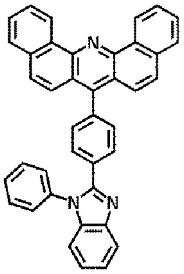
ET22

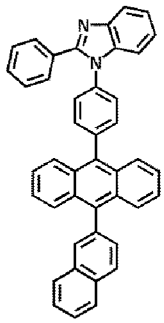
ET23

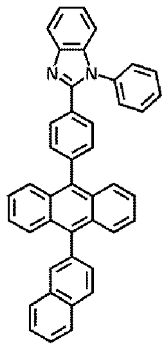
ET24

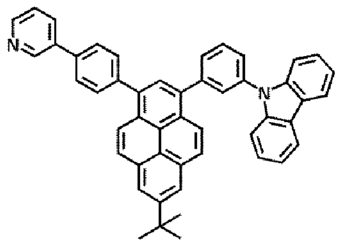
ET25

A thickness of the electron transport layer may be in a range of about 100 Å to about 1,000 Å, for example, about 150 Å to about 500 Å. When the thickness of the electron transport layer is within the range described above, satisfactory electron transport characteristics may be obtained without a substantial increase in driving voltage.

The electron transport layer may further include, in addition to the materials described above, a metal-containing material.

The metal-containing material may include a Li complex. The Li complex may include, for example, Compound ET-D1(LiQ) or ET-D2:

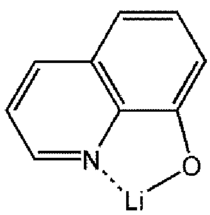
ET-D1

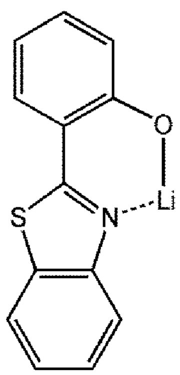
ET-D2

In addition, the electron transport region may include an electron injection layer to facilitate electron injection from the second electrode 19.

The electron injection layer may include LiF, NaCl, CsF, $Li_2O$, BaO, or any combination thereof.

A thickness of the electron injection layer may be in a range of about 1 Å to about 100 Å, for example, about 3 Å to about 90 Å. When the thickness of the electron injection layer is within the range described above, satisfactory electron injection characteristics may be obtained without a substantial increase in driving voltage.

The second electrode 19 may be disposed on the organic layer 15. The second electrode 19 may be a cathode.

A material for forming the second electrode 19 may be a metal, an alloy, an electrically conductive compound, or any combination thereof, which has a relatively low work function. In detail, lithium (Li), magnesium (Mg), aluminum (Al), aluminum-lithium (Al-Li), calcium (Ca), magnesium-indium (Mg-In), magnesium-silver (Mg-Ag), or the like may be used as the material for forming the second electrode 19. In one or more embodiments, to obtain a top-emission light-emitting device, ITO or IZO may be used to form a transmissive second electrode 19, but embodiments are not limited thereto.

Hereinbefore, the organic light-emitting device according to an embodiment has been described in connection with the FIGURE, but embodiments of the present disclosure are not limited thereto.

According to an aspect of another embodiment, an electronic apparatus including the organic light-emitting device may be provided. The electronic apparatus may be used for various purposes such as a display, lighting, and a mobile phone.

Another aspect of the present disclosure provides a diagnostic composition including at least one organometallic compound represented by Formula 1.

The organometallic compound represented by Formula 1 may provide high luminance efficiency, and in this regard, the diagnostic composition including the organometallic compound may have high diagnostic efficiency.

The diagnostic composition may be variously applied to various kits, diagnostic reagents, biosensors, biomarkers, and the like.

The term "$C_1$-$C_{60}$ alkyl group" as used herein refers to a linear or branched saturated aliphatic hydrocarbon monovalent group having 1 to 60 carbon atoms. The term "$C_1$-$C_{60}$ alkylene group" as used herein refers to a divalent group having the same structure as the $C_1$-$C_{60}$ alkyl group.

Examples of the $C_1$-$C_{60}$ alkyl group, the $C_1$-$C_{20}$ alkyl group, and/or the $C_1$-$C_{10}$ alkyl group as used herein may include a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group or a tert-decyl group, each unsubstituted or substituted with a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or any combination thereof. In some embodiments, Formula 9-33 may be a branched $C_6$ alkyl group. Formula 9-33 may be a tert-butyl group substituted with two methyl groups.

The term "$C_1$-$C_{60}$ alkoxy group" as used herein refers to a monovalent group represented by $-OA_{101}$ (wherein $A_{101}$ is a $C_1$-$C_{60}$ alkyl group). Examples of the $C_1$-$C_{60}$ alkoxy group, the $C_1$-$C_{20}$ alkoxy group, or the $C_1$-$C_{10}$ alkoxy group as used herein may include a methoxy group, an ethoxy group, a propoxy group, a butoxy group, or a pentoxy group.

The term "$C_2$-$C_{60}$ alkenyl group" as used herein refers to a group formed by placing at least one carbon-carbon double bond in the middle or at the terminus of the $C_2$-$C_{60}$ alkyl group. Examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a group formed by placing at least one carbon-carbon triple bond in the middle or at the terminus of the $C_2$-$C_{60}$ alkyl group. Examples thereof include an ethynyl group and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent cyclic saturated hydrocarbon group including 3 to 10 carbon atoms. The term "$C_3$-$C_{10}$ cycloalkylene group" as used herein refers to a divalent group having the same structure as the $C_3$-$C_{10}$ cycloalkyl group.

Examples of the $C_3$-$C_{10}$ cycloalkyl group as used herein may include a cyclopropyl group, a cyclobutyl group, a cyclopentyl group, a cyclohexyl group, a cycloheptyl group, a cyclooctyl group, an adamantanyl group, a norbornanyl group (a bicyclo[2.2.1]heptyl group), a bicyclo[1.1.1]pentyl group, a bicyclo[2.1.1]hexyl group, or a bicyclo[2.2.2]octyl group.

The term "$C_1$-$C_{10}$ heterocycloalkyl group" as used herein refers to a monovalent monocyclic group including at least one heteroatom selected from N, O, P, Si, Se, Ge, B and S as a ring-forming atom and 1 to 10 carbon atoms. The term "$C_1$-$C_{10}$ heterocycloalkylene group" as used herein refers to a divalent group having the same structure as the $C_1$-$C_{10}$ heterocycloalkyl group.

Examples of the $C_1$-$C_{10}$ heterocycloalkyl group as used herein may include a silolanyl group, a silinanyl group, a tetrahydrofuranyl group, a tetrahydro-2H-pyranyl group, or a tetrahydrothiophenyl group.

The term "$C_3$-$C_{10}$ cycloalkenyl group" as used herein refers to a monovalent monocyclic group that has 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group including at least one heteroatom selected from N, O, P, Si, Se, Ge, B and S as a ring-forming atom, 1 to 10 carbon atoms, and at least one double bond in its ring wherein the molecular structure as a whole is non-aromatic. Examples of the $C_1$-$C_{10}$ heterocycloalkenyl group include a 2,3-dihydrofuranyl group and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms. The term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include a plurality of rings, the plurality of rings may be fused to each other.

The term "$C_7$-$C_{60}$ alkyl aryl group" as used herein refers to a $C_6$-$C_{60}$ aryl group substituted with at least one $C_1$-$C_{60}$ alkyl group.

The term "$C_1$-$C_{60}$ heteroaryl group" as used herein refers to a monovalent group having a heterocyclic aromatic system having at least one heteroatom selected from N, O, P, Si, Se, Ge, B and S as a ring-forming atom and 1 to 60 carbon atoms. The term "$C_1$-$C_{60}$ heteroarylene group" as used herein refers to a divalent group having a heterocyclic aromatic system having at least one heteroatom selected from N, O, P, Si, Se, Ge, B and S as a ring-forming atom and 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include a plurality of rings, the plurality of rings may be fused to each other.

The term "$C_2$-$C_{60}$ alkyl heteroaryl group" as used herein refers to a $C_1$-$C_{60}$ heteroaryl group substituted with at least one $C_1$-$C_{60}$ alkyl group.

The term "$C_6$-$C_{60}$ aryloxy group" as used herein is represented by $-OA_{102}$ (wherein $A_{102}$ is the $C_6$-$C_{60}$ aryl group). The term "$C_6$-$C_{60}$ arylthio group" as used herein is represented by $-SA_{103}$ (wherein $A_{103}$ is the $C_6$-$C_{60}$ aryl group). The term "C1-$C_{60}$ alkylthio group" as used herein is represented by $-SA_{104}$ (wherein $A_{104}$ is the $C_1$-$C_{60}$ alkyl group).

The term "monovalent non-aromatic condensed polycyclic group" as used herein refers to a monovalent group that has two or more condensed rings and only carbon atoms (e.g., the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and a heteroatom selected from N, O, P, Si, Se, Ge, B and S and carbon atoms (e.g., the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "$C_5$-$C_{30}$ carbocyclic group" as used herein refers to a saturated or unsaturated cyclic group including 5 to 30 carbon atoms only as ring-forming atoms. The $C_5$-$C_{30}$ carbocyclic group may be a monocyclic group or a polycyclic group. Examples of the "$C_5$-$C_{30}$ carbocyclic group (unsubstituted or substituted with at least one $R_{10a}$)" may include an adamantane group, a norbornene group, a norbornane group (a bicyclo[2.2.1]heptane group), a bicyclo[1.1.1]pentane group, a bicyclo[2.1.1]hexane group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, or a fluorene group, each (unsubstituted or substituted with at least one $R_{10a}$).

The term "$C_1$-$C_{30}$ heterocyclic group" as used herein refers to saturated or unsaturated cyclic group including 1 to 30 carbon atoms and at least one heteroatom selected from N, O, P, Si, Se, Ge, B and S as ring-forming atoms. The $C_1$-$C_{30}$ heterocyclic group may be a monocyclic group or a polycyclic group. Examples of the "$C_1$-$C_{30}$ heterocyclic group (unsubstituted or substituted with at least one $R_{10a}$)" may include a thiophene group, a furan group, a pyrrole group, a silole group, a borole group, a phosphole group, a selenophene group, a germole group, a benzothiophene group, a benzofuran group, an indole group, a benzosilole group, a benzoborole group, a benzophosphole group, a

benzoselenophene group, a benzogermole group, a dibenzothiophene group, a dibenzofuran group, a carbazole group, a dibenzosilole group, a dibenzoborole group, a dibenzophosphole group, a dibenzoselenophenegroup, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, each (unsubstituted or substituted with at least one $R_{10a}$).

Examples of the terms "$C_5$-$C_{30}$ carbocyclic group" and "$C_1$-$C_{30}$ heterocyclic group" as used herein may include i) a first ring, ii) a second ring, iii) a condensed cyclic group in which two or more first rings are condensed with each other, iv) a condensed cyclic group in which two or more second rings are condensed with each other, or v) a condensed cyclic group in which at least one first ring is condensed with at least one second ring,

the first ring may be a cyclopentane group, a cyclopentadiene group, a furan group, a thiophene group, a pyrrole group, a silole group, a germole group, a borole group, a selenophene group, a phosphole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaselenophene group, or an azaphosphole group, and

the second ring may be an adamantane group, a norbornane group (a bicyclo[2.2.1]heptane group), a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

The "fluorinated $C_1$-$C_{60}$ alkyl group (or fluorinated $C_1$-$C_{20}$ alkyl group or the like)", "fluorinated $C_3$-$C_{10}$ cycloalkyl group", "fluorinated $C_1$-$C_{10}$ heterocycloalkyl group", and "fluorinated phenyl group" as used herein may respectively be a $C_1$-$C_{60}$ alkyl group (or $C_1$-$C_{20}$ alkyl group or the like), $C_3$-$C_{10}$ cycloalkyl group, a $C_1$-$C_{10}$ heterocycloalkyl group, and a phenyl group, each substituted with at least one fluoro group (-F). Examples of the "fluorinated $C_1$ alkyl group (i.e., a fluorinated methyl group)" may include $-CF_3$, $-CF_2H$, and $-CFH_2$. The "fluorinated $C_1$-$C_{60}$ alkyl group (or fluorinated $C_1$-$C_{20}$ alkyl group or the like)", "fluorinated $C_3$-$C_{10}$ cycloalkyl group", or "fluorinated $C_1$-$C_{10}$ heterocycloalkyl group" may respectively be: i) a fully fluorinated $C_1$-$C_{60}$ alkyl group (or fully fluorinated $C_1$-$C_{20}$ alkyl group or the like), fully fluorinated $C_3$-$C_{10}$ cycloalkyl group, or fully fluorinated $C_1$-$C_{10}$ heterocycloalkyl group, in which all hydrogen atoms are substituted with fluoro groups; or ii) a partially fluorinated $C_1$-$C_{60}$ alkyl group (or partially fluorinated $C_1$-$C_{20}$ alkyl group or the like), partially fluorinated $C_3$-$C_{10}$ cycloalkyl group, or partially fluorinated $C_1$-$C_{10}$ heterocycloalkyl group, in which some of hydrogen atoms are substituted with fluoro groups.

The "deuterated $C_1$-$C_{60}$ alkyl group (or deuterated $C_1$-$C_{20}$ alkyl group or the like)", "deuterated $C_3$-$C_{10}$ cycloalkyl group", "deuterated $C_1$-$C_{10}$ heterocycloalkyl group", and "deuterated phenyl group" as used herein may respectively be a $C_1$-$C_{60}$ alkyl group (or $C_1$-$C_{20}$ alkyl group or the like), $C_3$-$C_{10}$ cycloalkyl group, a $C_1$-$C_{10}$ heterocycloalkyl group, and a phenyl group, each substituted with at least one deuterium. Examples of the "deuterated $C_1$ alkyl group (i.e., a deuterated methyl group)" may include $-CD_3$, $-CD_2H$, and $-CDH_2$ and examples of the "deuterated $C_3$-$C_{10}$ cycloalkyl group" may refer to Formula 10-501 described in this disclosure. The " deuterated $C_1$-$C_{60}$ alkyl group (or deuterated $C_1$-$C_{20}$ alkyl group or the like)", " deuterated $C_3$-$C_{10}$ cycloalkyl group", or " deuterated $C_1$-$C_{10}$ heterocycloalkyl group" may respectively be: i) a fully deuterated $C_1$-$C_{60}$ alkyl group (or fully deuterated $C_1$-$C_{20}$ alkyl group or the like), fully deuterated $C_3$-$C_{10}$ cycloalkyl group, or fully deuterated $C_1$-$C_{10}$ heterocycloalkyl group, in which all hydrogen atoms are substituted with deuteriums; or ii) a partially deuterated $C_1$-$C_{60}$ alkyl group (or partially deuterated $C_1$-$C_{20}$ alkyl group or the like), partially deuterated $C_3$-$C_{10}$ cycloalkyl group, or partially deuterated $C_1$-$C_{10}$ heterocycloalkyl group, in which some of hydrogen atoms are substituted with deuterium(s).

The "($C_1$-$C_{20}$ alkyl)'X' group" refers to a 'X' group substituted with at least one $C_1$-$C_{20}$ alkyl group. For example, The "($C_1$-$C_{20}$ alkyl)$C_3$-$C_{10}$ cycloalkyl group" as used herein refers to a $C_3$-$C_{10}$ cycloalkyl group substituted with at least one $C_1$-$C_{20}$ alkyl group, and the "($C_1$-$C_{20}$ alkyl)phenyl group" as used herein refers to a phenyl group substituted with at least one $C_1$-$C_{20}$ alkyl group. Examples of the ($C_1$ alkyl)phenyl group may include a toluyl group.

In the present specification, "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" each refer to a hetero ring in which at least one ring-forming carbon atom is substituted with nitrogen atom and respectively having an identical backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group".

Substituents of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alklythio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted monovalent non-aromatic condensed polycyclic group, and the substituted monovalent non-aromatic condensed heteropolycyclic group may each independently be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, $C_1$-$C_{60}$ alkoxy group, or $C_1$-$C_{60}$ alkylthio group each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-Ge(Q_{13})(Q_{14})(Q_{15})$, - $B(Q_{16})(Q_{17})$, $-P(=O)(Q_{18})(Q_{19})$, $-P(Q_{18})(Q_{19})$, or any combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, - $Ge(Q_{23})(Q_{24})(Q_{25})$, $-B(Q_{26})(Q_{27})$, $-P(=O)(Q_{28})(Q_{29})$, $-P(Q_{28})(Q_{29})$, or any combination thereof;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, - $P(=O)(Q_{38})(Q_{39})$, or $-P(Q_{38})(Q_{39})$; or any combination thereof.

In the present specification, $Q_1$ to $Q_9$, $Q_{11}$ to $Q_{19}$, $Q_{21}$ to $Q_{29}$, and $Q_{31}$ to $Q_{39}$ may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, -F, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_1$-$C_{60}$ alkylthio group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, -F, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_1$-$C_{60}$ heteroaryl group; a monovalent non-aromatic condensed polycyclic group; or a monovalent non-aromatic condensed heteropolycyclic group.

For example, $Q_1$ to $Q_9$, $Q_{11}$ to $Q_{19}$, $Q_{21}$ to $Q_{29}$, and $Q_{31}$ to $Q_{39}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, or $-CD_2CDH_2$; or

an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, 3-pentyl group, a sec-isopentyl group, a phenyl group, a biphenyl group, or a naphthyl group, each unsubstituted or substituted with deuterium, a $C_1$-$C_{20}$ alkyl group, a phenyl group, or any combination thereof.

Hereinafter, a compound according to embodiments and an organic light-emitting device according to embodiments will be described in detail with reference to Synthesis Examples and Examples, but the present disclosure is not limited to Synthesis Examples and Examples below. The expression "B was used instead of A" used in describing Synthesis Examples means that an identical number of molar equivalents of A was used in place of molar equivalents of B.

[Examples]

<u>**Synthesis Example 1 (Compound 15)**</u>

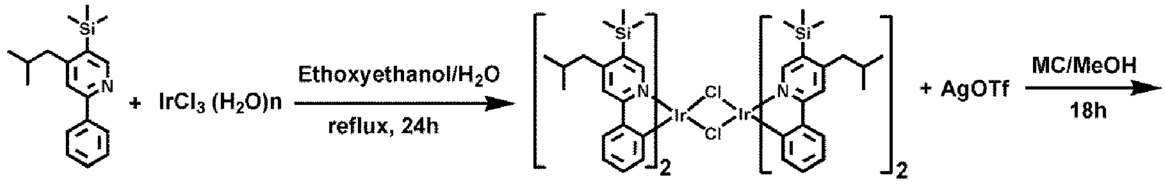


15A

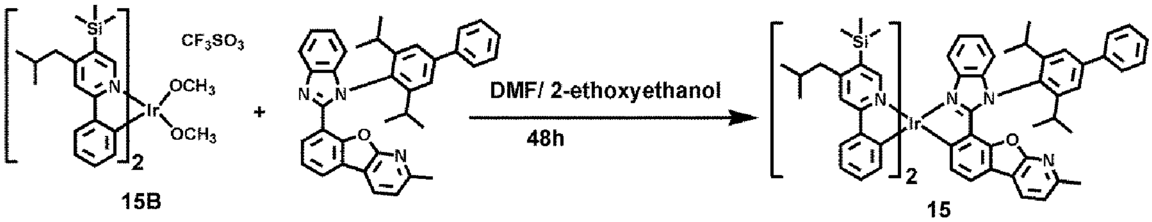


15B 15

<u>Synthesis of Compound 15A</u>

4-isobutyl-2-phenyl-5-(trimethylsilyl)pyridine (7.5 g, 26.7 mmol) and iridium chloride (4.1 g, 11.9 mmol) were mixed with 120 mL of ethoxyethanol and 40 mL of distilled water, and then the mixture was stirred while refluxing for 24 hours and cooled to room temperature. A solid material formed therefrom was separated by filtration and washed thoroughly with water, methanol, and hexane in the stated order to obtain a solid which was then dried in a vacuum oven to obtain 7.43 g (yield of 79%) of Compound 15A.

<u>Synthesis of Compound 15B</u>

After Compound 15A (3.0 g, 1.91 mmol) and 60 mL of methylene chloride were mixed, AgOTf (silver triflate, 0.98 g, 3.81 mmol) and 20 mL of methanol were mixed and added thereto. Subsequently, the mixture was stirred for 18 hours at room temperature while blocking light with aluminum foil, and then a resultant (Compound 15B) obtained by removing a solid generated by celite filtration and decompressing a filtrate was used in the next reaction without additional purification.

<u>Synthesis of Compound 15</u>

Compound 15B (3.68 g, 3.79 mmol) and 8-(1-(3,5-diisopropyl-[1,1'-biphenyl]-4-yl)-1H-benzo[d]imidazol-2-yl)-2-methylbenzofuro[2,3-b]pyridine) (2.24 g, 4.17 mmol) were mixed with 50 mL of 2-ethoxyethanol and 50 mL of dimethylformamide, and the mixture was stirred while refluxing for 48 hours at 130 °C, and then the temperature was lowered

to the room temperature. A compound obtained therefrom was decompressed to obtain a solid which was then subject to column chromatography using methylene chloride (MC) : hexane to obtain 2.0 g (yield of 41%) of compound. A material was identified by Mass spectrum and HPLC analysis.

HRMS(MALDI) calcd for $C_{73}H_{80}IrN_5OSi_2$: m/z 1291.5531 Found: 1291.5529

**Synthesis Example 2 (Compound 295)**

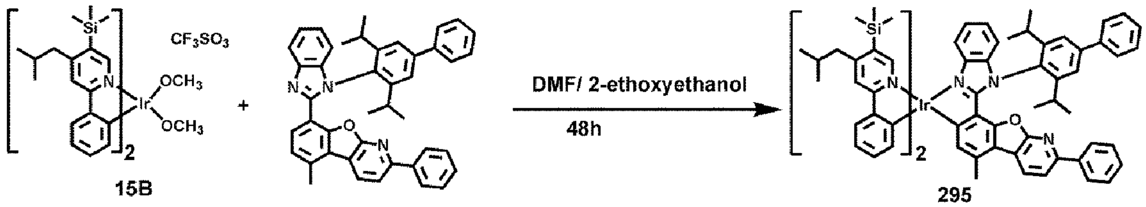


15B

295

0.78g (yield of 39%) of Compound 295 was obtained by using the same method as the synthesis method of Compound 15 of Synthesis Example 1, except that 8-(1-(3,5-diisopropyl-[1,1'-biphenyl]-4-yl)-1H-benzo[d]imidazol-2-yl)-5-methyl-2-phenylbenzofuro[2,3-b]pyridine was used instead of 8-(1-(3,5-diisopropyl-[1,1'-biphenyl]-4-yl)-1H-benzo[d]imidazol-2-yl)-2-methylbenzofuro[2,3-b]pyridine. The substance was identified by Mass spectrum and HPLC analysis.

HRMS(MALDI) calcd for $C_{81}H_{88}IrN_5OSi_2$: m/z 1395.9863 Found: 1395.96

**Synthesis Example 13 (Compound 184)**

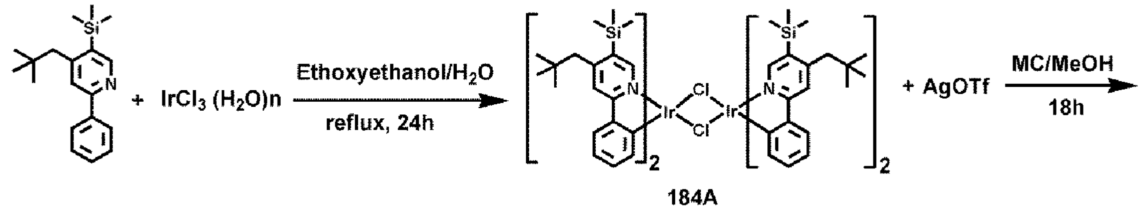


184A

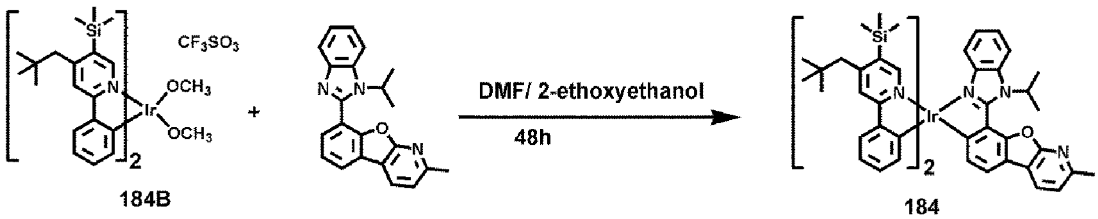


184B

184

Synthesis of Compound 184A

7.1 g (yield of 71%) of Compound 184A was obtained by using the same method as the synthesis method of Compound 15A of Synthesis Example 1, except that 4-neopentyl-2-phenyl-5-(trimethylsilyl)pyridine was used instead of 4-isobutyl-2-phenyl-5-(trimethylsilyl)pyridine.

Synthesis of Compound 184B

Compound 184B was obtained by using the same method as the synthesis method of Compound 15B of Synthesis Example 1, except that Compound 184A was used instead of Compound 15A. The obtained Compound 184B was used in the next reaction without further purification.

Synthesis of Compound 184

0.53 g (yield of 28%) of Compound 184 was obtained by using the same method as the synthesis method of Compound 15 of Synthesis Example 1, except that Compound 184B was used instead of Compound 15B, and 8-(1-isopropyl-1H-benzo[d]imidazol-2-yl)-2-methylbenzofuro[2,3-b]pyridine was used instead of 8-(1-(3,5-diisopropyl-[1,1'-biphenyl]-4-yl)-1H-benzo[d]imidazol-2-yl)-2-methylbenzofuro[2,3-b]pyridine. The substance was identified by Mass spectrum and HPLC analysis.

HRMS(MALDI) calcd for $C_{60}H_{70}IrN_5OSi_2$: m/z 1125.4748 Found: 1125.4744

**Synthesis Example 4 (Compound 212)**

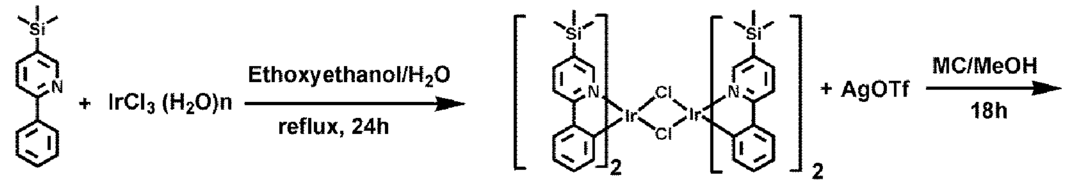


212A

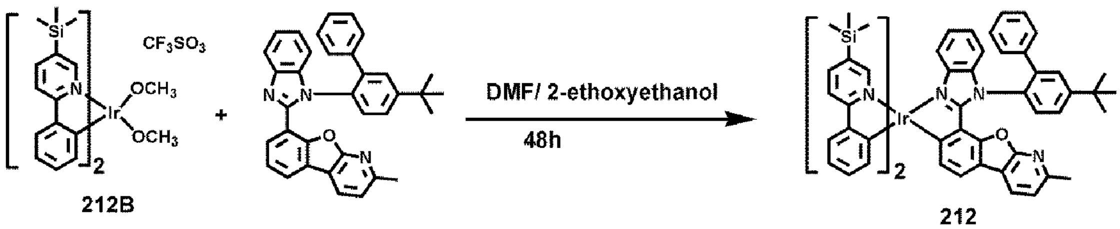


212B

212

Synthesis of Compound 212A

2-phenyl-5-(trimethylsilyl)pyridine (7.5 g, 33.1 mmol) and iridium chloride (5.2 g, 14.7 mmol) were mixed with 120 mL of ethoxyethanol and 40 mL of distilled water, and then the mixture was stirred while refluxing for 24 hours and cooled to room temperature. A solid material generated therefrom was separated by filtration and washed thoroughly with in the order of water/methanol/hexane to obtain a solid which was dried in a vacuum oven to obtain 8.2 g (yield of 82%) of Compound 212A.

Synthesis of Compound 212B

After Compound 212A (1.6 g, 1.2 mmol) and 45 mL of methylene chloride were mixed, AgOTf (0.6 g, 2.3 mmol) and 15 mL of methanol were mixed and added thereto. Subsequently, the mixture was stirred for 18 hours at room temperature while blocking light with aluminum foil, and then a solid (Compound 212B) obtained by removing a solid generated by celite filtration and decompressing a filtrate was used in the next reaction without additional purification.

Synthesis of Compound 212

Compound 212B (1.49 g, 1.74 mmol) and 8(-(1-(5-(tert-butyl)-[1,1'-biphenyl]-2-yl)-1H-benzo[d]imidazol-2-yl)-2-methylbenzofuro[2,3-b]pyridine) (0.97 g, 1.91 mmol) were mixed with 20 mL of 2-ethoxyethanol and 20 mL of dimethylformamide, and the mixture was stirred while refluxing for 48 hours at 130 °C, and then the temperature was lowered. A compound obtained therefrom was decompressed to obtain a solid which was then subjected to column chromatography using MC : hexane to obtain 0.73 g (yield of 37%) of Compound 212. The substance was identified by Mass spectrum and HPLC analysis.

HRMS(MALDI) calcd for $C_{63}H_{60}IrN_5OSi_2$: m/z 1151.3699 Found: 1151.3698

**Synthesis Example 5 (Compound 487)**

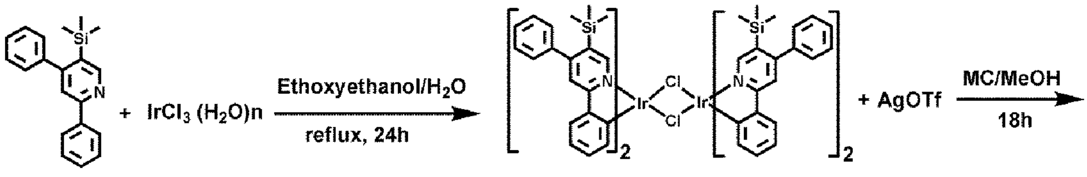


487A

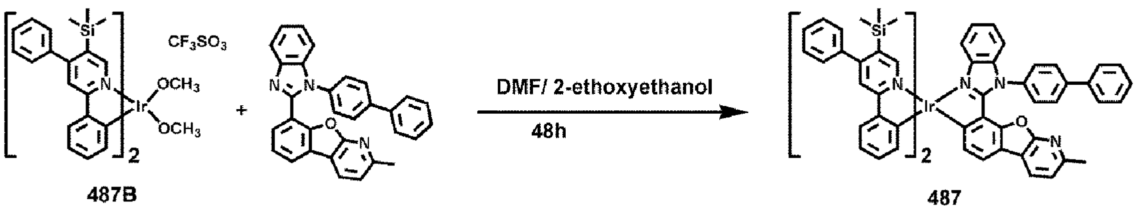


487B 487

Synthesis of Compound 487A

3.4 g (yield of 74%) of Compound 487A was obtained by using the same method as the synthesis method of Compound 212A of Synthesis Example 4, except that 2,4-diphenyl-5-(trimethylsilyl)pyridine was used instead of 2-phenyl-5-(trimethylsilyl)pyridine.

Synthesis of Compound 487B

Compound 487B was obtained by using the same method as the synthesis method of Compound 212B of Synthesis Example 4, except that Compound 487A was used instead of Compound 212A. The obtained Compound 487B was used in the next reaction without further purification.

Synthesis of Compound 487

0.84 g (yield of 42%) of Compound 487 was obtained by using the same method as the synthesis method of Compound 212 of Synthesis Example 4, except that Compound 487B was used instead of Compound 212B and 8-(1-([1,1'-biphenyl]-4-yl)-1H-benzo[d]imidazol-2-yl)-2-methylbenzofuro[2,3-b]pyridine was used instead of 8(-(1-(5-(tert-butyl)-[1,1'-biphenyl]-2-yl)-1H-benzo[d]imidazol-2-yl)-2-methylbenzofuro[2,3-b]pyridine. The substance was identified by Mass spectrum and HPLC analysis.

HRMS(MALDI) calcd for $C_{71}H_{60}IrN_5OSi_2$: m/z 1247.6570 Found: 1247.6571

**Synthesis Example 6 (Compound 982)**

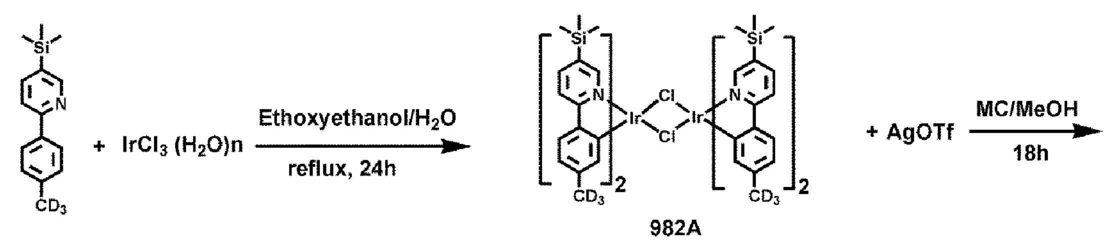


982A

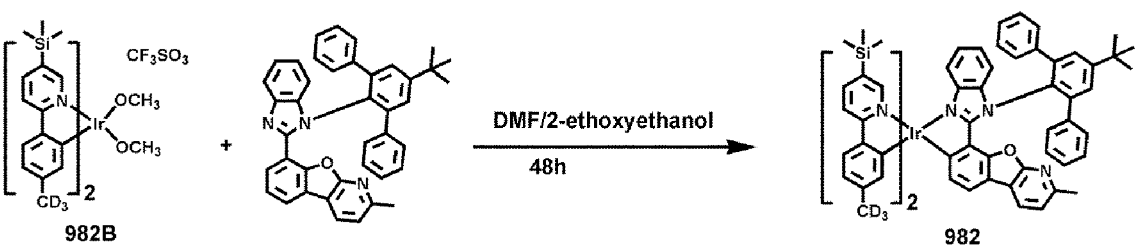


982B 982

Synthesis of Compound 982A

5.3 g (yield of 79%) of Compound 982A was obtained by using the same method as the synthesis method of Compound 212A of Synthesis Example 4, except that (2-(p-tolyl-$D_3$)-5-(trimethylsilyl)pyridine) was used instead of 2-phenyl-5-(trimethylsilyl)pyridine.

Synthesis of Compound 982B

Compound 982B was obtained by using the same method as the synthesis method of Compound 212B of Synthesis Example 4, except that Compound 982A was used instead of Compound 212A. The obtained Compound 982B was used in the next reaction without further purification.

Synthesis of Compound 982

0.78 g (yield of 39%) of Compound 982 was obtained by using the same method as the synthesis method of Compound 212 of Synthesis Example 4, except that Compound 982B was used instead of Compound 212B and 8-(1-(5'-(tert-butyl)-[1,1':3',1"-terphenyl]-2'-yl)-1H-benzo[d]imidazol-2-yl)-2-methylbenzofuro[2,3-b]pyridine was used instead of 8(-(1-(5-(tert-butyl)-[1,1'-biphenyl]-2-yl)-1H-benzo[d]imidazol-2-yl)-2-methylbenzofuro[2,3-b]pyridine. The substance was identified by Mass spectrum and HPLC analysis.

HRMS(MALDI) calcd for $C_{71}H_{62}D_6IrN_5OSi_2$: m/z 1261.4968 Found: 1261.4956

**Synthesis Example 7 (Compound 1042)**

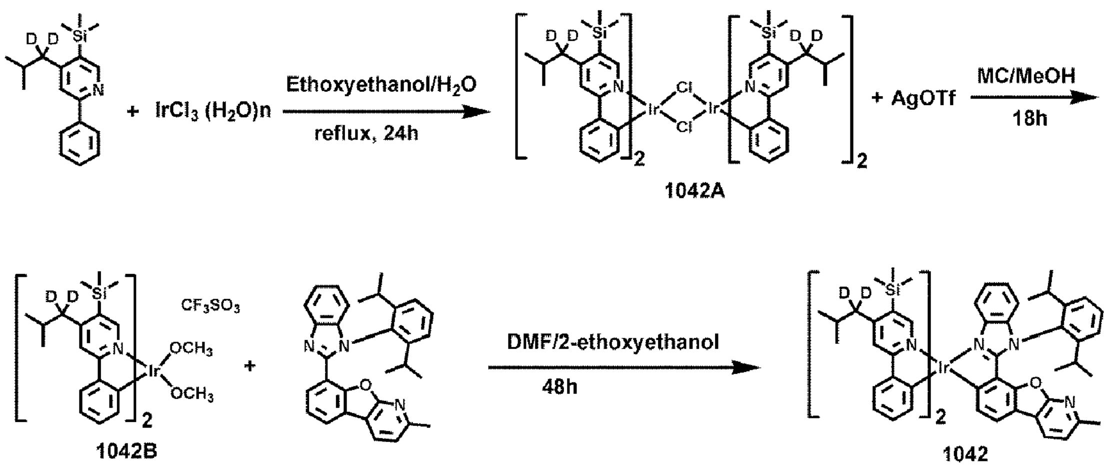


Synthesis of Compound 1042A

2.5 g (yield of 68%) of Compound 1042A was obtained by using the same method as the synthesis method of Compound 212A of Synthesis Example 4, except that 4-isobutyl($D_2$)-2-phenyl-5-(trimethylsilyl)pyridine was used instead of 2-phenyl-5-(trimethylsilyl)pyridine.

Synthesis of Compound 1042B

Compound 1042B was obtained by using the same method as the synthesis method of Compound 212B of Synthesis Example 4, except that Compound 1042A was used instead of Compound 212A. The obtained Compound 1042B was used in the next reaction without further purification.

Synthesis of Compound 1042

0.49 g (yield of 33%) of Compound 1042 was obtained by using the same method as the synthesis method of Compound 212 of Synthesis Example 4, except that Compound 1042B was used instead of Compound 212B and 8-(1-(2,6-diisopropylphenyl)-1H-benzo[d]imidazol-2-yl)-2-methylbenzofuro[2,3-b]pyridine was used instead of

8(-(1-(5-(tert-butyl)-[1,1'-biphenyl]-2-yl)-1H-benzo[d]imidazol-2-yl)-2-methylbenzofuro[2,3-b]pyridine. The substance was identified by Mass spectrum and HPLC analysis.

HRMS(MALDI) calcd for $C_{67}H_{71}D_4IrN_4OSi_2$: m/z 1204.5360 Found: 1204.5364.

## Synthesis Example 8 (Compound 1229)

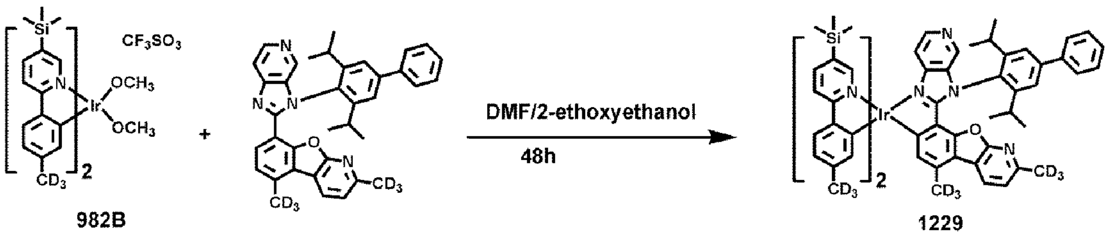


982B

1229

0.35 g of (yield of 23%) of Compound 1229 was obtained by using the same method as the synthesis method of Compound 212 of Synthesis Example 4, except that Compound 982B was used instead of Compound 212B and 8-(3-(3,5-diisopropyl-[1,1'-biphenyl]-4-yl)-3H-imidazo[4,5-c]pyridin-2-yl)-2,5-dimethyl($D_6$)benzofuro[2,3-b]pyridine was used instead of 8(-(1-(5-(tert-butyl)-[1,1'-biphenyl]-2-yl)-1H-benzo[d]imidazol-2-yl)-2-methylbenzofuro[2,3-b]pyridine. The substance was identified by Mass spectrum and HPLC analysis.

HRMS(MALDI) calcd for $C_{68}H_{58}D_{12}IrN_6OSi_2$: m/z 1234.5454 Found: 1234.5450.

## Synthesis Example 9 (Compound 1550)

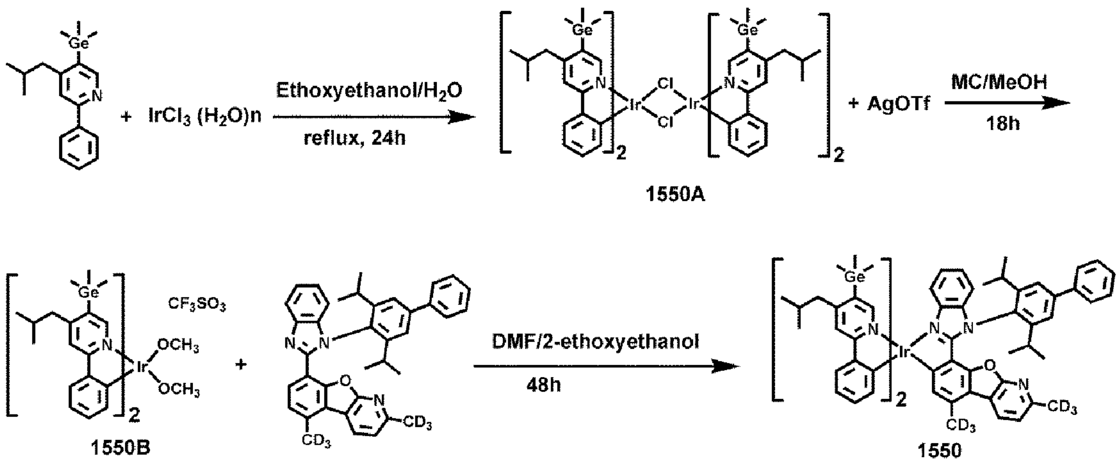


1550B

1550

Synthesis of Compound 1550A

3.3 g (yield of 65%) of Compound 1550A was obtained by using the same method as the synthesis method of Compound 15A of Synthesis Example 1, except that 4-isobutyl-2-phenyl-5-(trimethylgermyl)pyridine was used instead of 4-isobutyl-2-phenyl-5-(trimethylsilyl)pyridine.

Synthesis of Compound 1550B

Compound 1550B was obtained by using the same method as the synthesis method of Compound 15B of Synthesis Example 1, except that Compound 1550A was used instead of Compound 15A. The obtained Compound 1550B was used in the next reaction without further purification.

Synthesis of Compound 1550

0.56 g (yield of 28%) of Compound 1550 was obtained by using the same method as the synthesis method of Compound 15 of Synthesis Example 1, except that Compound 1550B was used instead of Compound 15B and (8-(1-(3,5-diisopropyl-[1,1'-biphenyl]-4-yl)-1H-benzo[d]imidazol-2-yl)-2,5-dimethyl($D_6$)benzofuro[2,3-b]pyridine) was used instead of 8-(1-(3,5-diisopropyl - [1,1'-biphenyl]-4-yl)-1H-benzo[d]imidazol-2-yl)-2-methylbenzofuro[2,3-b]pyridine. The substance was identified by Mass spectrum and HPLC analysis.

HRMS(MALDI) calcd for $C_{74}H_{76}D_6Ge_2IrN_5O$: m/z 1403.4949 Found: 1403.4946

**Synthesis Example 10 (Compound 1725)**

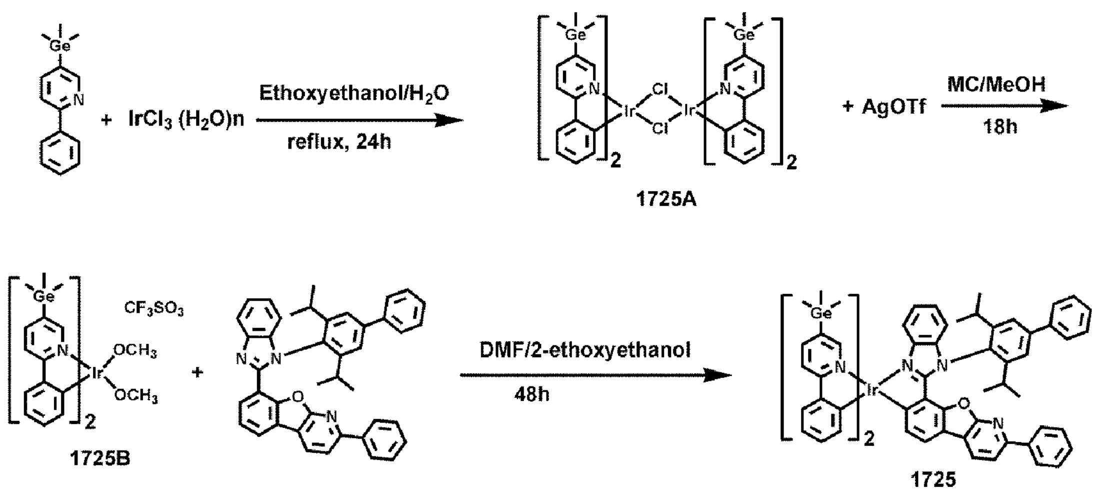


1725A

1725B

1725

Synthesis of Compound 1725A

2.1 g (yield of 61%) of Compound 1725A was obtained by using the same method as the synthesis method of Compound 212A of Synthesis Example 4, except that 2-phenyl-5-(trimethylgermyl)pyridine was used instead of 2-phenyl-5-(trimethylsilyl)pyridine.

Synthesis of Compound 1725B

Compound 1725B was obtained by using the same method as the synthesis method of Compound 212B of Synthesis Example 4, except that Compound 1725A was used instead of Compound 212A. The obtained Compound 1725B was used in the next reaction without further purification.

Synthesis of Compound 1725

0.76 g (yield of 38%) of Compound 1725 was obtained by using the same method as the synthesis method of Compound 212 of Synthesis Example 4, except that Compound 1725B was used instead of Compound 212B and 8-(1-(3,5-diisopropyl-[1,1'-biphenyl]-4-yl)-1H-benzo[d]imidazol-2-yl)-2-phenylbenzofuro[2,3-b]pyridine was used instead of 8(-(1-(5-(tert-butyl)-[1,1'-biphenyl]-2-yl)-1H-benzo[d]imidazol-2-yl)-2-methylbenzofuro[2,3-b]pyridine. The substance was identified by Mass spectrum and HPLC analysis.

HRMS(MALDI) calcd for $C_{70}H_{66}Ge_2IrN_5O$: m/z 1333.3320 Found: 1333.3318

**Synthesis Example 11 (Compound 2610)**

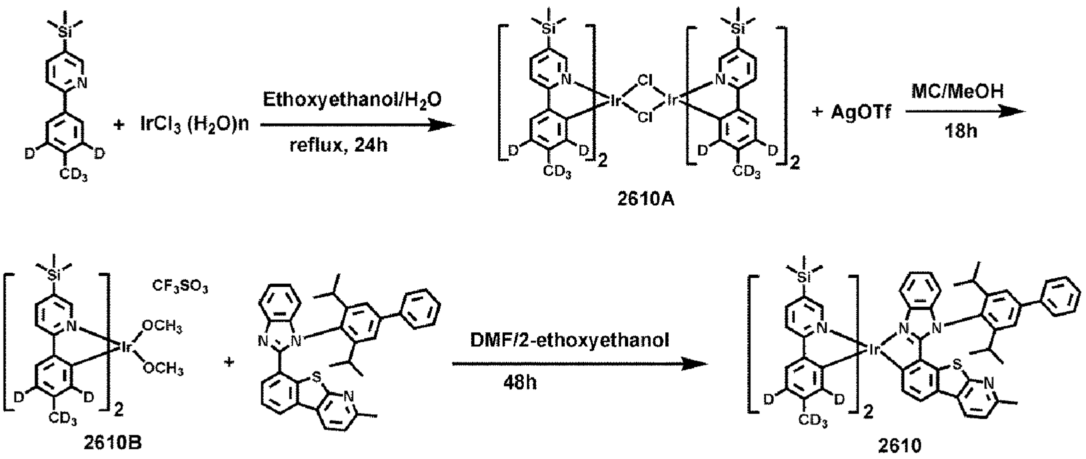


2610A

2610B

2610

Synthesis of Compound 2610A

2.4 g (yield of 64%) of Compound 2610A was obtained by using the same method as the synthesis method of Compound 212A of Synthesis Example 4, except that 2-(p-tolyl-$D_5$)-5-(trimethylsilyl)pyridine was used instead of 2-phenyl-5-(trimethylsilyl)pyridine.

Synthesis of Compound 2610B

Compound 2610B was obtained by using the same method as the synthesis method of Compound 212B of Synthesis Example 4, except that Compound 2610A was used instead of Compound 212A. The obtained Compound 2610B was used in the next reaction without further purification.

Synthesis of Compound 2610

0.73 g (yield of 37%) of Compound 2610 was obtained by using the same method of the synthesis method of Compound 212 of Synthesis Example 4, except that Compound 2610B was used instead of Compound 212B and 8-(1-(3,5-diisopropyl-[1,1'-biphenyl]-4-yl)-1H-benzo[d]imidazol-2-yl)-2-methylbenzo[4,5]thieno[2,3-b]pyridine was used instead of 8(-(1-(5-(tert-butyl)-[1,1'-biphenyl]-2-yl)-1H-benzo[d]imidazol-2-yl)-2-methylbenzofuro[2,3-b]pyridine. The substance was identified by Mass spectrum and HPLC analysis.

HRMS(MALDI) calcd for $C_{67}H_{58}D_{10}IrN_5SSi_2$: m/z 1233.4991 Found: 1233.4988

**Synthesis Example 12 (Compound 2755)**

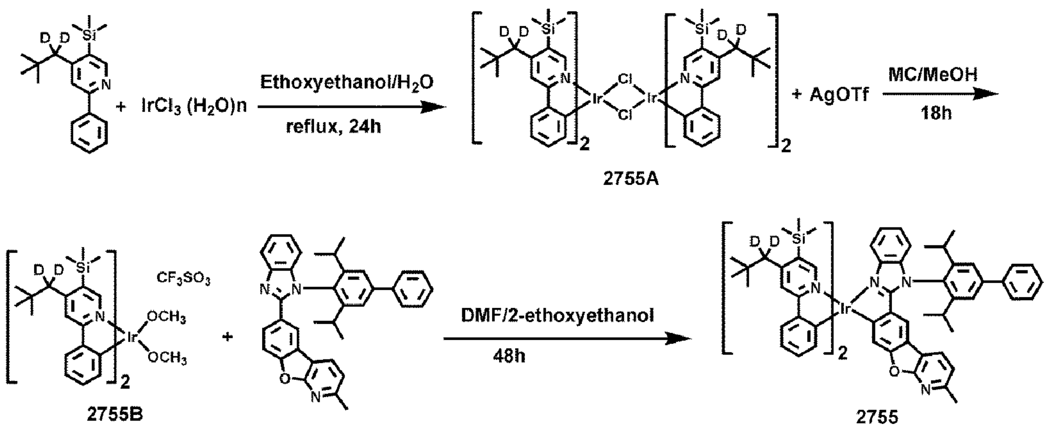


2755A

2755B

2755

Synthesis of Compound 2755A

4.2 g (yield of 81%) of Compound 2755A was obtained by using the same method as the synthesis method of Compound 212A of Synthesis Example 4, except that 4-neopentyl($D_2$)-2-phenyl-5-(trimethylsilyl)pyridine was used instead of 2-phenyl-5-(trimethylsilyl)pyridine.

Synthesis of Compound 2755B

Compound 2755B was obtained by using the same method as the synthesis method of Compound 212B of Synthesis Example 4, except that Compound 2755A was used instead of Compound 212A. The obtained Compound 2755B was used in the next reaction without further purification.

Synthesis of Compound 2755

0.65 g (yield of 33%) of Compound 2755 was obtained by using the same method as the synthesis method of Compound 212 of Synthesis Example 4, except that Compound 2755B was used instead of Compound 212B and 6-(1-(3,5-diisopropyl-[1,1'-biphenyl]-4-yl)-1H-benzo[d]imidazol-2-yl)-2-methylbenzofuro[2,3-b]pyridine was used instead of 8(-(1-(5-(tert-butyl)-[1,1'-biphenyl]-2-yl)-1H-benzo[d]imidazol-2-yl)-2-methylbenzofuro[2,3-b]pyridine. The substance was identified by Mass spectrum and HPLC analysis.

HRMS(MALDI) calcd for $C_{75}H_{80}IrN_5OSi_2$: m/z 1323.6095 Found: 1323.6090

**Synthesis Example 13 (Compound 3214)**

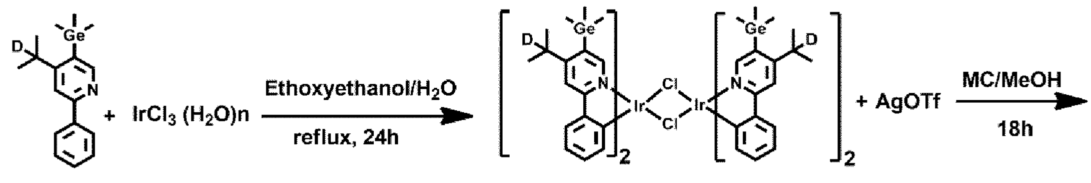


3214A

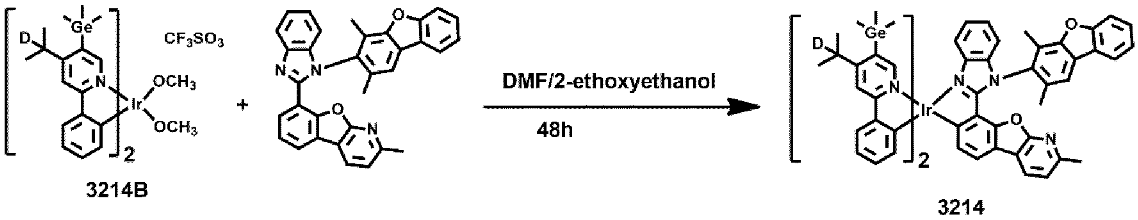


3214B

3214

Synthesis of Compound 3214A

8.0 g (yield of 80%) of Compound 3214A was obtained by using the same method as the synthesis method of Compound 212A of Synthesis Example 4, except that 2-phenyl-4-(propan-2-yl-2-D)-5-(trimethylgermyl)pyridine was used instead of 2-phenyl-5-(trimethylsilyl)pyridine.

Synthesis of Compound 3214B

Compound 3214B was obtained by using the same method as the synthesis method of Compound 212B of Synthesis Example 4, except that Compound 3214A was used instead of Compound 212A. The obtained Compound 3214B was used in the next reaction without further purification.

Synthesis of Compound 3214

0.76 g (yield of 38%) of Compound 3214 was obtained by using the same method as the synthesis method of Compound 212 of Synthesis Example 4, except that Compound 3214B was used instead of Compound 212B and

8-(1-(2,4-dimethyldibenzo[b,d]furan-3-yl)-1H-benzo[d]imidazol-2-yl)-2-methylbenzofuro[2,3-b]pyridine was used instead of 8(-(1-(5-(tert-butyl)-[1,1'-biphenyl]-2-yl)-1H-benzo[d]imidazol-2-yl)-2-methylbenzofuro[2,3-b]pyridine. The substance was identified by Mass spectrum and HPLC analysis.

HRMS(MALDI) calcd for $C_{67}H_{64}D_2Ge_2N_5O_2$: m/z 1315.3395 Found: 1315.3394

## Synthesis Example 14 (Compound 3275)

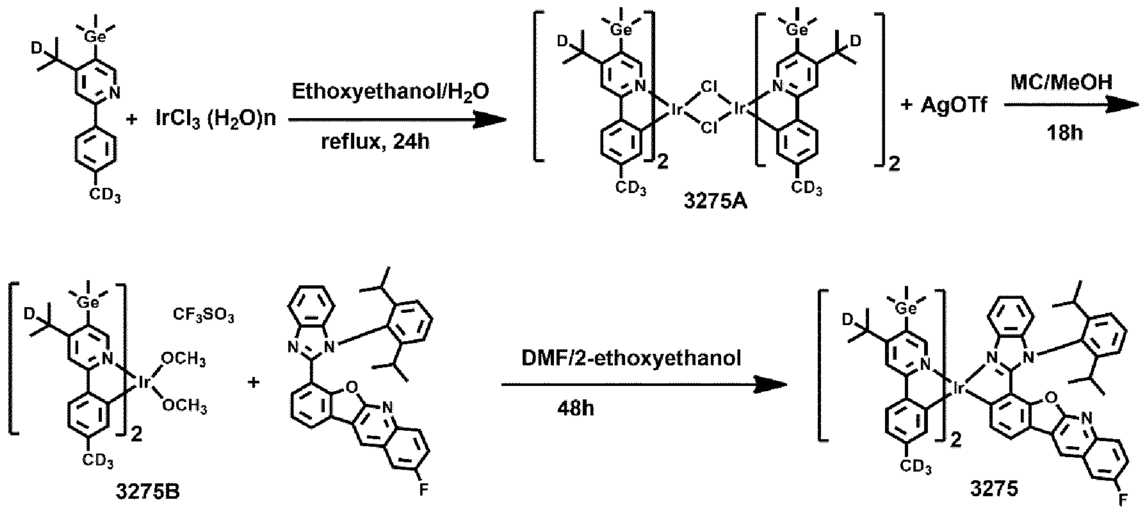


Synthesis of Compound 3275A

8.5 g (yield of 71%) of Compound 3275A was obtained by using the same method as the synthesis method of Compound 212A of Synthesis Example 4, except that 2-(4-(methyl-d3)phenyl)-4-(propan-2-yl-2-d)-5-(trimethylgermyl)pyridine was used instead of 2-phenyl-5-(trimethylsilyl)pyridine.

Synthesis of Compound 3275B

Compound 3275B was obtained by using the same method as the synthesis method of Compound 212B of Synthesis Example 4, except that Compound 3275A was used instead of Compound 212A. The obtained Compound 3275B was used in the next reaction without further purification.

Synthesis of Compound 3275

0.61 g (yield of 34%) of Compound 3275 was obtained by using the same method as the synthesis method of Compound 212 of Synthesis Example 4, except that Compound 3275B was used instead of Compound 212B and 4-(1-(2,6-diisopropylphenyl)-1H-benzo[d]imidazol-2-yl)-9-fluorobenzofuro[2,3-b]quinolone was used instead of 8(-(1-(5-(tert-butyl)-[1,1'-biphenyl]-2-yl)-1H-benzo[d]imidazol-2-yl)-2-methylbenzofuro[2,3-b]pyridine. The substance was identified by Mass spectrum and HPLC analysis.

HRMS(MALDI) calcd for $C_{70}H_{67}D_8FGe_2IrN_5O$: m/z 1369.4511 Found: 1369.4509

## Synthesis Example 15 (Compound 3492)

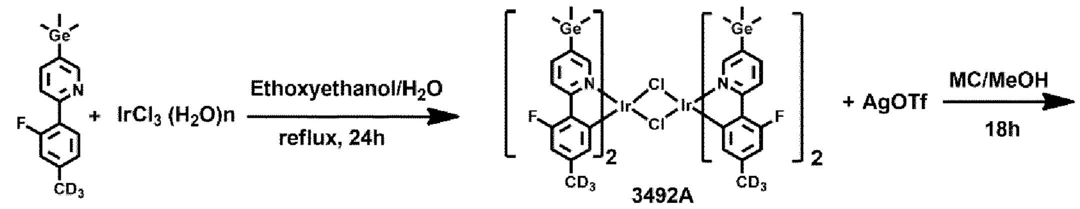


3492A

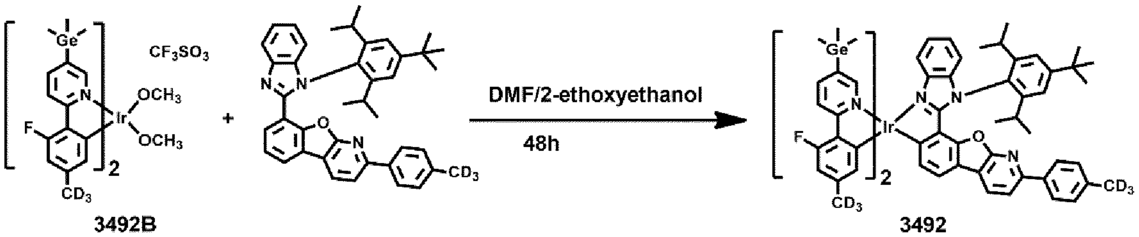


3492B 3492

Synthesis of Compound 3492A

9.0 g (yield of 75%) of Compound 3492A was obtained by using the same method as the synthesis method of Compound 212A of Synthesis Example 4, except that 2-(2-fluoro-4-(methyl-*d*$_3$)phenyl)-5-(trimethylgermyl)pyridine was used instead of 2-phenyl-5-(trimethylsilyl)pyridine.

Synthesis of Compound 3492B

Compound 3492B was obtained by using the same method as the synthesis method of Compound 212B of Synthesis Example 4, except that Compound 3492A was used instead of Compound 212A. The obtained Compound 3492B was used in the next reaction without further purification.

Synthesis of Compound 3492

0.59 g (yield of 35%) of Compound 3492 was obtained by using the same method as the synthesis method of Compound 212 of Synthesis Example 4, except that Compound 3492B was used instead of Compound 212B and 8-(1-(4-(tert-butyl)-2,6-diisopropylphenyl)-1H-benzo[d]imidazol-2-yl)-2-(4-(methyl-*d*$_3$)phenyl)benzofuro[2,3-b]pyridine was used instead of 8(-(1-(5-(tert-butyl)-[1,1'-biphenyl]-2-yl)-1H-benzo[d]imidazol-2-yl)-2-methylbenzofuro[2,3-b]pyridine. The substance was identified by Mass spectrum and HPLC analysis.

HRMS(MALDI) calcd for $C_{71}H_{65}D_9F_2Ge_2IrN_5O$: m/z 1400.4479 Found: 1400.4477

**Synthesis Example 16 (Compound 3553)**

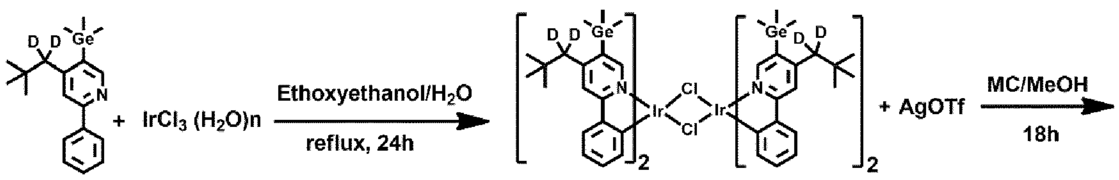


3553A

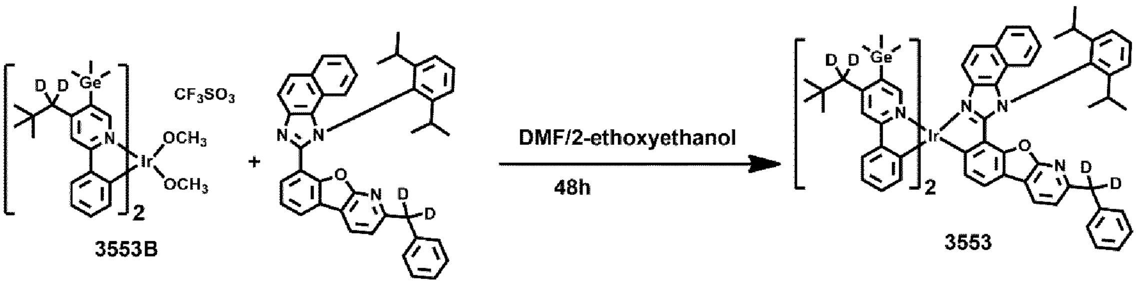


3553B 3553

Synthesis of Compound 3553A

8.5 g (yield of 77%) of Compound 3553A was obtained by using the same method as the synthesis method of Compound 212A of Synthesis Example 4, except that 4-(2,2-dimethylpropyl-1,1-d2)-2-phenyl-5-(trimethylgermyl)pyridine was used instead of 2-phenyl-5-(trimethylsilyl)pyridine.

Synthesis of Compound 3553B

Compound 3553B was obtained by using the same method as the synthesis method of Compound 212B of Synthesis Example 4, except that Compound 3553A was used instead of Compound 212A. The obtained Compound 3553B was used in the next reaction without further purification.

Synthesis of Compound 3553

0.55 g (yield of 32%) of Compound 3553 was obtained by using the same method as the synthesis method of Compound 212 of Synthesis Example 4, except that Compound 3553B was used instead of Compound 212B and 8-(1-(2,6-diisopropylphenyl)-1H-naphtho[1,2-d]imidazol-2-yl)-2-(phenylmethyl-d2)benzofuro[2,3-b]pyridine was used instead of 8(-(1-(5-(tert-butyl)-[1,1'-biphenyl]-2-yl)-1H-benzo[d]imidazol-2-yl)-2-methylbenzofuro[2,3-b]pyridine. The substance was identified by Mass spectrum and HPLC analysis.

HRMS(MALDI) calcd for $C_{79}H_{80}D_6Ge_2IrN_5O$: m/z 1467.5262 Found: 1467.5260

**Example 1**

As an anode, a glass substrate with ITO patterned thereon was cut to a size of 50mm × 50mm × 0.5mm, sonicated by using isopropyl alcohol and pure water for 5 minutes each, and then irradiated with ultraviolet light for 30 minutes and exposed to ozone for cleaning. Then, the resultant glass substrate was loaded onto a vacuum deposition apparatus.

Compound HT3 and F6-TCNNQ were vacuum deposited at a weight ratio of 98:2 on the anode to form a hole injection layer having a thickness of 100 Å, and Compound HT3 was vacuum deposited on the hole injection layer to form a hole transport layer having a thickness of 1650 Å.

Subsequently, Compound CBP (host) and Compound 15 (dopant) were co-depostied at a weight ratio of 95:5 on the hole transport layer to form an emission layer having a thickness of 400 Å.

Thereafter, Compound ET3 and ET-D1 were co-deposited at a volume ratio of 50:50 on the emission layer to form an electron transport layer having a thickness of 350 Å, ET-D1 was vacuum deposited on the electron transport layer to form an electron injection layer having a thickness of 10 Å, and Al was vacuum deposited on the electron injection layer to form a cathode having a thickness of 1000 Å, and thereby an organic light-emitting device was manufactured.

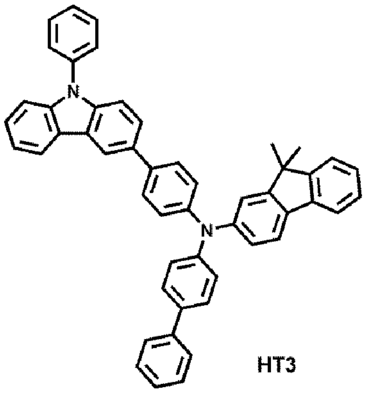

HT3

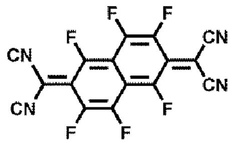

F6-TCNNQ

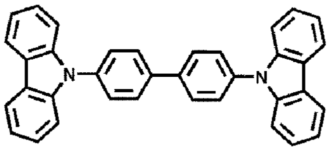

CBP

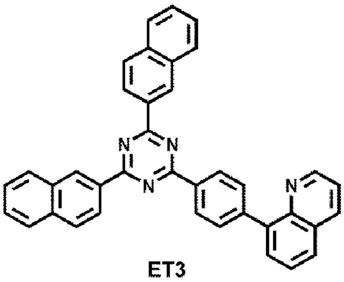

ET3

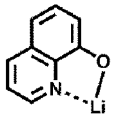

ET-D1

## Examples 2 to 15 and Comparative Examples A to C

Organic light-emitting devices were manufactured in the same manner as in Example 1, except that in forming an emission layer, for use as a dopant, corresponding compounds shown in Table 2 were used instead of Compound 15.

## Evaluation Example 1

For each organic light-emitting device manufactured in Examples 1 to 15 and Comparative Examples A to C, the maximum value of external quantum efficiency (Max EQE), roll-off ratio, and lifespan ($LT_{97}$) were evaluated. The results are shown in Table 2. This evaluation was performed using a current-voltage meter (Keithley 2400) and a luminescence meter (Minolta Cs-1,000A), and the lifespan ($LT_{97}$) (at 9000 nit (wherein 1 nit = 1 cd/$m^2$)) was expressed as a relative value (%) by evaluating the time (hr) for the luminance of 97% with respect to the initial luminance of 100%. The roll-off ratio was calculated by the following equation 20.

<Equation 20>

$$\text{Roll-off ratio} = \{1 - (\text{efficiency (at 9000nit)} / \text{maximum luminescent efficiency})\} \times 100\%$$

[Table 2]

| | Dopant in emission layer Compound No. | Max EQE (%) | Roll-off ratio (%) | $LT_{97}$ (a relative value, %) (at 9000nit) |
|---|---|---|---|---|
| Example 1 | 15 | 27.6 | 10 | 134 |
| Example 2 | 184 | 25.6 | 16 | 100 |
| Example 3 | 212 | 27.1 | 11 | 156 |
| Example 4 | 295 | 26.5 | 12 | 114 |
| Example 5 | 982 | 25.6 | 14 | 106 |
| Example 6 | 1042 | 27.2 | 15 | 98 |

(continued)

| | Dopant in emission layer Compound No. | Max EQE (%) | Roll-off ratio (%) | $LT_{97}$ (a relative value, %) (at 9000nit) |
|---|---|---|---|---|
| Example 7 | 1229 | 24.7 | 14 | 99 |
| Example 8 | 1550 | 25.1 | 15 | 100 |
| Example 9 | 1725 | 27.5 | 12 | 145 |
| Example 10 | 2610 | 28.0 | 11 | 172 |
| Example 11 | 2755 | 24.5 | 10 | 138 |
| Example 12 | 3214 | 27.4 | 12 | 130 |
| Example 13 | 3275 | 27.1 | 13 | 210 |
| Example 14 | 3492 | 27.8 | 10 | 102 |
| Example 15 | 3553 | 27.1 | 14 | 125 |
| Comparative Example A | A | 23.2 | 20 | 50 |
| Comparative Example B | B | 20.9 | 28 | 42 |
| Comparative Example C | C | 19.6 | 25 | 30 |

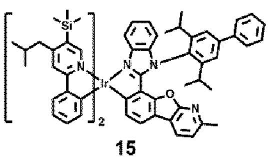
15

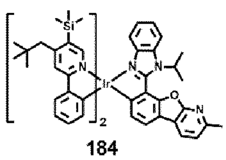
184

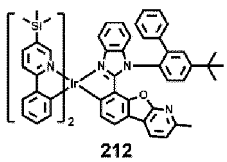
212

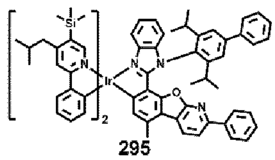
295

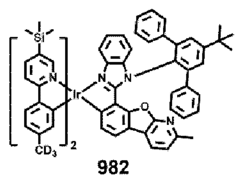
982

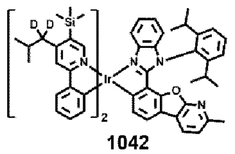
1042

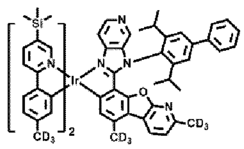
1229

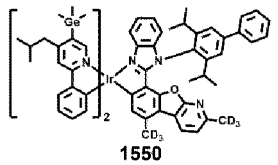
1550

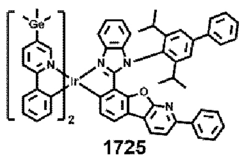
1725

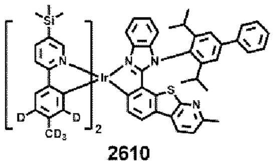
2610

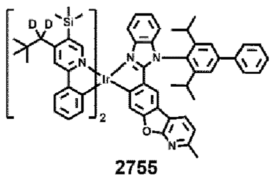
2755

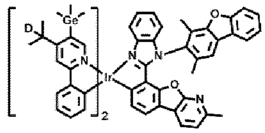
3214

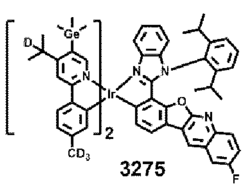
3275

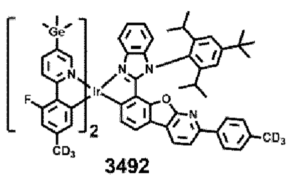
3492

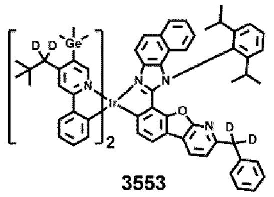
3553

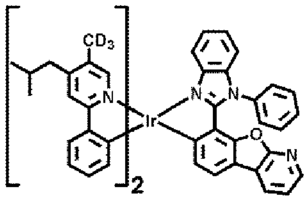

A

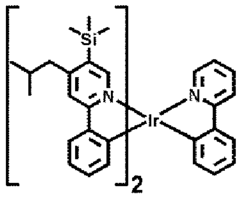

B

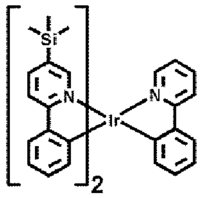

C

From Table 2, it was confirmed that the organic light-emitting devices of Example 1 to 15 may have improved external quantum efficiency, improved roll-off ratio, and improved lifespan characteristics compared to the organic light-emitting devices of Comparative Examples A to C.

The organometallic compound has excellent electrical characteristics, and thus an electronic device including the organometallic compound, for example, an organic light-emitting device, may have improved external quantum efficiency and improved lifespan characteristics.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

**1.** An organometallic compound represented by Formula 1:

<Formula 1> $M(L_1)_{n1}(L_2)_{n2}$

wherein, in Formula 1,

M is a transition metal,
$L_1$ is a ligand represented by Formula 2,
$L_2$ is a ligand represented by Formula 3,
n1 and n2 are each independently 1 or 2, when n1 is 2, two $L_1$(s) are identical to or different from each other, and when n2 is 2, two $L_2$(s) are identical to or different from each other.

<Formula 2>

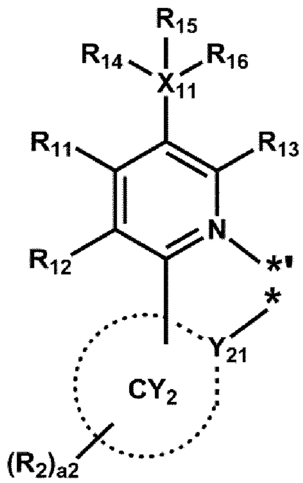

<Formula 3>

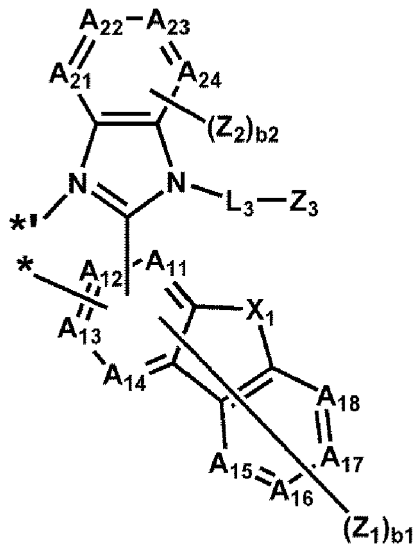

wherein, in Formulae 2 and 3,

$Y_{21}$ is C or N,
ring $CY_2$ is a $C_5$-$C_{30}$ carbocyclic group or $C_1$-$C_{30}$ heterocyclic group,
$X_{11}$ is Si or Ge,
$X_1$ is O, S, Se, $N(Z_{19})$, $C(Z_{19})(Z_{20})$, or $Si(Z_{19})(Z_{20})$,
$A_{11}$ to $A_{14}$ are each independently C or N, wherein one of $A_{11}$ to $A_{14}$ is C bonded to a group represented by

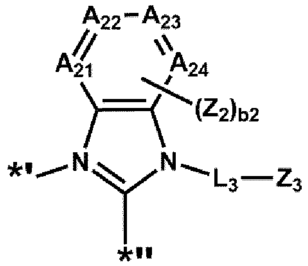

in Formula 3, and one of the remaining $A_{11}$ to $A_{14}$ is C bonded to M in Formula 1,
$A_{15}$ to $A_{18}$ and $A_{21}$ to $A_{24}$ are each independently C or N,
at least one of $A_{11}$ to $A_{18}$ is N,
$L_3$ is a single bond, a $C_5$-$C_{30}$ carbocyclic group that is unsubstituted or substituted with at least one $R_{10a}$, or a $C_1$-$C_{30}$ heterocyclic group that is unsubstituted or substituted with at least one $R_{10a}$,
$R_2$, $R_{11}$ to $R_{16}$, $Z_1$ to $Z_3$, $Z_{19}$, and $Z_{20}$ are each independently hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$ or $-P(Q_8)(Q_9)$,
a2 is an integer from 0 to 20, and when a2 is 2 or more, two or more $R_2$(s) are identical to or different from each other,
b1 is an integer from 0 to 5, and when b1 is 2 or more, two or more $Z_1$(s) are identical to or different from each other,
b2 is an integer from 0 to 4, and when b2 is 2 or more, two or more $Z_2$(s) are identical to or different from each other,
$R_{11}$ and $R_{12}$ are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
two or more of a plurality of $R_2$(s) are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
two or more of a plurality of $Z_1$(s) are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
two or more of a plurality of $Z_2$(s) are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
$R_{10a}$ is the same as explained in connection with $Z_1$, and
* and *' each indicate a binding site to M in Formula 1,
wherein a substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl

group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group is:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, carboxylic acid group or a salt thereof, sulfonic acid group or a salt thereof, phosphoric acid group or a salt thereof, a $C_1$-$C_{60}$ alkyl group, a $C_2$-$C_{60}$ alkenyl group, a $C_2$-$C_{60}$ alkynyl group, $C_1$-$C_{60}$ alkoxy group, or a $C_1$-$C_{60}$ alkylthio group;
a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, - Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, carboxylic acid group or a salt thereof, sulfonic acid group or a salt thereof, phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$, or any combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with deuterium, -F, -Cl, - Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, carboxylic acid group or a salt thereof, sulfonic acid group or a salt thereof, phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, $-P(Q_{28})(Q_{29})$, or any combination thereof;
$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$, or $-P(Q_{38})(Q_{39})$; or
any combination thereof;
wherein $Q_1$ to $Q_9$, $Q_{11}$ to $Q_{19}$, $Q_{21}$ to $Q_{29}$, and $Q_{31}$ to $Q_{39}$ are each independently: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, -F, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_1$-$C_{60}$ alkylthio group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, -F, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_1$-$C_{60}$ heteroaryl group; a monovalent non-aromatic condensed polycyclic group; or a monovalent non-aromatic condensed heteropolycyclic group.

**2.** The organometallic compound of claim 1, wherein

the ring $CY_2$ is a benzene group, a naphthalene group, an anthracene group, a phenanthrene group, a 1,2,3,4-tetrahydronaphthalene group, a carbazole group, a fluorene group, a dibenzosilole group, a dibenzothiophene group, or a dibenzofuran group; and/or
wherein $L_3$ in Formula 3 is:

a single bond, or
a benzene group, a naphthalene group, a dibenzofuran group, or a dibenzothiophene group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group,

a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

**3.** The organometallic compound of claims 1 or 2, wherein
$R_2$, $R_{11}$ to $R_{13}$, $Z_1$ to $Z_3$, $Z_{19}$ and $Z_{20}$ in Formulae 2 and 3 are each independently:

hydrogen, deuterium, -F, or a cyano group; or
a $C_1$-$C_{20}$ alkyl group, a $C_3$-$C_{10}$ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, -Si($Q_{33}$)($Q_{34}$)($Q_{35}$), -Ge($Q_{33}$)($Q_{34}$)($Q_{35}$), or any combination thereof, and
$R_{14}$ to $R_{16}$ in Formula 2 are each independently a $C_1$-$C_{20}$ alkyl group, a $C_3$-$C_{10}$ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

**4.** The organometallic compound of any of claims 1-3, wherein $R_{11}$ is not hydrogen; and/or
wherein the organometallic compound satisfies at least one of <Condition A> and <Condition B> :

<Condition A>
$L_3$ is a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$.
<Condition B>
$Z_3$ is a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

**5.** The organometallic compound of any of claims 1-4, wherein $Z_1$ is not hydrogen, and b1 is an integer from 1 to 5; and/or wherein

a group represented by

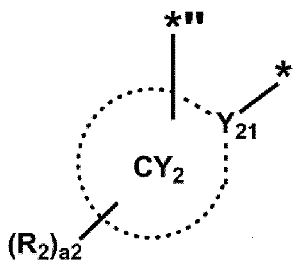

in Formula 2 is a group represented by one of Formulae CY2-1 to CY2-33:

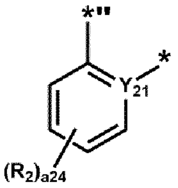
CY2-1
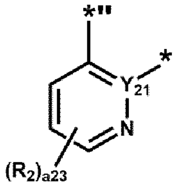
CY2-2
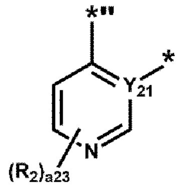
CY2-3
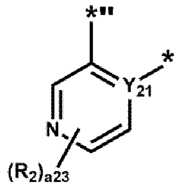
CY2-4
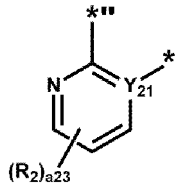
CY2-5

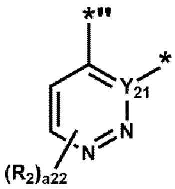
CY2-6
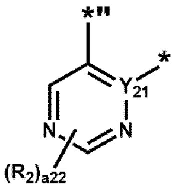
CY2-7
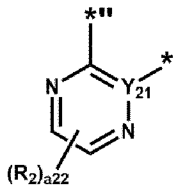
CY2-8
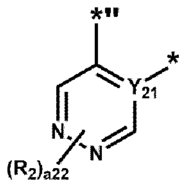
CY2-9
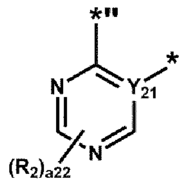
CY2-10

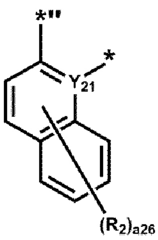
CY2-11
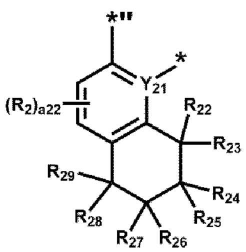
CY2-12
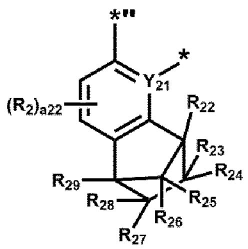
CY2-13
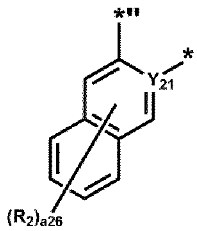
CY2-14
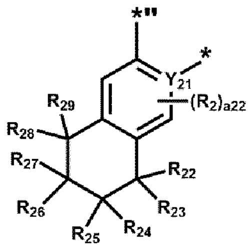
CY2-15

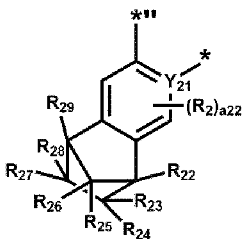
CY2-16
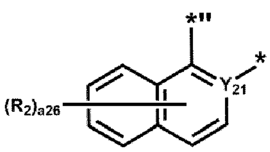
CY2-17
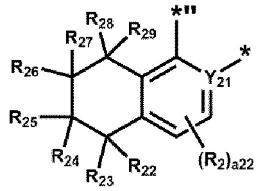
CY2-18
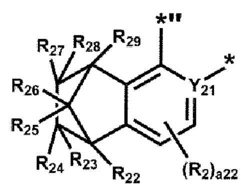
CY2-19

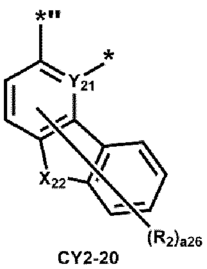
CY2-20
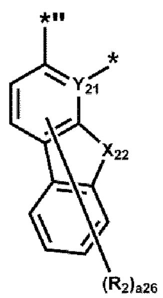
CY2-21
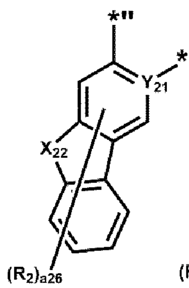
CY2-22
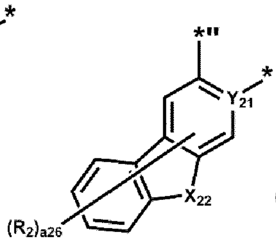
CY2-23
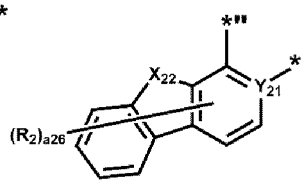
CY2-24

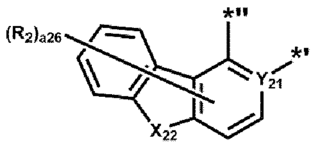
CY2-25

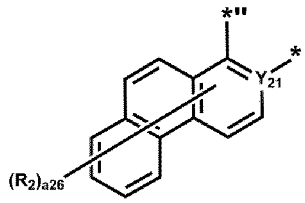
CY2-26

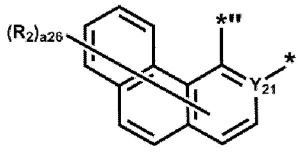
CY2-27

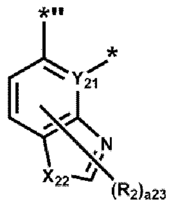
CY2-28

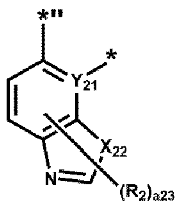
CY2-29

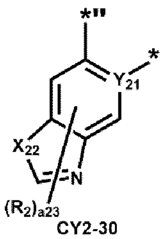
CY2-30

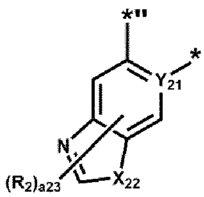
CY2-31

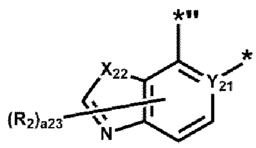
CY2-32

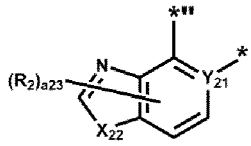
CY2-33

wherein, in Formulae CY2-1 to CY2-33,

$Y_{21}$ and $R_2$ are the same as described in claim 1,
$X_{22}$ is $C(R_{22})(R_{23})$, $N(R_{22})$, O, S, or $Si(R_{22})(R_{23})$,
$R_{22}$ to $R_{29}$ are each the same as described in claim 1 in connection with $R_2$,
a28 is an integer from 0 to 8,
a26 is an integer from 0 to 6,
a24 is an integer from 0 to 4,
a23 is an integer from 0 to 3,
a22 is an integer from 0 to 2,
*" indicates a binding site to a neighboring atom in Formula 2, and
* indicates a binding site to M in Formula 1.

**6.** The organometallic compound of any of claims 1-5, wherein

a group represented by

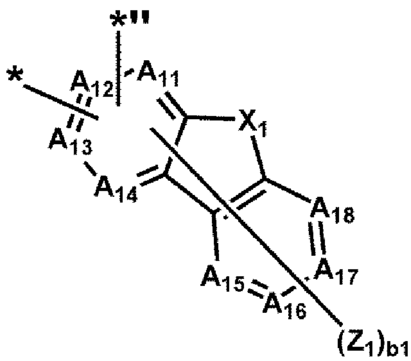

in Formula 3 is a group represented by one of Formulae CY3-1 to CY3-6:

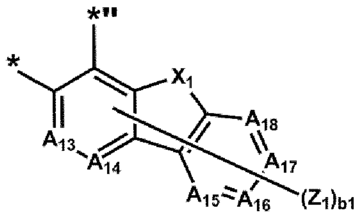

CY3-1

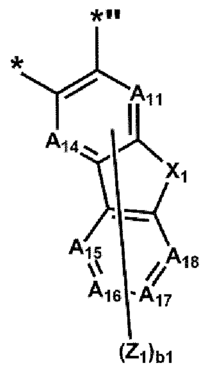

CY3-2

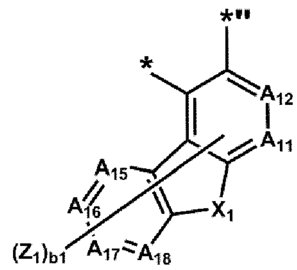

CY3-3

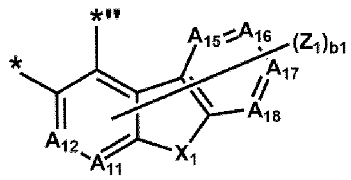

CY3-4

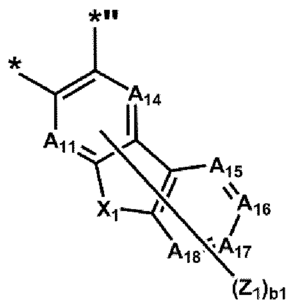

CY3-5

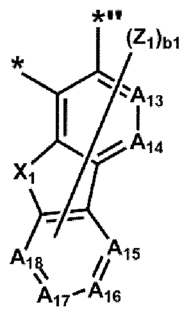

CY3-6

wherein, in Formulae CY3-1 to CY3-6,

$X_1$, $Z_1$ and b1 are the same as described in claim 1,
$A_{11}$ to $A_{18}$ are each independently C or N, wherein at least one of $A_{13}$ to $A_{18}$ in Formulae CY3-1 and CY3-6 is N, at least one of $A_{11}$, $A_{14}$, $A_{15}$, $A_{16}$, $A_{17}$ and $A_{18}$ in Formulae CY3-2 and CY3-5 is N, and at least one of $A_{11}$, $A_{12}$, $A_{15}$, $A_{16}$, $A_{17}$ and $A_{18}$ in Formulae CY3-3 and CY3-4 is N,
* indicates a binding site to M in Formula 1, and
*" indicates a binding site to a neighboring atom in Formula 3.

**7.** The organometallic compound of any of claims 1-5, wherein

a group represented by

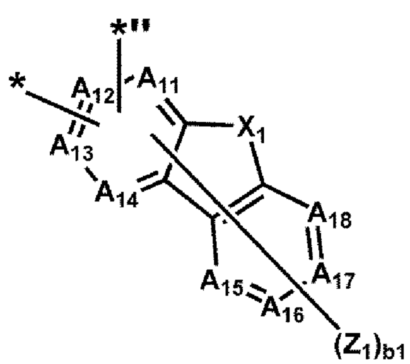

in Formula 3 is a group represented by one of Formulae CY3-1-1 to CY3-1-6, CY3-2-1 to CY3-2-6, CY3-3-1 to CY3-3-6, CY3-4-1 to CY3-4-6, CY3-5-1 to CY3-5-6, and CY3-6-1 to CY3-6-6:

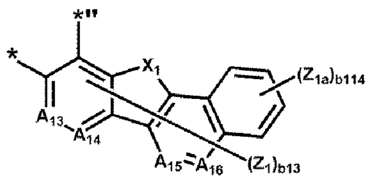
CY3-1-1

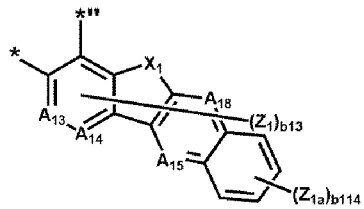
CY3-1-2

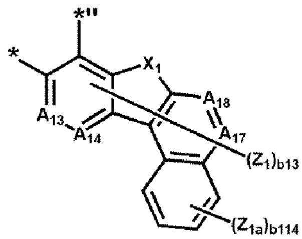
CY3-1-3

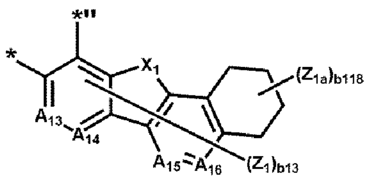
CY3-1-4

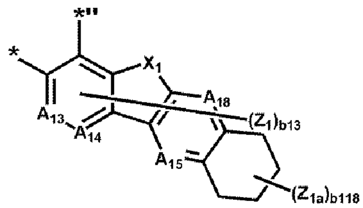
CY3-1-5

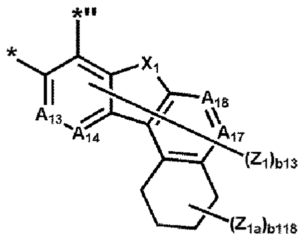
CY3-1-6

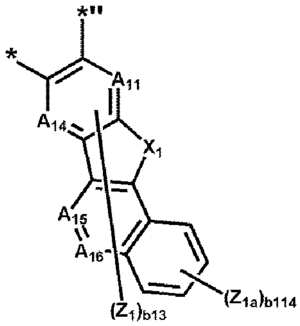
CY3-2-1

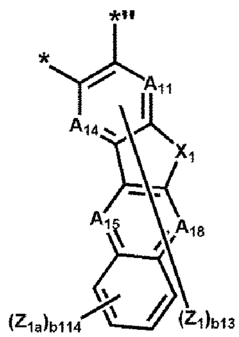
CY3-2-2

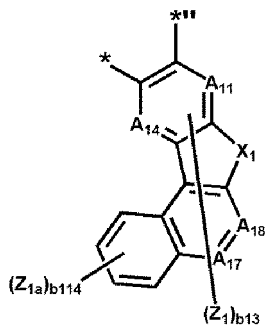
CY3-2-3

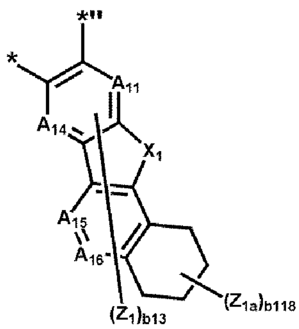
CY3-2-4

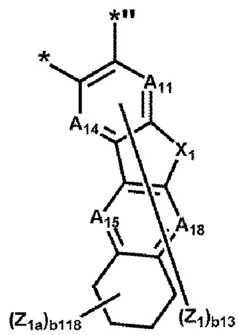
CY3-2-5

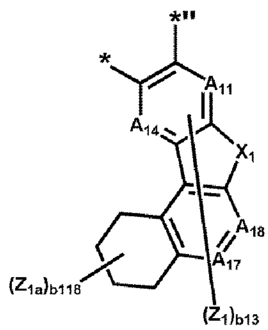
CY3-2-6

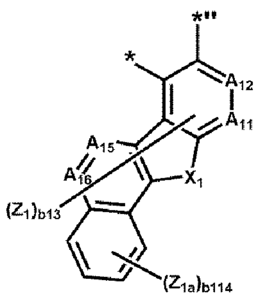
CY3-3-1

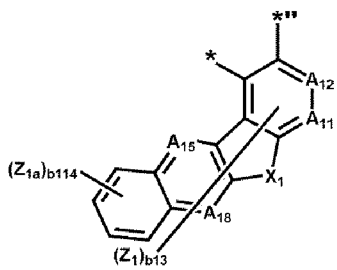
CY3-3-2

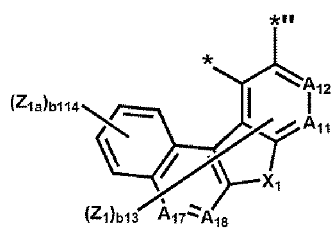
CY3-3-3

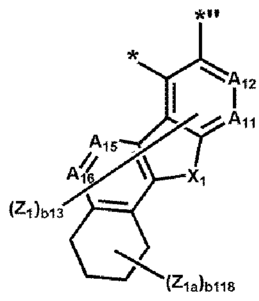
CY3-3-4

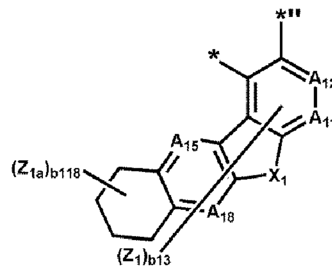
CY3-3-5

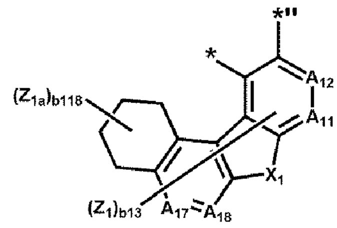
CY3-3-6

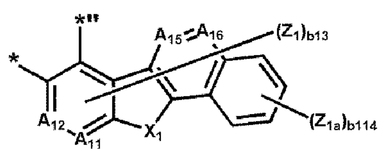
CY3-4-1

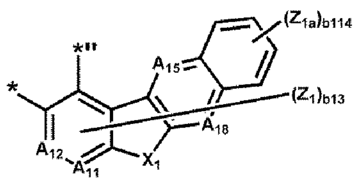
CY3-4-2

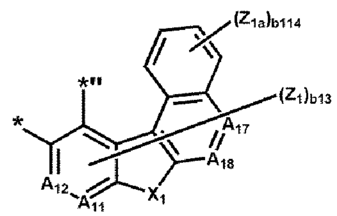
CY3-4-3

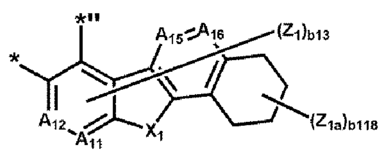
CY3-4-4

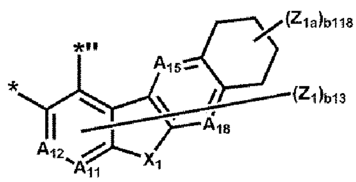
CY3-4-5

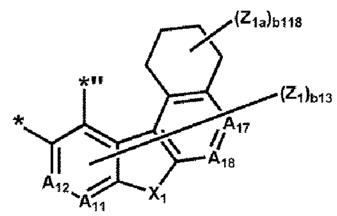
CY3-4-6

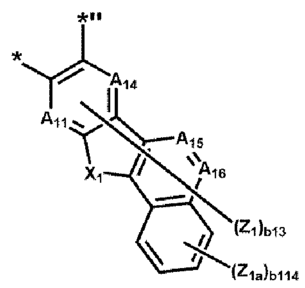
CY3-5-1

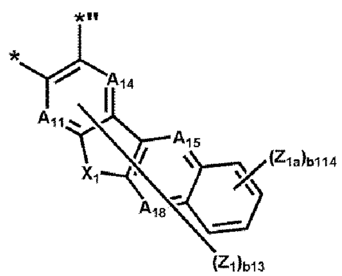
CY3-5-2

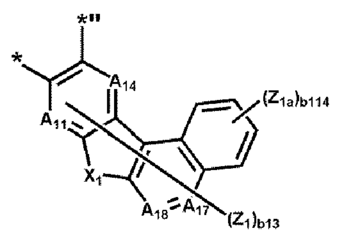
CY3-5-3

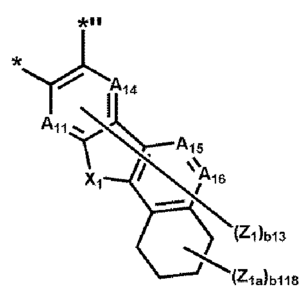
CY3-5-4

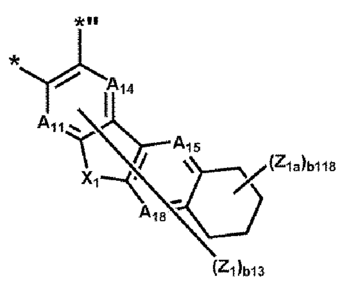
CY3-5-5

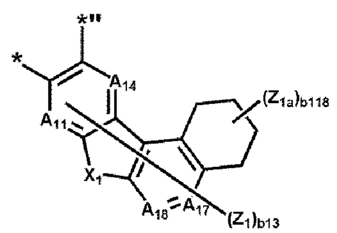
CY3-5-6

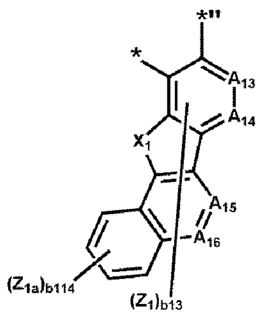

CY3-6-1

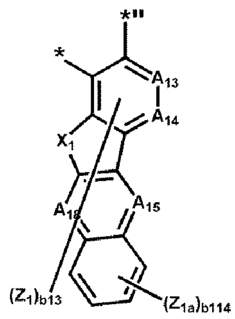

CY3-6-2

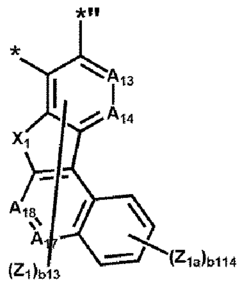

CY3-6-3

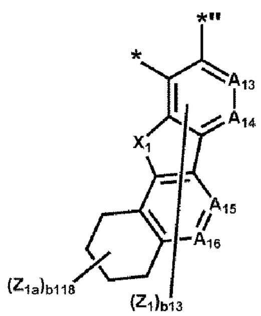

CY3-6-4

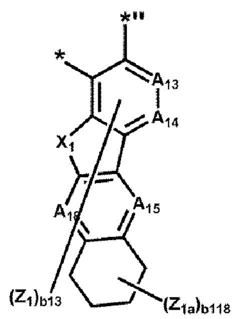

CY3-6-5

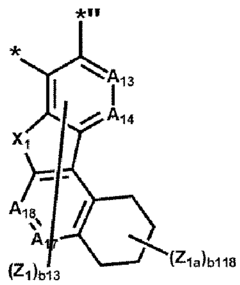

CY3-6-6

wherein, in Formulae CY3-1-1 to CY3-1-6, CY3-2-1 to CY3-2-6, CY3-3-1 to CY3-3-6, CY3-4-1 to CY3-4-6, CY3-5-1 to CY3-5-6, and CY3-6-1 to CY3-6-6,

$X_1$ and $Z_1$ are the same as described in claim 1,
$Z_{1a}$ is the same as described in claim 1 in connection with $R_{1a}$,
$A_{11}$ to $A_{18}$ are each independently C or N, wherein a) at least one of $A_{13}$, $A_{14}$, $A_{15}$, and $A_{16}$ in Formulae CY3-1-1, CY3-1-4, CY3-6-1, and CY3-6-4 is N, b) at least one of $A_{13}$, $A_{14}$, $A_{15}$, and $A_{18}$ in Formulae CY3-1-2, CY3-1-5, CY3-6-2, and CY3-6-5 is N, c) at least one of $A_{13}$, $A_{14}$, $A_{17}$, and $A_{18}$ in Formulae CY3-1-3, CY3-1-6, CY3-6-3, and CY3-6-6 is N, d) at least one of $A_{11}$, $A_{14}$, $A_{15}$, and $A_{16}$ in Formulae CY3-2-1, CY3-2-4, CY3-5-1, and CY3-5-4 is N, e) at least one of $A_{11}$, $A_{14}$, $A_{15}$, and $A_{18}$ in Formulae CY3-2-2, CY3-2-5, CY3-5-2, and CY3-5-5 is N, f) at least one of $A_{11}$, $A_{14}$, $A_{17}$, and $A_{18}$ in Formulae CY3-2-3, CY3-2-6, CY3-5-3, and CY3-5-6 is N, g) at least one of $A_{11}$, $A_{12}$, $A_{15}$, and $A_{16}$ in Formulae CY3-3-1, CY3-3-4, CY3-4-1, and CY3-4-4 is N, h) at least one of $A_{11}$, $A_{12}$, $A_{15}$, and $A_{18}$ in Formulae CY3-3-2, CY3-3-5, CY3-4-2, and CY3-4-5 is N, i) at least one of $A_{11}$, $A_{12}$, $A_{17}$, and $A_{18}$ in Formulae CY3-3-3, CY3-3-6, CY3-4-3, and CY3-4-6 is N,
b13 is an integer from 0 to 3,
b114 is an integer from 0 to 4,
b118 is an integer from 0 to 8,
* indicates a binding site to M in Formula 1, and
*" indicates a binding site to a neighboring atom in Formula 3.

**8.** The organometallic compound of any of claims 1-5, wherein

a group represented by

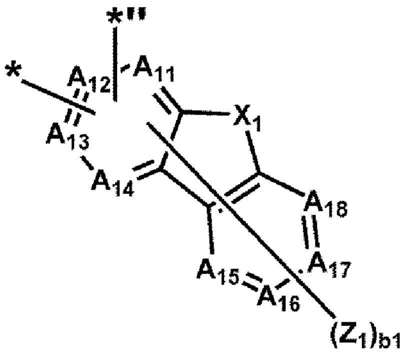

in Formula 3 is a group represented by one of Formulae NCY3(1) to NCY3(84):

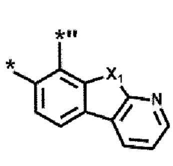
NCY3(1)

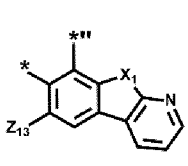
NCY3(2)

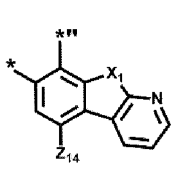
NCY3(3)

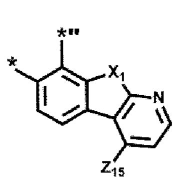
NCY3(4)

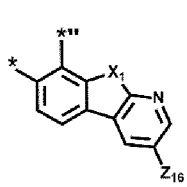
NCY3(5)

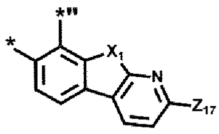
NCY3(6)

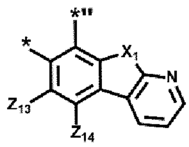
NCY3(7)

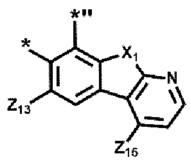
NCY3(8)

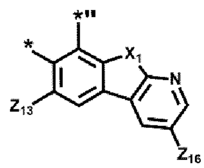
NCY3(9)

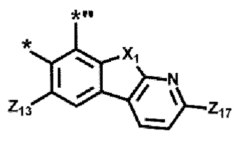
NCY3(10)

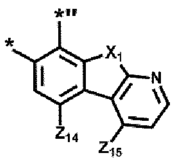
NCY3(11)

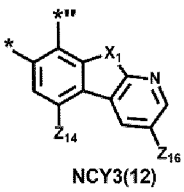
NCY3(12)

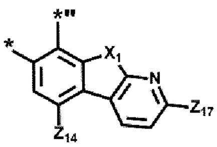
NCY3(13)

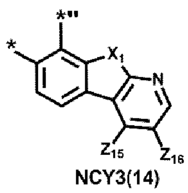
NCY3(14)

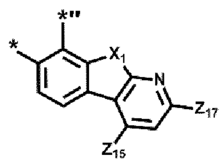
NCY3(15)

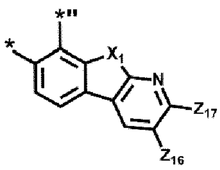
NCY3(16)

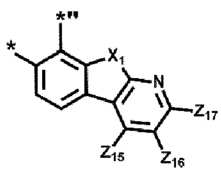
NCY3(17)

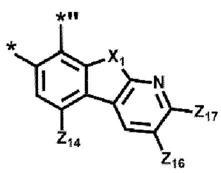
NCY3(18)

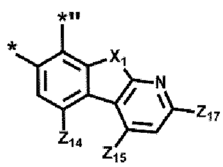
NCY3(19)

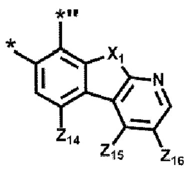
NCY3(20)

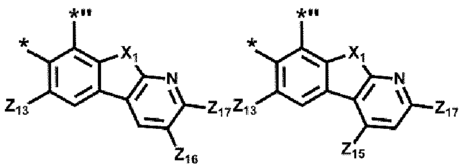
NCY3(21)

NCY3(22)

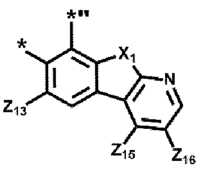
NCY3(23)

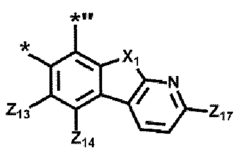
NCY3(24)

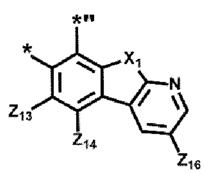
NCY3(25)

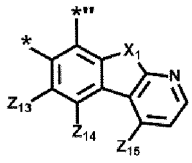
NCY3(26)

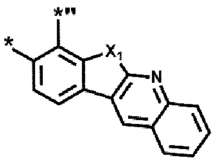
NCY3(27)

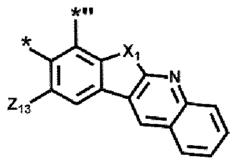
NCY3(28)

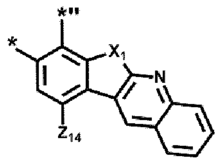
NCY3(29)

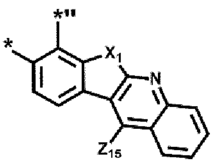
NCY3(30)

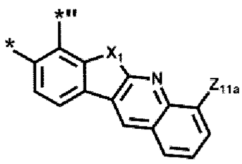
NCY3(31)

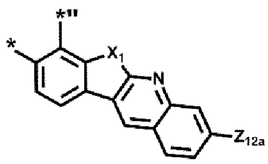
NCY3(32)

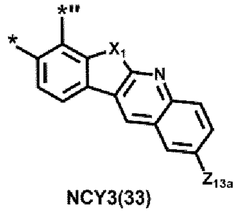
NCY3(33)

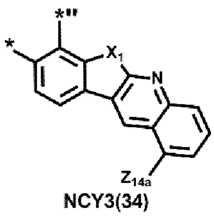
NCY3(34)

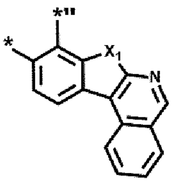
NCY3(35)

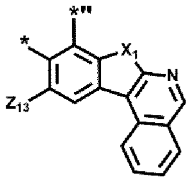
NCY3(36)

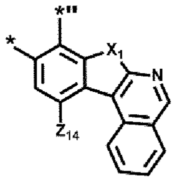
NCY3(37)

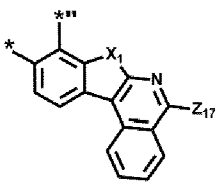
NCY3(38)

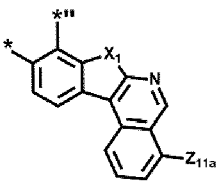
NCY3(39)

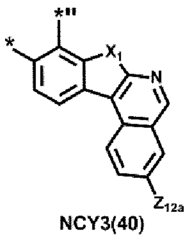
NCY3(40)

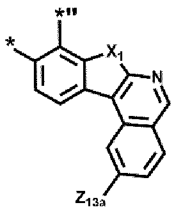
NCY3(41)

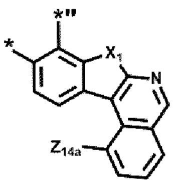
NCY3(42)

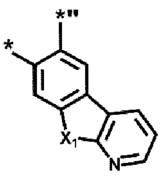
NCY3(43)

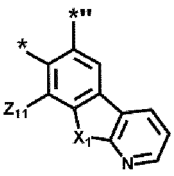
NCY3(44)

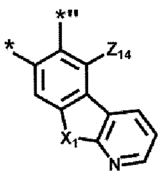
NCY3(45)

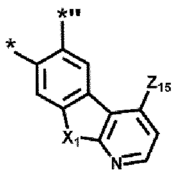
NCY3(46)

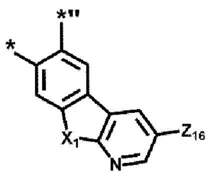
NCY3(47)

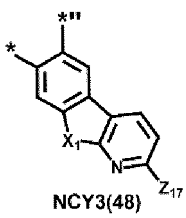
NCY3(48)

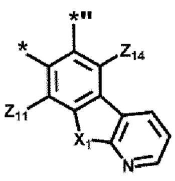
NCY3(49)

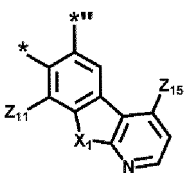
NCY3(50)

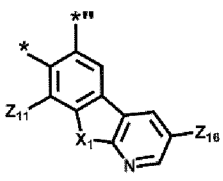
NCY3(51)

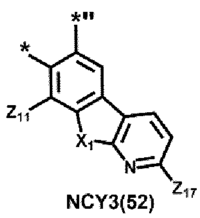
NCY3(52)

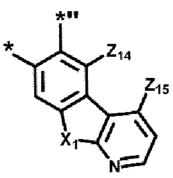
NCY3(53)

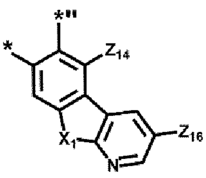
NCY3(54)

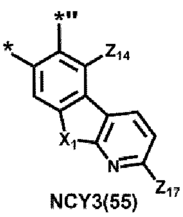
NCY3(55)

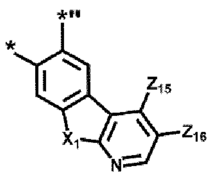
NCY3(56)

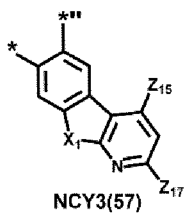
NCY3(57)

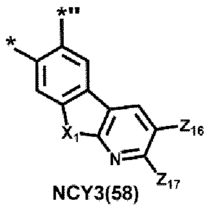
NCY3(58)

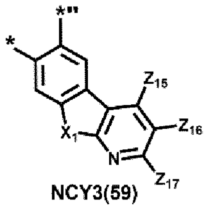
NCY3(59)

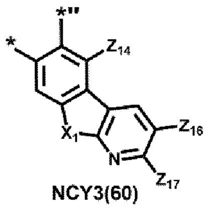
NCY3(60)

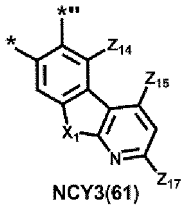
NCY3(61)

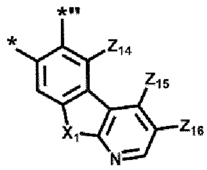
NCY3(62)

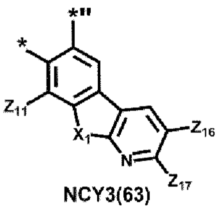
NCY3(63)

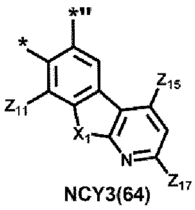
NCY3(64)

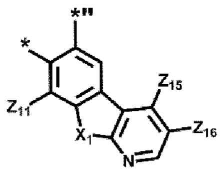
NCY3(65)

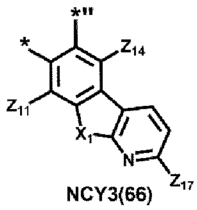
NCY3(66)

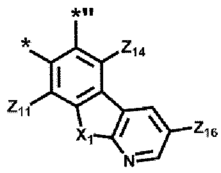
NCY3(67)

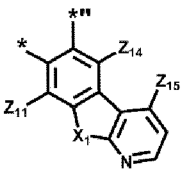
NCY3(68)

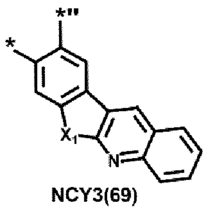
NCY3(69)

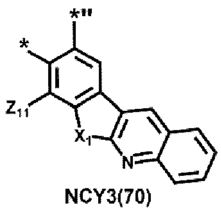
NCY3(70)

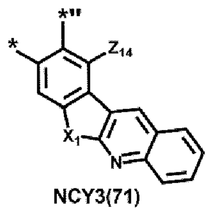
NCY3(71)

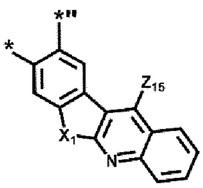
NCY3(72)

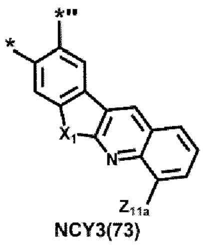
NCY3(73)

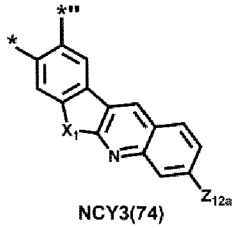
NCY3(74)

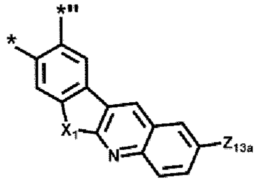
NCY3(75)

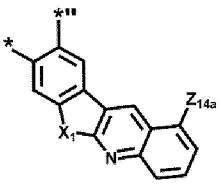
NCY3(76)

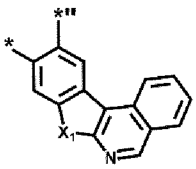
NCY3(77)

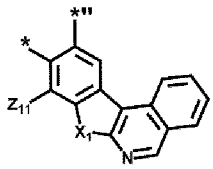
NCY3(78)

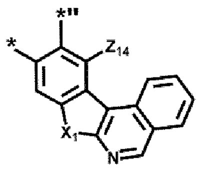
NCY3(79)

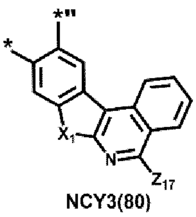
NCY3(80)

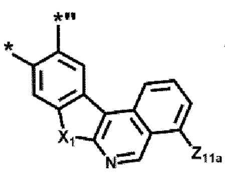
NCY3(81)

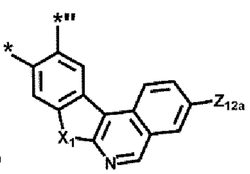
NCY3(82)

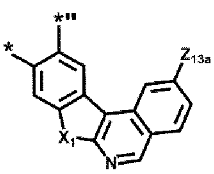
NCY3(83)

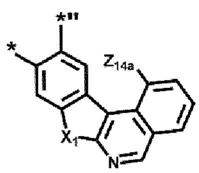
NCY3(84)

wherein, in Formulae NCY3(1) to NCY3(84),

$X_1$ is the same as described in claim 1,
$Z_{11}$ to $Z_{18}$ and $Z_{11a}$ to $Z_{14a}$ $Z_{1a}$ are each the same as described in claim 1 in connection with $Z_1$, and each of $Z_{11}$ to $Z_{18}$ and $Z_{11a}$ to $Z_{14a}$ $Z_{1a}$ is not hydrogen,
* indicates a binding site to M in Formula 1, and
*" indicates a binding site to a neighboring atom in Formula 3.

**9.** The organometallic compound of any of claims 1-8, wherein

a group represented by

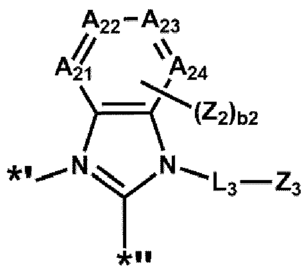

in Formula 3 is a group represented by one of Formulae CY4-1 to CY4-60:

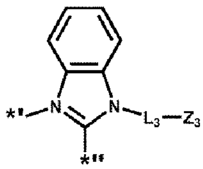
CY4-1

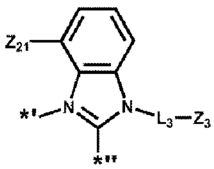
CY4-2

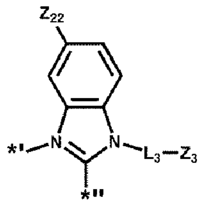
CY4-3

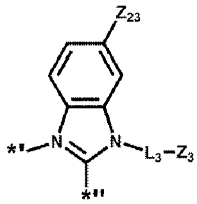
CY4-4

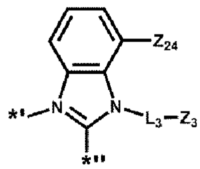
CY4-5

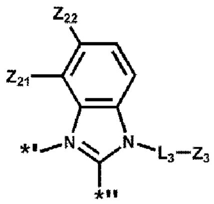
CY4-6

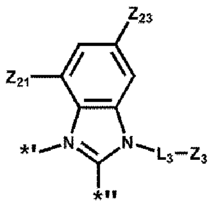
CY4-7

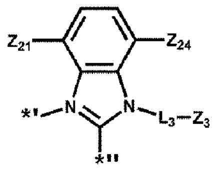
CY4-8

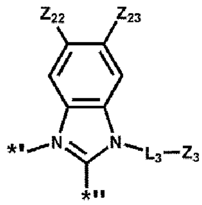
CY4-9

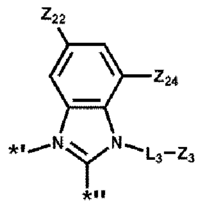
CY4-10

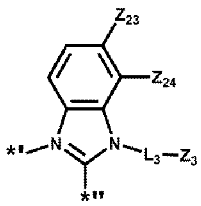
CY4-11

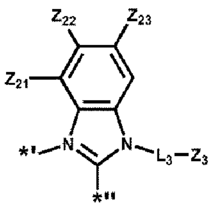
CY4-12

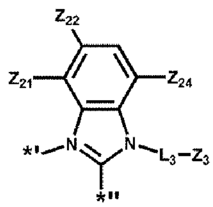
CY4-13

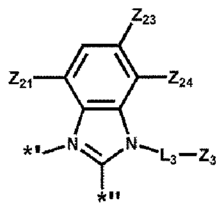
CY4-14

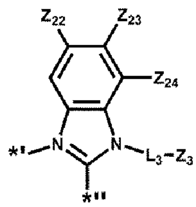
CY4-15

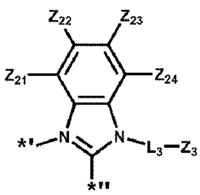
CY4-16

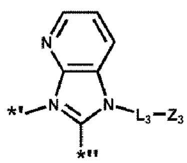
CY4-17

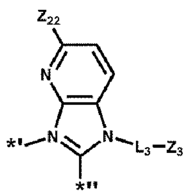
CY4-18

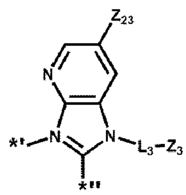
CY4-19

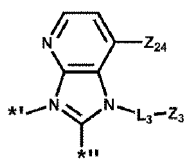
CY4-20

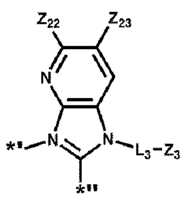
CY4-21

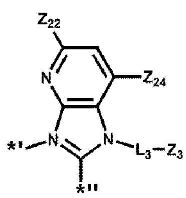
CY4-22

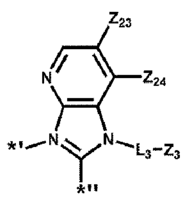
CY4-23

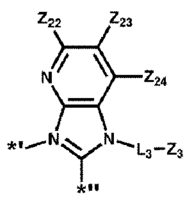
CY4-24

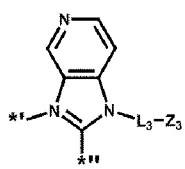
CY4-25

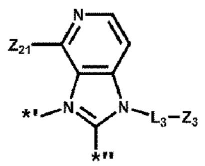
CY4-26

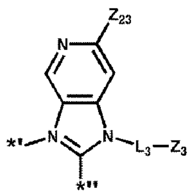
CY4-27

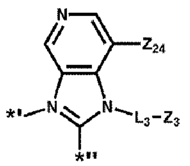
CY4-28

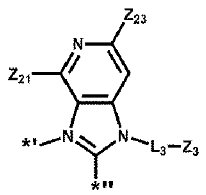
CY4-29

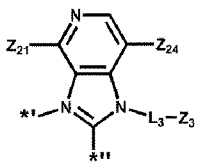
CY4-30

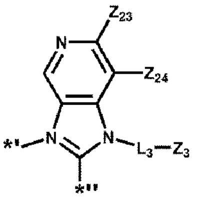
CY4-31

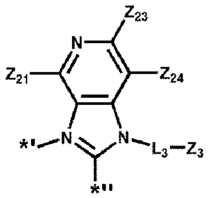
CY4-32

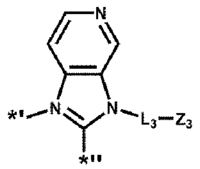
CY4-33

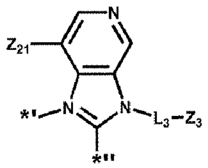
CY4-34

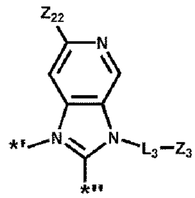
CY4-35

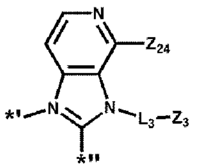
CY4-36

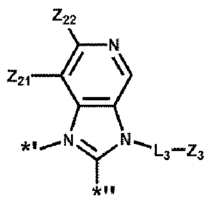
CY4-37

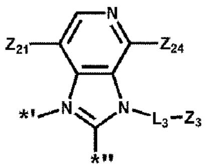
CY4-38

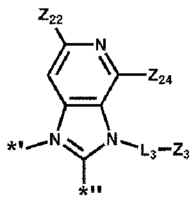
CY4-39

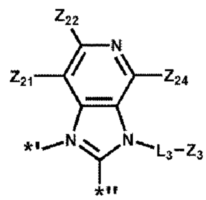
CY4-40

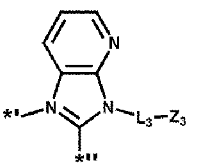
CY4-41

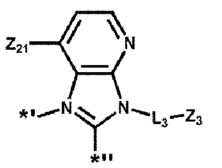
CY4-42

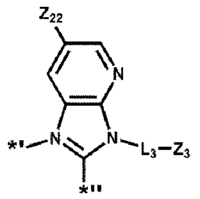
CY4-43

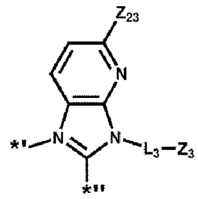
CY4-44

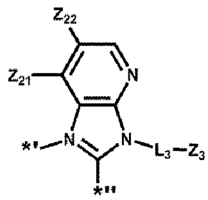
CY4-45

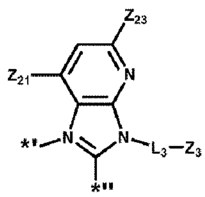
CY4-46

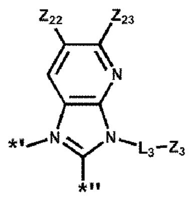
CY4-47

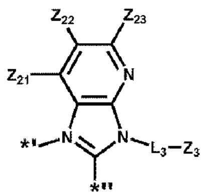
CY4-48

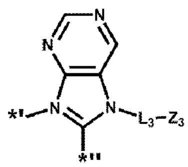
CY4-49

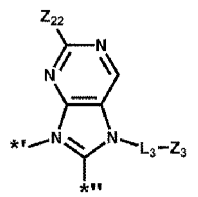
CY4-50

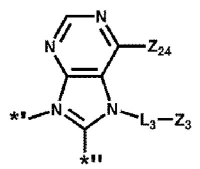
CY4-51

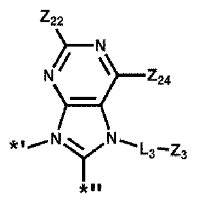
CY4-52

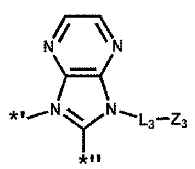
CY4-53

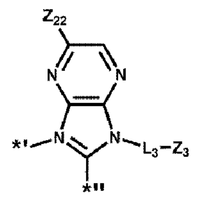
CY4-54

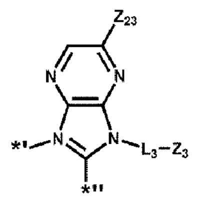
CY4-55

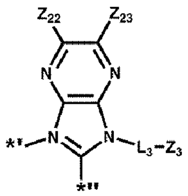

CY4-56

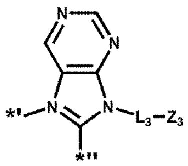

CY4-57

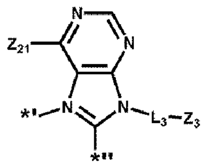

CY4-58

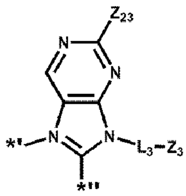

CY4-59

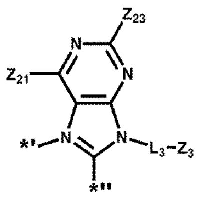

CY4-60

wherein, in Formulae CY4-1 to CY4-60,

$L_3$ and $Z_3$ are the same as described in claim 1,
$Z_{21}$ to $Z_{24}$ are each the same as described in claim 1 in connection with $Z_2$, wherein $Z_{21}$ to $Z_{24}$ are not hydrogen,
*' indicates a binding site to M in Formula 1, and
*" indicates a binding site to a neighboring atom in Formula 3.

**10.** The organometallic compound of any of claims 1-8, wherein

a group represented by

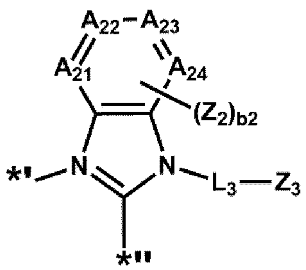

in Formula 3 is a group represented by one of Formulae CY4(1) to CY4(4):

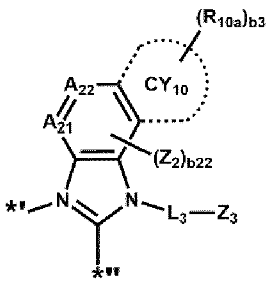

CY4(1)

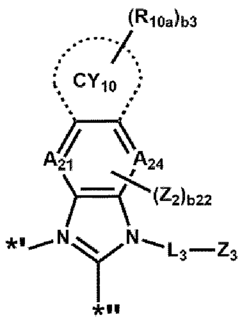

CY4(2)

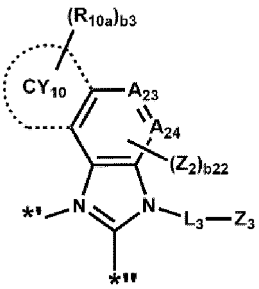

CY4(3)

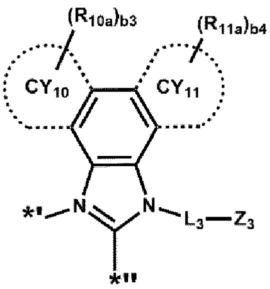

CY4(4)

wherein, in Formulae CY4(1) to CY4(4),

$A_{21}$ to $A_{24}$, $L_3$, $Z_2$ , $Z_3$ and $R_{10a}$ are the same as described in claim 1,
b22 is an integer from 0 to 2,
ring $CY_{10}$ and ring $CY_{11}$ are each independently a $C_5$-$C_{30}$ carbocyclic group or a $C_1$-$C_{30}$ heterocyclic group,
$R_{11a}$ is the same as described in connection with $R_{10a}$,
b3 and b4 are each independently an integer from 0 to 20, when b3 is 2 or more, two or more $R_{10a}$(s) are identical to or different from each other, and when b4 is 2 or more, two or more $R_{11a}$(s) are identical to or different from each other,
*' indicates a binding site to M in Formula 1, and
*" indicates a binding site to a neighboring atom in Formula 3.

**11.** The organometallic compound of any of claims 1-8, wherein

a group represented by

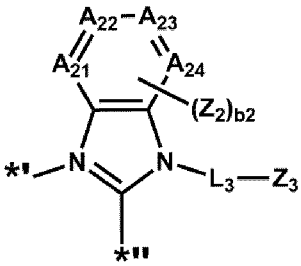

in Formula 3 is a group represented by one of Formulae CY4(1)-1 to CY4(1)-4, CY4(2)-1 to CY4(2)-4, CY4(3)-1 to CY4(3)-4 and CY4(4)-1:

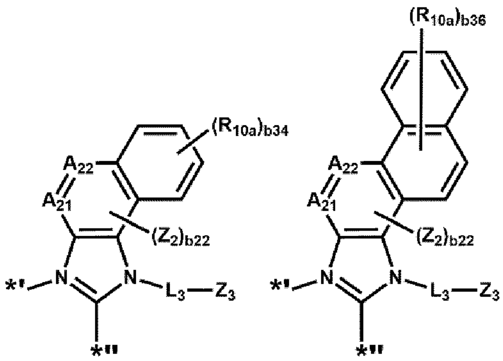

CY4(1)-1

CY4(1)-2

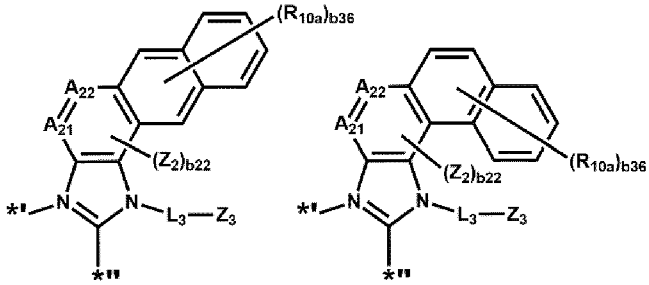

CY4(1)-3

CY4(1)-4

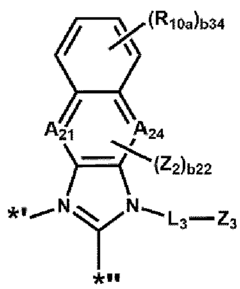

CY4(2)-1

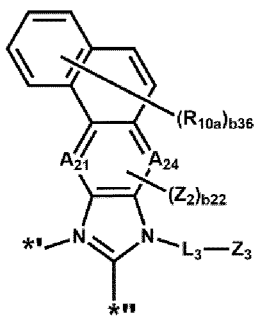

CY4(2)-2

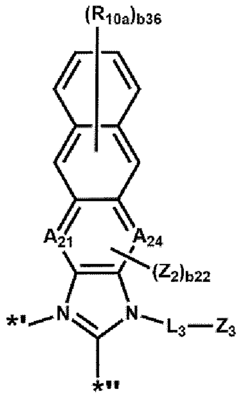

CY4(2)-3

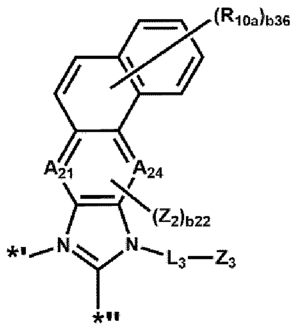

CY4(2)-4

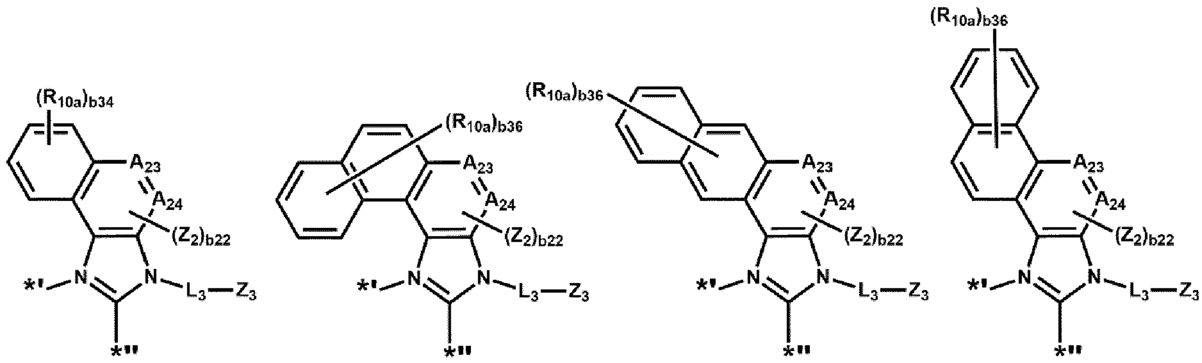

CY4(3)-1 CY4(3)-2 CY4(3)-3 CY4(3)-4

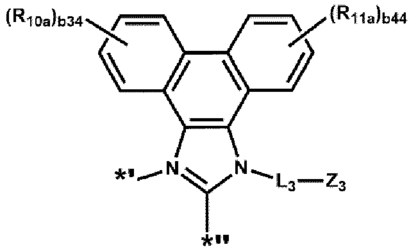

CY4(4)-1

wherein, in Formulae CY4(1)-1 to CY4(1)-4, CY4(2)-1 to CY4(2)-4, CY4(3)-1 to CY4(3)-4 and CY4(4)-1,

$A_{21}$ to $A_{24}$, $L_3$, $Z_2$ , $Z_3$ and $R_{10a}$ are the same as described in claim 1,
b22 is an integer from 0 to 2,
$R_{11a}$ is the same as described in connection with $R_{10a}$,
b34 and b44 may each independently be an integer from 0 to 4, when b34 is 2 or more, two or more $R_{10a}$(s) may be identical to or different from each other, and when b44 is 2 or more, two or more $R_{11a}$(s) may be identical to or different from each other,
b36 may be an integer from 0 to 6, when b36 is 2 or more, two or more $R_{10a}$(s) may be identical to or different from each other,
*' indicates a binding site to M in Formula 1, and
*" indicates a binding site to a neighboring atom in Formula 3.

**12.** An organic light-emitting device comprising: a first electrode;

a second electrode; and
an organic layer disposed between the first electrode and the second electrode and including an emission layer, wherein the organic layer comprises at least one organometallic compound of any of claims 1-11.

**13.** The organic light-emitting device of claim 12, wherein

the first electrode is an anode,
the second electrode is a cathode,
the organic layer further comprises a hole transport region between the first electrode and the emission layer and an electron transport region between the emission layer and the second electrode,
the hole transport region comprises a hole injection layer, a hole transport layer, an electron blocking layer, a buffer layer, or any combination thereof, and
the electron transport region comprises a hole blocking layer, an electron transport layer, an electron injection layer, or any combination thereof; and/or
wherein
the at least one organometallic compound is comprised in the emission layer.

**14.** The organic light-emitting device of claims 12 or 13, wherein

the emission layer emits green light; and/or
wherein
the emission layer further includes a host, and the amount of the host is greater than the amount of the organometallic compound.

**15.** An electronic apparatus comprising the organic light-emitting device of any of claims 12-14.

**Patentansprüche**

**1.** Metallorganische Verbindung, dargestellt durch Formel 1:

<Formel 1> $M\ (L_1)_{n1}(L_2)_{n2}$

wobei in Formel 1

M ein Übergangsmetall ist;
$L_1$ ein Ligand ist, der durch Formel 2 dargestellt ist,
$L_2$ ein Ligand ist, der durch Formel 3 dargestellt ist,
n1 und n2 jeweils unabhängig 1 oder 2 sind, wenn n1 gleich 2 ist, sind zwei $L_1$ gleich oder voneinander verschieden und wenn n2 gleich 2 ist, sind zwei $L_2$ gleich oder voneinander verschieden,

<Formel 2>

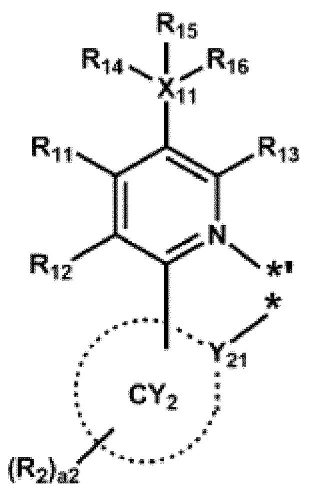

<Formel 3>

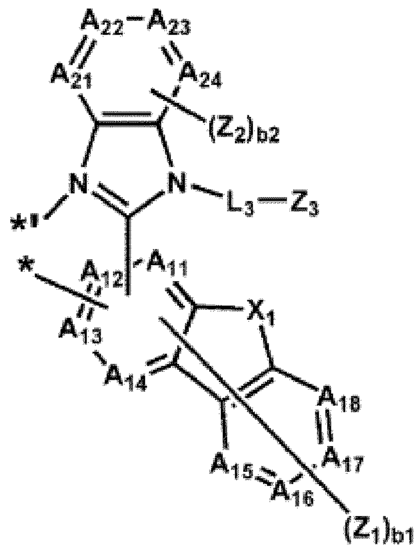

wobei in Formel 2 und 3,

$Y_{21}$ C oder N ist;
Ring $CY_2$ eine $C_5$-$C_{30}$-carbocyclische Gruppe oder eine $C_1$-$C_{30}$-heterocyclische Gruppe ist,
$X_{11}$ Si oder Ge ist,
$X_1$ O, S, Se, $N(Z_{19})$, $C(Z_{19})(Z_{20})$ oder $Si(Z_{19})(Z_{20})$ ist,
$A_{11}$ bis $A_{14}$ jeweils unabhängig C oder N sind, wobei eines von $A_{11}$ bis $A_{14}$ C gebunden an eine Gruppe ist, die durch

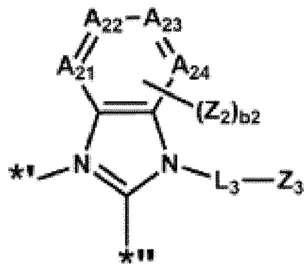

in Formel 3 dargestellt ist, und eines von dem der verbleibenden $A_{11}$ bis $A_{14}$ C gebunden an M in Formel 1 ist,

$A_{15}$ bis $A_{18}$ und $A_{21}$ bis $A_{24}$ jeweils unabhängig C oder N sind,
mindestens eines von $A_{11}$ bis $A_{18}$ N ist,
$L_3$ eine Einfachbindung, eine $C_5$-$C_{30}$-carbocyclische Gruppe, die unsubstituiert oder mit mindestens einem $R_{10a}$ substituiert ist, oder eine $C_1$-$C_{30}$-heterocyclische Gruppe, die unsubstituiert oder mit mindestens einem $R_{10a}$ substituiert ist, ist,
$R_2$, $R_{11}$ bis $R_{16}$, $Z_1$ bis $Z_3$, $Z_{19}$ und $Z_{20}$ jeweils unabhängig Wasserstoff, Deuterium, -F, -Cl, -Br, -I, -$SF_5$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte $C_1$-$C_{60}$-Alkylgruppe, eine substituierte oder unsubstituierte $C_2$-$C_{60}$-Alkenylgruppe, eine substituierte oder unsubstituierte $C_2$-$C_{60}$-Alkinylgruppe, eine substituierte oder unsubstituierte $C_1$-$C_{60}$-Alkoxygruppe, eine substituierte oder unsubstituierte $C_1$-$C_{60}$-Alkylthiogruppe, eine substituierte oder unsubstituierte $C_3$-$C_{10}$-Cycloalkylgruppe, eine substituierte oder unsubstituierte $C_1$-$C_{10}$-Heterocycloalkylgruppe, eine substituierte oder unsubstituierte $C_3$-$C_{10}$-Cycloalkenylgruppe, eine substituierte oder unsubstituierte $C_1$-$C_{10}$-Heterocycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte $C_6$-$C_{60}$-Arylthiogruppe, eine substituierte oder unsubstituierte $C_1$-$C_{60}$-Heteroarylgruppe, eine substituierte oder unsubstituierte einwertige nicht-aromatische kondensierte polyzyklische Gruppe, eine substituierte oder unsubstituierte einwertige nicht-aromatische kondensierte heteropolyzyklische Gruppe, -$N(Q_1)(Q_2)$, -$Si(Q_3)(Q_4)(Q_5)$, - $Ge(Q_3)(Q_4)(Q_5)$, - $B(Q_6)(Q_7)$, -$P(=O)(Q_8)(Q_9)$ oder -$P(Q_8)(Q_9)$ sind,
a2 eine ganze Zahl von 0 bis 20 ist, und wenn a2 2 oder mehr ist, sind zwei oder mehrere $R_2$ gleich oder voneinander verschieden sind,
b1 ist eine ganze Zahl von 0 bis 5, und wenn b1 2 oder mehr ist, sind zwei oder mehrere $Z_1$ gleich oder voneinander verschieden sind,
b2 ist eine ganze Zahl von 0 bis 4, und wenn b2 2 oder mehr ist, sind zwei oder mehrere $Z_2$ gleich oder voneinander verschieden sind,
$R_{11}$ und $R_{12}$ optional miteinander verbunden sind, um eine $C_5$-$C_{30}$-carbocyclische Gruppe, die unsubstituiert oder mit mindestens einem $R_{10a}$ substituiert ist, oder eine $C_1$-$C_{30}$-heterocyclische Gruppe, die unsubstituiert oder mit mindestens einem $R_{10a}$ substituiert ist, zu bilden,
zwei oder mehrere einer Vielzahl von $R_2$ optional miteinander verbunden sind, um eine $C_5$-$C_{30}$-carbocyclische Gruppe, die unsubstituiert oder mit mindestens einem $R_{10a}$ substituiert ist, oder eine $C_1$-$C_{30}$-heterocyclische Gruppe, die unsubstituiert oder mit mindestens einem $R_{10a}$ substituiert ist, zu bilden,
zwei oder mehrere einer Vielzahl von $Z_1$ optional miteinander verbunden sind, um eine $C_5$-$C_{30}$-carbocyclische Gruppe, die unsubstituiert oder mit mindestens einem $R_{10a}$ substituiert ist, oder eine $C_1$-$C_{30}$-heterocyclische Gruppe, die unsubstituiert oder mit mindestens einem $R_{10a}$ substituiert ist, zu bilden,
zwei oder mehrere einer Vielzahl von $Z_2$ optional miteinander verbunden sind, um eine $C_5$-$C_{30}$-carbocyclische Gruppe, die unsubstituiert oder mit mindestens einem $R_{10a}$ substituiert ist, oder eine $C_1$-$C_{30}$-heterocyclische Gruppe, die unsubstituiert oder mit mindestens einem $R_{10a}$ substituiert ist, zu bilden,
$R_{10a}$ gleich wie erläutert im Zusammenhang mit $Z_1$ ist, und
* und *' jeweils eine Bindungsstelle an M in Formel 1 angeben,
wobei ein Substituent der substituierten $C_1$-$C_{60}$-Alkylgruppe, der substituierten $C_2$-$C_{60}$-Alkenylgruppe, der substituierten $C_2$-$C_{60}$-Alkinylgruppe, der substituierten $C_1$-$C_{60}$-Alkoxygruppe, der substituierten

$C_1$-$C_{60}$-Alkylthiogruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_1$-$C_{60}$-Heteroarylgruppe, der substituierten monovalenten nicht-aromatischen kondensierten polycyclischen Gruppe, und der substituierten monovalenten nicht-aromatischen kondensierten heteropolycyclischen Gruppe, wie folgt ist:

Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkinylgruppe, eine $C_1$-$C_{60}$-Alkoxygruppe oder eine $C_1$-$C_{60}$-Alkylthiogruppe,
eine $C_1$-$C_{60}$-Alkylgruppe, eine $C_2$-$C_{60}$-Alkenylgruppe, eine $C_2$-$C_{60}$-Alkinylgruppe, eine $C_1$-$C_{60}$-Alkoxygruppe oder eine $C_1$-$C_{60}$-Alkylthiogruppe, jeweils substituiert mit Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, Carbonsäuregruppe oder ein Salz davon, Sulfonsäuregruppe oder ein Salz davon, Phosphorsäuregruppe oder ein Salz davon, eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine monovalente nicht-aromatische kondensierte polyzyklische Gruppe, eine monovalente nicht-aromatische kondensierte heteropolyzyklische Gruppe, $-N(Q_{11})(Q_{12})$, - $Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, - $P(Q_{18})(Q_{19})$ oder eine beliebige Kombination davon;
eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine monovalenten nicht-aromatischen kondensierten polycyclischen Gruppe oder eine monovalenten nichtaromatischen kondensierten heteropolycyclischen Gruppe, jeweils unsubstituiert oder substituiert mit Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, Carbonsäuregruppe oder einem Salz davon, Sulfonsäuregruppe oder einem Salz davon, Phosphorsäuregruppe oder einem Salz davon, eine $C_1$-$C_{60}$-Alkylgruppe, eine $C_2$-$C_{60}$-Alkenylgruppe, eine $C_2$-$C_{60}$-Alkinylgruppe, eine $C_1$-$C_{60}$-Alkoxygruppe, eine $C_1$-$C_{60}$-Alkylthiogruppe, eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine monovalenten nichtaromatischen kondensierten polycyclischen Gruppe und eine monovalenten nichtaromatischen kondensierten heteropolycyclischen Gruppe, $-N(Q_{21})(Q_{22})$, $-Si(Q_{23})(Q_{24})(Q_{25})$, $-Ge(Q_{23})(Q_{24})(Q_{25})$, - $B(Q_{26})(Q_{27})$, $-P(=O)(Q_{28})(Q_{29})$, $-P(Q_{28})(Q_{29})$ oder eine beliebige Kombination davon;
$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, - $P(=O)(Q_{38})(Q_{39})$ oder $-P(Q_{38})(Q_{39})$; oder
eine beliebige Kombination davon;
wobei $Q_1$ bis $Q_9$, $Q_{11}$ bis $Q_{19}$, $Q_{21}$ bis $Q_{29}$ und $Q_{31}$ bis $Q_{39}$ jeweils unabhängig Wasserstoff; Deuterium; -F; -Cl; -Br; -I; eine Hydroxylgruppe; eine Cyanogruppe; eine Nitrogruppe; eine Amidinogruppe; eine Hydrazingruppe; eine Hydrazongruppe; eine Carbonsäuregruppe oder ein Salz davon; eine Sulfonsäuregruppe oder ein Salz davon; eine Phosphorsäuregruppe oder ein Salz davon; eine $C_1$-$C_{60}$-Alkylgruppe unsubstituiert oder substituiert mit Deuterium, -F, eine $C_1$-$C_{60}$-Alkylgruppe, eine $C_6$-$C_{60}$-Arylgruppe oder eine beliebige Kombination davon; eine $C_2$-$C_{60}$-Alkenylgruppe; eine $C_2$-$C_{60}$-Alkinylgruppe, eine $C_1$-$C_{60}$-Alkoxygruppe; eine $C_1$-$C_{60}$-Alkylthiogruppe; eine $C_3$-$C_{10}$-Cycloalkylgruppe; eine $C_1$-$C_{10}$-Heterocycloalkylgruppe; eine $C_3$-$C_{10}$-Cycloalkenylgruppe; eine $C_1$-$C_{10}$-Heterocycloalkenylgruppe; eine $C_6$-$C_{60}$-Arylgruppe unsubstituiert oder substituiert mit Deuterium, -F, eine $C_1$-$C_{60}$-Alkylgruppe, eine $C_6$-$C_{60}$-Arylgruppe oder eine beliebige Kombination davon; eine $C_6$-$C_{60}$-Aryloxygruppe, eine $C_6$-$C_{60}$-Arylthiogruppe; eine $C_1$-$C_{60}$-Heteroarylgruppe, eine monovalente nicht-aromatische kondensierte polycyclische Gruppe; oder eine monovalente nicht-aromatische kondensierte heteropolycyclische Gruppe sind.

**2.** Metallorganische Verbindung nach Anspruch 1, wobei der Ring $CY_2$ eine Benzolgruppe, eine Naphthalingruppe, eine Anthracengruppe, eine Phenanthrengruppe, eine 1,2,3,4-Tetrahydronaphthalingruppe, eine Carbazolgruppe, eine Fluorengruppe, eine Dibenzosilolgruppe, eine Dibenzothiophengruppe oder eine Dibenzofurangruppe ist; und/oder wobei $L_3$ in Formel 3 wie folgt ist:

eine Einfachbindung, oder
eine Benzolgruppe, eine Naphthalingruppe, eine Dibenzofurangruppe oder eine Dibenzothiophengruppe, jeweils unsubstituiert oder substituiert mit Deuterium, -F, einer Cyanogruppe, einer $C_1$-$C_{20}$-Alkylgruppe, einer deuterierten $C_1$-$C_{20}$-Alkylgruppe, einer fluorierten $C_1$-$C_{20}$-Alkylgruppe, einer $C_3$-$C_{10}$-Cycloalkylgruppe, einer deuterierte $C_3$-$C_{10}$-Cycloalkylgruppe, einer fluorierten $C_3$-$C_{10}$-Cycloalkylgruppe, einer ($C_1$-$C_{20}$-Alkyl)-$C_3$-$C_{10}$-Cycloalkylgruppe, einer Phenylgruppe, einer deuterierten Phenylgruppe, einer fluorierten Phenylgruppe, einer ($C_1$-$C_{20}$-Alkyl)phenylgruppe, einer Naphthylgruppe, einer Pyridinylgruppe, einer Furanylgruppe, einer Thiophenylgruppe, einer Benzofuranylgruppe, einer Benzothiophenylgruppe, einer Dibenzofuranylgruppe, einer Dibenzothiophenylgruppe oder einer Kombination davon.

**3.** Metallorganische Verbindung nach Anspruch 1 oder 2, wobei $R_2$, $R_{11}$ bis $R_{13}$, $Z_1$ bis $Z_3$, $Z_{19}$ und $Z_{20}$ in Formel 2 und 3 jeweils unabhängig wie folgt sind:

Wasserstoff, Deuterium, -F, oder eine Cyanogruppe; oder
eine $C_1$-$C_{20}$-Alkylgruppe, eine $C_3$-$C_{10}$-Cycloalkylgruppe, eine Phenylgruppe, eine Naphthylgruppe, eine Pyridinylgruppe, eine Furanylgruppe, eine Thiophenylgruppe, eine Benzofuranylgruppe, eine Benzothiophenylgruppe, eine Dibenzofuranylgruppe oder eine Dibenzothiophenylgruppe, jeweils unsubstituiert oder substituiert mit Deuterium, -F, einer Cyanogruppe, einer $C_1$-$C_{20}$-Alkylgruppe, einer deuterierten $C_1$-$C_{20}$-Alkylgruppe, einer fluorierten $C_1$-$C_{20}$-Alkylgruppe, einer $C_3$-$C_{10}$-Cycloalkylgruppe, einer deuterierten $C_3$-$C_{10}$-Cycloalkylgruppe, einer fluorierten $C_3$-$C_{10}$-Cycloalkylgruppe, einer ($C_1$-$C_{20}$-Alkyl)-$C_3$-$C_{10}$-Cycloalkylgruppe, einer Phenylgruppe, einer deuterierten Phenylgruppe, einer fluorierten Phenylgruppe, einer ($C_1$-$C_{20}$-Alkyl)phenylgruppe, einer Naphthylgruppe, einer Pyridinylgruppe, einer Furanylgruppe, einer Thiophenylgruppe, einer Benzofuranylgruppe, einer Benzothiophenylgruppe, einer Dibenzofuranylgruppe, einer Dibenzothiophenylgruppe, -Si($Q_{33}$)($Q_{34}$)($Q_{35}$), -Ge($Q_{33}$)($Q_{34}$)($Q_{35}$) oder einer Kombination davon, und
$R_{14}$ bis $R_{16}$ in Formel 2 jeweils unabhängig eine $C_1$-$C_{20}$-Alkylgruppe, eine $C_3$-$C_{10}$-Cycloalkylgruppe, eine Phenylgruppe, eine Naphthylgruppe, eine Pyridinylgruppe, eine Furanylgruppe, eine Thiophenylgruppe, eine Benzofuranylgruppe, eine Benzothiophenylgruppe, eine Dibenzofuranylgruppe oder eine Dibenzothiophenylgruppe, jeweils unsubstituiert oder substituiert mit Deuterium, -F, einer Cyanogruppe, einer $C_1$-$C_{20}$-Alkylgruppe, einer deuterierte $C_1$-$C_{20}$-Alkylgruppe, einer fluorierten $C_1$-$C_{20}$-Alkylgruppe, einer $C_3$-$C_{10}$-Cycloalkylgruppe, einer deuterierten $C_3$-$C_{10}$-Cycloalkylgruppe, einer fluorierten $C_3$-$C_{10}$-Cycloalkylgruppe, einer ($C_1$-$C_{20}$-Alkyl)-$C_3$-$C_{10}$-Cycloalkylgruppe, einer Phenylgruppe, einer deuterierten Phenylgruppe, einer fluorierten Phenylgruppe, einer ($C_1$-$C_{20}$-Alkyl)phenylgruppe, einer Naphthylgruppe, einer Pyridinylgruppe, einer Furanylgruppe, einer Thiophenylgruppe, einer Benzofuranylgruppe, einer Benzothiophenylgruppe, einer Dibenzofuranylgruppe, einer Dibenzothiophenylgruppe oder einer Kombination davon sind.

**4.** Metallorganische Verbindung nach einem der Ansprüche 1-3, wobei $R_{11}$ nicht Wasserstoff ist; und/oder wobei die metallorganische Verbindung mindestens eine der Bedingungen <Bedingung A> und <Bedingung B> erfüllt:

<Bedingung A>
$L_3$ ist eine $C_5$-$C_{30}$-carbocyclische Gruppe, unsubstituiert oder mit mindestens einem $R_{10a}$ substituiert, oder eine $C_1$-$C_{30}$-heterocyclische Gruppe, unsubstituiert oder mit mindestens einem $R_{10a}$ substituiert
<Bedingung B>
$Z_3$ ist eine substituierte oder unsubstituierte $C_6$-$C_{60}$-Arylgruppe, eine substituierte oder unsubstituierte $C_1$-$C_{60}$-Heteroarylgruppe, eine substituierte oder unsubstituierte monovalente nicht-aromatische kondensierte polyzyklische Gruppe oder eine substituierte oder unsubstituierte monovalente nicht-aromatische kondensierte heteropolyzyklische Gruppe.

**5.** Metallorganische Verbindung nach einem der Ansprüche 1-4, wobei $Z_1$ nicht Wasserstoff ist und b1 eine ganze Zahl von 1 bis 5 ist; und/oder wobei

eine durch

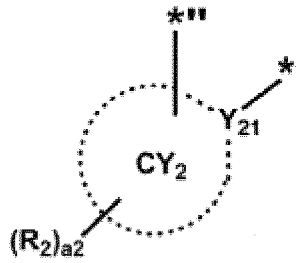

dargestellte Gruppe in Formel 2 ist eine Gruppe ist, dargestellt durch eine der Formeln CY2-1 bis CY2-33:

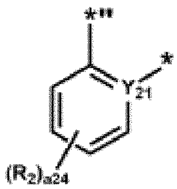

CY2-1

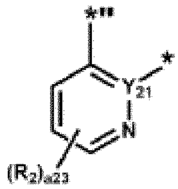

CY2-2

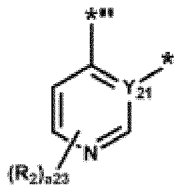

CY2-3

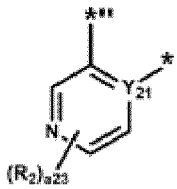

CY2-4

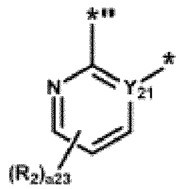

CY2-5

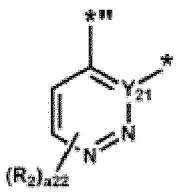

CY2-6

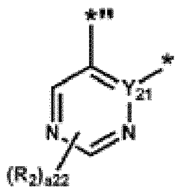

CY2-7

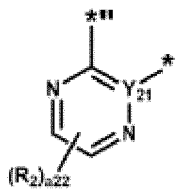

CY2-8

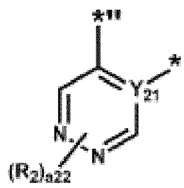

CY2-9

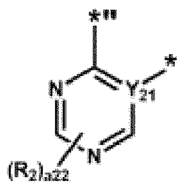

CY2-10

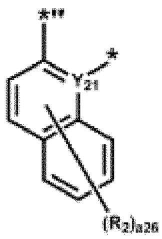

CY2-11

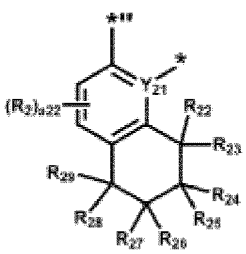

CY2-12

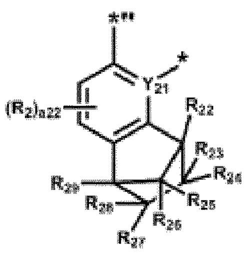

CY2-13

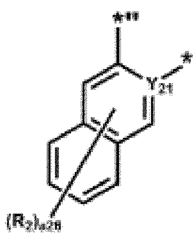

CY2-14

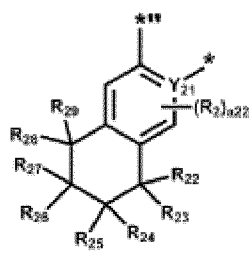

CY2-15

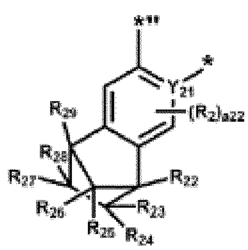

CY2-16

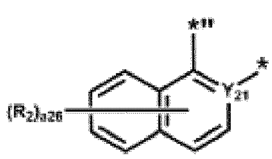

CY2-17

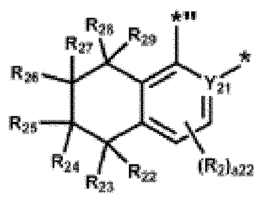

CY2-18

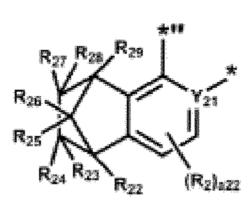

CY2-19

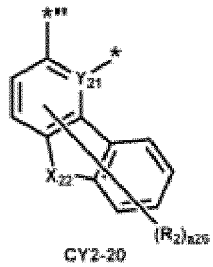
CY2-20

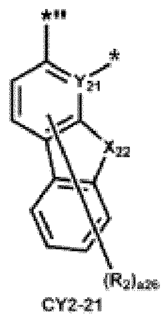
CY2-21

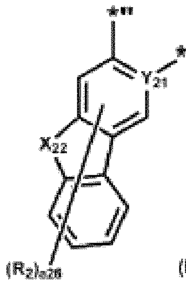
CY2-22

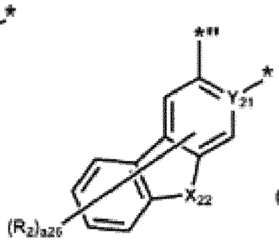
CY2-23

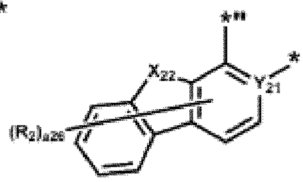
CY2-24

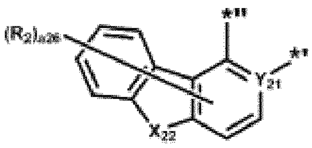
CY2-25

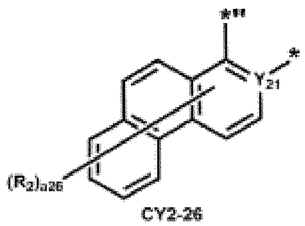
CY2-26

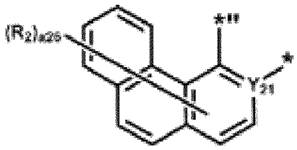
CY2-27

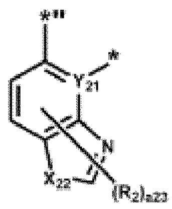
CY2-28

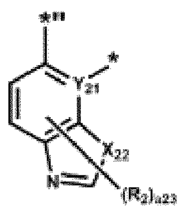
CY2-29

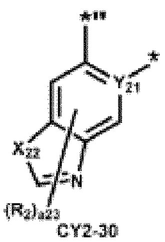
CY2-30

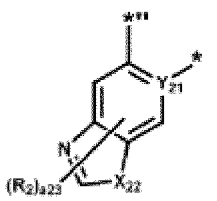
CY2-31

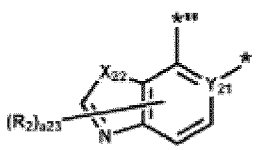
CY2-32

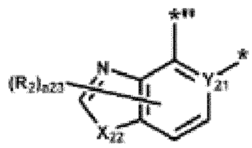
CY2-33

wobei in den Formeln CY2-1 bis CY2-33,

$Y_{21}$ und $R_2$ gleich sind wie beschrieben in Anspruch 1,
$X_{22}$ $C(R_{22})(R_{23})$, $N(R_{22})$, O, S oder $Si(R_{22})(R_{23})$ ist,
$R_{22}$ bis $R_{29}$ jeweils gleich sind wie beschrieben in Anspruch 1 in Verbindung mit $R_2$,
a28 eine ganze Zahl von 0 bis 8 ist,
a26 eine ganze Zahl von 0 bis 6 ist,
a24 eine ganze Zahl von 0 bis 4 ist,
a23 eine ganze Zahl von 0 bis 3 ist,
a22 eine ganze Zahl von 0 bis 2 ist,
*" eine Bindungsstelle an einem benachbarten Atom in Formel 2 angibt, und
* eine Bindungsstelle an M in Formel 1 angibt.

**6.** Metallorganische Verbindung nach einem der Ansprüche 1-5, wobei

eine durch

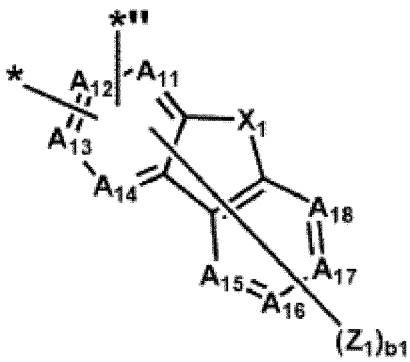

dargestellte Gruppe in Formel 3 eine Gruppe ist, dargestellt durch eine der Formeln CY3-1 bis CY3-6:

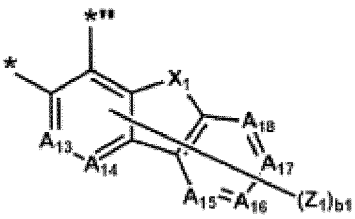

CY3-1

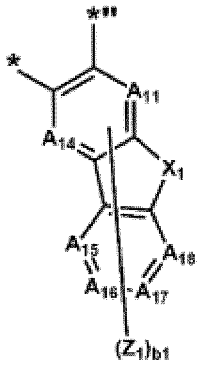

CY3-2

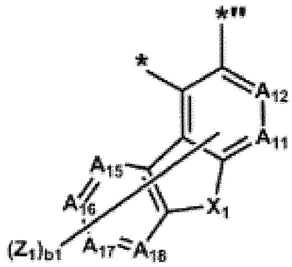

CY3-3

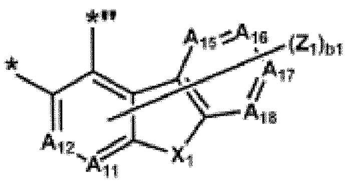

CY3-4

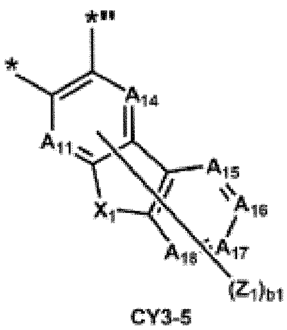

CY3-5

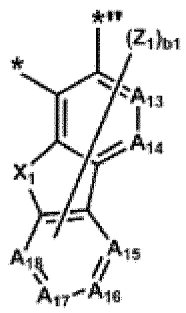

CY3-6

wobei in den Formeln CY3-1 bis CY3-6,

$X_1$, $Z_1$ and b1 gleich sind wie beschrieben in Anspruch 1,
$A_{11}$ bis $A_{18}$ jeweils unabhängig C oder N sind, wobei mindestens eines von $A_{13}$ to $A_{18}$ in Formel CY3-1 und CY3-6 N ist, mindestens eines von $A_{11}$, $A_{14}$, $A_{15}$, $A_{16}$, $A_{17}$ und $A_{18}$ in Formel CY3-2 und CY3-5 N ist, und mindestens eines von $A_{11}$, $A_{12}$, $A_{15}$, $A_{16}$, $A_{17}$ und $A_{18}$ in Formel CY3-3 und CY3-4 N ist,
* eine Bindungsstelle an M in Formel 1 angibt, und
*" eine Bindungsstelle zu einem benachbarten Atom in Formel 3 angibt.

**7.** Metallorganische Verbindung nach einem der Ansprüche 1-5, wobei

eine durch

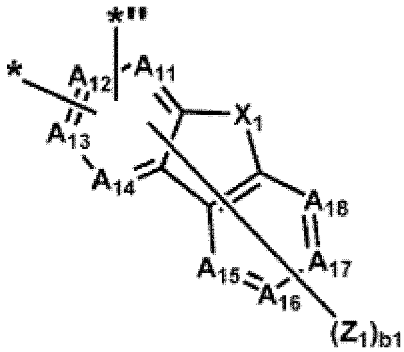

dargestellte Gruppe in Formel 3 eine Gruppe ist, dargestellt durch eine der Formeln CY3-1-1 bis CY3-1-6, CY3-2-1 bis CY3-2-6, CY3-3-1 bis CY3-3-6, CY3-4-1 bis CY3-4-6, CY3-5-1 bis CY3-5-6, und CY3-6-1 bis CY3-6-6

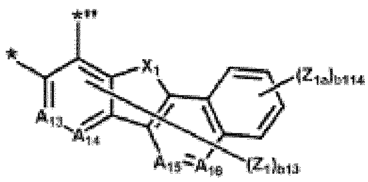

CY3-1-1

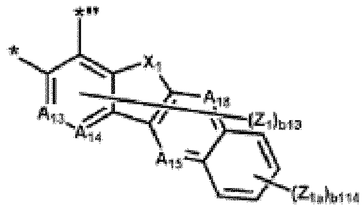

CY3-1-2

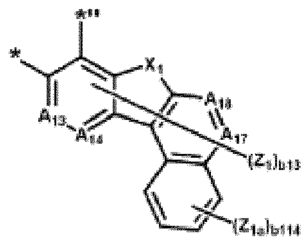

CY3-1-3

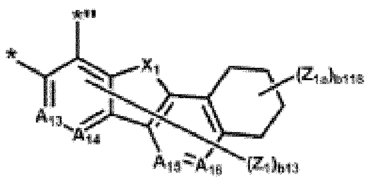

CY3-1-4

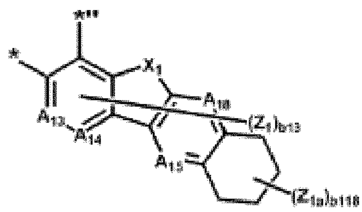

CY3-1-5

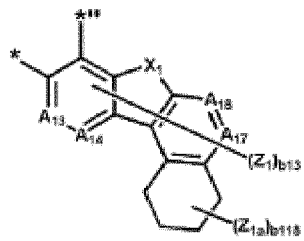

CY3-1-6

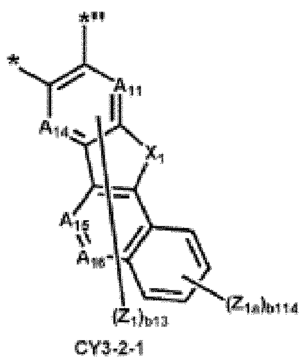

CY3-2-1

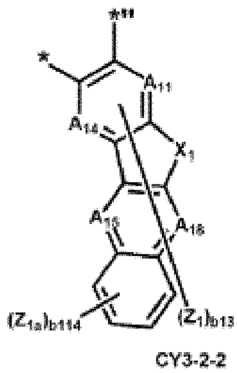

CY3-2-2

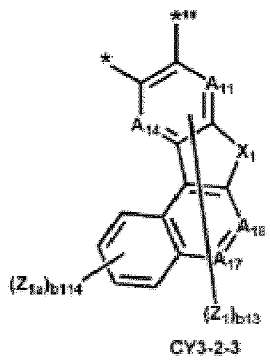

CY3-2-3

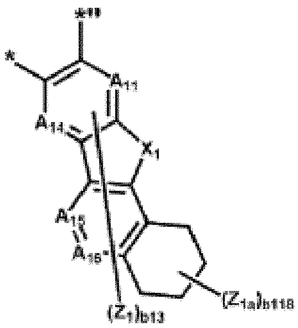

CY3-2-4

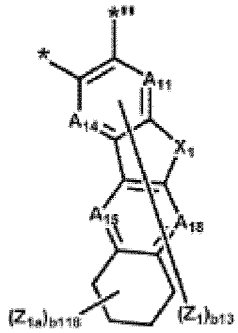

CY3-2-5

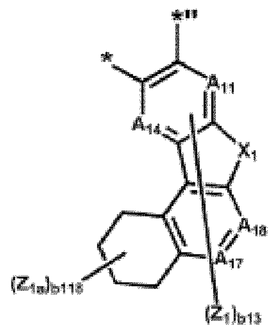

CY3-2-6

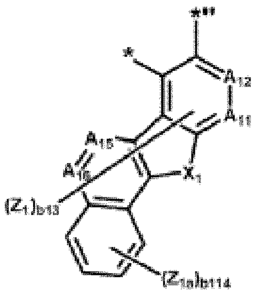

CY3-3-1

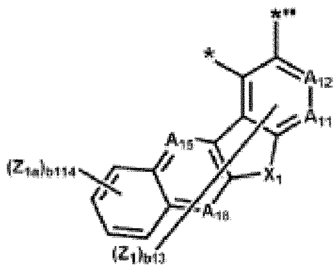

CY3-3-2

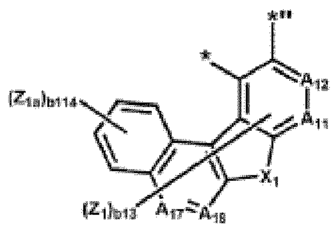

CY3-3-3

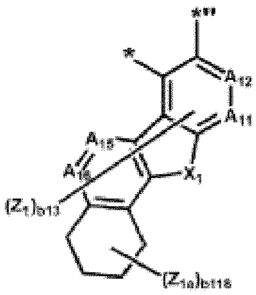

CY3-3-4

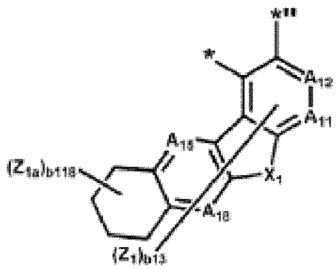

CY3-3-5

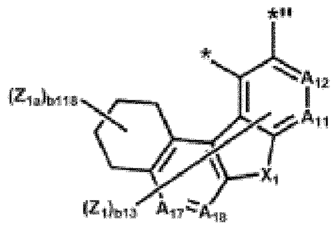

CY3-3-6

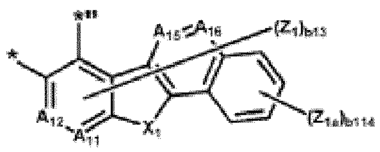

CY3-4-1

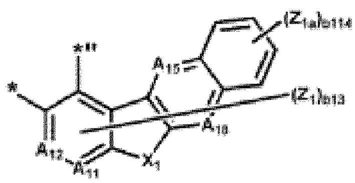

CY3-4-2

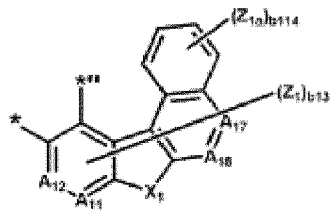

CY3-4-3

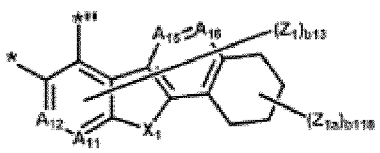

CY3-4-4

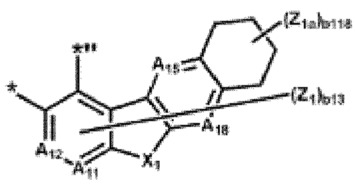

CY3-4-5

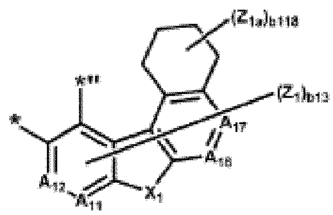

CY3-4-6

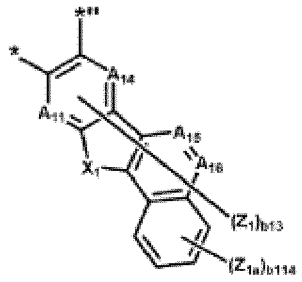
CY3-5-1

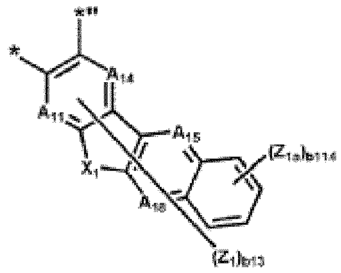
CY3-5-2

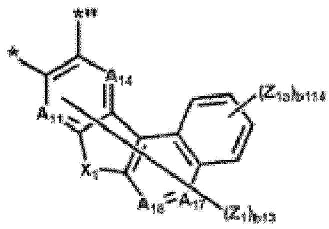
CY3-5-3

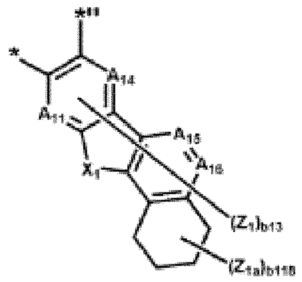
CY3-5-4

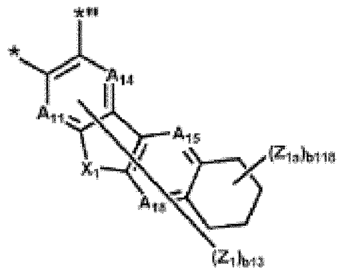
CY3-5-5

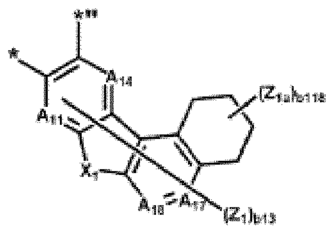
CY3-5-6

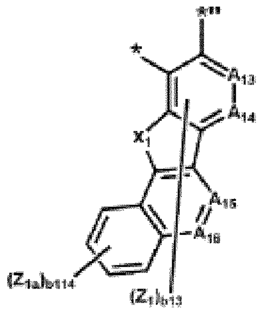
CY3-6-1

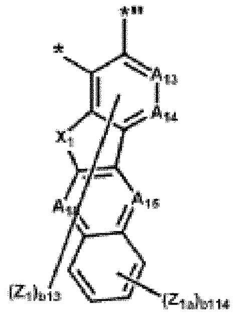
CY3-6-2

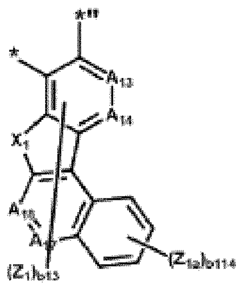
CY3-6-3

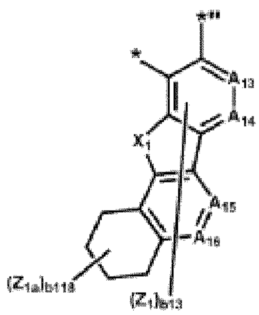
CY3-6-4

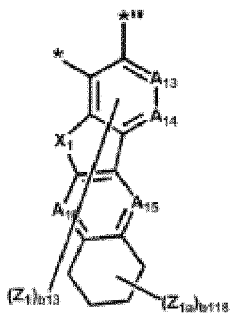
CY3-6-5

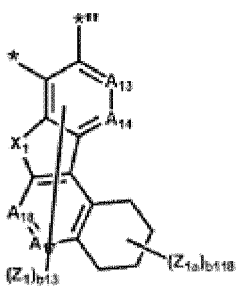
CY3-6-6

wobei in den Formeln CY3-1-1 bis CY3-1-6, CY3-2-1 bis CY3-2-6, CY3-3-1 bis CY3-3-6, CY3-4-1 bis CY3-4-6, CY3-5-1 bis CY3-5-6, und CY3-6-1 bis CY3-6-6,

$X_1$ und $Z_1$ gleich sind wie beschrieben in Anspruch 1,
$Z_{1a}$ gleich ist wie beschrieben in Anspruch 1 in Verbindung mit $R_{1a}$,
$A_{11}$ bis $A_{18}$ jeweils unabhängig C oder N, wobei a) mindestens eines von $A_{13}$, $A_{14}$, $A_{15}$ und $A_{16}$ in Formel CY3-1-1, CY3-1-4, CY3-6-1 und CY3-6-4 N ist, b) mindestens eines von $A_{13}$, $A_{14}$, $A_{15}$ und $A_{18}$ in Formel CY3-1-2, CY3-1-5, CY3-6-2 und CY3-6-5 N ist, c) mindestens eines von $A_{13}$, $A_{14}$, $A_{17}$ und $A_{18}$ in Formel CY3-1-3, CY3-1-6, CY3-6- 3 und CY3-6-6 N ist, d) mindestens eines von $A_{11}$, $A_{14}$, $A_{15}$ und $A_{16}$ in Formel CY3-2-1, CY3-2-4, CY3-5-1 und CY3-5-4 N ist, e) mindestens eines von $A_{11}$, $A_{14}$, $A_{15}$ und $A_{18}$ in Formel

CY3-2-2, CY3-2-5, CY3-5-2 und CY3-5-5 N ist, f) mindestens eines von $A_{11}$, $A_{14}$, $A_{17}$ und $A_{18}$ in Formel CY3-2-3, CY3-2-6, CY3-5-3 und CY3-5-6 N ist, g) mindestens eines von $A_{11}$, $A_{12}$, $A_{15}$ und $A_{16}$ in Formel CY3-3-1, CY3-3-4, CY3-4-1 und CY3-4-4 N ist, h) mindestens eines von $A_{11}$, $A_{12}$, $A_{15}$ und $A_{18}$ in Formel CY3-3-2, CY3-3-5, CY3-4-2 und CY3-4-5 N ist, i) mindestens eines von $A_{11}$, $A_{12}$, $A_{17}$ und $A_{18}$ in Formel CY3-3-3, CY3-3-6, CY3-4-3 und CY3-4-6 N ist,
b13 eine ganze Zahl von 0 bis 3 ist,
b 114 eine ganze Zahl von 0 bis 4 ist,
b118 eine ganze Zahl von 0 bis 8 ist,

* eine Bindungsstelle an M in Formel 1 angibt, und
*" eine Bindungsstelle zu einem benachbarten Atom in Formel 3 angibt.

**8.** Metallorganische Verbindung nach einem der Ansprüche 1-5, wobei

eine durch

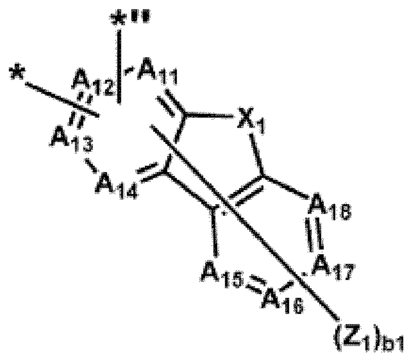

dargestellte Gruppe in Formel 3 eine Gruppe ist, dargestellt durch eine der Formeln NCY3(1) bis NCY3(84):

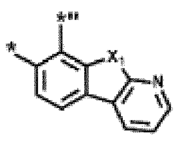
NCY3(1)

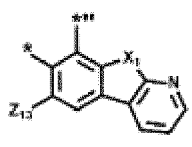
NCY3(2)

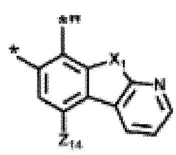
NCY3(3)

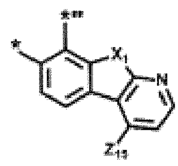
NCY3(4)

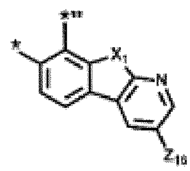
NCY3(5)

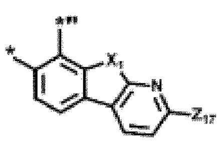
NCY3(6)

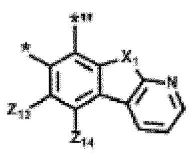
NCY3(7)

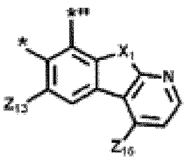
NCY3(8)

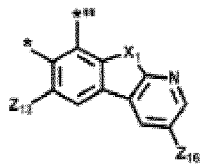
NCY3(9)

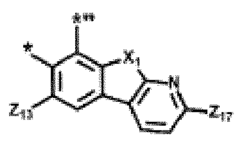
NCY3(10)

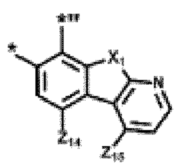
NCY3(11)

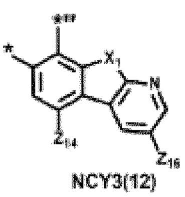
NCY3(12)

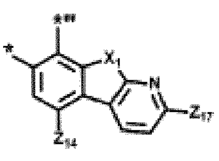
NCY3(13)

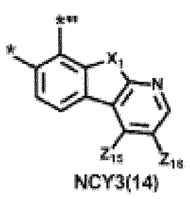
NCY3(14)

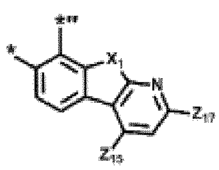
NCY3(15)

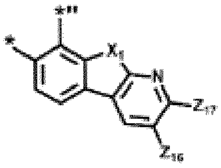
NCY3(16)
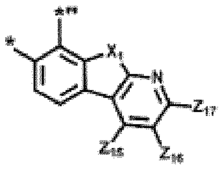
NCY3(17)
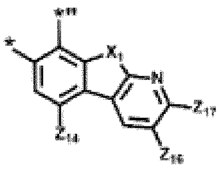
NCY3(18)
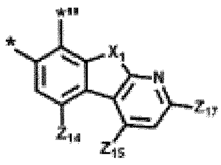
NCY3(19)
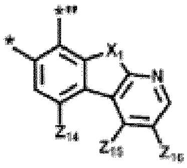
NCY3(20)

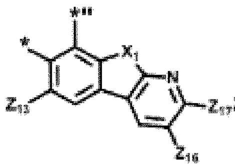
NCY3(21)
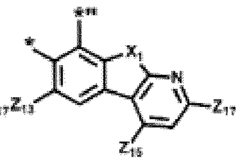
NCY3(22)
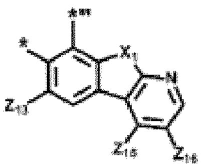
NCY3(23)
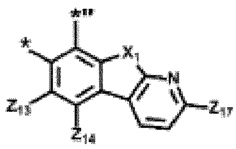
NCY3(24)
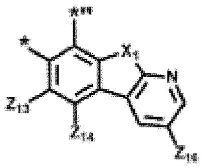
NCY3(25)

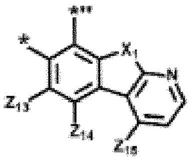
NCY3(26)
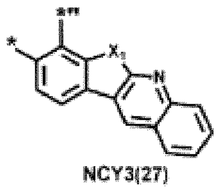
NCY3(27)
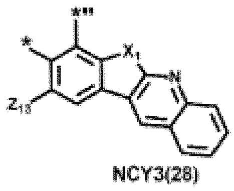
NCY3(28)
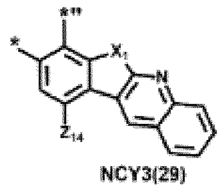
NCY3(29)

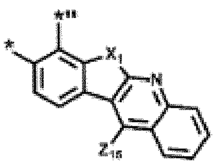
NCY3(30)
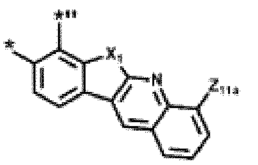
NCY3(31)
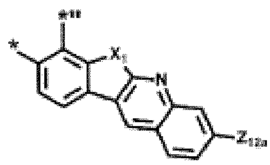
NCY3(32)
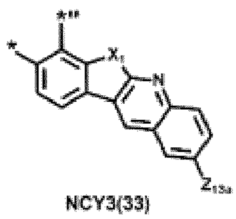
NCY3(33)

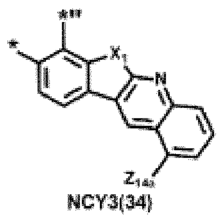
NCY3(34)
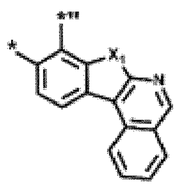
NCY3(35)
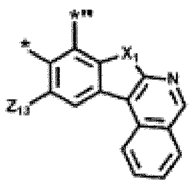
NCY3(36)
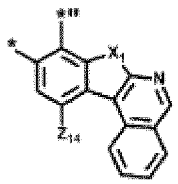
NCY3(37)

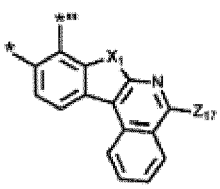
NCY3(38)
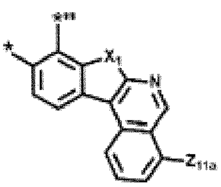
NCY3(39)
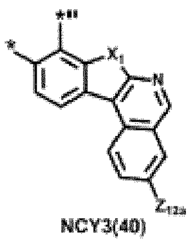
NCY3(40)
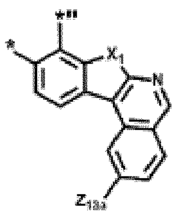
NCY3(41)
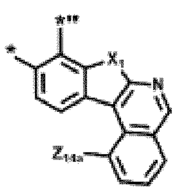
NCY3(42)

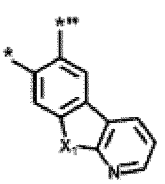
NCY3(43)
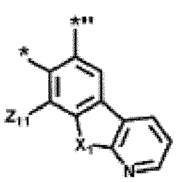
NCY3(44)
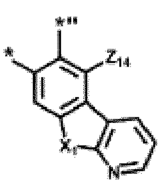
NCY3(45)
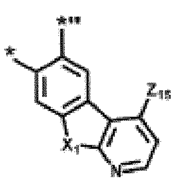
NCY3(46)
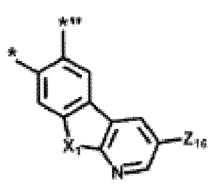
NCY3(47)

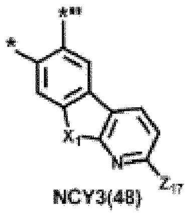
NCY3(48)

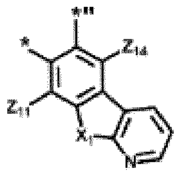
NCY3(49)

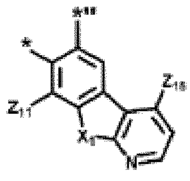
NCY3(50)

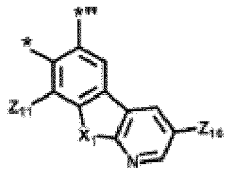
NCY3(51)

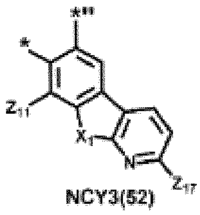
NCY3(52)

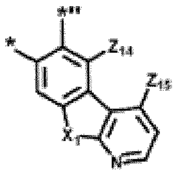
NCY3(53)

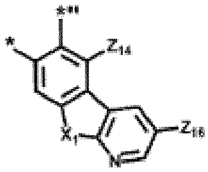
NCY3(54)

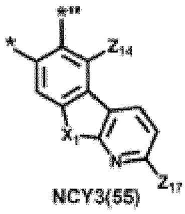
NCY3(55)

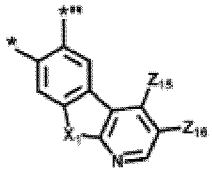
NCY3(56)

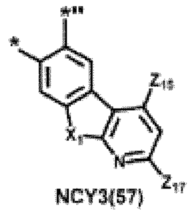
NCY3(57)

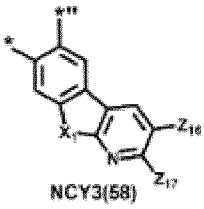
NCY3(58)

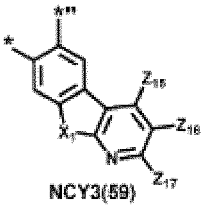
NCY3(59)

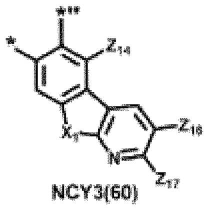
NCY3(60)

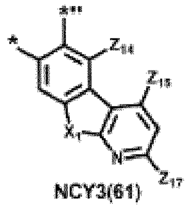
NCY3(61)

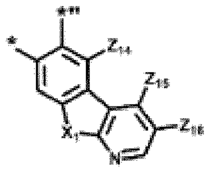
NCY3(62)

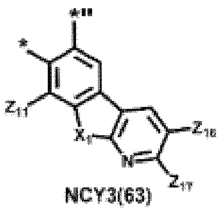
NCY3(63)

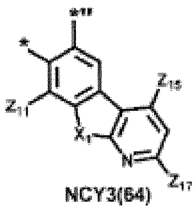
NCY3(64)

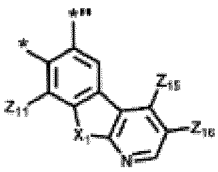
NCY3(65)

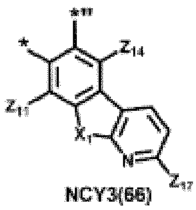
NCY3(66)

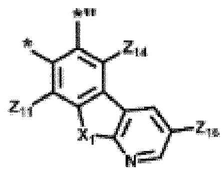
NCY3(67)

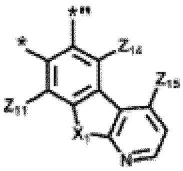
NCY3(68)

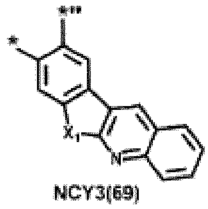
NCY3(69)

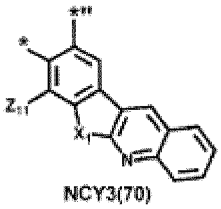
NCY3(70)

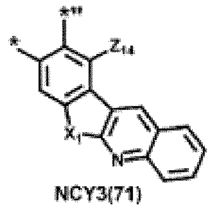
NCY3(71)

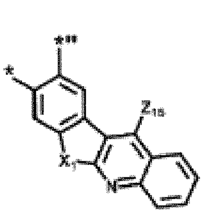
NCY3(72)

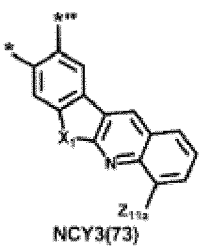
NCY3(73)

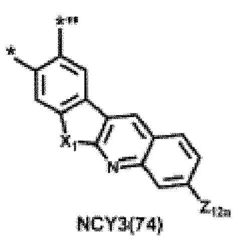
NCY3(74)

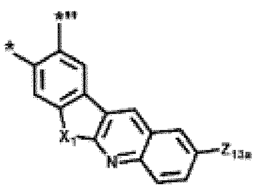
NCY3(75)

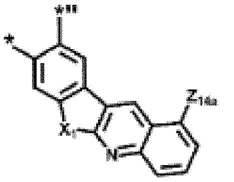
NCY3(76)

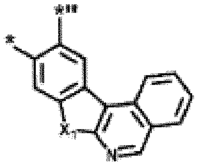
NCY3(77)

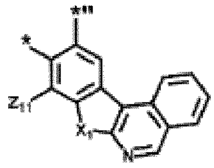
NCY3(78)

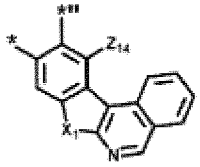
NCY3(79)

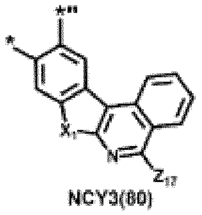
NCY3(80)

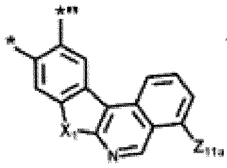
NCY3(81)

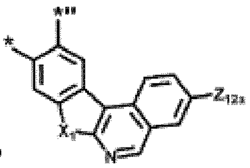
NCY3(82)

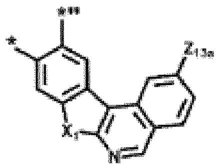
NCY3(83)

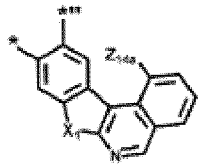
NCY3(84)

wobei in Formel NCY3(1) bis NCY3(84),

$X_1$ gleich ist wie beschrieben in Anspruch 1,
$Z_{11}$ bis $Z_{18}$ und $Z_{11a}$ bis $Z_{14a}$ $Z_{1a}$ jeweils gleich sind wie beschrieben in Anspruch 1 in Verbindung mit $Z_1$, und $Z_{11}$ bis $Z_{18}$ und $Z_{11a}$ bis $Z_{14a}$ $Z_{1a}$ jeweils nicht Wasserstoff sind,
* eine Bindungsstelle an M in Formel 1 angibt, und
*" eine Bindungsstelle zu einem benachbarten Atom in Formel 3 angibt.

**9.** Metallorganische Verbindung nach einem der Ansprüche 1-8, wobei

eine durch

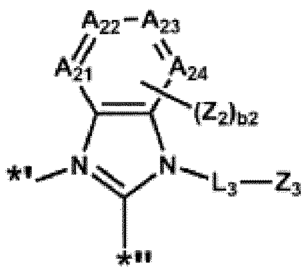

dargestellte Gruppe in Formel 3 ist eine Gruppe ist, dargestellt durch eine der Formeln CY4-1 bis CY4-60:

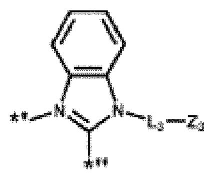
CY4-1

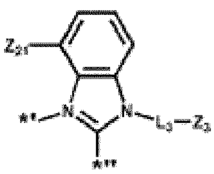
CY4-2

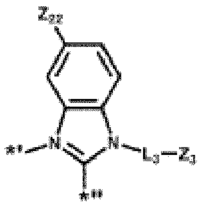
CY4-3

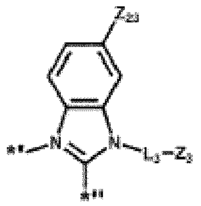
CY4-4

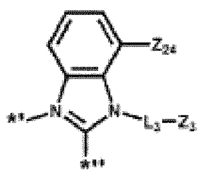
CY4-5

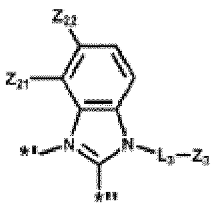
CY4-6

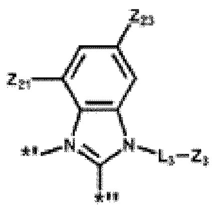
CY4-7

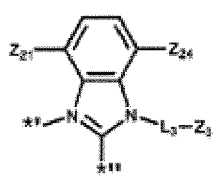
CY4-8

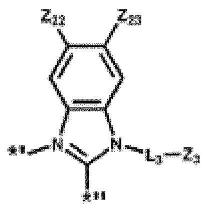
CY4-9

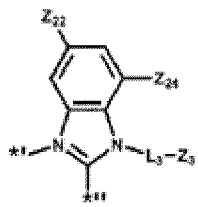
CY4-10

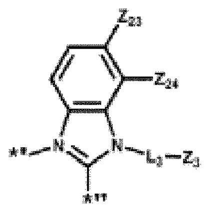
CY4-11

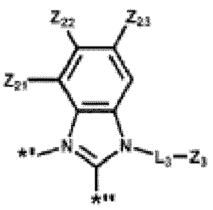
CY4-12

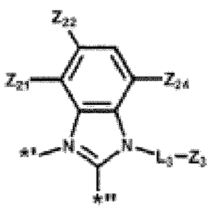
CY4-13

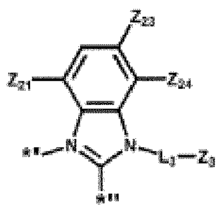
CY4-14

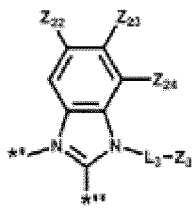
CY4-15

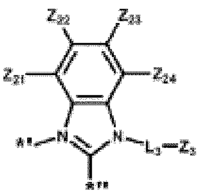
CY4-16

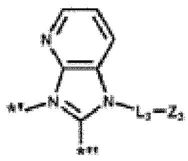
CY4-17

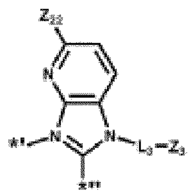
CY4-18

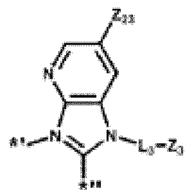
CY4-19

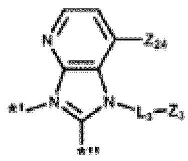
CY4-20

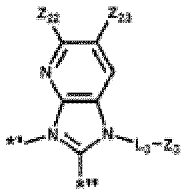
CY4-21

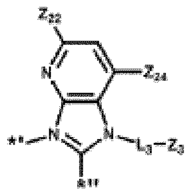
CY4-22

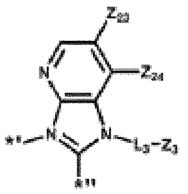
CY4-23

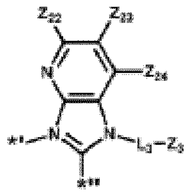
CY4-24

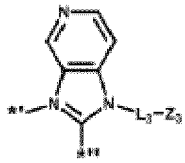
CY4-25

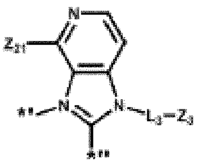
CY4-26

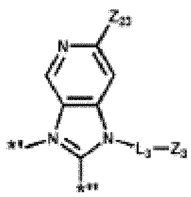
CY4-27

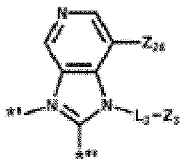
CY4-28

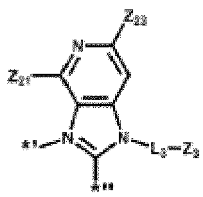
CY4-29

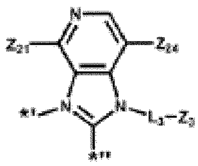
CY4-30

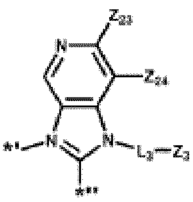
CY4-31

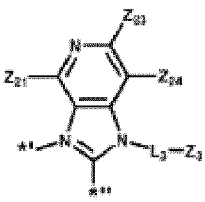
CY4-32

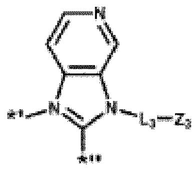
CY4-33

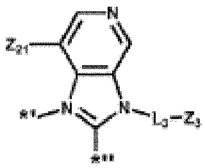
CY4-34

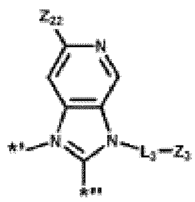
CY4-35

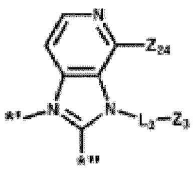
CY4-36

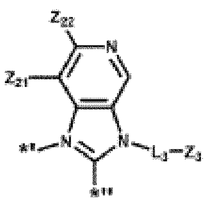
CY4-37

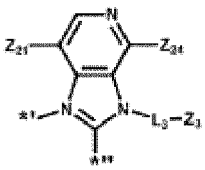
CY4-38

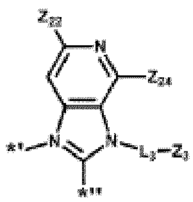
CY4-39

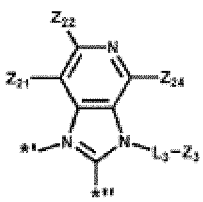
CY4-40

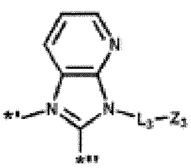
CY4-41

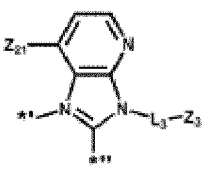
CY4-42

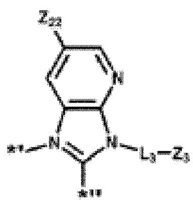
CY4-43

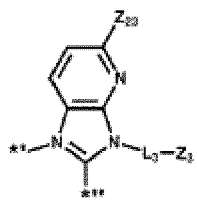
CY4-44

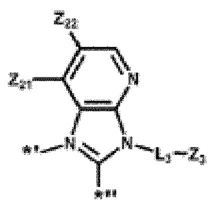
CY4-45

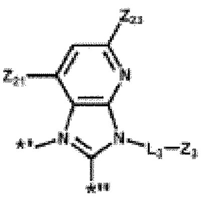
CY4-46

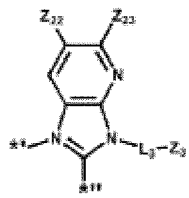
CY4-47

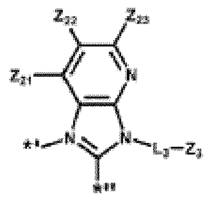
CY4-48

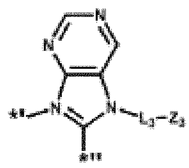
CY4-49

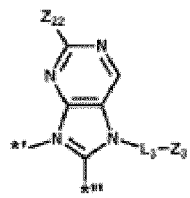
CY4-50

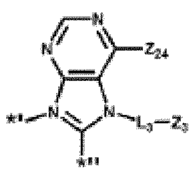
CY4-51

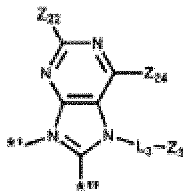
CY4-52

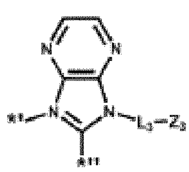
CY4-53

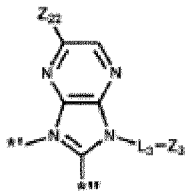
CY4-54

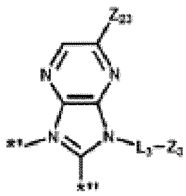
CY4-55

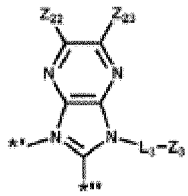
CY4-56

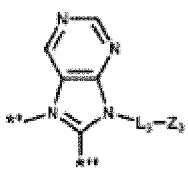
CY4-57

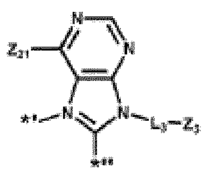
CY4-58

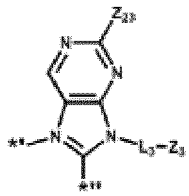
CY4-59

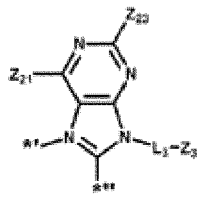
CY4-60

wobei in Formel CY4-1 bis CY4-60,

$L_3$ und $Z_3$ gleich sind wie beschrieben in Anspruch 1,
$Z_{21}$ to $Z_{24}$ jeweils gleich sind wie beschrieben in Anspruch 1 in Verbindung mit $Z_2$, wobei $Z_{21}$ bis $Z_{24}$ nicht Wasserstoff sind,
* eine Bindungsstelle an M in Formel 1 angibt, und
*" eine Bindungsstelle zu einem benachbarten Atom in Formel 3 angibt.

**10.** Metallorganische Verbindung nach einem der Ansprüche 1-8, wobei

eine durch

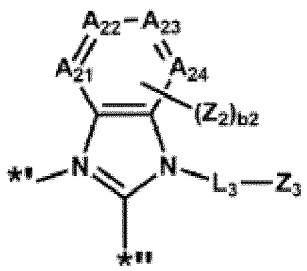

dargestellte Gruppe in Formel 3 ist eine Gruppe ist, dargestellt durch eine der Formeln CY4(1) bis CY4(4):

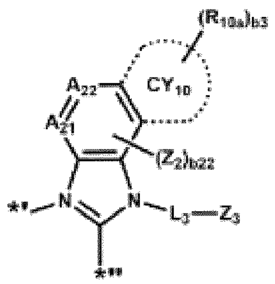
CY4(1)
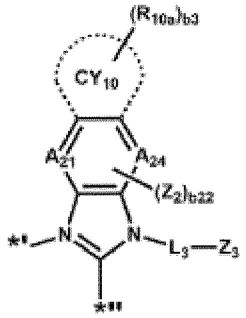
CY4(2)
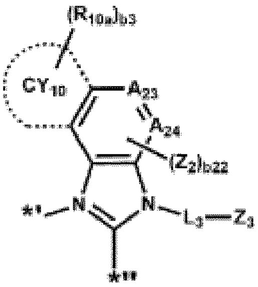
CY4(3)
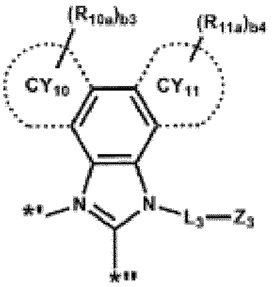
CY4(4)

wobei in Formel CY4(1) bis CY4(4),

$A_{21}$ bis $A_{24}$, $L_3$, $Z_2$, $Z_3$ und $R_{10a}$ gleich sind wie beschrieben in Anspruch 1,
b22 eine ganze Zahl von 0 bis 2 ist,
Ring $CY_{10}$ und Ring $CY_{11}$ jeweils unabhängig eine $C_5$-$C_{30}$-carbocyclische Gruppe oder eine $C_1$-$C_{30}$-heterocyclische Gruppe sind,
$R_{11a}$ gleich ist wie beschrieben in Verbindung mit $R_{10a}$,
b3 und b4 jeweils unabhängig eine ganze Zahl von 0 bis 20 sind, wenn b3 2 oder mehr ist, zwei oder mehrere $R_{10a}$ identisch oder voneinander verschieden sind, und wenn b4 2 oder mehr ist, zwei oder mehrere $R_{11a}$ identisch oder voneinander verschieden sind,
* eine Bindungsstelle an M in Formel 1 angibt, und
*" eine Bindungsstelle zu einem benachbarten Atom in Formel 3 angibt.

**11.** Metallorganische Verbindung nach einem der Ansprüche 1-8, wobei

eine durch

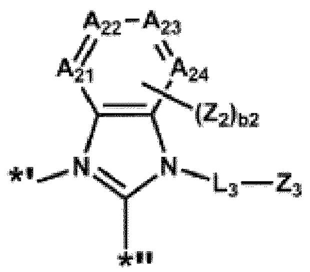

dargestellte Gruppe in Formel 3 ist eine Gruppe ist, dargestellt durch eine der Formeln CY4(1)-1 bis CY4(1)-4, CY4(2)-1 bis CY4(2)-4, CY4(3)-1 bis CY4(3)-4 und CY4(4)-1:

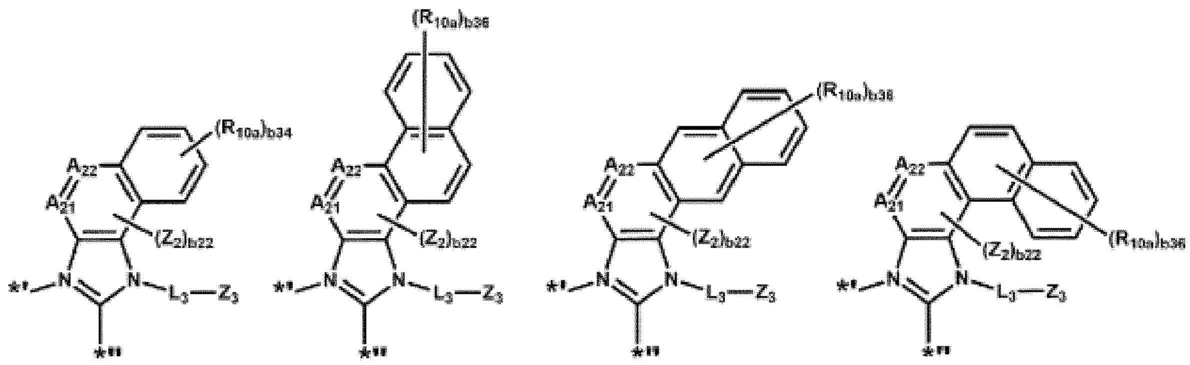
CY4(1)-1 CY4(1)-2 CY4(1)-3 CY4(1)-4

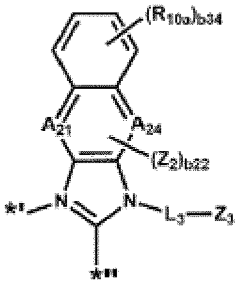

CY4(2)-1

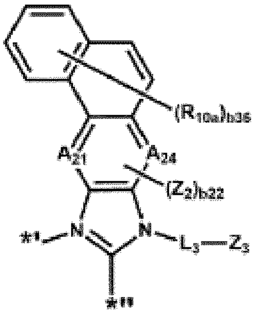

CY4(2)-2

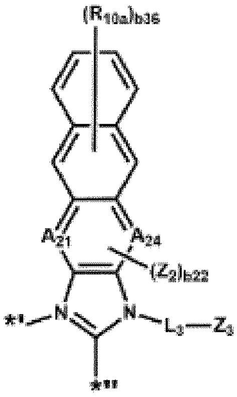

CY4(2)-3

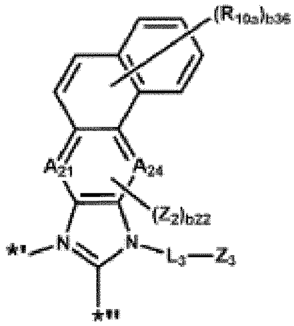

CY4(2)-4

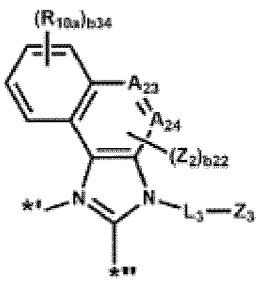

CY4(3)-1

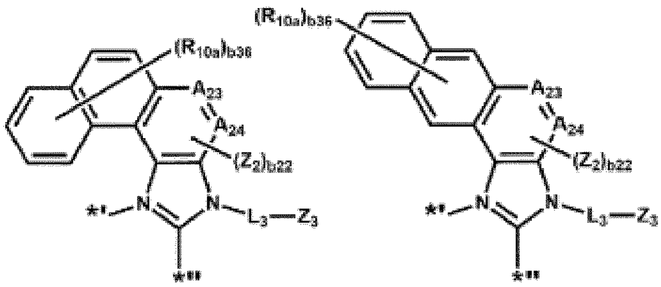

CY4(3)-2

CY4(3)-3

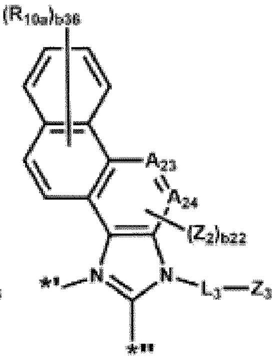

CY4(3)-4

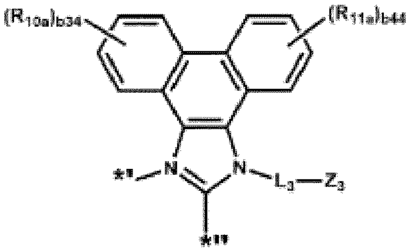

CY4(4)-1

wobei in Formel CY4(1)-1 bis CY4(1)-4, CY4(2)-1 bis CY4(2)-4, CY4(3)-

1 bis CY4(3)-4 und CY4(4)-1,
$A_{21}$ bis $A_{24}$, $L_3$, $Z_2$, $Z_3$ und $R_{10a}$ gleich sind wie beschrieben in Anspruch 1,
b22 eine ganze Zahl von 0 bis 2 ist,
$R_{11a}$ gleich ist wie beschrieben in Verbindung mit $R_{10a}$,
b34 und b44 jeweils unabhängig eine ganze Zahl von 0 bis 4 sein können, wenn b34 2 oder mehr ist, können zwei oder mehrere $R_{10a}$ identisch oder voneinander verschieden sein, und wenn b44 2 oder mehr ist, können zwei oder mehrere $R_{11a}$ identisch oder voneinander verschieden sein,
b36 eine ganze Zahl von 0 bis 6 sein kann, wenn b36 2 oder mehr ist, können zwei oder mehrere $R_{10a}$ gleich oder voneinander verschieden sein,
* eine Bindungsstelle an M in Formel 1 angibt, und
*" eine Bindungsstelle zu einem benachbarten Atom in Formel 3 angibt.

**12.** Organische lichtemittierende Vorrichtung, umfassend: eine erste Elektrode;

eine zweite Elektrode; und
eine organische Schicht, die zwischen der ersten Elektrode und der zweiten Elektrode angeordnet ist und eine

Emissionsschicht beinhaltet,
wobei die organische Schicht mindestens eine metallorganische Verbindung nach einem der Ansprüche 1-11 umfasst.

**13.** Organische lichtemittierende Vorrichtung nach Anspruch 12, wobei

die erste Elektrode eine Anode ist,
die zweite Elektrode eine Kathode ist,
die organische Schicht ferner einen Lochtransportbereich zwischen der ersten Elektrode und der Emissionsschicht und einen Elektronentransportbereich zwischen der Emissionsschicht und der zweiten Elektrode umfasst,
der Lochtransportbereich eine Lochinjektionsschicht, eine Lochtransportschicht, eine Elektronensperrschicht, eine Pufferschicht oder eine beliebige Kombination davon umfasst, und der Elektronentransportbereich eine Lochsperrschicht, eine Elektronentransportschicht, eine Elektroneninjektionsschicht oder eine beliebige Kombination davon umfasst; und/oder
wobei
die mindestens eine metallorganische Verbindung in der Emissionsschicht enthalten ist.

**14.** Organische lichtemittierende Vorrichtung nach Anspruch 12 oder 13, wobei

die Emissionsschicht grünes Licht emittiert; und/oder
wobei
die Emissionsschicht ferner einen Wirt beinhaltet und die Menge des Wirts größer ist als die Menge der metallorganischen Verbindung.

**15.** Elektronische Vorrichtung, umfassend die organische lichtemittierende Vorrichtung nach einem der Ansprüche 12-14.

## Revendications

**1.** Composé organométallique représenté par la Formule 1 :

<Formule 1> $M(L_1)_{n1}(L_2)_{n2}$

où, dans la Formule 1,

M est un métal de transition,
$L_1$ est un ligand représenté par la Formule 2,
$L_2$ est un ligand représenté par la Formule 3,
n1 et n2 sont chacun indépendamment 1 ou 2, quand n1 est 2, deux $L_1$(s) sont identiques ou différents l'un de l'autre, et quand n2 est 2, deux $L_2$(s) sont identiques ou différents l'un de l'autre ;

<Formule 2>

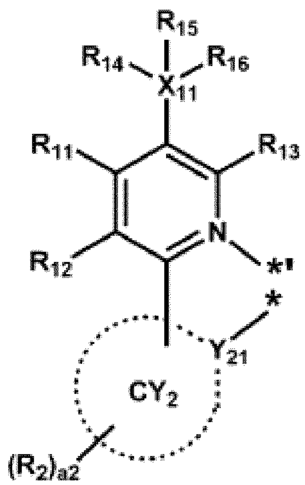

<Formule 3>

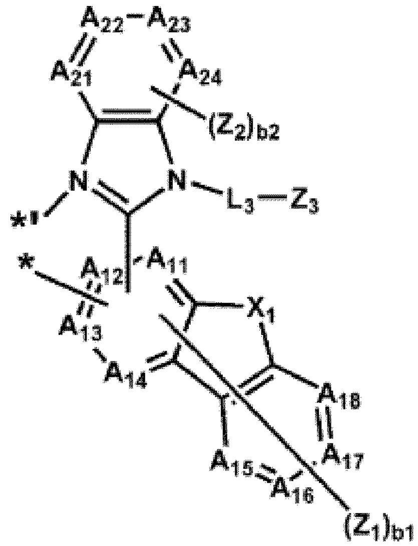

où, dans les Formules 2 et 3,

$Y_{21}$ est C ou N,
l'anneau $CY_2$ est un groupe $C_5$-$C_{30}$ carbocyclique ou un groupe $C_1$-$C_{30}$ hétérocyclique,
$X_{11}$ est Si ou Ge,
$X_1$ est O, S, Se, $N(Z_{19})$, $C(Z_{19})(Z_{20})$ ou $Si(Z_{19})(Z_{20})$,
$A_{11}$ à $A_{14}$ sont chacun indépendamment C ou N, où l'un de $A_{11}$ à $A_{14}$ est C lié à un groupe représenté par

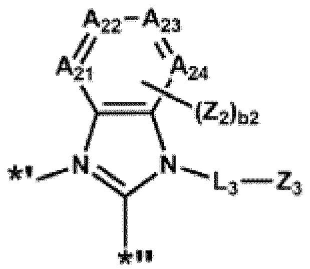

dans la Formule 3, et l'un des $A_{11}$ à $A_{14}$ restants est C lié à M dans la Formule 1,

$A_{15}$ à $A_{18}$ et $A_{21}$ à $A_{24}$ sont chacun indépendamment C ou N,
au moins l'un de $A_{11}$ à $A_{18}$ est N,
$L_3$ est une liaison simple, un groupe $C_5$-$C_{30}$ carbocyclique qui est non substitué ou substitué par au moins un $R_{10a}$, ou un groupe $C_1$-$C_{30}$ hétérocyclique qui est non substitué ou substitué par au moins un $R_{10a}$,
$R_2$, $R_{11}$ à $R_{16}$, $Z_1$ à $Z_3$, $Z_{19}$, et $Z_{20}$ sont chacun indépendamment hydrogène, deutérium, -F, -Cl, -Br, -I, $-SF_5$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle substitué ou non substitué, un groupe $C_2$-$C_{60}$ alkényle substitué ou non substitué, un groupe $C_2$-$C_{60}$ alkynyle substitué ou non substitué, un groupe $C_1$-$C_{60}$ alkoxy substitué ou non substitué, un groupe $C_1$-$C_{60}$ alkylthio substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalkényle substitué ou non substitué, un groupe $C_1$-$C_{10}$ hétérocycloalkényle substitué ou non substitué, un groupe $C_6$-$C_{60}$ aryle substitué ou non substitué, un groupe $C_6$-$C_{60}$ aryloxy substitué ou non substitué, un groupe $C_6$-$C_{60}$ arylthio substitué ou non substitué, un groupe $C_1$-$C_{60}$ hétéroaryle substitué ou non substitué, un groupe polycyclique condensé non aromatique monovalent substitué ou non

substitué, un groupe hétéropolycyclique condensé non aromatique monovalent substitué ou non substitué, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$ ou $-P(Q_8)(Q_9)$,

a2 est un nombre entier de 0 à 20, et quand a2 est 2 ou plus, au moins deux $R_2$(s) sont identiques ou différents l'un de l'autre,

b1 est un nombre entier de 0 à 5, et quand b1 est 2 ou plus, au moins deux $Z_1$(s) sont identiques ou différents l'un de l'autre,

b2 est un nombre entier de 0 à 4, et quand b2 est 2 ou plus, au moins deux $Z_2$(s) sont identiques ou différents l'un de l'autre,

$R_{11}$ et $R_{12}$ sont optionnellement liés l'un à l'autre pour former un groupe $C_5$-$C_{30}$ carbocyclique qui est non substitué ou substitué par au moins un $R_{10a}$ ou un groupe $C_1$-$C_{30}$ hétérocyclique qui est non substitué ou substitué par au moins un $R_{10a}$,

au moins deux d'une pluralité de $R_2$(s) sont optionnellement liés l'un à l'autre pour former un groupe $C_5$-$C_{30}$ carbocyclique qui est non substitué ou substitué par au moins un $R_{10a}$ ou un groupe $C_1$-$C_{30}$ hétérocyclique qui est non substitué ou substitué par au moins un $R_{10a}$,

au moins deux d'une pluralité de $Z_1$(s) sont optionnellement liés l'un à l'autre pour former un groupe $C_5$-$C_{30}$ carbocyclique qui est non substitué ou substitué par au moins un $R_{10a}$ ou un groupe $C_1$-$C_{30}$ hétérocyclique qui est non substitué ou substitué par au moins un $R_{10a}$,

au moins deux d'une pluralité de $Z_2$(s) sont optionnellement liés l'un à l'autre pour former un groupe $C_5$-$C_{30}$ carbocyclique qui est non substitué ou substitué par au moins un $R_{10a}$ ou un groupe $C_1$-$C_{30}$ hétérocyclique qui est non substitué ou substitué par au moins un $R_{10a}$,

$R_{10a}$ est identique à l'explication en rapport avec $Z_1$, et

* et *' indiquent chacun un site de liaison à M dans la Formule 1,

où un substituant du groupe $C_1$-$C_{60}$ alkyle substitué, du groupe $C_2$-$C_{60}$ alkényle substitué, du groupe $C_2$-$C_{60}$ alkynyle substitué, du groupe $C_1$-$C_{60}$ alkoxy substitué, du groupe $C_1$-$C_{60}$ alkylthio substitué, du groupe $C_3$-$C_{10}$ cycloalkyle substitué, du groupe $C_1$-$C_{10}$ hétérocycloalkyle substitué, du groupe $C_3$-$C_{10}$ cycloalkényle substitué, du groupe $C_1$-$C_{10}$ hétérocycloalkényle substitué, du groupe $C_6$-$C_{60}$ aryle substitué, du groupe $C_6$-$C_{60}$ aryloxy substitué, du groupe $C_6$-$C_{60}$ arylthio substitué, du groupe $C_1$-$C_{60}$ hétéroaryle substitué, du groupe polycyclique condensé non aromatique monovalent substitué, et du groupe hétéropolycyclique condensé non aromatique monovalent substitué est :

deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle, un groupe $C_2$-$C_{60}$ alkényle, un groupe $C_2$-$C_{60}$ alkynyle, un groupe $C_1$-$C_{60}$ alkoxy, ou un groupe $C_1$-$C_{60}$ alkylthio ;

un groupe $C_1$-$C_{60}$ alkyle, un groupe $C_2$-$C_{60}$ alkényle, un groupe $C_2$-$C_{60}$ alkynyle, un groupe $C_1$-$C_{60}$ alkoxy, ou un groupe $C_1$-$C_{60}$ alkylthio, chacun substitué par deutérium, -F, - Cl, -Br, -I, - $CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_3$-$C_{10}$ cycloalkyle, un groupe $C_1$-$C_{10}$ hétérocycloalkyle, un groupe $C_3$-$C_{10}$ cycloalkényle, un groupe $C_1$-$C_{10}$ hétérocycloalkényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe polycyclique condensé non aromatique monovalent, un groupe hétéropolycyclique condensé non aromatique monovalent, $-N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$, ou toute combinaison de ceux-ci ;

un groupe $C_3$-$C_{10}$ cycloalkyle, un groupe $C_1$-$C_{10}$ hétérocycloalkyle, un groupe $C_3$-$C_{10}$ cycloalkényle, un groupe $C_1$-$C_{10}$ hétérocycloalkényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe polycyclique condensé non aromatique monovalent, ou un groupe hétéropolycyclique condensé non aromatique monovalent, chacun non substitué ou substitué par deutérium, -F, -Cl, - Br, -I, $-CD_3$, $-CD_2H$, - $CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle, un groupe $C_2$-$C_{60}$ alkényle, un groupe $C_2$-$C_{60}$ alkynyle, un groupe $C_1$-$C_{60}$ alkoxy, un groupe $C_1$-$C_{60}$ alkylthio, un groupe $C_3$-$C_{10}$ cycloalkyle, un groupe $C_1$-$C_{10}$ hétérocycloalkyle, un groupe $C_3$-$C_{10}$ cycloalkényle, un groupe $C_1$-$C_{10}$ hétérocycloalkényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe polycyclique condensé non aromatique monovalent, un groupe hétéropolycyclique condensé non aromatique monovalent, $-N(Q_{21})(Q_{22})$,

- $Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, $-P(Q_{28})(Q_{29})$, ou toute combinaison de ceux-ci ;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$, ou $-P(Q_{38})(Q_{39})$ ; ou

toute combinaison de ceux-ci ;

où $Q_1$ à $Q_9$, $Q_{11}$ à $Q_{19}$, $Q_{21}$ à $Q_{29}$, et $Q_{31}$ à $Q_{39}$ sont chacun indépendamment : hydrogène ; deutérium ; -F ; -Cl ; -Br ; -I ; un groupe hydroxyle ; un groupe cyano ; un groupe nitro ; un groupe amidino ; un groupe hydrazine ; un groupe hydrazone ; un groupe acide carboxylique ou un sel de celui-ci ; un groupe acide sulfonique ou un sel de celui-ci ; un groupe acide phosphorique ou un sel de celui-ci ; un groupe $C_1$-$C_{60}$ alkyle non substitué ou substitué par deutérium, -F, un groupe $C_1$-$C_{60}$ alkyle, un groupe $C_6$-$C_{60}$ aryle, ou toute combinaison de ceux-ci ; un groupe $C_2$-$C_{60}$ alkényle ; un groupe $C_2$-$C_{60}$ alkynyle ; un groupe $C_1$-$C_{60}$ alkoxy ; un groupe $C_1$-$C_{60}$ alkylthio ; un groupe $C_3$-$C_{10}$ cycloalkyle ; un groupe $C_1$-$C_{10}$ hétérocycloalkyle ; un groupe $C_3$-$C_{10}$ cycloalkényle ; un groupe $C_1$-$C_{10}$ hétérocycloalkényle ; un groupe $C_6$-$C_{60}$ aryle non substitué ou substitué par deutérium, -F, un groupe $C_1$-$C_{60}$ alkyle, un groupe $C_6$-$C_{60}$ aryle, ou toute combinaison de ceux-ci ; un groupe $C_6$-$C_{60}$ aryloxy ; un groupe $C_6$-$C_{60}$ arylthio ; un groupe $C_1$-$C_{60}$ hétéroaryle ; un groupe polycyclique condensé non aromatique monovalent ; ou un groupe hétéropolycyclique condensé non aromatique monovalent.

**2.** Composé organométallique selon la revendication 1, où
l'anneau $CY_2$ est un groupe benzène, un groupe naphtalène, un groupe anthracène, un groupe phénanthrène, un groupe 1,2,3,4-tétrahydronaphtalène, un groupe carbazole, un groupe fluorène, un groupe dibenzosilole, un groupe dibenzothiophène, ou un groupe dibenzofurane ; et/ou
où $L_3$ dans la Formule 3 est :

une liaison simple, ou
un groupe benzène, un groupe naphtalène, un groupe dibenzofurane, ou un groupe dibenzothiophène, chacun non substitué ou substitué par deutérium, -F, un groupe cyano, un groupe $C_1$-$C_{20}$ alkyle, un groupe $C_1$-$C_{20}$ alkyle deutéré, un groupe $C_1$- $C_{20}$ alkyle fluoré, un groupe $C_3$-$C_{10}$ cycloalkyle, un groupe $C_3$-$C_{10}$ cycloalkyle deutéré, un groupe $C_3$-$C_{10}$ cycloalkyle fluoré, un groupe ($C_1$-$C_{20}$ alkyl)$C_3$-$C_{10}$ cycloalkyle, un groupe phényle, un groupe phényle deutéré, un groupe phényle fluoré, un groupe ($C_1$-$C_{20}$ alkyl)phényle, un groupe naphtyle, un groupe pyridinyle, un groupe furanyle, un groupe thiophényle, un groupe benzofuranyle, un groupe benzothiophényle, un groupe dibenzofuranyle, un groupe dibenzothiophényle, ou toute combinaison de ceux-ci.

**3.** Composé organométallique selon la revendication 1 ou 2, où
$R_2$, $R_{11}$ à $R_{13}$, $Z_1$ à $Z_3$, $Z_{19}$ et $Z_{20}$ dans les Formules 2 et 3 sont chacun indépendamment:

hydrogène, deutérium, -F, ou un groupe cyano ; ou
un groupe $C_1$-$C_{20}$ alkyle, un groupe $C_3$-$C_{10}$ cycloalkyle, un groupe phényle, un groupe naphtyle, un groupe pyridinyle, un groupe furanyle, un groupe thiophényle, un groupe benzofuranyle, un groupe benzothiophényle, un groupe dibenzofuranyle, ou un groupe dibenzothiophényle, chacun non substitué ou substitué par deutérium, -F, un groupe cyano, un groupe $C_1$-$C_{20}$ alkyle, un groupe $C_1$-$C_{20}$ alkyle deutéré, un groupe $C_1$-$C_{20}$ alkyle fluoré, un groupe $C_3$-$C_{10}$ cycloalkyle, un groupe $C_3$-$C_{10}$ cycloalkyle deutéré, un groupe $C_3$-$C_{10}$ cycloalkyle fluoré, un groupe ($C_1$-$C_{20}$ alkyl)$C_3$-$C_{10}$ cycloalkyle, un groupe phényle, un groupe phényle deutéré, un groupe phényle fluoré, un groupe ($C_1$-$C_{20}$ alkyl)phényle, un groupe naphtyle, un groupe pyridinyle, un groupe furanyle, un groupe thiophényle, un groupe benzofuranyle, un groupe benzothiophényle, un groupe dibenzofuranyle, un groupe dibenzothiophényle, $-Si(Q_{33})(Q_{34})(Q_{35})$, $-Ge(Q_{33})(Q_{34})(Q_{35})$, ou toute combinaison de ceux-ci, et
$R_{14}$ à $R_{16}$ dans la Formule 2 sont chacun indépendamment un groupe $C_1$-$C_{20}$ alkyle, un groupe $C_3$-$C_{10}$ cycloalkyle, un groupe phényle, un groupe naphtyle, un groupe pyridinyle, un groupe furanyle, un groupe thiophényle, un groupe benzofuranyle, un groupe benzothiophényle, un groupe dibenzofuranyle, ou un groupe dibenzothiophényle, chacun non substitué ou substitué par deutérium, -F, un groupe cyano, un groupe $C_1$-$C_{20}$ alkyle, un groupe $C_1$-$C_{20}$ alkyle deutéré, un groupe $C_1$-$C_{20}$ alkyle fluoré, un groupe $C_3$-$C_{10}$ cycloalkyle, un groupe $C_3$-$C_{10}$ cycloalkyle deutéré, un groupe $C_3$-$C_{10}$ cycloalkyle fluoré, un groupe ($C_1$-$C_{20}$ alkyl)$C_3$-$C_{10}$ cycloalkyle, un groupe phényle, un groupe phényle deutéré, un groupe phényle fluoré, un groupe ($C_1$-$C_{20}$ alkyl)phényle, un groupe naphtyle, un groupe pyridinyle, un groupe furanyle, un groupe thiophényle, un groupe benzofuranyle, un groupe benzothiophényle, un groupe dibenzofuranyle, un groupe dibenzothiophényle, ou toute combinaison de ceux-ci.

**4.** Composé organométallique selon l'une quelconque des revendications 1-3, où $R_{11}$ n'est pas l'hydrogène ; et/ou

où le composé organométallique satisfait au moins l'une des <Condition A> et <Condition B>:

<Condition A>
$L_3$ est un groupe $C_5$-$C_{30}$ carbocyclique non substitué ou substitué par au moins un $R_{10a}$, ou un groupe $C_1$-$C_{30}$ hétérocyclique non substitué ou substitué par au moins un $R_{10a}$ ;
<Condition B>
$Z_3$ est un groupe $C_6$-$C_{60}$ aryle substitué ou non substitué, un groupe $C_1$-$C_{60}$ hétéroaryle substitué ou non substitué, un groupe polycyclique condensé non aromatique monovalent substitué ou non substitué, ou un groupe hétéropolycyclique condensé non aromatique monovalent substitué ou non substitué.

**5.** Composé organométallique selon l'une quelconque des revendications 1-4, où $Z_1$ n'est pas l'hydrogène, et b1 est un nombre entier de 1 à 5 ; et/ou
où

un groupe représenté par

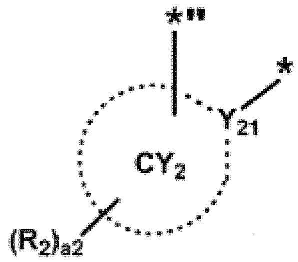

dans la Formule 2 est un groupe représenté par l'une des Formules CY2-1 à CY2-33 :

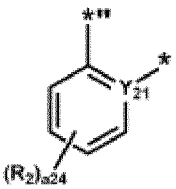
CY2-1

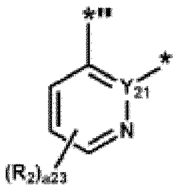
CY2-2

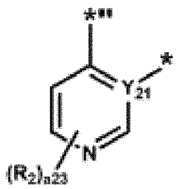
CY2-3

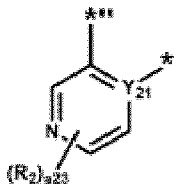
CY2-4

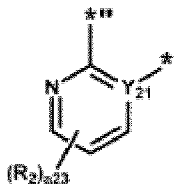
CY2-5

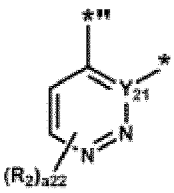
CY2-6

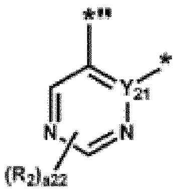
CY2-7

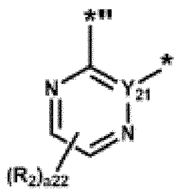
CY2-8

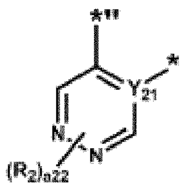
CY2-9

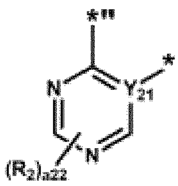
CY2-10

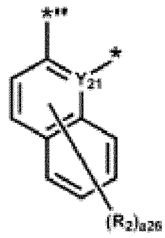
CY2-11

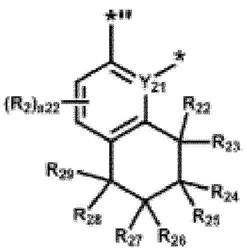
CY2-12

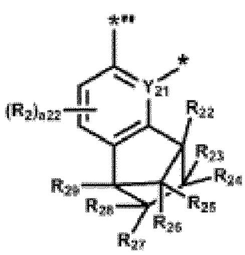
CY2-13

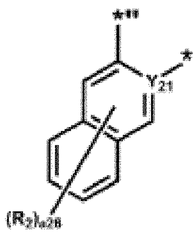
CY2-14

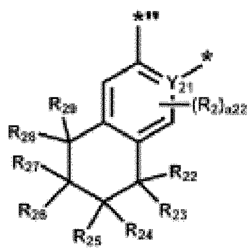
CY2-15

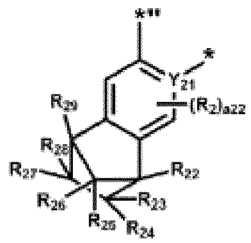

CY2-16

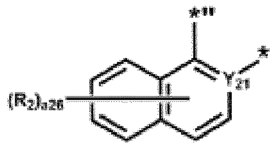

CY2-17

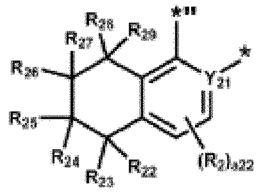

CY2-18

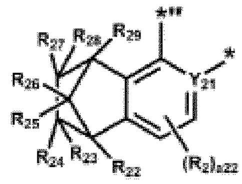

CY2-19

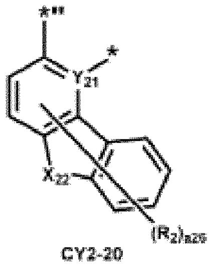

CY2-20

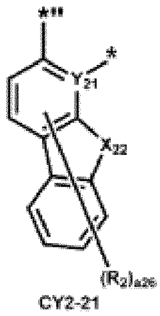

CY2-21

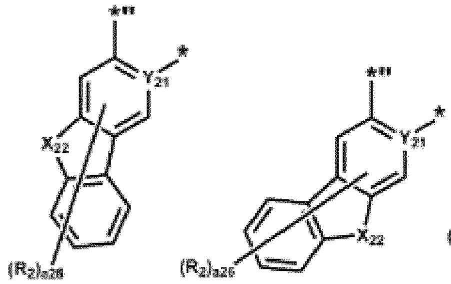

CY2-22

CY2-23

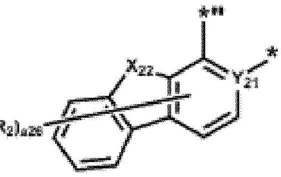

CY2-24

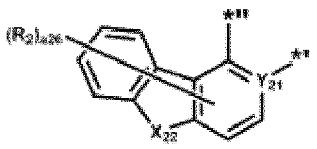

CY2-25

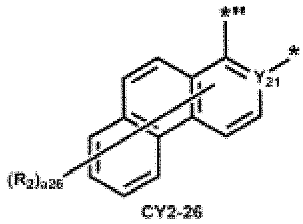

CY2-26

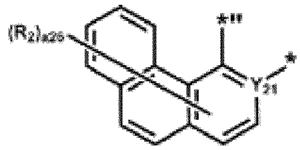

CY2-27

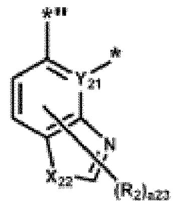

CY2-28

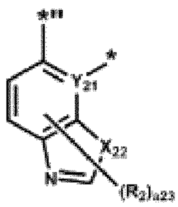

CY2-29

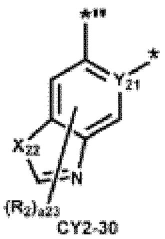

CY2-30

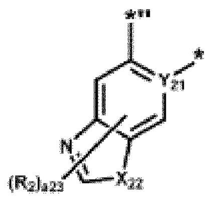

CY2-31

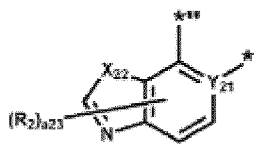

CY2-32

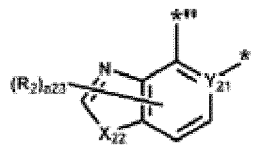

CY2-33

où, dans les Formules CY2-1 à CY2-33,

$Y_{21}$ et $R_2$ sont identiques à la description de la revendication 1,
$X_{22}$ est $C(R_{22})(R_{23})$, $N(R_{22})$, O, S, ou $Si(R_{22})(R_{23})$,
$R_{22}$ à $R_{29}$ sont chacun identiques à la description de la revendication 1 relativement à $R_2$,
a28 est un nombre entier de 0 à 8,
a26 est un nombre entier de 0 à 6,
a24 est un nombre entier de 0 à 4,
a23 est un nombre entier de 0 à 3,
a22 est un nombre entier de 0 à 2,
*" indique un site de liaison à un atome voisin dans la Formule 2, et
* indique un site de liaison à M dans la Formule 1.

**6.** Composé organométallique selon l'une quelconque des revendications 1-5, où

un groupe représenté par

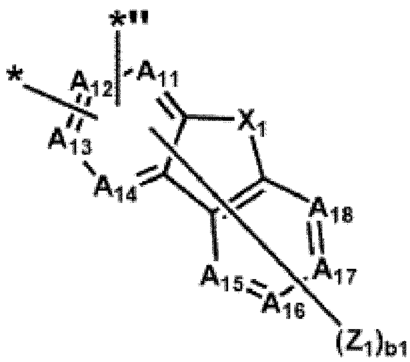

dans la Formule 3 est un groupe représenté par l'une des Formules CY3-1 à CY3-6 :

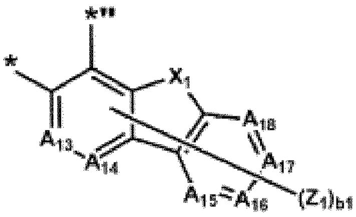

CY3-1

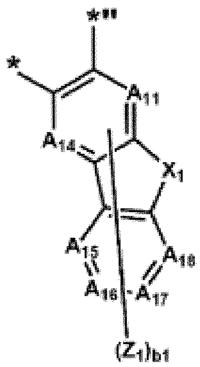

CY3-2

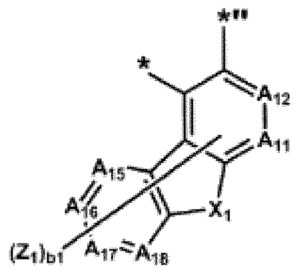

CY3-3

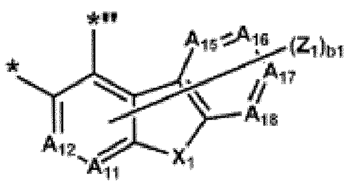

CY3-4

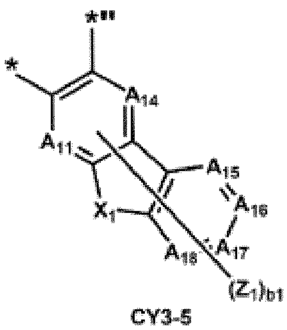

CY3-5

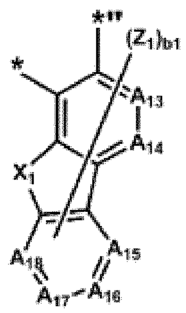

CY3-6

où, dans les Formules CY3-1 à CY3-6,

$X_1$, $Z_1$ et b1 sont identiques à la description de la revendication 1,
$A_{11}$ à $A_{18}$ sont chacun indépendamment C ou N, où au moins l'un de $A_{13}$ à $A_{18}$ dans les Formules CY3-1 et CY3-6 est N, au moins l'un de $A_{11}$, $A_{14}$, $A_{15}$, $A_{16}$, $A_{17}$ et $A_{18}$ dans les Formules CY3-2 et CY3-5 est N, et au moins l'un de $A_{11}$, $A_{12}$, $A_{15}$, $A_{16}$, $A_{17}$ et $A_{18}$ dans les Formules CY3-3 et CY3-4 est N,

* indique un site de liaison à M dans la Formule 1, et
*" indique un site de liaison à un atome voisin dans la Formule 3.

**7.** Composé organométallique selon l'une quelconque des revendications 1-5, où

un groupe représenté par

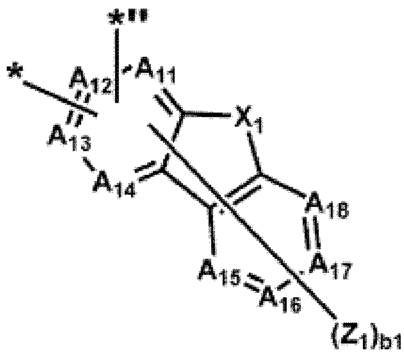

dans la Formule 3 est un groupe représenté par l'une des Formules CY3-1-1 à CY3-1-6, CY3-2-1 à CY3-2-6, CY3-3-1 à CY3-3-6, CY3-4-1 à CY3-4-6, CY3-5-1 à CY3-5-6, et CY3-6-1 à CY3-6-6 :

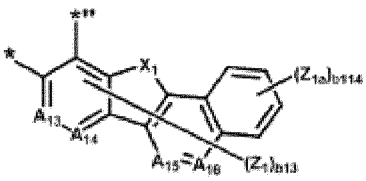

CY3-1-1

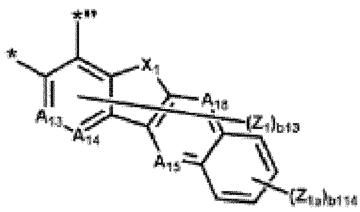

CY3-1-2

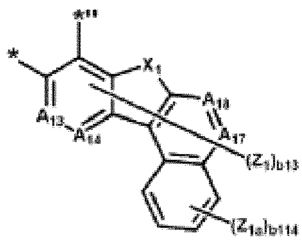

CY3-1-3

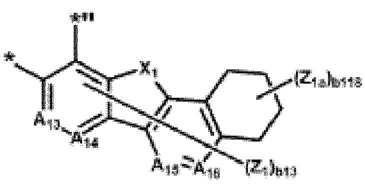

CY3-1-4

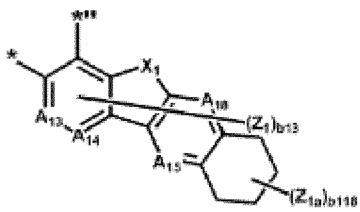

CY3-1-5

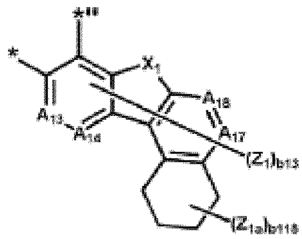

CY3-1-6

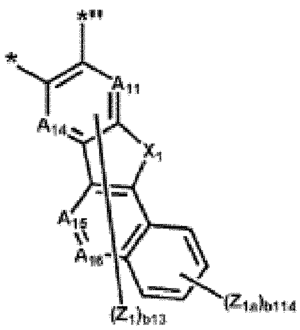

CY3-2-1

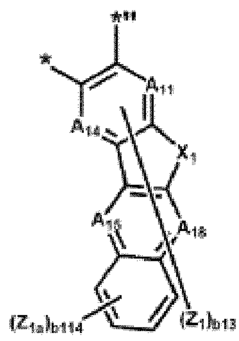

CY3-2-2

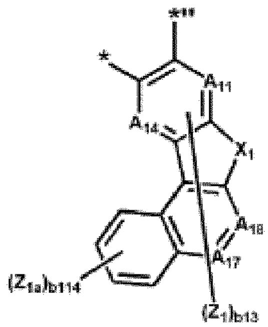

CY3-2-3

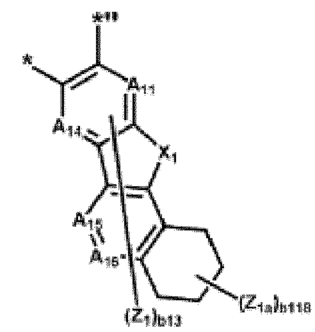
CY3-2-4

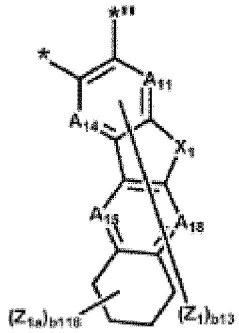
CY3-2-5

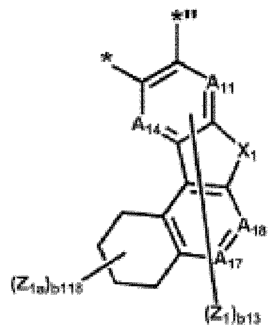
CY3-2-6

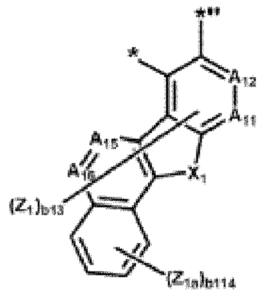
CY3-3-1

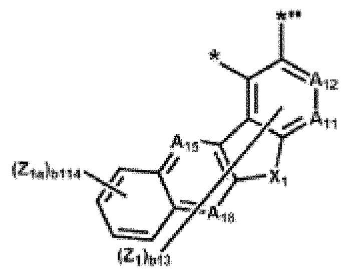
CY3-3-2

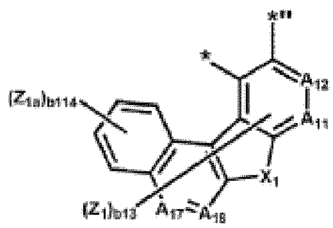
CY3-3-3

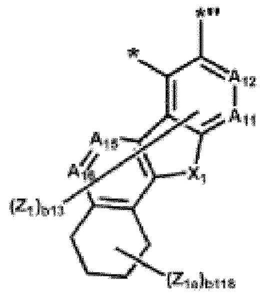
CY3-3-4

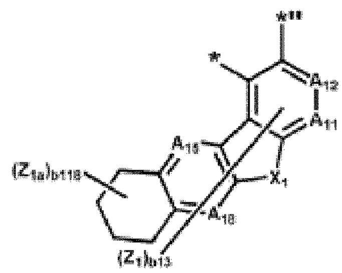
CY3-3-5

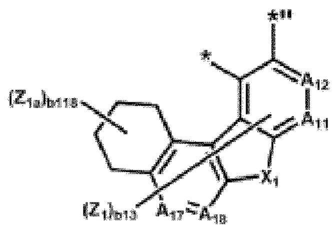
CY3-3-6

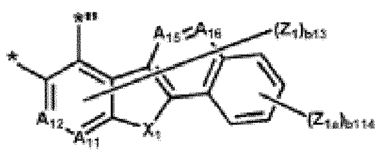
CY3-4-1

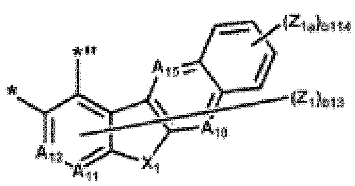
CY3-4-2

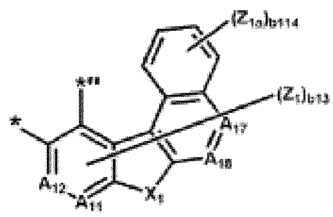
CY3-4-3

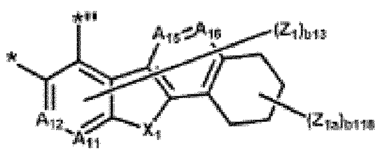
CY3-4-4

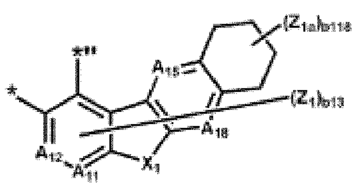
CY3-4-5

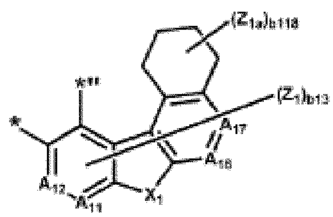
CY3-4-6

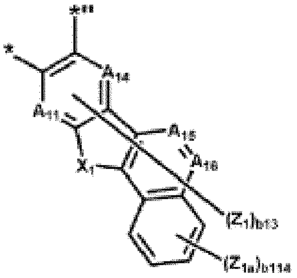
CY3-5-1

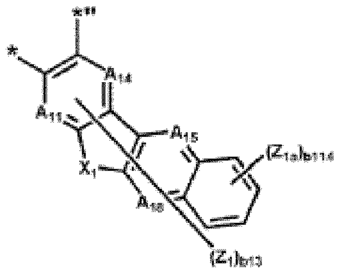
CY3-5-2

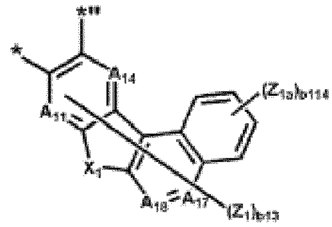
CY3-5-3

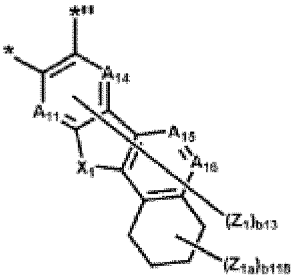
CY3-5-4

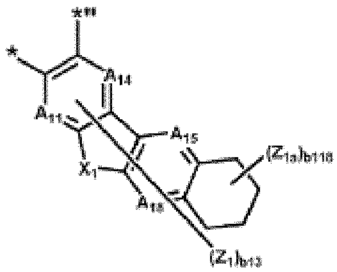
CY3-5-5

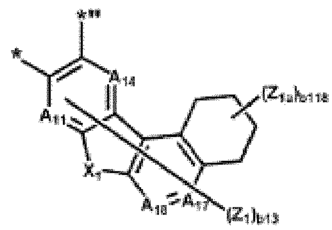
CY3-5-6

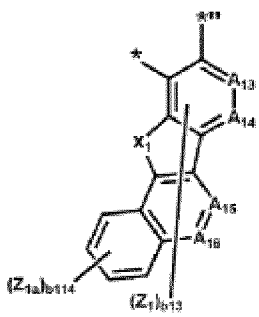
CY3-6-1

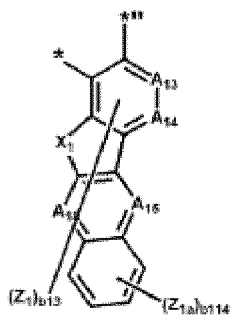
CY3-6-2

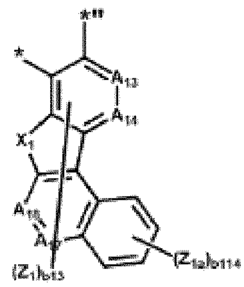
CY3-6-3

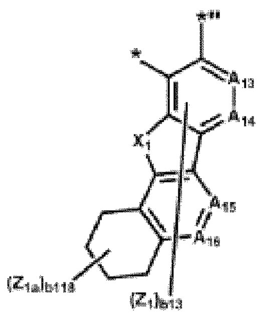
CY3-6-4

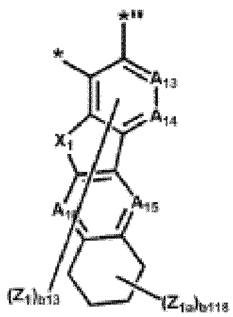
CY3-6-5

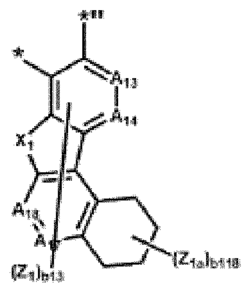
CY3-6-6

où, dans les Formules CY3-1-1 à CY3-1-6, CY3-2-1 à CY3-2-6, CY3-3-1 à CY3-3-6, CY3-4-1 à CY3-4-6, CY3-5-1 à CY3-5-6, et CY3-6-1 à CY3-6-6,

$X_1$ et $Z_1$ sont identiques à la description de la revendication 1,
$Z_{1a}$ est identique à la description de la revendication 1 en rapport avec $R_{1a}$,
$A_{11}$ à $A_{18}$ sont chacun indépendamment C ou N, où a) au moins l'un de $A_{13}$, $A_{14}$, $A_{15}$, et $A_{16}$ dans les Formules CY3-1-1, CY3-1-4, CY3-6-1, et CY3-6-4 est N, b) au moins l'un de $A_{13}$, $A_{14}$, $A_{15}$, et $A_{18}$ dans les Formules CY3-1-2, CY3-1-5, CY3-6-2, et CY3-6-5 est N, c) au moins l'un de $A_{13}$, $A_{14}$, $A_{17}$, et $A_{18}$ dans les Formules CY3-1-3, CY3-1-6, CY3-6- 3, et CY3-6-6 est N, d) au moins l'un de $A_{11}$, $A_{14}$, $A_{15}$, et $A_{16}$ dans les Formules CY3-2-1, CY3-2-4, CY3-5-1, et CY3-5-4 est N, e) au moins l'un de $A_{11}$, $A_{14}$, $A_{15}$, et $A_{18}$ dans

les Formules CY3-2-2, CY3-2-5, CY3-5-2, et CY3-5-5 est N, f) au moins l'un de $A_{11}$, $A_{14}$, $A_{17}$, et $A_{18}$ dans les Formules CY3-2-3, CY3-2-6, CY3-5-3, et CY3-5-6 est N, g) au moins l'un de $A_{11}$, $A_{12}$, $A_{15}$, et $A_{16}$ dans les Formules CY3-3-1, CY3-3-4, CY3-4-1, et CY3-4-4 est N, h) au moins l'un de $A_{11}$, $A_{12}$, $A_{15}$, et $A_{18}$ dans les Formules CY3-3-2, CY3-3-5, CY3-4-2, et CY3-4-5 est N, i) au moins l'un de $A_{11}$, $A_{12}$, $A_{17}$, et $A_{18}$ dans les Formules CY3-3-3, CY3-3-6, CY3-4-3, et CY3-4-6 est N,
b13 est un nombre entier de 0 à 3,
b114 est un nombre entier de 0 à 4,
b118 est un nombre entier de 0 à 8,

* indique un site de liaison à M dans la Formule 1, et
*" indique un site de liaison à un atome voisin dans la Formule 3.

**8.** Composé organométallique selon l'une quelconque des revendications 1-5, où

un groupe représenté par

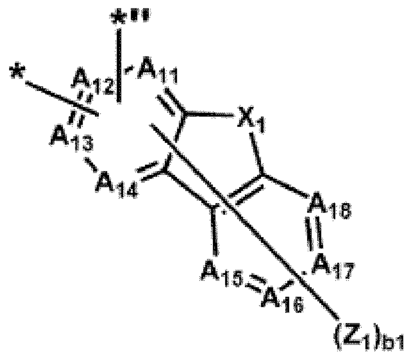

dans la Formule 3 est un groupe représenté par l'une des Formules NCY3(1) à NCY3(84) :

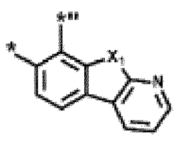
NCY3(1)

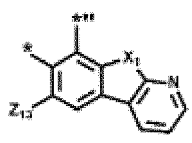
NCY3(2)

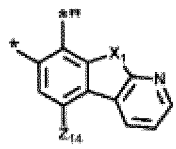
NCY3(3)

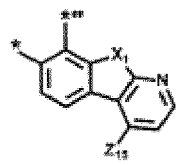
NCY3(4)

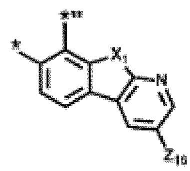
NCY3(5)

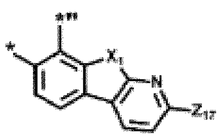
NCY3(6)

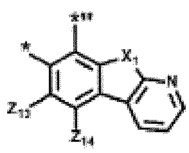
NCY3(7)

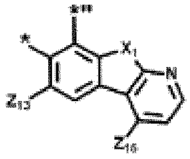
NCY3(8)

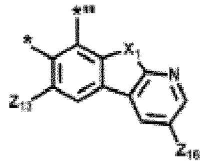
NCY3(9)

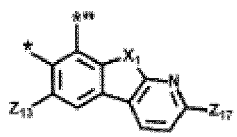
NCY3(10)

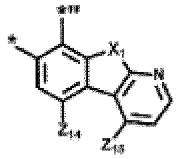
NCY3(11)

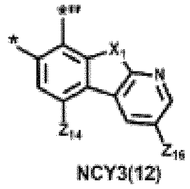
NCY3(12)

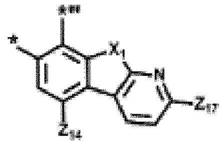
NCY3(13)

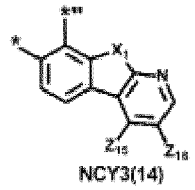
NCY3(14)

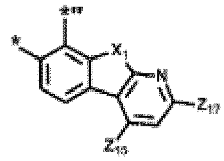
NCY3(15)

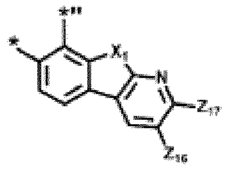
NCY3(16)

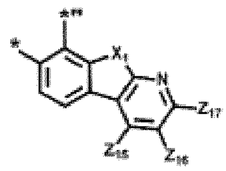
NCY3(17)

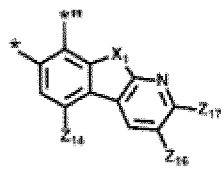
NCY3(18)

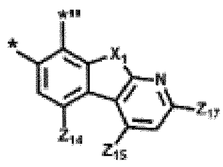
NCY3(19)

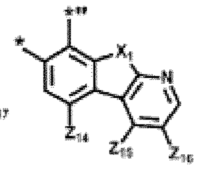
NCY3(20)

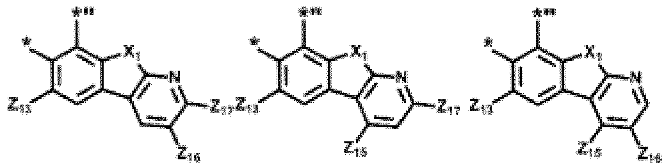
NCY3(21) NCY3(22) NCY3(23)

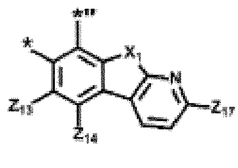
NCY3(24)

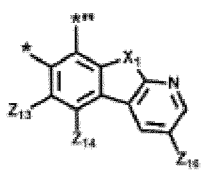
NCY3(25)

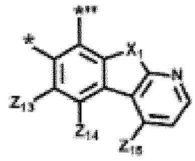
NCY3(26)

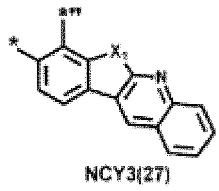
NCY3(27)

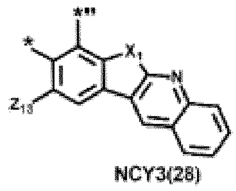
NCY3(28)

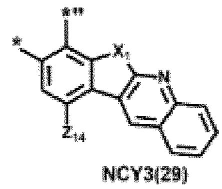
NCY3(29)

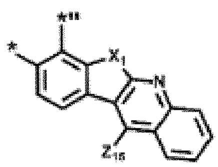
NCY3(30)

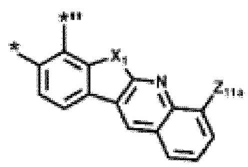
NCY3(31)

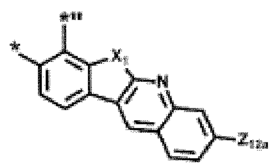
NCY3(32)

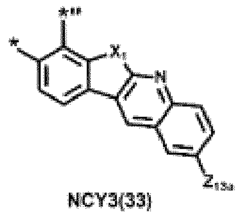
NCY3(33)

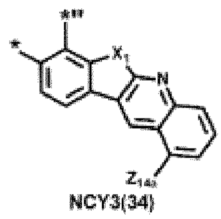
NCY3(34)

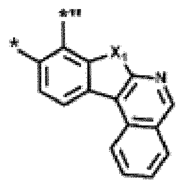
NCY3(35)

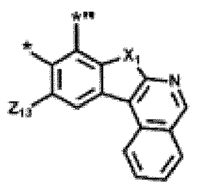
NCY3(36)

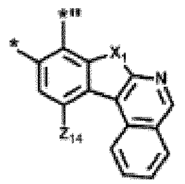
NCY3(37)

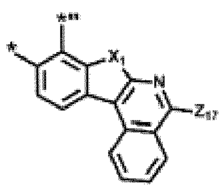
NCY3(38)

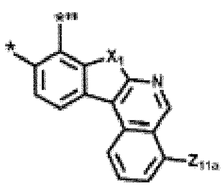
NCY3(39)

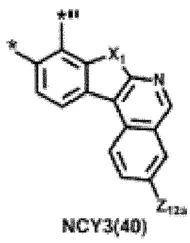
NCY3(40)

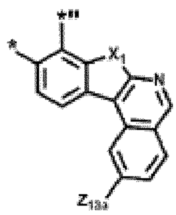
NCY3(41)

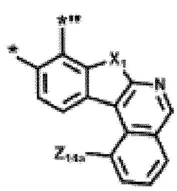
NCY3(42)

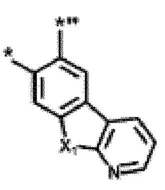
NCY3(43)

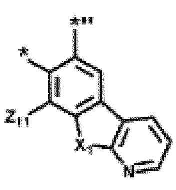
NCY3(44)

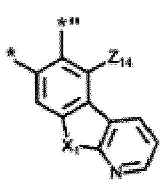
NCY3(45)

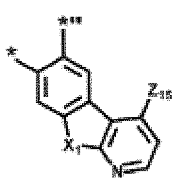
NCY3(46)

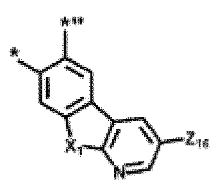
NCY3(47)

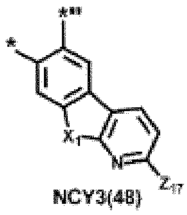
NCY3(48)

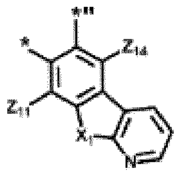
NCY3(49)

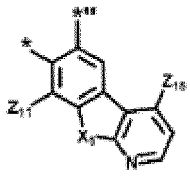
NCY3(50)

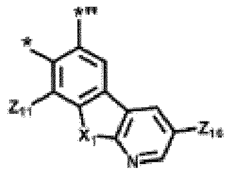
NCY3(51)

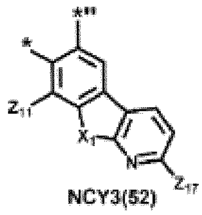
NCY3(52)

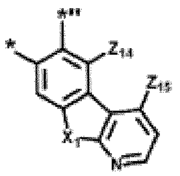
NCY3(53)

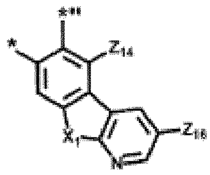
NCY3(54)

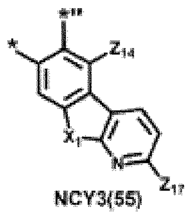
NCY3(55)

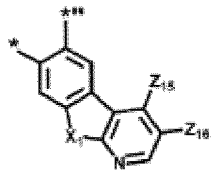
NCY3(56)

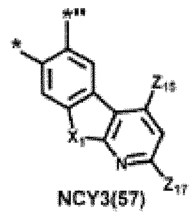
NCY3(57)

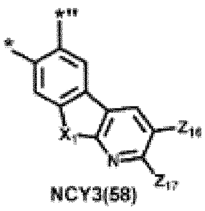
NCY3(58)

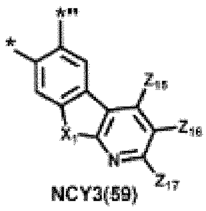
NCY3(59)

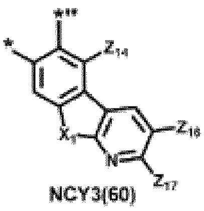
NCY3(60)

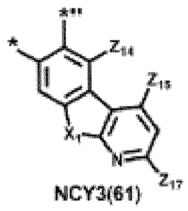
NCY3(61)

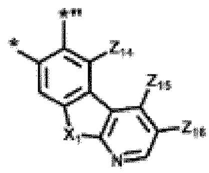
NCY3(62)

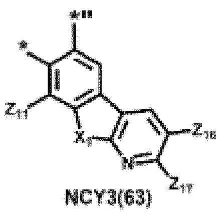
NCY3(63)

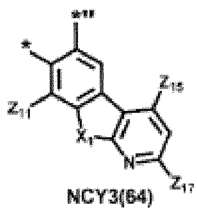
NCY3(64)

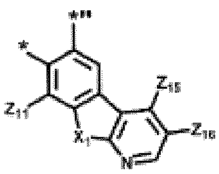
NCY3(65)

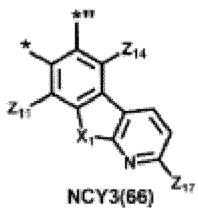
NCY3(66)

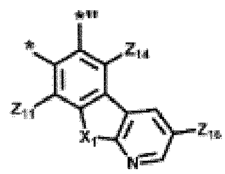
NCY3(67)

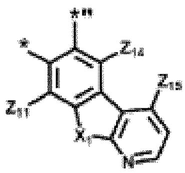
NCY3(68)

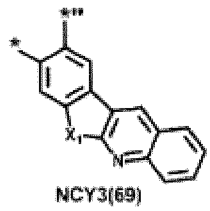
NCY3(69)

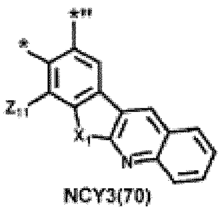
NCY3(70)

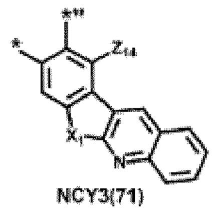
NCY3(71)

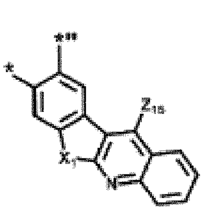
NCY3(72)

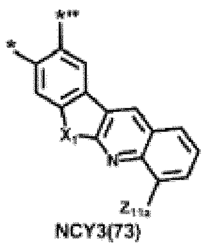
NCY3(73)

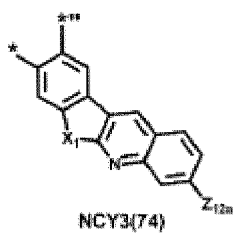
NCY3(74)

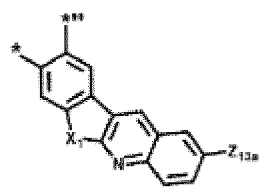
NCY3(75)

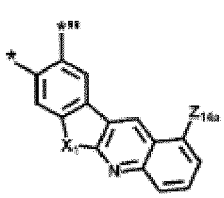
NCY3(76)

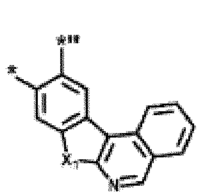
NCY3(77)

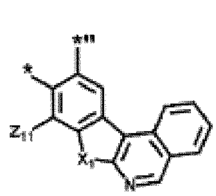
NCY3(78)

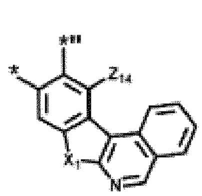
NCY3(79)

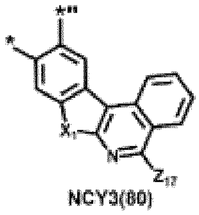
NCY3(80)
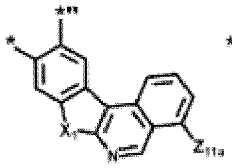
NCY3(81)
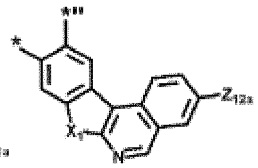
NCY3(82)
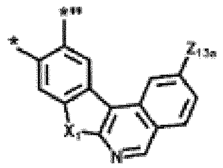
NCY3(83)
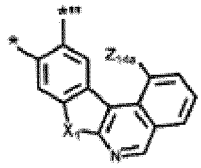
NCY3(84)

où, dans les Formules NCY3(1) à NCY3(84),

$X_1$ est identique à la description de la revendication 1,
$Z_{11}$ à $Z_{18}$ et $Z_{11a}$ à $Z_{14a}$ $Z_{1a}$ sont chacun identiques à la description de la revendication 1 en rapport avec $Z_1$, et chacun de $Z_{11}$ à $Z_{18}$ et $Z_{11a}$ à $Z_{14a}$ $Z_{1a}$ n'est pas l'hydrogène,

* indique un site de liaison à M dans la Formule 1, et
*" indique un site de liaison à un atome voisin dans la Formule 3.

**9.** Composé organométallique selon l'une quelconque des revendications 1-8, où

un groupe représenté par

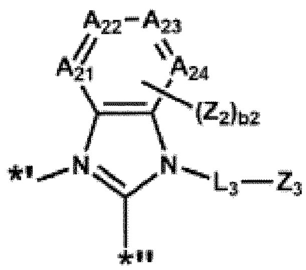

dans la Formule 3 est un groupe représenté par l'une des Formules CY4-1 à CY4-60 :

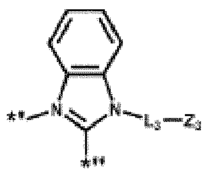
CY4-1
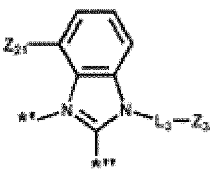
CY4-2
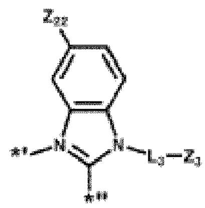
CY4-3
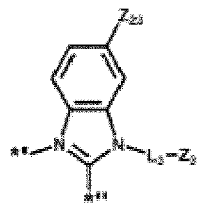
CY4-4
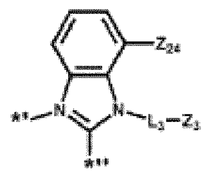
CY4-5

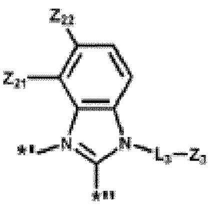
CY4-6
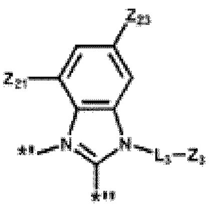
CY4-7
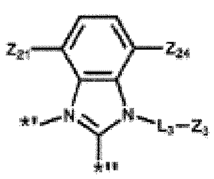
CY4-8
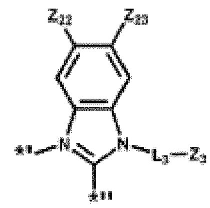
CY4-9
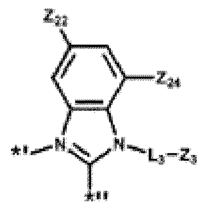
CY4-10

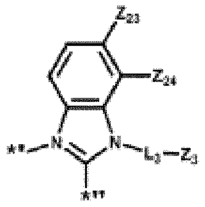
CY4-11

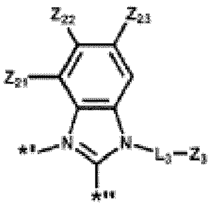
CY4-12

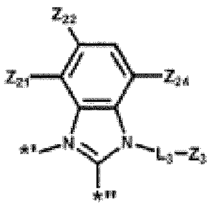
CY4-13

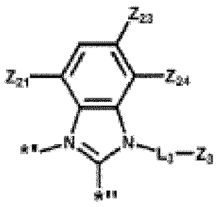
CY4-14

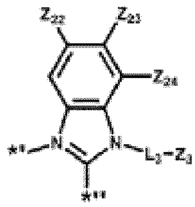
CY4-15

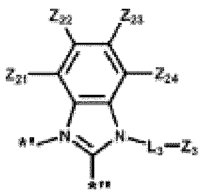
CY4-16

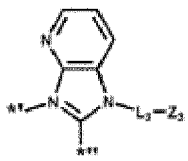
CY4-17

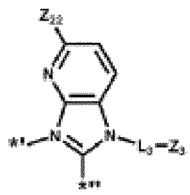
CY4-18

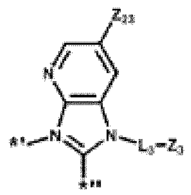
CY4-19

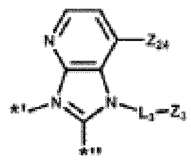
CY4-20

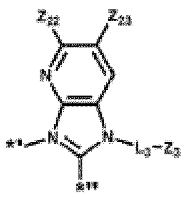
CY4-21

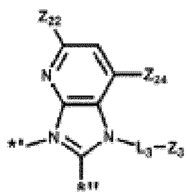
CY4-22

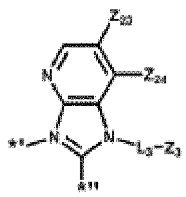
CY4-23

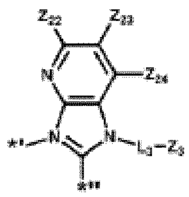
CY4-24

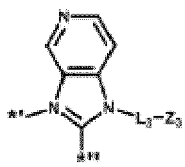
CY4-25

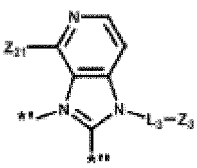
CY4-26

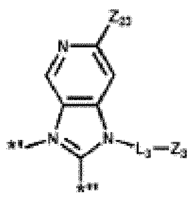
CY4-27

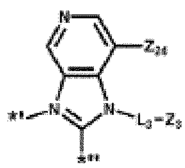
CY4-28

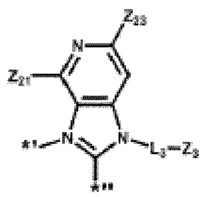
CY4-29

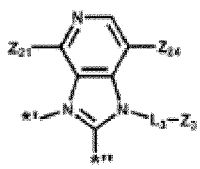
CY4-30

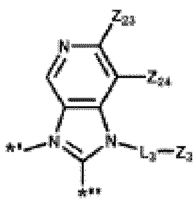
CY4-31

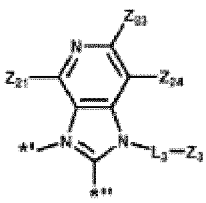
CY4-32

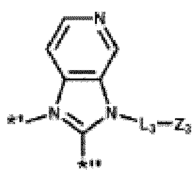
CY4-33

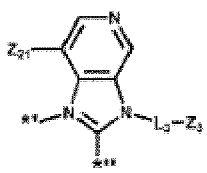
CY4-34

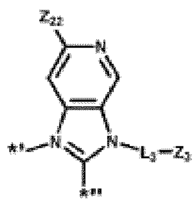
CY4-35

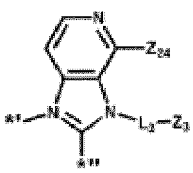
CY4-36

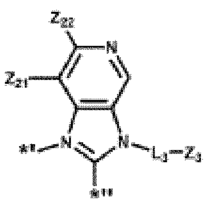
CY4-37

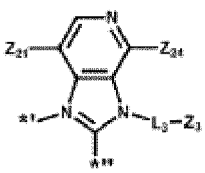
CY4-38

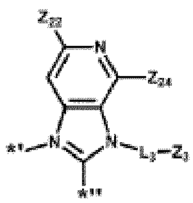
CY4-39

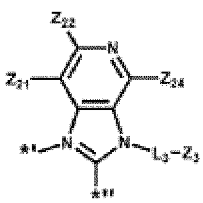
CY4-40

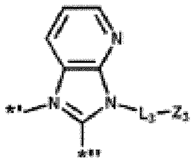
CY4-41

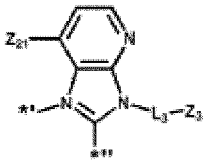
CY4-42

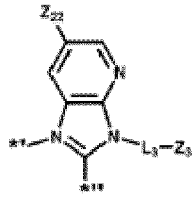
CY4-43

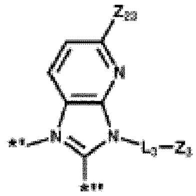
CY4-44

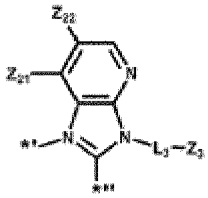
CY4-45

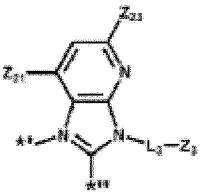
CY4-46

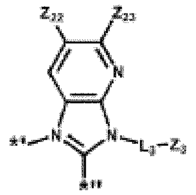
CY4-47

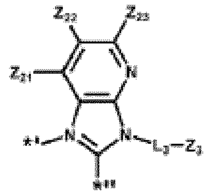
CY4-48

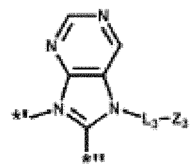
CY4-49

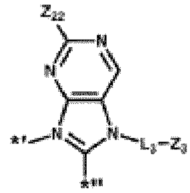
CY4-50

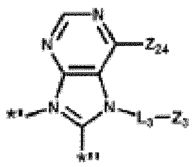
CY4-51

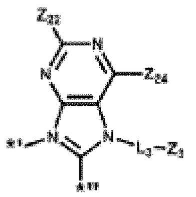
CY4-52

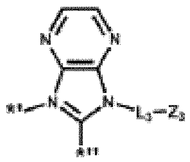
CY4-53

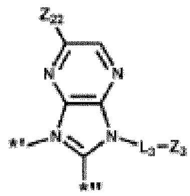
CY4-54

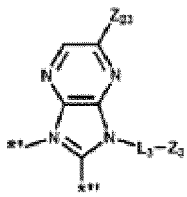
CY4-55

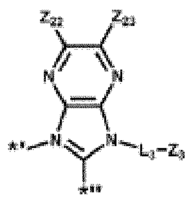
CY4-56

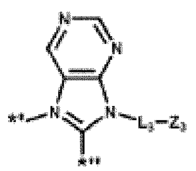
CY4-57

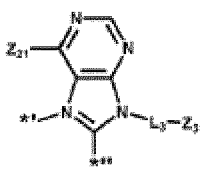
CY4-58

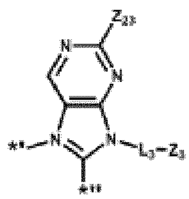
CY4-59

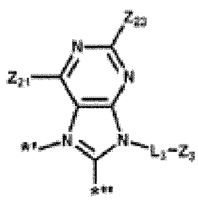
CY4-60

où, dans les Formules CY4-1 à CY4-60,

$L_3$ et $Z_3$ sont identiques à la description de la revendication 1,
$Z_{21}$ à $Z_{24}$ sont chacun identiques à la description de la revendication 1 en rapport avec $Z_2$, où $Z_{21}$ à $Z_{24}$ ne sont pas l'hydrogène,

*' indique un site de liaison à M dans la Formule 1, et
*" indique un site de liaison à un atome voisin dans la Formule 3.

**10.** Composé organométallique selon l'une quelconque des revendications 1-8, où

un groupe représenté par

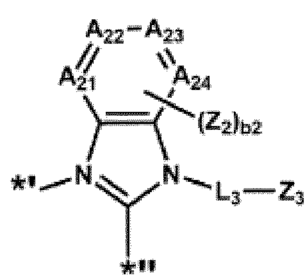

dans la Formule 3 est un groupe représenté par l'une des Formules CY4(1) à CY4(4) :

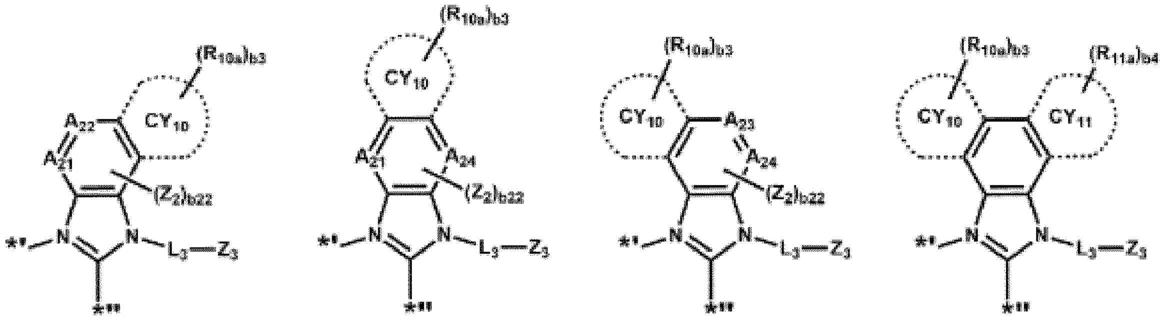

CY4(1) CY4(2) CY4(3) CY4(4)

où, dans les Formules CY4(1) à CY4(4),

$A_{21}$ à $A_{24}$, $L_3$, $Z_2$, $Z_3$ et $R_{10a}$ sont identiques à la description de la revendication 1,
b22 est un nombre entier de 0 à 2,
l'anneau $CY_{10}$ et l'anneau $CY_{11}$ sont chacun indépendamment un groupe $C_5$-$C_{30}$ carbocyclique ou un groupe $C_1$-$C_{30}$ hétérocyclique,
$R_{11a}$ est identique à la description en rapport avec $R_{10a}$,
b3 et b4 sont chacun indépendamment un nombre entier de 0 à 20, quand b3 est 2 ou plus, au moins deux $R_{10a}$(s) sont identiques ou différents l'un de l'autre, et quand b4 est 2 ou plus, au moins deux $R_{11a}$(s) sont identiques ou différents l'un de l'autre,

*' indique un site de liaison à M dans la Formule 1, et
*" indique un site de liaison à un atome voisin dans la Formule 3.

**11.** Composé organométallique selon l'une quelconque des revendications 1-8, où

un groupe représenté par

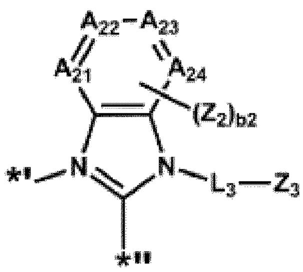

dans la Formule 3 est un groupe représenté par l'une des Formules CY4(1)-1 à CY4(1)-4, CY4(2)-1 à CY4(2)-4, CY4(3)-1 à CY4(3)-4 et CY4(4)-1 :

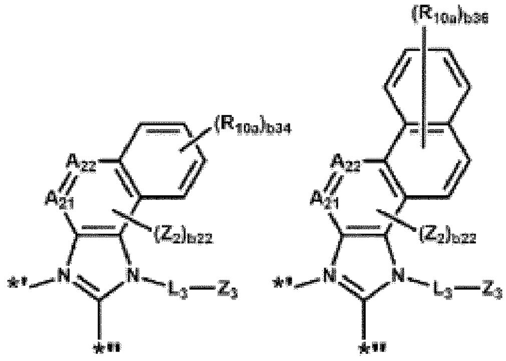

CY4(1)-1 CY4(1)-2

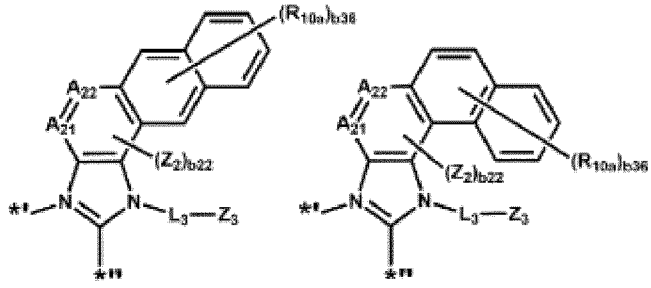

CY4(1)-3 CY4(1)-4

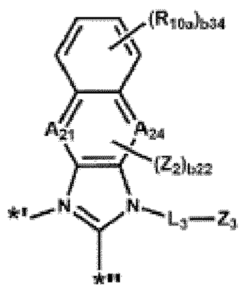

CY4(2)-1

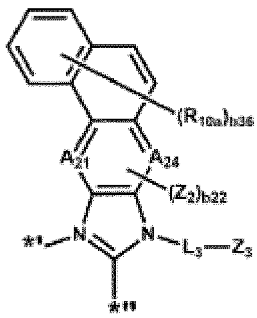

CY4(2)-2

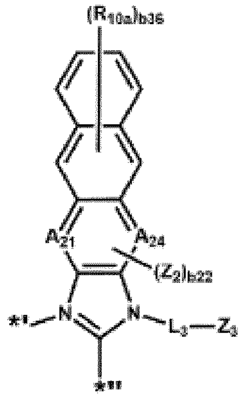

CY4(2)-3

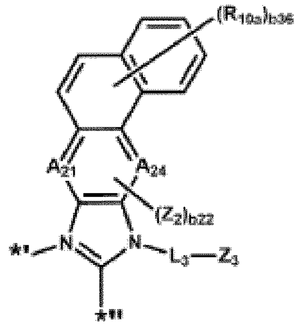

CY4(2)-4

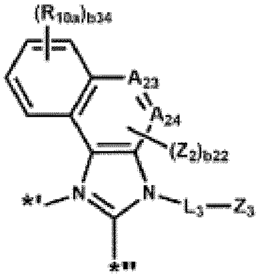

CY4(3)-1

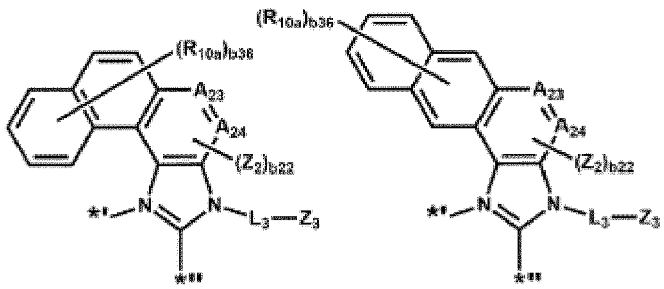

CY4(3)-2 CY4(3)-3

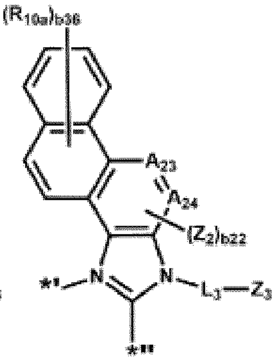

CY4(3)-4

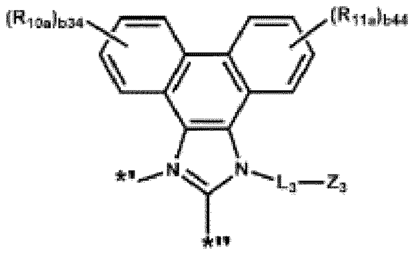

CY4(4)-1

où, dans les Formules CY4(1)-1 à CY4(1)-4, CY4(2)-1 à CY4(2)-4, CY4(3)-1 à CY4(3)-4 et CY4(4)-1,

$A_{21}$ à $A_{24}$, $L_3$, $Z_2$, $Z_3$ et $R_{10a}$ sont identiques à la description de la revendication 1,
b22 est un nombre entier de 0 à 2,

$R_{11a}$ est identique à la description en rapport avec $R_{10a}$,
b34 et b44 peuvent chacun indépendamment être un nombre entier de 0 à 4, quand b34 est 2 ou plus, au moins deux $R_{10a}$(s) peuvent être identiques ou différents l'un de l'autre, et quand b44 est 2 ou plus, au moins deux $R_{11a}$(s) peuvent être identiques ou différents l'un de l'autre,
b36 peut être un nombre entier de 0 à 6, quand b36 est 2 ou plus, au moins deux $R_{10a}$(s) peuvent être identiques ou différents l'un de l'autre,
*' indique un site de liaison à M dans la Formule 1, et
*" indique un site de liaison à un atome voisin dans la Formule 3.

**12.** Dispositif électroluminescent organique comprenant : une première électrode ;

une seconde électrode ; et
une couche organique disposée entre la première électrode et la seconde électrode et comportant une couche d'émission,
où la couche organique comprend au moins un composé organométallique selon l'une quelconque des revendications 1-11.

**13.** Dispositif électroluminescent organique selon la revendication 12, où

la première électrode est une anode,
la seconde électrode est une cathode,
la couche organique comprend en outre une zone de transport de trous entre la première électrode et la couche d'émission et une zone de transport d'électrons entre la couche d'émission et la seconde électrode,
la zone de transport de trous comprend une couche d'injection de trous, une couche de transport de trous, une couche de blocage d'électrons, une couche tampon, ou toute combinaison de celles-ci, et
la zone de transport d'électrons comprend une couche de blocage de trous, une couche de transport d'électrons, une couche d'injection d'électrons, ou toute combinaison de celles-ci ; et/ou
où
le ou les composés organométalliques sont compris dans la couche d'émission.

**14.** Dispositif électroluminescent organique selon la revendication 12 ou 13, où

la couche d'émission émet une lumière verte ; et/ou
où
la couche d'émission comporte en outre un hôte, et la quantité de l'hôte est plus grande que la quantité du composé organométallique.

**15.** Appareil électronique comprenant le dispositif électroluminescent organique selon l'une quelconque des revendications 12-14.

# FIGURE

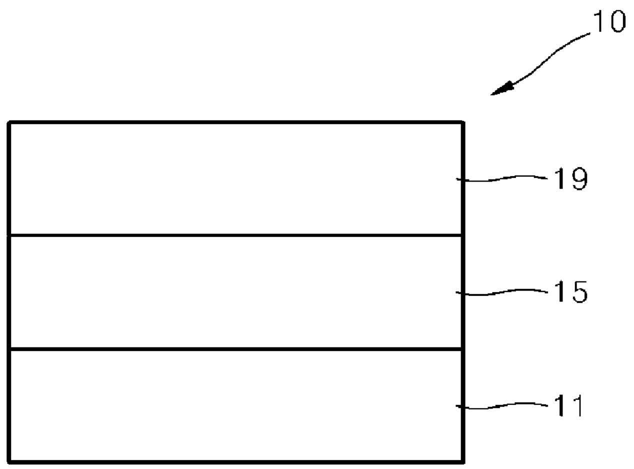

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2016268522 A


### Non-patent literature cited in the description


- **YONGBIAO ZHAO et al.** Ultrathin nondoped emissive layers for efficient and simple monochrome and white organic light-emitting diodes. *ACS Appl. Mater. Interfaces,* February 2013, vol. 5 (3), 965-71